(19) Europäisches Patentamt
European Patent Office
Office européen des brevets

(11) EP 1 214 706 B1

(12) EUROPEAN PATENT SPECIFICATION

(45) Date of publication and mention
of the grant of the patent:
**04.08.2004 Bulletin 2004/32**

(51) Int Cl.⁷: **G10L 19/14**

(86) International application number:
**PCT/US2000/025182**

(21) Application number: **00963447.8**

(22) Date of filing: **15.09.2000**

(87) International publication number:
**WO 2001/022402 (29.03.2001 Gazette 2001/13)**

(54) **MULTIMODE SPEECH ENCODER**

MULTIMODALER SPRACHKODIERER

CODEUR VOCAL MULTIMODE

(84) Designated Contracting States:
**AT BE CH CY DE DK ES FI FR GB GR IE IT LI LU MC NL PT SE**

(30) Priority: **22.09.1999 US 155321 P**
**19.05.2000 US 574396**

(43) Date of publication of application:
**19.06.2002 Bulletin 2002/25**

(73) Proprietor: **Conexant Systems, Inc.**
**Newport Beach, CA 92660 (US)**

(72) Inventors:
• **GAO, Yang**
**Mission Viejo, CA 92692 (US)**
• **BENYASSINE, Adil**
**Irvine, CA 92602 (US)**
• **THYSSEN, Jes**
**Laguna Niguel, CA 92677 (US)**
• **SHOLOMOT, Eyal**
**Long Beach, CA 90803 (US)**
• **SU, Huan-yu**
**San Clemente, CA 92673 (US)**

(74) Representative: **Wagner & Geyer**
**Intellectual Property Attorneys**
**Gewürzmühlstrasse 5**
**80538 München (DE)**

(56) References cited:
**CA-A- 2 239 294          US-A- 5 911 128**

• **CELLARIO L ET AL: "CELP CODING AT VARIABLE RATE" EUROPEAN TRANSACTIONS ON TELECOMMUNICATIONS AND RELATED TECHNOLOGIES,IT,AEI, MILANO, vol. 5, no. 5, 1 September 1994 (1994-09-01), pages 69-79, XP000470681 ISSN: 1120-3862**
• **OZAWA K ET AL: "M-LCELP SPEECH CODING AT 4 KB/S WITH MULTI-MODE AND MULTI-CODEBOOK" IEICE TRANSACTIONS ON COMMUNICATIONS,JP,INSTITUTE OF ELECTRONICS INFORMATION AND COMM. ENG. TOKYO, vol. E77B, no. 9, 1 September 1994 (1994-09-01), pages 1114-1121, XP000474108 ISSN: 0916-8516**

**Description**

**TECHNICAL FIELD**

This invention relates to speech communication systems and, more particularly, to systems for digital speech coding.

**BACKGROUND ART**

One prevalent mode of human communication is by the use of communication systems. Communication systems include both wireline and wireless radio based systems. Wireless communication systems are electrically connected with the wireline based systems and communicate with the mobile communication devices using radio frequency (RF) communication. Currently, the radio frequencies available for communication in cellular systems, for example, are in the cellular frequency range centered around 900 MHz and in the personal communication services (PCS) frequency range centered around 1900 MHz. Data and voice transmissions within the wireless system have a bandwidth that consumes a portion of the radio frequency. Due to increased traffic caused by the expanding popularity of wireless communication devices, such as cellular telephones, it is desirable to reduced bandwidth of transmissions within the wireless systems.

Digital transmission in wireless radio communications is increasingly applied to both voice and data due to noise immunity, reliability, compactness of equipment and the ability to implement sophisticated signal processing functions using digital techniques. Digital transmission of speech signals involves the steps of: sampling an analog speech waveform with an analog-to-digital converter, speech compression (encoding), transmission, speech decompression (decoding), digital-to-analog conversion, and playback into an earpiece or a loudspeaker. The sampling of the analog speech waveform with the analog-to-digital converter creates a digital signal. However, the number of bits used in the digital signal to represent the analog speech waveform creates a relatively large bandwidth. For example, a speech signal that is sampled at a rate of 8000 Hz (once every 0.125 ms), where each sample is represented by 16 bits, will result in a bit rate of 128,000 (16x8000) bits per second, or 128 Kbps (Kilobits per second).

Speech compression may be used to reduce the number of bits that represent the speech signal thereby reducing the bandwidth needed for transmission. However, speech compression may result in degradation of the quality of decompressed speech. In general, a higher bit rate will result in higher quality, while a lower bit rate will result in lower quality. However, modem speech compression techniques, such as coding techniques, can produce decompressed speech of relatively high quality at relatively low bit rates. In general, modem coding techniques attempt to represent the perceptually important features of the speech signal, without preserving the actual speech waveform.

One coding technique used to lower the bit rate involves varying the degree of speech compression (i.e. varying the bit rate) depending on the part of the speech signal being compressed. Typically, parts of the speech signal for which adequate perceptual representation is more difficult (such as voiced speech, plosives, or voiced onsets) are coded and transmitted using a higher number of bits. Conversely, parts of the speech for which adequate perceptual representation is less difficult (such as unvoiced, or the silence between words) are coded with a lower number of bits. The resulting average bit rate for the speech signal will be relatively lower than would be the case for a fixed bit rate that provides decompressed speech of similar quality.

Speech compression systems, commonly called codecs, include an encoder and a decoder and may be used to reduce the bit rate of digital speech signals. Numerous algorithms have been developed for speech codecs that reduce the number of bits required to digitally encode the original speech while attempting to maintain high quality reconstructed speech. Code-Excited Linear Predictive (CELP) coding techniques, as discussed in the article entitled "Code-Excited Linear Prediction: High-Quality Speech at Very Low Rates," by M. R. Schroeder and B. S. Atal, Proc. ICASSP-85, pages 937-940, 1985, provide one effective speech coding algorithm. An example of a variable rate CELP based speech coder is TIA (Telecommunications Industry Association) IS-127 standard that is designed for CDMA (Code Division Multiple Access) applications. which is entitled "Enhanced Variable Rate Codec, Speech Service Option 3 for Wickband Sprad Spectrum digital Systems", Committee, TR-45.5, Category: Telecommunications Published January 1, 1997. The CELP coding technique utilizes several prediction techniques to remove the redundancy from the speech signal. The CELP coding approach is frame-based in the sense that it stores sampled input speech signals into a block of samples called frames. The frames of data may then be processed to create a compressed speech signal in digital form.

The CELP coding approach uses two types of predictors, a short-term predictor and a long-term predictor. The short-term predictor typically is applied before the long-term predictor. A prediction error derived from the short-term predictor is commonly called short-term residual, and a prediction error derived from the long-term predictor is commonly called long-term residual. The long-term residual may be coded using a fixed codebook that includes a plurality of fixed codebook entries or vectors. One of the entries may be selected and multiplied by a fixed codebook gain to represent the long-term residual. The short-term predictor also can be referred to as an LPC (Linear Prediction Coding) or a spectral representation, and typically comprises 10 prediction parameters. The long-term predictor also can be referred to as a pitch predictor or an adaptive codebook and typically comprises a lag parameter and a long-term predictor gain parameter. Each lag parameter also can be called a pitch lag, and each long-term predictor gain parameter can also be called an adaptive codebook gain. The lag parameter defines an entry or a vector in the adaptive codebook.

The CELP encoder performs an LPC analysis to determine the short-term predictor parameters. Following the LPC analysis, the long-term predictor parameters may be determined. In addition, determination of the fixed codebook entry and the fixed codebook gain that best represent the long-term residual occurs. The powerful concept of analysis-by-synthesis (ABS) is employed in CELP coding. In the ABS approach, the best contribution from the fixed codebook, the best fixed codebook gain, and the best long-term predictor parameters may be found by synthesizing them using an inverse prediction filter and applying a perceptual weighting measure. The short-term (LPC) prediction coefficients, the fixed-codebook gain, as well as the lag parameter and the long-term gain parameter may then be quantized. The quantization indices, as well as the fixed codebook indices, may be sent from the encoder to the decoder.

The CELP decoder uses the fixed codebook indices to extract a vector from the fixed codebook. The vector may be multiplied by the fixed-codebook gain, to create a long-term excitation also known as a fixed codebook contribution. A long-term predictor contribution may be added to the long-term excitation to create a short-term excitation that commonly is referred to simply as an excitation. The long-term predictor contribution comprises the short-term excitation from the past multiplied by the long-terra predictor gain. The addition of the long-term predictor contribution alternatively can be viewed as an adaptive codebook contribution or as a long-term (pitch) filtering. The short-term excitation may be passed through a short-term inverse prediction filter (LPC) that uses the short-term (LPC) prediction coefficients quantized by the encoder to generate synthesized speech. The synthesized speech may then be passed through a post-filter that reduces perceptual coding noise.

These speech compression techniques have resulted in lowering the amount of bandwidth used to transmit a speech signal. However, further reduction in bandwidth is particular important in a communication system that has to allocate its resources to a large number of users. Accordingly, there is a need for systems and methods of speech coding that are capable of minimizing the average bit rate needed for speech representation, while providing high quality decompressed speech.

## DISCLOSURE OF INVENTION

This invention provides systems for encoding and decoding speech signals. The embodiments may use the CELP coding technique and prediction based coding as a framework to employ signal-processing functions using waveform matching and perceptual related techniques. These techniques allow the generation of synthesized speech that closely resembles the original speech by including perceptual features while maintaining a relatively low bit rate. One application of the embodiments is in wireless communication systems. In this application, the encoding of original speech, or the decoding to generate synthesized speech, may occur at mobile communication devices. In addition, encoding and decoding may occur within wireline-based systems or within other wireless communication systems to provide interfaces to wireline-based systems.

One embodiment of a speech compression system includes a full-rate codec, a half-rate codec, a quarter-rate codec and an eighth-rate codec each capable of encoding and decoding speech signals. The full-rate, half-rate, quarter-rate and eighth-rate codecs encode the speech signals at bit rates of 8.5 Kbps, 4 Kbps, 2 Kbps and 0.8 Kbps, respectively. The speech compression system performs a rate selection on a frame of a speech signal to select one of the codecs. The rate selection is performed on a frame-by-frame basis. Frames are created by dividing the speech signal into segments of a finite length of time. Since each frame may be coded with a different bit rate, the speech compression system is a variable-rate speech compression system that codes the speech at an average bit rate.

The rate selection is determined by characterization of each frame of the speech signal based on the portion of the speech signal contained in the particular frame. For example, frames may be characterized as stationary voiced, non-stationary voiced, unvoiced, background noise, silence etc. In addition, the rate selection is based on a Mode that the speech compression system is operating within. The different Modes indicate the desired average bit rate. The codecs are designed for optimized coding within the different characterizations of the speech signals. Optimal coding balances the desire to provide synthesized speech of the highest perceptual quality while maintaining the desired average bit rate, thereby maximizing use of the available bandwidth. During operation, the speech compression system selectively activates the codecs based on the Mode as well as characterization of the frame in an attempt to optimize the perceptual quality of the synthesized speech.

Once the full or the half-rate codec is selected by the rate selection, a type classification of the speech signal occurs to further optimize coding. The type classification may be a first type (i.e. a Type One) for frames containing a harmonic structure and a formant structure that do not change rapidly or a second type (i.e. a Type Zero) for all other frames. The bit allocation of the full-rate and half-rate codecs may be adjusted in response to the type classification to further optimize the coding of the frame. The adjustment of the bit allocation provides improved perceptual quality of the reconstructed speech signal by emphasizing different aspects of the speech signal within each frame.

Accordingly, the speech coder is capable of selectively activating the codecs to maximize the overall quality of a reconstructed speech signal while maintaining the desired average bit rate. Other systems, methods, features and advantages of the invention will be or will become apparent to one with skill in the art upon examination of the following figures and detailed description. It is intended that all such additional systems, methods, features and advantages be included within this description, be within the scope of the invention, and be protected by the accompanying claims.

## BRIEF DESCRIPTION OF DRAWINGS

The components in the figures are not necessarily to scale, emphasis instead being placed upon illustrating the principals of the invention. Moreover, in the figures, like reference numerals designate corresponding parts throughout the different views.

FIG. 1 is a block diagram of one embodiment of a speech compression system.

FIG. 2 is an expanded block diagram of one embodiment of the encoding system illustrated in Fig. 1.

FIG. 3 is an expanded block diagram of one embodiment of the decoding system illustrated in Fig. 1.

FIG. 4 is a table illustrating the bit allocation of one embodiment of the full-rate codec.

FIG. 5 is a table illustrating the bit allocation of one embodiment of the half-rate codec.

FIG. 6 is a table illustrating the bit allocation of one embodiment of the quarter-rate codec.

FIG. 7 is a table illustrating the bit allocation of one embodiment of the eighth-rate codec.

FIG. 8 is an expanded block diagram of one embodiment of the pre-processing module illustrated in Fig. 2.

FIG. 9 is an expanded block diagram of one embodiment of the initial frame-processing module illustrated in Fig. 2 for the full and half-rate codecs.

FIG. 10 is an expanded block diagram of one embodiment of the first sub-frame processing module illustrated in Fig. 2 for the full and half-rate codecs.

FIG. 11 is an expanded block diagram of one embodiment of the first frame processing module, the second sub-frame processing module and the second frame processing module illustrated in Fig. 2 for the full and half-rate codecs.

FIG. 12 is an expanded block diagram of one embodiment of the decoding system illustrated in Fig. 3 for the full and half-rate codecs.

## MODES FOR CARRYING OUT THE INVENTION

The embodiments are discussed with reference to speech signals, however, processing of any other signal is possible. It will also be understood that the numerical values disclosed may be numerically represented by floating point, fixed point, decimal, or other similar numerical representation that may cause slight variation in the values but will not compromise functionality. Further, functional blocks identified as modules are not intended to represent discrete structures and may be combined or further sub-divided in various embodiments.

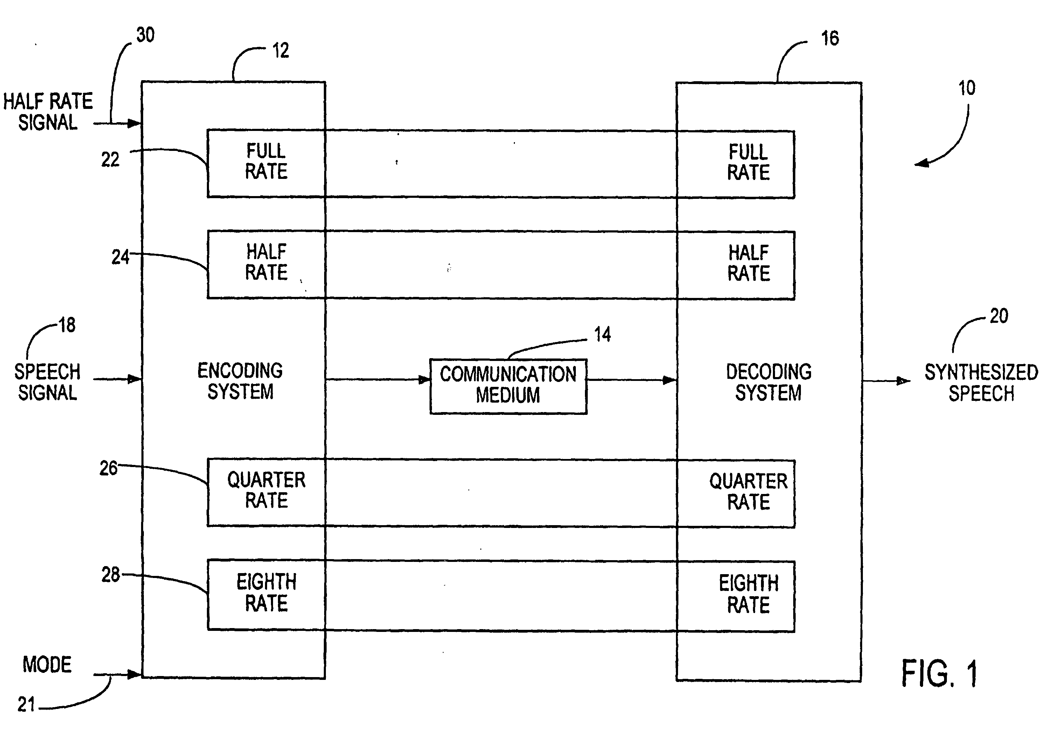

FIG. 1 is a block diagram of one embodiment of the speech compression system 10. The speech compression system 10 includes an encoding system 12, a communication medium 14 and a decoding system 16 that may be connected as illustrated. The speech compression system 10 may be any system capable of receiving and encoding a speech signal 18, and then decoding it to create post-processed synthesized speech 20. In a typical communication system, the wireless communication system is electrically connected with a public switched telephone network (PSTN) within the wireline-based communication system. Within the wireless communication system, a plurality of base stations are typically used to provide radio communication with mobile communication devices such as a cellular telephone or a portable radio transceiver.

The speech compression system 10 operates to receive the speech signal 18. The speech signal 18 emitted by a sender (not shown) can be, for example, captured by a microphone (not shown) and digitized by an analog-to-digital converter (not shown). The sender may be a human voice, a musical instrument or any other device capable of emitting analog signals. The speech signal 18 can represent any type of sound, such as, voice speech, unvoiced speech, background noise, silence, music etc.

The encoding system 12 operates to encode the speech signal 18. The encoding system 12 may be part of a mobile communication device, a base station or any other wireless or wireline communication device that is capable of receiving and encoding speech signals 18 digitized by an analog-to-digital converter. The wireline communication devices may include Voice over Internet Protocol (VoIP) devices and systems. The encoding system 12 segments the speech signal 18 into frames to generate a bitstream. One embodiment of the speech compression system 10 uses frames that comprise 160 samples that, at a sampling rate of 8000 Hz, correspond to 20 milliseconds per frame. The frames represented by the bitstream may be provided to the communication medium 14.

The communication medium 14 may be any transmission mechanism, such as a communication channel, radio waves, microwave, wire transmissions, fiber optic transmissions, or any medium capable of carrying the bitstream generated by the encoding system 12. The communication medium 14 may also include transmitting devices and receiving devices used in the transmission of the bitstream. An example embodiment of the communication medium 14 can include communication channels, antennas and associated transceivers for radio communication in a wireless communication system. The communication medium 14 also can be a storage mechanism, such as, a memory device, a storage media or other device capable of storing and retrieving the bitstream generated by the encoding system 12. The communication medium 14 operates to transmit the bitstream generated by the encoding system 12 to the decoding system 16.

The decoding system 16 receives the bitstream from the communication medium 14. The decoding system 14 may be part of a mobile communication device, a base station or other wireless or wireline communication device that is capable of receiving the bitstream. The decoding system 16 operates to decode the bitstream and generate the post-processed synthesized speech 20 in the form of a digital signal. The post-processed synthesized speech 20 may then be converted to an analog signal by a digital-to-analog converter (not shown). The analog output of the digital-to-analog converter may be received by a receiver (not shown) that may be a human ear, a magnetic tape recorder, or any other device capable of receiving an analog signal. Alternatively, a digital recording device, a speech recognition device, or any other device capable of receiving a digital signal may receive the post-processed synthesized speech 20.

One embodiment of the speech compression system 10 also includes a Mode line 21. The Mode line 21 carries a Mode signal that controls the speech compression system 10 by indicating the desired average bit rate for the bitstream. The Mode signal may be generated externally by, for example, a wireless communication system using a Mode signal generation module. The Mode signal generation module determines the Mode Signal based on a plurality of factors, such as, the desired quality of the post-processed synthesized speech 20, the available bandwidth, the services contracted by a user or any other relevant factor. The Mode signal is controlled and selected by the communication system that the speech compression system 10 is operating within. The Mode signal may be provided to the encoding system 12 to aid in the determination of which of a plurality of codecs may be activated within the encoding system 12.

The codecs comprise an encoder portion and a decoder portion that are located within the encoding system 12 and the decoding system 16, respectively. In one embodiment of the speech compression system 10 there are four codecs namely; a full-rate codec 22, a half-rate codec 24, a quarter-rate codec 26, and an eighth-rate codec 28. Each of the codecs 22, 24, 26, and 28 is operable to generate the bitstream. The size of the bitstream generated by each codec 22, 24, 26, and 28, and hence the bandwidth or capacity needed for transmission of the bitstream via the communication medium 14 is different.

In one embodiment, the full-rate codec 22, the half-rate codec 24, the quarter-rate codec 26 and the eighth-rate codec 28 generate 170 bits, 80 bits, 40 bits and 16 bits, respectively, per frame. The size of the bitstream of each frame corresponds to a bit rate, namely, 8.5 Kbps for the full-rate codec 22, 4.0 Kbps for the half-rate codec 24, 2.0 Kbps for the quarter-rate codec 26, and 0.8 Kbps for the eighth-rate codec 28. However, fewer or more codecs as well as other bit rates are possible in alternative embodiments. By processing the frames of the speech signal 18 with the various codecs, an average bit rate is achieved. The encoding system 12 determines which of the codecs 22, 24, 26, and 28 may be used to encode a particular frame based on characterization of the frame, and on the desired average bit rate provided by the Mode signal. Characterization of a frame is based on the portion of the speech signal 18 contained in the particular frame. For example, frames may be characterized as stationary voiced, non-stationary voiced, unvoiced, onset, background noise, silence etc.

The Mode signal on the Mode signal line 21 in one embodiment identifies a Mode 0, a Mode 1, and a Mode 2. Each of the three Modes provides a different desired average bit rate that can vary the percentage of usage of each of the codecs 22, 24, 26, and 28. Mode 0 may be referred to as a premium mode in which most of the frames may be coded with the full-rate codec 22; fewer of the frames may be coded with the half-rate codec 24; and frames comprising silence and background noise may be coded with the quarter-rate codec 26 and the eighth-rate codec 28. Mode 1 may be referred to as a standard mode in which frames with high information content, such as onset and some voiced frames, may be coded with the full-rate codec 22. In addition, other voiced and unvoiced frames may be coded with the half-rate codec 24, some unvoiced frames may be coded with the quarter-rate codec 26, and silence and stationary background noise frames may be coded with the eighth-rate codec 28.

Mode 2 may be referred to as an economy mode in which only a few frames of high information content may be coded with the full-rate codec 22. Most of the frames in Mode 2 may be coded with the half-rate codec 24 with the exception of some unvoiced frames that may be coded with the quarter-rate codec 26. Silence and stationary background noise frames may be coded with the eighth-rate codec 28 in Mode 2. Accordingly, by varying the selection of the codecs 22, 24, 26, and 28 the speech compression system 10 can deliver reconstructed speech at the desired average bit rate while attempting to maintain the highest possible quality. Additional Modes, such as, a Mode three operating in a super economy Mode or a half-rate max Mode in which the maximum codec activated is the half-rate codec 24 are possible in alternative embodiments.

Further control of the speech compression system 10 also may be provided by a half rate signal line 30. The half rate signal line 30 provides a half rate signaling flag. The half rate signaling flag may be provided by an external source such as a wireless communication system. When activated, the half rate signaling flag directs the speech compression system 10 to use the half-rate codec 24 as the maximum rate. Determination of when to activate the half rate signaling flag is performed by the communication system that the speech compression system 10 is operating within. Similar to the Mode signal determination, a half rate-signaling module controls activation of the half rate signaling flag based on a plurality of factors that are determined by the communication system. In alternative embodiments, the half rate signaling flag could direct the speech compression system 10 to use one codec 22, 24, 26, and 28 in place of another or identify one or more of the codecs 22, 24, 26, and 28 as the maximum or minimum rate.

In one embodiment of the speech compression system 10, the full and half-rate codecs 22 and 24 may be based on an eX-CELP (extended CELP) approach and the quarter and eighth-rate codecs 26 and 28 may be based on a perceptual matching approach. The eX-CELP approach extends the traditional balance between perceptual matching and waveform matching of traditional CELP, and is described in a paper entitled "EX-CECP: A SPEECH CODING PARADIGM." Published in The Proceedings of the ICASSP 2001 Salt Lake City, UTAH, May 2001, pp 689-692 by Gao et al. In particular, the eX-CELP approach categorizes the frames using a rate selection and a type classification that will be described later. Within the different categories of frames, different encoding approaches may be utilized that have different perceptual matching, different waveform matching, and different bit assignments. The perceptual matching approach of the quarter-rate codec 26 and the eighth-rate codec 28 do not use waveform matching and instead concentrate on the perceptual aspects when encoding frames.

The coding of each frame with either the eX-CELP approach or the perceptual matching approach may be based on further dividing the frame into a plurality of subframes. The subframes may be different in size and in number for each codec 22, 24, 26, and 28. In addition, with respect to the eX-CELP approach, the subframes may be different for each category. Within the subframes, speech parameters and waveforms may be coded with several predictive and non-predictive scalar and vector quantization techniques. In scalar quantization a speech parameter or element may be represented by an index location of the closest entry in a representative table of scalars. In vector quantization several speech parameters may be grouped to form a vector. The vector may be represented by an index location of the closest entry in a representative table of vectors.

In predictive coding, an element may be predicted from the past. The element may be a scalar or a vector. The prediction error may then be quantized, using a table of scalars (scalar quantization) or a table of vectors (vector quantization). The eX-CELP coding approach, similarly to traditional CELP, uses the powerful Analysis-by-Synthesis (ABS) scheme for choosing the best representation for several parameters. In particular, the parameters may be the adaptive codebook, the fixed codebook, and their corresponding gains. The ABS scheme uses inverse prediction filters and perceptual weighting measures for selecting the best codebook entries.

One implementation of an embodiment of the speech compression system 10 may be in a signal-processing device such as a Digital Signal Processing (DSP) chip, a mobile communication device or a radio transmission base station. The signal-processing device may be programmed with source code. The source code may be first translated into fixed point, and then translated into the programming language that is specific to the signal-processing device. The translated source code may then be downloaded and run in the signal-processing device. One example of source code is the C language computer program utilized by one embodiment of the speech compression system 10 that is included in the attached microfiche appendix as Appendix A and B.

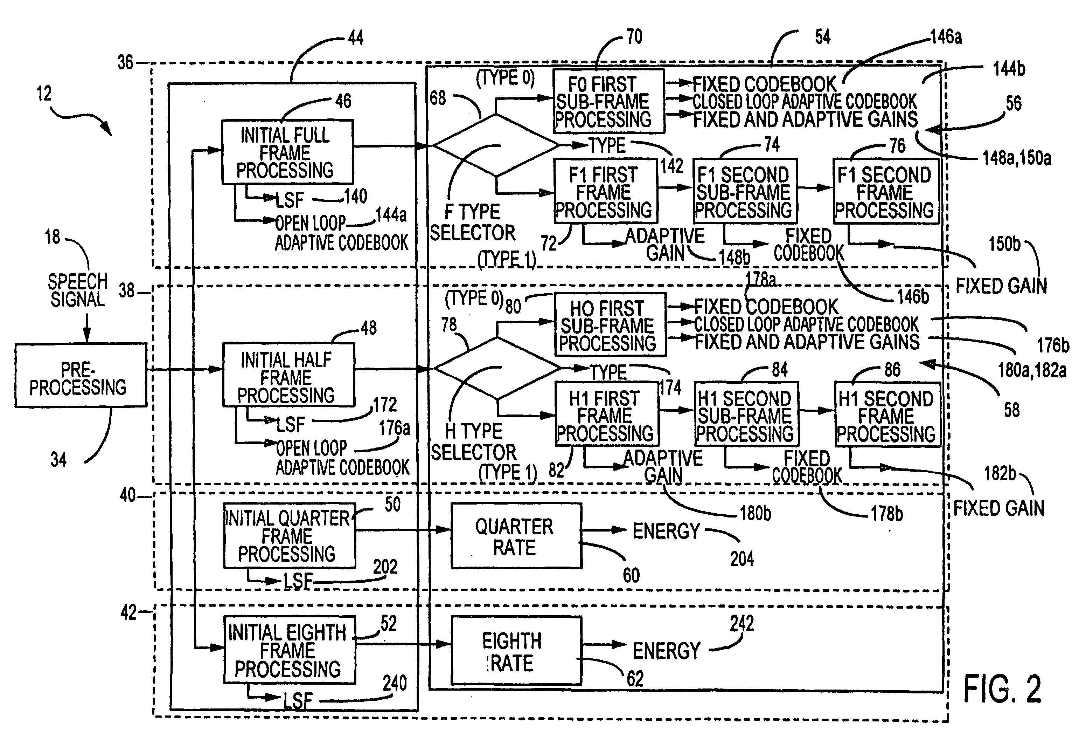

FIG. 2 is a more detailed block diagram of the encoding system 12 illustrated in FIG. 1. One embodiment of the encoding system 12 includes a pre-processing module 34, a full-rate encoder 36, a half-rate encoder 38, a quarter-rate encoder 40 and an eighth-rate encoder 42 that may be connected as illustrated. The rate encoders 36, 38, 40, and 42 include an initial frame-processing module 44 and an excitation-processing module 54.

The speech signal 18 received by the encoding system 12 is processed on a frame level by the pre-processing module 34. The pre-processing module 34 is operable to provide initial processing of the speech signal 18. The initial processing can include filtering, signal enhancement, noise removal, amplification and other similar techniques capable of optimizing the speech signal 18 for subsequent encoding.

The full, half, quarter and eighth-rate encoders 36, 38, 40, and 42 are the encoding portion of the full, half, quarter and eighth-rate codecs 22, 24, 26, and 28, respectively. The initial frame-processing module 44 performs initial frame processing, speech parameter extraction and determines which of the rate encoders 36, 38, 40, and 42 will encode a particular frame. The initial frame-processing module 44 may be illustratively sub-divided into a plurality of initial frame processing modules, namely, an initial full frame processing module 46, an initial half frame-processing module 48, an initial quarter frame-processing module 50 and an initial eighth frame-processing module 52. However, it should be noted that the initial frame-processing module 44 performs processing that is common to all the rate encoders 36, 38, 40, and 42 and particular processing that is particular to each rate encoder 36, 38, 40, and 42. The sub-division of the initial frame-processing module 44 into the respective initial frame processing modules 46, 48, 50, and 52 corresponds to a respective rate encoder 36, 38, 40, and 42.

The initial frame-processing module 44 performs common processing to determine a rate selection that activates one of the rate encoders 36, 38, 40, and 42. In one embodiment, the rate selection is based on the characterization of the frame of the speech signal 18 and the Mode the speech compression system 10 is operating within. Activation of one of the rate encoders 36, 38, 40, and 42 correspondingly activates one of the initial frame-processing modules 46, 48, 50, and 52.

The particular initial frame-processing module 46, 48, 50, and 52 is activated to encode aspects of the speech signal 18 that are common to the entire frame. The encoding by the initial frame-processing module 44 quantizes parameters of the speech signal 18 contained in a frame. The quantized parameters result in generation of a portion of the bitstream. In general, the bitstream is the compressed representation of a frame of the speech signal 18 that has been processed by the encoding system 12 through one of the rate encoders 36, 38, 40, and 42.

In addition to the rate selection, the initial frame-processing module 44 also performs processing to determine a type classification for each frame that is processed by the full and half-rate encoders 36 and 38. The type classification of one embodiment classifies the speech signal 18 represented by a frame as a first type (i.e., a Type One) or as a second type (i.e., a Type Zero). The type classification of one embodiment is dependent on the nature and characteristics of the speech signal 18. In an alternate embodiment, additional type classifications and supporting processing may be provided.

Type One classification includes frames of the speech signal 18 that exhibit stationary behavior. Frames exhibiting stationary behavior include a harmonic structure and a formant structure that do not change rapidly. All other frames may be classified with the Type Zero classification. In alternative embodiments, additional type classifications may classify frames into additional classification based on time-domain, frequency domain, etc. The type classification optimizes encoding by the initial full-rate frame-processing module 46 and the initial half-rate frame-processing module 48, as will be later described. In addition, both the type classification and the rate selection may be used to optimize encoding by portions of the excitation-processing module 54 that correspond to the full and half-rate encoders 36 and 38.

One embodiment of the excitation-processing module 54 may be sub-divided into a full-rate module 56, a half-rate module 58, a quarter-rate module 60, and an eighth-rate module 62. The rate modules 56, 58, 60, and 62 correspond to the rate encoders 36, 38, 40, and 42 as illustrated in FIG. 2. The full and half-rate modules 56 and 58 of one embodiment both include a plurality of frame processing modules and a plurality of subframe processing modules that provide substantially different encoding as will be discussed.

The portion of the excitation processing module 54 for both the full and half-rate encoders 36 and 38 include type selector modules, first subframe processing modules, second subframe processing modules, first frame processing modules and second subframe processing modules. More specifically, the full-rate module 56 includes an F type selector module 68, an F0 first subframe processing module 70, an F1 first frame-processing module 72, an F1 second subframe processing module 74 and an F1 second frame-processing module 76. The term "F" indicates full-rate, and "0" and "1" signify Type Zero and Type One, respectively. Similarly, the half-rate module 58 includes an H type selector module 78, an H0 first subframe processing module 80, an H1 first frame-processing module 82, an H1 second subframe processing module 84, and an H 1 second frame-processing module 86.

The F and H type selector modules 68,78 direct the processing of the speech signals 18 to further optimize the encoding process based on the type classification. Classification as Type One indicates the frame contains a harmonic structure and a formant structure that do not change rapidly, such as stationary voiced speech. Accordingly, the bits used to represent a frame classified as Type One may be allocated to facilitate encoding that takes advantage of these aspects in representing the frame. Classification as Type Zero indicates the frame may exhibit non-stationary behavior, for example, a harmonic structure and a formant structure that changes rapidly or the frame may exhibit stationary unvoiced or noise-like characteristics. The bit allocation for frames classified as Type Zero may be consequently adjusted to better represent and account for this behavior.

For the full rate module 56, the F0 first subframe-processing module 70 generates a portion of the bitstream when the frame being processed is classified as Type Zero. Type Zero classification of a frame activates the F0 first subframe-processing module 70 to process the frame on a subframe basis. The F1 first frame-processing module 72, the F1 second subframe processing module 74, and the F1 second frame-processing modules 76 combine to generate a portion of the bitstream when the frame being processed is classified as Type One. Type One classification involves both subframe and frame processing within the full rate module 56.

Similarly, for the half rate module 58, the H0 first subframe-processing module 80 generates a portion of the bitstream on a sub-frame basis when the frame being processed is classified as Type Zero. Further, the H1 first frame-processing module 82, the H1 second subframe processing module 84, and the H1 second frame-processing module 86 combine to generate a portion of the bitstream when the frame being processed is classified as Type One. As in the full rate module 56, the Type One classification involves both subframe and frame processing.

The quarter and eighth-rate modules 60 and 62 are part of the quarter and eighth-rate encoders 40 and 42, respectively, and do not include the type classification. The type classification is not included due to the nature of the frames that are processed. The quarter and eighth-rate modules 60 and 62 generate a portion of the bitstream on a subframe basis and a frame basis, respectively, when activated.

The rate modules 56, 58, 60, and 62 generate a portion of the bitstream that is assembled with a respective portion of the bitstream that is generated by the initial frame processing modules 46, 48, 50, and 52 to create a digital representation of a frame. For example, the portion of the bitstream generated by the initial full-rate frame-processing module 46 and the full-rate module 56 may be assembled to form the bitstream generated when the full-rate encoder 36 is activated to encode a frame. The bitstreams from each of the encoders 36, 38, 40, and 42 may be further assembled to form a bitstream representing a plurality of frames of the speech signal 18. The bitstream generated by the encoders 36, 38, 40, and 42 is decoded by the decoding system 16.

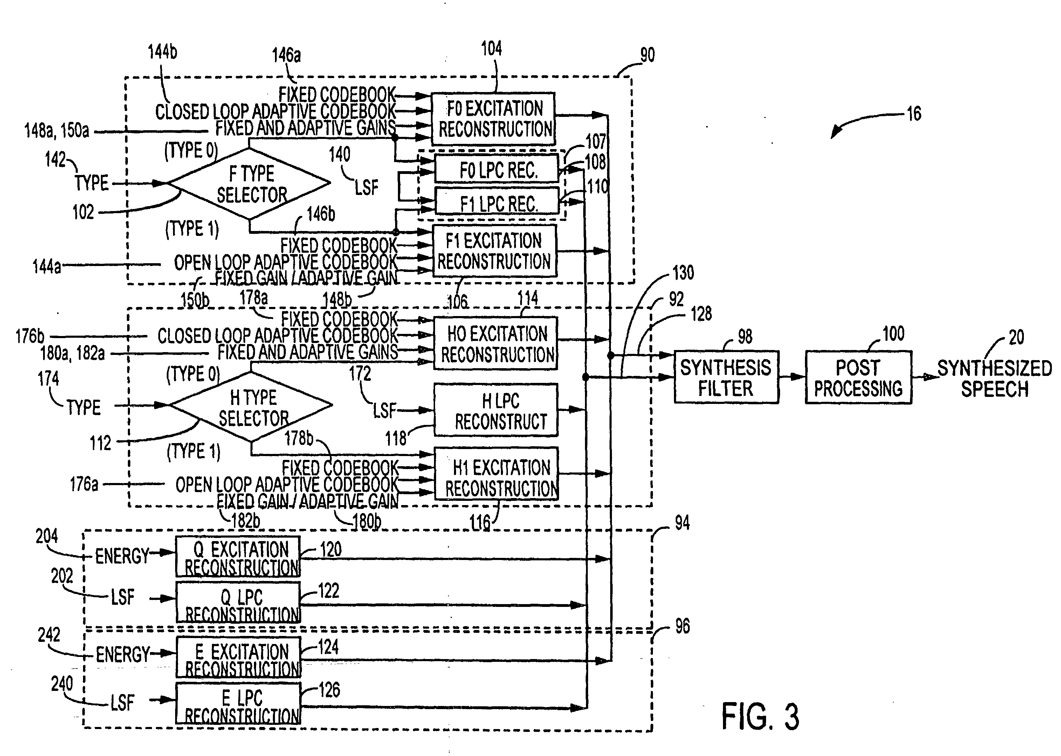

FIG. 3 is an expanded block diagram of the decoding system 16 illustrated in FIG. 1. One embodiment of the decoding system 16 includes a full-rate decoder 90, a half-rate decoder 92, a quarter-rate decoder 94, an eighth-rate decoder 96, a synthesis filter module 98 and a post-processing module 100. The full, half, quarter and eighth-rate decoders 90, 92, 94, and 96, the synthesis filter module 98 and the post-processing module 100 are the decoding portion of the full, half, quarter and eighth-rate codecs 22, 24, 26, and 28.

The decoders 90, 92, 94, and 96 receive the bitstream and decode the digital signal to reconstruct different parameters of the speech signal 18. The decoders 90, 92, 94, and 96 may be activated to decode each frame based on the rate selection. The rate selection may be provided from the encoding system 12 to the decoding system 16 by a separate information transmittal mechanism, such as a control channel in a wireless communication system. In this example embodiment, the rate selection may be provided to the mobile communication devices as part of broadcast beacon signals generated by the base stations within the wireless communications system. In general, the broadcast beacon signals are generated to provide identifying information used to establish communications between the base stations and the mobile communication devices.

The synthesis filter 98 and the post-processing module 100 are part of the decoding process for each of the decoders 90, 92, 94, and 96. Assembling the parameters of the speech signal 18 that are decoded by the decoders 90, 92, 94, and 96 using the synthesis filter 98, generates synthesized speech. The synthesized speech is passed through the post-processing module 100 to create the post-processed synthesized speech 20.

One embodiment of the full-rate decoder 90 includes an F type selector 102 and a plurality of excitation reconstruction modules. The excitation reconstruction modules comprise an F0 excitation reconstruction module 104 and an F1 excitation reconstruction module 106. In addition, the full-rate decoder 90 includes a linear prediction coefficient (LPC) reconstruction module 107. The LPC reconstruction module 107 comprises an F0 LPC reconstruction module 108 and an F1 LPC reconstruction module 110.

Similarly, one embodiment of the half-rate decoder 92 includes an H type selector 112 and a plurality of excitation reconstruction modules. The excitation reconstruction modules comprise an H0 excitation reconstruction module 114 and an H1 excitation reconstruction module 116. In addition, the half-rate decoder 92 comprises a linear prediction coefficient (LPC) reconstruction module that is an H LPC reconstruction module 118. Although similar in concept, the full and half-rate decoders 90 and 92 are designated to decode bitstreams from the corresponding full and half-rate encoders 36 and 38, respectively.

The F and H type selectors 102 and 112 selectively activate respective portions of the full and half-rate decoders 90 and 92 depending on the type classification. When the type classification is Type Zero, the F0 or H0 excitation reconstruction modules 104 or 114 are activated. Conversely, when the type classification is Type One, the F1 or H1 excitation reconstruction modules 106 or 116 are activated. The F0 or F1 LPC reconstruction modules 108 or 110 are activated by the Type Zero and Type One type classifications, respectively. The H LPC reconstruction module 118 is activated based solely on the rate selection.

The quarter-rate decoder 94 includes a Q excitation reconstruction module 120 and a Q LPC reconstruction module 122. Similarly, the eighth-rate decoder 96 includes an E excitation reconstruction module 124 and an E LPC reconstruction module 126. Both the respective Q or E excitation reconstruction modules 120 or 124 and the respective Q or E LPC reconstruction modules 122 or 126 are activated based solely on the rate selection.

Each of the excitation reconstruction modules is operable to provide the short-term excitation on a short-term excitation line 128 when activated. Similarly, each of the LPC reconstruction modules operate to generate the short-term prediction coefficients on a short-term prediction coefficients line 130. The short-term excitation and the short-term prediction coefficients are provided to the synthesis filter 98. In addition, in one embodiment, the short-term prediction coefficients are provided to the post-processing module 100 as illustrated in FIG. 3.

The post-processing module 100 can include filtering, signal enhancement, noise modification, amplification, tilt correction and other similar techniques capable of improving the perceptual quality of the synthesized speech. The post-processing module 100 is operable to decrease the audible noise without degrading the synthesized speech. Decreasing the audible noise may be accomplished by emphasizing the formant structure of the synthesized speech or by suppressing only the noise in the frequency regions that are perceptually not relevant for the synthesized speech. Since audible noise becomes more noticeable at lower bit rates, one embodiment of the post-processing module 100 may be activated to provide post-processing of the synthesized speech differently depending on the rate selection. Another embodiment of the post-processing module 100 may be operable to provide different post-processing to different groups of the decoders 90, 92, 94, and 96 based on the rate selection.

During operation, the initial frame-processing module 44 illustrated in FIG. 2 analyzes the speech signal 18 to determine the rate selection and activate one of the codecs 22, 24, 26, and 28. If for example, the full-rate codec 22 is activated to process a frame based on the rate selection, the initial full-rate frame-processing module 46 determines the type classification for the frame and generates a portion of the bitstream. The full-rate module 56, based on the type classification, generates the remainder of the bitstream for the frame.

The bitstream may be received and decoded by the full-rate decoder 90 based on the rate selection. The full-rate decoder 90 decodes the bitstream utilizing the type classification that was determined during encoding. The synthesis filter 98 and the post-processing module 100 use the parameters decoded from the bitstream to generate the post-processed synthesized speech 20. The bitstream that is generated by each of the codecs 22, 24, 26, and 28 contains significantly different bit allocations to emphasize different parameters and/or characteristics of the speech signal 18 within a frame.

### 1.0 BIT ALLOCATION

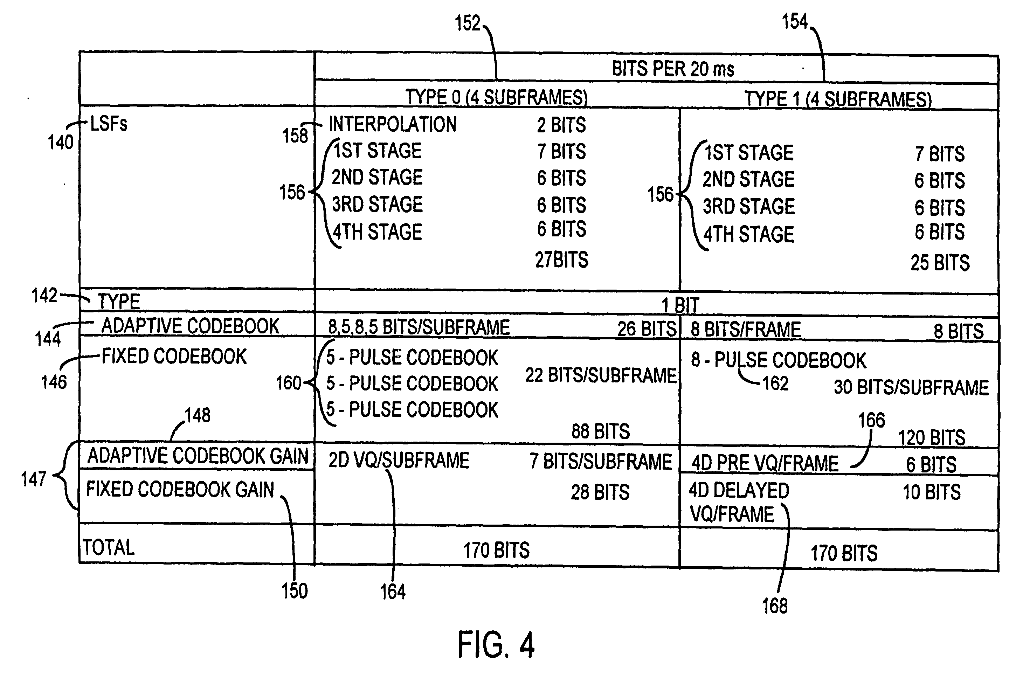

FIGS. 4, 5, 6 and 7 are tables illustrating one embodiment of the bit-allocation for the full-rate codec 22, the half-rate codec 24, the quarter-rate codec 26, and the eighth-rate codec 28, respectively. The bit-allocation designates the portion of the bitstream generated by the initial frame-processing module 44, and the portion of the bitstream generated by the excitation-processing module 54 within a respective encoder 36, 38, 40, and 42. In addition the bit-allocation designates the number of bits in the bitstream that represent a frame. Accordingly, the bit rate varies depending on the codec 22, 24, 26, and 28 that is activated. The bitstream may be classified into a first portion and a second portion depending on whether the representative bits are generated on a frame basis or on a subframe basis, respectively, by the encoding system 12. As will be described later, the first portion and the second portion of the bitstream vary depending on the codec 22, 24, 26, and 28 selected to encode and decode a frame of the speech signal 18.

### 1.1 Bit Allocation for the Full-Rate Codec

Referring now to FIGS. 2, 3, and 4, the full-rate bitstream of the full-rate codec 22 will be described. Referring now to FIG. 4, the bit allocation for the full-rate codec 22 includes a line spectrum frequency (LSF) component 140, a type component 142, an adaptive codebook component 144, a fixed codebook component 146 and a gain component 147. The gain component 147 comprises an adaptive codebook gain component 148 and a fixed codebook gain component 150. The bitstream allocation is further defined by a Type Zero column 152 and a Type One column 154. The Type Zero and Type One columns 152 and 154 designate the allocation of the bits in the bitstream based on the type classification of the speech signal 18 as previously discussed. In one embodiment, the Type Zero column 152 and the Type One column 154 both use 4 subframes of 5 milliseconds each to process the speech signals 18.

The initial full frame-processing module 46, illustrated in FIG. 2, generates the LSF component 140. The LSF component 140 is generated based on the short-term predictor parameters. The short-term predictor parameters are converted to a plurality of line spectrum frequencies (LSFs). The LSFs represent the spectral envelope of a frame. In addition, a plurality of predicted LSFs from the LSFs of previous frames are determined. The predicted LSFs are subtracted from the LSFs to create an LSFs prediction error. In one embodiment, the LSFs prediction error comprises a vector of 10 parameters. The LSF prediction error is combined with the predicted LSFs to generate a plurality of quantized LSFs. The quantized LSFs are interpolated and converted to form a plurality of quantized LPC coefficients $Aq(z)$ for each subframe as will be discussed in detail later. In addition, the LSFs prediction error is quantized to generate the LSF component 140 that is transmitted to the decoding system 16.

When the bitstream is received at the decoding system 16, the LSF component 140 is used to locate a quantized vector representing a quantized LSFs prediction error. The quantized LSFs prediction error is added to the predicted LSFs to generate quantized LSFs. The predicted LSFs are determined from the LSFs of previous frames within the decoding system 16 similarly to the encoding system 12. The resulting quantized LSFs may be interpolated for each subframe using a predetermined weighting. The predetermined weighting defines an interpolation path that may be fixed or variable. The interpolation path is between the quantized LSFs of the previous frame and the quantized LSFs of the current frame. The interpolation path may be used to provide a spectral envelope representation for each subframe in the current frame.

For frames classified as Type Zero, one embodiment of the LSF component 140 is encoded utilizing a plurality of stages 156 and an interpolation element 158 as illustrated in FIG. 4. The stages 156 represent the LSFs prediction error used to code the LSF component 140 for a frame. The interpolation element 158 may be used to provide a plurality of interpolation paths between the quantized LSFs of the previous frame and the quantized LSFs of the frame currently being processed. In general, the interpolation element 158 represents selectable adjustment in the contour of the line spectrum frequencies (LSFs) during decoding. Selectable adjustment may be used due to the non-stationary spectral nature of frames that are classified as Type Zero. For frames classified as Type One, the LSF component 140 may be encoded using only the stages 156 and a predetermined linear interpolation path due to the stationary spectral nature of such frames.

One embodiment of the LSF component 140 includes 2 bits to encode the interpolation element 158 for frames classified as Type Zero. The bits identify the particular interpolation path. Each of the interpolation paths adjust the weighting of the previous quantized LSFs for each subframe and the weighting of the current quantized LSFs for each subframe. Selection of an interpolation path may be determined based on the degree of variations in the spectral envelope between subsequent subframes. For example, if there is substantial variation in the spectral envelope in the middle of the frame, the interpolation element 158 selects an interpolation path that decreases the influence of the quantized LSFs from the previous frame. One embodiment of the interpolation element 158 can represent any one of four different interpolation paths for each subframe.

The predicted LSFs may be generated using a plurality of moving average predictor coefficients. The predictor coefficients determine how much of the LSFs of past frames are used to predict the LSFs of the current frame. The predictor coefficients within the full-rate codec 22 use an LSF predictor coefficients table. The table mav be generally illustrated by the following matrix:

$$
\begin{bmatrix}
El_1, & El_2, & \ldots & El_n \\
\cdot & \cdot & \ldots & \cdot \\
\cdot & \cdot & \ldots & \cdot \\
\cdot & \cdot & \ldots & \cdot \\
\cdot & \cdot & \ldots & \cdot \\
\cdot & \cdot & \ldots & \cdot \\
Em_1, & Em_2 & \ldots & Em_n
\end{bmatrix}
$$

**TABLE 1**

In one embodiment, m equals 2 and n equals 10. Accordingly, the prediction order is two and there are two vectors of predictor coefficients, each comprising 10 elements. One embodiment of the LSF predictor coefficients table is titled "Float64 B_85k" and is included in Appendix B of the attached microfiche appendix.

Once the predicted LSFs have been determined, the LSFs prediction error may be calculated using the actual LSFs. The LSFs prediction error may be quantized using a full dimensional multi-stage quantizer. An LSF prediction error quantization table containing a plurality of quantization vectors represents each stage 156 that may be used with the multi-stage quantizer. The multistage quantizer determines a portion of the LSF component 140 for each stage 156. The determination of the portion of the LSF component 140 is based on a pruned search approach. The pruned search approach determines promising quantization vector candidates from each stage. At the conclusion of the determination of candidates for all the stages, a decision occurs simultaneously that selects the best quantization vectors for each stage.

In the first stage, the multistage quantizer determines a plurality of candidate first stage quantization errors. The candidate first stage quantization errors are the difference between the LSFs prediction error and the closest matching quantization vectors located in the first stage. The multistage quantizer then determines a plurality of candidate second stage quantization errors by identifying the quantization vectors located in the second stage that best match the candidate first stage quantization errors. This iterative process is completed for each of the stages and promising candidates are kept from each stage. The final selection of the best representative quantization vectors for each stage simultaneously occurs when the candidates have been determined for all the stages. The LSF component 140 includes index locations of the closest matching quantization vectors from each stage. One embodiment of the LSF component 140 includes 25 bits to encode the index locations within the stages 156. The LSF prediction error quantization table for the quantization approach may be illustrated generally by the following matrix:

$$
\begin{bmatrix}
\begin{bmatrix}
V1_1, & V1_2, & \ldots & V1_n \\
\cdot & \cdot & \ldots & \cdot \\
\cdot & \cdot & \ldots & \cdot \\
\cdot & \cdot & \ldots & \cdot \\
\cdot & \cdot & \ldots & \cdot \\
\cdot & \cdot & \ldots & \cdot \\
Vr_1, & Vr_2 & \ldots & Vr_n
\end{bmatrix}_1 \\
\begin{bmatrix}
V1_1, & V1_2, & \ldots & V1_n \\
\cdot & \cdot & \ldots & \cdot \\
\cdot & \cdot & \ldots & \cdot \\
\cdot & \cdot & \ldots & \cdot \\
\cdot & \cdot & \ldots & \cdot \\
Vs_1, & Vs_2 & \ldots & Vs_n
\end{bmatrix}_j
\end{bmatrix}
$$

**TABLE 2**

One embodiment of the quantization table for both the Type Zero and the Type One classification uses four stages (j=4) in which each quantization vector is represented by 10 elements (n=10). The stages 156 of this embodiment include 128 quantization vectors (r=128) for one of the stages 156, and 64 quantization vectors (s=64) in the remaining stages 156. Accordingly, the index location of the quantization vectors within the stages 156 may be encoded using 7 bits for the one of the stages 156 that includes 128 quantization vectors. In addition, index locations for each of the stages 156 that include 64 quantization vectors may be encoded using 6 bits. One embodiment of the LSF prediction error quantization table used for both the Type Zero and Type One classification is titled "Float64 CBes_85k" and is included in Appendix B of the attached microfiche appendix.

Within the decoding system 16, the F0 or F1 LPC reconstruction modules 108, 110 in the full-rate decoder 90 obtain the LSF component 140 from the bitstream as illustrated in FIG. 3. The LSF component 140 may be used to reconstruct the quantized LSFs as previously discussed. The quantized LSFs may be interpolated and converted to form the linear prediction coding coefficients for each subframe of the current frame.

For Type Zero classification, reconstruction may be performed by the F0 LPC reconstruction module 108. Reconstruction involves determining the predicted LSFs, decoding the quantized LSFs prediction error and reconstructing the quantized LSFs. In addition, the quantized LSFs may be interpolated using the identified interpolation path. As previously discussed, one of the four interpolation paths is identified to the F0 LPC reconstruction module 108 by the interpolation element 158 that forms a part of the LSF component 140. Reconstruction of the Type One classification involves the use of the predetermined linear interpolation path and the LSF prediction error quantization table by the F1 LPC reconstruction module 110. The LSF component 140 forms part of the first portion of the bitstream since it is encoded on a frame basis in both the Type Zero and the Type One classifications.

The type component 142 also forms part of the first portion of the bitstream. As illustrated in FIG. 2, the F type selector module 68 generates the type component 142 to represent the type classification of a particular frame. Referring now to FIG. 3, the F type selector module 102 in the full-rate decoder 90 receives the type component 142 from the bitstream.

One embodiment of the adaptive codebook component 144 may be an open loop adaptive codebook component 144a or a closed loop adaptive codebook component 144b. The open or closed loop adaptive codebook component 144a, 144b is generated by the initial full frame-processing module 46 or the F0 first subframe-processing module 70, respectively, as illustrated in FIG. 2. The open loop adaptive codebook component 144a may be replaced by the closed loop adaptive codebook component 144b in the bitstream when the frame is classified as Type Zero. In general, the open loop designation refers to processing on a frame basis that does not involve analysis-by-synthesis (ABS). The closed loop processing is performed on a subframe basis and includes analysis-by-synthesis (ABS).

Encoding the pitch lag, which is based on the periodicity of the speech signal 18, generates the adaptive codebook component 144. The open loop adaptive codebook component 144a is generated for a frame; whereas the closed loop adaptive codebook component 144b is generated on a subframe basis. Accordingly, the open loop adaptive codebook component 144a is part of the first portion of the bitstream and the closed loop adaptive codebook component 144b is part of the second portion of the bitstream. In one embodiment, as illustrated in Fig. 4, the open loop adaptive codebook component 144a comprises 8 bits and the closed loop adaptive codebook component 144b comprises 26 bits. The open loop adaptive codebook component 144a and the closed loop adaptive codebook component 144b may be generated using an adaptive codebook vector that will be described later. Referring now to FIG. 3, the decoding system 16 receives the open or closed loop adaptive codebook component 144a or 144b. The open or closed loop adaptive codebook component 144a or 144b is decoded by the F0 or F1 excitation reconstruction module 104 or 106, respectively.

One embodiment of the fixed codebook component 146 may be a Type Zero fixed codebook component 146a or a Type One fixed codebook component 146b. The Type Zero fixed codebook component 146a is generated by the F0 first subframe-processing module 70 as illustrated in FIG. 2. The F1 subframe-processing module 72 generates the Type One fixed codebook component 146b. The Type Zero or Type One fixed codebook component 146a or 146b is generated using a fixed codebook vector and synthesis-by-analysis on a subframe basis that will be described later. The fixed codebook component 146 represents the long-term residual of a subframe using an n-pulse codebook, where n is the number of pulses in the codebook.

Referring now to Fig. 4, the Type Zero fixed codebook component 146a of one embodiment comprises 22 bits per subframe. The Type Zero fixed codebook component 146a includes identification of one of a plurality of n-pulse codebooks, pulse locations in the codebook, and the signs of representative pulses (quantity "n") that correspond to the pulse locations. In an example embodiment, up to two bits designate which one of three n-pulse codebooks has been encoded. Specifically, the first of the two bits is set to "1" to designate the first of the three n-pulse codebooks is used. If the first bit is set to "0," the second of the two bits designates whether the second or the third of the three n-pulse codebooks are used. Accordingly, in the example embodiment, the first of the three n-pulse codebooks has 21 bits to represent the pulse locations and signs, and the second and third of the three n-pulse codebooks have 20 bits available.

Each of the representative pulses within one of the n-pulse codebooks includes a corresponding track. The track is a list of sample locations in a subframe where each sample location in the list is one of the pulse locations. A subframe being encoded may be divided into a plurality of sample locations where each of the sample locations contains a sample value. The tracks of the corresponding representative pulses list only a portion of the sample locations from a subframe. Each of the representative pulses within one of the n-pulse codebooks may be represented by one of the pulse locations in the corresponding track.

During operation, each of the representative pulses is sequentially placed in each of the pulse locations in the corresponding track. The representative pulses are converted to a signal that may be compared to the sample values in the sample locations of the subframe using ABS. The representative pulses are compared to the sample values in those sample locations that are later in time than the sample location of the pulse location. The pulse location that minimizes the difference between the representative pulse and the sample values that are later in time forms a portion of the Type Zero fixed codebook component 146a. Each of the representative pulses in a selected n-pulse codebook may be represented by a corresponding pulse location that forms a portion of the Type Zero fixed codebook component 146a. The tracks are contained in track tables that can generally be represented by the following matrix:

$$
\begin{bmatrix}
P1_1, & P1_2, & \ldots & P1_f \\
P2_1, & P2_2, & \ldots & P2_g \\
P3_1, & P3_2, & \ldots & P3_h \\
P4_1, & P4_2, & \ldots & P4_i \\
\cdot & \cdot & \ldots & \cdot \\
\cdot & \cdot & \ldots & \cdot \\
Pn_1, & Pn_2 & \ldots & Pn_j
\end{bmatrix}
$$

**TABLE 3**

One embodiment of the track tables is the tables entitled "static short track_5_4_0," "static short track_5_3_2," and "static short track_5_3_1" within the library titled "tracks.tab" that is included in Appendix B of the attached microfiche appendix.

In the example embodiment illustrated in Fig. 4, the n-pulse codebooks are three 5-pulse codebooks 160 where the first of the three 5-pulse codebooks 160 includes 5 representative pulses therefore n=5. A first representative pulse has a track that includes 16 (f=16) of the 40 sample locations in the subframe. The first representative pulse from the first of the three 5-pulse codebooks 160 are compared with the sample values in the sample locations. One of the sample locations present in the track associated with the first representative pulse is identified as the pulse location using 4 bits. The sample location that is identified in the track is the sample location in the subframe that minimizes the difference between the first representative pulse and the sample values that are later in time as previously discussed. Identification of the pulse location in the track forms a portion of the Type Zero fixed codebook component 146a.

In this example embodiment, the second and fourth representative pulses have corresponding tracks with 16 sample locations (g and i = 16) and the third and fifth representative pulses have corresponding tracks with 8 sample locations (h and j = 8). Accordingly, the pulse locations for the second and fourth representative pulses are identified using 4 bits and the pulse locations of the third and fifth representative pulses are identified using 3 bits. As a result, the Type Zero fixed codebook component 146a for the first of the three 5-pulse codebooks 160 includes 18 bits for identifying the pulse locations.

The signs of the representative pulses in the identified pulse locations may also be identified in the Type Zero fixed codebook component 146a. In the example embodiment, one bit represents the sign for the first representative pulse, one bit represents a combined sign for both the second and fourth representative pulses and one bit represents the combined sign for the third and the fifth representative pulses. The combined sign uses the redundancy of the information in the pulse locations to transmit two distinct signs with a single bit. Accordingly, the Type Zero fixed codebook component 146a for the first of the three 5-pulse codebooks 160 includes three bits for the sign designation for a total of 21 bits.

In an example embodiment, the second and third of the three 5-pulse codebooks 160 also include 5 representative pulses (n=5) and the tracks in the track table each comprise 8 sample locations (f,g,h,i,j = 8). Accordingly, the pulse locations for each of the representative pulses in the second and third of the three 5-pulse codebook 160 are identified using 3 bits. In addition, in this example embodiment, the signs for each of the pulse locations are identified using 1 bit.

For frames classified as Type One, in an example embodiment, the n-pulse codebook is an 8-pulse codebook 162 (n=8). The 8-pulse codebook 162 is encoded using 30 bits per subframe to create one embodiment of the Type One fixed codebook component 146b. The 30 bits includes 26 bits identifying pulse locations using tracks as in the Type Zero classification, and 4 bits identifying the signs. One embodiment of the track table is the table entitled "static INT16 track_8_4_0" within the library titled "tracks.tab" that is included in Appendix B of the attached microfiche appendix.

In the example embodiment, the tracks associated with the first and fifth representative pulses comprise 16 sample locations that are encoded using 4 bits. The tracks associated with the remaining representative pulses comprise 8 sample locations that are encoded using 3 bits. The first and fifth representative pulses, the second and sixth representative pulses, the third and seventh representative pulses, and the fourth and eighth representative pulses use the combined signs for both respective representative pulses. As illustrated in FIG. 3, when the bitstream is received by the decoding system 16, the F0 or the F1 excitation reconstruction modules 104 or 106 decode the pulse locations of the tracks. The pulse locations of the tracks are decoded by the F0 or the F1 excitation reconstruction modules 104 or 106 for one of the three 5-pulse codebooks 160 or the 8-pulse codebook 162, respectively. The fixed codebook component 146 is part of the second portion of the bitstream since it is generated on a subframe basis.

Referring again to FIG. 4, the gain component 147, in general, represents the adaptive and fixed codebook gains. For Type Zero classification, the gain component 147 is a Type Zero adaptive and fixed codebook gain component 148a, 150a representing both the adaptive and the fixed codebook gains. The Type Zero adaptive and fixed codebook gain component 148a, 150a is part of the second portion of the bitstream since it is encoded on a subframe basis. As illustrated in FIG. 2, the Type Zero adaptive and fixed codebook gain component 148a, 150a is generated by the F0 first subframe-processing module 70.

For each subframe of a frame classified as Type Zero, the adaptive and fixed codebook gains are jointly coded by a two-dimensional vector quantizer (2D VQ) 164 to generate the Type Zero adaptive and fixed codebook gain component 148a, 150a. In one embodiment, quantization involves translating the fixed codebook gain into a fixed codebook energy in units of decibels (dB). In addition, a predicted fixed codebook energy may be generated from the quantized fixed codebook energy values of previous frames. The predicted fixed codebook energy may be derived using a plurality of fixed codebook predictor coefficients.

Similar to the LSFs predictor coefficients, the fixed codebook predictor coefficients determine how much of the fixed codebook energy of past frames may be used to predict the fixed codebook energy of the current frame. The predicted fixed codebook energy is subtracted from the fixed codebook energy to generate a prediction fixed codebook energy error. By adjusting the weighting of the previous frames and the current frames for each subframe, the predicted fixed codebook energy may be calculated to minimize the prediction fixed codebook error.

The prediction fixed codebook energy error is grouped with the adaptive codebook gain to form a two-dimensional vector. Following quantization of the prediction fixed codebook energy error and the adaptive codebook gain, as later described, the two-dimensional vector may be referred to as a quantized gain vector ($\hat{g}_{ac}$). The two-dimensional vector is compared to a plurality of predetermined vectors in a 2D gain quantization table. An index location is identified that is the location in the 2D gain quantization table of the predetermined vector that best represents the two-dimensional vector. The index location is the adaptive and fixed codebook gain component 148a and 150a for the subframe. The adaptive and fixed codebook gain component 148a and 150a for the frame represents the indices identified for each of the subframes.

The predetermined vectors comprise 2 elements, one representing the adaptive codebook gain, and one representing the prediction fixed codebook energy error. The 2D gain quantization table may be generally represented by:

$$\begin{bmatrix} V1_1, & V1_2 & \cdot \\ \cdot & \cdot & \\ \cdot & \cdot & \\ \cdot & \cdot & \\ \cdot & \cdot & \\ Vn_1, & Vn_2 & \end{bmatrix}$$

**TABLE 4**

The two-dimensional vector quantizer (2D VQ) 164, of one embodiment, utilizes 7 bits per subframe to identify the index location of one of 128 quantization vectors (n=128). One embodiment of the 2D gain quantization table is entitled "Float64 gainVQ_2_128_8_5" and is included in Appendix B of the attached microfiche appendix.

For frames classified as Type One, a Type One adaptive codebook gain component 148b is generated by the F1 first frame-processing module 72 as illustrated in FIG. 2. Similarly, the F1 second frame-processing module 76 generates a Type One fixed codebook gain .component 150b. The Type One adaptive codebook gain component 148b and the Type One fixed codebook gain component 150b are generated on a frame basis to form part of the first portion of the bitstream.

Referring again to FIG. 4, the Type One adaptive codebook gain component 148b is generated using a multidimensional vector quantizer that is a four-dimensional pre vector quantizer (4D pre VQ) 166 in one embodiment. The term "pre" is used to highlight that, in one embodiment, the adaptive codebook gains for all the subframes in a frame are quantized prior to the search in the fixed codebook for any of the subframes. In an alternative embodiment, the multi-dimensional quantizer is an n dimensional vector quantizer that quantizes vectors for n subframes where n may be any number of subframes.

The vector quantized by the four-dimensional pre vector quantizer (4D pre VQ) 166 is an adaptive codebook gain vector with elements that represent each of the adaptive codebook gains from each of the subframes. Following quantization, as will be later discussed, the adaptive codebook gain vector can also be referred to as a quantized pitch gain ($\hat{g}^k{}_a$). Quantization of the adaptive codebook gain vector to generate the adaptive codebook gain component 148b is performed by searching in a pre-gain quantization table. The pre-gain quantization table includes a plurality of predetermined vectors that may be searched to identify the predetermined vector that best represents the adaptive codebook gain vector. The index location of the identified predetermined vector within the pre-gain quantization table is the Type One adaptive codebook component 148b. The adaptive codebook gain component 148b of one embodiment comprises 6 bits.

In one embodiment, the predetermined vectors comprise 4 elements, 1 element for each subframe. Accordingly, the pre-gain quantization table may be generally represented as:

$$\begin{bmatrix} V1_1, & V1_2, & \ldots & V1_4 \\ V2_1, & V2_2, & \ldots & V2_4 \\ \cdot & \cdot & \ldots & \cdot \\ \cdot & \cdot & \ldots & \cdot \\ \cdot & \cdot & \ldots & \cdot \\ Vn_1, & Vn_2 & \ldots & Vn_4 \end{bmatrix}$$

**TABLE 5**

One embodiment of the pre-gain quantization table includes 64 predetermined vectors (n=64). An embodiment of the pre-gain quantization table is entitled "Float64 gp4_tab" and is included in Appendix B of the attached microfiche appendix.

The Type One fixed codebook gain component 150b may be similarly encoded using a multi-dimensional vector quantizer for n subframes. In one embodiment, the multi-dimensional vector quantizer is a four-dimensional delayed vector quantizer (4D delayed VQ) 168. The term "delayed" highlights that the quantization of the fixed codebook gains for the subframes occurs only after the search in the fixed codebook for all the subframes. Referring again to FIG. 2, the F1 second frame-processing module 76 determines the fixed codebook gain for each of the subframes. The fixed codebook gain may be determined by first buffering parameters generated on a sub-frame basis until the entire frame has been processed. When the frame has been processed, the fixed codebook gains for all of the subframes are quantized using the buffered parameters to generate the Type One fixed codebook gain component 150b. In one embodiment, the Type One fixed codebook gain component 150b comprises 10 bits as illustrated in FIG. 4.

The Type One fixed codebook gain component 150b is generated by representing the fixed-codebook gains with a plurality of fixed codebook energies in units of decibels (dB). The fixed codebook energies are quantized to generate a plurality of quantized fixed codebook energies, which are then translated to create a plurality of quantized fixed-codebook gains. In addition, the fixed codebook energies are predicted from the quantized fixed codebook energy errors of the previous frames to generate a plurality of predicted fixed codebook energies. The difference between the predicted fixed codebook energies and the fixed codebook energies is a plurality of prediction fixed codebook energy errors. In one embodiment, different prediction coefficients may be used for each of 4 subframes to generate the predicted fixed codebook energies. In this example embodiment, the predicted fixed codebook energies of the first, the second, the third, and the fourth subframe are predicted from the 4 quantized fixed codebook energy errors of the previous frame. The prediction coefficients for the first, second, third, and fourth subframes of this example embodiment may be {0.7, 0.6, 0.4, 0.2}, {0.4, 0.2, 0.1, 0.05}, {0.3, 0.2, 0.075, 0.025}, and {0.2, 0.075, 0.025, 0.0}, respectively.

The prediction fixed codebook energy errors may be grouped to form a fixed codebook gain vector that, when quantized, may be referred to as a quantized fixed codebook gain ($\hat{g}^k_c$). In one embodiment, the prediction fixed codebook energy error for each subframe represent the elements in the vector. The prediction fixed codebook energy errors are quantized using a plurality of predetermined vectors in a delayed gain quantization table. During quantization, a perceptual weighing measure may be incorporated to minimize the quantization error. An index location that identifies the predetermined vector in the delayed gain quantization table is the fixed codebook gain component 150b for the frame.

The predetermined vectors in the delayed gain quantization table of one embodiment includes 4 elements. Accordingly, the delayed gain quantization table may be represented by the previously discussed Table 5. One embodiment of the delayed gain quantization table includes 1024 predetermined vectors (n=1024). An embodiment of the delayed gain quantization table is entitled "Float64 gainVQ_4_1024" and is included in Appendix B of the attached microfiche appendix.

Referring again to FIG. 3, the fixed and adaptive codebook gain components 148 and 150 may be decoded by the full-rate decoder 90 within the decoding system 16 based on the type classification. The F0 excitation reconstruction module 104 decodes the Type Zero adaptive and fixed codebook gain component 148a, 150a. Similarly, the Type One adaptive codebook gain component 148b and the Type One fixed gain component 150b are decoded by the F1 excitation reconstruction module 106.

Decoding of the fixed and adaptive codebook gain components 158 and 160 involves generation of the respective predicted gains, as previously discussed, by the full-rate decoder 90. The respective quantized vectors from the respective quantization tables are then located using the respective index locations. The respective quantized vectors are then assembled with the respective predicted gains to generate respective quantized codebook gains. The quantized codebook gains generated from the Type Zero fixed and adaptive gain component 148a and 150a represent the values for both the fixed and adaptive codebook gains for a subframe. The quantized codebook gain generated from the Type One adaptive codebook gain component 148b and the Type One fixed codebook gain component 150b represents the values for the fixed and adaptive codebook gains, respectively, for each subframe in a frame.

### 1.2 Bit Allocation for the Half-Rate Codec

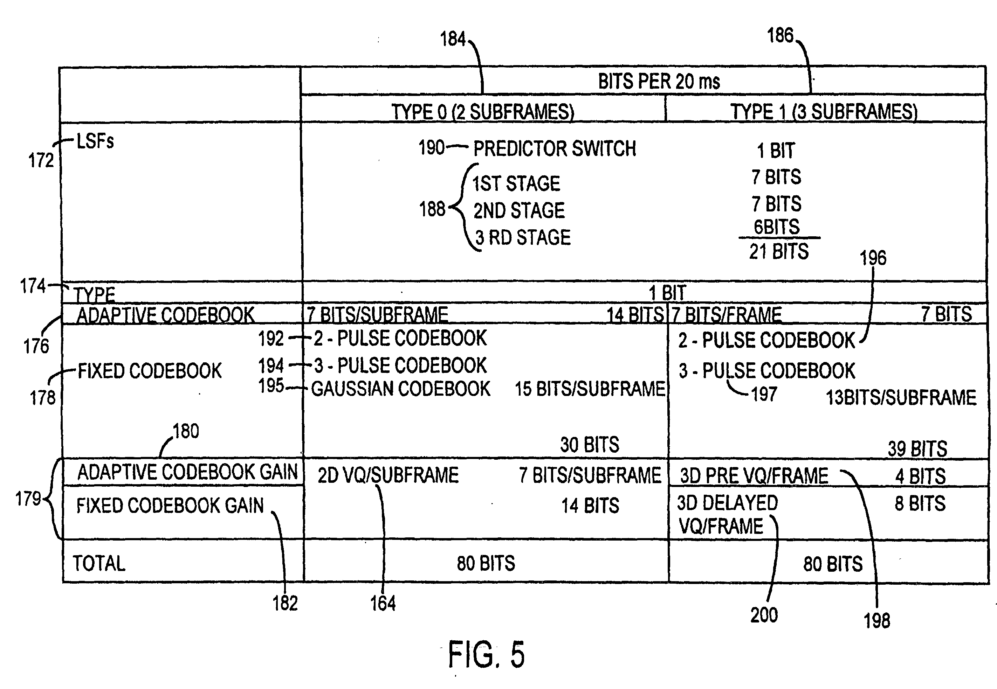

Referring now to FIGS. 2, 3 and 5, the half-rate bitstream of the half-rate codec 24 will be described. The half-rate codec 24 is in many respects similar to the full-rate codec 22 but has a different bit allocation. As such, for purposes of brevity, the discussion will focus on the differences. Referring now to FIG. 5, the bitstream allocation of one embodiment of the half-rate codec 24 includes a line spectrum frequency (LSF) component 172, a type component 174, an adaptive codebook component 176, a fixed codebook component 178, and a gain component 179. The gain component 179 further comprises an adaptive codebook gain component 180 and a fixed codebook gain component 182. The bitstream of the half-rate codec 24 also is further defined by a Type Zero column 184 and a Type One column 186. In one embodiment, the Type Zero column 184 uses two subframes of 10 milliseconds each containing 80 samples. The Type One column 186, of one embodiment, uses three subframes where the first and second subframes contain 53 samples and the third subframe contains 54 samples.

Although generated similarly to the full-rate codec 22, the LSF component 172 includes a plurality of stages 188 and a predictor switch 190 for both the Type Zero and the Type One classifications. In addition, one embodiment of the LSF component 172 comprises 21 bits that form part of the first portion of the bitstream. The initial half frame-processing module 48 illustrated in FIG. 2, generates the LSF component 172 similarly to the full-rate codec 22. Referring again to FIG. 5, the half-rate codec 24 of one embodiment includes three stages 188, two with 128 vectors and one with 64 vectors. The three stages 188 of the half rate codec 24 operate similarly to the full-rate codec 22 for frames classified as Type One with the exception of the selection of a set of predictor coefficients as discussed later. The index location of each of the 128 vectors is identified with 7 bits and the index location of each of the 64 vectors is identified with 6 bits. One embodiment of the LSF prediction error quantization table for the half-rate codec 24 is titled "Float64 CBes_40k" and is included in Appendix B of the attached microfiche appendix.

The half-rate codec 24 also differs from the full-rate codec 22 in selecting between sets of predictor coefficients. The predictor switch 190 of one embodiment identifies one of two possible sets of predictor coefficients using one bit. The selected set of predictor coefficients may be used to determine the predicted line spectrum frequencies (LSFs), similar to the full-rate codec 22. The predictor switch 190 determines and identifies which of the sets of predictor coefficients will best minimize the quantization error. The sets of predictor coefficients may be contained in an LSF predictor coefficient table that may be generally illustrated by the following matrix:

$$
\begin{bmatrix}
\begin{bmatrix}
E1_1^1, E1_2^1, & \cdots & E1_n^1 \\
\cdot & \cdots & \cdot \\
\cdot & \cdots & \cdot \\
\cdot & \cdots & \cdot \\
\cdot & \cdots & \cdot \\
Em_1^1, Em_2^1, & \cdots & Em_n^1
\end{bmatrix}^1 \\
\begin{bmatrix}
E1_1^j, E1_2^j, & \cdots & E1_n^j \\
\cdot & \cdots & \cdot \\
\cdot & \cdots & \cdot \\
\cdot & \cdots & \cdot \\
\cdot & \cdots & \cdot \\
Em_1^j, Em_2^j, & \cdots & Em_n^j
\end{bmatrix}^j
\end{bmatrix}
$$

**TABLE 6**

In one embodiment there are four predictor coefficients (m=4) in each of two sets (j=2) that comprise 10 elements each (n=10). The LSF predictor coefficient table for the half-rate codec 24 in one embodiment is titled "Float64 B_40k" and is included in Appendix B of the attached microfiche appendix. Referring again to FIG. 3, the LSF prediction error quantization table and the LSF predictor coefficient table are used by the H LPC reconstruction module 118 within the decoding system 16. The H LPC reconstruction module 118 receives and decodes the LSF component 172 from the bitstream to reconstruct the quantized frame LSFs. Similar to the full-rate codec 22, for frames classified as Type One, the half-rate codec 24 uses a predetermined linear interpolation path. However, the half-rate codec 24 uses the predetermined linear interpolation path for frames classified as both Type Zero and Type One.

The adaptive codebook component 176 in the half-rate codec 24 similarly models the pitch lag based on the periodicity of the speech signal 18. The adaptive codebook component 176 is encoded on a subframe basis for the Type Zero classification and a frame basis for the Type One classification. As illustrated in FIG. 2, the initial half frame-processing module 48 encodes an open loop adaptive codebook component 176a for frames with the Type One classification. For frames with the Type Zero classification, the H0 first subframe-processing module 80 encodes a closed loop adaptive codebook component 176b.

Referring again to FIG. 5, one embodiment of the open loop adaptive codebook component 176a is encoded by 7 bits per frame and the closed loop adaptive codebook component 176b is encoded by 7 bits per subframe. Accordingly, the Type Zero adaptive codebook component 176a is part of the first portion of the bitstream, and the Type One adaptive codebook component 176b is part of the second portion of the bitstream. As illustrated in FIG. 3, the decoding system 16 receives the closed loop adaptive codebook component 176b. The closed loop adaptive codebook component 176b is decoded by the half-rate decoder 92 using the H0 excitation reconstruction module 114. Similarly, the H1 excitation reconstruction module 116 decodes the open loop adaptive codebook component 176a.

One embodiment of the fixed codebook component 178 for the half-rate codec 24 is dependent on the type classification to encode the long-term residual as in the full-rate codec 22. Referring again to FIG. 2, a Type Zero fixed codebook component 178a or a Type One fixed codebook component 178b is generated by the H0 first subframe-processing module 80 or the H 1 second subframe-processing module 84, respectively. Accordingly, the Type Zero and Type One fixed codebook components 178a and 178b form a part of the second portion of the bitstream.

Referring again to FIG. 5, the Type Zero fixed codebook component 178a of an example embodiment is encoded using 15 bits per subframe with up to two bits identify the codebook to be used as in the full-rate codec 22. Encoding the Type Zero fixed codebook component 178a involves use of a plurality of n-pulse codebooks that are a 2-pulse codebook 192 and a 3-pulse codebook 194 in the example embodiment. In addition, in this example embodiment, a gaussian codebook 195 is used that includes entries that are random excitation. For the n-pulse codebooks, the half-rate codec 24 uses the track tables similarly to the full-rate codec 22. In one embodiment, the track table entitled "static INT16 track_2_7_1," "static INT16 track_1_3_0," and "static INT16 track_3_2_0" included in the library entitled "tracks.tab" in Appendix B of the microfiche appendix are used.

In an example embodiment of the 2-pulse codebook 192, each track in the track table includes 80 sample locations for each representative pulse. The pulse locations for both the first and second representative pulses are encoded using 13 bits. Encoding 1 of the 80 possible pulse locations is accomplished in 13 bits by identifying the pulse location for the first representative pulse, multiplying the pulse location by 80 and adding the pulse location of the second representative pulse to the result. The end result is a value that can be encoded in 13 bits with an additional bit used to represent the signs of both representative pulses as in the full-rate codec 22.

In an example embodiment of the 3-pulse codebook 194, the pulse locations are generated by the combination of a general location, that may be one of 16 sample locations defined by 4 bits, and a relative displacement there from. The relative displacement may be 3 values representing each of the 3 representative pulses in the 3-pulse codebook 194. The values represent the location difference away from the general location and may be defined by 2 bits for each representative pulse. The signs for the three representative pulses may be each defined by one bit such that the total bits for the pulse location and the signs is 13 bits.

The gaussian codebook 195 generally represents noise type speech signals that may be encoded using two orthogonal basis random vectors. The Type Zero fixed codebook component 178a represents the two orthogonal based random vectors generated from the gaussian codebook 195. The Type Zero fixed codebook component 178a represents how to perturbate a plurality of orthogonal basis random vectors in a gaussian table to increase the number of orthogonal basis random vectors without increasing the storage requirements. In an example embodiment, the number of orthogonal basis random vectors is increased from 32 vectors to 45 vectors. A gaussian table that includes 32 vectors with each vector comprising 40 elements represents the gaussian codebook of the example embodiment. In this example embodiment, the two orthogonal basis random vectors used for encoding are interleaved with each other to represent 80 samples in each subframe. The gaussian codebook may be generally represented by the following matrix:

$$
\begin{bmatrix}
G1_1, & G1_2, & \ldots & G1_n \\
G2_1, & G2_2, & \ldots & G2_n \\
\cdot & \cdot & \ldots & \cdot \\
\cdot & \cdot & \ldots & \cdot \\
\cdot & \cdot & \ldots & \cdot \\
\cdot & \cdot & \ldots & \cdot \\
G32_1, & G32_2 & \ldots & G32_n
\end{bmatrix}
$$

**TABLE 7**

One embodiment of the gaussian codebook 195 is titled "double bv" and is included in Appendix B of the attached microfiche appendix. For the example embodiment of the gaussian codebook 195, 11 bits identify the combined indices (location and perturbation) of both of the two orthogonal basis random vectors used for encoding, and 2 bits define the signs of the orthogonal basis random vectors.

Encoding the Type One fixed codebook component 178b involves use of a plurality of n-pulse codebooks that are a 2-pulse codebook 196 and a 3-pulse codebook 197 in the example embodiment. The 2-pulse codebook 196 and the 3-pulse codebook 197 function similarly to the 2-pulse codebook 192 and the 3-pulse codebook 194 of the Type Zero classification, however the structure is different. The Type One fixed codebook component 178b of an example embodiment is encoded using 13 bits per subframe. Of the 13 bits, 1 bit identifies the 2-pulse codebook 196 or the 3-pulse codebook 197 and 12 bits represent the respective pulse locations and the signs of the representative pulses. In the 2-pulse codebook 196 of the example embodiment, the tracks include 32 sample locations for each representative pulse that are encoded using 5 bits with the remaining 2 bits used for the sign of each representative pulse. In the 3-pulse codebook 197, the general location includes 8 sample locations that are encoded using 4 bits. The relative displacement is encoded by 2 bits and the signs for the representative pulses are encoded in 3 bits similar to the frames classified as Type Zero.

Referring again to FIG. 3, the decoding system 16 receives the Type Zero or Type One fixed codebook components 178a and 178b. The Type Zero or Type One fixed codebook components 178a and 178b are decoded by the H0 excitation reconstruction module 114 or the H1 reconstruction module 116, respectively. Decoding of the Type Zero fixed codebook component 178a occurs using an embodiment of the 2-pulse codebook 192, the 3-pulse codebook 194, or the gaussian codebook 195. The Type One fixed codebook component 178b is decoded using the 2-pulse codebook 196 or the 3-pulse codebook 197.

Referring again to FIG. 5, one embodiment of the gain component 179 comprises a Type Zero adaptive and fixed codebook gain component 180a and 182a. The Type Zero adaptive and fixed codebook gain component 180a and 182a may be quantized using the two-dimensional vector quantizer (2D VQ) 164 and the 2D gain quantization table (Table 4), used for the full-rate codec 22. In one embodiment, the 2D gain quantization table is entitled "Float64 gainVQ_3_128", and is included in Appendix B of the attached microfiche appendix.

Type One adaptive and fixed codebook gain components 180b and 182b may also be generated similarly to the full-rate codec 22 using multi-dimensional vector quantizers. In one embodiment, a three-dimensional pre vector quantizer (3D preVQ) 198 and a three-dimensional delayed vector quantizer (3D delayed VQ) 200 are used for the adaptive and fixed gain components 180b and 182b, respectively. The vector quantizers 198 and 200 perform quantization using respective gain quantization tables. In one embodiment, the gain quantization tables are a pre-gain quantization table and a delayed gain quantization table for the adaptive and fixed codebook gains, respectively. The multi-dimensional gain tables may be similarly structured and include a plurality of predetermined vectors. Each multi-dimensional gain table in one embodiment comprises 3 elements for each subframe of a frame classified as Type One.

Similar to the full-rate codec 22, the three-dimensional pre vector quantizer (3D preVQ) 198 for the adaptive gain component 180b may quantize directly the adaptive gains. In addition, the three-dimensional delayed vector quantizer (3D delayed VQ) 200 for the fixed gain component 182b may quantize the fixed codebook energy prediction error. Different prediction coefficients may be used to predict the fixed codebook energy for each subframe. In one preferred embodiment, the predicted fixed codebook energies of the first, the second, and the third subframes are predicted from the 3 quantized fixed codebook energy errors of the previous frame. In this example embodiment, the predicted fixed codebook energies of the first, the second, and the third subframes are predicted using the set of coefficients {0.6, 0.3, 0.1}, {0.4, 0.25, 0.1}, and {0.3, 0.15, 0.075}, respectively.

The gain quantization tables for the half-rate codec 24 may be generally represented as:

$$
\begin{bmatrix}
G1_1, & G1_2, & G1_3, \\
\cdot & \cdot & \cdot \\
\cdot & \cdot & \cdot \\
\cdot & \cdot & \cdot \\
\cdot & \cdot & \cdot \\
\cdot & \cdot & \cdot \\
Gn_1, & Gn_2, & Gn_3
\end{bmatrix}
$$

**TABLE 8**

One embodiment of the pre-gain quantization table used by the three-dimensional pre vector quantizer (3D preVQ) 198 includes 16 vectors (n=16). The three-dimensional delayed vector quantizer (3D delayed VQ) 200 uses one embodiment of the delayed gain quantization table that includes 256 vectors (n=256). The gain quantization tables for the pre vector quantizer (3D preVQ) 198 and the delayed vector quantizer (3D delayed VQ) 200 of one embodiment are entitled "Float64 gp3_tab" and "Float64 gainVQ_3_256", respectively, and are included in Appendix B of the attached microfiche appendix.

Referring again to FIG. 2, the Type Zero adaptive and fixed codebook gain component 180a and 182a is generated by the H0 first subframe-processing module 80. The H 1 first frame-processing module 82 generates the Type One adaptive codebook gain component 180b. Similarly, the Type One fixed codebook gain component 182b is generated by the H 1 second frame-processing module 86. Referring again to FIG. 3, the decoding system 16 receives the Type Zero adaptive and fixed codebook gain component 180a and 182a. The Type Zero adaptive and fixed codebook gain component 180a and 182a is decoded by the H0 excitation reconstruction module 114 based on the type classification. Similarly, the H1 excitation reconstruction module 116 decodes the Type One adaptive gain component 180b and the Type One fixed codebook gain component 182b.

### 1.3 Bit Allocation for the Quarter-Rate Codec

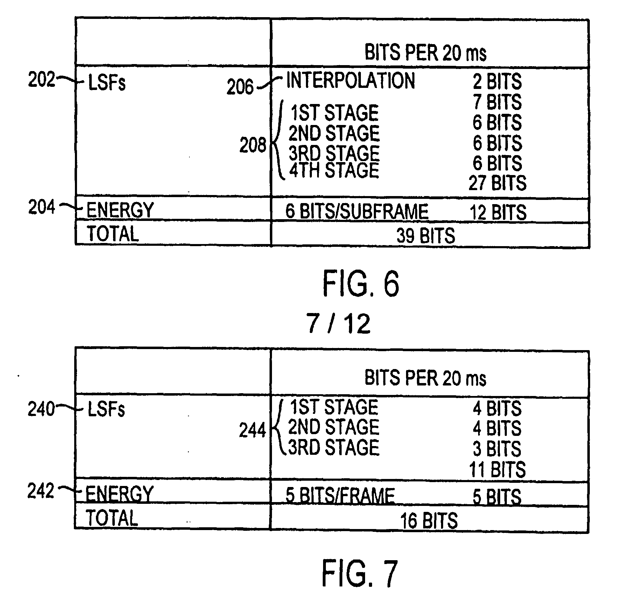

Referring now to FIGS. 2, 3 and 6, the quarter-rate bitstream of the quarter-rate codec 26 will now be explained. The illustrated embodiment of the quarter-rate codec 26 operates on both a frame basis and a subframe basis but does not include the type classification as part of the encoding process as in the full and half-rate codecs 22 and 24. Referring now to FIG. 6, the bitstream generated by quarter-rate codec 26 includes an LSF component 202 and an energy component 204. One embodiment of the quarter-rate codec 26 operates using two subframes of 10 milliseconds each to process frames using 39 bits per frame.

The LSF component 202 is encoded on a frame basis using a similar LSF quantization scheme as the full-rate codec 22 when the frame is classified as Type Zero. The quarter-rate codec 26 utilizes an interpolation element 206 and a plurality of stages 208 to encode the LSFs to represent the spectral envelope of a frame. One embodiment of the LSF component 202 is encoded using 27 bits. The 27 bits represent the interpolation element 206 that is encoded in 2 bits and four of the stages 208 that are encoded in 25 bits. The stages 208 include one stage encoded using 7 bits and three stages encoded using 6 bits. In one embodiment, the quarter rate codec 26 uses the exact quantization table and predictor coefficients table used by the full rated codec 22. The quantization table and the predictor coefficients table of one embodiment are titled "Float64 CBes_85k" and "Float64 B_85k", respectively, and are included in Appendix B of the attached microfiche appendix.

The energy component 204 represents an energy gain that may be multiplied by a vector of similar yet random numbers that may be generated by both the encoding system 12 and the decoding system 16. In one embodiment, the energy component 204 is encoded using 6 bits per subframe. The energy component 204 is generated by first determining the energy gain for the subframe based on the random numbers. In addition, a predicted energy gain is determined for the subframe based on the energy gain of past frames.

The predicted energy gain is subtracted from the energy gain to determine an energy gain prediction error. The energy gain prediction error is quantized using an energy gain quantizer and a plurality of predetermined scalars in an energy gain quantization table. Index locations of the predetermined scalars for each subframe may be represented by the energy component 204 for the frame. The energy gain quantization table may be generally represented by the following matrix:

$$
\begin{bmatrix}
G_1 \\
\vdots \\
\vdots \\
\vdots \\
\vdots \\
G_n
\end{bmatrix}
$$

**TABLE 9**

In one embodiment, the energy gain quantization table contains 64 (n=64) of the predetermined scalars. An embodiment of the energy gain quantization table is entitled "Float64 gainSQ_1_64" and is included in Appendix B of the attached microfiche appendix.

In FIG. 2, the LSF component 202 is encoded on a frame basis by the initial quarter frame-processing module 50. Similarly, the energy component 204 is encoded by the quarter rate module 60 on a subframe basis. Referring now to FIG. 3, the decoding system 16 receives the LSF component 202. The LSF component 202 is decoded by the Q LPC reconstruction module 122 and the energy component 204 is decoded by the Q excitation reconstruction module 120. Decoding the LSF component 202 is similar to the decoding methods for the full-rate codec 22 for frames classified as Type One. The energy component 204 is decoded to determine the energy gain. A vector of similar yet random numbers generated within the decoding system 16 may be multiplied by the energy gain to generate the short-term excitation.

### 1.4 Bit Allocation for the Eighth-Rate Codec

In FIGS. 2, 3, and 7, the eighth-rate bitstream of the eighth-rate codec 28 may not include the type classification as part of the encoding process and may operate on a frame basis only. Referring now to Fig. 7, similar to the quarter rate codec 26, the bitstream of the eighth-rate codec 28 includes an LSF component 240 and an energy component 242. The LSF component 240 may be encoded using a similar LSF quantization scheme as the full-rate codec 22, when the frame is classified as Type One. The eighth-rate codec 28 utilizes a plurality of stages 244 to encode the short-term predictor or spectral representation of a frame. One embodiment of the LSF component 240 is encoded using 11 bits per frame in three stages 244. Two of the three stages 244 are encoded in 4 bits and the last of the three stages 244 is encoded in 3 bits.

The quantization approach to generate the LSF component 240 for the eighth-rate codec 28 involves an LSF prediction error quantization table and a predictor coefficients table similar to the full-rate codec 22. The LSF prediction error quantization table and the LSF predictor coefficients table can be generally represented by the previously discussed Tables 1 and 2. In an example embodiment, the LSF quantization table for the eighth-rate codec 28 includes 3 stages (j=3) with 16 quantization vectors in two stages (r=16) and 8 quantization vectors in one stage (s =8) each having 10 elements (n=10). The predictor coefficient table of one embodiment includes 4 vectors (m=4) of 10 elements each (n=10). The quantization table and the predictor coefficients table of one embodiment are titled "Float64 CBes_08k" and "Float64 B_08k," respectively, and are included in Appendix B of the attached microfiche appendix.

In FIG. 2, the LSF component 240 is encoded on a frame basis by the initial eighth frame-processing module 52. The energy component 242 also is encoded on a frame basis by the eighth-rate module 62. The energy component 242 represents an energy gain that can be determined and coded similarly to the quarter rate codec 26. One embodiment of the energy component 242 is represent by 5 bits per frame as illustrated in Fig. 7.

Similar to the quarter rate codec 26, the energy gain and the predicted energy gain may be used to determine an energy prediction error. The energy prediction error is quantized using an energy gain quantizer and a plurality of predetermined scalars in an energy gain quantization table. The energy gain quantization table may be generally represented by Table 9 as previously discussed. The energy gain quantizer of one embodiment uses an energy gain quantization table containing 32 vectors (n=32) that is entitled "Float64 gainSQ_1_32" and is included in Appendix B of the attached microfiche appendix.

In FIG. 3, the LSF component 240 and the energy component 242 may be decoded following receipt by the decoding system 16. The LSF component 240 and the energy component 242 are decoded by the E LPC reconstruction module 126 and the E excitation reconstruction module 124, respectively. Decoding of the LSF component 240 is similar to the full-rate codec 22 for frames classified as Type One. The energy component 242 may be decoded by applying the decoded energy gain to a vector of similar yet random numbers as in the quarter rate codec 26.

An embodiment of the speech compression system 10 is capable of creating and then decoding a bitstream using one of the four codecs 22, 24, 26 and 28. The bitstream generated by a particular codec 22, 24, 26 and 28 may be encoded emphasizing different parameters of the speech signal 18 within a frame depending on the rate selection and the type classification. Accordingly, perceptual quality of the post-processed synthesized speech 20 decoded from the bitstream may be optimized while maintaining the desired average bit rate.

A detailed discussion of the configuration arid operation of the speech compression system modules illustrated in the embodiments of FIGS. 2 and 3 is now provided. The reader is encouraged to review the source code included in Appendix A of the attached microfiche appendix in conjunction with the discussion to further enhance understanding.

### 2.0 PRE-PROCESSING MODULE

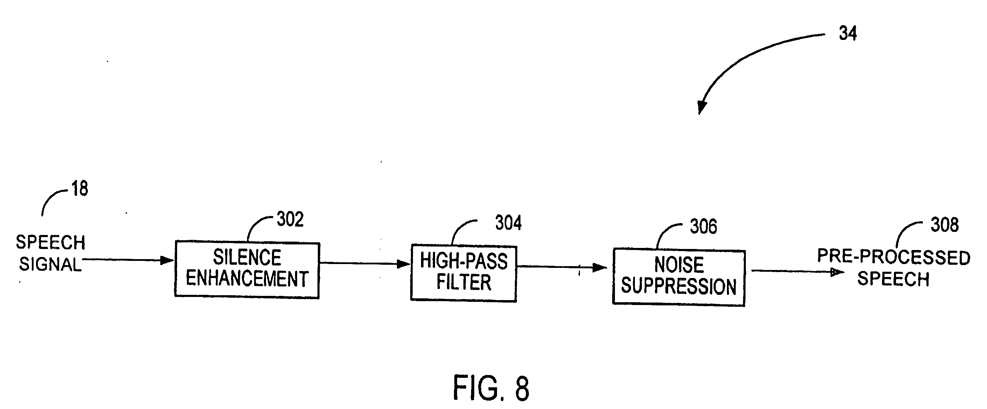

Referring now to Fig. 8, an expanded block diagram of the pre-processing module 34 illustrated in Fig. 2 is provided. One embodiment of the pre-processing module 34 includes a silence enhancement module 302, a high-pass filter module 304, and a noise suppression module 306. The pre-processing module 34 receives the speech signal 18 and provides a pre-processed speech signal 308.

The silence enhancement module 302 receives the speech signal 18 and functions to track the minimum noise resolution. The silence enhancement function adaptively tracks the minimum resolution and levels of the speech signal 18 around zero, and detects whether the current frame may be "silence noise." If a frame of "silence noise" is detected, the speech signal 18 may be ramped to the zero-level. Otherwise, the speech signal 18 may not be modified. For example, the A-law coding scheme can transform such an inaudible "silence noise" into a clearly audible noise. A-law encoding and decoding of the speech signal 18 prior to the pre-processing module 34 can amplify sample values that are nearly 0 to values of about + 8 or -8 thereby transforming a nearly inaudible noise into an audible noise. After processing by the silence enhancement module 302, the speech signal 18 may be provided to the high-pass filter module 304.

The high-pass filter module 304 may be a $2^{nd}$ order pole-zero filter, and may be given by the following transfer

function H(z):

$$H(z) = \frac{0.92727435 - 1.8544941z^{-1} + 0.92727435z^{-2}}{1 - 1.9059465z^{-1} + 0.9114024z^{-2}}$$  (Equation 1)

The input may be scaled down by a factor of 2 during the high-pass filtering by dividing the coefficients of the numerator by 2.

Following processing by the high-pass filter, the speech signal 18 may be passed to the noise suppression module 306. The noise suppression module 306 employs noise subtraction in the frequency domain and may be one of the many well-known techniques for suppressing noise. The noise suppression module 306 may include a Fourier transform program used by a noise suppression algorithm as described in section 4.1.2 of the TIA/EIA IS-127 standard entitled "Enhanced Variable Rate Codec, Speech Service Option 3 for Wideband Spread Spectrum Digital Systems."

The noise suppression module 306 of one embodiment transforms each frame of the speech signal 18 to the frequency domain where the spectral amplitudes may be separated from the spectral phases. The spectral amplitudes may be grouped into bands, which follow the human auditory channel bands. An attenuation gain may be calculated for each band. The attenuation gains may be calculated with less emphasis on the spectral regions that are likely to have harmonic structure. In such regions, the background noise may be masked by the strong voiced speech. Accordingly, any attenuation of the speech can distort the quality of the original speech, without any perceptual improvement in the reduction of the noise.

Following calculation of the attenuation gain, the spectral amplitudes in each band may be multiplied by the attenuation gain. The spectral amplitudes may then be combined with the original spectral phases, and the speech signal 18 may be transformed back to the time domain. The time-domain signal may be overlapped-and-added to generate the pre-processed speech signal 308. The pre-processed speech signal 308 may be provided to the initial frame-processing module 44.

## 3.0 INITIAL FRAME PROCESSING MODULE

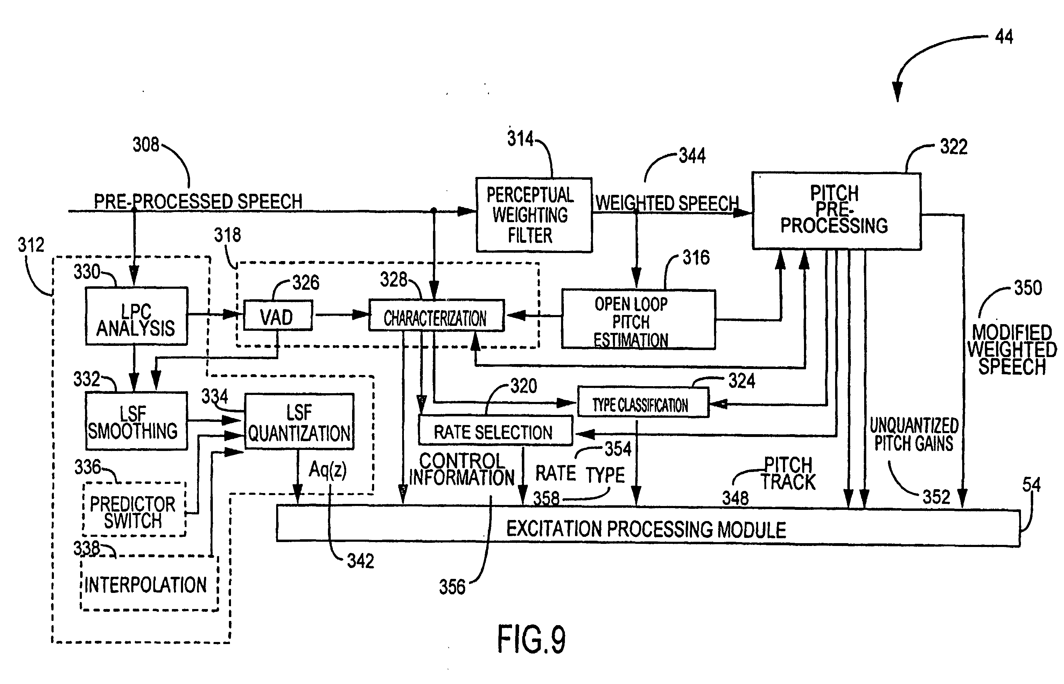

FIG. 9 is a block diagram of the initial frame-processing module 44, illustrated in FIG. 2. One embodiment of the initial frame-processing module 44 includes an LSF generation section 312, a perceptual weighting filter module 314, an open loop pitch estimation module 316, a characterization section 318, a rate selection module 320, a pitch pre-processing module 322, and a type classification module 324. The characterization section 318 further comprises a voice activity detection (VAD) module 326 and a characterization module 328. The LSF generation section 312 comprises an LPC analysis module 330, an LSF smoothing module 332, and an LSF quantization module 334. In addition, within the full-rate encoder 36, the LSF generation section 312 includes an interpolation module 338 and within the half-rate encoder 38, the LSF generation section includes a predictor switch module 336.

Referring to FIG. 2, the initial frame-processing module 44 operates to generate the LSF components 140, 172, 202 and 240, as well as determine the rate selection and the type classification. The rate selection and type classification control the processing by the excitation-processing module 54. The initial frame-processing module 44 illustrated in Fig. 9 is illustrative of one embodiment of the initial full frame-processing module 46 and the initial half frame-processing module 48. Embodiments of the initial quarter frame-processing module 50 and the initial eighth frame-processing module 52 differ to some degree.

As previously discussed, in one embodiment, type classification does not occur for the initial quarter-rate frame-processing module 50 and the initial eighth-rate frame-processing module 52. In addition, the long-term predictor and the long-term predictor residual are not processed separately to represent the energy component 204 and 242 illustrated in FIGS. 6 and 7. Accordingly, only the LSF section 312, the characterization section 318 and the rate selection module 320 illustrated in Fig. 9 are operable within the initial quarter-rate frame-processing module 50 and the initial eighth-rate frame-processing module 52.

To facilitate understanding of the initial frame-processing module 44, a general overview of the operation will first be discussed followed by a detailed discussion. Referring now to FIG. 9, the pre-processed speech signal 308 initially is provided to the LSF generation section 312, the perceptual weighting filter module 314 and the characterization section 318. However, some of the processing within the characterization section 318 is dependent on the processing that occurs within the open loop pitch estimation module 316. The LSF generation section 312 estimates and encodes the spectral representation of the pre-processed speech signal 308. The perceptual weighting filter module 314 operates to provide perceptual weighting during coding of the pre-processed speech signal 308 according to the natural masking that occurs during processing by the human auditory system. The open loop pitch estimation module 316 determines the open loop pitch lag for each frame. The characterization section 318 analyzes the frame of the pre-processed speech signal 308 and characterizes the frame to optimize subsequent processing.

During, and following, the processing by the characterization section 318, the resulting characterizations of the frame may be used by the pitch pre-processing module 322 to generate parameters used in generation of the closed loop pitch lag. In addition, the characterization of the frame is used by the rate selection module 320 to determine the rate selection. Based on parameters of the pitch lag determined by the pitch pre-processing module 322 and the characterizations, the type classification is determined by the type classification module 324.

### 3.1 LPC Analysis Module

The pre-processed speech signal 308 is received by the LPC analysis module 330 within the LSF generation section 312. The LPC analysis module 330 determines the short-term prediction parameters used to generate the LSF component 312. Within one embodiment of the LPC analysis module 330, there are three 10$^{th}$ order LPC analyses performed for a frame of the pre-processed speech signal 308. The analyses may be centered within the second quarter of the frame, the fourth quarter of the frame, and a lookahead. The lookahead is a speech segment that overhangs into the next frame to reduce transitional effects. The analysis within the lookahead includes samples from the current frame and from the next frame of the pre-processed speech signal 308.

Different windows may be used for each LPC analysis within a frame to calculate the linear prediction coefficients. The LPC analyses in one embodiment are performed using the autocorrelation method to calculate autocorrelation coefficients. The autocorrelation coefficients may be calculated from a plurality of data samples within each window. During the LPC analysis, bandwidth expansion of 60Hz and a white noise correction factor of 1.0001 may be applied to the autocorrelation coefficients. The bandwidth expansion provides additional robustness against signal and round-off errors during subsequent encoding. The white noise correction factor effectively adds a noise floor of -40dB to reduce the spectral dynamic range and further mitigate errors during subsequent encoding.

A plurality of reflection coefficients may be calculated using a Leroux-Gueguen algorithm from the autocorrelation coefficients. The reflection coefficients may then be converted to the linear prediction coefficients. The linear prediction coefficients may be further converted to the LSFs (Line Spectrum Frequencies), as previously discussed. The LSFs calculated within the fourth quarter may be quantized and sent to the decoding system 16 as the LSF component 140, 172, 202, 240. The LSFs calculated within the second quarter may be used to determine the interpolation path for the full-rate encoder 36 for frames classified as Type Zero. The interpolation path is selectable and may be identified with the interpolation element 158. In addition, the LSFs calculated within the second quarter and the lookahead may be used in the encoding system 12 to generate the short term residual and a weighted speech that will be described later.

### 3.2 LSF Smoothing Module

During stationary background noise, the LSFs calculated within the fourth quarter of the frame may be smoothed by the LSF smoothing module 332 prior to quantizing the LSFs. The LSFs are smoothed to better preserve the perceptual characteristic of the background noise. The smoothing is controlled by a voice activity determination provided by the VAD module 326 that will be later described and an analysis of the evolution of the spectral representation of the frame. An LSF smoothing factor is denoted $\beta_{isf}$. In an example embodiment:

1. At the beginning of "smooth" background noise segments, the smoothing factor may be ramped quadratically from 0 to 0.9 over 5 frames.
2. During "smooth" background noise segments the smoothing factor may be 0.9.
3. At the end of "smooth" background noise segments the smoothing factor may be reduced to 0 instantaneously.
4. During non-"smooth" background noise segments the smoothing factor may be 0. According to the LSF smoothing factor the LSFs for the quantization may be calculated as:

$$\text{lsf}_n(k) = \beta_{lsf} \cdot \text{lsf}_{n-1}(k) + (1 - \beta_{lsf}) \cdot \text{lsf}_2(k), \qquad k = 1, 2, ..., 10 \qquad \text{(Equation 2)}$$

where $\text{lsf}_n(k)$ and $\text{lsf}_{n-1}(k)$ represents the smoothed LSFs of the current and previous frame, respectively, and $\text{lsf}_2(k)$ represents the LSFs of the LPC analysis centered at the last quarter of the current frame.

### 3.3 LSF Quantization Module

The 10$^{th}$ order LPC model given by the smoothed LSFs (Equation 2) may be quantized in the LSF domain by the LSF quantization module 334. The quantized value is a plurality of quantized LPC coefficients $A_q(z)$ 342. The quantization scheme uses an $n^{th}$ order moving average predictor. In one embodiment, the quantization scheme uses a $2^{nd}$ order moving average predictor for the full-rate codec 22 and the quarter rate codec 26. For the half-rate codec 24, a $4^{th}$ order moving average switched predictor may be used. For the eighth rate codec 28, a $4^{th}$ order moving average predictor may be used. The quantization of the LSF prediction error may be performed by multi-stage codebooks, in the respective codecs as previously discussed.

The error criterion for the LSFs quantization is a weighted mean squared error measure. The weighting for the weighted mean square error is a function of the LPC magnitude spectrum. Accordingly, the objective of the quantization may be given by:

$$\left\{ l\hat{s}f_n(1), l\hat{s}f_n(1), ..., l\hat{s}f_n(10) \right\} = \arg\min \left\{ \sum_{k=1}^{10} w_i \cdot \left( lsf_n(k) - l\hat{s}f_n(k) \right)^2 \right\},$$

**(Equation 3)**

where the weighting may be:

$$w_i = \left| P(lsf_n(i)) \right|^{0.4}, \qquad\qquad \text{(Equation 4)}$$

and $|P(f)|$ is the LPC power spectrum at frequency $f$ (the index $n$ denotes the frame number). In the example embodiment, there are 10 coefficients.

In one embodiment, the ordering property of the quantized LPC coefficients $A_q(z)$ 342 is checked. If one LSF pair is flipped they may be re-ordered. When two br more LSF pairs are flipped, the quantized LPC coefficients $A_q(z)$ 342 may be declared erased and may be reconstructed using the frame erasure concealment of the decoding system 16 that will be discussed later. In one embodiment, a minimum spacing of 50Hz between adjacent coefficients of the quantized LPC coefficients $A_q(z)$ 342 may be enforced.

### 3.4 Predictor Switch Module

The predictor switch module 336 is operable within the half-rate codec 24. The predicted LSFs may be generated using moving average predictor coefficients as previously discussed. The predictor coefficients determine how much of the LSFs of past frames are used to predict the LSFs of the current frame. The predictor switch module 336 is coupled with the LSFs quantization module 334 to provide the predictor coefficients that minimize the quantization error as previously discussed.

### 3.5 LSF Interpolation Module

The quantized and unquantized LSFs may also be interpolated for each subframe within the full-rate codec 22. The quantized and unquantized LSFs are interpolated to provide quantized and unquantized linear prediction parameters for each subframe. The LSF interpolation module 338 chooses an interpolation path for frames of the full-rate codec 22 with the Type Zero classification, as previously discussed. For all other frames, a predetermined linear interpolation path may be used.

The LSF interpolation module 338 analyzes the LSFs of the current frame with respect to the LSFs of previous frames and the LSFs that were calculated at the second quarter of the frame. An interpolation path may be chosen based on the degree of variations in the spectral envelope between the subframes. The different interpolation paths adjust the weighting of the LSFs of the previous frame and the weighting of the LSFs of the current frame for the current subframe as previously discussed. Following adjustment by the LSF interpolation module 338, the interpolated LSFs may be converted to predictor coefficients for each subframe.

For Type One classification within the full-rate codec 22, as well as for the half-rate codec 24, the quarter-rate codec 26, and the eighth-rate codec 28, the predetermined linear interpolation path may be used to adjust the weighting. The interpolated LSFs may be similarly converted to predictor coefficients following interpolation. In addition, the predictor coefficients may be further weighted to create the coefficients that are used by perceptual weighting filter module 314.

**3.6 Perceptual Weighting Filter Module**

The perceptual weighting filter module 314 is operable to receive and filter the pre-processed speech signal 308. Filtering by the perceptual weighting filter module 314 may be performed by emphasizing the valley areas and de-emphasizing the peak areas of the pre-processed speech signal 308. One embodiment of the perceptual weighting filter module 314 has two parts. The first part may be the traditional pole-zero filter given by:

$$W_1(z) = \frac{A(z/\gamma_1)}{A(z/\gamma_2)},$$  **(Equation 5)**

where $A(z/\gamma_1)$ and $1/A(z/\gamma_2)$ are a zeros-filter and a poles-filter, respectively. The prediction coefficients for the zeros-filter and the poles-filter may be obtained from the interpolated LSFs for each subframe and weighted by $\gamma_1$ and $\gamma_2$, respectively. In an example embodiment of the perceptual weighting filter module 314, the weighting is $\gamma_1 = 0.9$ and $\gamma_2 = 0.5$. The second part of the perceptual weighting filter module 314 may be an adaptive lowpass filter given by:

$$W_2(z) = \frac{1}{1 - \eta z^{-1}}$$  (Equation 6)

where $\eta$ is a function of stationary long-term spectral characteristics that will be later discussed. In one embodiment, if the stationary long-term spectral characteristics have the typical tilt associated with public switched telephone network (PSTN), then $\eta = 0.2$, otherwise, $\eta = 0.0$. The typical tilt is commonly referred to as a modified IRS characteristic or spectral tilt: Following processing by the perceptual weighting filter module 314, the pre-processed speech signal 308 may be described as a weighted speech 344. The weighted speech 344 is provided to the open loop pitch estimation module 316.

**3.7 Open Loop Pitch Estimation Module**

The open loop pitch estimation module 316 generates the open loop pitch lag for a frame. In one embodiment, the open loop pitch lag actually comprises three open loop pitch lags, namely, a first pitch lag for the first half of the frame, a second pitch lag for the second half of the frame, and a third pitch lag for the lookahead portion of the frame.
For every frame, the second and third pitch lags are estimated by the open loop pitch estimation module 316 based on the current frame. The first open loop pitch lag is the third open loop pitch lag (the lookahead) from the previous frame that may be further adjusted. The three open loop pitch lags are smoothed to provide a continuous pitch contour. The smoothing of the open loop pitch lags employs a set of heuristic and ad-hoc decision rules to preserve the optimal pitch contour of the frame. The open-loop pitch estimation is based on the weighted speech 344 denoted by $s_w(n)$. The values estimated by the open loop pitch estimation module 316 in one embodiment are lags that range from 17 to 148.
The first, second and third open loop pitch lags may be determined using a normalized correlation, R(k) that may be calculated according to

$$R(k) = \frac{\sum_{n=0}^{79} s_w(n) \cdot s_w(n-k)}{\sqrt{\left(\sum_{n=0}^{79} s_w(n) \cdot s_w(n)\right)\left(\sum_{n=0}^{79} s_w(n-k) \cdot s_w(n-k)\right)}}.$$  **(Equation 7)**

Where n=79 in the example embodiment to represent the number of samples in the subframe. The maximum normalized correlation R(k) for each of a plurality of regions is determined. The regions may be four regions that represent four sub-ranges within the range of possible lags. ,For example, a first region from 17-33 lags, a second region from 34-67 lags, a third region from 68-137 lags, and a fourth region from 138-148 lags. One open loop pitch lag corresponding to the lag that maximizes the normalized correlation values R(k) from each region are the initial pitch lag candidates.

A best candidate from the initial pitch lag candidates is selected based on the normalized correlation, characterization information, and the history of the open loop pitch lag. This procedure may be performed for the second pitch lag and for the third pitch lag.

Finally, the first, second, and third open loop pitch lags may be adjusted for an optimal fitting to the overall pitch contour and form the open loop pitch lag for the frame. The open loop pitch lag is provided to the pitch pre-processing module 322 for further processing that will be described later. The open loop pitch estimation module 316 also provides the pitch lag and normalized correlation values at the pitch lag. The normalized correlation values at the pitch lag are called a pitch correlation and are notated as $R_p$. The pitch correlation $R_p$ is used in characterizing the frame within the characterization section 318.

### 3.8 Characterization Section

The characterization section 318 is operable to analyze and characterize each frame of the pre-processed speech signal 308. The characterization information is utilized by a plurality of modules within the initial frame-processing module 44 as well by the excitation-processing module 54. Specifically, the characterization information is used in the rate selection module 320 and the type classification module 324. In addition, the characterization information may be used during quantization and coding, particularly in emphasizing the perceptually important features of the speech using a class-dependent weighting approach that will be described later.

Characterization of the pre-processed speech signal 308 by the characterization section 318 occurs for each frame. Operation of one embodiment of the characterization section 318 may be generally described as six categories of analysis of the pre-processed speech signal 308. The six categories are: voice activity determination, the identification of unvoiced noise-like speech, a 6-class signal characterization, derivation of a noise-to-signal ratio, a 4-grade characterization, and a characterization of a stationary long term spectral characteristic.

### 3.9 Voice Activity Detection (VAD) Module

The voice activity detection (VAD) module 326 performs voice activity determination as the first step in characterization. The VAD module 326 operates to determine if the pre-processed speech signal 308 is some form of speech or if it is merely silence or background noise. One embodiment of the VAD module 326 detects voice activity by tracking the behavior of the background noise. The VAD module 326 monitors the difference between parameters of the current frame and parameters representing the background noise. Using a set of predetermined threshold values, the frame may be classified as a speech frame or as a background noise frame.

The VAD module 326 operates to determine the voice activity based on monitoring a plurality of parameters, such as, the maximum of the absolute value of the samples in the frame, as well as the reflection coefficients, the prediction error, the LSFs and the 10th order autocorrelation coefficients provided by the LPC analysis module 330. In addition, an example embodiment of the VAD module 326 uses the parameters of the pitch lag and the adaptive codebook gain from recent frames. The pitch lags and the adaptive codebook gains used by the VAD module 326 are from the previous frames since pitch lags and adaptive codebook gains of the current frame are not yet available. The voice activity determination performed by the VAD module 326 may be used to control several aspects of the encoding system 12, as well as forming part of a final class characterization decision by the characterization module 328.

### 3.10 Characterization Module

Following the voice activity determination by the VAD module 326, the characterization module 328 is activated. The characterization module 328 performs the second, third, fourth and fifth categories of analysis of the pre-processed speech signal 308 as previously discussed. The second category is the detection of unvoiced noise-like speech frames.

#### 3.10.1 Unvoiced Noise-Like Speech Detection

In general, unvoiced noise-like speech frames do not include a harmonic structure, whereas voiced frames do. The detection of an unvoiced noise-like speech frame, in one embodiment, is based on the pre-processed speech signal 308, and a weighted residual signal $R_w(z)$ given by:

$$R_w(Z) = A(z/\gamma_1) \cdot S(z) \qquad \text{(Equation 8)}$$

Where $A(z/\gamma_1)$ represents a weighted zeros-filter with the weighting $\gamma_1$ and $S(z)$ is the pre-processed speech signal 308. A plurality of parameters, such as the following six parameters may be used to determine if the current frame is unvoiced noise-like speech:

1. The energy of the pre-processed speech signal 308 over the first ¾ of the frame.
2. A count of the speech samples within the frame that are under a predetermined threshold.
3. A residual sharpness determined using a weighted residual signal and the frame size. The sharpness is given by the ratio of the average of the absolute values of the samples to the maximum of the absolute values of the samples. The weighted residual signal may be determined from Equation 8.
4. A first reflection coefficient representing the tilt of the magnitude spectrum of the pre-process speech signal 308.
5. The zero crossing rate of the pre-processed speech signal 308.
6. A prediction measurement between the pre-processed speech signal 308 and the weighted residual signal.

In one embodiment, a set of predetermined threshold values are compared to the above listed parameters in making the determination of whether a frame is unvoiced noise-like speech. The resulting determination may be used in controlling the pitch pre-processing module 322, and in the fixed codebook search, both of which will be described later. In addition, the unvoiced noise-like speech determination is used in determining the 6-class signal characterization of the pre-processed speech signal 308.

### 3.10.2 6-Class Signal Characterization

The characterization module 328 may also perform the third category of analysis that is the 6-class signal characterization. The 6-class signal characterization is performed by characterizing the frame into one of 6 classes according to the dominant features of the frame. In one embodiment, the 6 classes may be described as:

0. Silence/Background Noise
1. Stationary Noise-Like Unvoiced Speech
2. Non-Stationary Unvoiced
3. Onset
4. Non-Stationary Voiced
5. Stationary Voiced

In an alternative embodiment, other classes are also included such as frames characterized as plosive. Initially, the characterization module 328 distinguishes between silence/background noise frames (class 0), non-stationary unvoiced frames (class 2), onset frames (class 3), and voiced frames represented by class 4 and 5. Characterization of voiced frames as Non-Stationary (class 4) and Stationary (class 5) may be performed during activation of the pitch pre-processing module 322. Furthermore, the characterization module 328 may not initially distinguish between stationary noise-like unvoiced frames(class 1) and non-stationary unvoiced frames(class 2). This characterization class may also be identified during processing by the pitch pre-processing module 322 using the determination by the unvoiced noise-like speech algorithm previously discussed.

The characterization module 328 performs characterization using, for example, the pre-processed speech signal 308 and the voice activity detection by the VAD module 326. In addition, the characterization module 328 may utilize the open loop pitch lag for the frame and the normalized correlation $R_p$ corresponding to the second open loop pitch lag.

A plurality of spectral tilts and a plurality of absolute maximums may be derived from the pre-processed speech signal 308 by the characterization module 328. In an example embodiment, the spectral tilts for 4 overlapped segments comprising 80 samples each are calculated. The 4 overlapped segments may be weighted by a Hamming window of 80 samples. The absolute maximums of an example embodiment are derived from 8 overlapped segments of the pre-processed speech signal 308. In general, the length of each of the 8 overlapped segments is about 1.5 times the period of the open loop pitch lag. The absolute maximums may be used to create a smoothed contour of the amplitude envelope.

The spectral tilt, the absolute maximum, and the pitch correlation $R_p$ parameters may be updated or interpolated multiple times per frame. Average values for these parameters may also be calculated several times for frames characterized as background noise by the VAD module 326. In an example embodiment, 8 updated estimates of each parameter are obtained using 8 segments of 20 samples each. The estimates of the parameters for the background noise may be subtracted from the estimates of parameters for subsequent frames not characterized as background noise to create a set of "noise cleaned" parameters.

A set of statistically based decision parameters may be calculated from the "noise clean" parameters and the open loop pitch lag. Each of the statistically based decision parameters represents a statistical property of the original parameters, such as, averaging, deviation, evolution, maximum, or minimums. Using a set of predetermined threshhold parameters, initial characterization decisions may be made for the current frame based on the statistical decision parameters. Based on the initial characterization decision, past characterization decisions, and the voice activity decision of the VAD module 326, an initial class decision may be made for the frame. The initial class decision characterizes the frame as one of the classes 0, 2, 3, or as a voiced frame represented by classes 4 and 5.

### 3.10.3 Noise-to-Signal Ratio Derivation

In addition to the frame characterization, the characterization module 328 of one embodiment also performs the fourth category of analysis by deriving a noise-to-signal ratio (NSR). The NSR is a traditional distortion criterion that may be calculated as the ratio between an estimate of the background noise energy and the frame energy of a frame. One embodiment of the NSR calculation ensures that only true background noise is included in the ratio by using a modified voice activity decision. The modified voice activity decision is derived using the initial voice activity decision by the VAD module 326, the energy of the frame of the pre-processed speech signal 308 and the LSFs calculated for the lookahead portion. If the modified voice activity decision indicates that the frame is background noise, the energy of the background noise is updated.

The background noise is updated from the frame energy using, for example, moving average. If the energy level of the background noise is larger than the energy level of the frame energy, it is replaced by the frame energy. Replacement by the frame energy can involve shifting the energy level of the background noise lower and truncating the result. The result represents the estimate of the background noise energy that may be used in the calculation of the NSR.

Following calculation of the NSR, the characterization module 328 performs correction of the initial class decision to a modified class decision. The correction may be performed using the initial class decision, the voice activity determination and the unvoiced noise-like speech determination. In addition, previously calculated parameters representing, for example, the spectrum expressed by the reflection coefficients, the pitch correlation $R_p$, the NSR, the energy of the frame, the energy of the previous frames, the residual sharpness and a sharpness of the weighted speech may also be used. The correction of the initial class decision is called characterization tuning. Characterization tuning can change the initial class decision, as well as set an onset condition flag and a noisy voiced flag if these conditions are identified. In addition, tuning can also trigger a change in the voice activity decision by the VAD module 326.

### 3.10.4 4-Grade Characterization

The characterization module 328 can also generate the fifth category of characterization, namely, the 4-grade characterization. The 4-grade characterization is a parameter that controls the pitch pre-processing module 322. One embodiment of the 4-grade characterization distinguishes between 4 categories. The categories may be labeled numerically from 1 to 4. The category labeled 1 is used to reset the pitch pre-processing module 322 in order to prevent accumulated delay that exceeds a delay budget during pitch pre-processing. In general, the remaining categories indicate increasing voicing strength. Increasing voicing strength is a measure of the periodicity of the speech. In an alternative embodiment, more or less categories could be included to indicate the levels of voicing strength.

### 3.10.5 Stationary Long-Term Spectral Characteristics

The characterization module 328 may also performs the sixth category of analysis by determining the stationary long-term spectral characteristics of the pre-processed speech signal 308. The stationary long-term spectral characteristic is determined over a plurality of frames using, for example, spectral information such as the LSFs, the 6-class signal characterization and the open loop pitch gain. The determination is based on long-term averages of these parameters.

### 3.11 Rate Selection Module

Following the modified class decision by the characterization module 328, the rate selection module 320 can make an initial rate selection called an open loop rate selection. The rate-selection module 320 can use, for example, the modified class decision, the NSR, the onset flag, the residual energy, the sharpness, the pitch correlation Rp, and spectral parameters such as the reflection coefficients in determining the open-loop rate selection. The open loop rate selection may also be selected based on the Mode that the speech compression system 10 is operating within. The rate selection module 320 is tuned to provide the desired average bit rate as indicated by each of the Modes. The initial rate selection may be modified following processing by the pitch pre-processing module 322 that will be described later.

**3.12 Pitch Pre-Processing Module**

The pitch pre-processing module 322 operates on a frame basis to perform analysis and modification of the weighted speech 344. The pitch pre-processing module 322 may, for example, uses compression or dilation techniques on pitch cycles of the weighted speech 344 in order to improve the encoding process. The open loop pitch lag is quantized by the pitch pre-processing module 322 to generate the open loop adaptive codebook component 144a or 176a, as previously discussed with reference to FIGS. 2, 4 and 5. If the final type classification of the frame is Type One, this quantization represents the pitch lag for the frame. However, if the type classification is changed following processing by the pitch pre-processing module 322, the pitch lag quantization also is changed to represent the closed loop adaptive codebook component 144b or 176b, as previously discussed with reference to FIGS. 2, 4 and 5.

The open loop pitch lag for the frame that was generated by the open loop pitch estimation module 316 is quantized and interpolated, to create a pitch track 348. In general, the pitch pre-processing module 322 attempts to modify the weighted speech 344 to fit the pitch track 348. If the modification is successful, the final type classification of the frame is Type One. If the medication is unsuccessful the final type classification of the frame is Type Zero.

As further detailed later, the pitch pre-processing modification procedure can perform continuous time warping of the weighted speech 344. The warping introduces a variable delay. In one example embodiment, the maximum variable delay within the encoding system 12 is 20 samples (2.5 ms). The weighted speech 344 may be modified on a pitch cycle-by-pitch cycle basis, with certain overlap between adjacent pitch cycles to avoid discontinuities between the reconstructed/modified segments. The weighted speech 344 may be modified according to the pitch track 348 to generate a modified weighted speech 350. In addition, a plurality of unquantized pitch gains 352 are generated by the pitch pre-processing module 322. If the type classification of the frame is Type One, the unquantized pitch gains 352 are used to generate the Type One adaptive codebook gain component 148b (for full rate codec 22) or 180b (for half-rate codec 24). The pitch track 348, the modified weighted speech 350 and the unquantized pitch gains 352 are provided to the excitation-processing module 54.

As previously discussed, the 4-grade characterization by the characterization module 328 controls the pitch pre-processing. In one embodiment, if the frame is predominantly background noise or unvoiced with low pitch correlation, such as, category 1, the frame remains unchanged and the accumulated delay of the pitch pre-processing is reset to zero. If the frame is pre-dominantly pulse-like unvoiced, such as, category 2, the accumulated delay may be maintained without any warping of the signal except for a simple time shift. The time shift may be determined according to the accumulated delay of the input speech signal 18. For frames with the remaining 4-grade characterizations, the core of the pitch pre-processing algorithm may be executed in order to optimally warp the signal.

In general, the core of the pitch pre-processing module 322 in one embodiment performs three main tasks. First, the weighted speech 344 is modified in an attempt to match the pitch track 348. Second, a pitch gain and a pitch correlation for the signal are estimated. Finally, the characterization of the speech signal 18 and the rate selection is refined based on the additional signal information obtained during the pitch pre-processing analysis. In another embodiment, additional pitch pre-processing may be included, such as, waveform interpolation. In general, waveform interpolation may be used to modify certain irregular transition segments using forward-backward waveform interpolation techniques to enhance the regularities and suppress the irregularities of the weighted speech 344.

*3.12.1 Modification*

Modification of the weighted speech 344 provides a more accurate fit of the weighted speech 344 into a pitch-coding model that is similar to the Relaxed Code Excited Linear Prediction (RCELP) speech coding approach. An example of an implementation of RCELP speech coding is provided in the TIA (Telecommunications Industry Association) IS-127 standard. Performance of the modification without any loss of perceptual quality can include a fine pitch search, estimation of a segment size, target signal warping, and signal warping. The fine pitch search may be performed on a frame level basis while the estimation of a segment size, the target signal warping, and the signal warping may be executed for each pitch cycle.

*3.12.1.1 Fine Pitch Search*

The fine pitch search may be performed on the weighted speech 344, based on the previously determined second and third pitch lags, the rate selection, and the accumulated pitch pre-processing delay. The fine pitch search searches for fractional pitch lags. The fractional pitch lags are non-integer pitch lags that combine with the quantization of the lags. The combination is derived by searching the quantization tables of the lags used to quantize the open loop pitch lags and finding lags that maximize the pitch correlation of the weighted speech 344. In one embodiment, the search is performed differently for each codec due to the different quantization techniques associated with the different rate selections. The search is performed in a search area that is identified by the open loop pitch lag and is controlled by the accumulated delay.

### 3.12.1.2 Estimate segment size

The segment size follows the pitch period, with some minor adjustments. In general, the pitch complex (the main pulses) of the pitch cycle are located towards the end of a segment in order to allow for maximum accuracy of the warping on the perceptual most important part, the pitch complex. For a given segment the starting point is fixed and the end point may be moved to obtain the best model fit. Movement of the end point effectively stretches or compresses the time scale. Consequently, the samples at the beginning of the segment are hardly shifted, and the greatest shift will occur towards the end of the segment.

### 3.12.1.3 Target signal for warping

One embodiment of the target signal for time warping is a synthesis of the current segment derived from the modified weighted speech 350 that is represented by $s_w^t(n)$ and the pitch track 348 represented by $L_p(n)$. According to the pitch track 348, $L_p(n)$, each sample value of the target signal $s_w^t(n), n=0,...,N_s-1$ may be obtained by interpolation of the modified weighted speech 350 using a 21st order Hamming weighted Sinc window,

$$s_w'(n) = \sum_{i=-10}^{10} w_s\big(f(L_p(n)),i\big) \cdot s_w'\big(n - i(L_p(n))\big), \text{ for } n = 0,..., N_s - 1$$

**(Equation 9)**

where $i(L_p(n))$ and $f(L_p(n))$ are the integer and fractional parts of the pitch lag, respectively; $w_s(f,i)$ is the Hamming weighted Sinc window, and $N_s$ is the length of the segment. A weighted target, $s_w^{wt}(n)$, is given by $s_w^{wt}(n) = w_e(n) \cdot s_w'(n)$. The weighting function, $w_e(n)$, may be a two-piece linear function, which emphasizes the pitch complex and de-emphasizes the "noise" in between pitch complexes. The weighting may be adapted according to the 4-grade classification, by increasing the emphasis on the pitch complex for segments of higher periodicity.

The integer shift that maximizes the normalized cross correlation between the weighted target $s_w^{wt}(n)$ and the weighted speech 344 is $s_w(n + \tau_{acc})$, where $s_w(n + \tau_{acc})$ is the weighted speech 344 shifted according to an accumulated delay $\tau_{acc}$ may be found by maximizing

$$R(\tau_{shift}) = \frac{\sum_{n=0}^{N_s-1} s_w^{wt}(n) \cdot s_w(n + \tau_{acc} + \tau_{shift})}{\sqrt{\left(\sum_{n=0}^{N_s-1} s_w^{wt}(n)^2\right) \cdot \left(\sum_{n=0}^{N_s-1} s_w(n + \tau_{acc} + \tau_{shift})^2\right)}} .$$

**(Equation 10)**

A refined (fractional) shift may be determined by searching an upsampled version of $R(\tau_{shift})$ in the vicinity of $\tau_{shift}$. This may result in a final optimal shift $\tau_{opt}$ and the corresponding normalized cross correlation $R_n(\tau_{opt})$.

### 3.12.1.4 Signal Warping

The modified weighted speech 350 for the segment may be reconstructed according to the mapping given by

$$\llcorner s_w(n + \tau_{acc}), s_w(n + \tau_{acc} + \tau_c + \tau_{opt}) \lrcorner \rightarrow [s_w'(n), s_w'(n + \tau_c - 1)], \quad \text{(Equation 11)}$$

and

$$\llcorner s_w(n + \tau_{acc} + \tau_c + \tau_{opt}), s_w(n + \tau_{acc} + \tau_{opt} + N_s - 1) \lrcorner \rightarrow [s_w'(n + \tau_c), s'w(n + N_s - 1)]$$

(Equation 12)

where $\tau_c$ is a parameter defining the warping function. In general, $\tau_c$ specifies the beginning of the pitch complex. The mapping given by Equation 11 specifies a time warping, and the mapping given by Equation 12 specifies a time shift (no warping). Both may be carried out using a Hamming weighted Sinc window function.

### 3.12.2 Pitch Gain and Pitch Correlation Estimation

The pitch gain and pitch correlation may be estimated on a pitch cycle basis and are defined by Equations 11 and 12, respectively. The pitch gain is estimated in order to minimize the mean squared error between the target $s_w^t(n)$, defined by Equation 9, and the final modified signal $s_w^t(n)$, defined by Equations 11 and 12, and may be given by

$$g_a = \frac{\sum_{n=0}^{N_s-1} s_w'(n) \cdot s_w^t(n)}{\sum_{n=0}^{N_s-1} s_{w'}'(n)^2} . \qquad \text{(Equation 13)}$$

The pitch gain is provided to the excitation-processing module 54 as the unquantized pitch gains 352. The pitch correlation may be given by

$$R_a = \frac{\sum_{n=0}^{N_s-1} s_w'(n) \cdot s_w^t(n)}{\sqrt{\left(\sum_{n=0}^{N_s-1} s_w'(n)^2\right) \cdot \left(\sum_{n=0}^{N_s-1} s_w^t(n)^2\right)}} . \qquad \text{(Equation 14)}$$

Both parameters are available on a pitch cycle basis and may be linearly interpolated.

### *3.12.3 Refined Classification and Refined Rate Selection*

Following pitch pre-processing by the pitch pre-processing module 322, the average pitch correlation and the pitch gains are provided to the characterization module 328 and the rate selection module 320. The characterization module 328 and the rate selection module 320 create a final characterization class and a final rate selection, respectively, using the pitch correlation and the pitch gains. The final characterization class and the final rate selection may be determined by refining the 6-class signal characterization and the open loop rate selection of the frame.

Specifically, the characterization module 328 determines whether a frame with a characterization as a voiced frame should be characterized as class 4 - "Non-Stationary Voiced", or class 5 - "Stationary Voiced." In addition, a final determination that a particular frame is stationary noise-like unvoiced speech may occur based on the previous determination that the particular frame is modified unvoiced noise-like speech. Frames confirmed to be noise-like unvoiced speech may be characterized as class 1, "Stationary Noise-Like Unvoiced Speech."

Based on the final characterization class, the open loop rate selection by the rate selection module 320 and the half rate signaling flag on the half rate signal line 30 (FIG. 1), a final rate selection may be determined. The final rate selection is provided to the excitation-processing module 54 as a rate selection indicator 354. In addition, the final characterization class for the frame is provided to the excitation-processing module 54 as control information 356.

### 3.13 Type Classification Module

For the full rate codec 22 and the half rate codec 24, the final characterization class may also be used by the type classification module 324. A frame with a final characterization class of class 0 to 4 is determined to be a Type Zero frame, and a frame of class 5 is determined to be a Type One frame. The type classification is provided to the excitation-processing module 54 as a type indicator 358.

**4.0 EXCITATION PROCESSING MODULE**

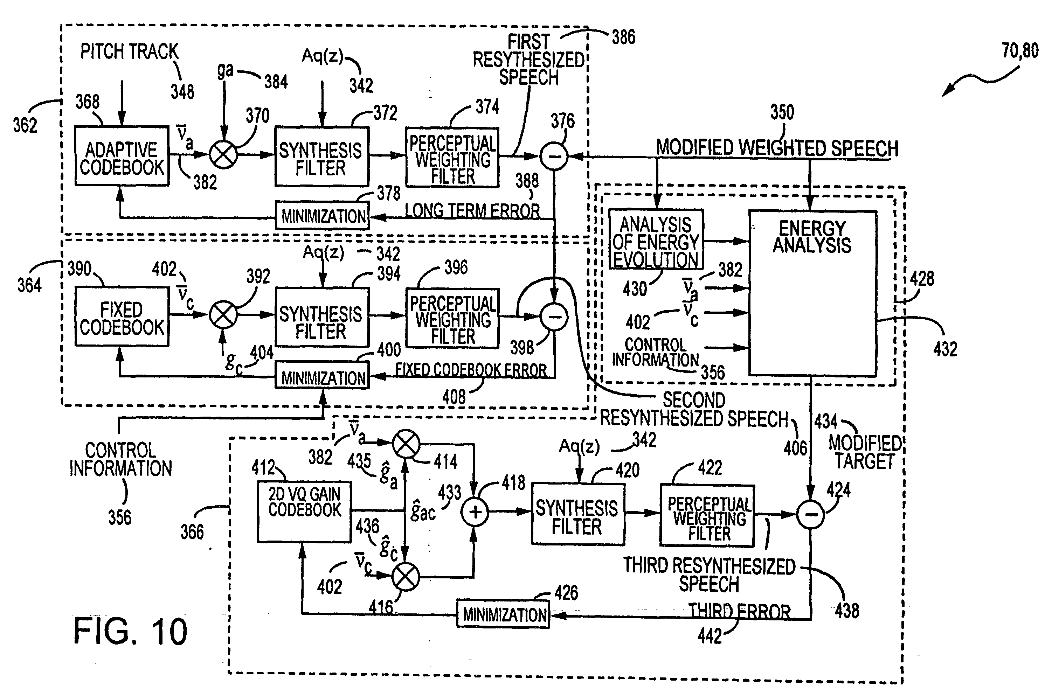

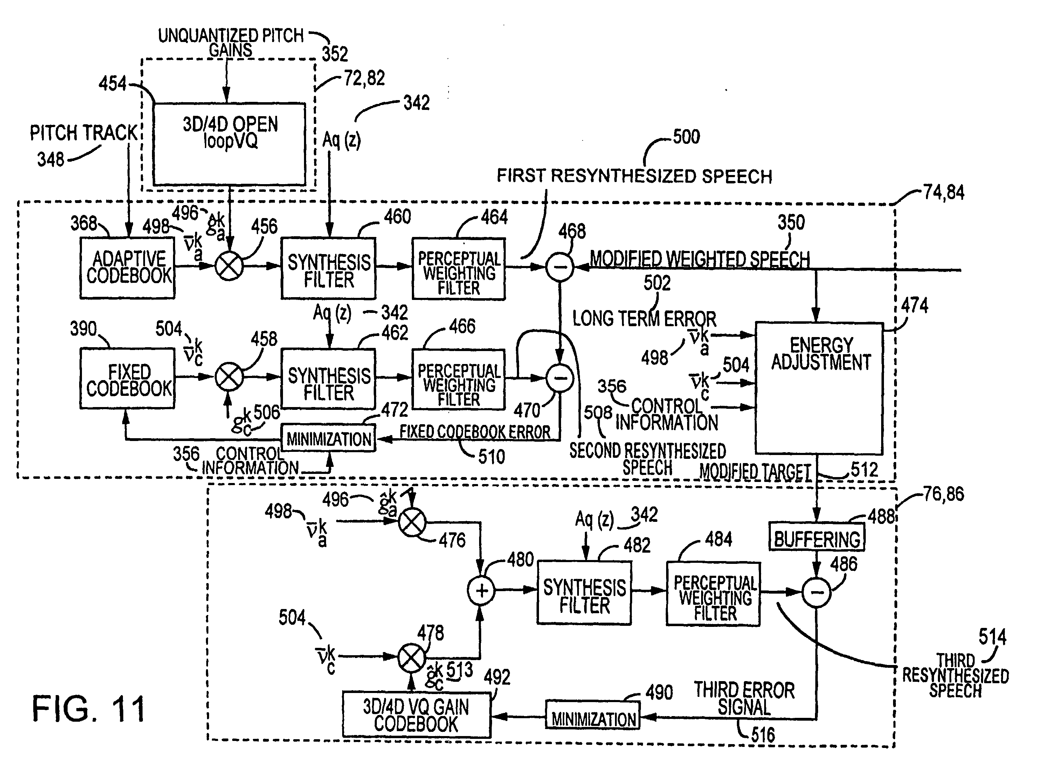

The type indicator 358 from the type classification module 324 selectively activates either the full-rate module 54 or the half-rate module 56, as illustrated in FIG. 2, depending on the rate selection. FIG. 10 is a block diagram representing the F0 or H0 first subframe-processing module 70 or 80 illustrated in FIG. 2 that is activated for the Type Zero classification. Similarly, FIG. 11 is a block diagram representing the F1 or H1 first frame processing module 72 or 82, the F1 or H1 second subframe processing module 74 or 84 and the F1 or H1 second frame processing module 76 or 86 that are activated for Type One classification. As previously discussed, the "F" and "H" represent the full-rate codec 22 and the half-rate codec 24, respectively.

Activation of the quarter-rate module 60 and the eighth-rate module 62 illustrated in FIG. 2 may be based on the rate selection. In one embodiment, a pseudo-random sequence is generated and scaled to represent the short-term excitation. The energy component 204 and 242 (FIG. 2) represents the scaling of the pseudo-random sequence, as previously discussed. In one embodiment, the "seed" used for generating the pseudo-random sequence is extracted from the bitstream, thereby providing synchronicity between the encoding system 12 and the decoding system 16.

As previously discussed, the excitation processing module 54 also receives the modified weighted speech 350, the unquantized pitch gains 352, the rate indicator 354 and the control information 356. The quarter and eighth rate codecs 26 and 28 do not utilize these signals during processing. However, these parameters may be used to further process frames of the speech signal 18 within the full-rate codec 22 and the half-rate codec 24. Use of these parameters by the full-rate codec 22 and the half-rate codec 24, as described later, depends on the type classification of the frame as Type Zero or Type One.

**4.1 Excitation Processing Module For Type Zero Frames Of The Full-Rate Codec And The Half-Rate Codec**

Referring now to FIG. 10, one embodiment of the F0 or H0 first subframe-processing module 70, 80 comprises an adaptive codebook section 362, a fixed codebook section 364 and a gain quantization section 366. The processing and coding for frames of Type Zero is somewhat similar to the traditional CELP encoding, for example, of TIA (Telecommunications Industry Association) standard IS-127. For the full-rate codec 22, the frame may be divided into four subframes, while for the half-rate codec 24, the frame may be divided into two sub frames, as previously discussed. The functions represented in FIG. 10 are executed on a subframe basis.

The F0 or H0 first subframe-processing module 70 and 80 (FIG. 2) operate to determine the closed loop pitch lag and the corresponding adaptive codebook gain for the adaptive codebook. In addition, the long-term residual is quantized using the fixed codebook, and the corresponding fixed codebook gain is also determined. Quantization of the closed loop pitch lag and joint quantization of the adaptive codebook gain and the fixed codebook gain are also performed.

*4.1.1 Adaptive Codebook Section*

The adaptive codebook section 362 includes an adaptive codebook 368, a first multiplier 370, a first synthesis filter 372, a first perceptual weighting filter 374, a first subtractor 376 and a first minimization module 378. The adaptive codebook section 362 performs a search for the best closed loop pitch lag from the adaptive codebook 368 using the analysis-by-synthesis (ABS) approach.

A segment from the adaptive codebook 368 corresponding to the closed loop pitch lag may be referred to as an adaptive codebook vector ($v_a$) 382. The pitch track 348 from the pitch pre-processing module 322 of FIG. 9 may be used to identify an area in the adaptive codebook 368 to search for vectors for the adaptive codebook vector ($v_a$) 382. The first multiplier 370 multiplies the selected adaptive codebook vector ($v_a$) 382 by a gain ($g_a$) 384. The gain ($g_a$) 384 is unquantized and represents an initial adaptive codebook gain that is calculated as will be described later. The resulting signal is passed to the first synthesis filter 372 that performs a function that is the inverse of the LPC analysis previously discussed. The first synthesis filter 372 receives the quantized LPC coefficients $A_q(z)$ 342 from the LSF quantization module 334 and together with the first perceptual weighting filter module 374, creates a first resynthesized speech signal 386. The first subtractor 376 subtracts the first resynthesized speech signal 386 from the modified weighted speech 350 to generate a long-term error signal 388. The modified weighted speech 350 is the target signal for the search in the adaptive codebook 368.

The first minimization module 378 receives the long-term error signal 388 that is a vector representing the error in quantizing the closed loop pitch lag. The first minimization module 378 performs calculation of the energy of the vector and determination of the corresponding weighted mean squared error. In addition, the first minimization module 378 controls the search and selection of vectors from the adaptive codebook 368 for the adaptive codebook vector ($v_a$) 382 in order to reduce the energy of the long-term error signal 388.

The search process repeats until the first minimization module 378 has selected the best vector for the adap-

tive codebook vector ($v_a$) 382 from the adaptive codebook 368 for each subframe. The index location of the best vector for the adaptive codebook vector ($v_a$) 382 within the adaptive codebook 368 forms part of the closed loop adaptive codebook component 144b, 176b (FIG. 2). This search process effectively minimizes the energy of the long-term error signal 388. The best closed loop pitch lag is selected by selecting the best adaptive codebook vector (v,) 382 from the adaptive codebook 368. The resulting long-term error signal 388 is the modified weighted speech signal 350 less the filtered best vector for the adaptive codebook vector ($v_a$) 382.

### 4.1.1.1 Closed-Loop Adaptive Codebook Search for the Full-Rate Codec

The closed loop pitch lag for the full-rate codec 22 is represented in the bitstream by the closed loop adaptive codebook component 144b. For one embodiment of the full-rate codec 22, the closed loop pitch lags for the first and the third subframes are represented with 8 bits, and the closed loop pitch lags for the second and the fourth subframes are represented with 5 bits, as previously discussed. In one embodiment, the lag is in a range of 17 to 148 lags. The 8 bits and the 5 bits may represent the same pitch resolution. However, the 8 bits may also represent the full range of the closed loop pitch lag for a subframe and the 5 bits may represent a limited value of closed loop pitch lags around the previous subframe closed loop pitch lag. In an example embodiment, the closed loop pitch lag resolution is 0.2, uniformly, between lag 17 and lag 33. From lag 33 to lag 91 of the example embodiment, the resolution is gradually increased from 0.2 to 0.5, and the resolution from lag 91 to lag 148 is 1.0, uniformly.

The adaptive codebook section 362 performs an integer lag search for closed loop integer pitch lags. For the first and the third subframes (i.e. those represented with 8 bits), the integer lag search may be performed on the range of $[L_p -3,...,L_p+3]$. Where $L_p$ is the subframe pitch lag. The subframe pitch lag is obtained from the pitch track 348, which is used to identify a vector in the adaptive codebook 368. The cross-correlation function, $R(l)$, for the integer lag search range may be calculated according to

$$R(l) = \frac{\sum_{n=0}^{39} t(n) \cdot (e(n-l) * h(n))}{\sqrt{\sum_{n=0}^{39} (e(n-l) * h(n))^2}},$$ 
(Equation 15)

where $t(n)$ is the target signal that is the modified weighted speech 350, $e(n)$ is the adaptive codebook contribution represented by the adaptive codebook vector ($v_a$) 382, $h(n)$ is the combined response of the first synthesis filter 372 and the perceptual weighting filter 374. In the example embodiment, there are 40 samples in a subframe, although more or less samples could be used.

The closed loop integer pitch lag that maximizes $R(l)$ may be choosen as a refined integer lag. The best vector from the adaptive codebook 368 for the adaptive codebook vector ($v_a$) 382 may be determined by upsampling the cross-correlation function $R(l)$ using a 9th order Hamming weighted Sinc. Upsampling is followed by a search of the vectors within the adaptive codebook 368 that correspond to closed loop pitch lags that are within 1 sample of the refined integer lag. The index location within the adaptive codebook 368 of the best vector for the adaptive codebook vector ($v_a$) 382 for each subframe is represented by the closed loop adaptive codebook component 144b in the bitstream. The initial adaptive codebook gain may be estimated according to:

$$g = \frac{\sum_{n=0}^{39} t(n) \cdot (e(n-L_p^{opt}) * h(n))}{\sum_{n=0}^{39} (e(n-L_p^{opt}) * h(n))^2},$$
(Equation 16)

where $L_p^{opt}$ represents the lag of the best vector for the adaptive codebook vector ($v_a$) 382 and $e(n- L_p^{opt})$ represents the best vector for the adaptive codebook vector ($v_a$) 382. In addition, in this example embodiment, the estimate is bounded by $0.0 \leq g \leq 1.2$, and n represents 40 samples in a subframe. A normalized adaptive codebook correlation is given by $R(l)$ when $1=L_p^{opt}$. The initial adaptive codebook gain may be further normalized according to the normalized adaptive codebook correlation, the initial class decision and the sharpness of the adaptive codebook contribution. The normalization results in the gain ($g_a$) 384. The gain ($g_a$) 384 is unquantized and represents the initial adaptive codebook gain for the closed loop pitch lag.

### 4.1.1.2 Closed-Loop Adaptive Codebook Search for Half-Rate Coding

The closed loop pitch lag for the half-rate codec 24 is represented by the closed loop adaptive codebook component 176b (FIG. 2). For the half-rate codec 24 of one embodiment, the closed loop pitch lags for each of the two subframes are encoded in 7 bits each with each representing a lag in the range of 17 to 127 lags. The integer lag search may be performed on the range of $[L_p -3,...,L_p+3]$ as opposed to the fractional search performed in the full-rate codec 22. The cross-correlation function $R(l)$ may be calculated as in Equation 15, where the summation is performed on an example embodiment subframe size of 80 samples. The closed loop pitch lag that maximizes $R(l)$ is choosen as the refined integer lag. The index location within the adaptive codebook 368 of the best vector for the adaptive codebook vector ($v_a$) 382 for each subframe is represented by the closed loop adaptive codebook component 176b in the bitstream.

The initial value for the adaptive codebook gain may be calculated according to Equation 16, where the summation is performed on an example embodiment subframe size of 80 samples. The normalization procedures as previously discussed may then be applied resulting in the gain ($g_a$) 384 that is unquantized.

The long-term error signal 388 generated by either the full-rate codec 22 or the half-rate codec 24 is used during the search by the fixed codebook section 364. Prior to the fixed codebook search, the voice activity decision from the VAD module 326 of FIG. 9 that is applicable to the frame is obtained. The voice activity decision for the frame may be sub-divided into a subframe voice activity decision for each subframe. The subframe voice activity decision may be used to improve perceptual selection of the fixed-codebook contribution.

### 4.1.2 Fixed Codebook Section

The fixed codebook section 364 includes a fixed codebook 390, a second multiplier 392, a second synthesis filter 394, a second perceptual weighting filter 396, a second subtractor 398, and a second minimization module 400. The search for the fixed codebook contribution by the fixed codebook section 364 is similar to the search within the adaptive codebook section 362.

A fixed codebook vector ($v_c$) 402 representing the long-term residual for a subframe is provided from the fixed codebook 390. The second multiplier 392 multiplies the fixed codebook vector ($v_c$) 402 by a gain ($g_c$) 404. The gain ($g_c$) 404 is unquantized and is a representation of the initial value of the fixed codebook gain that may be calculated as later described. The resulting signal is provided to the second synthesis filter 394. The second synthesis filter 394 receives the quantized LPC coefficients $A_q(z)$ 342 from the LSF quantization module 334 and together with the second perceptual weighting filter 396, creates a second resynthesized speech signal 406. The second subtractor 398 subtracts the resynthesized speech signal 406 from the long-term error signal 388 to generate a vector that is a fixed codebook error signal 408.

The second minimization module 400 receives the fixed codebook error signal 408 that represents the error in quantizing the long-term residual by the fixed codebook 390. The second minimization module 400 uses the energy of the fixed codebook error signal 408 to control the selection of vectors for the fixed codebook vector ($v_c$) 402 from the fixed codebook 292 in order to reduce the energy of the fixed codebook error signal 408. The second minimization module 400 also receives the control information 356 from the characterization module 328 of FIG. 9.

The final characterization class contained in the control information 356 controls how the second minimization module 400 selects vectors for the fixed codebook vector ($v_c$) 402 from the fixed codebook 390. The process repeats until the search by the second minimization module 400 has selected the best vector for the fixed codebook vector ($v_c$) 402 from the fixed codebook 390 for each subframe. The best vector for the fixed codebook vector ($v_c$) 402 minimizes the error in the second resynthesized speech signal 406 with respect to the long-term error signal 388. The indices identify the best vector for the fixed codebook vector ($v_c$) 402 and, as previously discussed, may be used to form the fixed codebook component 146a and 178a.

### 4.1.2.1 Fixed Codebook Search for the Full-Rate Codec

As previously discussed with reference to FIGs. 2 and 4, the fixed codebook component 146a for frames of Type Zero classification may represent each of four subframes of the full-rate codec 22 using the three 5-pulse codebooks 160. When the search is initiated, vectors for the fixed codebook vector ($v_c$) 402 within the fixed codebook 390 may be determined using the long-term error signal 388 that is represented by:

$$t'(n) = t(n) - g_a \cdot \left( e(n - L_p^{opt}) * h(n) \right). \qquad \text{(Equation 17)}$$

Pitch enhancement may be applied to the three 5-pulse codebooks 160 (illustrated in Fig. 4) within the fixed codebook 390 in the forward direction during the search. The search is an iterative, controlled complexity search for the best vector for the fixed codebook vector ($v_c$) 402. An initial value for fixed codebook gain represented by the gain ($g_c$) 404 may be found simultaneously with the search for the best vector for the fixed codebook vector ($v_c$) 402.

In an example embodiment, the search for the best vector for the fixed codebook vector ($v_c$) 402 is completed in each of the three 5-pulse codebooks 160. At the conclusion of the search process within each of the three 5-pulse codebooks 160, candidate best vectors for the fixed codebook vector ($v_c$) 402 have been identified. Selection of one of the three 5-pulse codebooks 160 and which of the corresponding candidate best vectors will be used may be determined using the corresponding fixed codebook error signal 408 for each of the candidate best vectors. Determination of the weighted mean squared error (WMSE) for each of the corresponding fixed codebook error signals 408 by the second minimization module 400 is first performed. For purposes of this discussion, the weighted mean squared errors (WMSEs) for each of the candidate best vectors from each of the three 5-pulse codebooks 160 will be referred to as first, second and third fixed codebook WMSEs.

The first, second, and third fixed codebook WMSEs may be first weighted. Within the full-rate codec 22, for frames classified as Type Zero, the first, second, and third fixed codebook WMSEs may be weighted by the subframe voice activity decision. In addition, the weighting may be provided by a sharpness measure of each of the first, second, and third fixed codebook WMSEs and the NSR from the characterization module 328 of FIG. 9. Based on the weighting, one of the three 5-pulse fixed codebooks 160 and the best candidate vector in that codebook may be selected.

The selected 5-pulse codebook 160 may then be fine searched for a final decision of the best vector for the fixed codebook vector ($v_c$) 402. The fine search is performed on the vectors in the selected one of the three 5 - pulse codebook 160 that are in the vicinity of the best candidate vector chosen. The indices that identify the best vector for the fixed codebook vector ($v_c$) 402 within the selected one of the three 5-pulse codebook 160 are part of the fixed codebook component 178a in the bitstream.

### 4.1.2.2 Fixed Codebook Search for the Half-Rate Codec

For frames of Type Zero classification, the fixed codebook component 178a represents each of the two subframes of the half-rate codec 24. As previously discussed, with reference to FIG. 5, the representation may be based on the pulse codebooks 192, 194 and the gaussian codebook 195. The initial target for the fixed codebook gain represented by the gain ($g_c$) 404 may be determined similarly to the full-rate codec 22. In addition, the search for the fixed codebook vector ($v_c$) 402 within the fixed codebook 390 may be weighted similarly to the full-rate codec 22. In the half-rate codec 24, the weighting may be applied to the best candidate vectors from each of the pulse codebooks 192 and 194 as well as the gaussian codebook 195. The weighting is applied to determi ne the most suitable fixed codebook vector ($v_c$) 402 from a perceptual point of view. In addition, the weighting of the weighted mean squared error (WMSE) in the half-rate codec 24 may be further enhanced to emphasize the perceptual point of view. Further enhancement may be accomplished by including additional parameters in the weighting. The additional factors may be the closed loop pitch lag and the normalized adaptive codebook correlation.

In addition to the enhanced weighting, prior to the search of the codebooks 192, 194, 195 for the best candidate vectors, some characteristics may be built into the entries of the pulse codebooks 192, 194. These characteristics can provide further enhancement to the perceptual quality. In one embodiment, enhanced perceptual quality during the searches may be achieved by modifying the filter response of the second synthesis filter 394 using three enhancements. The first enhancement may be accomplished by injecting high frequency noise into the fixed codebook, which modifies the high-frequency band. The injection of high frequency noise may be incorporated into the response of the second synthesis filter 394 by convolving the high frequency noise impulse response with the impulse response of the second synthesis filter 394.

The second enhancement may be used to incorporate additional pulses in locations that can be determined by high correlations in the previously quantized subframe. The amplitude of the additional pulses may be adjusted according to the correlation strength, thereby allowing the decoding system 16 to perform the same operation without the necessity of additional information from the encoding system 12. The contribution from these additional pulses also may be incorporated into the impulse response of the second synthesis filter 394. The third enhancement filters the fixed codebook 390 with a weak short-term spectral filter to compensate for the reduction in the formant sharpness resulting from bandwidth expansion and the quantization of the LSFs.

The search for the best vector for the fixed codebook vector ($v_c$) 402 is based on minimizing the energy of the fixed codebook error signal 408, as previously discussed. The search may first be performed on the 2-pulse codebook 192. The 3-pulse codebook 194 may be searched next, in two steps. The first step can determine a center for the second step that may be referred to as a focused search. Backward and forward weighted pitch enhancement may be applied for the search in both pulse codebooks 192 and 194. The gaussian codebook 195 may be searched last, using a fast search routine that is used to determine the two orthogonal basis vectors for encoding as previously discussed.

The selection of one of the codebooks 192, 194 and 195 and the best vector for the fixed codebook vector ($v_c$) 402 may be performed similarly to the full-rate codec 22. The indices that identify the best vector for the fixed codebook vector ($v_c$) 402 within the selected codebook are part of the fixed codebook component 178a in the bitstream.

At this point, the best vectors for the adaptive codebook vector ($v_a$) 382 and the fixed codebook vector ($v_c$) 402 have been found within the adaptive and fixed codebooks 368, 390, respectively. The unquantized initial values for the gain ($g_a$) 384 and the gain ($g_c$) 404 now may be replaced by the best gain values. The best gain values may be determined based on the best vectors for the adaptive codebook vector ($v_a$) 382 and the fixed codebook vector ($v_c$) 402 previously determined. Following determination of the best gains, they are jointly quantized. Determination and quantization of the gains occurs within the gain quantization section 366.

### 4.1.3 Gain Quantization Section

The gain quantization section 366 of one embodiment includes a 2D VQ gain codebook 412, a third multiplier 414, a fourth multiplier 416, an adder 418, a third synthesis filter 420, a third perceptual weighting filter 422, a third subtractor 424, a third minimization module 426, and an energy modification section 428. The energy modification section 428 of one embodiment includes an energy analysis module 430 and an energy adjustment module 432. Determination and quantization of the fixed and adaptive codebook gains may be performed within the gain quantization section 366. In addition, further modification of the modified weighted speech 350 occurs in the energy modification section 428, as will be discussed, to form a modified target signal 434 that may be used for the quantization.

Determination and quantization involves searching to determine a quantized gain vector ($g_{ac}$) 433 that represents the joint quantization of the adaptive codebook gain and the fixed codebook gain. The adaptive and fixed codebook gains, for the search, may be obtained by minimizing the weighted mean square error according to:

$$\{g_a, g_c\} = \arg\min\left\{\sum_{n=0}^{79}\left(t(n) - \left(\left(g_a v_a(n) * h(n)\right) + \left(g_c v_c(n) * h(n)\right)\right)\right)^2\right\}.$$

**(Equation 18)**

Where $v_a(n)$ is the best vector for the adaptive codebook vector ($v_a$) 382, and $v_c(n)$ is the best vector for the fixed codebook vector ($v_c$) 402 as previously discussed. In the example embodiment, the summation is based on a frame that contains 80 samples, such as, in one embodiment of the half-rate codec 24. The minimization may be obtained jointly (obtaining $g_a$ and $g_c$ concurrently) or sequentially (obtaining $g_a$ first and then $g_c$), depending on a threshold value of the normalized adaptive codebook correlation. The gains may then be modified in part, to smooth the fluctuations of the reconstructed speech in the presence of background noise. The modified gains are denoted $g'_a$ and $g'_c$. The modified target signal 434 may be generated using the modified gains by:

$$t''(n) = g'_a v_a(n) * h(n) + g'_c v_c(n) * h(n) \tag{Equation 19}$$

A search for the best vector for the quantized gain vector ($\hat{g}_{ac}$) 433 is performed within the 2D VQ gain codebook 412. The 2D VQ gain codebook 412 may be the previously discussed 2D gain quantization table illustrated as Table 4. The 2D VQ gain codebook 412 is searched for vectors for the quantized gain vector ($\hat{g}_{ac}$) 433 that minimize the mean square error, i.e., minimizing

$$E = \sum_{n=0}^{79}\left(t''(n) - \left(\hat{g}_a v_a(n) * h(n) + \hat{g}_c v_c(n) * h(n)\right)\right)^2, \tag{Equation 20}$$

where a quantized fixed codebook gain ($\hat{g}_a$) 435 and a quantized adaptive codebook gain ($\hat{g}_c$) 436 may be derived from the 2D VQ gain codebook 412. In the example embodiment, the summation is based on a frame that contains 80 samples, such as, in one embodiment of the half-rate codec 24. The quantized vectors in the 2D VQ gain codebook 412 actually represent the adaptive codebook gain and a correction factor for the fixed codebook gain as previously discussed.

Following determination of the modified target signal 434, the quantized gain vector ($\hat{g}_{ac}$) 433 is passed to multipliers 414, 416. The third multiplier 414 multiplies the best vector for the adaptive codebook vector ($v_a$) 382 from the adaptive codebook 368 with the quantized adaptive codebook gain ($\hat{g}_a$) 435. The output from the third multiplier 414 is provided to the adder 418. Similarly, the fourth multiplier 416 multiplies the quantized fixed codebook gain ($\hat{g}_c$) 436 with the best vector for the fixed codebook vector ($v_c$) 402 from the fixed codebook 390. The output from the fourth multiplier 416 is also provided to the adder 418. The adder 418 adds the outputs from the multipliers 414, 416 and provides the resulting signal to the third synthesis filter 420.

The combination of the third synthesis filter 420 and the perceptual weighting filter 422 generates a third resynthesized speech signal 438. As with the first and second synthesis filters 372 and 394, the third synthesis filter 420 receives the quantized LPC coefficients $A_q(z)$ 342. The third subtractor 424 subtracts the third resynthesized speech signal 438 from the modified target signal 434 to generate a third error signal 442. The third minimization module 426 receives the third error signal 442 that represents the error resulting from joint quantization of the fixed codebook gain and the adaptive codebook gain by the 2D VQ gain codebook 412. The third minimization module 426 uses the energy of the third error signal 442 to control the search and selection of vectors from the 2D VQ gain codebook 412 in order to reduce the energy of the third error signal 442.

The process repeats until the third minimization module 426 has selected the best vector from the 2D VQ gain codebook 412 for each subframe that minimizes the energy of the third error signal 442. Once the energy of the third error signal 442 has been minimized for each subframe, the index locations of the jointly quantized gains ($\hat{g}_a$) and ($\hat{g}_c$) 435 and 436 are used to generate the gain component 147, 179 for the frame. For the full-rate codec 22, the gain component 147 is the fixed and adaptive gain component 148a, 150a and for the half-rate codec 24, the gain component 179 is the adaptive and fixed gain component 180a and 182a.

The synthesis filters 372, 394 and 420, the perceptual weighting filters 374, 396 and 422, the minimization modules 378, 400 and 426, the multipliers 370, 392, 414 and 416, the adder 418, and the subtractors 376, 398 and 424 (as well as any other filter, minimization module, multiplier, adder, and subtractor described in this application) may be replaced by any other device, or modified in a manner known to those of ordinary skill in the art, that may be appropriate for the particular application.

**4.2 Excitation Processing Module For Type One Frames Of The Full-Rate Codec And The Half-Rate Codec**

In Fig. 11, the F1, H1 first frame processing modules 72 and 82 includes a 3D/4D open loop VQ module 454. The F 1, H 1 second sub-frame processing modules 74 and 84 of one embodiment include the adaptive codebook 368, the fixed codebook 390, a first multiplier 456, a second multiplier 458, a first synthesis filter 460, and a second synthesis filter 462. In addition, the F1, H1 second sub-frame processing modules 74 and 84 include a first perceptual weighting filter 464, a second perceptual weighting filter 466, a first subtractor 468, a second subtractor 470, a first minimization module 472, and an energy adjustment module 474. The F1, H1 second frame processing modules 76 and 86 include a third multiplier 476, a fourth multiplier 478, an adder 480, a third synthesis filter 482, a third perceptual weighting filter 484, a third subtractor 486, a buffering module 488, a second minimization module 490 and a 3D/4D VQ gain codebook 492.

The processing of frames classified as Type One within the excitation-processing module 54 provides processing on both a frame basis and a sub-frame basis, as previously discussed. For purposes of brevity, the following discussion will refer to the modules within the full rate codec 22. The modules in the half rate codec 24 may be considered to function similarly, unless otherwise noted. Quantization of the adaptive codebook gain by the F1 first frame-processing module 72 generates the adaptive gain component 148b. The F1 second subframe processing module 74 and the F1 second frame processing module 76 operate to determine the fixed codebook vector and the corresponding fixed codebook gain, respectively as previously set forth. The F1 second subframe-processing module 74 uses the track tables, as previously discussed, to generate the fixed codebook component 146b as illustrated in FIG. 2.

The F1 second frame-processing module 76 quantizes the fixed codebook gain to generate the fixed gain component 150b. In one embodiment, the full-rate codec 22 uses 10 bits for the quantization of 4 fixed codebook gains, and the half-rate codec 24 uses 8 bits for the quantization of the 3 fixed codebook gains. The quantization may be performed using moving average prediction. In general, before the prediction and the quantization are performed, the prediction states are converted to a suitable dimension.

*4.2.1 First Frame Processing Module*

One embodiment of the 3D/4D open loop VQ module 454 may be the previously discussed four-dimensional pre vector quantizer (4D pre VQ) 166 and associated pre-gain quantization table for the full-rate codec 22. Another embodiment of the 3D/4D open loop VQ module 454 may be the previously discussed three-dimensional pre vector quantizer (3D pre VQ) 198 and associated pre-gain quantization table for the half-rate codec 24. The 3D/4D open loop VQ module 454 receives the unquantized pitch gains 352 from the pitch pre-processing module 322. The unquantized pitch gains 352 represent the adaptive codebook gain for the open loop pitch lag, as previously discussed.

The 3D/4D open loop VQ module 454 quantizes the unquantized pitch gains 352 to generate a quantized pitch gain ($\hat{g}^k_a$) 496 representing the best quantized pitch gains for each subframe where k is the number of subframes. In one embodiment, there are four subframes for the full-rate codec 22 and three subframes for the half-rate codec 24 which correspond to four quantized gains ($\hat{g}^1_a$, $\hat{g}^2_a$, $\hat{g}^3_a$, $\hat{g}^4_a$) and three quantized gains ($\hat{g}^1_a$, $\hat{g}^2_a$, $\hat{g}^3_a$) of each subframe, respectively. The index location of the quantized pitch gain ($\hat{g}^k_a$) 496 within the pre-gain quantization table represents the adaptive gain component 148b for the full-rate codec 22 or the adaptive gain component 180b for the half-rate codec 24. The quantized pitch gain ($\hat{g}^k_a$) 496 is provided to the F1 second subframe-processing module 74 or the H 1 second subframe-processing module 84.

### 4.2.2 Second Sub-Frame Processing Module

The F 1 or H1 second subframe-processing module 74 or 84 uses the pitch track 348 provided by the pitch pre-processing module 322 to identify an adaptive codebook vector ($v^k_a$) 498. The adaptive codebook vector ($v^k_a$) 498 represents the adaptive codebook contribution for each subframe where k equals the subframe number. In one embodiment, there are four subframes for the full-rate codec 22 and three subframes for the half-rate codec 24 which correspond to four vectors ($v^1_a$, $v^2_a$, $v^3_a$, $v^4_a$) and three vectors ($v^1_a$, $v^2_a$, $v^3_a$) for the adaptive codebook contribution for each subframe, respectively.

The vector selected for the adaptive codebook vector ($v^k_a$) 498 may be derived from past vectors located in the adaptive codebook 368 and the pitch track 348. Where the pitch track 348 may be interpolated and is represented by $L_p(n)$. Accordingly, no search is required. The adaptive codebook vector ($v^k_a$) 498 may be obtained by interpolating the past adaptive codebook vectors ($v^k_a$) 498 in the adaptive codebook with a 21st order Hamming weighted Sinc window by:

$$v_a(n) = \sum_{i=-10}^{10} w_s\big(\mathrm{f}(L_p(n)), i\big) \cdot e\big(n - \mathrm{i}(L_p(n)\big), \qquad \text{(Equation 21)}$$

where $e(n)$ is the past excitation, $\mathrm{i}(L_p(n))$ and $\mathrm{f}(L_p(n))$ are the integer and fractional part of the pitch lag, respectively, and $w_s(f,i)$ is the Hamming weighted Sinc window.

The adaptive codebook vector ($v^k_a$) 498 and the quantized pitch gain ($\hat{g}^k_a$) 496 are multiplied by the first multiplier 456. The first multiplier 456 generates a signal that is processed by the first synthesis filter 460 and the first perceptual weighting filter module 464 to provide a first resynthesized speech signal 500. The first synthesis filter 460 receives the quantized LPC coefficients $A_q(z)$ 342 from the LSF quantization module 334 as part of the processing. The first subtractor 468 subtracts the first resynthesized speech signal 500 from the modified weighted speech 350 provided by the pitch pre-processing module 322 to generate a long-term error signal 502.

The F1 or H1 second subframe-processing module 74 or 84 also performs a search for the fixed codebook contribution that is similar to that performed by the F0 or H0 first subframe-processing module 70 and 80, previously discussed. Vectors for a fixed codebook vector ($v^k_c$) 504 that represents the long-term residual for a subframe are selected from the fixed codebook 390 during the search. The second multiplier 458 multiplies the fixed codebook vector ($v^k_c$) 504 by a gain ($g^k_c$) 506 where k is the subframe number. The gain ($g^k_c$) 506 is unquantized and represents the fixed codebook gain for each subframe. The resulting signal is processed by the second synthesis filter 462 and the second perceptual weighting filter 466 to generate a second resynthesized speech signal 508. The second resynthesized speech signal 508 is subtracted from the long-term error signal 502 by the second subtractor 470 to produce a fixed codebook error signal 510.

The fixed codebook error signal 510 is received by the first minimization module 472 along with the control information 356. The first minimization module 472 operates the same as the previously discussed second minimization module 400 illustrated in FIG. 10. The search process repeats until the first minimization module 472 has selected the best vector for the fixed codebook vector ($v^k_c$) 504 from the fixed codebook 390 for each subframe. The best vector for the fixed codebook vector ($v^k_c$) 504 minimizes the energy of the fixed codebook error signal 510. The indices identify the best vector for the fixed codebook vector ($v^k_c$) 504, as previously discussed, and form the fixed codebook component 146b and 178b.

### 4.2.2.1 Fixed Codebook Search for Full-Rate Codec

In one embodiment, the 8-pulse codebook 162, illustrated in FIG. 4, is used for each of the four subframes for frames of type 1 by the full-rate codec 22, as previously discussed. The target for the fixed codebook vector ($v^k_c$) 504 is the long-term error signal 502, as previously described. The long-term error signal 502, represented by t'(n), is determined based on the modified weighted speech 350, represented by t(n), with the adaptive codebook contribution from the initial frame processing module 44 removed according to:

$$t'(n) = t(n) - g_a \cdot \left(v_a(n) * h(n)\right). \qquad \text{(Equation 22)}$$

During the search for the best vector for the fixed codebook vector ($v^k_c$) 504, pitch enhancement may be applied in the forward direction. In addition, the search procedure minimizes the fixed codebook residual 508 using an iterative search procedure with controlled complexity to determine the best vector for the fixed codebook vector $v^k_c$ 504. An initial fixed codebook gain represented by the gain ($g^k_c$) 506 is determined during the search. The indices identify the best vector for the fixed codebook vector ($v^k_c$) 504 and form the fixed codebook component 146b as previously discussed.

### 4.2.2.2 Fixed Codebook Search for Half-Rate Codec

In one embodiment, the long-term residual is represented with 13 bits for each of the three subframes for frames classified as Type One for the half-rate codec 24, as previously discussed. The long-term residual may be determined in a similar manner to the fixed codebook search in the full-rate codec 22. Similar to the fixed-codebook search for the half-rate codec 24 for frames of Type Zero, the high-frequency noise injection, the additional pulses that are determined by high correlation in the previous subframe, and the weak short-term spectral filter may be introduced into the impulse response of the second synthesis filter 462. In addition, forward pitch enhancement also may be introduced into the impulse response of the second synthesis filter 462.

In one embodiment, a full search is performed for the 2-pulse code book 196 and the 3-pulse codebook 197 as illustrated in FIG. 5. The pulse codebook 196, 197 and the best vector for the fixed codebook vector ($v^k_c$) 504 that minimizes the fixed codebook error signal 510 are selected for the representation of the long term residual for each subframe. In addition, an initial fixed codebook gain represented by the gain ($g^k_c$) 506 may be determined during the search similar to the full-rate codec 22. The indices identify the best vector for the fixed codebook vector ($v^k_c$) 504 and form the fixed codebook component 178b.

As previously discussed, the F1 or H1 second subframe-processing module 74 or 84 operates on a subframe basis. However, the F1 or H1 second frame-processing module 76 or 86 operates on a frame basis. Accordingly, parameters determined by the F1 or H1 second subframe-processing module 74 or 84 may be stored in the buffering module 488 for later use on a frame basis. In one embodiment, the parameters stored are the best vector for the adaptive codebook vector ($v^k_a$) 498 and the best vector for the fixed codebook vector ($v^k_c$) 504. In addition, a modified target signal 512 and the gains ($g^k_a$), ($g^k_c$) 496 and 506 representing the initial adaptive and fixed codebook gains may be stored. Generation of the modified target signal 512 will be described later.

At this time, the best vector for the adaptive codebook vector ($v^k_a$) 498, the best vector for the fixed codebook vector ($v^k_c$) 504, and the best pitch gains for the quantized pitch gain ($g^k_a$) 496 have been identified. Using these best vectors and best pitch gains, the best fixed codebook gains for the gain ($g^k_c$) 506 will be determined. The best fixed codebook gains for the gain ($g^k_c$) 506 will replace the unquantized initial fixed codebook gains determined previously for the gain ($g^k_c$) 506. To determine the best fixed codebook gains, a joint delayed quantization of the fixed-codebook gains for each subframe is performed by the second frame-processing module 76 and 86.

### 4.2.3 Second Frame Processing Module

The second frame processing module 76 and 86 is operable on a frame basis to generate the fixed codebook gain represented by the fixed gain component 150b and 182b. The modified target 512 is first determined in a manner similar to the gain determination and quantization of the frames classified as Type Zero. The modified target 512 is determined for each subframe and is represented by t''(n). The modified target may be derived using the best vectors for the adaptive codebook vector ($v^k_a$) 498 and the fixed codebook vector ($v^k_c$) 504, as well as the adaptive codebook gain and the initial value of the fixed codebook gain derived from Equation 18 by:

$$t^n(n) = g_a v_a(n) * h(n) + g_c v_c(n) * h(n). \qquad \text{(Equation 23)}$$

An initial value for the fixed codebook gain for each subframe to be used in the search may be obtained by minimizing:

$$\{g_c\} = \arg\min\left\{\sum_{n=0}^{N-1}\left(t(n)-\left(\left(\hat{g}_a v_a(n)*h(n)\right)+\left(g_c v_c(n)*h(n)\right)\right)\right)^2\right\}. \quad \textbf{(Equation 24)}$$

Where $v_a(n)$ is the adaptive-codebook contribution for a particular subframe and $v_c(n)$ is the fixed-codebook contribution for a particular subframe. In addition, $\hat{g}_a$ is the quantized and normalized adaptive-codebook gain for a particular subframe that is one of the elements a quantized fixed codebook gain ($\hat{g}^k_c$) 513. The calculated fixed codebook gain $g_c$ is further normalized and corrected, to provide the best energy match between the third resynthesized speech signal and the modified target signal 512 that has been buffered. Unquantized fixed-codebook gains from the previous subframes may be used to generate the adaptive codebook vector ($v^k_a$) 498 for the processing of the next subframe according to Equation 21.

The search for vectors for the quantized fixed codebook gain ($\hat{g}^k_c$) 513 is performed within the 3D/4D VQ gain codebook 492. The 3D/4D VQ gain codebook 492 may be the previously discussed multi-dimensional gain quantizer and associated gain quantization table. In one embodiment, the 3D/4D VQ gain codebook 492 may be the previously discussed 4D delayed VQ gain quantizer 168 for the full-rate codec 22. As previously discussed, the 4D delayed VQ gain quantizer 168 may be operable using the associated delayed gain quantization table illustrated as Table 5. In another embodiment, the 3D/4D VQ gain codebook 492 may be the previously discussed 3D delayed VQ gain quantizer 200 for the half-rate codec 24. The 3D delayed VQ gain quantizer 200 may be operable using the delayed gain quantization table illustrated as the previously discussed Table 8.

The 3D/4D VQ gain codebook 492 may be searched for vectors for the quantized fixed codebook gain ($\hat{g}^k_c$) 513 that minimize the energy similar to the previously discussed 2D VQ gain codebook 412 of FIG. 10. The quantized vectors in the 3D/4D VQ gain codebook 492 actually represent a correction factor for the predicted fixed codebook gain as previously discussed. During the search, the third multiplier 476 multiplies the adaptive codebook vector ($v^k_n$) 498 by the quantized pitch gain ($\hat{g}^k_a$) 496 following determination of the modified target 512. In addition, the fourth multiplier 478 multiplies the fixed codebook vector ($v^k_c$) 504 by the quantized fixed codebook gain ($\hat{g}^k_c$) 513. The adder 480 adds the resulting signals from the multipliers 476 and 478.

The resulting signal from the adder 480 is passed through the third synthesis filter 482 and the perceptual weighting filter module 484 to generate a third resynthesized speech signal 514. As with the first and second synthesis filters 460, 462, the third synthesis filter 482 receives the quantized LPC coefficients $A_q(z)$ 342 from the LSF quantization module 334 as part of the processing. The third subtractor 486 subtracts the third resynthesized speech signal 514 from the modified target signal 512 that was previously stored in the buffering module 488. The resulting signal is the weighted mean squared error referred to as a third error signal 516.

The third minimization module 490 receives the third error signal 516 that represents the error resulting from quantization of the fixed codebook gain by the 3D/4D VQ gain codebook 492. The third minimization module 490 uses the third error signal 516 to control the search and selection of vectors from the 3D/4D VQ gain codebook 492 in order to reduce the energy of the third error signal 516. The search process repeats until the third minimization module 490 has selected the best vector from the 3D/4D VQ gain codebook 492 for each subframe that minimizes the error in the third error signal 516. Once the energy of the third error signal 516 has been minimized, the index location of the quantized fixed codebook gain ($\hat{g}^k_c$) 513 in the 3D/4D VQ gain codebook 492 is used to generate the fixed codebook gain component 150b for the full-rate codec 22, and the fixed codebook gain component 182b for the half-rate codec 24.

### 4.2.3.1 3D/4D VQ Gain Codebook

In one embodiment, when the 3D/4D VQ gain codebook 492 is a 4-dimensional codebook, it may be searched in order to minimize

$$E = \sum_{n=0}^{39} \left( t^1(n) - \left( \hat{g}_a^1 v_a^1(n) * h(n) + \hat{g}_c^1 v_c^1(n) * h(n) \right) \right)^2$$
$$+ \sum_{n=0}^{39} \left( t^2(n) - \left( \hat{g}_a^2 v_a^2(n) * h(n) + \hat{g}_c^2 v_c^2(n) * h(n) \right) \right)^2$$
$$+ \sum_{n=0}^{39} \left( t^3(n) - \left( \hat{g}_a^3 v_a^3(n) * h(n) + \hat{g}_c^3 v_c^3(n) * h(n) \right) \right)^2$$
$$+ \sum_{n=0}^{39} \left( t^4(n) - \left( \hat{g}_a^4 v_a^4(n) * h(n) + \hat{g}_c^4 v_c^4(n) * h(n) \right) \right)^2$$

(Equation 25)

where the quantized pitch gains $\{\hat{g}_a^1, \hat{g}_a^2, \hat{g}_a^3, \hat{g}_a^4\}$ originate from the initial frame processing module 44, and $\{t^1(n), t^2(n), t^3(n), t^4(n)\}$, $\{v_a^1(n), v_a^2(n), v_a^3(n), v_a^4(n)\}$, and $\{v_c^1(n), v_c^2(n), v_c^3(n), v_c^4(n)\}$ may be buffered during the subframe processing as previously discussed. In an example embodiment, the fixed codebook gains $\{g_c^1, g_c^2, g_c^3, g_c^4\}$ are derived from a 10-bit codebook, where the entries of the codebook contain a 4-dimensional correction factor for the predicted fixed codebook gains as previously discussed. In addition, n=40 to represent 40 samples per frame.

In another embodiment, when the 3D/4D VQ gain codebook 492 is a 3-dimensional codebook, it may be searched in order to minimize

$$E = \sum_{n=0}^{52} \left( t^1(n) - \left( \hat{g}_a^1 v_a^1(n) * h(n) + \hat{g}_c^1 v_c^1(n) * h(n) \right) \right)^2$$
$$+ \sum_{n=0}^{52} \left( t^2(n) - \left( \hat{g}_a^2 v_a^2(n) * h(n) + \hat{g}_c^2 v_c^2(n) * h(n) \right) \right)^2$$
$$+ \sum_{n=0}^{53} \left( t^3(n) - \left( \hat{g}_a^3 v_a^3(n) * h(n) + \hat{g}_c^3 v_c^3(n) * h(n) \right) \right)^2$$

(Equation 26)

where the quantized pitch gains $\{\hat{g}_a^1, \hat{g}_a^2, \hat{g}_a^3\}$ originate from the initial frame processing module 44, and $\{t^1(n), t^2(n), t_3(n)\}$, $\{v_a^1(n), v_a^2(n), v_a^3(n)\}$, and $\{v_c^1(n), v_c^2(n), v_c^3(n)\}$ may be buffered during the subframe processing as previously discussed. In an example embodiment, the fixed codebook gains $\{g_c^1, g_c^2, g_c^3\}$ are derived from an 8-bit codebook where the entries of the codebook contain a 3-dimensional correction factor for the predicted fixed codebook gains. The prediction of the fixed-codebook gains may be based on moving average prediction of the fixed codebook energy in the log domain.

## 5.0 DECODING SYSTEM

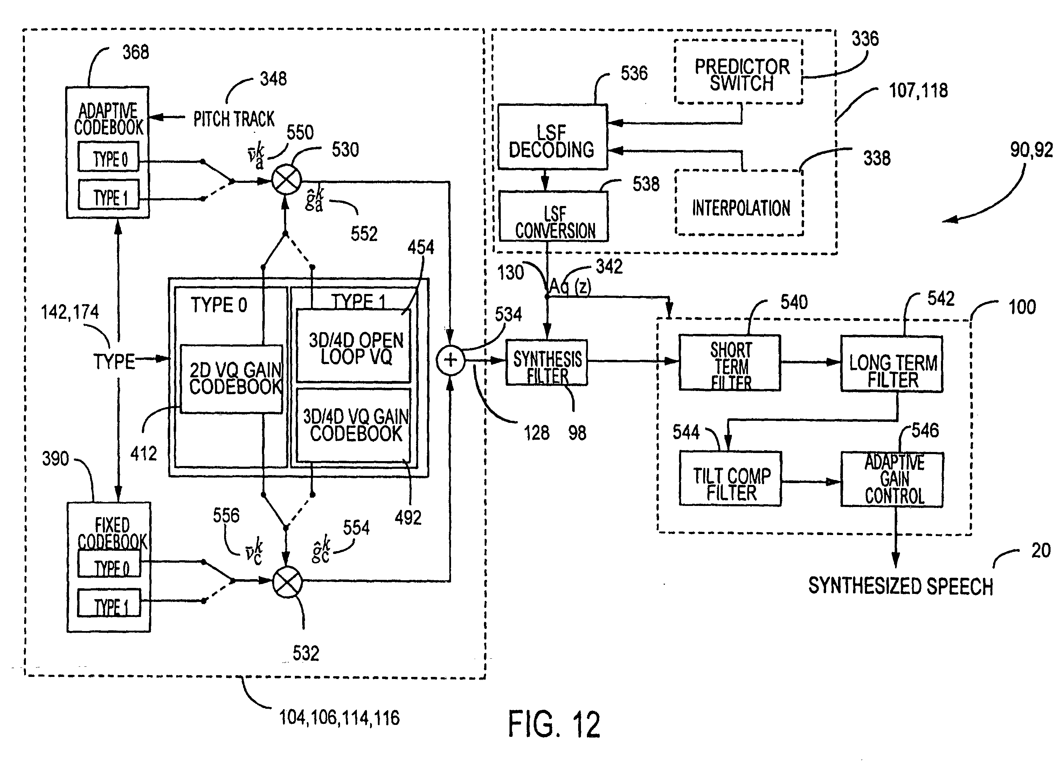

Referring now to FIG. 12, an expanded block diagram representing the full and half-rate decoders 90 and 92 of FIG. 3 is illustrated. The full or half-rate decoders 90 or 92 include the excitation reconstruction modules 104, 106, 114 and 116 and the linear prediction coefficient (LPC) reconstruction modules 107 and 118. One embodiment of each of the excitation reconstruction modules 104, 106, 114 and 116 includes the adaptive codebook 368, the fixed codebook 390, the 2D VQ gain codebook 412, the 3D/4D open loop VQ codebook 454, and the 3D/4D VQ gain codebook 492. The excitation reconstruction modules 104, 106, 114 and 116 also include a first multiplier 530, a second multiplier 532 and an adder 534. In one embodiment, the LPC reconstruction modules 107, 118 include an LSF decoding module 536 and an LSF conversion module 538. In addition, the half-rate codec 24 includes the predictor switch module 336, and the full-rate codec 22 includes the interpolation module 338.

Also illustrated in FIG. 12 are the synthesis filter module 98 and the post-processing module 100. In one embodiment, the post-processing module 100 includes a short-term post filter module 540, a long-term filter module 542, a tilt compensation filter module 544, and an adaptive gain control module 546. According to the rate selection, the bit-stream may be decoded to generate the post-processed synthesized speech 20. The decoders 90 and 92 perform inverse mapping of the components of the bit-stream to algorithm parameters. The inverse mapping may be followed by a type classification dependent synthesis within the full and half-rate codecs 22 and 24.

The decoding for the quarter-rate codec 26 and the eighth-rate codec 28 are similar to the full and half-rate codecs 22 and 24. However, the quarter and eighth-rate codecs 26 and 28 use vectors of similar yet random numbers and the energy gain, as previously discussed, instead of the adaptive and the fixed codebooks 368 and 390 and associated gains. The random numbers and the energy gain may be used to reconstruct an excitation energy that represents the short-term excitation of a frame. The LPC reconstruction modules 122 and 126 also are similar to the full and half-rate codec 22, 24 with the exception of the predictor switch module 336 and the interpolation module 338.

### 5.1 Excitation Reconstruction

Within the full and half rate decoders 90 and 92, operation of the excitation reconstruction modules 104, 106, 114 and 116 is largely dependent on the type classification provided by the type component 142 and 174. The adaptive codebook 368 receives the pitch track 348. The pitch track 348 is reconstructed by the decoding system 16 from the adaptive codebook component 144 and 176 provided in the bitstream by the encoding system 12. Depending on the type classification provided by the type component 142 and 174, the adaptive codebook 368 provides a quantized adaptive codebook vector $(v^k{}_a)$ 550 to the multiplier 530. The multiplier 530 multiplies the quantized adaptive codebook vector $(v^k{}_a)$ 550 with an adaptive codebook gain vector $(g^k{}_a)$ 552. The selection of the adaptive codebook gain vector $(g^k{}_a)$ 552 also depends on the type classification provided by the type component 142 and 174.

In an example embodiment, if the frame is classified as Type Zero in the full rate codec 22, the 2D VQ gain codebook 412 provides the adaptive codebook gain vector $(g^k{}_a)$ 552 to the multiplier 530. The adaptive codebook gain vector $(g^k{}_a)$ 552 is determined from the adaptive and fixed codebook gain component 148a and 150a. The adaptive codebook gain vector $(g^k{}_a)$ 552 is the same as part of the best vector for the quantized gain vector $(\hat{g}_{ac})$ 433 determined by the gain and quantization section 366 of the F0 first sub-frame processing module 70 as previously discussed. The quantized adaptive codebook vector $(v^k{}_a)$ 550 is determined from the closed loop adaptive codebook component 144b. Similarly, the quantized adaptive codebook vector $(v^k{}_a)$ 550 is the same as the best vector for the adaptive codebook vector $(v_a)$ 382 determined by the F0 first sub-frame processing module 70.

The 2D VQ gain codebook 412 is two-dimensional and provides the adaptive codebook gain vector $(g^k{}_a)$ 552 to the multiplier 530 and a fixed codebook gain vector $(g^k{}_c)$ 554 to the multiplier 532. The fixed codebook gain vector $(g^k{}_c)$ 554 similarly is determined from the adaptive and fixed codebook gain component 148a and 150a and is part of the best vector for the quantized gain vector $(\hat{g}_{ac})$ 433. Also based on the type classification, the fixed codebook 390 provides a quantized fixed codebook vector $(v^k{}_a)$ 556 to the multiplier 532. The quantized fixed codebook vector $(v^k{}_a)$ 556 is reconstructed from the codebook identification, the pulse locations (or the gaussian codebook 195 for the half-rate codec 24), and the pulse signs provided by the fixed codebook component 146a. The quantized fixed codebook vector $(v^k{}_a)$ 556 is the same as the best vector for the fixed codebook vector $(v_c)$ 402 determined by the F0 first sub-frame processing module 70 as previously discussed. The multiplier 532 multiplies the quantized fixed codebook vector $(v^k{}_a)$ 556 by the fixed codebook gain vector $(g^k{}_c)$ 554.

If the type classification of the frame is Type One, a multi-dimensional vector quantizer provides the adaptive codebook gain vector $(g^k{}_a)$ 552 to the multiplier 530. Where the number of dimensions in the multi-dimensional vector quantizer is dependent on the number of subframes. In one embodiment, the multi-dimensional vector quantizer may be the 3D/4D open loop VQ 454. Similarly, a multi-dimensional vector quantizer provides the fixed codebook gain vector $(g^k{}_c)$ 554 to the multiplier 532. The adaptive codebook gain vector $(g^k{}_a)$ 552 and the fixed codebook gain vector $(g^k{}_c)$ 554 are provided by the gain component 147 and 179 and are the same as the quantized pitch gain $(\hat{g}^k{}_a)$ 496 and the quantized fixed codebook gain $(\hat{g}^k{}_c)$ 513, respectively.

In frames classified as Type Zero or Type One, the output from the first multiplier 530 is received by the adder 534 and is added to the output from the second multiplier 532. The output from the adder 534 is the short-term excitation. The short-term excitation is provided to the synthesis filter module 98 on the short-term excitation line 128.

### 5.2 LPC Reconstruction

The generation of the short-term (LPC) prediction coefficients in the decoders 90 and 92 is similar to the processing in the encoding system 12. The LSF decoding module 536 reconstructs the quantized LSFs from the LSF component 140 and 172. The LSF decoding module 536 uses the same LSF prediction error quantization table and LSF predictor coefficients tables used by the encoding system 12. For the half-rate codec 24, the predictor switch module 336 selects one of the sets of predictor coefficients, to calculate the predicted LSFs as directed by the LSF component 140, 172. Interpolation of the quantized LSFs occurs using the same linear interpolation path used in the encoding system 12. For the full-rate codec 22 for frames classified as Type Zero, the interpolation module 338, selects the one of the same interpolation paths used in the encoding system 12 as directed by the LSF component 140 and 172. The weighting of the quantized LSFs is followed by conversion to the quantized LPC coefficients $A_q(z)$ 342 within the LSF conversion module 538. The quantized LPC coefficients Aq(z) 342 are the short-term prediction coefficients that are supplied to the synthesis filter 98 on the short-term prediction coefficients line 130.

### 5.3 Synthesis Filter

The quantized LPC coefficients $A_q(z)$ 342 may be used by the synthesis filter 98 to filter the short-term prediction coefficients. The synthesis filter 98 may be a short-term inverse prediction filter that generates synthesized speech prior to post-processing. The synthesized speech may then be passed through the post-processing module 100. The short-term prediction coefficients may also be provided to the post-processing module 100.

### 5.4 Post-Processing

The post-processing module 100 processes the synthesized speech based on the rate selection and the short-term prediction coefficients. The short-term post filter module 540 may be first to process the synthesized speech. Filtering parameters within the short-term post filter module 540 may be adapted according to the rate selection and the long-term spectral characteristic determined by the characterization module 328 as previously discussed with reference to FIG. 9. The short-term post filter may be described by:

$$H_{st}(z) = \frac{\hat{A}\left(z/\gamma_{1,n}\right)}{\hat{A}\left(z/\gamma_2\right)}, \qquad \text{(Equation 27)}$$

where in an example embodiment, $\gamma_{1,n} = 0.75 \cdot \gamma_{1,n-1} + 0.25 \cdot r_0$ and $\gamma_2 = 0.75$, and $r_0$ is determined based on the rate selection and the long-term spectral characteristic. Processing continues in the long term filter module 542.

The long term filter module 542 preforms a fine tuning search for the pitch period in the synthesized speech. In one embodiment, the fine tuning search is performed using pitch correlation and rate-dependent gain controlled harmonic filtering. The harmonic filtering is disabled for the quarter-rate codec 26 and the eighth-rate codec 28. The tilt compensation filter module 544, in one embodiment is a first-order finite impulse response (FIR) filter. The FIR filter may be tuned according to the spectral tilt of the perceptual weighting filter module 314 previously discussed with reference to FIG. 9. The filter may also be tuned according to the long-term spectral characteristic determined by the characterization module 328 also discussed with reference to FIG. 9.

The post filtering may be concluded with an adaptive gain control module 546. The adaptive gain control module 546 brings the energy level of the synthesized speech that has been processed within the post-processing module 100 to the level of the synthesized speech prior to the post-processing. Level smoothing and adaptations may also be performed within the adaptive gain control module 546. The result of the processing by the post-processing module 100 is the post-processed synthesized speech 20.

In one embodiment of the decoding system 16, frames received by the decoding system 16 that have been erased due to, for example, loss of the signal during radio transmission, are identified by the decoding system 16. The decoding system 16 can subsequently perform a frame erasure concealment operation. The operation involves interpolating speech parameters for the erased frame from the previous frame. The extrapolated speech parameters may be used to synthesize the erased frame. In addition, parameter smoothing may be performed to ensure continuous speech for the frames that follow the erased frame. In another embodiment, the decoding system 16 also includes bad rate determination capabilities. Identification of a bad rate selection for a frame that is received by the decoding system 16 is accomplished by identifying illegal sequences of bits in the bitstream and declaring that the particular frame is erased.

The previously discussed embodiments of the speech compression system 10 perform variable rate speech compression using the full-rate codec 22, the half-rate codec 24, the quarter-rate codec 26, and the eighth-rate codec 28. The codecs 22, 24, 26 and 28 operate with different bit allocations and bit rates using different encoding approaches to encode frames of the speech signal 18. The encoding approach of the full and half-rate codecs 22 and 24 have different perceptual matching, different waveform matching and different bit allocations depending on the type classification of a frame. The quarter and eighth-rate codecs 26 and 28 encode frames using only parametric perceptual representations. A Mode signal identifies a desired average bit rate for the speech compression system 10. The speech compression system 10 selectively activates the codecs 22, 24, 26 and 28 to balance the desired average bit rate with optimization of the perceptual quality of the post-processed synthesized speech 20.

While various embodiments of the invention have been described, it will be apparent to those of ordinary skill in the art that many more embodiments and implementations are possible that are within the scope of this invention. Accordingly, the invention is not to be restricted except in light of the attached claims and their equivalents.

MICROFICHE APPENDIX

APPENDIX A

```
/*===========================================================================*/


/*===========================================================================*/
/* Conexant System Inc.                              */
/* 4311 Jamboree Road                                */
/* Newport Beach, CA 92660                            */
/*-------------------------------------------------------*/
/* Copyright(C) 2000 Conexant System Inc.                  */
/*-------------------------------------------------------*/
/* ALL RIGHTS RESERVED:                               */
/* No part of this software may be reproduced in any form or by any */
/* means or used to make any derivative work (such as transformation */
/* or adaptation) without the authorisation of Conexant System Inc. */
/*===========================================================================*/
/* FILE: const.h                               */
/*===========================================================================*/



/*===========================================================================*/
/*========================= Coding Parameters ===========================*/
/*===========================================================================*/


#define     sqr(a)      ((a)*(a))
#define     cube(a)     ((a)*(a)*(a))


#define     MAX(a,b)    ((a)>(b) ? (a) : (b))
#define     ABS(a)      (((a)<0) ? -(a) : (a))
#define     MIN(a,b)    (((a)<(b)) ? (a) : (b))
#define     SIGN(a)     (((a)>=0) ? (1) : (-1))
#define     ROUND(a)    (INT64)((a)>0 ? ((a)+0.5) : ((a)-0.5))
#define     AVG(a,b,c)  (INT16)(((a)+(b)+(c))/(3.0)+0.5)
#define     MAXFLT      1.0e30
#define     MINFLT      1.0e-30
#define     EPSI        0.00000000000000001


#define     L_PREV      60      /* length of previous speech data */
#define     L_FRM       160     /* length of coding frame */
#define     L_SF        80      /* maximun length of subframe */
#define     L_SF3       54      /* length of subframe */
#define     L_SF4       40      /* length of subframe */
```

```
#define     L_SF0        53        /* length of subframe */
#define     N_SF_MAX      4        /* maximun number of subframes */
#define     N_SF4        4        /* number of subframes 8.5 k*/
#define     N_SF3        3        /* number of subframes 4.0 k mode 1*/
#define     N_SF2        2        /* number of subframes 4.0 k mode 0*/
#define       NP                          10


#define       NP                          10        .     :
#define     L_LPC        240       /* length of LPC window */
#define     L_LPCLHD      80        /* length of LPC lookahead */



/*==================================================================*/
/*======================= Coding Parameters ======================*/
/*==================================================================*/



#define FS                    8000.0  /* Sampling frequency */


#define  RATE8_5K    8                 /* 8.5 kbps */
#define  RATE4_0K    4                 /* 4.0 kbps */
#define  RATE2_0K    2                 /* 2.0 kbps */
#define  RATE0_8K    0              .  /* 0.8 kbps */


/*----------------------------------------------------------*/
/*       Bit-rate including overhead for the four rates         */
/*----------------------------------------------------------*/


#define RATE_1_1     9600              /* 8.5 kbit/s source coding */
#define RATE_1_2     4800              /* 4.0 kbit/s source coding */
#define RATE_1_4     2400              /* 2.0 kbit/s source coding */
#define RATE_1_8     1200              /* 0.8 kbit/s source coding */


#define NUM_SINC_WIN       21       /* Number of quantized Sinc interpolation   */
                                            /* windows                          */



/*==================================================================*/
/*===================== SPEECH ENAHNCEMENT ======================*/
```

```
/*===================================================================*/

#define ENH_DELAY    24


/*===================================================================*/
/*======================= PRE AND POST PROCESSING ==================*/
/*===================================================================*/


#define  PPR_FLT_ORDER      2
#define  LP_FLT_ORDER       1

#define SE_MEM_SIZE         4
#define SE_HIS_SIZE         5
#define SE_RAMP_SIZE 40
#define  DELTA_THRLD        48.0


/*===================================================================*/
/*===================== DEFINITIONS  FOR CLASSIFICATION ============*/
/*===================================================================*/


#define MEM_CLASS 140


#define N_Lp 3


#define MAX_N_SF 8
#define MAX_L_SF 20


#define L_LPC_SF     40 /* SHOULD NOT BE CHANGED - HARDWIRED AT PLACES */
#define OVERLAP      20
#define LPC_WIN1     (L_LPC_SF+2*OVERLAP)


#define CLA_MEM_SIZE   4
#define SLOPE_MAX_SIZE 5


/*===================================================================*/
/*=================== DEFINITIONS  FOR PERCEPTUAL WEIGHTING ========*/
/*===================================================================*/


#define GAMMA1       0.9
```

```
/*==============================================================================*/
/*========================= FIXED COEDEBOOK SEARCH ============================*/
/*==============================================================================*/


#define MAXPN                          11
#define MAX_FB_PULSE_NUM  5
#define  SEG_NUM_M1                     8
#define  SEG_NUM_M0                    16


#define L_HF              20


#define  L_CORR                 80
#define L_WSP          (L_CORR+L_SF+10)


#define PAST_PGAIN_MAX2 0.8



/*==============================================================================*/
/*========================== Gaussian codebook sizes =========================*/
/*==============================================================================*/


#define N_GAUSS_13b  45              /* Entries 1. basis vector: 13 bit codebook */


#define NUM_PRESELECT 2



/*==============================================================================*/
/*========================== DEFINITIONS  FOR LTP ============================*/
/*==============================================================================*/


#define SINC_LIMIT_E   10
#define LEN_SINC_E           (2*SINC_LIMIT_E+1)
#define LEN_SINC_TAB_E       (NUM_SINC_WIN*LEN_SINC_E)


/*==============================================================================*/
/*================= DEFINITIONS  FOR PITCH PRE-PROCESSING ===============*/
/*==============================================================================*/


#define  L_PP              (L_PREV+L_FRM+L_LPCLHD) /* length of sig_ppr = 260  */


#define SINC_LIMIT_PP  10
#define LEN_SINC_PP   (2*SINC_LIMIT_PP+1)
```

```c
#define LEN_SINC_TAB_PP (NUM_SINC_WIN*LEN_SINC_PP)


#define HALFP            2
#define MAX_PULS_NUM 5
#define MAX_DIF_TAB  16


#define  MAX_L_TG      180                     /* Maximum length for LT preprocessing    */
                                               /* Note: it must to be >= L_FRM  and > L_SF   */


#define MAX_DELAY    20


/*=============================================================================*/
/*===================== DEFINITIONS  FOR OPEN LOOP PITCH ===================*/
/*=============================================================================*/


#define NUM_MAX_SRCH   4
#define SINC_LIMIT             4
#define LEN_SINC               (2*SINC_LIMIT+1)
#define LEN_SINC_TAB (NUM_SINC_WIN*LEN_SINC)
#define DELT_F                 (1.0/((double)NUM_SINC_WIN-1.0)) /* Precision of the */
                                                                        /*

interpolation    */


#define MIN_LAG        17                          /* minimum pitch lag */
#define MAX_LAG               (L_FRM+SINC_LIMIT_E+2)     /* Maximum  pitch lag       */
                                                         /* Note: must to be > 170 and */
                                                         /*      > HI_LAG+11        */


#define L_OLPIT        (L_FRM+L_LPCLHD+MAX_LAG)          /* Open loop pitch window */


#define HI_LAG     120                          /* maximum pitch lag  */
#define HI_LAG2    148                          /* maximum pitch lag  */
#define MIN_LAG2   (HI_LAG2-127)                /* minimum pitch lag  */


#define PIT_F_MEM     3


/*=============================================================================*/
/*================== DEFINITIONS  FOR CLOSED LOOP PITCH ==================*/
/*=============================================================================*/
```

```
#define LEN_PITCH_TAB_5BIT  17
#define LEN_PITCH_TAB_7BIT  129
#define LEN_PITCH_TAB_8BIT  257


#define MAX_PIT_IDX_5b              16
#define MAX_PIT_IDX_7b              127
#define MAX_PIT_IDX_8b       255


#define DELT_F2                              (1.0/(FLOAT64)DELT_F)


/*===========================================================================*/
/*========================== DEFINITIONS FOR GAIN MA-VQ ======================*/
/*===========================================================================*/


  #define PAST_PGAIN_MIN             0.2          /* minimum value of the past quantized   */
                                                  /* pitch gain for the adaptive prefilter */
                                                  /* in the algebraic codebok search       */


  #define PAST_PGAIN_MAX             1.0          /* maximum value of the past quantized   */
                                                  /* pitch gain for the adaptive prefilter */
                                                  /* in the algebraic codebok search       */



#define MSMAX_1_64                 64
#define MSMAX_1_32                 32
#define MSMAX_2_64                 64
#define MSMAX_2_128                128
#define MSMAX_3_256                256
#define MSMAX_4_1024       1024



#define GP_BUF_SIZE      8
#define BETA_BUF_SIZE      4



#define GVQ_VEC_SIZE_2D    2

#define GVQ_VEC_SIZE_3D    3
#define TAB_SIZE_GVQ_3D    16
```

```
#define GVQ_VEC_SIZE_4D    4
#define TAB_SIZE_GVQ_4D    64


#define CORR_SIZE          6


/*================================================================*/
/*=============================== SMOOTHING ======================*/
/*================================================================*/


#define DSP_BUFF_SIZE          4
#define SMO_BUFF_SIZE              15
#define MAX_GRP_SIZE           5
#define HL_COUNT_MAX               15


#define ADAPT_THRESHOLDS   1


#define N_MODE_SUB_START   -4
#define UPDATE_MAX                 15
#define CONSEC_MAX                 31


/*----------------------------------------------------*/
/*             Smooth LSF                     */
/*----------------------------------------------------*/


#define  BETA_FRM     0.90
#define  BETA_SUB     0.70
#define  dSP1         0.0015
#define  dSP2         0.0025
#define  dSP_int1     0.0024
#define  R1lim        0.50


/*================================================================*/
/*================== DEFINITIONS  FOR LSF MA-VQ ==================*/
/*================================================================*/


#define  MAX_CAND_LSFQ     10            /* the maximal number of condidate per stage */
#define  N_LSFVQCDBK   5              /* number of LSF codebooks */
#define  MAXLNp               -   10    /* maximal order of LPC */
#define  MAXLTT_08k   3     /* the maximal number of codebooks */
#define  MAXLTT_40k   3     /* the maximal number of codebooks */
```

```
#define MAXLTT_85k    4      /* the maximal number of codebooks */


#define LP_08k    1                    /* number of switch predictors */
#define LPL_08k   1              /* the number of delayed predictors */
#define LMS1_08k  16        /* the number of entries for the 1 code */
#define LMS2_08k  16        /* the number of entries for the 2 code */
#define LMS3_08k  8         /* the number of entries for the 3 code */
#define LMSMAX_08k 16
#define LQMA_08k  4


#define LP_40k    2          /* number of switch predictors */
#define LPL_40k   2          /* the number of delayed predictors */
#define LMS1_40k  128         /* the number of entries for the 1 code */
#define LMS2_40k  128        /* the number of entries for the 2 code */
#define LMS3_40k  64         /* the number of entries for the 3 code */
#define LMSMAX_40k 128
#define LQMA_40k  4


#define LP_85k    1          /* number of switch predictors */
#define LPL_85k   1          /* the number of delayed predictors */
#define LMS1_85k  128        /* the number of entries for the 1 code */
#define LMS2_85k  64         /* the number of entries for the 2 code */
#define LMS3_85k  64         /* the number of entries for the 3 code */
#define LMS4_85k  64         /* the number of entries for the 4 code */
#define LMSMAX_85k 128
#define LQMA_85k  2



#define LTT_08k   3          /* the number of stages for T */
#define LTT_40k   3          /* the number of stages for T */
#define LTT_85k   4          /* the number of stages for T */


/*==================================================================*/
/*======================= DEFINITIONS  FOR VAD =====================*/
/*==================================================================*/


#define VOICE                       1
#define NOISE                       0


#define INIT_FRAME                  32
```

```
#define INIT_COUNT                    10

#define VAD_LPC_ORDER                 4

#define LTP_BUFF_SIZE        5

#define FLAG_VAD_MEM_SIZE 2
#define VAD_MEM_SIZE                  3
#define VAD_MIN_MEM_SIZE   8

#define MAX_ENERGY                    1.0e30

#define MIN_LAG                          17      /* minimum pitch lag */

/*====================================================================*/
/*================= DEFINITIONS  FOR BAD FRAME HANDLING ==============*/
/*====================================================================*/

#define  BFH_OH          1                     /* LSF: bad frame handling overhang */
#define  ERNG_MEM_SIZE       3
#define  MAX_BFI_COUNT       5

/*====================================================================*/
/*================= ENCODER / DECODER INDEX STRUCTURE ===============*/
/*====================================================================*/

#define PACKWDSNUM    12   /* the number of words to pack the SMV bits
                (1 for rate/erasure control, 11*16=171 for data */
typedef struct {
        INT16 idx_lsf[N_LSFVQCDBK+1];
                INT16 idx_SVS_deci;
                INT16 idx_ltp_deci[N_SF_MAX];
        INT16 idx_pitch[N_SF_MAX];
                INT16 idx_Gp_VQ;
                INT16 idx_Gc_VQ;
                INT16 idx_gainVQ[N_SF_MAX];
                INT16 idx_subcpcb[N_SF_MAX][5];
                INT16 idx_cpcbsign[N_SF_MAX][20];
        INT16 idx_cpcb[N_SF_MAX][20];
                INT16 idx_center[N_SF_MAX];
```

```
        INT16 fix_rate;

        INT16 idx_lpc_int;
        INT16 idx_vad;
        INT16 idx_pitchgainQ[N_SF_MAX];
        INT16 ltp_mode;
        INT16 idx_pit_frac[N_SF_MAX];
        INT16 idx_pit_int[N_SF_MAX];
        INT16 idx_fcbpit_frac[N_SF_MAX][2];
        INT16 idx_fcbpit_int[N_SF_MAX][2];
    } PARAMETER;
```

```
/*=====================================================================*/
/*------------------------------ END ------------------------------*/
/*=====================================================================*/
```

```
/*============================================================*/


/*============================================================*/
/* Conexant System Inc.                          */
/* 4311 Jamboree Road                            */
/* Newport Beach, CA 92660                         */
/*-------------------------------------------------*/
/* Copyright(C) 2000 Conexant System Inc.             */
/*-------------------------------------------------*/
/* ALL RIGHTS RESERVED:                          */
/* No part of this software may be reproduced in any form or by any */
/* means or used to make any derivative work (such as transformation */
/* or adaptation) without the authorisation of Conexant System Inc. */
/*============================================================*/
/* FILE: decoder.c                              */
/*============================================================*/


/*-------------------------------------------------*/
/*----------------------- INCLUDE ----------------------*/
/*-------------------------------------------------*/


#include "typedef.h"
#include "main.h"
#include "const.h"
#include "mcutil.h"
#include "gputil.h"


#include "ext_var.h"


#include "lib_lpc.h"
#include "lib_qlsf.h"
#include "lib_geq.h"
#include "lib_bit.h"
#include "lib_cla.h"
#include "lib_pit.h"
#include "lib_ltp.h"
#include "lib_ppr.h"
#include "lib_fcs.h"
#include "lib_gcb.h"
```

```
#include  "lib_flt.h"


#ifdef DIAG_SMV

#include  "lib_dia.h"

#endif


/*-----------------------------------------------------------*/
/*----------------------- FUNCTIONS -----------------------*/
/*-----------------------------------------------------------*/


/*=========================================================*/
/* FUNCTION  : dec_smv_frame ().                      */
/*-----------------------------------------------------------*/
/* PURPOSE  : Performs processing on one frame.            */
/*-----------------------------------------------------------*/
/* ALGORITHM :                              */
/*-----------------------------------------------------------*/
/* INPUT ARGUMENTS :                         */
/*          _ (INT16 []) serial:  intput frame bitstream.   */
/*-----------------------------------------------------------*/
/* OUTPUT ARGUMENTS :                          */
/*          _ (FLOAT64 []) sigout:  output decoded frame.    */
/*-----------------------------------------------------------*/
/* INPUT/OUTPUT ARGUMENTS :                      */
/*              _ None.                   */
/*-----------------------------------------------------------*/
/* RETURN ARGUMENTS :                         */
/*              _ None.                   */
/*=========================================================*/


void dec_smv_frame (INT16 PackedWords [], FLOAT64 *sigout, INT16 switch_flag)
        {
        /*-----------------------------------------------------------*/

        INT16   i_sf,i_s, l_sf, i,j, n_sf;
        FLOAT64 x, y;
```

```
/*----------------------------------------------------------*/
/*          Parameters for bitstream processing          */
/*----------------------------------------------------------*/


INT16 parm[3];
INT16 shft_count;

INT16 PackWdsPtr[2];
PARAMETER channel;


/*----------------------------------------------------------*/
/*                  Gain MA-VQ                            */
/*----------------------------------------------------------*/


FLOAT64 gainQ[N_SF_MAX];


/*----------------------------------------------------------*/
/*                  LSF quantisation                     */
/*----------------------------------------------------------*/


INT16 exp_flg;
FLOAT64  lsfq_new_dec[NP], lpcgain_q;


/*----------------------------------------------------------*/
/*                  Bad Frame Concealment                */
/*----------------------------------------------------------*/


INT16 bfi;
INT16 update;

FLOAT64 enrg;
FLOAT64 fec_refl[NP];
FLOAT64 temp_lagf;
FLOAT64 ET_buf[N_SF_MAX];


/*----------------------------------------------------------*/


FLOAT64 ForPitch_dec[L_FRM];
FLOAT64 ForPitch_decTEMP[L_FRM];
```

```
/*========================================================================*/
/* oooooooooooooooooooooooooooooooooooooooooooooooooooooooooooooooooooooo */
/* oooooooooooooooooooooooooooooo        ooooooooooooooooooooooooooooo */
/* oooooooooooooooooooooooooooo    DECODER    ooooooooooooooooooooooooooo */
/* oooooooooooooooooooooooooooooo        oooooooooooooooooooooooooooo */
/* ooooooooooooooooooooooooooooooooooooooooooooooooooooooooooooooooooooooo */
/*========================================================================*/



/*========================================================================*/
/* oooooooooooooooooooooooooooooo BFI MANAGEMENT ooooooooooooooooooooooooooo */
/*========================================================================*/


        bfi = 0;
        update = 0;


        /*----------------------------------------------------*/
        /*       Initalizing bit un-packing parameters        */
        /*----------------------------------------------------*/


        PackWdsPtr[0] = 16;
        PackWdsPtr[1] = 1;


        switch (PackedWords[0])
                {
                case 0: nrerror("Blank detected...");
                        break;

                case 1: channel.fix_rate = RATE0_8K;
                        if (bfh_oh > 0)
                                {
                                N_bfi = 0;
                                bfh_oh--;
                                }
                        break;

                case 2: channel.fix_rate = RATE2_0K;
                        if (bfh_oh > 0)
                                {
                                N_bfi = 0;
```

```
                                             bfh_oh--;
                                         }
                            break;


                    case 3: channel.fix_rate = RATE4_0K;
                                if (bfh_oh > 0)
                                    {
                                    N_bfi = 0;
                                    bfh_oh--;
                                    }
                            break;
                    case 4: channel.fix_rate = RATE8_5K;
                                if (bfh_oh > 0)
                                    {
                                    N_bfi = 0;
                                    bfh_oh--;
                                    }
                            break;


                    case 14: bfi = 1;
                                    N_bfi++;
                                    bfh_oh = BFH_OH+1;
                            break;


                                        .
                    case 15: nrerror("Full Rate Portable detected...?\n");
                            break;


                    default: nrerror("Illegal control word\n");
                            break;
                    }


        if(bfi == 1)
                nbfi_count = 0;
        else if (nbfi_count < 5)
                nbfi_count++;


        if (nbfi_count > 3)
                bfi_caution = 0;
```

```
if (bfi == 1)
        {
        frm_erasure++;
        channel.fix_rate = fix_rate_mem;
        channel.idx_SVS_deci = SVS_deci_mem;
        }


/*--------------------------------------------------------*/
/*          Decode bit-stream  if is a good frame         */
/*--------------------------------------------------------*/


if (bfi == 0)
        {
        BIT_bits_to_cdbk_index(PackedWords, PackWdsPtr, &channel);

        if (channel.fix_rate == RATE2_0K)
                {
                parm[0] = channel.idx_lsf[0];
                parm[1] = channel.idx_lsf[1];
                parm[2] = channel.idx_lpc_int;
                seed_dec = 0x00000000;
                shft_count = 15;
                for (j = 0; j <3; j++)
                        {
                        shft_count -= bitno0[j];
                        seed_dec = seed_dec ^(((long) parm[j] ) << shft_count);
                        }

                }
        else
                {
                if (channel.fix_rate == RATE0_8K)
                        {
                        parm[0] = channel.idx_lsf[0];
                        parm[1] = channel.idx_lsf[1];
                        parm[2] = channel.idx_lsf[2];
                        seed_dec = 0x00000000;
                        shft_count = 11;
                        for (j = 0; j < 3; j++)
```

```
                                    {
                                    shft_count -= bitnol[j];
                                    seed_dec = seed_dec ^(((long) parm[j] ) << shft_count);
                                    }


                              }
                       }

              }
       else

              {
              /*----------------------------------------------*/
              /*        Save adaptive codebook temporaly      */
              /*----------------------------------------------*/

              cpy_dvector(ext_dec, ext_dec_mem, 0, MAX_LAG-1);
              }


/*===============================================================================*/
/* ◻◻◻◻◻◻◻◻◻◻◻◻◻ LSF INVERSE QUANTIZATION AND INTERPOLATION ◻◻◻◻◻◻◻◻◻◻◻◻◻*/
/*===============================================================================*/



       /*----------------------------------------------*/
       /*             Get the quantized lsf            */
       /*----------------------------------------------*/

       LSF_Q_lsf_decode (bfi_caution, &exp_flg, lsfq_new_dec, channel.idx_lsf,
                         bfi, nbfi_count, channel.fix_rate);

       /*----------------------------------------------*/
       /*    Interpolate the QUANTIZED lsf and calculate corresponding   */
       /*             the LPC coefficients             */
       /*----------------------------------------------*/



       if (channel.fix_rate == RATE4_0K)
              {
              if (channel.idx_SVS_deci == 1)
                     LPC_interpolate_lpc_4to3 (lsfq_new_dec, (FLOAT64 *)NULL,
```

```
                                                                lsfq_old_dec, pdcfq_dec,
                1);

                        else
                                LPC_interpolate_lpc_4to2 (lsfq_new_dec, (FLOAT64 *)NULL,

                                                        lsfq_old_dec, pdcfq_dec,
                1);


                        }
                else

                        {
                        if ((channel.fix_rate == RATE2_0K) ||
                                        ((channel.fix_rate == RATE8_5K) &&
                                                (channel.idx_SVS_deci == 0)))
#ifdef ALGO_BUG_FIX
                                                if (bfi == 0)
                                                        {
                                                        LPC_adptive_interp_dec(lsfq_new_dec,
                                                                lsfq_old_dec, pdcfq_dec,
                                                                        channel.idx_lpc_int);


                                                        }
                                                else
                                                        LPC_adptive_interp_dec(lsfq_new_dec,
                                                                lsfq_old_dec, pdcfq_dec, 0);


#else
                                                LPC_adptive_interp_dec(lsfq_new_dec, lsfq_old_dec,
                                                        pdcfq_dec, channel.idx_lpc_int);
#endif

                        else
                                LPC_adptive_interp_dec(lsfq_new_dec, lsfq_old_dec,
                                                                pdcfq_dec, 0);
                        }


        LPC_pred2refl (pdcfq_dec[0], fec_refl, NP);


        /*-------------------------------------------------------------*/
        /*      Determination of the flatness of the input speech       */
```

```
/*------------------------------------------------------*/

CLA_Identify_Input (channel.idx_SVS_deci, pdcfq_dec[0], lsfq_new_dec[0],
                    pgain_past_dec, &lpcgain_q, channel.fix_rate, &FlatSp_Flag);


/*------------------------------------------------------*/
/*              Interpolation of Pitch Lag           */
/*------------------------------------------------------*/


if (channel.idx_SVS_deci == 1)
        {
        PIT_pitch_track_recons (fix_rate_mem, bfi, past_bfi, ppast_bfi,
                                        lag_f, SVS_deci_mem, qua_gainQ, channel,
                                                &pitchf, pitch_f_mem,
ForPitch_decTEMP);

        PIT_PitchInterpolat (pitchf, pitch_f_mem,  ForPitch_dec, 0);
        }

if ((channel.idx_SVS_deci == 0) && (channel.fix_rate == RATE8_5K))
        temp_lagf = PitLagTab8b[channel.idx_pitch[0]];
else if ((channel.idx_SVS_deci == 0) && (channel.fix_rate == RATE4_0K))
        temp_lagf = PitLagTab7b[channel.idx_pitch[0]];

LTP_adap_cbk_correction (fix_rate_mem, bfi, past_bfi, ppast_bfi,
                                qua_gainQ, gainQ, SVS_deci_mem, temp_lagf,
                                &update, pitch_f_mem, lag, lag_f,
                                ForPitch_decTEMP, ext_dec_mem, ext_dec,
                                unfcod_dec, channel);


/*------------------------------------------------------*/
/*          Gaussian excitation for very low bit rates      */
/*------------------------------------------------------*/


if ((channel.fix_rate == RATE2_0K) || (channel.fix_rate == RATE0_8K))
        {
        cpy_dvector(gp_buf+4, gp_buf, 0, 4-1);
        ini_dvector(gp_buf+4, 0, 4-1, 0.0);

        GCB_gauss_excit_dec (&seed_dec, channel.fix_rate, qua_unfcod[1]);
```

```
if (channel.fix_rate == RATE2_0K)
            {
            /*------------------------------------------------*/
            /*    Decode  the fixed codebook gain for sub-frame    */
            /*        # 1 and # 3 coded with 6 + 6 bits          */
            /*------------------------------------------------*/

            if ((fix_rate_mem == RATE8_5K) || (fix_rate_mem ==RATE0_8K))
                    GEQ_update_mem_4d_to_2d();
            else if ((fix_rate_mem == RATE4_0K) && (SVS_deci_mem != 0))
                    GEQ_update_mem_3d_to_2d();

            GEQ_dec_gains_1_6 (0, channel.idx_gainVQ[0], qua_gainQ,
                                              qua_unfcod[1], N_bfi);

            GEQ_dec_gains_1_6 (2, channel.idx_gainVQ[1], qua_gainQ,
                                              qua_unfcod[1], N_bfi);

            qua_gainQ[1][1] = qua_gainQ[1][0];
            qua_gainQ[1][3] = qua_gainQ[1][2];
            }
    else
            {
            /*------------------------------------------------*/
            /*    Decode  the fixed codebook gain for sub-frame    */
            /*            # 1  coded with 6 bits             */
            /*------------------------------------------------*/

            if ((fix_rate_mem == RATE4_0K) || (fix_rate_mem == RATE2_0K))
                    {
                    if (SVS_deci_mem == 0)
                            GEQ_update_mem_2d_to_4d();
                    else
                            GEQ_update_mem_3d_to_4d();
                    }

            GEQ_dec_gains_1_5 (channel.idx_gainVQ[0], qua_gainQ,
                                              qua_unfcod[1], N_bfi);

            for (i = 0; i < N_SF4; i++)
```

```
                    qua_gainQ[1][i] = qua_gainQ[1][0];

            }

        }


/*============================================================================*/
/* xxxxxxxxxxxxxxxxxxxxxxxxxxxxx SUB-FRAME PROCESSING xxxxxxxxxxxxxxxxxxxxxxxxxxxxx */
/*============================================================================*/


/*--------------------------------------------------------------*/
/*-------------------------VARIABLE DESCRIPTION ----------------------*/
/*--------------------------------------------------------------*/
/*                                              */
/*      pdcfq_dec   - quantized prediction coefficients          */
/*      unfcod_dec[0] - adaptive codebook (ACB) vector            */
/*      unfcod_dec[1] - algebraic codebook (CDBK) vector          */
/*      gainQ[0]     - ACB gain                          */
/*      gainQ[1]     - CDBK gain                         */
/*                                              */
/*      ext_dec     - adaptive codebook                   */
/*      lag[i_sf]    - integral lag of the current subframe        */
/*      lagf[i_sf]   - fractional lag of the current subframe       */
/*                                              */
/*--------------------------------------------------------------*/



/*--------------------------------------------------------------*/
/*             Set number of subframes              */
/*--------------------------------------------------------------*/


if (channel.fix_rate != RATE4_0K)
        n_sf=N_SF4;
else
        {
        if (channel.idx_SVS_deci == 1)
                n_sf = N_SF3;
        else
                n_sf = N_SF2;
        }
```

```
/*---------------------------------------------------------------*/
/*□□□□□□□□ First decoding loop for the decoder classification purpose □□□□□□□□*/
/*---------------------------------------------------------------*/


        i_s = 0;
        for (i_sf = 0; i_sf < n_sf; i_sf++)
                {
                /*=========================================================*/


                /*-----------------------------------------------*/
                /*          Set length of subframe           */
                /*-----------------------------------------------*/


                if (channel.fix_rate != RATE4_0K)
                        l_sf = L_SF4;
                else
                        {
                        if (channel.idx_SVS_deci == 1)
                                {
                                if (i_sf == N_SF3-1)
                                        l_sf = L_SF3;
                                else
                                        l_sf = L_SF0;
                                }
                        else
                                l_sf = L_SF;
                        }


                /*-----------------------------------------------*/
                /*          Adaptive Codebook Contribution          */
                /*-----------------------------------------------*/


                if ((channel.fix_rate == RATE8_5K) ||
                                (channel.fix_rate == RATE4_0K))
                                {
                                if (channel.idx_SVS_deci == 1)
                                        {
                                        LTP_PP_pitch_ext_decod (ForPitch_dec+i_s, ext_dec,
                                                        i_sf, unfcod_dec[0], lag, lag_f, l_sf);
```

```
                        cpy_dvector (unfcod_dec[0], qua_unfcod[0]+i_s, 0,
                                              l_sf-1);
                        lag[i_sf] = (INT16)(ForPitch_dec[l_sf/2+i_s]+0.5);
                    }
            else
                {
                if (channel.fix_rate == RATE8_5K)
                        LTP_8_5k_pitch_decod (bfi, ext_dec, i_sf,
                                    unfcod_dec[0], lag, lag_f, l_sf,
                                        channel.idx_pitch);
                    else
                        LTP_7b_pitch_decod (bfi, ext_dec, i_sf,
                                    unfcod_dec[0], lag, lag_f, l_sf,
                                        channel.idx_pitch);

                        cpy_dvector(unfcod_dec[0], qua_unfcod[0]+i_s,
                                              0, l_sf-1);
                    }
                }
            else
                {
                gainQ[0] = 0.0;
                qua_gainQ[0][i_sf] = 0.0;

                ini_dvector(unfcod_dec[0], 0, l_sf-1, 0.0);
                ini_dvector(qua_unfcod[0]+i_s, 0, l_sf-1, 0.0);
                }


/*-------------------------------------------------*/
/*          Fixed Codebook Contribution          */
/*-------------------------------------------------*/


switch (channel.fix_rate)
        {
        /*-------------------------------------------------*/
        /*               RATE 8.5 kps            */
        /*-------------------------------------------------*/
```

```
case RATE8_5K:

            if (channel.idx_SVS_deci == 1)
                    {
                    GEQ_Dec_PitchGain_4D (N_bfi, i_sf, channel.idx_Gp_VQ,
                                                    gainQ);
                    if (bfi == 0)
                            FCS_cdbk_decod_30b_sub40 (unfcod_dec[1],
                                    l_sf, i_sf, lag[i_sf], gainQ[0], &channel);
                    }
            else
                    {
                    if (bfi == 0)
                            FCS_cdbk_decod_22b_sub40(unfcod_dec[1],
                                    l_sf, i_sf, lag[i_sf], pgain_past_dec,
                                            &channel);
                    }

            break;


    /*------------------------------------------------*/
    /*              RATE 4.0 kps              */
    /*------------------------------------------------*/


    case RATE4_0K:

            if (channel.idx_SVS_deci == 1)
                    {
                    GEQ_Dec_PitchGain_3D (N_bfi, i_sf, channel.idx_Gp_VQ,
                                                    gainQ);
                    if (bfi == 0)
                            FCS_cdbk_decod_13b_sub54(ext_dec,
                                            pdcfq_dec[i_sf], unfcod_dec[1], l_sf,
                                                    i_sf, lag[i_sf], gainQ[0],
                                                            fix_rate_mem, lpcgain_q,
                                                                    &channel);

                    }
            else
                    {
```

```
                            if (bfi == 0)
                                    FCS_cdbk_decod_15b_sub80(ext_dec,
                                              pdcfq_dec[i_sf], unfcod_dec[1], l_sf,
                                                    i_sf, lag[i_sf], pgain_past_dec,
                                                          fix_rate_mem, lpcgain_q,
                                                                &channel);

                            }


                    break;


            /*-------------------------------------------------*/
            /*              RATE 2.0 kps              */
            /*-------------------------------------------------*/


            case RATE2_0K:
                    cpy_dvector (qua_unfcod[1]+i_s, unfcod_dec[1], 0,
                                                                  l_sf-1);

                    gainQ[1] = qua_gainQ[1][i_sf];
                    break;


            /*-------------------------------------------------*/
            /*              RATE 0.8 kps              */
            /*-------------------------------------------------*/


            case RATE0_8K:
                    break;


            default: nrerror ("Invalid rate !!");
                    break;
            }


    /*-------------------------------------------------*/


    if ((bfi == 1) && ((channel.fix_rate == RATE8_5K) ||
                    (channel.fix_rate == RATE4_0K)))
            {
            for (i = 0; i < l_sf; i++)
                    unfcod_dec[1][i] = GCB_gauss_noise(&seed_bfi_exc);
            }
```

```
/*----------------------------------------*/
/*        Adaptive and Fixed Codebook Gains      */
/*----------------------------------------*/


if ((channel.fix_rate == RATE8_5K) ||
                (channel.fix_rate == RATE4_0K))
                {
                /*----------------------------------------*/
                /*        RATE 8.5 kbps and 4.0 kbps      */
                /*----------------------------------------*/


                cpy_dvector (unfcod_dec[1], qua_unfcod[1]+i_s, 0,
                                                        l_sf-1);


                if (channel.idx_SVS_deci == 0)
                        {
                        if (channel.fix_rate == RATE8_5K)
                                {
                                if (((fix_rate_mem == RATE4_0K) ||
                                                (fix_rate_mem == RATE2_0K)) &&
                                                        (i_sf == 0))
                                        {
                                        if (SVS_deci_mem == 0)
                                                GEQ_update_mem_2d_to_4d();
                                        else
                                                GEQ_update_mem_3d_to_4d();
                                        }

                                GEQ_dec_gains_2_7 (channel.fix_rate,lag[0],
                                                channel.idx_gainVQ[i_sf], gainQ,
                                                        N_bfi, unfcod_dec[1], i_sf,l_sf);

                                if ((fec_refl[0] > 0.0) && (N_bfi > 0))
                                                gainQ[0] = 0.4;
                                }
                        else
                                {
                                if (((fix_rate_mem == RATE8_5K) ||
                                                (fix_rate_mem ==RATE0_8K)) &&
                                                        (i_sf == 0))
```

```
                                        {
                                          GEQ_update_mem_4d_to_2d();
                                        }
                                else
                                        {
                                        if ((fix_rate_mem == RATE4_0K) &&
                                                        (SVS_deci_mem != 0) &&
                                                                (i_sf == 0))
                                                        {

GEQ_update_mem_3d_to_2d();

                                                        }
                                        }

                                GEQ_dec_gains_2_7(channel.fix_rate,lag[0],

        channel.idx_gainVQ[i_sf],
                                                                gainQ, N_bfi,
unfcod_dec[1],
                                                                        i_sf,
l_sf);

                                if (((fec_refl[0] > 0.0) && (N_bfi > 0))
                                                gainQ[0] = 0.4;
                                        }
                                }
                        else
                                {
                                if (channel.fix_rate == RATE8_5K)
                                        {
                                        if ((((fix_rate_mem == RATE4_0K) ||
                                                        (fix_rate_mem == RATE2_0K))&& (i_sf
== 0))

                                                {
                                                if (SVS_deci_mem == 0)
                                                        GEQ_update_mem_2d_to_4d();
                                                else
                                                        GEQ_update_mem_3d_to_4d();
                                                }
                                        GEQ_dec_gc_4_10 (channel.idx_Gc_VQ, &(gainQ[1]),
```

```
                                                                    N_bfi, unfcod_dec, i_sf);
                            }
                    else
                    {
                    if ((((fix_rate_mem == RATE8_5K) ||
                                (fix_rate_mem == RATE0_8K)) && (i_sf == 0))
                                    GEQ_update_mem_4d_to_3d();
                    else if (SVS_deci_mem == 0)
                                    GEQ_update_mem_2d_to_3d();

                                    GEQ_dec_gc_3_8(channel.idx_Gc_VQ, &(gainQ[1]),
                                            N_bfi,unfcod_dec, i_sf);
                    }
                }
#ifdef PROG_BUG_FIX
                qua_gainQ[1][i_sf] = gainQ[1];
#endif

                qua_gainQ[0][i_sf] = gainQ[0];
                pgain_past_dec = gainQ[0];
                if (pgain_past_dec < PAST_PGAIN_MIN)
                        pgain_past_dec = PAST_PGAIN_MIN;

                if (pgain_past_dec > PAST_PGAIN_MAX)
                        pgain_past_dec = PAST_PGAIN_MAX;
            }
        else
            {
            /*-------------------------------------------*/
            /*          RATE 2.0 kbps and 0.8 kbps       */
            /*-------------------------------------------*/

            gainQ[0] = 0.0;
            pgain_past_dec = 0.0;
            qua_gainQ[0][i_sf]=0.0;
            gainQ[1]=qua_gainQ[1][i_sf];
            }

    /*-------------------------------------------*/
    /*          Build the excitation             */
```

```
/*----------------------------------------------*/


if( exp_flg == 1 )
                wad_dvector(qua_unfcod[0]+i_s, gainQ[0],

                                        qua_unfcod[1]+i_s, 0.7*gainQ[1],
                                ext_dec+MAX_LAG, 0, l_sf-1);


else
                wad_dvector(qua_unfcod[0]+i_s, gainQ[0],

                                        qua_unfcod[1]+i_s, gainQ[1],
                                        ext_dec+MAX_LAG, 0,
l_sf-1);


#ifdef PROG_BUG_FIX


        GEQ_energy_extrapolation (i_s, i_sf, l_sf, gainQ,
                        qua_unfcod, bfi, lag, ext_dec, Prev_Beta_Pitch,
                                ET_buf, ForPitch_dec, channel);
#else


        GEQ_energy_extrapolation (i_s, i_sf, l_sf, gainQ, bfi, lag,
                        ext_dec, Prev_Beta_Pitch, ET_buf, channel);
#endif


        /*----------------------------------------------*/
        /*          Temporary buffer                */
        /*----------------------------------------------*/


        cpy_dvector(ext_dec+MAX_LAG, sigout+i_s, 0, l_sf-1);


        /*----------------------------------------------*/
        /*          Update the adaptive codebook        */
        /*----------------------------------------------*/


        cpy_dvector(ext_dec+l_sf, ext_dec, 0, MAX_LAG-1);


        i_s += l_sf;


        /*==============================================================*/
        }
```

```
if ((channel.fix_rate == RATE4_0K) && (channel.idx_SVS_deci == 1))
        {
        cpy_dvector(gp_buf+4, gp_buf, 0, 4-1);
        gp_buf[4] = qua_gainQ[0][0];
        gp_buf[5] = gp_buf[6] = qua_gainQ[0][1];
        gp_buf[7] = qua_gainQ[0][2];
        }
else
        {
        if ((channel.fix_rate == RATE4_0K) &&
                (channel.idx_SVS_deci!=1))
                {
                cpy_dvector(gp_buf+4,gp_buf, 0, 4-1);

                if ((ET_buf[0] < 40.0) && (qua_gainQ[0][0] > 0.7))
                        gp_buf[4] = gp_buf[5] = 0.4;
                else
                        gp_buf[4] = gp_buf[5] = qua_gainQ[0][0];

                if ((ET_buf[1] < 40.0) && (qua_gainQ[0][1] > 0.7))
                        gp_buf[6] = gp_buf[7] = 0.4;
                else
                        gp_buf[6] = gp_buf[7] = qua_gainQ[0][1];
                }
        else
                {
                if (channel.fix_rate == RATE8_5K)
                        {
                        cpy_dvector(gp_buf+4, gp_buf, 0, 4-1);
                        for (i = 0; i < 4; i++)
                                {
                                if ((ET_buf[i] < 40.0) && (qua_gainQ[0][i] > 0.7)
                                        && (channel.idx_SVS_deci != 1))
                                                gp_buf[i+4] = 0.4;
                                else
                                                gp_buf[i+4] = qua_gainQ[0][i];
                                }
                        }
                }
```

```
                    }


/*─────────────────────────────────────────────*/
/*□□□□□□□□□□□□□□□□□□□□□□□□□□ Second decoding loop □□□□□□□□□□□□□□□□□□□□□□□□□□□*/
/*─────────────────────────────────────────────*/


        i_s = 0;
        for (i_sf = 0; i_sf < n_sf; i_sf++)
                {
                /*─────────────────────────────────────*/
                /*            Set the subframe length            */
                /*─────────────────────────────────────*/

                if (channel.fix_rate!= RATE4_0K)
                        l_sf = L_SF4;
                else
                        {
                        if (channel.idx_SVS_deci == 1)
                                {
                                if (i_sf == N_SF3-1)
                                        l_sf = L_SF3;
                                else
                                        l_sf = L_SF0;
                                }
                        else
                                l_sf = L_SF;
                        }


                cpy_dvector(sigout+i_s, sigsyn_dec+NP, 0, l_sf-1);


                /*─────────────────────────────────────*/
                /*              Synthesis filter            */
                /*─────────────────────────────────────*/

                FLT_allsyn (sigsyn_dec+NP, l_sf, pdcfq_dec[i_sf], NP,
                                        sigsyn_dec+NP, synth_mem_dec);
```

```
/*------------------------------------------------*/
/*                 Post processing              */
/*------------------------------------------------*/


switch (channel.fix_rate)
        {
        case RATE8_5K:
                        if (FlatSp_Flag == 0)
                                {
                                x = 0.65;
                                y = 0.4;
                                }
else
        {
        x = 0.63;
        y = 0.4;
        }
                break;

        case RATE4_0K: x = 0.63;
                                        y = 0.5;
                break;

        case RATE2_0K: x = 0.63;
                                        y = 0.0;
                break;

        case RATE0_8K: x = 0.63;
                                        y = 0.0;
                break;

        default: nrerror ("Invalid fix_rate !!!");
                break;
        }

PPR_post_process (sigsyn_dec, pdcfq_dec[i_sf], x, y,
                        lag_f[i_sf], l_sf, FlatSp_Flag, channel.fix_rate);


/*------------------------------------------------*/
```

```
/*         Update the synthesized speech buffer      */
/*----------------------------------------------------*/

      cpy_dvector(sigsyn_dec+NP, sigout+i_s, 0, l_sf-1);

/*----------------------------------------------------*/

      i_s += l_sf;

/*====================================================*/
    }

dot_dvector(sigout, sigout, &enrg, 0, L_FRM-1);

enrg_buff[0] = enrg_buff[1];
enrg_buff[1] = enrg_buff[2];
enrg_buff[2] = 10.0*log10(enrg/L_FRM+EPSI);

if ((enrg_buff[2] < 45.0) && (bfi == 1) && (channel.fix_rate == RATE8_5K)
      && (channel.idx_SVS_deci == 0))
      {
       ini_dvector(past_energyq_4d, 0, GVQ_VEC_SIZE_4D-1, -30.0);
       bfi_caution = 1;
      }
else if ((enrg_buff[2] < 45.0) && (bfi == 1) &&
      (channel.fix_rate == RATE4_0K) && (channel.idx_SVS_deci == 0))
  {
       ini_dvector(past_energyq_2d, 0, GVQ_VEC_SIZE_2D-1, -30.0);
       bfi_caution = 1;
      }


ppast_bfi = past_bfi;
past_bfi = bfi;

SVS_deci_mem = channel.idx_SVS_deci;
fix_rate_mem = channel.fix_rate;


#ifdef MEM_TEST
```

```
        for (i = 0; i < 2; i++)
                ini_dvector(unfcod_dec[i], 0, L_SF-1, -1.0);


        for (i = 0; i < 2; i++)
                ini_dvector(qua_unfcod[i], 0, L_FRM-1, -1.0);


        for (i = 0; i < N_SF_MAX; i++)
                ini_dvector(pdcfq_dec[i], 0, NP-1, -1.0);


        ini_dvector(ext_dec, MAX_LAG, MAX_LAG+L_SF-1, -1.0);
        ini_dvector(sigsyn_dec, NP, NP+L_SF-1, -1.0);
        ini_dvector(lsfq_new_dec, 0, NP-1, -1.0);


#endif
        /*----------------------------------------------------------*/


        return;


        /*----------------------------------------------------------*/
        }


/*==========================================================================*/
/*------------------------------ END ------------------------------*/
/*==========================================================================*/
```

```
/*===================================================================*/


/*===================================================================*/
/* Conexant System Inc.                          */
/* 4311 Jamboree Road                            */
/* Newport Beach, CA 92660                        */
/*-------------------------------------------------*/
/* Copyright(C) 2000 Conexant System Inc.              */
/*-------------------------------------------------*/
/* ALL RIGHTS RESERVED:                           */
/* No part of this software may be reproduced in any form or by any  */
/* means or used to make any derivative work (such as transformation */
/* or adaptation) without the authorisation of Conexant System Inc.  */
/*===================================================================*/
/* FILE : decoder.h                              */
/*===================================================================*/


/*-------------------------------------------------*/
/*--------------------- FUNCTIONS ------------------------*/
/*-------------------------------------------------*/


void dec_smv_frame (INT16 [], FLOAT64 [], INT16);


/*===================================================================*/
/*------------------------ END -----------------------*/
/*===================================================================*/
```

```
/*=================================================================*/


/*=================================================================*/
/* Conexant System Inc.                              */
/* 4311 Jamboree Road                                */
/* Newport Beach, CA 92660                            */
/*------------------------------------------------*/
/* Copyright(C) 2000 Conexant System Inc.               */
/*------------------------------------------------*/
/* ALL RIGHTS RESERVED:                             */
/* No part of this software may be reproduced in any form or by any  */
/* means or used to make any derivative work (such as transformation */
/* or adaptation) without the authorisation of Conexant System Inc.  */
/*=================================================================*/
/* FILE: encoder.c                               */
/*=================================================================*/


/*------------------------------------------------*/
/*----------------------- INCLUDE -------------------------*/
/*------------------------------------------------*/


#include "typedef.h"
#include "main.h"
#include "const.h"
#include "gputil.h"
#include "mcutil.h"
#include "ext_var.h"


#include "lib_qlsf.h"
#include "lib_geq.h"
#include "lib_vad.h"
#include "lib_lpc.h"
#include "lib_cla.h"
#include "lib_snr.h"
#include "lib_pwf.h"
#include "lib_bit.h"
#include "lib_pit.h"
#include "lib_smo.h"
#include "lib_prc.h"
#include "lib_flt.h"
```

```
#include "lib_fcs.h"
#include "lib_ltp.h"
#include "lib_ppr.h"
#include "lib_ppp.h"
#include "lib_gcb.h"


#ifdef DIAG_SMV

#include "lib_dia.h"

#endif


/*-------------------------------------------------------------*/
/*------------------------ FUNCTIONS ------------------------*/
/*-------------------------------------------------------------*/


/*===========================================================================*/
/* FUNCTION  : enc_smv_frame ().                          */
/*-------------------------------------------------------------*/
/* PURPOSE   : Performs processing on one frame.            */
/*-------------------------------------------------------------*/
/* ALGORITHM :                              */
/*-------------------------------------------------------------*/
/* INPUT ARGUMENTS  :                         */
/*       _ (FLOAT64 []) sigpp     : input frame.            */
/*       _ (INT16    ) smv_mode  : selected SMV mode.        */
/*       _ (INT16    ) switch_flag: switching mode flag.      */
/*       _ (char     ) signaling  : signal information.      */
/*-------------------------------------------------------------*/
/* OUTPUT ARGUMENTS :                         */
/*       _ (INT16   []) PackedWords : output frame bitstream.  */
/*       _ (FLOAT64 []) enc_sigout  : output processed frame.  */
/*       _ (INT16    *) FlatSpFlag  : flat input speech flag.  */
/*       _ (FLOAT64  *) avg_rate    : average bit rate.       */
/*       _ (INT16    *) VoicingClass: Frame classification.    */
/*-------------------------------------------------------------*/
/* INPUT/OUTPUT ARGUMENTS :                      */
/*       _ None.                           */
/*-------------------------------------------------------------*/
```

```
/* RETURN ARGUMENTS :                              */
/*          _ None.                        */
/*===========================================================*/


void enc_smv_frame (FLOAT64 sigpp [], INT16 PackedWords [], FLOAT64 enc_sigout [],
                      INT16 smv_mode, INT16 switch_flag, INT16 *FlatSpFlag,
                          char signaling, FLOAT64 *avg_rate, INT16 *VoicingClass)
        {
        /*---------------------------------------------------*/
        /*             Misc. parameters            */
        /*---------------------------------------------------*/


        FLOAT64 *px, *buf;
        FLOAT64 g1, g2, val1, val2;


        INT16   i_sf, i, j, k, l, i_s, l_sf, n_sf;
        FLOAT64 x;


#ifdef DIAG_SMV


        FLOAT64 y;
#endif


        /*---------------------------------------------------*/
        /*          Variables for Voice Activity Detection       */
        /*---------------------------------------------------*/


        INT16   avg_lag;


        /*---------------------------------------------------*/
        /*             Variables for classification          */
        /*---------------------------------------------------*/


        INT16   NoisyV_flag, OnSetFlag;
        FLOAT64 FrmResEng, ResEng[N_SF2];
        FLOAT64 lpcgain_q;


        /*---------------------------------------------------*/
        /*             Variables for LPC smoothing          */
        /*---------------------------------------------------*/
```

```
FLOAT64 beta_frm, beta_sub;
FLOAT64 refl0[N_SF_MAX];


/*-------------------------------------------------------------*/
/*            Parameters for LPC smoothing              */
/*-------------------------------------------------------------*/


FLOAT64 LP_CF[N_SF_MAX+1];
FLOAT64 lsf_int [NP];


/*-------------------------------------------------------------*/
/*            Variables for Smoothing                  */
/*-------------------------------------------------------------*/


INT16   exc_mode, speech_mode;
FLOAT64 pitch_corr[2];


/*-------------------------------------------------------------*/
/*      Parameters for LPC analysis and quantization       */
/*-------------------------------------------------------------*/


FLOAT64 lsf_new2[NP], lsf_new3[NP], lsfq_new[NP];


/*-------------------------------------------------------------*/
/*            Variables for Pitch Interpolation         */
/*-------------------------------------------------------------*/


FLOAT64 ForPitch[L_FRM+L_FRM/2];


/*-------------------------------------------------------------*/
/*            Parameters for pitch pre-processing        */
/*-------------------------------------------------------------*/


FLOAT64 gp_pp[N_SF_MAX];


/*-------------------------------------------------------------*/
/*            Parameters for pitch open loop             */
/*-------------------------------------------------------------*/
```

```
INT16 pre_lag;


/*------------------------------------------------*/
/*              Parameters for LTP             */
/*------------------------------------------------*/


FLOAT64 Rp;


/*------------------------------------------------*/
/*        Parameters for Closed Loop processing   */
/*------------------------------------------------*/


FLOAT64 gainQ [N_SF_MAX];
FLOAT64 hh[L_SF], hh_w[L_SF], hh_m[L_FRM];
FLOAT64 Tg[L_SF], Tgs[L_SF], Tgs_m[L_SF];


FLOAT64 res2[L_SF];
FLOAT64 nsr = 0.0;


FLOAT64 Rp_Wn, ac_sharp, frm_sharp;


FLOAT64 qua_Tg [L_FRM];


/*------------------------------------------------*/
/*           Variables for Signal Sinthesis    */
/*------------------------------------------------*/


FLOAT64 sigsyn[L_SF+NP];
FLOAT64 qua_sigsyn[L_SF+NP];



/*------------------------------------------------*/
/*        Parameters for bitstream processing     */
/*------------------------------------------------*/


INT64 seed_enc;
INT16 parm[3];
INT16 shft_count;


INT16   PackWdsPtr[2];
```

```
        PARAMETER channel;


/*======================================================================*/
/* ◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻ */
/* ◻◻◻◻◻◻◻◻◻◻◻◻◻◻◻◻◻◻◻◻◻◻◻◻◻            ◻◻◻◻◻◻◻◻◻◻◻◻◻◻◻◻◻◻◻◻◻◻◻◻◻◻◻◻◻ */
/* ◻◻◻◻◻◻◻◻◻◻◻◻◻◻◻◻◻◻◻◻◻◻◻◻    ENCODER    ◻◻◻◻◻◻◻◻◻◻◻◻◻◻◻◻◻◻◻◻◻◻◻◻◻ */
/* ◻◻◻◻◻◻◻◻◻◻◻◻◻◻◻◻◻◻◻◻◻◻◻◻◻            ◻◻◻◻◻◻◻◻◻◻◻◻◻◻◻◻◻◻◻◻◻◻◻◻◻◻◻ */
/* ◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻◻ */
/*======================================================================*/




/*======================================================================*/
/* ◻◻◻◻◻◻◻◻◻◻◻◻◻◻◻◻◻◻◻◻◻◻◻◻◻◻◻◻◻◻ LPC ANALYSIS ◻◻◻◻◻◻◻◻◻◻◻◻◻◻◻◻◻◻◻◻◻◻◻◻◻◻◻◻◻ */
/*======================================================================*/


        /*--------------------------------------------------*/
        /*             Second subframe LPC                 */
        /*--------------------------------------------------*/



        LPC_analysis(L_LPC, sigpp, lpc_window, rxx, bwe_factor,
                     refl[1], &pderr, pdcf[1], lsf_new2, NP, &x,
                     (*FlatSpFlag));


        /*--------------------------------------------------*/
        /*             First subframe LPC                  */
        /*--------------------------------------------------*/


        for (i = 0; i < NP; i++)
                refl[0][i] = 0.5*(refl[1][i] + refl[N_SF4-1][i]);


        for (i = 0; i < NP; i++)
                lsf_int [i] = 0.5*(lsf_new[i] + lsf_new2[i]);


        LPC_lsftop(lsf_int, pdcf[0], NP);


        /*--------------------------------------------------*/
        /*    Fourth subframe LPC analysis, used for LSF quantization   */
        /*--------------------------------------------------*/
```

```
LPC_analysis(L_LPC, sigpp+L_PP-L_LPC, lpc_window1, rxx, bwe_factor,
                        refl[N_SF4-1], &pderr, pdcf[N_SF4-1], lsf_new, NP,
                        &lpcgain, (*FlatSpFlag));

/*---------------------------------------------------------------*/
/*        VAD based on the fourth subframe LPC LPC       */
/*---------------------------------------------------------------*/

flag_vad_mem [1] = flag_vad_mem [0];
flag_vad_mem [0] = Vad;

px = sigpp + L_PP-L_FRM-L_LPCLHD;

VAD_voice_detection (px, refl[N_SF4-1], pderr, lag_buf, pgain_buf,
                        lsf_new, rxx, frm_count, &Vad, flag_vad_mem);

/*---------------------------------------------------------------*/
/*                Third subframe LPC                    */
/*---------------------------------------------------------------*/

for (i = 0; i < NP; i++)
        refl[2][i] = 0.5*(refl[1][i] + refl[N_SF4-1][i]);

for (i = 0; i < NP; i++)
        lsf_int [i] = 0.5*(lsf_new[i]+lsf_new2[i]);

LPC_lsftop(lsf_int, pdcf[2], NP);

/*---------------------------------------------------------------*/
/*                LPC analysis for Look-Ahead           */
/*---------------------------------------------------------------*/

energy_m = energy;

LPC_analysis (L_LPC, sigpp+L_PP-L_LPC, lpc_window2, rxx, bwe_factor,
                        refl[N_SF4], &pderr, pdcf[N_SF4], lsf_new3, NP, &x,
                        (*FlatSpFlag));

energy = rxx[0];
```

```
/*======================================================================*/
/* ◻◻◻◻◻◻◻◻◻◻◻◻◻◻◻◻◻ WEIGHTING SPEECH AND CLASSIFICATION ◻◻◻◻◻◻◻◻◻◻◻◻◻◻◻◻◻ */
/*======================================================================*/



#ifndef MEM_TEST


        /*------------------------------------------------*/
        /*        Update the weighted speech buffer       */
        /*------------------------------------------------*/


        cpy_dvector(wspeech+L_FRM, wspeech, 0, L_OLPIT-L_FRM-L_LPCLHD-1);
#endif


        /*------------------------------------------------*/
    .   /*           Generate the residual                */
        /*------------------------------------------------*/


        PWF_speech_to_residu (sigpp, wspeech, pdcf, wpdcf_zero, GAMMA1);


        /*------------------------------------------------*/
        /*   Temporal noise-like unvoied speech detector  */
        /*------------------------------------------------*/


        VUV = 3;
        l = L_FRM + L_LPCLHD;


        CLA_NoisUnvoiceDetect (wspeech+ L_OLPIT-l, sigpp+L_PP-l, &VUV, ResEng,
                                                    &frm_sharp, L_FRM);
        FrmResEng = ResEng[0] + ResEng[1];


        /*------------------------------------------------*/
        /*           Generate the weighted speech         */
        /*------------------------------------------------*/


        PWF_residu_to_wspeech((*FlatSpFlag), wspeech, wspeech, refl, pdcf,
                                    wpdcf_pole, LP_CF, wspeech_mem, &Z1_ws_1);


/*======================================================================*/
```

/* ¤¤¤¤¤¤¤¤¤¤¤¤¤¤¤¤¤¤¤¤ OPEN-LOOP INTER PITCH LAG SEARCH ¤¤¤¤¤¤¤¤¤¤¤¤¤¤¤¤¤¤¤¤¤¤ */

/*==============================================================================*/

```c
        pre_lag = ol_lag[1];
        PIT_ol_2pitchs(wspeech, L_OLPIT, ol_lag, Rp_sub, frame_class, HI_LAG2);


        for (i = 0; i < 3; i++)
                lag_buf[i] = lag_buf[i+2];


#ifndef COMPLEXITY_REDUC

        avg_lag = AVG(lag_buf[0], lag_buf[1], lag_buf[2]);


        if( abs((short) (ol_lag[0]/2.0) - avg_lag)<=2)
        lag_buf[3] = (INT16) (ol_lag[0]/2.0);
            else
                {
                if (abs((INT16) (ol_lag[0]/3.0) - avg_lag) <= 2)
                        lag_buf[3] = (INT16) (ol_lag[0]/3.0);
                else
                        lag_buf[3] = ol_lag[0];
                }


        if (abs((INT16) (ol_lag[1]/2.0) - avg_lag)<=2)
                lag_buf[4] = (short) (ol_lag[1]/2.0);
        else
                {
                if( abs((INT16) (ol_lag[1]/3.0) - avg_lag) <= 2)
                        lag_buf[4] = (short) (ol_lag[1]/3.0);
                else
                        lag_buf[4] = ol_lag[1];
                }
#else
        lag_buf[3] = ol_lag[0];
        lag_buf[4] = ol_lag[1];
#endif
```

/*==============================================================================*/

/* ¤¤¤¤¤¤¤¤¤¤¤¤¤¤¤¤¤¤¤¤¤¤¤¤¤¤¤¤ CLASSIFICATON ¤¤¤¤¤¤¤¤¤¤¤¤¤¤¤¤¤¤¤¤¤¤¤¤¤¤¤¤¤¤ */

```
/*===========================================================================*/

        frame_class_m = frame_class;
        frame_class = CLA_signal_classifier(sigpp + L_PP-L_FRM - L_LPCLHD,
                                    Rp_sub[1], (double)(ol_lag[1]), Vad);


        /*----------------------------------------------*/
        /*              Background Noise Level           */
        /*----------------------------------------------*/


        SNR_Calc_NSR_enc (sigpp+L_PP-L_FRM, lsf_new3, Vad, frame_class,
                            &nsr, L_FRM);


        /*----------------------------------------------*/
        /*              Class correction                 */
        /*----------------------------------------------*/


        CLA_Class_Correct(&frame_class, &frame_class_pp, &Vad, &VUV,
                            &OnSetFlag, frame_class_m, Rp_sub, nsr, refl,
                            frm_sharp, smv_mode, energy_m, energy,
                                FrmResEng, lpcgain, &NoisyV_flag);




/*===========================================================================*/
/* ¤¤¤¤¤¤¤¤¤¤¤¤¤¤¤¤¤¤¤¤¤¤¤¤¤¤¤ CODEC BIT-RATE SELECTION ¤¤¤¤¤¤¤¤¤¤¤¤¤¤¤¤¤¤¤¤¤ */
/*===========================================================================*/


        /*----------------------------------------------*/
        /*              Fixed rate selection             */
        /*----------------------------------------------*/


        fix_rate_mem = fix_rate;


        if (smv_mode <= 1)
                fix_rate = RATE8_5K;
        else
                fix_rate = RATE4_0K;


        if (switch_flag)
                {
```

```
        CLA_Rate_Select (smv_mode, frame_class, frame_class_m,
                                   OnSetFlag, Rp_sub, nsr, frm_sharp,
                                   refl[2][0], FrmResEng, &fix_rate);


        if ((signaling == (char)1) && (fix_rate == RATE8_5K))
                     fix_rate = RATE4_0K;
        }


/*==========================================================================*/
/* ooooooooooooooooooooooooooo FINE PITCH AND INTERPOLATION ooooooooooooooooooooooooooo */
/*==========================================================================*/



    if ((fix_rate == RATE4_0K) && (ol_lag[1] > HI_LAG) && (frame_class_pp>0))
            frame_class_pp = 0;


        /*----------------------------------------------------*/
        /*              Forward fine pitch                */
        /*----------------------------------------------------*/


    if (frame_class_pp > 0)
            {
            low_pit  = MAX(min_pit, ol_lag[1] - 5);
            if (fix_rate == RATE8_5K)
                    high_pit = MIN(HI_LAG2, ol_lag[1] + 5);
            else
                    high_pit = MIN(HI_LAG, ol_lag[1] + 5);


            pre_pitch_index = pitch_index;


            pitch_f_mem [1] = pitch_f_mem [0];
            pitch_f_mem [0] = pitchf;


            l = L_OLPIT-L_LPCLHD;


            lagl = PIT_FinePitch (fix_rate, low_pit, high_pit, wspeech,
                                   l, Delay_pp, &Rp, &pitchf, &pitch_index);


            channel.idx_pitch[0] = pitch_index;
```

```
/*-------------------------------------------------*/
/*  Pitch interpolation and modify pitch index to avoid too  */
/*                 large delay                    */
/*-------------------------------------------------*/


if ((fix_rate_mem == RATE2_0K) || (fix_rate_mem == RATE0_8K))
            {
        pitch_f_mem [1] = pitchf;
        pitch_f_mem [0] = pitchf;


            }
    else if (frame_class_m < 6)
            {
        if (fix_rate_mem != RATE8_5K)
                {
            pitch_f_mem [1] = lag_f[N_SF2-1];
            pitch_f_mem [0] = lag_f[N_SF2-1];


                }
        else
                {
            pitch_f_mem [1] = lag_f[N_SF4-1];
            .pitch_f_mem [0] = lag_f[N_SF4-1];
                }
            }


        PIT_PitchInterpolat (pitchf, pitch_f_mem,  ForPitch, 1);
            }


/*===================================================*/
/* □□□□□□□□□□□□□□□□□□□□□□□□□ LT PROCESSING □□□□□□□□□□□□□□□□□□□□□□□□□ */
/*===================================================*/


    cpy_dvector (NewTg+L_FRM, NewTg, 0, NP-1);


    PPP_pitch_preproc (smv_mode, fix_rate, (*FlatSpFlag), nsr, wspeech,
                        NewTg+NP, ForPitch, &Delay_pp, frame_class_pp,
                            &frame_class, &VUV, gp_pp);


        /*-------------------------------------------------*/
```

```
/*              frame_class correction              */
/*---------------------------------------------------------*/


if ((VUV == 2) && (frame_class > 1) && (OnSetFlag != 1))
        frame_class=1;


if ((frame_class == 6) && ((fix_rate_mem == RATE2_0K) ||
        (fix_rate_mem == RATE0_8K) || (fix_rate == RATE2_0K) ||
            (fix_rate == RATE0_8K)))
                    frame_class = 5;


if ((frame_class == 6) && (frame_class_m < 3) && (switch_flag != 0))
        frame_class = 5;


/*---------------------------------------------------------*/
/*      Rate modification because of the complexity       */
/*---------------------------------------------------------*/


if (switch_flag)
        {
        if ((smv_mode >= 1)  && (fix_rate == RATE8_5K) &&
                        (frame_class == 1))
                            fix_rate = RATE4_0K;
        if ((frame_class_pp > 0) && (frame_class < 6) &&
                (fix_rate == RATE4_0K) &&
                    ((ol_lag[0] < 30) || (ol_lag[1] < 30)))
                        fix_rate = RATE8_5K;



#ifdef PROG_BUG_FIX

        if ((signaling == (char)1) && fix_rate == RATE8_5K)
                {
                fix_rate = RATE4_0K;
                if (frame_class == 6)
                        frame_class = 5;

                if (frame_class_pp > 0)
                        {
                        if (ol_lag[0] < 30)
```

```
                                ol_lag[0] *=2;

                            if (ol_lag[1] < 30)
                                    ol_lag[1] *=2;
                        }
                    }
#else

            if ((signaling == (char)1) && (fix_rate == RATE8_5K))
                {
                fix_rate = RATE4_0K;
                if (frame_class == 6)
                        frame_class = 5;

                if ((frame_class_pp > 0) &&
                        ((ol_lag[0] < 30) || (ol_lag[1] < 30)))
                                ol_lag[0] *= 2;
                }
#endif

            PRC_average_rate (fix_rate, avg_rate);
            }

    channel.fix_rate = fix_rate;

    /*---------------------------------------------------------*/
    /*              Reset open-loop pitch                  */
    /*---------------------------------------------------------*/

    if (fix_rate == RATE8_5K)
            {
            for (i = 0; i < 2; i++)
                    lag[i] = ol_lag[0];

            for (i = 2; i < N_SF4; i++)
                    lag[i] = ol_lag[1];
            }
    else
            {
            lag[0] = ol_lag[0];
```

```
            lag[1] = ol_lag[1];
        }


if (frame_class_pp > 0)
        {
        if (fix_rate == RATE8_5K)
                lag[N_SF4-1] = lagl;
        else if (lagl >= 30)
                lag[N_SF2-1] = lagl;
        }


/*--------------------------------------------------------------*/
/*        Quantize 3 stable LTP gains with 4bits        */
/*--------------------------------------------------------------*/


if ((frame_class == 6) && (fix_rate != RATE2_0K) &&
        (fix_rate != RATE0_8K))
        {
        channel.idx_SVS_deci = 1;
        if (NoisyV_flag == 1)
                for (i = 0; i < N_SF4; i++)
                        gp_pp[i] *= 0.95;
        else if (NoisyV_flag == 2)
                for (i = 0; i < N_SF4; i++)
                        gp_pp[i] *= 0.92;
        if ((*FlatSpFlag) == 0)
                {
                if (smv_mode == 0)
                        {
                        for (i = 0; i < N_SF4; i++)
                                gp_pp[i] *= 0.95;
                        }
                else
                        {
                        for (i = 0; i < N_SF4; i++)
                                gp_pp[i] *= 0.97;
                        }
                }


        if (fix_rate != RATE8_5K)
```

```
            {
            /*---------------------------------------------*/
            /*        4 bits to  quantize 3 gp          */
            /*---------------------------------------------*/

            GEQ_Quant_PitchGain_3D(gp_pp, &(channel.idx_Gp_VQ));
            }
     else
            {
            /*---------------------------------------------*/
            /*        6 bits to  quantize 4 gp          */
            /*---------------------------------------------*/

            GEQ_Quant_PitchGain_4D(gp_pp, &(channel.idx_Gp_VQ));
            }

         }
  else
         channel.idx_SVS_deci = 0;


     /*---------------------------------------------*/
     /*        Back to speech domain          */
     /*---------------------------------------------*/


  PWF_wspeech_to_speech(NewTg+NP, wpdcf_zero, wpdcf_pole, LP_CF, &Z1_ws_2);


/*==========================================================================*/
/* ◻◻◻◻◻◻◻◻◻◻◻◻◻◻◻◻◻ LPC QUANTIZATION AND INTERPOLATION ◻◻◻◻◻◻◻◻◻◻◻◻◻◻◻◻◻ */
/*==========================================================================*/


     /*---------------------------------------------*/
     /*   Estimate frame based and initial subframe based smoothing   */
     /*---------------------------------------------*/


  SMO_lsf_smooth_est (Vad, flag_vad_mem [0], refl[1][0], lsf_new,
                                              &beta_frm);


     /*---------------------------------------------*/
     /*     Smooth LSF, smoothing not active for coder_mode >= 3   */
     /*---------------------------------------------*/
```

```
for (i = 0; i < NP; i++)
        lsf_smooth[i] = beta_frm*lsf_smooth[i] +
                                        (1.0-beta_frm)*lsf_new[i];


/*--------------------------------------------------------------*/
/*                 LSF quantization                     */
/*--------------------------------------------------------------*/


LSF_Q_lsfqnt(lsf_smooth, lsfq_new, channel.idx_lsf, fix_rate);


/*--------------------------------------------------------------*/
/* Interpolation of LSF and weighting filter coefficients extraction */
/*--------------------------------------------------------------*/


if ((*FlatSpFlag) == 0)
        {
        if (NoisyV_flag > 0)
                x = 0.55;
        else
                x = 0.6;
        }
else
        x = 0.5;


r_pole_ws = 0.25*r_pole_ws + 0.75*x;


/*--------------------------------------------------------------*/


if ((fix_rate == RATE8_5K) || (fix_rate == RATE2_0K) ||
        (fix_rate == RATE0_8K))
        {


        /*--------------------------------------------------------------*/
        /* Interpolate the QUANTIZED lsf and get the LPC coefficients */
        /*--------------------------------------------------------------*/


        if ((fix_rate == RATE2_0K) ||
                ((fix_rate == RATE8_5K) && (frame_class != 6)))
                        LPC_adptive_interp(lsfq_new, lsf_new2, lsfq_old, pdcfq,
```

```
                                                                &(channel.idx_lpc_int));
        else
                LPC_adptive_interp_dec(lsfq_new, lsfq_old, pdcfq, 0);


        /*--------------------------------------------------*/


        for (i = 0; i < N_SF4; i++)
                refl0[i] = refl[i][0];



        /*--------------------------------------------------*/
        /*   Perceptual weighting filter coefficients calculation   */
        /*--------------------------------------------------*/


        for (i = 0; i < N_SF4; i++)
                {
                vall = 1.0;


                for (j = 0; j < NP; j++)
                        {
                vall *= r_pole_ws;
                        wpdcf_pole[i][j] = pdcf[i][j]*vall;
                        }
                }
        }
else
        {
        if (frame_class==6)
        {
                /*--------------------------------------------------*/
                /*   Interpolate the QUANTIZED lsf and get the LPC   */
                /*            coefficients            */
                /*--------------------------------------------------*/


                LPC_interpolate_lpc_4to3 (lsfq_new, (FLOAT64 *)NULL,
                                                                lsfq_old, pdcfq,


                /*--------------------------------------------------*/
                /*   Interpolate the UNQUANTIZED lsf and get the LPC   */
```

```
/*                coefficients            */
/*-------------------------------------------------*/


LPC_interpolate_lpc_4to3 (lsf_new, lsf_new2, lsf_old,

                                            pdcf, 0);


/*-------------------------------------------------*/


x = 6.5 / 40;
refl0[0] = (1-x)*refl[0][0] + x*refl[1][0];
refl0[1] = 0.5*(refl[1][0]  + refl[2][0]);
refl0[2] = (1-x)*refl[3][0] + x*refl[2][0];


/*-------------------------------------------------*/
/* Perceptual weighting filter coefficients calculation  */
/*-------------------------------------------------*/


for (i = 0; i < N_SF3; i++)
        {
        val1 = 1.0;
        val2 = 1.0;

        for (j = 0; j < NP; j++)
                {
                val1 *= GAMMA1;
                val2 *= r_pole_ws;
                wpdcf_zero[i][j] = pdcf[i][j]*val1;
                wpdcf_pole[i][j] = pdcf[i][j]*val2;
                }
        }
    }
else
    {


/*-------------------------------------------------*/
/*    Interpolate the QUANTIZED lsf and get the LPC    */
/*                coefficients            */
/*-------------------------------------------------*/


LPC_interpolate_lpc_4to2 (lsfq_new, (FLOAT64 *)NULL,
```

lsfq_old, pdcfq, 1);

```
/*---------------------------------------------*/
/*    Interpolate the UNQUANTIZED lsf and get the LPC   */
/*                coefficients              */
/*---------------------------------------------*/


LPC_interpolate_lpc_4to2 (lsf_new, lsf_new2, lsf_old,

                                pdcf, 0);


/*---------------------------------------------*/


refl0[0] = 0.5*(refl[0][0] + refl[1][0]);
refl0[1] = 0.5*(refl[2][0] + refl[3][0]);


/*---------------------------------------------*/
/* Perceptual weighting filter coefficients calculation  */
/*---------------------------------------------*/


for (i = 0; i < N_SF2; i++)
        {
        val1 = 1.0;
        val2 = 1.0;


        for (j = 0; j < NP; j++)
                {
                val1 *= GAMMA1;
                val2 *= r_pole_ws;
                wpdcf_zero[i][j] = pdcf[i][j]*val1;
                wpdcf_pole[i][j] = pdcf[i][j]*val2;
                }
        }
    }


/*---------------------------------------------*/
/*          Flat input speech identifier          */
/*---------------------------------------------*/


CLA_Identify_Input (channel.idx_SVS_deci, pdcfq[0], lsfq_new[0],
```

```
                                pgain_past, &lpcgain_q, fix_rate, FlatSpFlag);


        if (fix_rate == RATE2_0K )
                {
                parm[0] = channel.idx_lsf[0];
                parm[1] = channel.idx_lsf[1];
                parm[2] = channel.idx_lpc_int;
                seed_enc = 0x00000000;
                shft_count = 15;
                for (j = 0; j < 3; j++)
                        {
                        shft_count -= bitno0[j];
                        seed_enc = seed_enc ^(((long) parm[j] ) << shft_count);
                        }


                }
        else if (fix_rate == RATE0_8K )
                {
                parm[0] = channel.idx_lsf[0];
                parm[1] = channel.idx_lsf[1];
                parm[2] = channel.idx_lsf[2];
                seed_enc = 0x00000000;
                shft_count = 11;
                for (j = 0; j < 3; j++)
                        {
                        shft_count -= bitno1[j];
                        seed_enc = seed_enc ^(((long) parm[j] ) << shft_count);
                        }
                }


        /*-------------------------------------------------------------*/
        /*          Gaussian excitation for very low bit rates        */
        /*-------------------------------------------------------------*/


        if (nsr > 0.125)
                x = 1.0 - 0.6*nsr;
        else
                x = 1.0;


        if ((fix_rate == RATE0_8K) && (nsr > 0.125))
```

```
        x = 0.4;
if (frame_class == 6)
        x = 1.0;


NoiseGainFactor = 0.5*NoiseGainFactor + 0.5*x;


if ((fix_rate == RATE2_0K) || (fix_rate == RATE0_8K))
        {
        GCB_gauss_excit (&seed_enc, fix_rate, fix_rate_mem, nsr, ResEng,
                                        qua_unfcod[1], qua_gainQ[1]);
        qua_gainQ[1][0] *= NoiseGainFactor;


        if (fix_rate == RATE2_0K)
                {
                /*-----------------------------------------------*/
                /*   Quantize 'qua_gainQ[1][0]' and 'qua_gainQ[1][2]'   */
                /*                 with 6 + 6 bits                 */
                /*-----------------------------------------------*/


                if ((fix_rate_mem == RATE8_5K) || (fix_rate_mem == RATE0_8K))
                        GEQ_update_mem_4d_to_2d();
                else if ((fix_rate_mem == RATE4_0K) && (frame_class_m == 6))
                        GEQ_update_mem_3d_to_2d();


                qua_gainQ[1][2] *= NoiseGainFactor;


                GEQ_gainNSQMA_1_6 (0, qua_unfcod[1], qua_gainQ,
                                                &(channel.idx_gainVQ[0]));
                GEQ_gainNSQMA_1_6 (2, qua_unfcod[1], qua_gainQ,
                                                &(channel.idx_gainVQ[1]));


                qua_gainQ[1][1] = qua_gainQ[1][0];
                qua_gainQ[1][3] = qua_gainQ[1][2];
                }
        else
                {
                /*-----------------------------------------------*/
                /*        Quantize 'qua_gainQ[1][0]' 5 bits        */
                /*-----------------------------------------------*/
```

```
if ((fix_rate_mem == RATE4_0K) || (fix_rate_mem == RATE2_0K))
        {
        if (frame_class_m != 6)
                GEQ_update_mem_2d_to_4d();
        else
                GEQ_update_mem_3d_to_4d();
        }


    GEQ_gainNSQMA_1_5(qua_unfcod[1], qua_gainQ,
                                    &(channel.idx_gainVQ[0]));


    for (i = 1; i < N_SF4; i++)
            qua_gainQ[1][i] = qua_gainQ[1][0];
    }
        }


    (*VoicingClass) = frame_class;



#ifdef MEM_TEST


    /*----------------------------------------------------*/
    /*          Update the weighted speech buffer         */
    /*----------------------------------------------------*/


    cpy_dvector (wspeech+L_FRM, wspeech, 0, L_OLPIT-L_FRM-L_LPCLHD-1);


#endif



    /*==================================================================*/
    /* xxxxxxxxxxxxxxxxxxxxxxxxxxxxxxxxxxxxxxxxxxxxxxxxxxxxxxxxxxxxxxxx*/
    /* xxxxxxxxxxxxxxxxxxxxxxxxxxxx SUB-FRAME PROCESSING xxxxxxxxxxxxxxxxxxxxxxxxxxx */
    /* xxxxxxxxxxxxxxxxxxxxxxxxxxxxxxxxxxxxxxxxxxxxxxxxxxxxxxxxxxxxxxxx*/
    /*==================================================================*/


    /*----------------------------------------------------*/
    /*------------------VARIABLE DESCRIPTION --------------------*/
    /*----------------------------------------------------*/
    /*                                                    */
```

```
/*      pdcfq     - quantized prediction coefficients              */
/*      wpdcf_pole - poles of the perceptual weighting filter        */
/*      wpdcf_zero - zeros of the perceptual weighting filter        */
/*                                                    */
/*      Tgs       - target signal                     */
/*      Tg        - target signal for codebook search         */
/*                 (no pitch contribution)           */
/*      hh        - impulse response of the combined synthesis and   */
/*                 perceptual weighting filter        */
/*      unfcod[0] - adaptive codebook (ACB) vector           */
/*      unfcod[1] - algebraic codebook (CDBK) vector          */
/*      fcod[0]   - filtered ACB vector              */
/*      fcod[1]   - filtered CDBK vector             */
/*      gainQ[0]  - ACB gain                    */
/*      gainQ[1]  - CDBK gain                   */
/*      gainQ[2]  - CDBK gain                   */
/*                                           */
/*      ext       - adaptive codebook               */
/*      lag[i_sf] - integral lag of the current subframe        */
/*      lagf[i_sf] - fractional lag of the current subframe      */
/*-----------------------------------------------------------------*/



/*-----------------------------------------------------------------*/
/*□□□□□□□□□□□□□□□□□□□ First Loop With Unquantized Fixed CB Gains □□□□□□□□□□□□□□□□□□□*/
/*-----------------------------------------------------------------*/



        if (fix_rate != RATE4_0K)
                n_sf = N_SF4;
        else
                {
                if (frame_class == 6)
                        n_sf = N_SF3;
                else
                        n_sf = N_SF2;
                }
        i_s = 0;


        for (i_sf = 0; i_sf < n_sf; i_sf++)
```

```
{
/*---------------------------------------------*/
/*          Set-up of the sub-frame parameters        */
/*---------------------------------------------*/


if (fix_rate != RATE4_0K)
        l_sf = L_SF4;
else
        {
        if (frame_class == 6)
                {
                if (i_sf == N_SF3-1)
                        l_sf = L_SF3;
                    else
                        l_sf = L_SF0;
                }
            else
                l_sf = L_SF;
        }


/*---------------------------------------------*/
/* The impulse response with the all pole synthesis filter   */
/*         and  the percerptual weighting filter         */
/*---------------------------------------------*/


LPC_ImpulseResponse (hh, wpdcf_zero [i_sf], wpdcf_pole[i_sf],
                                            pdcfq [i_sf], l_sf);


cpy_dvector(hh, hh_m+i_s, 0, l_sf-1);


/*---------------------------------------------*/
/*              Target signal                */
/*---------------------------------------------*/


PRC_TargetSignal (wpdcf_zero[i_sf], wpdcf_pole[i_sf],
                                    pdcfq[i_sf], NewTg+i_s, ext+MAX_LAG, Tgs,
                                        dif_mem, target_mem, l_sf);


if (i_sf == 0)
        cpy_dvector (Tgs, Tgs_m, 0, l_sf-1);
```

```
/*---------------------------------------------*/
/*              Ideal excitation               */
/*---------------------------------------------*/


PRC_Ideal_Excit (Tgs, pdcfq[i_sf], wpdcf_pole[i_sf],
                                wpdcf_zero[i_sf], res2, I_sf);


/*---------------------------------------------*/
/*              LTP Contribution               */
/*---------------------------------------------*/


if ((fix_rate == RATE8_5K) || (fix_rate == RATE4_0K))
        {
        if (frame_class == 6)
                {
                /*---------------------------------------------*/
                /*         Pitch lag interpolation             */
                /*---------------------------------------------*/


                LTP_PP_pitch_ext (ForPitch+i_s, Tgs, ext, hh, i_sf,
                                        unfcod[0], fcod[0], lag, lag_f,
                                        &Rp_Wn, I_sf);


                /*---------------------------------------------*/
                /*              Pitch gain                     */
                /*---------------------------------------------*/


                gainQ[0] = gp_pp[i_sf];
                if (NoisyV_flag < 2)
                        gainQ[0] *= 0.25*Rp_Wn + 0.75;
                }
        else
                {
                /*---------------------------------------------*/
                /*              Close-loop search              */
                /*---------------------------------------------*/


                if (fix_rate == RATE8_5K)
```

```
                    LTP_close_8_5k_pitch (Tgs, ext, hh, i_sf, unfcod[0],
                       fcod[0], lag, lag_f, &(gainQ[0]), &Rp_Wn, l_sf,
                          frame_class_pp, channel.idx_pitch);
                else
                    LTP_close_7b_pitch (Tgs, ext, hh, i_sf, unfcod[0],
                                        fcod[0], lag, lag_f, &(gainQ[0]),
                                           &Rp_Wn, l_sf, frame_class_pp,
                                              channel.idx_pitch);


                /*-----------------------------------------------*/
                /*  Modify the gainQ[0] to de-emphasize the pitch   */
                /*        contribution in the cdbk search          */
                /*-----------------------------------------------*/


                gp_pp[i_sf] = gainQ[0];


                ac_sharp = PPP_sharpness(l_sf, unfcod[0]);


                if ((frame_class > 1) && (ac_sharp < 0.25))
                        {
                        x = MAX(MIN(5*ac_sharp-0.25, 1.0), 0.0);
                        gainQ[0] *= (1 - x)*Rp_Wn + x;
                        }
                    }
            /*-----------------------------------------------*/
            /*       Save the results for the second loop       */
            /*-----------------------------------------------*/


            cpy_dvector (unfcod[0], qua_unfcod[0]+i_s, 0, l_sf-1);
            cpy_dvector (fcod[0], qua_fcod[0]+i_s, 0, l_sf-1);
            }
        else
            {
            gainQ[0] = 0.0;
            gp_pp[i_sf] = 0.0;
            Rp_Wn = 0.0;
            lag_f [i_sf] = lag [i_sf];
            ini_dvector(unfcod[0], 0, l_sf-1, 0.0);
            ini_dvector(qua_unfcod[0]+i_s, 0, l_sf-1, 0.0);
            ini_dvector(fcod[0], 0, l_sf-1, 0.0);
```

```
        ini_dvector(qua_fcod[0], 0, l_sf-1, 0.0);
    }


/*-----------------------------------------------*/
/*     Classify the speech subframe, used for excitation   */
/*              preselection              */
/*-----------------------------------------------*/


SMO_initial_analysis (NewTg+i_s+NP, Vad, lag_f[i_sf],
                                      refl0[i_sf], &speech_mode,
                                            pitch_corr, l_sf);


/*-----------------------------------------------*/
/*        Calculate the Target for codebook search      */
/*-----------------------------------------------*/


for (i = 0; i < l_sf; i++)
        {
        Tg[i] = Tgs[i] - gainQ[0]*fcod[0][i];
        res2[i] -= gainQ[0]*unfcod[0][i];
        }


/*-----------------------------------------------*/
/*        Mode selection of fixed excitation:      */
/*           mixed search vs pure Gaussian         */
/*-----------------------------------------------*/


SMO_refined_analysis (res2, speech_mode, pitch_corr, &exc_mode,
                                      &beta_sub, l_sf);


/*-----------------------------------------------*/
/*             Fixed Codebook search             */
/*-----------------------------------------------*/


k = exc_mode*frame_class;
if (NoisyV_flag == 1)
        k = 2;
if (NoisyV_flag == 2)
        k = 1;
```

```
                    switch (fix_rate)
                        {
                        case RATE8_5K:
                            if (frame_class == 6)
                                {
                                FCS_cdbk_search_30b_sub40 (ext, pdcfq[i_sf],
                                                Tg, res2, hh, unfcod[1], l_sf, i_sf,
                                                    lag[i_sf], k, gp_pp[i_sf],
                                                        nsr, Rp_Wn, &channel);
                                }
                            else
                                {
                                FCS_cdbk_search_22b_sub40 (ext, pdcfq[i_sf],
                                                Tg, res2, hh, unfcod[1], l_sf, i_sf,
                                                    lag[i_sf], k, pgain_past,
                                                nsr, Rp_Wn, &channel);
                                }
                            break;

                        case RATE4_0K:

                            if (frame_class == 6)
                                {
                                FCS_cdbk_search_13b_sub54 (ext, pdcfq[i_sf],
                                                Tg, res2, hh, unfcod[1],
                                                    l_sf, i_sf, lag[i_sf], k,
                                                        gp_pp[i_sf], nsr, Rp_Wn,
                                                            fix_rate_mem,
                                                            lpcgain_q,
&channel);
                                }
                            else
                                {
#ifdef MEM_TEST
                                ini_dvector(&sigsyn[NP], 0, L_SF-1, -1.0);
                                ini_dvector(&qua_sigsyn[NP], 0, L_SF-1, -1.0);
                                ini_dvector(dif_mem, 0, L_SF+NP-1, -1.0);
                                ini_dvector(qua_dif_mem, 0, L_SF+NP-1, -1.0);

                                px = &wspeech[L_OLPIT-L_FRM-L_LPCLHD];
```

```
                                        ini_dvector(px, 0, L_FRM+L_LPCLHD-1, -1.0);


                                        ini_dvector(hh_w, 0, L_SF-1, -1.0);
                                        ini_dvector(ForPitch, 0, L_FRM+L_FRM/2-1, -1.0);


                                        px = &qua_unfcod[0][0];
                                        ini_dvector(px, i_s, L_FRM-1, -1.0);
                                        px = &qua_unfcod[1][0];
                                        ini_dvector(px, i_s, L_FRM-1, -1.0);
                                        px = &qua_fcod[0][0];
                                        ini_dvector(px, i_s, L_FRM-1, -1.0);
                                        px = &qua_fcod[1][0];
                                        ini_dvector(px, i_s, L_FRM-1, -1.0);



                                        ini_dvector(qua_ext, 0, MAX_LAG+L_SF-1, -1.0);


                                        ini_dvector(qua_Tg, 0, L_SF-1, -1.0);

                                    .
                                        ini_dvector(rxx, 0, NP, -1.0);
                                        ini_dvector(refl0, 0, N_SF_MAX-1, -1.0);


                                        for (i=0;i<N_SF_MAX+1;i++)                  .
                                                {
                                                px = &pdcf[i][0];
                                                ini_dvector(px, 0, NP-1, -1.0);
                                                }


                                        ini_dvector(lsfq_new, 0, NP-1, -1.0);
                                        ini_dvector(lsf_new2, 0, NP-1, -1.0);


                                        ini_dvector(lsf_new3, 0, NP-1, -1.0);
                                        ini_dvector(lsf_int, 0, NP-1, -1.0);
                                        ini_dvector(sigpp, i_s, L_FRM-1, -1.0);
                                        .

                                        .

    #endif


                                        FCS_cdbk_search_15b_sub80 (ext, pdcfq[i_sf],
                                                        Tg, res2, hh, unfcod[1], l_sf, i_sf,
```

```
                                                      lag[i_sf], k, pgain_past,
                                                            nsr, Rp_Wn,

        fix_rate_mem,
                                                               lpcgain_q,
        &channel);
                                    }
                            break;


                    case RATE2_0K: case RATE0_8K:
                            cpy_dvector(qua_unfcod[1]+i_s, unfcod[1], 0, l_sf-1);
                            gainQ[1] = qua_gainQ[1][i_sf];
                        break;


                    default: nrerror ("Invalid fix_rate !!\n");
                            break;
                    }


        /*---------------------------------------------------*/
        /*      Filter the selected excitation vector        */
        /*---------------------------------------------------*/


        buf = dvector (0, l_sf-1);


        filterAZ (hh, unfcod[1], fcod[1], buf, (INT16)(l_sf-1), l_sf);


        free_dvector (buf, 0, l_sf-1);




        /*---------------------------------------------------*/
        /*                    Gains                          */
        /*---------------------------------------------------*/


        if ((fix_rate == RATE8_5K) || (fix_rate == RATE4_0K))
                {
                /*-------------------------------------------*/
                /*          Unquantized gains                */
                /*-------------------------------------------*/


        GainModiDeci = 1;
```

```
if ((frame_class < 6) && (frame_class > 1))
        GEQ_gain_reopt_2 (fcod[0], fcod[1], Tgs, gainQ,
                                        gainQ+1, l_sf);
else
        {
        gainQ[0] = gp_pp[i_sf];
        for(i = 0; i < l_sf; i++)
                Tg[i] = Tgs[i] - gainQ[0]*fcod[0][i];


        dot_dvector (Tg, fcod[1], &gainQ[1], 0, l_sf-1);


        dot_dvector (fcod[1], fcod[1], &val1, 0, l_sf-1);


        gainQ[1] /= MAX(val1, 0.01);
        }



/*---------------------------------------------*/
/*              Gain normalization             */
/*---------------------------------------------*/


if (frame_class < 6)
        {
        if (GainNormDeci == 0)
                beta_sub = 0.0;
        GainNormDeci = 0;
        if ((nsr > 0.125) || (frame_class <= 1) ||
                        ((fix_rate == RATE4_0K) && (Rp_Wn < 0.5)))
                        {
                        GainNormDeci = 1;
                        if (fix_rate == RATE8_5K)
                                x = ResEng[(short)(i_sf/2)];
                        else
                                x = ResEng[i_sf];


                        PRC_GainsNorm_Gc_Gp (nsr, x, ext+MAX_LAG, gainQ,
                                        unfcod, fcod, Tgs, Vad*exc_mode,
                                        beta_sub, l_sf);
                        }
```

```
                    gainQ[0] *= NoiseGainFactor;

                    gainQ[1] *= NoiseGainFactor;

                    }

            else

                {

                if (nsr > 0.25)

                        PRC_GainNorm_Gc (ext+MAX_LAG, gainQ, unfcod,

        fcod, Tg, 1_sf);
#ifdef PROG_BUG_FIX

                        GainNormDeci = 0;

#endif

                    }




        /*----------------------------------------------*/

        /*              Gain Quantization            */

        /*----------------------------------------------*/




        /*----------------------------------------------*/

        /*              Limit pitch gain             */

        /*----------------------------------------------*/


        if (gainQ[0] < 0.0)

                gainQ[0] = 0.0;


        if (gainQ[0] > 1.2)

                gainQ[0] = 1.2;


        for (i = 0; i < LTP_BUFF_SIZE-1; i++)

                pgain_buf[i] = pgain_buf[i+1];


        pgain_buf[LTP_BUFF_SIZE-1] = gainQ[0];


        if (gainQ[1] < 0.0)

                FCS_ChangeSign (&channel, i_sf, 1_sf, unfcod[1], fcod[1],

                                        gainQ+1);


        /*----------------------------------------------*/
```

111

```
#ifdef MEM_TEST
                cpy_dvector (unfcod[0], qua_unfcod[0]+i_s, 0, l_sf-1);
                cpy_dvector (fcod[0], qua_fcod[0]+i_s, 0, l_sf-1);
#endif


                cpy_dvector (unfcod[1], qua_unfcod[1]+i_s, 0, l_sf-1);
                cpy_dvector (fcod[1], qua_fcod[1]+i_s, 0, l_sf-1);



        if (GainModiDeci == 0)
                cpy_dvector (Tgs, Tg, 0, l_sf-1);
        else
                wad_dvector (fcod[0], gainQ[0], fcod[1], gainQ[1],
                                        Tg, 0, l_sf-1);


        cpy_dvector (Tg, &qua_Tg[i_s], 0, l_sf-1);


        /*---------------------------------------------*/


        if (frame_class != 6)
                {
                if (fix_rate != RATE8_5K)
                        {
                        if (((fix_rate_mem == RATE8_5K) ||
                                (fix_rate_mem == RATE0_8K)) && (i_sf == 0))
                                        GEQ_update_mem_4d_to_2d();
                        else if (((fix_rate_mem == RATE4_0K) &&
                                        (frame_class_m == 6) && (i_sf == 0))
                                        GEQ_update_mem_3d_to_2d();


                        GEQ_gainVQMA_2 (Tg, unfcod, fcod, gainQ,
                                        &(channel.idx_gainVQ[i_sf]),
                                                l_sf, fix_rate);
                        }
                else
                        {
                        if (((fix_rate_mem == RATE4_0K) ||
                                (fix_rate_mem == RATE2_0K)) && (i_sf == 0))
                                {
```

```
                    if (frame_class_m != 6)
                            GEQ_update_mem_2d_to_4d();
                    else
                            GEQ_update_mem_3d_to_4d();
                    }


                    GEQ_gainVQMA_2 (Tg, unfcod, fcod, gainQ,
                                        &(channel.idx_gainVQ[i_sf]),
                                            l_sf, fix_rate);

                }
            }


        /*----------------------------------------------------*/
        /*  Update the past quantized pitch gain for cdbk search */
        /*----------------------------------------------------*/


        pgain_past = gainQ[0];
        if (pgain_past < PAST_PGAIN_MIN)
                    pgain_past = PAST_PGAIN_MIN;
        if (pgain_past > PAST_PGAIN_MAX)
                    pgain_past = PAST_PGAIN_MAX;


        qua_gainQ[0][i_sf] = gainQ[0];
        qua_gainQ[1][i_sf] = gainQ[1];
        }
    else
        {
        /*----------------------------------------------------*/
        /*      fix_rate==RATE2_0K || fix_rate==RATE0_8K    */
        /*----------------------------------------------------*/


        GainNormDeci = 0;
        gainQ[0] = 0.0;
        pgain_past = gainQ[0];
        qua_gainQ[0][i_sf]=0;
        gainQ[1]=qua_gainQ[1][i_sf];
        cpy_dvector(fcod[1], qua_fcod[1]+i_s, 0, l_sf-1);
        }


        /*----------------------------------------------------*/
```

```
/*      Build the excitation and synthesized signal      */
/*------------------------------------------------------*/


wad_dvector (unfcod[0], gainQ[0], unfcod[1], gainQ[1],
                                    ext+MAX_LAG, 0, l_sf-1);



/*------------------------------------------------------*/
/*               Update memory                */
/*------------------------------------------------------*/


FLT_allsyn (ext+MAX_LAG, l_sf, pdcfq[i_sf], NP, sigsyn+NP,

    synth_mem);

for (i = l_sf-NP, j=0; i < l_sf; i++,j++)
        {
        dif_mem[j] = NewTg[i_s+NP+i] - sigsyn[i+NP];
        target_mem[j] = Tgs[i] - gainQ[0]*fcod[0][i]
                                    - gainQ[1]*fcod[1][i];
        }


/*------------------------------------------------------*/
/*           Update the adaptive codebook        */
/*------------------------------------------------------*/


cpy_dvector (ext+l_sf, ext, 0, MAX_LAG-1);


/*------------------------------------------------------*/


i_s += l_sf;


/*======================================================*/
}


/*============================================================*/
/*□□□□□□□□□□□□□□□□□□□□ Second Loop With Quantized Fixed CB Gains □□□□□□□□□□□□□□□□□□□*/
/*============================================================*/


if ((frame_class == 6) && (fix_rate != RATE2_0K) && (fix_rate != RATE0_8K))
        {
```

```
/*-----------------------------------------------*/
/*            Quantize 3 fixed CB gains          */
/*-----------------------------------------------*/


if (fix_rate != RATE8_5K)
        {
        if( ((fix_rate_mem == RATE8_5K) || (fix_rate_mem == RATE0_8K)))
                        GEQ_update_mem_4d_to_3d();
        else if (frame_class_m != 6 )
                        GEQ_update_mem_2d_to_3d();


        GEQ_gainVQMA_3(qua_Tg, qua_unfcod, qua_fcod, qua_gainQ,
                                        &(channel.idx_Gc_VQ));


        }
else
        {
        if( ((fix_rate_mem == RATE4_0K) || (fix_rate_mem == RATE2_0K)))
                {
                if (frame_class_m != 6)
                        GEQ_update_mem_2d_to_4d();
                else
                        GEQ_update_mem_3d_to_4d();
                }


        GEQ_gainVQMA_4(qua_Tg, qua_unfcod, qua_fcod, qua_gainQ,
                                        &(channel.idx_Gc_VQ));

        }
/*-----------------------------------------------*/


i_s = 0;
for (i_sf = 0; i_sf < n_sf; i_sf++)
        {
        /*=============================================*/


        if (fix_rate == RATE8_5K)
                l_sf = L_SF4;
        else
                {
                if (i_sf == N_SF3-1)
```

```
                l_sf = L_SF3;
           else
                l_sf = L_SF0;
       }


/*-----------------------------------------------*/
/*              Target signal           */
/*-----------------------------------------------*/


if (i_sf > 0)
       {
       PRC_TargetSignal (wpdcf_zero[i_sf], wpdcf_pole[i_sf],
                          pdcfq[i_sf], NewTg+i_s, ext+MAX_LAG, Tgs,
                          qua_dif_mem, qua_target_mem, l_sf);
       }
else
       cpy_dvector (Tgs_m, Tgs, 0, l_sf-1);


/*-----------------------------------------------*/
/*         Re-build adaptive CB excitation     */
/*-----------------------------------------------*/


if (i_sf > 0)
       {
       LTP_PP_pitch_ext_decod (ForPitch+i_s, qua_ext, i_sf,
                          qua_unfcod[0]+i_s, lag, lag_f, l_sf);


       /*-----------------------------------------*/


       buf = dvector (0, l_sf-1);


       filterAZ (hh_m+i_s, qua_unfcod[0]+i_s, qua_fcod[0]+i_s,
                                                    buf,
(INT16)(l_sf-1), l_sf);


       free_dvector (buf, 0, l_sf-1);


       /*-----------------------------------------*/


       }
```

```
/*---------------------------------------------*/
/*      Build the excitation and synthesized signal     */
/*---------------------------------------------*/


wad_dvector (qua_unfcod[0]+i_s, qua_gainQ[0][i_sf],

                        qua_unfcod[1]+i_s, qua_gainQ[1][i_sf],

                                qua_ext+MAX_LAG, 0, l_sf-1);


/*---------------------------------------------*/
/*              Update memory                  */
/*---------------------------------------------*/


FLT_allsyn (qua_ext+MAX_LAG, l_sf, pdcfq[i_sf], NP,

                                qua_sigsyn+NP, qua_synth_mem);



g1 = qua_gainQ[0][i_sf];
g2 = qua_gainQ[1][i_sf];


for (i = l_sf-NP, j = 0; i < l_sf; i++, j++)
        {
        qua_dif_mem[j] = NewTg[i_s+NP+i] - qua_sigsyn[i+NP];

        qua_target_mem[j] = Tgs[i] - g1 * qua_fcod[0][i+i_s]
                - g2 * qua_fcod[1][i+i_s];
        }


/*---------------------------------------------*/
/*      Update the adaptive codebook           */
/*---------------------------------------------*/


cpy_dvector (qua_ext+l_sf, qua_ext, 0, MAX_LAG-1);
i_s += l_sf;


/*===========================================================*/
}



/*---------------------------------------------*/
```

```
/*          Modify the memorys for next frame      */
/*----------------------------------------------------*/


cpy_dvector (qua_synth_mem,    synth_mem,     0, NP-1);
cpy_dvector (qua_dif_mem,              dif_mem,       0, NP-1);
cpy_dvector (qua_target_mem,    target_mem, 0, NP-1);
cpy_dvector (qua_ext,                     ext,             0, MAX_LAG-1);



/*=======================================================*/

}
else
{
/*----------------------------------------------------*/
/*          Modify the memorys for next frame      */
/*----------------------------------------------------*/


cpy_dvector (synth_mem, qua_synth_mem, 0, NP-1);
cpy_dvector (dif_mem,           qua_dif_mem,    0, NP-1);
cpy_dvector (target_mem,      qua_target_mem, 0, NP-1);
cpy_dvector (ext,                     qua_ext,             0, MAX_LAG-1);


}


/*----------------------------------------------------*/
/*          Index to bitstream convertion         */
/*----------------------------------------------------*/


BIT_cdbk_index_to_bits(&channel, PackedWords, PackWdsPtr);


#ifdef DIAG_SMV


/*=======================================================*/
/* □□□□□□□□□□□□□□□□□□□□□□□□□□□□□□□□□□□□□□□□□□□□□□□□□□ */
/* □□□□□□□□□□□□□□□□□□□□□□□□          □□□□□□□□□□□□□□□□□□□□ */
/* □□□□□□□□□□□□□□□□□□□□□□□□    DECODER    □□□□□□□□□□□□□□□□□□ */
/* □□□□□□□□□□□□□□□□□□□□□□□□          □□□□□□□□□□□□□□□□□□□□ */
/* □□□□□□□□□□□□□□□□□□□□□□□□□□□□□□□□□□□□□□□□□□□□□□□□□□ */
/*=======================================================*/
```

```
i_s = 0;
for (i_sf = 0; i_sf < n_sf; i_sf++)
        {
        if (fix_rate != RATE4_0K)
                l_sf = L_SF4;
        else
                {
                if (frame_class == 6)
                        {
                        if (i_sf == N_SF3-1)
                                l_sf = L_SF3;
                        else
                                l_sf = L_SF0;
                        }
                else
                        l_sf = L_SF;
                }


        /*----------------------------------------------------*/


        cpy_dvector (qua_unfcod[0]+i_s, unfcod[0], 0, l_sf-1);
        cpy_dvector (qua_unfcod[1]+i_s, unfcod[1], 0, l_sf-1);
        wad_dvector (unfcod[0], qua_gainQ[0][i_sf], unfcod[1],
                                qua_gainQ[1][i_sf], qua_sigsyn+NP, 0, l_sf-1);



        FLT_allsyn (qua_sigsyn+NP, l_sf, pdcfq[i_sf], NP,
                                qua_sigsyn+NP, synth_mem_dec);


        /*----------------------------------------------------*/
        /*              Post processing            */
        /*----------------------------------------------------*/


        switch (fix_rate)
                {
                case RATE8_5K: if ((*FlatSpFlag) == 0)
                                                {
                                                x = 0.65;
                                                y = 0.4;
```

119

```
                                                             }
                                                          else
                                                             {
                                                             x = 0.63;
                                                             y = 0.4;
                                                             }
                              break;

                  case RATE4_0K:          x = 0.63;
                                                      y = 0.5;
                              break;

                  case RATE2_0K:  x = 0.63;
                                                      y = 0.0;
                              break;

                  case RATE0_8K:          x = 0.63;
                                                      y = 0.0;
                              break;
                  default: nrerror("Invalid fix_rate !!");
                              break;
                  }

         PPR_post_process(qua_sigsyn, pdcfq[i_sf], x, y, lag_f[i_sf],
                                             l_sf, (*FlatSpFlag), fix_rate);


         /*----------------------------------------------------*/
         /*        Update the synthesized speech buffer        */
         /*----------------------------------------------------*/

         cpy_dvector (qua_sigsyn+NP, enc_sigout+i_s, 0, l_sf-1);

         /*----------------------------------------------------*/


   i_s += l_sf;
         }

#endif
```

```
#ifdef DIAG_SMV

        DIA_trace_data ((FLOAT64)Vad, L_FRM, 10000.0, fdia_vad);

#endif

        /*-----------------------------------------------*/

        return;

        /*-----------------------------------------------*/
        }

/*===============================================================*/
/*----------------------------- END ----------------------------*/
/*===============================================================*/
```

```
/*==============================================================*/


/*==============================================================*/
/* Conexant System Inc.                       */
/* 4311 Jamboree Road                         */
/* Newport Beach, CA 92660                      */
/*----------------------------------------------*/
/* Copyright(C) 2000 Conexant System Inc.            */
/*----------------------------------------------*/
/* ALL RIGHTS RESERVED:                       */
/* No part of this software may be reproduced in any form or by any  */
/* means or used to make any derivative work (such as transformation */
/* or adaptation) without the authorisation of Conexant System Inc.  */
/*==============================================================*/
/* PROTOTYPE : encoder.h                      */
/*==============================================================*/


/*----------------------------------------------*/
/*--------------------- FUNCTIONS ---------------------*/
/*----------------------------------------------*/


void enc_smv_frame (FLOAT64 sigpp [], INT16 PackedWords [], FLOAT64 enc_sigout [],
                    INT16 smv_mode, INT16 switch_flag, INT16 *FlatSpFlag,
                         char signaling, FLOAT64 *av_rat, INT16 *VoicingClass);



/*==============================================================*/
/*--------------------- END ---------------------*/
/*==============================================================*/
```

```
/*======================================================================*/


/*======================================================================*/
/* Conexant System Inc.                          */
/* 4311 Jamboree Road                            */
/* Newport Beach, CA 92660                        */
/*----------------------------------------------------*/
/* Copyright(C) 2000 Conexant System Inc.                */
/*----------------------------------------------------*/
/* ALL RIGHTS RESERVED:                          */
/* No part of this software may be reproduced in any form or by any  */
/* means or used to make any derivative work (such as transformation */
/* or adaptation) without the authorisation of Conexant System Inc.  */
/*======================================================================*/
/* FILE: ext_var.h                            */
/*======================================================================*/


#ifdef DIAG_SMV


/*======================================================================*/
/*===================== DIAGNOSTICS FILE POINTERS ====================*/
/*======================================================================*/


/*----------------------------------------------------*/
/*              Encoder unquantized              */
/*----------------------------------------------------*/

extern FILE *fdia_vad;

/*----------------------------------------------------*/
/*              Encoder quantized                */
/*----------------------------------------------------*/

extern FILE *fdia_sp_enc;

/*----------------------------------------------------*/
/*              Floating point parameter dump          */
/*----------------------------------------------------*/
```

```
/*------------------------------------------------*/
/*                    Decoder                  */
/*------------------------------------------------*/


#endif


/*================================================*/
/*================= FRAME COUNTERS ===============*/
/*================================================*/


extern INT64 frm_count;
extern INT64 frm_erasure;


/*================================================*/
/*=================== SMV CONTROL ================*/
/*================================================*/


extern INT16 smv_mode;
extern INT16 fix_rate, fix_rate_mem;


/*================================================*/
/*================ NOISE SUPRESSION ==============*/
/*================================================*/


extern FLOAT64 MIN_GAIN;



/*================================================*/
/*=========== PRE AND POST PROCESSING ============*/
/*================================================*/


extern FLOAT64 *pre_flt_num;
extern FLOAT64 *pre_flt_den;
extern FLOAT64 *pre_flt_buf_z;
extern FLOAT64 *pre_flt_buf_p;


extern FLOAT64 pre_gain;


extern FLOAT64 *lp_flt_num;
```

```
extern FLOAT64 *lp_flt_buf;


/*--------------------------------------------------------------------*/


extern INT16   *zeroed;
extern FLOAT64 *zero_rate;
extern FLOAT64 *low_rate;
extern FLOAT64 *high_rate;


extern FLOAT64 *low_neg;
extern FLOAT64 *low_pos;




extern INT32    min_delta;
extern FLOAT64 zero_level;
extern FLOAT64 l2_neg, l1_neg, l1_pos, l2_pos;


/*--------------------------------------------------------------------*/


extern FLOAT64 tc_mem_dec;
extern FLOAT64 tc_coeff;
extern FLOAT64 tc_gain;
extern FLOAT64 *tc_buff_exc;


/*--------------------------------------------------------------------*/


extern FLOAT64 *buff_LTpost;
extern FLOAT64 *PF_mem_syn;
extern FLOAT64 r_zero, r_pole;
extern FLOAT64 pst_scale;
extern FLOAT64 pst_hp_mem;


/*--------------------------------------------------------------------*/


extern FLOAT64 *pst_flt_num;
extern FLOAT64 *pst_flt_den;
extern FLOAT64 *pst_flt_buf_z;
extern FLOAT64 *pst_flt_buf_p;


extern FLOAT64 pst_gain;
```

```
/*===================================================================*/
/*============================ LPC ANALYSIS ========================*/
/*===================================================================*/


extern FLOAT64 *siglpc;


/*-------------------------------------------------------------*/
/*            '     LPC analysis window             */
/*-------------------------------------------------------------*/


extern FLOAT64 *lpc_window;
extern FLOAT64 *lpc_window1;
extern FLOAT64 *lpc_window2;


/*-------------------------------------------------------------*/
/*                Tilt analysis window              */
/*-------------------------------------------------------------*/


extern FLOAT64 *tilt_window;


/*-------------------------------------------------------------*/
/*                Bandwidth expansion factor        */
/*-------------------------------------------------------------*/


extern FLOAT64 *bwe_factor;


/*-------------------------------------------------------------*/
/*                LPC parameters                    */
/*-------------------------------------------------------------*/


extern FLOAT64 pderr;
extern FLOAT64 *rxx, **refl, **pdcf, **pdcfq, **pdcfq_dec;
extern FLOAT64 *lsf_new, *lsf_old, *lsf_mid;


/*-------------------------------------------------------------*/


extern FLOAT64 erg, lpcgain;
```

```
extern FLOAT64 sub_lpcg;


/*----------------------------------------------------------------*/


extern FLOAT64 *IntLSF_C;


/*================================================================*/
/*=========================== Weighted Speech ===================*/
/*================================================================*/


extern FLOAT64 r_pole_ws;
extern FLOAT64 **wpdcf_zero, **wpdcf_pole;
extern FLOAT64 *wspeech, *wspeech_mem;
extern FLOAT64 Z1_ws_1, Z1_ws_2;
extern FLOAT64 *ModiSig_m, *tmp_ws_m;


/*================================================================*/
/*========================= Fixed codebook search ==============*/
/*================================================================*/


extern FLOAT64 **fcod, **unfcod;
extern FLOAT64 **qua_fcod, **qua_unfcod;


/*================================================================*/
/*================= Residual and target signal buffer =========*/
/*================================================================*/



/*================================================================*/
/*========================= Gain VQ ===========================*/
/*================================================================*/


extern INT16   GainNormDeci, GainModiDeci;


extern FLOAT64 pgain_past;
extern FLOAT64 pgain_past_dec;


extern FLOAT64 **qua_gainQ;


extern FLOAT64 *past_energyq_2d;
```

```
extern FLOAT64 *past_energyq_3d;
extern FLOAT64 *past_energyq_4d;


extern FLOAT64 *gp_buf;


extern FLOAT64 past_fixed_energy;


extern FLOAT64 *Prev_Beta_Pitch;



extern FLOAT64 *energy_pred_coeff_1;
extern FLOAT64 *energy_pred_coeff_2;
extern FLOAT64 *energy_pred_coeff_3;


extern FLOAT64 *energy_pred_coeff4d_1;
extern FLOAT64 *energy_pred_coeff4d_2;
extern FLOAT64 *energy_pred_coeff4d_3;
extern FLOAT64 *energy_pred_coeff4d_4;


extern FLOAT64 *pred_energy_d38;
extern FLOAT64 *pred_energy_d410;
extern FLOAT64 gp_mean;
extern FLOAT64 gp_fec;



extern FLOAT64 **gain_cb_2_128;
extern FLOAT64 **gain_cb_2_128_8_5;


extern FLOAT64 gp3_tab[TAB_SIZE_GVQ_3D][GVQ_VEC_SIZE_3D];
extern FLOAT64 gp4_tab[TAB_SIZE_GVQ_4D][GVQ_VEC_SIZE_4D];
extern FLOAT64 gainVQ_2_128[MSMAX_2_128][GVQ_VEC_SIZE_2D];
extern FLOAT64 gainVQ_2_128_8_5[MSMAX_2_128][GVQ_VEC_SIZE_2D];
extern FLOAT64 gainVQ_3_256[MSMAX_3_256][GVQ_VEC_SIZE_3D];
extern FLOAT64 gainVQ_4_1024[MSMAX_4_1024][GVQ_VEC_SIZE_4D];
extern FLOAT64 gainSQ_1_32[MSMAX_1_32];
extern FLOAT64 gainSQ_1_64[MSMAX_1_64];


/*=============================================================================*/
/*======================= LSF quantizers ======================================*/
/*=============================================================================*/
```

```
extern FLOAT64 ***lsf_cb_08k;
extern FLOAT64 ***lsf_cb_40k;
extern FLOAT64 ***lsf_cb_85k;


extern INT16   *stage_cand_08k;
extern INT16   *stage_cand_40k;
extern INT16   *stage_cand_85k;



extern FLOAT64 B_08k[LP_08k][LQMA_08k][MAXLNp];
extern FLOAT64 B_40k[LP_40k][LQMA_40k][MAXLNp];
extern FLOAT64 B_85k[LP_85k][LQMA_85k][MAXLNp];


extern FLOAT64 CBes_08k[MAXLTT_08k][LMSMAX_08k][MAXLNp];
extern FLOAT64 CBes_40k[MAXLTT_40k][LMSMAX_40k][MAXLNp];
extern FLOAT64 CBes_85k[MAXLTT_85k][LMSMAX_85k][MAXLNp];


extern INT16   *MS_08k;
extern INT16   *MS_40k;
extern INT16   *MS_85k;


extern FLOAT64 *last_qlsf;
extern FLOAT64 *lsfq_old, *lsfq_old_dec;
extern FLOAT64 *Mean;


extern FLOAT64 **qes;
extern FLOAT64 **qes_dec;


extern FLOAT64 *lsfq_mem_dec;
extern FLOAT64 *lsfq_mem_enc;



/*===========================================================================*/
/*=============================== PITCH OPEN LOOP ===========================*/
/*===========================================================================*/


extern INT16   *ol_lag;
extern INT16   *lag;
```

```
extern INT16   lagl, low_pit, high_pit;
extern FLOAT64 *Rp_sub;

extern FLOAT64 pitchf;


/*---------------------------------------------------------------*/



/*---------------------------------------------------------------*/


extern FLOAT64 *PitLagTab5b;
extern FLOAT64 *PitLagTab7b;
extern FLOAT64 *PitLagTab8b;


extern FLOAT64 *SincWindows;


/*---------------------------------------------------------------*/


extern INT16     VUVmm, pitch_m, pitch_mm, Iopt0;

extern INT16     *PITmax0;
extern INT16     LagCount, VadCount, Av_lag;

extern FLOAT64 Rp_m;
extern FLOAT64 *Rmax0;


/*---------------------------------------------------------------*/


extern FLOAT64 *pitch_f_mem;


/*==============================================================*/
/*======================= CLOSED PITCH PROCESSING =============*/
/*==============================================================*/


extern FLOAT64 *ext;
extern FLOAT64 *SincWindows_E;
extern FLOAT64 *NewTg;
extern FLOAT64 *lag_f;
extern INT16     pitch_index, pre_pitch_index;
```

```
/*=============================================================*/
/*============================ PITCH PRE-PROCESSING ===========================*/
/*=============================================================*/


extern FLOAT64 *SincWindows_PP;


extern FLOAT64  Delay_pp, Last_Rp;
extern INT16     frame_class_pp_m;
extern FLOAT64 *targ_mem;




/*=============================================================*/
/*==================== PRC LIBRARY PROCESSING ===============*/
/*=============================================================*/


extern FLOAT64 cl_Eg, ol_Eg;
extern FLOAT64 m_lpc_gain;


/*=============================================================*/
/*==================== GCB LIBRARY PROCESSING ===============*/
/*=============================================================*/


extern INT64 seed_exc;
extern FLOAT64 Z1_gcb;
extern FLOAT64 ref_eng_gcb;
extern INT16 rate_mem;


extern INT64 seed_dec;


/*=============================================================*/
/*==================== CLA LIBRARY PROCESSING ===============*/
/*=============================================================*/


extern INT16   VUV, VUVm;
extern INT16   frame_class, frame_class_m, frame_class_pp;


extern FLOAT64 energy, energy_m;


extern INT16 frame_onset;
extern INT16 frame_pit_tab, min_pit, max_pit;
```

131

```
extern INT16   *frame_class_mem, *onstplsv_mem, *voiced_mem;
extern FLOAT64 *window1;
extern FLOAT64 *buffer_cla;
extern FLOAT64 *Lp_buffer;
extern FLOAT64 *buffer_refl0;
extern FLOAT64 *buffer_max_cla;
extern FLOAT64 *buffer_wtilt, *buffer_wmax, *buffer_wRp;
extern FLOAT64 E_noi, T_noi, M_noi, R_noi;
extern FLOAT64 **P_w, MA_avg_wRp, MA_min_wtilt;


extern INT16 SVS_Count, Vad_0_Count, FlatSp_Flag;
extern FLOAT64 Av_value;


/*---------------------------------------------------------*/


extern FLOAT64 Rp_m_cla, lpcg_m_cla;


/*---------------------------------------------------------*/


extern INT16 OnSct;
extern INT16 frame_class_mm;


/*---------------------------------------------------------*/


INT16   SVS_deci_mem;


/*=========================================================*/
/*===================== VAD LIBRARY PROCESSING ===========*/
/*=========================================================*/


extern INT16   *lag_buf;
extern FLOAT64 *pgain_buf;


extern INT16 Vad, *flag_vad_mem;


extern INT16 flag;
extern INT16 count_sil;
extern INT16 count_ext;
```

```
extern INT16 count_noise;
extern INT16 dec3_flg_mem;
extern INT16 onset_flg, count_onset;


extern FLOAT64 pitch_gain_mean;
extern FLOAT64 **vad_lsf_mem;
extern FLOAT64 min_energy;
extern FLOAT64 mean_energy;
extern FLOAT64 *prev_cml_lsf_diff;
extern FLOAT64 *prev_energy;
extern FLOAT64 snr;
extern FLOAT64 mean_max;
extern FLOAT64 mean_s_energy;
extern FLOAT64 prev_min_energy;
extern FLOAT64 *min_energy_mem;
extern FLOAT64 next_min_energy;
extern FLOAT64 *mean_lsf;
extern FLOAT64 *norm_mean_lsf;
extern FLOAT64 cml_lsf_diff_filt;
extern FLOAT64 onset_trhsd;


/*===========================================================================*/
/*============================= SNR LIBRARY PROCESSING =======================*/
/*===========================================================================*/


extern FLOAT64 NoiseGainFactor;



extern INT16    n_nois_ext_enc;
extern FLOAT64  NoisEng_enc, eng_old_enc, diff_lsf_m_enc, diff_eng_m_enc;
extern INT16    snr_frm_count, snr_count_vad;
extern FLOAT64  eng_m_enc;



/*===========================================================================*/
/*============================= SMO LIBRARY PROCESSING =======================*/
/*===========================================================================*/


extern FLOAT64  *lsf_smooth;
```

133

```
extern INT16     N_mode_sub_est, N_mode_frm;
extern FLOAT64 *lsf_old_smo, *ma_lsf, *dSP_buf;
extern INT16      *N_sub;


extern INT16     consec_low, consec_high, consec_vad_0;
extern INT16     updates_noise, updates_speech, calls, lev_reset;
extern FLOAT64  ma_max_noise, ma_max_speech;
extern FLOAT64 *buffer_smo, *buffer_p, ma_cp;
extern FLOAT64 *buffer_sum_smo, *buffer_max_smo;


extern INT16     N_mode_sub_ref, consec;
extern INT16     updates;
extern FLOAT64  ma_max;


/*==================================================================*/
/*======================== FCS LIBRARY PROCESSING ===================*/
/*==================================================================*/


extern FLOAT64 lpcg_m, alpha;
extern INT16   lag_m, SVS_flag_m;


extern FLOAT64 *wsp_m;


extern FLOAT64 *hh_hf;


extern FLOAT64 **PHI;


extern INT16     *MaxIdx;
extern INT16     **track;


extern INT16 **p_track_2_5_0, **p_track_2_7_1;
extern INT16 ***p_track_3_2_80, ***p_track_3_2_54;
extern INT16 **p_track_5_4_0, **p_track_5_3_1, **p_track_5_3_2, **p_track_8_4_0;


extern FLOAT64 **unfcod_dec;


/*----------------------------------------------------*/
/*                 13 bits              */
/*----------------------------------------------------*/
```

```
extern FLOAT64 Stab_13b_enc;
extern FLOAT64 Stab_13b_dec;


/*------------------------------------------------------------*/
/*                    15 bits                    */
/*------------------------------------------------------------*/


extern INT64    seed_bfi_exc;
extern FLOAT64 Stab_15b_enc;
extern FLOAT64 Stab_15b_dec;


/*============================================================*/
/*===================== FRAME ERASURE CONCEALEMENT ==========*/
/*============================================================*/


extern INT16    N_bfi, bfh_oh;
extern INT16    past_bfi, ppast_bfi;
extern INT16    bfi_caution, nbfi_count;
extern FLOAT64 *enrg_buff;
extern FLOAT64 *ext_dec_mem;


/*============================================================*/
/*===================== SIGNAL SYNTHESIS =====================*/
/*============================================================*/


extern FLOAT64 *synth_mem, *synth_mem_dec, *dif_mem, *target_mem;
extern FLOAT64 *qua_synth_mem, *qua_dif_mem, *qua_target_mem, *qua_ext;
extern FLOAT64 *sigsyn_dec, *ext_dec;


/*============================================================*/
/*===================== INDEX ================================*/
/*============================================================*/


extern INT16 *bitno0, *bitno1;


/*============================================================*/
/*---------------------- END -----------------------*/
/*============================================================*/
```

```
/*=========================================================*/


/*=====================================================*/
/* Conexant System Inc.                    */
/* 4311 Jamboree Road                      */
/* Newport Beach, CA 92660                  */
/*_____*/
/* Copyright(C) 2000 Conexant System Inc.        */
/*_____*/
/* ALL RIGHTS RESERVED:                    */
/* No part of this software may be reproduced in any form or by any */
/* means or used to make any derivative work (such as transformation */
/* or adaptation) without the authorisation of Conexant System Inc.  */
/*=====================================================*/
/* FILE: gbl_var.h                     */
/*=====================================================*/


#ifdef DIAG_SMV


/*=========================================================*/
/*======================= DIAGNOSTICS FILE POINTERS ===================*/
/*=========================================================*/


/*_____*/
/*          Encoder unquantized        */
/*_____*/


FILE *fdia_vad;


/*_____*/
/*          Encoder quantized         */
/*_____*/


FILE *fdia_sp_enc;


/*_____*/
/*          Floating point parameter dump    */
/*_____*/
```

```
/*-----------------------------------------------*/
/*                    Decoder                    */
/*-----------------------------------------------*/



#endif



/*===============================================*/
/*===================== FRAME COUNTERS ==========*/
/*===============================================*/


INT64 frm_count = 0;
INT64 frm_erasure      = 0;


/*===============================================*/
/*===================== SMV CONTROL =============*/
/*===============================================*/


INT16   smv_mode;
INT16   fix_rate, fix_rate_mem;


/*===============================================*/
/*================== NOISE SUPRESSION ===========*/
/*===============================================*/


FLOAT64 MIN_GAIN = -13.0;


/*===============================================*/
/*============= PRE AND POST PROCESSING =========*/
/*===============================================*/


FLOAT64 *pre_flt_num;
FLOAT64 *pre_flt_den;
FLOAT64 *pre_flt_buf_z;
FLOAT64 *pre_flt_buf_p;
FLOAT64 pre_gain;

FLOAT64 *lp_flt_num;
```

```
        FLOAT64 *lp_flt_buf;


        /*------------------------------------------------------------*/


        INT16   *zeroed;
        FLOAT64 *zero_rate;
        FLOAT64 *low_rate;
        FLOAT64 *high_rate;


        FLOAT64 *low_neg;
        FLOAT64 *low_pos;



        INT32   min_delta;
        FLOAT64     zero_level;
        FLOAT64     l2_neg, l1_neg, l1_pos, l2_pos;


        /*------------------------------------------------------------*/


        FLOAT64 tc_mem_dec;
        FLOAT64 tc_coeff;
        FLOAT64 tc_gain;
        FLOAT64 *tc_buff_exc;


        /*------------------------------------------------------------*/


        FLOAT64 *buff_LTpost;
        FLOAT64 *PF_mem_syn;
        FLOAT64 r_zero, r_pole;
        FLOAT64 pst_scale;
        FLOAT64 pst_hp_mem;


        /*------------------------------------------------------------*/


        FLOAT64 *pst_flt_num;
        FLOAT64 *pst_flt_den;
        FLOAT64 *pst_flt_buf_z;
        FLOAT64 *pst_flt_buf_p;


        FLOAT64 pst_gain;
```

```
/*=====================================================================*/
/*========================= LPC ANALYSIS =============================*/
/*=====================================================================*/


FLOAT64 *siglpc;

        /*------------------------------------------------------------*/
        /*              LPC analysis window                       */
        /*------------------------------------------------------------*/

FLOAT64 *lpc_window;
FLOAT64 *lpc_window1;
FLOAT64 *lpc_window2;

        /*------------------------------------------------------------*/
        /*              Tilt analysis window                      */
        /*------------------------------------------------------------*/

FLOAT64 *tilt_window;

        /*------------------------------------------------------------*/
        /*              Bandwidth expansion factor                */
        /*------------------------------------------------------------*/

FLOAT64 *bwe_factor;

        /*------------------------------------------------------------*/
        /*              LPC parameters                            */
        /*------------------------------------------------------------*/

FLOAT64 pderr;
FLOAT64 *rxx, **refl, **pdcf, **pdcfq, **pdcfq_dec;
FLOAT64 *lsf_new, *lsf_old, *lsf_mid;


        /*------------------------------------------------------------*/

FLOAT64 erg, lpcgain;


FLOAT64        sub_lpcg;
```

```
/*------------------------------------------------------------*/


FLOAT64        *IntLSF_C;


/*==========================================================*/
/*========================== Weighted Speech ==============================*/
/*==========================================================*/


FLOAT64 r_pole_ws;
FLOAT64 **wpdcf_zero, **wpdcf_pole;
FLOAT64 *wspeech, *wspeech_mem;
FLOAT64 Z1_ws_1, Z1_ws_2;
FLOAT64 *ModiSig_m, *tmp_ws_m;


/*==========================================================*/
/*========================== Fixed codebook search =======================*/
/*==========================================================*/


FLOAT64 **fcod, **unfcod;
FLOAT64 **qua_fcod, **qua_unfcod;


/*==========================================================*/
/*==================== Residual and target signal buffer ==============*/
/*==========================================================*/




/*==========================================================*/
/*========================== Gain VQ ===============================*/
/*==========================================================*/


INT16   GainNormDeci, GainModiDeci;


FLOAT64 pgain_past;
FLOAT64 pgain_past_dec;


FLOAT64 **qua_gainQ;


FLOAT64 **gain_cb_2_128;
FLOAT64 **gain_cb_2_128_8_5;
```

```
        FLOAT64 *past_energyq_4d;
        FLOAT64 *past_energyq_3d;
        FLOAT64 *past_energyq_2d;


        FLOAT64 *gp_buf;


        FLOAT64 past_fixed_energy;


        FLOAT64 *Prev_Beta_Pitch;



        FLOAT64 *energy_pred_coeff_1;
        FLOAT64 *energy_pred_coeff_2;
        FLOAT64 *energy_pred_cocff_3;

        FLOAT64 *energy_pred_coeff4d_1;
        FLOAT64 *energy_pred_coeff4d_2;
        FLOAT64 *energy_pred_coeff4d_3;
        FLOAT64 *energy_pred_cocff4d_4;


        FLOAT64 *pred_energy_d38;
        FLOAT64 *pred_energy_d410;
        FLOAT64 gp_mean;
        FLOAT64 gp_fec;



        #include "gain_vq.tab"


        /*===================================================================*/
        /*======================= LSF quantizers ============================*/
        /*===================================================================*/


        FLOAT64 ***lsf_cb_08k;
        FLOAT64 ***lsf_cb_40k;
        FLOAT64 ***lsf_cb_85k;


        INT16   *stage_cand_08k;
```

141

```
INT16  *stage_cand_40k;
INT16  *stage_cand_85k;


#include "lsf_vq.tab"


INT16  *MS_08k;
INT16  *MS_40k;
INT16  *MS_85k;

FLOAT64 *last_qlsf;
FLOAT64 *lsfq_old, *lsfq_old_dec;
FLOAT64 *Mean;

FLOAT64 **qes;
FLOAT64 **qes_dec;


FLOAT64 *lsfq_mem_dec;
FLOAT64 *lsfq_mem_enc;


/*=================================================================*/
/*============================ PITCH OPEN LOOP ====================*/
/*=================================================================*/

INT16  *ol_lag;
INT16  *lag;
INT16  lagl, low_pit, high_pit;
FLOAT64 *Rp_sub;



FLOAT64     pitchf;


/*-----------------------------------------------------*/


/*-----------------------------------------------------*/
FLOAT64 *PitLagTab5b;
```

```c
    FLOAT64 *PitLagTab7b;
    FLOAT64 *PitLagTab8b;


    FLOAT64 *SincWindows;


    /*------------------------------------------------------------*/


    INT16   VUVmm, pitch_m, pitch_mm, Iopt0;


    INT16   *PITmax0;
    INT16   LagCount, VadCount, Av_lag;


    FLOAT64 Rp_m;
    FLOAT64 *Rmax0;


    /*------------------------------------------------------------*/


    FLOAT64 *pitch_f_mem;


    /*============================================================*/
    /*======================= CLOSED PITCH PROCESSING ===========*/
    /*============================================================*/


    FLOAT64 *ext;
    FLOAT64 *SincWindows_E;
    FLOAT64 *NewTg;
    FLOAT64 *lag_f;
    INT16   pitch_index, pre_pitch_index;


    /*============================================================*/
    /*======================= PITCH PRE-PROCESSING ==============*/
    /*============================================================*/


    FLOAT64 *SincWindows_PP;


    FLOAT64 Delay_pp, Last_Rp;
    INT16   frame_class_pp_m;
    FLOAT64      *targ_mem;


    /*============================================================*/
```

```
/*=============================== PRC LIBRARY PROCESSING =======================*/
/*=============================================================================*/

FLOAT64 cl_Eg, ol_Eg;
FLOAT64 m_lpc_gain;


/*=============================================================================*/
/*=============================== GCB LIBRARY PROCESSING =======================*/
/*=============================================================================*/


INT64 seed_exc;
FLOAT64 Z1_gcb;
FLOAT64 ref_eng_gcb;
INT16 rate_mem;

INT64 seed_dec;


/*=============================================================================*/
/*=============================== CLA LIBRARY PROCESSING =======================*/
/*=============================================================================*/


INT16   VUV, VUVm;
INT16   frame_class, frame_class_m, frame_class_pp;

FLOAT64 energy, energy_m;

INT16 frame_onset;
INT16 frame_pit_tab, min_pit, max_pit;


INT16   *frame_class_mem, *onstplsv_mem, *voiced_mem;
FLOAT64 *window1;
FLOAT64 *buffer_cla;
FLOAT64 *Lp_buffer;
FLOAT64 *buffer_refl0;
FLOAT64 *buffer_max_cla;
FLOAT64 *buffer_wtilt, *buffer_wmax, *buffer_wRp;
FLOAT64 E_noi, T_noi, M_noi, R_noi;
FLOAT64 **P_w, MA_avg_wRp, MA_min_wtilt;

INT16 SVS_Count, Vad_0_Count, FlatSp_Flag;
```

```
     FLOAT64 Av_value;


     /*------------------------------------------------------------*/


     FLOAT64 Rp_m_cla, lpcg_m_cla;


     /*------------------------------------------------------------*/


     FLOAT64 av_pit_lag, av_pit_g;          .
     INT16 PP_model_m, PP_frm_count;


     /*------------------------------------------------------------*/


     //INT16   SVS_deci_m;



     /*------------------------------------------------------------*/


     INT16 OnSet;
     INT16 frame_class_mm;


     /*------------------------------------------------------------*/


     INT16   SVS_deci_mem;


     /*------------------------------------------------------------*/




     /*============================================================*/
     /*======================= VAD LIBRARY PROCESSING ============*/
     /*============================================================*/


     INT16   *lag_buf;
     FLOAT64 *pgain_buf;


     INT16 Vad, *flag_vad_mem;


     INT16 flag;
     INT16 count_sil;
     INT16 count_ext;
```

```
INT16 count_noise;
INT16 dec3_flg_mem;
INT16 onset_flg, count_onset;

FLOAT64 pitch_gain_mean;
FLOAT64 **vad_lsf_mem;
FLOAT64 min_energy;
FLOAT64 mean_energy;
FLOAT64 *prev_cml_lsf_diff;
FLOAT64 *prev_energy;
FLOAT64 snr;
FLOAT64 mean_max;
FLOAT64 mean_s_energy;
FLOAT64 prev_min_energy;
FLOAT64 *min_energy_mem;
FLOAT64 next_min_energy;
FLOAT64 *mean_lsf;
FLOAT64 *norm_mean_lsf;
FLOAT64 cml_lsf_diff_filt;
FLOAT64 onset_trhsd;


/*==============================================================================*/
/*============================= SNR LIBRARY PROCESSING =========================*/
/*==============================================================================*/

FLOAT64 NoiseGainFactor;

INT16   n_nois_ext_enc;
FLOAT64 NoisEng_enc, eng_old_enc, diff_lsf_m_enc, diff_eng_m_enc;
INT16   snr_frm_count, snr_count_vad;
FLOAT64 eng_m_enc;


/*==============================================================================*/
/*============================= SMO LIBRARY PROCESSING =========================*/
/*==============================================================================*/

FLOAT64 *lsf_smooth;
```

```
INT16    N_mode_sub_est, N_mode_frm;
FLOAT64  *lsf_old_smo, *ma_lsf, *dSP_buf;
INT16    *N_sub;


INT16    consec_low, consec_high, consec_vad_0;
INT16    updates_noise, updates_speech, calls, lev_reset;
FLOAT64  ma_max_noise, ma_max_speech;
FLOAT64  *buffer_smo, *buffer_p, ma_cp;
FLOAT64  *buffer_sum_smo, *buffer_max_smo;



INT16    N_mode_sub_ref, consec;
INT16    updates;
FLOAT64  ma_max;


/*=================================================================*/
/*========================= FCS LIBRARY PROCESSING ================*/
/*=================================================================*/


FLOAT64 lpcg_m, alpha;
INT16   lag_m, SVS_flag_m;


FLOAT64 *wsp_m;


FLOAT64 *hh_hf;
FLOAT64       **PHI;


INT16   *MaxIdx;
INT16   **track;


INT16 **p_track_2_5_0, **p_track_2_7_1;
INT16 ***p_track_3_2_80, ***p_track_3_2_54;
INT16 **p_track_5_4_0, **p_track_5_3_1, **p_track_5_3_2, **p_track_8_4_0;


FLOAT64 **unfcod_dec;


/*----------------------------------------------------------------*/
/*                      13 bits                     */
/*----------------------------------------------------------------*/
```

```
FLOAT64 Stab_13b_enc;
FLOAT64 Stab_13b_dec;


/*————————————————————————————————*/
/*                  15 bits                    */
/*————————————————————————————————*/


INT64   seed_bfi_exc;
FLOAT64       Stab_15b_enc;
FLOAT64       Stab_15b_dec;


/*================================================*/
/*=================== FRAME ERASURE CONCEALEMENT ===================*/
/*================================================*/


INT16   N_bfi, bfh_oh;
INT16   past_bfi, ppast_bfi;
INT16   bfi_caution, nbfi_count;
FLOAT64 *enrg_buff;
FLOAT64 *ext_dec_mem;


/*================================================*/
/*==================== SIGNAL SYNTHESIS ====================*/
/*================================================*/


FLOAT64 *synth_mem, *synth_mem_dec, *dif_mem, *target_mem;
FLOAT64 *qua_synth_mem, *qua_dif_mem, *qua_target_mem, *qua_ext;
FLOAT64 *sigsyn_dec, *ext_dec;


/*================================================*/
/*==================== INDEX ====================*/
/*================================================*/


INT16 *bitno0, *bitno1;


/*================================================*/
/*———————————— END ————————————*/
/*================================================*/
```

```
/*=====================================================================*/


/*=====================================================================*/
/* Conexant System Inc.                        */
/* 4311 Jamboree Road                          */
/* Newport Beach, CA 92660                      */
/*-----------------------------------------------*/
/* Copyright(C) 2000 Conexant System Inc.             */
/*-----------------------------------------------*/
/* ALL RIGHTS RESERVED:                          */
/* No part of this software may be reproduced in any form or by any */
/* means or used to make any derivative work (such as transformation */
/* or adaptation) without the authorisation of Conexant System Inc. */
/*=====================================================================*/
/* LIBRARY: gputil.c                          */
/*=====================================================================*/


/*-----------------------------------------------*/
/*------------------------ INCLUDE --------------------------*/
/*-----------------------------------------------*/


#include "typedef.h"

#include "main.h"
#include "mcutil.h"
#include "gputil.h"


/*-----------------------------------------------*/
/*------------------------ FUNCTIONS --------------------------*/
/*-----------------------------------------------*/


/*=====================================================================*/
/* FUNCTIONS    :   file_open_r ()                    */
/*-----------------------------------------------*/
/* PURPOSE      :   These functions open the file named file_name,*/
/*                and return a pointer to this file.        */
/*-----------------------------------------------*/
/* INPUT ARGUMENTS : _ file name.                    */
/*-----------------------------------------------*/
/* OUTPUT ARGUMENTS : _ None.                      */
```

```
/*--------------------------------------------------------*/
/* RETURN ARGUMENTS :  _ pointer to the file.             */
/*========================================================*/


FILE    *file_open_r ( char *file_name )
        {
        /*------------------------------------------------*/


        FILE    *file_ptr;


        /*------------------------------------------------*/


        if ( ((file_ptr = fopen ( file_name, "r" ) ) == NULL)
                {
#ifdef VERBOSE
                printf("\nfile name : %s\n", file_name);
                nrerror ("error opening file (r) ...");
#endif
                }


        /*------------------------------------------------*/


        return (file_ptr);


        /*------------------------------------------------*/
        }


/*--------------------------------------------------------------*/


/*==============================================================*/
/* FUNCTIONS    :   file_open_w ()                        */
/*------------------------------------------------------*/
/* PURPOSE      :   These functions open the file named file_name,*/
/*                  and return a pointer to this file.    */
/*------------------------------------------------------*/
/* INPUT ARGUMENTS :  _ file name.                        */
/*------------------------------------------------------*/
/* OUTPUT ARGUMENTS :  _ None.                            */
/*------------------------------------------------------*/
/* RETURN ARGUMENTS :  _ pointer to the file.             */
```

```
/*===================================================================*/


.FILE    *file_open_w ( char *file_name )
         {
         /*----------------------------------------------------*/


         FILE    *file_ptr;


         /*----------------------------------------------------*/


         if ( (file_ptr = fopen ( file_name, "w" ) ) == NULL)
                 {
#ifdef VERBOSE
                 printf("\nfile name : %s\n", file_name);
                 nrerror ("error opening file (w) ...");
#endif
                 }


         /*----------------------------------------------------*/


         return (file_ptr);


         /*----------------------------------------------------*/
         }


/*----------------------------------------------------*/


/*===================================================================*/
/* FUNCTIONS    :   file_open_rb ()                    */
/*----------------------------------------------------*/
/* PURPOSE      :   These functions open the file named file_name,*/
/*                  and return a pointer to this file.       */
/*----------------------------------------------------*/
/* INPUT ARGUMENTS :  _ file name.                    */
/*----------------------------------------------------*/
/* OUTPUT ARGUMENTS :  _ None.                    */
/*----------------------------------------------------*/
/* RETURN ARGUMENTS :  _ pointer to the file.              */
/*===================================================================*/
```

```
FILE    *file_open_rb ( char *file_name )
        {
        /*-----------------------------------------------*/

        FILE    *file_ptr;

        /*-----------------------------------------------*/

        if ( (file_ptr = fopen ( file_name, "rb" ) ) == NULL)
                {
#ifdef VERBOSE
                printf("\nfile name : %s\n", file_name);
                nrerror ("error opening file (rb) ...");
#endif
                }

        /*-----------------------------------------------*/

        return (file_ptr);

        /*-----------------------------------------------*/
        }


/*-----------------------------------------------*/

/*===============================================*/
/* FUNCTIONS    :   file_open_wb ()              */
/*-----------------------------------------------*/
/* PURPOSE      :   These functions open the file named file_name,*/
/*           .         and return a pointer to this file.       */
/*-----------------------------------------------*/
/* INPUT ARGUMENTS  : _ file name.              */
/*-----------------------------------------------*/
/* OUTPUT ARGUMENTS : _ None.                   */
/*-----------------------------------------------*/
/* RETURN ARGUMENTS : _ pointer to the file.    */
/*===============================================*/


FILE    *file_open_wb ( char *file_name )
        {
```

FILE    *file_ptr;

```
/*------------------------------------------------*/

FILE    *file_ptr;

/*------------------------------------------------*/

if ( (file_ptr = fopen ( file_name, "wb" ) ) == NULL)
        {
#ifdef VERBOSE
        printf("\nfile name : %s\n", file_name);
        nrerror ("error opening file (wb) ...");
#endif
        }

/*------------------------------------------------*/

return (file_ptr);

/*------------------------------------------------*/
}


/*================================================*/
/* FUNCTIONS    :   output_waves_file ()          */
/*------------------------------------------------*/
/* PURPOSE      :   These functions writes an array of double in */
/*                  XWAVES format file.           */
/*------------------------------------------------*/
/* INPUT ARGUMENTS : _ (char *) file_name : name of the xwaves file.*/
/*                   : _ (FLOAT64 *) x    : array of double.     */
/*                   : _ (INT32) N        : size of the x array. */
/*                   : _ (FLOAT64) scale  : scale value.         */
/*                   : _ (FLOAT64) min    : min range value.     */
/*                   : _ (FLOAT64) max    : max range value.     */
/*------------------------------------------------*/
/* OUTPUT ARGUMENTS : _ None.                      */
/*------------------------------------------------*/
/* RETURN ARGUMENTS : _ pointer to the file.       */
/*================================================*/
```

153

```
void    output_waves_file ( char *file_name, FLOAT64 *x, INT32 N, FLOAT64 scale; \
                                                FLOAT64 min, FLOAT64 max )
        {
        /*----------------------------------------------------*/


        FILE    *file_ptr;
        INT32  i;
        INT16  *waves;


        /*----------------------------------------------------*/


        waves = svector (0, N-1);


        file_ptr = file_open_wb (file_name);


        waves [0] = (INT16)(max);
        waves [1] = (INT16)(min);


        fwrite (waves, sizeof (INT16), 2L, file_ptr);


        for ( i = 0; i < N; i ++ )
                waves [i] = (INT16)(scale * x [i]);


        fwrite (waves, sizeof (INT16), N, file_ptr);


        fclose (file_ptr);


        free_svector (waves, 0, N-1);


        /*----------------------------------------------------*/


        return;


        /*----------------------------------------------------*/
        }


/*--------------------------------------------------------*/


/*========================================================*/
```

```
/* FUNCTION      :   file_length ()                    */
/*------------------------------------------------------*/
/* PURPOSE      :   This function returns the length of a file in */
/*                  bytes.                              */
/*------------------------------------------------------*/
/* INPUT ARGUMENTS  :  _ Pointer to a file.            */
/*------------------------------------------------------*/
/* OUTPUT ARGUMENTS :  _ None.                         */
/*------------------------------------------------------*/
/* RETURN ARGUMENTS :  _ Length of the file in bytes.  */
/*======================================================*/


INT64   file_length ( FILE *file_ptr )
        {
            /*------------------------------------------*/


            INT64   file_size;


            /*------------------------------------------*/


            file_size = ftell(file_ptr);


            /*------------------------------------------*/


            return (file_size);


            /*------------------------------------------*/
        }


/*----------------------------------------------------------*/


/*==========================================================*/
/* FUNCTION      :   read_signal_double ()               */
/*----------------------------------------------------------*/
/* PURPOSE      :   This function reads short samples from a file */
/*                  stores them in an array of double.      */
/*----------------------------------------------------------*/
/* INPUT ARGUMENTS  :  _ Name of the signal file.          */
/*                     _ Number of samples.                */
/*----------------------------------------------------------*/
```

```
/* OUTPUT ARGUMENTS :  _ Array of double.                    */
/*-------------------------------------------------------*/
/* RETURN ARGUMENTS :  _ None.                           */
/*=======================================================*/


void     read_signal_double ( FILE *file_ptr, FLOAT64 *array, INT64 N )
         {
              /*--------------------------------------------*/


         INT16  *array_short;
         INT64  i;


              /*--------------------------------------------*/


         array_short = svector (0, N-1);

         if ( ( ( fread (array_short, sizeof (INT16), (INT32) N, file_ptr) ) !=

                         (size_t)N)
              nrerror ("error reading file ...");


         for ( i = 0; i < N; i ++ )
                   *(array+i) = (FLOAT64) (*(array_short+i));


         free_svector (array_short, 0, N-1);


              /*--------------------------------------------*/


         return;


              /*--------------------------------------------*/
         }


/*-------------------------------------------------------*/


/*=======================================================*/
/* FUNCTION    :   write_signal_double ()                */
/*-------------------------------------------------------*/
/* PURPOSE     :   This function writes short samples to a file */
/*                 from an array of double.                  */
```

```
/*-----------------------------------------------------*/
/* INPUT ARGUMENTS  : _ Array of double.                */
/*                    _ Number of samples.              */
/*-----------------------------------------------------*/
/* OUTPUT ARGUMENTS : _ Output short file.              */
/*-----------------------------------------------------*/
/* RETURN ARGUMENTS : _ None.                           */
/*=====================================================*/


void    write_signal_double ( FILE *file_ptr, FLOAT64 *array, INT64 N )
        {
        /*-----------------------------------------------------*/


        INT16  *array_short;
        INT64  i;


        /*-----------------------------------------------------*/


        array_short = svector (0, N-1);


        for ( i = 0; i < N; i ++ )
                *(array_short+i) = (INT16) nint (*(array+i));

        if ( ( fwrite (array_short, sizeof (INT16), (INT32) N, file_ptr) ) !=

                        (size_t)N)
                nrerror ("error writing file ...");


        free_svector (array_short, 0, N-1);


        /*-----------------------------------------------------*/


        return;


        /*-----------------------------------------------------*/
        }


/*-----------------------------------------------------*/


/*=====================================================*/
```

```
/* FUNCTION     :   get_int ().                      */
/*--------------------------------------------------*/
/* PURPOSE      :   These function read a value from a text file. */
/*--------------------------------------------------*/
/* INPUT ARGUMENTS :  _ file pointer.                */
/*--------------------------------------------------*/
/* OUTPUT ARGUMENTS :  _ (INT32*) val : output value.        */
/*--------------------------------------------------*/
/* RETURN ARGUMENTS :  _ None.                       */
/*==================================================*/


void     get_int ( FILE *file_ptr, INT32 *val )
         {
         /*--------------------------------------------------*/

         char     buffer [NB_MAX_CHAR];

         /*--------------------------------------------------*/

         fgets ( buffer, NB_MAX_CHAR, file_ptr );

         sscanf ( buffer, "%d", val );

         /*--------------------------------------------------*/

         return;

         /*--------------------------------------------------*/
         }


/*--------------------------------------------------*/


/*==================================================*/
/* FUNCTION     : get_two_int ().                    */
/*--------------------------------------------------*/
/* PURPOSE      : These function read two values from a text file. */
/*--------------------------------------------------*/
/* INPUT ARGUMENTS :  _ file pointer.                */
/*--------------------------------------------------*/
/* OUTPUT ARGUMENTS :                                */
```

```
/*            _ (INT32*) val1 : output value.        */
/*            _ (INT32*) val2 : output value.        */
/*-----------------------------------------------------*/
/* RETURN ARGUMENTS :  _ None.                        */
/*====================================================*/


void      get_two_int ( FILE *file_ptr, INT32 *val1, INT32 *val2 )
          {
          /*-------------------------------------------------*/


          char    buffer [NB_MAX_CHAR];


          /*-------------------------------------------------*/


          fgets ( buffer, NB_MAX_CHAR, file_ptr );

          sscanf ( buffer, "%d %d", val1, val2 );


          /*-------------------------------------------------*/


          return;


          /*-------------------------------------------------*/
          }


/*-----------------------------------------------------*/


/*====================================================*/
/* FUNCTION     :   get_long ().                      */
/*-----------------------------------------------------*/
/* PURPOSE      :    These function read a value from a text file. */
/*-----------------------------------------------------*/
/* INPUT ARGUMENTS  :  _ file pointer.                */
/*-----------------------------------------------------*/
/* OUTPUT ARGUMENTS :  _ (INT64*) val : output value.        */
/*-----------------------------------------------------*/
/* RETURN ARGUMENTS :  _ None.                        */
/*====================================================*/


void     get_long ( FILE *file_ptr, INT64 *val )
```

```
        {
        /*----------------------------------------------------*/

        char    buffer [NB_MAX_CHAR];

        /*----------------------------------------------------*/

        fgets ( buffer, NB_MAX_CHAR, file_ptr );

        sscanf ( buffer, "%ld", val );

        /*----------------------------------------------------*/

        return;

        /*----------------------------------------------------*/
        }

/*------------------------------------------------------------*/


/*==========================================================================*/
/* FUNCTION    :   get_float ().                        */
/*----------------------------------------------------------*/
/* PURPOSE     :    These function read a value from a text file. */
/*----------------------------------------------------------*/
/* INPUT ARGUMENTS  :  _ file pointer.                    */
/*----------------------------------------------------------*/
/* OUTPUT ARGUMENTS :  _ (FLOAT32*) val : output value.         */
/*----------------------------------------------------------*/
/* RETURN ARGUMENTS :  _ None.                        */
/*==========================================================================*/

void    get_FLOAT32 ( FILE *file_ptr, FLOAT32 *val )
        {
        /*----------------------------------------------------*/

        char    buffer [NB_MAX_CHAR];

        /*----------------------------------------------------*/
```

```
        fgets ( buffer, NB_MAX_CHAR, file_ptr );

        sscanf ( buffer, "%f", val );

        /*----------------------------------------------------------*/

        return;

        /*----------------------------------------------------------*/
        }


    /*----------------------------------------------------------------*/


    /*===============================================================================*/
    /* FUNCTION    :   get_double ().                      */
    /*-----------------------------------------------------------*/
    /* PURPOSE     :    These function read a value from a text file. */
    /*-----------------------------------------------------------*/
    /* INPUT ARGUMENTS  :  _ file pointer.                   */
    /*-----------------------------------------------------------*/
    /* OUTPUT ARGUMENTS :  _ (FLOAT64*) val : output value.       */
    /*-----------------------------------------------------------*/
    /* RETURN ARGUMENTS :  _ None.                     */
    /*===============================================================================*/

    void    get_double ( FILE *file_ptr, FLOAT64 *val )
            {
            /*----------------------------------------------------------*/

            char    buffer [NB_MAX_CHAR];

            /*----------------------------------------------------------*/

            fgets ( buffer, NB_MAX_CHAR, file_ptr );

            sscanf ( buffer, "%lf", val );

            /*----------------------------------------------------------*/
```

```
        return;


        /*--------------------------------------------------------------------*/
        }


/*--------------------------------------------------------------------------*/


/*==========================================================================*/
/* FUNCTION     :   ini_dvector ().                    */
/*--------------------------------------------------------------------*/
/* PURPOSE      :   This function initializes a vector of FLOAT64 */
/*              to a given value.                      */
/*--------------------------------------------------------------------*/
/* INPUT ARGUMENTS  :  _ (FLOAT64*) v vector of double.           */
/*              _ (INT32) nl                      */
/*              _ (INT32) nh                      */
/*              _ (FLOAT64) val                   */
/*--------------------------------------------------------------------*/
/* OUTPUT ARGUMENTS :  _ (FLOAT64*) initialized v vector.          */
/*--------------------------------------------------------------------*/
/* RETURN ARGUMENTS :  _ None.                         */
/*==========================================================================*/


void    ini_dvector ( FLOAT64 *v, INT32 nl, INT32 nh, FLOAT64 val )
        {
        /*--------------------------------------------------------------------*/


        INT32  i;


        /*--------------------------------------------------------------------*/


        for (i = nl; i <= nh; i ++)
             v [i] = val;


        /*--------------------------------------------------------------------*/


        return;


        /*--------------------------------------------------------------------*/
        }
```

```
/*--------------------------------------------------------------*/


/*==============================================================*/
/* FUNCTION      :   ini_svector ().                    */
/*--------------------------------------------------------------*/
/* PURPOSE       :   This function initializes a vector of INT16   */
/*                to a given value.                     */
/*--------------------------------------------------------------*/
/* INPUT ARGUMENTS  :  _ (INT16 *) v vector of int.          */
/*                _ (INT32  ) nl                     */
/*                _ (INT32  ) nh                     */
/*                _ (INT16  ) val                    */
/*--------------------------------------------------------------*/
/* OUTPUT ARGUMENTS :  _ (INT16 *) initialized v vector.        */
/*--------------------------------------------------------------*/
/* RETURN ARGUMENTS :  _ None.                          */
/*==============================================================*/


void     ini_svector ( INT16 *v, INT32 nl, INT32 nh, INT16 val )
         {
         /*--------------------------------------------------------*/


         INT32  i;


         /*--------------------------------------------------------*/


         for (i = nl; i <= nh; i ++)
                v [i] = val;


         /*--------------------------------------------------------*/


         return;


         /*--------------------------------------------------------*/
         }


/*--------------------------------------------------------------*/
```

```
/*=====================================================================*/
/* FUNCTION     :   ini_ivector ().                    */
/*-------------------------------------------------------------------*/
/* PURPOSE      :   This function initializes a vector of INT32   */
/*               to a given value.                     */
/*-------------------------------------------------------------------*/
/* INPUT ARGUMENTS :  _ (INT32 *) v vector of int.           */
/*               _ (INT32  ) nl                        */
/*               _ (INT32  ) nh                        */
/*               _ (INT32  ) val                       */
/*-------------------------------------------------------------------*/
/* OUTPUT ARGUMENTS :  _ (INT32 *) initialized v vector.        */
/*-------------------------------------------------------------------*/
/* RETURN ARGUMENTS :  _ None.                         */
/*=====================================================================*/


void     ini_ivector ( INT32 *v, INT32 nl, INT32 nh, INT32 val )
         {
         /*-------------------------------------------------------*/

         INT32  i;

         /*-------------------------------------------------------*/

         for (i = nl; i <= nh; i ++)
              v [i] = val;

         /*-------------------------------------------------------*/

         return;

         /*-------------------------------------------------------*/
         }

/*-----------------------------------------------------------------------*/


/*=====================================================================*/
/* FUNCTION     :   cpy_svector ().                    */
/*-------------------------------------------------------------------*/
/* PURPOSE      :   This function writes v1 to v2.             */
```

```
/*------------------------------------------------*/
/* INPUT ARGUMENTS  :  _ (INT16 *) v1 vector of short.        */
/*            _ (INT16 *) v2 vector of short.        */
/*            _ (INT32) nl                */
/*            _ (INT32) nh                */
/*------------------------------------------------*/
/* OUTPUT ARGUMENTS :  _ (INT16*) new v2 vector.        */
/*------------------------------------------------*/
/* RETURN ARGUMENTS :  _ None.                */
/*================================================*/


void    cpy_svector ( INT16 *v1, INT16 *v2, INT32 nl, INT32 nh )
        {
        /*----------------------------------------*/


        INT32  i;


        /*----------------------------------------*/


        for (i = nl; i <= nh; i ++)
            v2 [i] = v1 [i];


        /*----------------------------------------*/


        return;


        /*----------------------------------------*/
        }


/*------------------------------------------------*/



/*------------------------------------------------*/



/*================================================*/
/* FUNCTION    :   cpy_ivector ().            */
/*------------------------------------------------*/
/* PURPOSE     :    This function writes v1 to v2.        */
/*------------------------------------------------*/
/* INPUT ARGUMENTS  :  _ (INT32*) v1 vector of int.        */
```

```
/*              _ (INT32*) v2 vector of int.              */
/*              _ (INT32) nl                      */
/*              _ (INT32) nh                      */
/*---------------------------------------------------------*/
/* OUTPUT ARGUMENTS : _ (INT32*) new v2 vector.            */
/*---------------------------------------------------------*/
/* RETURN ARGUMENTS : _ None.                      */
/*=========================================================*/


void    cpy_ivector ( INT32 *v1, INT32 *v2, INT32 nl, INT32 nh )
        {
        /*-----------------------------------------------------*/


        INT32  i;


        /*-----------------------------------------------------*/


        for (i = nl; i <= nh; i ++)
                v2 [i] = v1 [i];


        /*-----------------------------------------------------*/


        return;


        /*-----------------------------------------------------*/
        }


/*---------------------------------------------------------*/


/*=========================================================*/
/* FUNCTION    :   cpy_dvector ().                 */
/*---------------------------------------------------------*/
/* PURPOSE     :   This function writes v1 to v2.          */
/*---------------------------------------------------------*/
/* INPUT ARGUMENTS  : _ (FLOAT64*) v1 vector of double.    */
/*              _ (FLOAT64*) v2 vector of double.      */
/*              _ (INT32) nl                      */
/*              _ (INT32) nh                      */
/*---------------------------------------------------------*/
/* OUTPUT ARGUMENTS : _ (FLOAT64*) new v2 vector.          */
```

```
/*-------------------------------------------------------*/
/* RETURN ARGUMENTS : _ None.                      */
/*=======================================================*/


void    cpy_dvector ( FLOAT64 *v1, FLOAT64 *v2, INT32 nl, INT32 nh )
        {
        /*-----------------------------------------------*/


        INT32  i;


        /*-----------------------------------------------*/


        for (i = nl; i <= nh; i ++)
                v2 [i] = v1 [i];


        /*-----------------------------------------------*/


        return;


        /*-----------------------------------------------*/
        }


/*-----------------------------------------------------------*/


/*===========================================================*/
/* FUNCTION     :   sfr_ivector ().               */
/*-----------------------------------------------------------*/
/* PURPOSE      :   This function shift rigth v elements of n   */
/*                position.                      */
/*-----------------------------------------------------------*/
/* INPUT ARGUMENTS  : _ (INT32 *) v1 vector of int.           */
/*                _ (INT32) n number of rigth shift       */
/*                _ (INT32) nl lower index            */
/*                _ (INT32) nh higher index           */
/*-----------------------------------------------------------*/
/* OUTPUT ARGUMENTS : _ (INT32 *) v2 shifted rigth v1 vector.    */
/*-----------------------------------------------------------*/
/* RETURN ARGUMENTS : _ None.                      */
/*===========================================================*/
```

```
void      sfr_ivector ( INT32 *v1, INT32 *v2, INT32 n, INT32 nl, INT32 nh )
          {
          /*------------------------------------------------------------*/

          INT32  i;


          /*------------------------------------------------------------*/


          for (i = nh-n; i >= nl; i --)
                  v2 [i+n] = v1 [i];


          /*------------------------------------------------------------*/


          return;


          /*------------------------------------------------------------*/
          }
/*------------------------------------------------------------*/


/*============================================================*/
/* FUNCTION     :   sfr_dvector ().                    */
/*------------------------------------------------------------*/
/* PURPOSE      :   This function shift roigth v elements of n   */
/*           ..    position.                           */
/*------------------------------------------------------------*/
/* INPUT ARGUMENTS  :  _ (FLOAT64*) v1 vector of double.        */
/*                     _ (INT32) n number of rigth shift        */
/*                     _ (INT32) nl lower index              */
/*                     _ (INT32) nh higher index            */
/*------------------------------------------------------------*/
/* OUTPUT ARGUMENTS :  _ (FLOAT64*) v2 shifted rigth v1 vector.   */
/*------------------------------------------------------------*/
/* RETURN ARGUMENTS :  _ None.                          */
/*============================================================*/


void      sfr_dvector ( FLOAT64 *v1, FLOAT64 *v2, INT32 n, INT32 nl, INT32 nh )
          {
          /*------------------------------------------------------------*/


          INT32  i;
```

```
/*--------------------------------------------------------------*/

for (i = nh-n; i >= nl; i --)
        v2 [i+n] = vl [i];

/*--------------------------------------------------------------*/

return;

/*--------------------------------------------------------------*/
}

/*--------------------------------------------------------------*/

/*==============================================================*/
/* FUNCTION     :   rev_dvector ().                     */
/*--------------------------------------------------------------*/
/* PURPOSE      :   This function reverse the order of the    */
/*                  elements of a vector.                 */
/*--------------------------------------------------------------*/
/* INPUT ARGUMENTS  :  _ (FLOAT64*) vl vector of double.        */
/*                     _ (INT32) nl lower index            */
/*                     _ (INT32) nh higher index           */
/*--------------------------------------------------------------*/
/* OUTPUT ARGUMENTS :  _ (FLOAT64*) v2 reversed vl vector.      */
/*--------------------------------------------------------------*/
/* RETURN ARGUMENTS :  _ None.                          */
/*==============================================================*/

void    rev_dvector ( FLOAT64 *vl, FLOAT64 *v2, INT32 nl, INT32 nh )
        {
        /*--------------------------------------------------------------*/

        INT32  i;

        /*--------------------------------------------------------------*/

        for (i = nl; i <= nh; i++)
                v2 [i] = vl [nh-i];
```

169

```
/*----------------------------------------------------*/

    return;

/*----------------------------------------------------*/

}


/*----------------------------------------------------*/


/*================================================================*/
/* FUNCTION    :   sca_dvector ().              */
/*----------------------------------------------------*/
/* PURPOSE     :    This function scale v1 into v2 by the factor */
/*              s.                    */
/*----------------------------------------------------*/
/* INPUT ARGUMENTS :  _ (FLOAT64*) v1 vector of double.       */
/*              _ (FLOAT64)  s  scale factor.          */
/*              _ (INT32) nl                 */
/*              _ (INT32) nh                 */
/*----------------------------------------------------*/
/* OUTPUT ARGUMENTS :  _ (FLOAT64*) v2 scaled vector.       */
/*----------------------------------------------------*/
/* RETURN ARGUMENTS :  _ None.                 */
/*================================================================*/


void    sca_dvector ( FLOAT64 *v1, FLOAT64 s, FLOAT64 *v2, INT32 nl, INT32 nh )
        {
        /*----------------------------------------------------*/

        INT32  i;


        /*----------------------------------------------------*/


        for (i = nl; i <= nh; i ++)
                v2 [i] = s * v1 [i];


        /*----------------------------------------------------*/


        return;
```

```
/*-------------------------------------------------------*/
        }

/*-------------------------------------------------------*/


/*=======================================================*/
/* FUNCTION      :   dot_dvector ().                    */
/*-------------------------------------------------------*/
/* PURPOSE       :   This function calculate the dot product    */
/*                   between v1 and v2                 */
/*-------------------------------------------------------*/
/* INPUT ARGUMENTS :  _ (FLOAT64*) v1 vector of double.      */
/*                 _ (FLOAT64*) v2 vector of double.      */
/*                 _ (INT32) nl                        */
/*                 _ (INT32) nh                        */
/*-------------------------------------------------------*/
/* OUTPUT ARGUMENTS :                                   */
/*                 _ (FLOAT64 *) s  dot product.          */
/*-------------------------------------------------------*/
/* RETURN ARGUMENTS : _ None.                          */
/*=======================================================*/


void    dot_dvector ( FLOAT64 *v1, FLOAT64 *v2, FLOAT64 *s, INT32 nl, INT32 nh )
        {
        /*-------------------------------------------------------*/


        INT32  i;


        /*-------------------------------------------------------*/


        (*s) = 0.0;


        for (i = nl; i <= nh; i ++)
               (*s) += v1 [i] * v2 [i];


        /*-------------------------------------------------------*/


        return;
```

```
/*-----------------------------------------------------*/
        }

/*-------------------------------------------------------------*/


/*===========================================================================*/
/* FUNCTION     :   add_dvector ().                    */
/*---------------------------------------------------------*/
/* PURPOSE      :   This function adds v1 to v2 in v.       */
/*---------------------------------------------------------*/
/* INPUT ARGUMENTS  :  _ (FLOAT64*) v1 vector of double.           */
/*              _ (FLOAT64*) v2 vector of double.          */
/*              _ (INT32) nl                   */
/*              _ (INT32) nh                   */
/*---------------------------------------------------------*/
/* OUTPUT ARGUMENTS :  _ (FLOAT64*) v=v1+v2 vector.             */
/*---------------------------------------------------------*/
/* RETURN ARGUMENTS :  _ None.                     */
/*===========================================================================*/


void     add_dvector (FLOAT64 *v1, FLOAT64 *v2, FLOAT64 *v, INT32 nl, INT32 nh )
        {
        /*---------------------------------------------------*/


        INT32  i;


        /*---------------------------------------------------*/


        for (i = nl; i <= nh; i ++)
                v [i] = v1 [i] + v2 [i];


        /*---------------------------------------------------*/


        return;


        /*---------------------------------------------------*/
        }

/*-------------------------------------------------------------*/
```

172

```
/*==============================================================*/
/* FUNCTION    :   wad_dvector ().                 */
/*----------------------------------------------*/
/* PURPOSE       :    This function adds v1 to v2 in v.      */
/*----------------------------------------------*/
/* INPUT ARGUMENTS  :  _ (FLOAT64*) v1 vector of double.         */
/*             _ (FLOAT64 ) w1 weigth for v1.         */
/*             _ (FLOAT64*) v2 vector of double.        */
/*             _ (FLOAT64 ) w2 weigth for v2.        */
/*             _ (INT32) nl                 */
/*             _ (INT32) nh                 */
/*----------------------------------------------*/
/* OUTPUT ARGUMENTS :  _ (FLOAT64*) v = w1 * v1 + w2 * v2 vector.   */
/*----------------------------------------------*/
/* RETURN ARGUMENTS :  _ None.                 */
/*==============================================================*/


void    wad_dvector ( FLOAT64 *v1, FLOAT64 w1, FLOAT64 *v2, FLOAT64 w2,
                              FLOAT64 *v, INT32 nl, INT32 nh )
        {
        /*----------------------------------------------*/


        INT32  i;


        /*----------------------------------------------*/


        for (i = nl; i <= nh; i ++)
                v [i] = w1 * v1 [i] + w2 * v2 [i];


        /*----------------------------------------------*/


        return;


        /*----------------------------------------------*/
        }


/*----------------------------------------------*/


/*==============================================================*/
/* FUNCTION    :   mul_dvector ().                 */
```

```
/*----------------------------------------------------------*/
/* PURPOSE     :   This function multiply v1 by v2 in v.     */
/*----------------------------------------------------------*/
/* INPUT ARGUMENTS :  _ (FLOAT64*) v1 vector of double.       */
/*                    _ (FLOAT64*) v2 vector of double.       */
/*                    _ (INT32) nl                            */
/*                    _ (INT32) nh                            */
/*----------------------------------------------------------*/
/* OUTPUT ARGUMENTS :  _ (FLOAT64*) v=v1*v2 vector.           */
/*----------------------------------------------------------*/
/* RETURN ARGUMENTS :  _ None.                                */
/*==========================================================*/


void    mul_dvector (FLOAT64 *v1, FLOAT64 *v2, FLOAT64 *v, INT32 nl, INT32 nh )
        {
        /*------------------------------------------------*/

        INT32  i;


        /*------------------------------------------------*/


        for (i = nl; i <= nh; i ++)
                v [i] = v1 [i] * v2 [i];


        /*------------------------------------------------*/


        return;


        /*------------------------------------------------*/
        }


/*----------------------------------------------------------*/


/*==========================================================*/
/* FUNCTION    :   dif_dvector ().                           */
/*----------------------------------------------------------*/
/* PURPOSE     :   This function substracts v2 to v1 into v. */
/*----------------------------------------------------------*/
/* INPUT ARGUMENTS :  _ (FLOAT64*) v1 vector of double.       */
/*                    _ (FLOAT64*) v2 vector of double.       */
```

```
/*            _ (INT32) nl                    */
/*            _ (INT32) nh                    */
/*_____*/
/* OUTPUT ARGUMENTS : _ (FLOAT64*) v=v1-v2 vector.      */
/*_____*/
/* RETURN ARGUMENTS : _ None.                */
/*===========================================*/


void    dif_dvector (FLOAT64 *v1, FLOAT64 *v2, FLOAT64 *v, INT32 nl, INT32 nh )
        {
        /*_____*/
        .

        INT32  i;


        /*_____*/


        for (i = nl; i <= nh; i ++)
                v [i] = v1 [i] - v2 [i];


        /*_____*/


        return;


        /*_____*/
        }


/*_____*/



/*===========================================*/
/* FUNCTION    :   cml_dvector ().            */
/*_____*/
/* PURPOSE     :   This function accumulates v2 to v1.   */
/*_____*/
/* INPUT ARGUMENTS  : _ (FLOAT64*) v1 vector of double.     */
/*            _ (FLOAT64*) v2 vector of double.      */
/*            _ (INT32) nl                    */
/*            _ (INT32) nh                    */
/*_____*/
/* OUTPUT ARGUMENTS : _ (FLOAT64*) new v1=v1+v2 vector.    */
/*_____*/
```

```
/* RETURN ARGUMENTS : _ None.                              */
/*=================================================================*/


void     cml_dvector ( FLOAT64 *v1, FLOAT64 *v2, INT32 nl, INT32 nh )
         {
         /*--------------------------------------------------------*/


         INT32  i;


         /*--------------------------------------------------------*/


         for (i = nl; i <= nh; i ++)
                 v1 [i] += v2 [i];


         /*--------------------------------------------------------*/


         return;


         /*--------------------------------------------------------*/
         }


/*--------------------------------------------------------*/



/*=================================================================*/
/* FUNCTION     :   cml_svector ().                        */
/*--------------------------------------------------------*/
/* PURPOSE      :   This function accumulates v2 to v1.    */
/*--------------------------------------------------------*/
/* INPUT ARGUMENTS  : _ (INT16*) v1 vector of short.          */
/*                _ (INT16*) v2 vector of short.           */
/*                _ (INT32) nl                     */
/*                _ (INT32) nh                     */
/*--------------------------------------------------------*/
/* OUTPUT ARGUMENTS : _ (FLOAT64*) new v1=v1+v2 vector.        */
/*--------------------------------------------------------*/
/* RETURN ARGUMENTS : _ None.                              */
/*=================================================================*/


void     cml_svector ( INT16 *v1, INT16 *v2, INT32 nl, INT32 nh )
         {
```

```
        /*----------------------------------------------------*/


        INT32  i;


        /*----------------------------------------------------*/


        for (i = nl; i <= nh; i ++)
                v1 [i] += v2 [i];


        /*----------------------------------------------------*/


        return;


        /*----------------------------------------------------*/
        }


    /*----------------------------------------------------*/


    /*================================================================*/
    /* FUNCTION      :   max_dvector ().                    */
    /*----------------------------------------------------*/
    /* PURPOSE       :   This function finds the maximum of v.      */
    /*----------------------------------------------------*/
    /* INPUT ARGUMENTS :  _ (FLOAT64*) v vector of double.       */
    /*                 _ (INT32)   nl                  */
    /*                 _ (INT32)   nh                  */
    /*----------------------------------------------------*/
    /* OUTPUT ARGUMENTS :  _ (FLOAT64*) max.                 */
    /*----------------------------------------------------*/
    /* RETURN ARGUMENTS :  _ None.                      */
    /*================================================================*/


    void    max_dvector ( FLOAT64 *v, FLOAT64 *max, INT32 nl, INT32 nh )
            {
            /*----------------------------------------------------*/


            INT32  i;


            /*----------------------------------------------------*/
```

```
for ( i = nl+1, *max = *(v+nl); i <= nh; i ++ )
        *max = ((*(v+i) > *max) ? *(v+i) : *max);


        /*---------------------------------------------------*/


        return;


        /*---------------------------------------------------*/
        }


/*---------------------------------------------------------*/



/*=========================================================*/
/* FUNCTION    :   min_dvector ().                  */
/*---------------------------------------------------*/
/* PURPOSE     :   This function finds the minimum of v.    */
/*---------------------------------------------------*/
/* INPUT ARGUMENTS  :  _ (FLOAT64*) v vector of double.        */
/*              _ (INT32)   nl                  */
/*              _ (INT32)   nh                  */
/*---------------------------------------------------*/
/* OUTPUT ARGUMENTS :  _ (FLOAT64*) min.                */
/*---------------------------------------------------*/
/* RETURN ARGUMENTS :  _ None.                      */
/*=========================================================*/


void    min_dvector ( FLOAT64 *v, FLOAT64 *min, INT32 nl, INT32 nh )
        {
        /*---------------------------------------------------*/


        INT32  i;


        /*---------------------------------------------------*/


for ( i = nl+1, *min = *(v+nl); i <= nh; i ++ )
        *min = ((*(v+i) < *min) ? *(v+i) : *min);


        /*---------------------------------------------------*/


        return;
```

```
        /*---------------------------------------------*/

        }


/*---------------------------------------------------*/


/*=================================================================*/

/* FUNCTION    :   limit_dvector ().            */

/*-----------------------------------------------*/

/* PURPOSE     :    This function limits the range of v.      */

/*-----------------------------------------------*/

/* INPUT ARGUMENTS  :  _ (FLOAT64*) v vector of double.        */

/*              _ (INT32)   nl                */

/*              _ (INT32)   nh                */

/*              _ (FLOAT64)  min               */

/*              _ (FLOAT64)  max               */

/*-----------------------------------------------*/

/*-----------------------------------------------*/

/* RETURN ARGUMENTS :  _ None.                  */

/*=================================================================*/


void    limit_dvector ( FLOAT64 *v, INT32 nl, INT32 nh, FLOAT64 min, FLOAT64 max )
        {
        /*---------------------------------------------------*/


        INT32  i;


        /*---------------------------------------------------*/


        for ( i = nl; i <= nh; i ++ )
            {
            *(v+i) = ((*(v+i) < min) ? min : *(v+i));
            *(v+i) = ((*(v+i) > max) ? max : *(v+i));
            }


        /*---------------------------------------------------*/


        return;


        /*---------------------------------------------------*/
```

```
        }

/*================================================================*/
/*-------------------------- END --------------------------------*/
/*================================================================*/
```

```
/*===============================================================*/


/*===============================================================*/
/* Conexant System Inc.                          */
/* 4311 Jamboree Road                            */
/* Newport Beach, CA 92660                         */
/*--------------------------------------------------*/
/* Copyright(C) 2000 Conexant System Inc.               */
/*--------------------------------------------------*/
/* ALL RIGHTS RESERVED:                          */
/* No part of this software may be reproduced in any form or by any */
/* means or used to make any derivative work (such as transformation */
/* or adaptation) without the authorisation of Conexant System Inc.  */
/*===============================================================*/
/* PROTOYPE FILE : gputil.h                       */
/*===============================================================*/


/*--------------------------------------------------*/
/*----------------------- FUNCTIONS -----------------------*/
/*--------------------------------------------------*/


FILE    *file_open_r        ( char * );
FILE    *file_open_w        ( char * );
FILE    *file_open_rb       .   ( char * );
FILE    *file_open_wb       ( char * );


void    output_waves_file   ( char *, FLOAT64 *, INT32, \
                                    FLOAT64, FLOAT64, FLOAT64 );


INT64   file_length         ( FILE * );


void    read_signal_double  ( FILE *, FLOAT64 *, INT64 );
void    write_signal_double ( FILE *, FLOAT64 *, INT64 );


void    get_int             ( FILE *file_ptr, INT32   *val );
void    get_long            ( FILE *file_ptr, INT64   *val );
void    get_float           ( FILE *file_ptr, FLOAT32 *val );
void    get_double          ( FILE *file_ptr, FLOAT64 *val );


void    get_two_int         ( FILE *file_ptr, INT32 *, INT32 * );
```

181

```
void    ini_svector      ( INT16 *, INT32, INT32, INT16);
void    ini_ivector      ( INT32 *, INT32, INT32, INT32);
void    ini_dvector          ( FLOAT64 *, INT32, INT32, FLOAT64 );
void    cpy_svector          ( INT16 *, INT16 *, INT32, INT32 );
void    cpy_ivector          ( INT32 *, INT32 *, INT32, INT32 );
void    cpy_dvector          ( FLOAT64 *, FLOAT64 *, INT32, INT32 );


void    rev_dvector          ( FLOAT64 *, FLOAT64 *, INT32, INT32);
void    sfr_dvector          ( FLOAT64 *, FLOAT64 *, INT32, INT32, INT32);
void    sfr_ivector      ( INT32 *, INT32 *, INT32, INT32, INT32);
void    sca_dvector          ( FLOAT64 *, FLOAT64, FLOAT64 *, INT32, INT32);
void    dot_dvector          ( FLOAT64 *, FLOAT64 *, FLOAT64 *, INT32, INT32);


void    cml_dvector          ( FLOAT64 *, FLOAT64 *, INT32, INT32 );
void    cml_svector          ( INT16 * , INT16 * , INT32, INT32 );
void    max_dvector          ( FLOAT64 *, FLOAT64 *, INT32, INT32 );
void    min_dvector          ( FLOAT64 *, FLOAT64 *, INT32, INT32 );
void    add_dvector          ( FLOAT64 *, FLOAT64 *, FLOAT64 *, INT32, INT32 );
void    wad_dvector      ( FLOAT64 *, FLOAT64, FLOAT64 *, FLOAT64,
                                 FLOAT64 *, INT32, INT32);
void    mul_dvector          ( FLOAT64 *, FLOAT64 *, FLOAT64 *, INT32, INT32 );


void    dif_dvector          ( FLOAT64 *, FLOAT64 *, FLOAT64 *, INT32, INT32 ); .


void    limit_dvector    ( FLOAT64 *, INT32, INT32, FLOAT64, FLOAT64 );


/*==================================================================*/
/*---------------------- END -----------------------*/
/*==================================================================*/
```

```
/*=========================================================================*/


/*=========================================================================*/
/* Conexant System Inc.                          */
/* 4311 Jamboree Road                            */
/* Newport Beach, CA 92660                        */
/*------------------------------------------------*/
/* Copyright(C) 2000 Conexant System Inc.              */
/*------------------------------------------------*/
/* ALL RIGHTS RESERVED:                            */
/* No part of this software may be reproduced in any form or by any  */
/* means or used to make any derivative work (such as transformation */
/* or adaptation) without the authorisation of Conexant System Inc.  */
/*=========================================================================*/
/* PROTOTYPE FILE: lib_bit.c                     */
/*=========================================================================*/


/*------------------------------------------------*/
/*--------------------- INCLUDE ------------------*/
/*------------------------------------------------*/


#include "typedef.h"
#include "main.h"
#include "const.h"
#include "ext_var.h"

#include "gputil.h"
#include "mcutil.h"
#include "lib_bit.h"


/*------------------------------------------------*/
/*-------------------- FUNCTIONS -----------------*/
/*------------------------------------------------*/


/*=========================================================================*/
/* FUNCTION  : BIT_init_lib ().                  */
/*------------------------------------------------*/
/* PURPOSE   : Performs the bit packing library initialisation.    */
/*------------------------------------------------*/
/* ALGORITHM :                                  */
```

```c
/*----------------------------------------------------*/
/* INPUT ARGUMENTS :                    .        */
/*              _ None.                      */
/*----------------------------------------------------*/
/* OUTPUT ARGUMENTS :                        */
/*              _ None.                      */
/*----------------------------------------------------*/
/* INPUT/OUTPUT ARGUMENTS :                      */
/*              _ None.                      */
/*----------------------------------------------------*/
/* RETURN ARGUMENTS :                        */
/*              _ None.                      */
/*====================================================*/


void BIT_init_lib (void)
        {
        /*------------------------------------------*/

        bitno0[0] = 7;
        bitno0[1] = 6;
        bitno0[2] = 2;

        bitno1[0] = 4;
        bitno1[1] = 4;
        bitno1[2] = 3;


        /*------------------------------------------*/


        return;


        /*------------------------------------------*/
        }


/*----------------------------------------------------*/


/*====================================================*/
/* FUNCTION    : BIT_bitpack ().                */
/*----------------------------------------------------*/
/* PURPOSE     : This function converts the encoder indices into */
/*              the bit-stream.                */
```

```
/*---------------------------------------------------------------*/
/* INPUT ARGUMENTS :                              */
/*     _ (INT16 ) in:      input data.           */
/*     _ (INT16 ) NoOfBits:   number of bits.         */
/*---------------------------------------------------------------*/
/* OUTPUT ARGUMENTS :                             */
/*     _ (UNS_INT16 *) TrWords : trasmitted word.        */
/*     _ (INT16    *) ptr :    bit and word pointers.      */
/*---------------------------------------------------------------*/
/* INPUT/OUTPUT ARGUMENTS :                          */
/*               _ None.              */
/*---------------------------------------------------------------*/
/* RETURN ARGUMENTS :                             */
/*               _ None.                */
/*===============================================================*/


void   BIT_bitpack (INT16 in, UNS_INT16 *TrWords, INT16 NoOfBits,
               INT16 *ptr)
      {
      /*-------------------------------------------------------*/


      INT16   temp;
      UNS_INT16 *WordPtr;


      /*-------------------------------------------------------*/


      WordPtr = TrWords + ptr[1];


      *ptr -= NoOfBits;
      if (*ptr >= 0)
           *WordPtr = *WordPtr | (in << *ptr);
      else
           {
           temp = in >> (-*ptr);
           *WordPtr = *WordPtr | temp;
           WordPtr++;
           *ptr = 16 + *ptr;
           *WordPtr = (INT16) ((INT64) ((INT64) in << *ptr) & 0xffff);
           }
```

```
ptr[1] = (INT16) (WordPtr - TrWords);


        /*----------------------------------------------------------*/


        return;


        /*----------------------------------------------------------*/
        }


    /*----------------------------------------------------------*/



    /*========================================================================*/
    /* FUNCTION     :  BIT_bitunpack ().                    */
    /*----------------------------------------------------*/
    /* PURPOSE      :  This function converts the decoder bit-stream   */
    /*              into indices.                        */
    /*----------------------------------------------------*/
    /* INPUT ARGUMENTS :                           */
    /*      _ (UNS_INT16 *) RecWords : received word.            */
    /*      _ (INT16     ) NoOfBits : number of bits.          */
    /*----------------------------------------------------*/
    /* OUTPUT ARGUMENTS :                           */
    /*      _ (INT16 *) out:   output data.              */
    /*----------------------------------------------------*/
    /* INPUT/OUTPUT ARGUMENTS :                        */
    /*      _ (INT16 *) ptr:  bit and word pointers.          */
    /*----------------------------------------------------*/
    /* RETURN ARGUMENTS :                          */
    /*      _ None.                           */
    /*========================================================================*/


void   BIT_bitunpack (INT16 *out, UNS_INT16 *RecWords, INT16 NoOfBits,
                 INT16 *ptr)
        {
        /*----------------------------------------------------------*/


        INT64   temp;
        UNS_INT16 *WordPtr;


        /*----------------------------------------------------------*/
```

```
        WordPtr = RecWords + ptr[1];


        *ptr -= NoOfBits;
        if (*ptr >= 0)
                temp = (INT64) (*WordPtr) << NoOfBits;
        else
                {
                temp = (INT64) (*WordPtr) << (NoOfBits + *ptr);
                WordPtr++;
                temp = (temp << (-*ptr)) | ((INT64) *WordPtr << (-*ptr));
                *ptr = 16 + *ptr;
                }


        *WordPtr = (INT16) (temp & 0xffff);
        *out = (INT16) ((INT64) (temp & 0xffff0000) >> 16);


        ptr[1] = (INT16) (WordPtr - RecWords);


        /*-----------------------------------------------------*/


        return;


        /*-----------------------------------------------------*/
        }


/*-----------------------------------------------------*/


/*======================================================================*/
/* FUNCTION    : BIT_cdbk_index_to_bits ().              */
/*-----------------------------------------------------*/
/* PURPOSE     : This function converts the fixed codebook index */
/*               into the bit-stream representation.          */
/*-----------------------------------------------------*/
/* INPUT ARGUMENTS :                          */
/*      _ (PARAMETER *) indices   : fixed codebook indices.   */
/*-----------------------------------------------------*/
/* OUTPUT ARGUMENTS :                          */
/*      _ (INT16   []) packedwords: bit-stream.          */
/*-----------------------------------------------------*/
```

```
/* INPUT/OUTPUT ARGUMENTS :                              */
/*      _ (INT16   []) packw_ptr:  pointer to the bit-stream. */
/*----------------------------------------------------------*/
/* RETURN ARGUMENTS :                                    */
/*                  _ None.                        */
/*========================================================*/


void BIT_cdbk_index_to_bits (PARAMETER *chan, INT16 packedwords [],
                                         INT16 packw_ptr [])

    {
    /*-----------------------------------------------------*/


    INT16 i, i_sf;


    /*-----------------------------------------------------*/
    /*          Initalizing bit packing parameters         */
    /*-----------------------------------------------------*/


    packw_ptr[0] = 16;


    /*-----------------------------------------------------*/
    /*          Points to the second word                  */
    /*-----------------------------------------------------*/


    packw_ptr[1] = 1;


    ini_svector(packedwords, 0, PACKWDSNUM-1, 0);


    /*=====================================================*/
    /*xxxxxxxxxxxxxxxxxxxxxxxxxxxxxxx Slected bitrate xxxxxxxxxxxxxxxxxxxxxxxxxxxxxxx*/
    /*=====================================================*/


    switch (chan->fix_rate)
        {
        case RATE8_5K: packedwords[0] = 4;
                break;

        case RATE4_0K: packedwords[0] = 3;
                break;
```

```
        case RATE2_0K: packedwords[0] = 2;
                break;

        case RATE0_8K: packedwords[0] = 1;
                break;

        default: nrerror("Invalid rate !!");
                break;
        }


/*==================================================================*/
/*□□□□□□□□□□□□□□□□□□□□□□□ Classification index □□□□□□□□□□□□□□□□□□□□□□□*/
/*==================================================================*/


if ((chan->fix_rate == RATE8_5K) || (chan->fix_rate==RATE4_0K))
        BIT_bitpack(chan->idx_SVS_deci, (unsigned short *) packedwords,
                                                1, packw_ptr);


/*==================================================================*/
/*□□□□□□□□□□□□□□□□□□□□□□□□ LSF quantizer index □□□□□□□□□□□□□□□□□□□□□□□□*/
/*==================================================================*/


switch (chan->fix_rate)
        {
        /*--------------------------------------------*/
        /*=============== case RATE8_5K ==============*/
        /*--------------------------------------------*/

        case RATE8_5K:
                /*--------------------------------------*/
                /*            25 bits              */
                /*--------------------------------------*/

                BIT_bitpack(chan->idx_lsf[0], (unsigned short *) packedwords,
                                                7, packw_ptr);

                BIT_bitpack(chan->idx_lsf[1], (unsigned short *) packedwords,
                                                6, packw_ptr);
                BIT_bitpack(chan->idx_lsf[2], (unsigned short *) packedwords,
                                                6, packw_ptr);
```

```
        BIT_bitpack(chan->idx_lsf[3], (unsigned short *) packedwords,
                                        6, packw_ptr);


        /*-----------------------------------------------*/
        /*          LSF interpolation  2 bits          */
        /*-----------------------------------------------*/


        if (chan->idx_SVS_deci == 0)
                BIT_bitpack(chan->idx_lpc_int,
                                (unsigned short *) packedwords, 2, packw_ptr);
        break;


    /*-----------------------------------------------*/
    /*================== case RATE4_0K ==================*/
    /*-----------------------------------------------*/


    case RATE4_0K:
        /*-----------------------------------------------*/
        /*              21 bits              */
        /*-----------------------------------------------*/


        BIT_bitpack(chan->idx_lsf[0], (unsigned short *) packedwords,
                                        7, packw_ptr);


        BIT_bitpack(chan->idx_lsf[1], (unsigned short *) packedwords,
                                        7, packw_ptr);


        BIT_bitpack(chan->idx_lsf[2], (unsigned short *) packedwords,
                                        6, packw_ptr);


        BIT_bitpack(chan->idx_lsf[3], (unsigned short *) packedwords,
                                        1, packw_ptr);
        break;


    /*-----------------------------------------------*/
    /*================== case RATE2_0K ==================*/
    /*-----------------------------------------------*/


    case RATE2_0K:
```

```
/*------------------------------------------------*/
/*                25 bits                  */
/*------------------------------------------------*/


    BIT_bitpack(chan->idx_lsf[0], (unsigned short *) packedwords,
                                        7, packw_ptr);


    BIT_bitpack(chan->idx_lsf[1], (unsigned short *) packedwords,
                                        6, packw_ptr);


    BIT_bitpack(chan->idx_lsf[2], (unsigned short *) packedwords,
                                        6, packw_ptr);


    BIT_bitpack(chan->idx_lsf[3], (unsigned short *) packedwords,
                                        6, packw_ptr);



/*------------------------------------------------*/
/*          LSF interpolation  2 bits         */
/*------------------------------------------------*/


    BIT_bitpack(chan->idx_lpc_int, (unsigned short *) packedwords,
                                        2, packw_ptr);
    break;


/*------------------------------------------------*/
/*================ case RATE0_8K ================*/
/*------------------------------------------------*/


case RATE0_8K:


/*------------------------------------------------*/
/*                11 bits                  */
/*------------------------------------------------*/


    BIT_bitpack(chan->idx_lsf[0], (unsigned short *) packedwords,
                                        4, packw_ptr);


    BIT_bitpack(chan->idx_lsf[1], (unsigned short *) packedwords,
                                        4, packw_ptr);
```

```
                    BIT_bitpack(chan->idx_lsf[2], (unsigned short *) packedwords,
                                                          3, packw_ptr);

          break;


       default: nrerror ("Invalid rate !!");


          break;                  .
       }


/*=================================================================*/
/*□□□□□□□□□□□□□□□□□□□□□□□□□□□□□□□ Pitch index □□□□□□□□□□□□□□□□□□□□□□□□□□□□□□□*/
/*=================================================================*/


if ((chan->fix_rate == RATE8_5K) || (chan->fix_rate == RATE4_0K))
       {
       if (chan->idx_SVS_deci == 1)
              {
              if (chan->fix_rate == RATE8_5K)
                     BIT_bitpack(chan->idx_pitch[0],
                            (unsigned short *) packedwords, 8, packw_ptr);
              else if (chan->fix_rate==RATE4_0K)
                     BIT_bitpack(chan->idx_pitch[0],
                            (unsigned short *) packedwords, 7, packw_ptr);


              }
       else
              {
              if (chan->fix_rate == RATE8_5K)
                     {
                     BIT_bitpack(chan->idx_pitch[0],
                            (unsigned short *) packedwords, 8, packw_ptr);

                     BIT_bitpack(chan->idx_pitch[1],
                            (unsigned short *) packedwords, 5, packw_ptr);

                     BIT_bitpack(chan->idx_pitch[2],
                            (unsigned short *) packedwords, 8, packw_ptr);

                     BIT_bitpack(chan->idx_pitch[3],
                            (unsigned short *) packedwords, 5, packw_ptr);
```

```
                }
        else if (chan->fix_rate==RATE4_0K)
                {
                for (i = 0; i < N_SF2; i++)
                        BIT_bitpack(chan->idx_pitch[i],
                                (unsigned short *) packedwords, 7, packw_ptr);
                }
        }
}


/*===========================================================================*/
/*ꙨꙨꙨꙨꙨꙨꙨꙨꙨꙨꙨꙨꙨꙨꙨꙨꙨꙨꙨꙨꙨ Gains index ꙨꙨꙨꙨꙨꙨꙨꙨꙨꙨꙨꙨꙨꙨꙨꙨꙨꙨꙨꙨꙨ*/
/*===========================================================================*/


switch (chan->fix_rate)
        {
        /*-------------------------------------------------*/
        /*================== case RATE8_5K ================*/
        /*-------------------------------------------------*/

        case RATE8_5K:
                if (chan->idx_SVS_dcci==1)
                        {
                        BIT_bitpack(chan->idx_Gp_VQ,
                                (unsigned short *) packedwords, 6, packw_ptr);

                        BIT_bitpack(chan->idx_Gc_VQ,
                                (unsigned short *) packedwords, 10, packw_ptr);
                        }
                else
                        {
                        for (i = 0; i < N_SF4; i++)
                                BIT_bitpack(chan->idx_gainVQ[i],
                                        (unsigned short *) packedwords, 7, packw_ptr);
                        }
                break;

        /*-------------------------------------------------*/
        /*================== case RATE4_0K ================*/
        /*-------------------------------------------------*/
```

```
case RATE4_0K:
        if (chan->idx_SVS_deci==1)
                {
                BIT_bitpack(chan->idx_Gp_VQ,
                        (unsigned short *) packedwords, 4, packw_ptr);

                BIT_bitpack(chan->idx_Gc_VQ,
                        (unsigned short *) packedwords, 8, packw_ptr);
                }
        else
                {
                for (i = 0; i < N_SF2; i++)
                        BIT_bitpack(chan->idx_gainVQ[i],
                                (unsigned short *) packedwords, 7, packw_ptr);
                }

        break;


/*----------------------------------------------*/
/*================= case RATE2_0K ===================*/
/*----------------------------------------------*/


case RATE2_0K:
        for (i = 0; i < N_SF2; i++)
                BIT_bitpack(chan->idx_gainVQ[i],
                        (unsigned short *) packedwords, 6, packw_ptr);
        break;


case RATE0_8K:
                BIT_bitpack(chan->idx_gainVQ[0],
                        (unsigned short *) packedwords, 5, packw_ptr);
        break;


default: nrerror("Invalid rate !!");
        break;
}


/*================================================*/
/*================= Codeboks index ================*/
```

```
/*===============================================================*/

       switch (chan->fix_rate)
              {
              /*---------------------------------------------*/
              /*=============== case RATE8_5K ================*/
              /*---------------------------------------------*/

              case RATE8_5K :

              if (chan->idx_SVS_deci == 1)
                     {
                     /*---------------------------------------*/
                     /*         Stationary voiced speech       */
                     /*---------------------------------------*/

                     for (i_sf = 0; i_sf < N_SF4; i_sf++)
                            {
                            /*-------------------------------*/
                     /* 8 pulses CB : 6p x 3b + 2p x 4b + 4b signs = 30 bits  */
                            /*-------------------------------*/

                            for (i = 0; i < 4; i++)
                                   BIT_bitpack((chan->idx_cpcbsign[i_sf][i]),
                                                 (UNS_INT16 *) packedwords, 1,
packw_ptr);

                            BIT_bitpack((chan->idx_cpcb[i_sf][0]),
                                                 (UNS_INT16 *) packedwords, 4,
packw_ptr);

                            for (i = 1; i < 4; i++)
                                   BIT_bitpack((chan->idx_cpcb[i_sf][i]),
                                                 (UNS_INT16 *) packedwords, 3,
packw_ptr);

                            BIT_bitpack((chan->idx_cpcb[i_sf][4]),
                                                 (UNS_INT16 *) packedwords, 4,
packw_ptr);
                            for (i = 5; i < 8; i++)
```

```
                BIT_bitpack((chan->idx_cpcb[i_sf][i]),
                                  (UNS_INT16 *) packedwords, 3, packw_ptr);
                    }
              /*----------------------------------------------------*/
              }
          else
              {
              /*----------------------------------------------------*/
              /*          Non-Stationary voiced speech          */
              /*----------------------------------------------------*/

              for (i_sf = 0; i_sf < N_SF4; i_sf++)
                    {
                    BIT_bitpack((chan->idx_subcpcb[i_sf][0]),
                                      (UNS_INT16 *) packedwords, 1, packw_ptr);

                    if (chan->idx_subcpcb[i_sf][0]==1)
                        {
                        /*--------------------------------------*/
                        /* 5 pulses CB : 3p x 4b + 2p x 3b + 3b signs   */
                        /*          = 21 bits                 */
                        /*--------------------------------------*/

                        for (i = 0; i < 3; i++)
                                BIT_bitpack((chan->idx_cpcbsign[i_sf][i]),
                                      (UNS_INT16 *) packedwords, 1, packw_ptr);

                        BIT_bitpack((chan->idx_cpcb[i_sf][0]),
                                      (UNS_INT16 *) packedwords, 4, packw_ptr);

                        BIT_bitpack((chan->idx_cpcb[i_sf][1]),
                                      (UNS_INT16 *) packedwords, 4, packw_ptr);

                        BIT_bitpack((chan->idx_cpcb[i_sf][2]),
                                      (UNS_INT16 *) packedwords, 3, packw_ptr);

                        BIT_bitpack((chan->idx_cpcb[i_sf][3]),
                                      (UNS_INT16 *) packedwords, 4, packw_ptr);

                        BIT_bitpack((chan->idx_cpcb[i_sf][4]),
```

```
                                    (UNS_INT16 *) packedwords, 3, packv_ptr);
                 }
          else
          {
              BIT_bitpack((chan->idx_subcpcb[i_sf][1]),
                                    (UNS_INT16 *) packedwords, 1, packw_ptr);


              /*-------------------------------------------*/
              /*      5 pulses CB : 5p x 3b + 5b signs     */
              /*               = 20 bits                   */
              /*-------------------------------------------*/


              for (i = 0; i < 5; i++)
                 {
        BIT_bitpack((chan->idx_cpcbsign[i_sf][i]),
              (UNS_INT16 *) packedwords, 1, packw_ptr);
        BIT_bitpack((chan->idx_cpcb[i_sf][i]),
              (UNS_INT16 *) packedwords, 3, packw_ptr);
                 }
              }
          }
     }
break;


/*-------------------------------------------*/
/*================== case RATE4_0K =====================*/
/*-------------------------------------------*/


case RATE4_0K :

if (chan->idx_SVS_deci==1)
     {
     /*-------------------------------------------*/
     /*          Stationary voiced speech          */
     /*-------------------------------------------*/


     for (i_sf = 0; i_sf < N_SF3; i_sf++)
          {
          BIT_bitpack((chan->idx_subcpcb[i_sf][0]),
                                    (UNS_INT16 *) packedwords, 1, packw_ptr);
```

```
if (chan->idx_subcpcb[i_sf][0] == 1)
        {
        /*--------------------------------------------*/
        /* 2 pulses CB : 2pulses x 5bits/pulse + 2 signs */
        /*             = 12 bits              */
        /*--------------------------------------------*/

        for (i = 0; i < 2; i++)
                {
                BIT_bitpack((chan->idx_cpcbsign[i_sf][i]),
                        (UNS_INT16 *) packedwords, 1, packw_ptr);
                BIT_bitpack((chan->idx_cpcb[i_sf][i]),
                        (UNS_INT16 *) packedwords, 5, packw_ptr);
                }
        }
else
        {
        /*--------------------------------------------*/
        /*   3 pulses CB :  3 pulses x 2 bits/pulse +   */
        /*   3 signs + 3bits center = 12 bits       */
        /*--------------------------------------------*/

        for (i = 0; i < 3; i++)
                {
                BIT_bitpack((chan->idx_cpcbsign[i_sf][i]),
                        (UNS_INT16 *) packedwords, 1, packw_ptr);
                BIT_bitpack((chan->idx_cpcb[i_sf][i]),
                        (UNS_INT16 *) packedwords, 2, packw_ptr);
                }
        BIT_bitpack((chan->idx_center[i_sf]),
                (UNS_INT16 *) packedwords, 3, packw_ptr);
        }
        }
else
        {

        /*--------------------------------------------*/
        /*       Non-Stationary voiced speech         */
```

```
/*------------------------------------------------*/


for (i_sf = 0; i_sf < N_SF2; i_sf++)
        {
        BIT_bitpack((chan->idx_subcpcb[i_sf][0]),
                                (UNS_INT16 *) packedwords, 1, packw_ptr);


        if (chan->idx_subcpcb[i_sf][0]==1)
                {
                /*------------------------------------------------*/
                /*    2 pulses CB :  2pulses x 6.5bits/pulse    */
                /*           + 1 sign = 12 bits            */
                /*------------------------------------------------*/

                BIT_bitpack((chan->idx_cpcbsign[i_sf][0]),
                                (UNS_INT16 *) packedwords, 1, packw_ptr);
                BIT_bitpack((chan->idx_cpcb[i_sf][0]),
                                (UNS_INT16 *) packedwords, 13, packw_ptr);
                }
        else
                {
                BIT_bitpack((chan->idx_subcpcb[i_sf][1]),
                                (UNS_INT16 *) packedwords, 1, packw_ptr);


                if (chan->idx_subcpcb[i_sf][1] == 1)
                        {
                        /*------------------------------------------------*/
                        /* 3 pulses CB :  3 pulses x 2 bits/pulse   */
                        /*    3 signs + 4bits center = 13 bits    */
                        /*------------------------------------------------*/

                        for (i = 0; i < 3; i++)
                                {
                                BIT_bitpack((chan->idx_cpcbsign[i_sf][i]),
                                 (UNS_INT16 *) packedwords, 1, packw_ptr);
                                BIT_bitpack((chan->idx_cpcb[i_sf][i]),
                                 (UNS_INT16 *) packedwords, 2, packw_ptr);
                                }
                        BIT_bitpack((chan->idx_center[i_sf]),
                                 (UNS_INT16 *) packedwords, 4, packw_ptr);
```

```
                              }
                   else
                              {
                              /*----------------------------------------*/
                              /*       Gaussian codebook, 13 bits    */
                              /*----------------------------------------*/

                              for (i = 0; i < 2; i++)
                                      BIT_bitpack((chan->idx_cpcbsign[i_sf][i]),
                                              (UNS_INT16 *) packedwords, 1, packw_ptr);

                                      BIT_bitpack((chan->idx_cpcb[i_sf][0]),
                                              (UNS_INT16 *) packedwords, 11, packw_ptr);
                              }
                         }
                    }
                }

        break;

        /*----------------------------------------------------*/
        /*=================== case RATE2_0K ==================*/
        /*----------------------------------------------------*/

        case RATE2_0K :
                break;

        /*----------------------------------------------------*/
        /*=================== case RATE0_8K ==================*/
        /*----------------------------------------------------*/

        case RATE0_8K :
                break;

        /*----------------------------------------------------*/
        /*==================== ERROR =========================*/
        /*----------------------------------------------------*/

        default: nrerror ("Invalid rate !!");
                break;
```

```
            }

            /*------------------------------------------------------------*/

        return;

            /*------------------------------------------------------------*/
        }


    /*------------------------------------------------------------*/


    /*============================================================*/
    /* FUNCTION     :  BIT_bits_to_cdbk_index ().              */
    /*------------------------------------------------------------*/
    /* PURPOSE      :  This function converts the the bit-stream   */
    /*                 representation into the codebook index    */
    /*------------------------------------------------------------*/
    /* INPUT ARGUMENTS :                              */
    /*       _ (INT16    []) packedwords: bit-stream.         */
    /*------------------------------------------------------------*/
    /* OUTPUT ARGUMENTS :                            */
    /*       _ (PARAMETER *) indices   : fixed codebook indices.   */
    /*------------------------------------------------------------*/
    /* INPUT/OUTPUT ARGUMENTS :                          */
    /*       _ (INT16    []) packw_ptr:  pointer to the bit-stream. */
    /*------------------------------------------------------------*/
    /* RETURN ARGUMENTS :                            */
    /*                 _ None.                      */
    /*============================================================*/


void BIT_bits_to_cdbk_index (INT16 packedwords [], INT16 packw_ptr [],
                                        PARAMETER *chan)
        {
            /*------------------------------------------------------------*/

        INT16 i, i_sf;

            /*------------------------------------------------------------*/


            /*============================================================*/
```

```
/*ooooooooooooooooooooo Classification index ooooooooooooooooooooo*/
/*================================================================*/


if ((chan->fix_rate == RATE8_5K) ||
            (chan->fix_rate == RATE4_0K))
                    BIT_bitunpack (&chan->idx_SVS_deci,
                            (UNS_INT16 *) packedwords, 1, packw_ptr);
else
        chan->idx_SVS_deci=0;



/*================================================================*/
/*ooooooooooooooooooooo LSF quantizer index ooooooooooooooooooooo*/
/*================================================================*/


switch (chan->fix_rate)
        {
        /*--------------------------------------------------*/
        /*================ case RATE8_5K ================*/
        /*--------------------------------------------------*/


        case RATE8_5K:


                /*--------------------------------------------------*/
                /*              25 bits             */
                /*--------------------------------------------------*/


                BIT_bitunpack (&chan->idx_lsf[0],
                            (UNS_INT16 *) packedwords, 7, packw_ptr);


                BIT_bitunpack (&chan->idx_lsf[1],
                            (UNS_INT16 *) packedwords, 6, packw_ptr);


                BIT_bitunpack (&chan->idx_lsf[2],
                            (UNS_INT16 *) packedwords, 6, packw_ptr);


                BIT_bitunpack (&chan->idx_lsf[3],
                            (UNS_INT16 *) packedwords, 6, packw_ptr);


                /*--------------------------------------------------*/
                /*          LSF interpolation  2 bits         */
```

```
                    /*------------------------------------*/


            if (chan->idx_SVS_deci == 0)
                    BIT_bitunpack (&chan->idx_lpc_int,
                            (UNS_INT16 *) packedwords, 2, packw_ptr);

        break;


            /*------------------------------------*/
            /*=============== case RATE4_0K ===============*/
            /*------------------------------------*/


        case RATE4_0K:


                    /*------------------------------------*/
                    /*          21 bits            */
                    /*------------------------------------*/


            BIT_bitunpack (&chan->idx_lsf[0],
                            (UNS_INT16 *) packedwords, 7, packw_ptr);


            BIT_bitunpack (&chan->idx_lsf[1],
                            (UNS_INT16 *) packedwords, 7, packw_ptr);


            BIT_bitunpack (&chan->idx_lsf[2],
                            (UNS_INT16 *) packedwords, 6, packw_ptr);


            BIT_bitunpack (&chan->idx_lsf[3],
                            (UNS_INT16 *) packedwords, 1, packw_ptr);


        break;


            /*------------------------------------*/
            /*=============== case RATE2_0K ===============*/
            /*------------------------------------*/


    case RATE2_0K:


                    /*------------------------------------*/
                    /*          25 bits            */
                    /*------------------------------------*/
```

```
                BIT_bitunpack (&chan->idx_lsf[0],
                            (UNS_INT16 *) packedwords, 7, packw_ptr);


                BIT_bitunpack (&chan->idx_lsf[1],
                            (UNS_INT16 *) packedwords, 6, packw_ptr);


                BIT_bitunpack (&chan->idx_lsf[2],
                            (UNS_INT16 *) packedwords, 6, packw_ptr);


                BIT_bitunpack (&chan->idx_lsf[3],
                            (UNS_INT16 *) packedwords, 6, packw_ptr);


            /*----------------------------------------------*/
            /*          LSF interpolation  2 bits          */
            /*----------------------------------------------*/


                BIT_bitunpack (&chan->idx_lpc_int,
                            (UNS_INT16 *) packedwords, 2, packw_ptr);
        break;


        /*----------------------------------------------*/
        /*============== case RATE0_8K ================*/
        /*----------------------------------------------*/


    case RATE0_8K:


            /*----------------------------------------------*/
            /*              11 bits              */
            /*----------------------------------------------*/


                BIT_bitunpack (&chan->idx_lsf[0],
                            (UNS_INT16 *) packedwords, 4, packw_ptr);


                BIT_bitunpack (&chan->idx_lsf[1],
                            (UNS_INT16 *) packedwords, 4, packw_ptr);


                BIT_bitunpack (&chan->idx_lsf[2],
                            (UNS_INT16 *) packedwords, 3, packw_ptr);
        break;
```

```
            default: nrerror ("Invalid rate !!");

                    break;

        }



/*=====================================================================*/
/*ΟΟΟΟΟΟΟΟΟΟΟΟΟΟΟΟΟΟΟΟΟΟ Pitch index ΟΟΟΟΟΟΟΟΟΟΟΟΟΟΟΟΟΟΟΟΟΟΟΟ*/
/*=====================================================================*/


if ((chan->fix_rate == RATE8_5K) ||
                    (chan->fix_rate == RATE4_0K))
                    {
                    if (chan->idx_SVS_deci == 1)
                            {
                            if (chan->fix_rate == RATE8_5K)
                                    {
                                    BIT_bitunpack (&chan->idx_pitch[0],
                                            (UNS_INT16 *) packedwords, 8,
                                                    packw_ptr);
                                    }
                            else if (chan->fix_rate == RATE4_0K)
                                    {
                                    BIT_bitunpack (&chan->idx_pitch[0],
                                            (UNS_INT16 *) packedwords, 7,
                                                    packw_ptr);
                                    }
                            }
                    else
                            {
                            if (chan->fix_rate == RATE8_5K)
                                    {
                                    BIT_bitunpack (&chan->idx_pitch[0],
                                                    (UNS_INT16 *) packedwords, 8,
                                                            packw_ptr);

                                    BIT_bitunpack (&chan->idx_pitch[1],
                                                    (UNS_INT16 *) packedwords, 5,
                                                            packw_ptr);
```

```
                                    BIT_bitunpack (&chan->idx_pitch[2],
                                            (UNS_INT16 *) packedwords, 8,
                                                    packw_ptr);


                                    BIT_bitunpack (&chan->idx_pitch[3],
                                            (UNS_INT16 *) packedwords, 5,
                                                    packw_ptr);
                            }
                    else if (chan->fix_rate == RATE4_0K)
                            {
                            for (i = 0; i < N_SF2; i++)
                                    {
                                    BIT_bitunpack (&chan->idx_pitch[i],
                                            (UNS_INT16 *) packedwords, 7,
                                                    packw_ptr);
                                    }
                            }
                    }
            }


    /*===============================================================*/
    /*xxxxxxxxxxxxxxxxxxxxxxxxxxxxxxxx Gains index xxxxxxxxxxxxxxxxxxxxxxxxxxxxxxxx*/
    /*===============================================================*/


    switch (chan->fix_rate)
            {
            /*-------------------------------------------------*/
            /*================== case RATE8_5K ================*/
            /*-------------------------------------------------*/

            case RATE8_5K:

                    if (chan->idx_SVS_deci == 1)
                            {
                            BIT_bitunpack (&chan->idx_Gp_VQ,
                                    (UNS_INT16 *) packedwords, 6, packw_ptr);


                            BIT_bitunpack (&chan->idx_Gc_VQ,
                                    (UNS_INT16 *) packedwords, 10, packw_ptr);
                            }
```

```
            else
                {
                for (i = 0; i < N_SF4; i++)
                        BIT_bitunpack (&chan->idx_gainVQ[i],
                                (UNS_INT16 *) packedwords, 7, packw_ptr);
                }
            break;


        /*-------------------------------------------------*/
        /*=================== case RATE4_0K =====================*/
        /*-------------------------------------------------*/


    case RATE4_0K:

            if (chan->idx_SVS_deci == 1)
                {
                BIT_bitunpack (&chan->idx_Gp_VQ,
                                    (UNS_INT16 *) packedwords, 4, packw_ptr);

                BIT_bitunpack (&chan->idx_Gc_VQ,
                                    (UNS_INT16 *) packedwords, 8, packw_ptr);
                }
            else
                {
                for (i = 0; i < N_SF2; i++)
                        BIT_bitunpack (&chan->idx_gainVQ[i],
                                    (UNS_INT16 *) packedwords, 7, packw_ptr);
                }
            break;
        /*-------------------------------------------------*/
        /*=================== case RATE2_0K =====================*/
        /*-------------------------------------------------*/

    case RATE2_0K:

            for (i = 0; i < N_SF2; i++)
                    BIT_bitunpack (&chan->idx_gainVQ[i],
                                    (UNS_INT16 *) packedwords, 6, packw_ptr);
            break;
```

```
            case RATE0_8K:
                        BIT_bitunpack (&chan->idx_gainVQ[0],
                                (UNS_INT16 *) packedwords, 5, packw_ptr);
                break;


            default: nrerror("Invalid rate !!");
                break;
            }


/*============================================================*/
/*□□□□□□□□□□□□□□□□□□□□□□□□□□□ Codeboks index □□□□□□□□□□□□□□□□□□□□□□□□□□□□□*/
/*============================================================*/


switch (chan->fix_rate)
            {
            /*-------------------------------------------------*/
            /*=================== case RATE8_5K ===================*/
            /*-------------------------------------------------*/


            case RATE8_5K:


            if (chan->idx_SVS_deci == 1)
                    {
                    /*-------------------------------------------------*/
                    /*          Stationary voiced speech          */
                    /*-------------------------------------------------*/


                    for (i_sf = 0; i_sf < N_SF4; i_sf++)
                            {
                            /*-------------------------------------------------*/
                    /* 8 pulses CB : 6p x 3b + 2p x 4b + 4b signs = 30 bits */
                            /*-------------------------------------------------*/


                            for (i = 0; i < 4; i++)
                                    BIT_bitunpack (&chan->idx_cpcbsign[i_sf][i],
                                                (UNS_INT16 *) packedwords, 1,
packw_ptr);


                            BIT_bitunpack (&chan->idx_cpcb[i_sf][0],
```

```
                                          (UNS_INT16 *) packedwords, 4,
      packw_ptr);
                              for (i = 1; i < 4; i++)
                                    BIT_bitunpack (&chan->idx_cpcb[i_sf][i],
                                             (UNS_INT16 *) packedwords, 3,
      packw_ptr);


                              BIT_bitunpack (&chan->idx_cpcb[i_sf][4],
                                             (UNS_INT16 *) packedwords, 4,
      packw_ptr);


                              for (i = 5; i < 8; i++)
                                    BIT_bitunpack (&chan->idx_cpcb[i_sf][i],
                                             (UNS_INT16 *) packedwords, 3,
      packw_ptr);
                                    }
                              }
                  else

                        {

                        /*--------------------------------------------*/
                        /*          Non-Stationary voiced speech      */
                        /*--------------------------------------------*/


                        for (i_sf = 0; i_sf < N_SF4; i_sf++)
                              {
                              BIT_bitunpack (&chan->idx_subcpcb[i_sf][0],
                                             (UNS_INT16 *) packedwords, 1,
      packw_ptr);

                              if (chan->idx_subcpcb[i_sf][0] == 1)
                                    {
                                    /*----------------------------------*/
                                    /* 5 pulses CB : 3p x 4b + 2p x 3b + 3b signs   */
                                    /*          = 21 bits              */
                                    /*----------------------------------*/

                                    for (i=0; i< 3; i++)
                                          BIT_bitunpack (&chan->idx_cpcbsign[i_sf][i],
```

```
                                                      (UNS_INT16 *) packedwords, 1,
packw_ptr);


                            BIT_bitunpack (&chan->idx_cpcb[i_sf][0],
                                                      (UNS_INT16 *) packedwords, 4,
packw_ptr);


                            BIT_bitunpack (&chan->idx_cpcb[i_sf][1],
                                                      (UNS_INT16 *) packedwords, 4,
packw_ptr);


                            BIT_bitunpack (&chan->idx_cpcb[i_sf][2],
                                                      (UNS_INT16 *) packedwords, 3,
packw_ptr);


                            BIT_bitunpack (&chan->idx_cpcb[i_sf][3],
                                                      (UNS_INT16 *) packedwords, 4,
packw_ptr);


                            BIT_bitunpack (&chan->idx_cpcb[i_sf][4],
                                                      (UNS_INT16 *) packedwords, 3,
packw_ptr);


                            }
                else
                            {
                            BIT_bitunpack (&chan->idx_subcpcb[i_sf][1],
                                                      (UNS_INT16 *) packedwords, 1,
packw_ptr);


                            /*————————————————————*/
                            /*     5 pulses CB : 5p x 3b + 5b signs    */
                            /*          = 20 bits              */
                            /*————————————————————*/


                            for (i = 0; i < 5; i++)
                                    {
                                    BIT_bitunpack (&chan->idx_cpcbsign[i_sf][i],
                                                      (UNS_INT16 *) packedwords, 1,
packw_ptr);
```

```
                                        BIT_bitunpack (&chan->idx_cpcb[i_sf][i],

                                                (UNS_INT16 *) packedwords, 3,

        packw_ptr);

                                }

                        }

                }

        }


        break;


        /*----------------------------------------------------*/
        /*================= case RATE4_0K ==================*/
        /*----------------------------------------------------*/


        case RATE4_0K:


        if (chan->idx_SVS_deci == 1)

                {


                        /*--------------------------------------------*/
                        /*          Stationary voiced speech        */
                        /*--------------------------------------------*/


                        for (i_sf = 0; i_sf < N_SF3; i_sf++)

                                {
                                BIT_bitunpack (&chan->idx_subcpcb[i_sf][0],

                                                (UNS_INT16 *) packedwords, 1,

        packw_ptr);


                                if (chan->idx_subcpcb[i_sf][0] == 1)

                                        {
                                        /*--------------------------------*/
                                        /* 2 pulses CB : 2pulses x 5bits/pulse + 2 signs */
                                        /*          = 12 bits            */
                                        /*--------------------------------*/


                                        for (i = 0; i < 2; i++)

                                                {
                                                BIT_bitunpack (&chan->idx_cpcbsign[i_sf][i],
```

```
                                                    (UNS_INT16 *) packedwords, 1,
            packw_ptr);

                                              BIT_bitunpack (&chan->idx_cpcb[i_sf][i],
                                                    (UNS_INT16 *) packedwords, 5,
            packw_ptr);

                                        }
                                  }
                            else
                                  {
                                  /*-------------------------------------------*/
                                  /*    3 pulses CB :  3 pulses x 2 bits/pulse +   */
                                  /*    3 signs + 3bits center = 12 bits        */
                                  /*-------------------------------------------*/

                                  for (i = 0; i < 3; i++)
                                        {
                                        BIT_bitunpack (&chan->idx_cpcbsign[i_sf][i],
                                                    (UNS_INT16 *) packedwords, 1,
            packw_ptr);

                                        BIT_bitunpack (&chan->idx_cpcb[i_sf][i],
                                                    (UNS_INT16 *) packedwords, 2,
            packw_ptr);
                                        }

                                  BIT_bitunpack (&chan->idx_center[i_sf],
                                                    (UNS_INT16 *) packedwords, 3,
            packw_ptr);
                                        }
                                  }
                            }
                  else
                        {
                        /*---------------------------------------------*/
                        /*         Non-Stationary voiced speech        */
                        /*---------------------------------------------*/

                        for (i_sf = 0; i_sf < N_SF2; i_sf++)
                              {
```

212

```
BIT_bitunpack (&chan->idx_subcpcb[i_sf][0],
                                (UNS_INT16 *) packedwords, 1,
packw_ptr);


if (chan->idx_subcpcb[i_sf][0] == 1)
        {
        /*--------------------------------------------*/
        /*    2 pulses CB :  2pulses x 6.5bits/pulse   */
        /*          + 1 sign = 12 bits            */
        /*--------------------------------------------*/


        BIT_bitunpack (&chan->idx_cpcbsign[i_sf][0],
                        (UNS_INT16 *) packedwords, 1,
packw_ptr);


        BIT_bitunpack (&chan->idx_cpcb[i_sf][0],
                        (UNS_INT16 *) packedwords, 13,
packw_ptr);

        }
else
        {
        BIT_bitunpack (&chan->idx_subcpcb[i_sf][1],
                        (UNS_INT16 *) packedwords, 1,
packw_ptr);


        if (chan->idx_subcpcb[i_sf][1] == 1)
                {
                /*------------------------------------------*/
                /* 3 pulses CB :  3 pulses x 2 bits/pulse   */
                /*    3 signs + 4bits center = 13 bits    */
                /*------------------------------------------*/


                for (i = 0; i < 3; i++)
                        {
                        BIT_bitunpack (&chan->idx_cpcbsign[i_sf][i],
                                (UNS_INT16 *) packedwords, 1,
packw_ptr);

                        BIT_bitunpack (&chan->idx_cpcb[i_sf][i],
                                (UNS_INT16 *) packedwords, 2,
packw_ptr);
```

```
                                            }

                                BIT_bitunpack (&chan->idx_center[i_sf],
                                             (UNS_INT16 *) packedwords, 4,
    packw_ptr);

                                }
                    else

                                {
                                /*--------------------------------------------*/
                                /*      Gaussian codebook, 13 bits       */
                                /*--------------------------------------------*/

                                for (i = 0; i < 2; i++)
                                        BIT_bitunpack (&chan->idx_cpcbsign[i_sf][i],
                                             (UNS_INT16 *) packedwords, 1,
    packw_ptr);

                                BIT_bitunpack (&chan->idx_cpcb[i_sf][0],
                                             (UNS_INT16 *) packedwords, 11,
    packw_ptr);
                                }
                                        }
                                }
                                }

                    break;

            /*--------------------------------------------------------*/
            /*================== case RATE2_0K ==================*/
            /*--------------------------------------------------------*/

    case RATE2_0K :
                    break;

            /*--------------------------------------------------*/
            /*================= case RATE0_8K =================*/
            /*--------------------------------------------------*/

    case RATE0_8K :
                    break;
```

```
/*--------------------------------------------------*/
/*==================== ERROR ====================*/
/*--------------------------------------------------*/


    default: nrerror ("Invalid rate !!");
            break;
        }


    /*--------------------------------------------------*/


return;


    /*--------------------------------------------------*/
    }



/*================================================*/
/*----------------------- END -----------------------*/
/*================================================*/
```

```
/*=====================================================================*/


/*===================================================================*/
/* Conexant System Inc.                           */
/* 4311 Jamboree Road                            */
/* Newport Beach, CA 92660                         */
/*----------------------------------------------------------*/
/* Copyright(C) 2000 Conexant System Inc.               */
/*----------------------------------------------------------*/
/* ALL RIGHTS RESERVED:                           */
/* No part of this software may be reproduced in any form or by any  */
/* means or used to make any derivative work (such as transformation */
/* or adaptation) without the authorisation of Conexant System Inc.  */
/*===================================================================*/
/* LIBRARY: lib_bit.h                             */
/*===================================================================*/


/*----------------------------------------------------------*/
/*------------------------- FUNCTIONS -------------------------*/
/*----------------------------------------------------------*/


void BIT_init_lib (void);


void BIT_bitpack (INT16, UNS_INT16 *, INT16, INT16 *);


void BIT_bitunpack (INT16 *, UNS_INT16 *, INT16, INT16 *);


void BIT_cdbk_index_to_bits (PARAMETER *, INT16 [], INT16 []);


void BIT_bits_to_cdbk_index (INT16 [], INT16 [], PARAMETER *);


/*=====================================================================*/
/*------------------------- END -------------------------*/
/*=====================================================================*/
```

```
/*=========================================================================*/


/*=========================================================================*/
/* Conexant System Inc.                       */
/* 4311 Jamboree Road                         */
/* Newport Beach, CA 92660                      */
/*----------------------------------------------------*/
/* Copyright(C) 2000 Conexant System Inc.            */
/*----------------------------------------------------*/
/* ALL RIGHTS RESERVED:                         */
/* No part of this software may be reproduced in any form or by any  */
/* means or used to make any derivative work (such as transformation */
/* or adaptation) without the authorisation of Conexant System Inc.  */
/*=========================================================================*/
/* LIBRARY: lib_cla.c                         */
/*=========================================================================*/


/*------------------------------------------------------*/
/*------------------------- INCLUDE -------------------------*/
/*------------------------------------------------------*/


#include "typedef.h"

#include "main.h"
#include "const.h"
#include "gputil.h"
#include "ext_var.h"

#include "lib_cla.h"
#include "lib_lpc.h"

#ifdef DIAGNOSTICS

#include "lib_dia.h"

#endif


/*------------------------------------------------------*/
/*------------------------- FUNCTIONS -------------------------*/
```

217

```
/*----------------------------------------------------*/


/*====================================================*/
/* FUNCTION     : CLA_init_lib ().                    */
/*----------------------------------------------------*/
/* PURPOSE      : This function initialise the global variables   */
/*                of the CLA library.                 */
/*----------------------------------------------------*/
/* INPUT ARGUMENTS :                                  */
/*               _ None.                              */
/*----------------------------------------------------*/
/* OUTPUT ARGUMENTS :                                 */
/*               _ None.                              */
/*----------------------------------------------------*/
/* INPUT/OUTPUT ARGUMENTS :                           */
/*               _ None.                              */
/*----------------------------------------------------*/
/* RETURN ARGUMENTS :                                 */
/*               _ None.                              */
/*====================================================*/


void CLA_init_lib (void)
        {
        /*----------------------------------------------------*/


        INT16  k;


        FLOAT64 x;


        /*----------------------------------------------------*/


        VUV = 0;
        VUVm = 2;
        frame_class = 0;
        frame_onset=0;


        energy_m     = 0.0;
        energy       = 0.0;


        /*----------------------------------------------------*/
```

```
    ini_svector (frame_class_mem,    0, CLA_MEM_SIZE-1, (INT16)0);
    ini_svector (onstplsv_mem,       0, CLA_MEM_SIZE-1, (INT16)0);
    ini_svector (voiced_mem,            0, CLA_MEM_SIZE-1, (INT16)0);


    ini_dvector (buffer_cla, 0, L_FRM+MEM_CLASS+L_LPCLHD-1, 0.0);
    ini_dvector (Lp_buffer, 0, N_Lp-1, (FLOAT64)MIN_LAG);


    MA_avg_wRp = 0.0;


    MA_min_wtilt = 0.0;


    ini_dvector (P_w[0], 0, SLOPE_MAX_SIZE-1, 0.0);
    ini_dvector (P_w[1], 0, SLOPE_MAX_SIZE-1, 0.0);


    /*--------------------------------------------------*/
    /*          Generate Hamming window          */
    /*--------------------------------------------------*/


    for(k = 0; k < LPC_WIN1; k++){
      x = cos (2.0*PI*(FLOAT64)k /(FLOAT64) (LPC_WIN1-1));
      window1[k] = 0.54 - 0.46 * x;
    }


    ini_dvector (buffer_refl0, 0, CLA_MEM_SIZE-1, 0.0);


    E_noi = 1.0;
    T_noi = 0.0;
    M_noi = 0.0;
    R_noi = 0.0;


    ini_dvector (buffer_wtilt, 0, MAX_N_SF-1, 0.0);
    ini_dvector (buffer_wmax,     0, MAX_N_SF-1, 0.0);
    ini_dvector (buffer_wRp, 0, MAX_N_SF-1, 0.0);
    ini_dvector (buffer_max_cla,     0, MAX_N_SF-1, 0.0);


    /*--------------------------------------------------*/


    SVS_Count = 0;
    Vad_0_Count = 0;
```

```
            FlatSp_Flag = 0;


            Av_value = 0.0;


            /*_____*/


            Rp_m_cla = 0.0;
            lpcg_m_cla = 0.0;


            /*_____*/


        OnSet = 0;
        frame_class_mm = 5;


            /*_____*/


            SVS_deci_mem = 0;


            /*_____*/


            return;


            /*_____*/
            }


    /*_____*/


    /*====================================================================*/
    /* FUNCTION     : CLA_signal_classifier ().                */
    /*_____*/
    /* PURPOSE      : This function classify teh input signal frame: */
    /*           file.                        */
    /* frame_class 0: silence                        */
    /* frame_class 1: noise-like   (CURRENTLY, NOT ACTIVATED)     */
    /* frame_class 2: unvoiced                    */
    /* frame_class 3: onset                        */
    /* frame_class 4: plosive    (CURRENTLY, NOT ACTIVATED)      */
    /* frame_class 5: non-stationary voiced               */
    /* frame_class 6: stationary voiced (CURRENTLY, NOT DISTINGUISHED */
    /*                    FROM CLASS 5)            */
```

```
/*------------------------------------------------------------------*/
/* INPUT ARGUMENTS :                                    */
/*        _ (FLOAT64 []) signal: input frame.           */
/*        _ (FLOAT64 )  Rp    : Pitch correlation.      */
/*        _ (FLOAT64 )  Lp    : Pitch lags.             */
/*        _ (INT16 )    Vad   : VAD of current frame.   */
/*------------------------------------------------------------------*/
/* OUTPUT ARGUMENTS :                                   */
/*            _ None.                                   */
/*------------------------------------------------------------------*/
/* INPUT/OUTPUT ARGUMENTS :                             */
/*            _ None.                                   */
/*------------------------------------------------------------------*/
/* RETURN ARGUMENTS :                                   */
/*        _ (INT16 ) frame_class: current fame frame_class.   */
/*================================================================================*/


INT16  CLA_signal_classifier (FLOAT64 signal[], FLOAT64 Rp, FLOAT64 Lp,
                                           INT16 Vad)
        {
        /*------------------------------------------------------------------*/

        INT16 frame_class, i_sf, k, idx;

        /*------------------------------------------------------------------*/
        /*        Parameters for local first order LPC analysis      */
        /*------------------------------------------------------------------*/

        FLOAT64 siglpc1[LPC_WIN1], rxx1[2], pderr;

        /*------------------------------------------------------------------*/
        /*            Pitch lag evolution            */
        /*------------------------------------------------------------------*/

        FLOAT64 Lp_avg, Lp_std;

        /*------------------------------------------------------------------*/
        /*                Maximum Tracking            */
        /*------------------------------------------------------------------*/
```

```
INT16 start, end;
FLOAT64 val, max, den;


/*-----------------------------------------------------------*/
/*        Weighted spectral tilt and weighted maximum        */
/*-----------------------------------------------------------*/



FLOAT64 E_seg, nsr, min_slope_wtilt, sum_slope_wtilt, max_slope_wmax,
        sum_slope_wmax;
FLOAT64 num_tilt, num_max, slope_wtilt, slope_wmax;
FLOAT64 min_wtilt, avg_wtilt, max_wRp, avg_wRp;
INT16 onstplsv, voiced;


/*-----------------------------------------------------------*/
/*                  Update signal buffer                     */
/*-----------------------------------------------------------*/


for(k = 0; k < MEM_CLASS; k++)
        buffer_cla[k] = buffer_cla[k+L_FRM];

for(k = 0; k < L_FRM + L_LPCLHD; k++)
        buffer_cla[k+MEM_CLASS] = signal[k];


/*-----------------------------------------------------------*/
/* ============== Calculate evolution of pitch lag ============== */
/*-----------------------------------------------------------*/


/*-----------------------------------------------------------*/
/*              Update buffer with pitch lags                */
/*-----------------------------------------------------------*/


for(k=0; k<N_Lp-1; k++)
        Lp_buffer[k] = Lp_buffer[k+1];


Lp_buffer[N_Lp-1] = Lp;


/*-----------------------------------------------------------*/
/*                    Average pitch lag                      */
/*-----------------------------------------------------------*/
```

```
for(Lp_avg=0.0, k=0; k<N_Lp; k++)
        Lp_avg += Lp_buffer[k];


Lp_avg /= (FLOAT64)N_Lp;


/*------------------------------------------------------------*/
/*              Standard deviation on lag              */
/*------------------------------------------------------------*/


for(Lp_std=0.0, k=0; k<N_Lp; k++)
        Lp_std += (Lp_buffer[k]-Lp_avg)*(Lp_buffer[k]-Lp_avg);


Lp_std = sqrt(Lp_std/(FLOAT64)N_Lp)/Lp_avg;


/*------------------------------------------------------------*/
/*      Buffer onset parameters of the previous frame      */
/*------------------------------------------------------------*/


for (k = 0; k < SLOPE_MAX_SIZE; k++)
        P_w[0][k] = P_w[1][k];


/*------------------------------------------------------------*/
/* ================== Calculate spectral tilt ================== */
/*------------------------------------------------------------*/


for(i_sf = 0; i_sf < CLA_MEM_SIZE; i_sf++)
        {
        /*------------------------------------------------------------*/
        /* ========= Local first order LPC analysis ========= */
        /*------------------------------------------------------------*/


        /*------------------------------------------------------------*/
        /*              LPC windowing              */
        /*------------------------------------------------------------*/


        mul_dvector (signal+i_sf*L_LPC_SF-OVERLAP, window1, siglpc1,


        0, LPC_WIN1-1);
```

```
/*----------------------------------------*/
/*            Autocorrelation              */
/*----------------------------------------*/


LPC_autocorrelation (siglpc1, LPC_WIN1, rxx1, 2);


/*----------------------------------------*/
/*         Leroux-Gueguen recursion        */
/*----------------------------------------*/


LPC_leroux_gueguen (rxx1, &buffer_refl0[i_sf], &pderr, 1);
}


/*----------------------------------------*/
/* ==================== Calculate Maximum ==================== */
/* ================== (the lookahead is utilized) ================== */
/*----------------------------------------*/


for(i_sf=0; i_sf < MAX_N_SF; i_sf++)
        {
        /*----------------------------------------*/
        /*          Find max in pitch cycle        */
        /*----------------------------------------*/


        if(Lp > MAX_L_SF)
                {
                start = MEM_CLASS+MAX_L_SF-(INT16)(1.5*Lp) +


i_sf*MAX_L_SF+L_LPCLHD;
                start = (start < 0 ? 0 : start);
                }
        else
                start = MEM_CLASS+i_sf*MAX_L_SF+L_LPCLHD;


        end = MEM_CLASS+(i_sf+1)*MAX_L_SF+L_LPCLHD;


        for(max=-MAXFLT, k=start; k<end; k++)
                {
                val = (buffer_cla[k] > 0.0 ? buffer_cla[k] : -buffer_cla[k]);
```

```
        if(val > max)
                max = val;

            }


    /*-------------------------------------------------*/
    /*          Update buffer of maxima          */
    /*-------------------------------------------------*/


    buffer_max_cla[i_sf] = max;

        }


/*-----------------------------------------------------*/
/* ======== Calculate weighted tilt, weighted maximum, and ==========*/
/* ================== weighted pitch correlation =================== */
/* ========= the parametric noise component is suppressed ======== */
/* ================== (the lookahead is utilized) ================ */
/*-----------------------------------------------------*/


min_slope_wtilt = MAXFLT;
sum_slope_wtilt = 0.0;
max_slope_wmax = -MAXFLT;
sum_slope_wmax = 0.0;
min_wtilt = MAXFLT;
avg_wtilt = 0.0;
max_wRp = -MAXFLT;
avg_wRp = 0.0;


for(i_sf = 0; i_sf < MAX_N_SF; i_sf++)
        {
        /*-------------------------------------------*/
        /*         Find energy in pitch cycle          */
        /*-------------------------------------------*/


        if(Lp > MAX_L_SF)
                {
                start = MEM_CLASS+MAX_L_SF-(INT16)(2.0*Lp)+i_sf*MAX_L_SF;
                start = (start < 0 ? 0 : start);
                }
        else
                start = MEM_CLASS+i_sf*MAX_L_SF;
```

```
end = MEM_CLASS+(i_sf+1)*MAX_L_SF;


/*----------------------------------------------*/
/*              Update segment energy           */
/*----------------------------------------------*/


E_seg = 0.0;
for(k=start; k<end; k++)
        E_seg += buffer_cla[k]*buffer_cla[k];


/*----------------------------------------------*/
/*              Normalize energy                */
/*----------------------------------------------*/


E_seg = 1.0+E_seg/(FLOAT64)(end-start+1);


/*----------------------------------------------*/
/*      Update noise level, noise tilt, noise max   */
/*----------------------------------------------*/


if (frm_count < 6 && buffer_refl0[(INT16)((FLOAT64)i_sf/2.0)] <
                -0.4 && Rp < 0.50)
        {
        /*----------------------------------------------*/
        /*      Relaxed update with fast adaptation     */
        /*----------------------------------------------*/


        E_noi = 0.80*E_noi+0.20*E_seg;


        idx = (INT16)((FLOAT64)i_sf/2.0);
        T_noi = 0.75 * T_noi + 0.25 * buffer_refl0 [idx];
        M_noi = 0.75*M_noi+0.25*buffer_max_cla[i_sf];
        R_noi = 0.75*R_noi+0.25*Rp;
        }
else if(Vad == 0)
        {
        /*----------------------------------------------*/
        /*      Stringent update with slow adaptation   */
        /*----------------------------------------------*/
```

```
        E_noi = 0.999*E_noi+0.001*E_seg;

        idx  = (INT16)((FLOAT64)i_sf/2.0);

        T_noi = 0.990 * T_noi + 0.010 * buffer_refl0[idx];

        M_noi = 0.990*M_noi+0.010*buffer_max_cla[i_sf];

        R_noi = 0.990*R_noi+0.010*Rp;

        }


/*-----------------------------------------------------*/
/*          Calculate weighting factor          */
/*-----------------------------------------------------*/


nsr = sqrt(E_noi/E_seg);


/*-----------------------------------------------------*/
/*          Limit noise suppression to 30dB.          */
/*          nsr_lim=1-10^(-dB_lim/20)          */
/*          10dB: 0.684, 20dB: 0.900, 30dB: 0.968          */
/*-----------------------------------------------------*/


nsr = (nsr > 0.968 ? 0.968 : nsr);


/*-----------------------------------------------------*/
/* Update buffer of weighted tilt, weighted maximum, and   */
/*          weighted pitch correlation          */
/*-----------------------------------------------------*/


for(k = 0; k < MAX_N_SF-1; k++)
        {
        buffer_wtilt[k] = buffer_wtilt[k+1];
        buffer_wmax[k] = buffer_wmax[k+1];
        buffer_wRp[k] = buffer_wRp[k+1];
        }


/*-----------------------------------------------------*/
/* Suppress noise component in tilt, maximum, and pitch   */
/*          correlation          */
/*-----------------------------------------------------*/


idx = (INT16)((FLOAT64)i_sf/2.0);
```

```
buffer_wtilt[MAX_N_SF-1] = buffer_refl0[idx] - nsr*T_noi;
buffer_wmax[MAX_N_SF-1] = buffer_max_cla[i_sf] - nsr*M_noi;
buffer_wRp[MAX_N_SF-1] = Rp - nsr*R_noi;


/*----------------------------------------------*/
/*   Calculate slope of weighted tilt and weighted maximum   */
/*----------------------------------------------*/


num_tilt = 0.0;
num_max = 0.0;
den = 0.0;
for (k = 0; k < MAX_N_SF; k++)
        {
        num_tilt += (FLOAT64)k*(buffer_wtilt[k]-buffer_wtilt[0]);
        num_max  += (FLOAT64)k*(buffer_wmax[k]-buffer_wmax[0]);
        den += (FLOAT64)(k*k);
        }


/*----------------------------------------------*/
/*     Update sum, max, min, avg, etc of weighted tilt,    */
/*     weighted maximum, and weighted pitch correlation    */
/*----------------------------------------------*/


slope_wtilt = num_tilt/(den+EPSI);


if(slope_wtilt < min_slope_wtilt)
        min_slope_wtilt = slope_wtilt;


sum_slope_wtilt += slope_wtilt;


slope_wmax = num_max/(den+EPSI);
if(slope_wmax > max_slope_wmax)
        max_slope_wmax = slope_wmax;
sum_slope_wmax += slope_wmax;


/*----------------------------------------------*/
/*     Update minimum and average of weighted tilt     */
/*----------------------------------------------*/


if(buffer_wtilt[MAX_N_SF-1] < min_wtilt)
```

```
                min_wtilt = buffer_wtilt[MAX_N_SF-1];
            avg_wtilt += buffer_wtilt[MAX_N_SF-1];


        /*--------------------------------------------------*/
        /* Update maximum and average of weighted pitch correlation */
        /*--------------------------------------------------*/


        if(buffer_wRp[MAX_N_SF-1] > max_wRp)
                max_wRp = buffer_wRp[MAX_N_SF-1];


        avg_wRp += buffer_wRp[MAX_N_SF-1];


        /*--------------------------------------------------*/
        }


    /*--------------------------------------------------*/
    /*    Normalize average weighted tilt and pitch correlation    */
    /*--------------------------------------------------*/


    avg_wRp        /= (FLOAT64)MAX_N_SF;
    avg_wtilt      /= (FLOAT64)MAX_N_SF;


    /*--------------------------------------------------*/
    /*    Update moving average of weighted spectral tilt    */
    /*--------------------------------------------------*/


    MA_min_wtilt = 0.75*MA_min_wtilt + 0.25*min_wtilt;


    /*--------------------------------------------------*/
    /*    Update moving average of pitch correlation    */
    /*--------------------------------------------------*/


    MA_avg_wRp = 0.75*MA_avg_wRp + 0.25*avg_wRp;


    /*--------------------------------------------------*/
    /* The first reflection coefficient of the last subframe with    */
    /*    inverted sign for probability interpretation,    */
    /*    i.e. mapped to [-1:1]    */
    /*--------------------------------------------------*/
```

```
P_w[1][4] = -buffer_wtilt[MAX_N_SF-1];


/*-------------------------------------------------*/
/* Limit sum of slopes to min of -1.0, max of 1.0, mapped to [-1:1] */
/*        inverted sign for probability interpretation,        */
/*-------------------------------------------------*/


P_w[1][0] = -sum_slope_wtilt;


if(P_w[1][0] > 1.0)
        P_w[1][0] = 1.0;
else if(P_w[1][0] < -1.0)
        P_w[1][0] = -1.0;


P_w[1][0] *= 1.0;


/*-------------------------------------------------*/
/* Limit sum of slopes to min of -0.5, max of 0.5, mapped to [-1:1] */
/*        inverted sign for probability interpretation,        */
/*-------------------------------------------------*/


P_w[1][1] = -min_slope_wtilt;
if(P_w[1][1] > 0.5)
        P_w[1][1] = 0.5;
else if(P_w[1][1] < -0.5)
        P_w[1][1] = -0.5;
P_w[1][1] *= 2;


/*-------------------------------------------------*/
/*      Limit sum of slopes to min of -10000, max of 10000,     */
/*                 mapped to [-1:1]                 */
/*-------------------------------------------------*/


P_w[1][2] = sum_slope_wmax;
if(P_w[1][2] > 10000.0)
        P_w[1][2] = 10000.0;
else if(P_w[1][2] < -10000.0)
        P_w[1][2] = -10000.0;
P_w[1][2] *= 0.0001;
```

```
/*--------------------------------------------------------------*/
/*      Limit sum of slopes to min of -1000, max of 1000,       */
/*                  mapped to [-1:1]                  */
/*--------------------------------------------------------------*/


P_w[1][3] = max_slope_wmax;
if(P_w[1][3] > 1000.0)
        P_w[1][3] = 1000.0;
else if(P_w[1][3] < -1000.0)
        P_w[1][3] = -1000.0;
P_w[1][3] *= 0.001;



onstplsv = 0;


/*--------------------------------------------------------------*/
/*    Rewritten in order to output criterion that triggers onset    */
/*--------------------------------------------------------------*/


if(P_w[1][1] > 0.3409 && P_w[1][2] > 0.025 && P_w[1][4] > -0.075)
        {
        onstplsv = 1;
        }
else if(P_w[1][1] > 0.2273 && P_w[1][2] > 0.027 && P_w[1][4] > -0.075)
        {
        onstplsv = 1;
        }
else if(P_w[1][1] > 0.1818 && P_w[1][2] > 0.031 && P_w[1][4] > -0.075)
        {
        onstplsv = 1;
        }
else if(P_w[1][1] > 0.0909 && P_w[1][2] > 0.040 && P_w[1][4] > 0.075)
        {
        onstplsv = 1;
        }
else if(P_w[1][1] > 0.0773 && P_w[1][2] > 0.060 && P_w[1][4] > 0.075)
        {
        onstplsv = 1;
        }
else if(P_w[1][1] > 0.0591 && P_w[1][2] > 0.080 && P_w[1][4] > 0.100)
```

```
        {
        onstplsv = 1;
        }
else if(P_w[1][1] > 0.03636 && P_w[1][2] > 0.100 && P_w[1][4] > 0.100)
        {
        onstplsv = 1;
        }
else if(P_w[1][1] > 0.1818 && P_w[1][2] > 0.025 && P_w[1][3] > 0.100 &&
  P_w[1][4] > -0.075)
        {
        onstplsv = 1;
        }
else if(P_w[1][1] > 0.1364 && P_w[0][1] > 0.1364 &&
        P_w[1][2] > 0.015 && P_w[0][2] > 0.015 && P_w[1][4] > -0.075)
        {
        onstplsv = 1;
        }
else if(P_w[1][1] > 0.1364 && P_w[1][3] > 0.120 && P_w[1][4] > 0.150)
        {
        onstplsv = 1;
        }
else if(P_w[1][1] > 0.2273 && P_w[1][3] > 0.070 && P_w[1][4] > 0.150)
        {
        onstplsv = 1;
        }
else if(P_w[1][1] > 0.2500 && P_w[1][3] > 0.060 && P_w[1][4] >  0.150)
        {
        onstplsv = 1;
        }
else if(P_w[1][1] > 0.4091 && P_w[1][3] > 0.030 && P_w[1][4] >  0.150)
        {
        onstplsv = 1;
        }
else if(P_w[1][1] > 0.1818 && P_w[0][3] > 0.30 && P_w[1][4] > 0.000)
        {
        onstplsv = 1;
        }

voiced = 0;
if(avg_wRp >= 0.70)
```

```
                {
                voiced = 1;
                }
        else if(avg_wRp >= 0.5 && Lp_std < 0.10)
                {
                voiced = 1;
                }
        else if(MA_avg_wRp >= 0.6 && Lp_std < 0.10)
                {
                voiced = 1;
                }
        else if(avg_wtilt < -0.50 && avg_wRp >= 0.2)
                {
                voiced = 1;
                }
        else if(min_wtilt < -0.70 && avg_wRp >= 0.2)
                {
                voiced = 1;
                }
        else if(avg_wtilt < -0.75)
                {
                voiced = 1;
                }
        else if(MA_avg_wRp > 0.50 && max_wRp > 0.40 && min_wtilt < -0.40)
                {
                voiced = 1;
                }
        else if(avg_wRp > 0.50 && min_wtilt < -0.35)
                {
                voiced = 1;
                }
        else if(avg_wRp > 0.50 && min_wtilt < -0.05)
                {
                voiced = 1;
                }


/*-------------------------------------------------------------*/
/*              Offset handling                     */
/*-------------------------------------------------------------*/
```

```
else if(voiced_mem[3] == 1 && voiced_mem[2] == 1)
        {
        if(MA_avg_wRp > 0.55 && MA_min_wtilt < -0.10 && Lp_std < 0.05)
                {
                voiced = 1;
                }
        }


if (Vad == 0)
        {
        voiced = 0;
        }


/*------------------------------------------------------*/
/*==================== Make frame_class decision ====================*/
/*------------------------------------------------------*/


frame_class = 2;


/*------------------------------------------------------*/
/*              Onset frame_classification              */
/*------------------------------------------------------*/


if ((frame_class_mem[3] == 0 || frame_class_mem[3] == 1 ||
        frame_class_mem[3] == 2) && voiced == 1)
                frame_class = 3;
else if (onstplsv == 1 && (frame_class_mem[3] != 5 ||
        frame_class_mem[3] != 6 || voiced != 1))
                frame_class = 3;


/*------------------------------------------------------*/
/*              Voiced frame_classification             */
/*------------------------------------------------------*/


else if(onstplsv_mem[3] == 1 && voiced == 0)
        frame_class = 5;
else if(voiced == 1)
        frame_class = 5;


if(Vad == 0)
```

```
              frame_class = 0;


       /*------------------------------------------------------*/
       /*              Update frame_class buffer           */
       /*------------------------------------------------------*/


       for ( k = 0; k < CLA_MEM_SIZE-1; k++)
              {
              frame_class_mem[k] = frame_class_mem[k+1];
              onstplsv_mem[k] = onstplsv_mem[k+1];
              voiced_mem[k] = voiced_mem[k+1];
              }


       frame_class_mem [CLA_MEM_SIZE-1] = frame_class;
       onstplsv_mem [CLA_MEM_SIZE-1] = onstplsv;
       voiced_mem [CLA_MEM_SIZE-1] = voiced;


       /*------------------------------------------------------*/
       /* frame_class 0: silence                          */
       /* frame_class 1: noise-like  (CURRENTLY, NOT ACTIVATED)      */
       /* frame_class 2: unvoiced                    */
       /* frame_class 3: onset                       */
       /* frame_class 4: plosive    (CURRENTLY, NOT ACTIVATED)      */
       /* frame_class 5: non-stationary voiced             */
       /* frame_class 6: stationary voiced (CURRENTLY, NOT DISTINGUISHED  */
       /*                      FROM CLASS 5           */
       /*------------------------------------------------------*/


       /*------------------------------------------------------*/


       return frame_class;


       /*------------------------------------------------------*/
       }


/*------------------------------------------------------*/


/*======================================================================*/
/* FUNCTION:  CLA_NoisUnvoiceDetect ().                  */
/*------------------------------------------------------*/
```

235

```
/* PURPOSE:  This function temporally detects noise-like unvoiced   */
/*        speech to reset the delay for the LT preprocessing and  */
/*        control the excitation weighting. The decision will be  */
/*        finalized after pitch-preprocessing.               */
/*---------------------------------------------------------------*/
/* INPUT ARGUMENTS :                          */
/*        _ (FLOAT64 []) residu:  input residual signal.      */
/*        _ (FLOAT64 []) sig:    input speech signal.       */
/*        _ (INT16)   l_frm:   input frame size.         */
/*---------------------------------------------------------------*/
/* OUTPUT ARGUMENTS :                          */
/*        _ (INT16  *) frame_class:   frame_class frame.   */
/*---------------------------------------------------------------*/
/* INPUT/OUTPUT ARGUMENTS :                        */
/*              _ None.                  */
/*---------------------------------------------------------------*/
/* RETURN ARGUMENTS :                          */
/*              _ None.                  */
/*===============================================================*/


void CLA_NoisUnvoiceDetect (FLOAT64 residu[], FLOAT64 sig[], INT16 *uv_mode,
                FLOAT64 *frm_erg, FLOAT64 *frm_sharp, INT16 l_frm)
        {
        /*-------------------------------------------------------*/

        FLOAT64 P1_SHP, P2_R1, P3_ZC, P4_RE;
        FLOAT64 X, X1, X2, Max, M, val;
        INT16   i, N;


        /*-------------------------------------------------------*/
        /*         Calculate parameter 1 : P1_SHP        */
        /*-------------------------------------------------------*/

        X = 0;
        Max = 0;
        for (i = 0; i < l_frm; i++)
                {
                M = fabs(residu[i]);
                X += M;
                if (M > Max)
```

```
                    Max = M;

            }


        P1_SHP = X / (l_frm*MAX(1.0, Max));
(*frm_sharp) = P1_SHP;


        /*-----------------------------------------------*/
        /*          Calculate parameter 2 : P2_R1        */
        /*-----------------------------------------------*/


        dot_dvector (sig+l_frm/2, sig+l_frm/2+1,   &X,          0, l_frm/2-2);
        dot_dvector (sig+l_frm/2, sig+l_frm/2,          &X2,    0, l_frm/2-1);
        P2_R1 = X / MAX(X2, 1.0);


        /*-----------------------------------------------*/
        /*          Calculate parameter 3 : P3_ZC        */
        /*-----------------------------------------------*/


        N = 0;
        for (i = 0; i < l_frm/2-1; i++)
                {
                if (sig[i+l_frm/2]*sig[i+l_frm/2+1] < 0)
                        N++;
                }


        P3_ZC = (FLOAT64)N/(l_frm/2-1.0);


        /*-----------------------------------------------*/
        /*          Calculate parameter 4 : P4_RE        */
        /*-----------------------------------------------*/


        dot_dvector (residu, residu, frm_erg, 0, l_frm/2-1);
        dot_dvector (residu+l_frm/2, residu+l_frm/2, frm_erg+1, 0, l_frm/2-1);


        X1 = frm_erg[1];
        X1 = sqrt(X1/MAX(1.0, X2));
        P4_RE = 1.0-MIN(1.0, X1);


        /*-----------------------------------------------*/
        /*          Make noise-like decision             */
```

```
          /*-------------------------------------------------*/


N = 0;

for (i = 0; i < l_frm; i++)
        {
        if (fabs(sig[i]) < 0.1)
                N++;
        }

dot_dvector (sig, sig, &val, 0, (INT32)(l_frm*0.75)-1);
X2 =  val / (l_frm*0.75);
if (X2 < 1000.0 || N*1.0/l_frm > 0.5)
        *uv_mode=0;

if (P1_SHP>0.15) *uv_mode=1;
    if ((P2_R1 < 0.60) && (P1_SHP > 0.20))
            (*uv_mode) = 2;
    if ((P3_ZC > 0.40) && (P1_SHP > 0.18))
            (*uv_mode) = 2;
    if ((P4_RE < 0.40) && (P1_SHP > 0.20))
            (*uv_mode) = 2;


          /*-------------------------------------------------*/


return;


          /*-------------------------------------------------*/
        }
```

```
/*-------------------------------------------------*/


/*=================================================*/
/* FUNCTION:  CLA_Identify_InputSpeech ().           */
/*-------------------------------------------------*/
/* PURPOSE:  This function identifys input speech as flat speech.    */
/*        The decision needs at least two sentences to update    */
/*        the memory.                              */
```

```
/*-----------------------------------------------*/
/* INPUT ARGUMENTS :                          */
/*      _ (INT16)  pp_mode:  = mode 1  or mode 0       */
/*      _ (FLOAT64) refl0 :  first reflection coeff.      */
/*      _ (FLOAT64) lsf0  :  first lsf               */
/*      _ (FLOAT64) ltp_g :  past LTP gain.           */
/*      _ (FLOAT64) lpc_g :  current LPC gain.        */
/*      _ (INT16)   vad   :  vad decision.           */
/*-----------------------------------------------*/
/* OUTPUT ARGUMENTS :                          */
/*      _ (INT16  *) flat_deci:   flat speech decision   */
/*-----------------------------------------------*/
/* INPUT/OUTPUT ARGUMENTS :                     */
/*              _ None.                        */
/*-----------------------------------------------*/
/* RETURN ARGUMENTS :                          */
/*              _ None.                        */
/*===============================================*/


void CLA_Identify_Input(INT16 pp_mode, FLOAT64 *pdcfq, FLOAT64 lsf0, FLOAT64 ltp_g,
          FLOAT64 *lpc_g, INT16 fix_rate, INT16 *flat_deci)
          {
          /*-----------------------------------------------*/

     INT16      i;
     FLOAT64 sub_refl[NP], x;


          /*-----------------------------------------------*/


     LPC_pred2refl(pdcfq, sub_refl, NP);


     (*lpc_g) = 1.0;
     for (i = 0; i < NP; i++)
       (*lpc_g) *= (1.0-sqr(sub_refl[i]));


     (*lpc_g) = -10.0*log10((*lpc_g)+EPSI);


          /*-----------------------------------------------*/
          /*               Vad counter               */
          /*-----------------------------------------------*/
```

```
if (fix_rate==RATE0_8K)
        Vad_0_Count++;
    else
        Vad_0_Count = 0;


if (pp_mode==1) {
  x=MIN((*lpc_g)/35.0, 1.0) - 2.0*sub_refl[0]+ MIN(ltp_g, 1.0) - lsf0*15;
  x *= 2.5;
  if (SVS_Count==0)
    Av_value = 0.75*x;
  else {
    if (SVS_Count<10)
       Av_value = 0.9*Av_value + 0.1*x;
    else {
      if (SVS_Count<100)
        Av_value = 0.99*Av_value + 0.01*x;
      else Av_value = 0.998*Av_value + 0.002*x;
      }
    }
  SVS_Count++;
  SVS_Count = MIN(SVS_Count, 10000);
}
else {
    if ((Av_value > 5.8) && ((*flat_deci) == 0) && (Vad_0_Count > 10)
      && (SVS_Count > 200))
            (*flat_deci) = 1;


    if ((Av_value < 5.3)  && ((*flat_deci) == 1) && (Vad_0_Count > 10)
      && (SVS_Count > 200))
            (*flat_deci) = 0;
}


    /*-------------------------------------------------*/


    return ;


    /*-------------------------------------------------*/
    }
```

```
/*-----------------------------------------------------*/


/*====================================================*/
/* FUNCTION: CLA_Class_Correct ().                    */
/*-----------------------------------------------------*/
/* PURPOSE:  This function works for                   */
/*           (1) improving voiced-unvoiced decision;   */
/*           (2) improving noise-like unvoiced decision; */
/*           (3) detecting specific "onset";           */
/*           (4) making classification for pitch preprocessing; */
/*           (5) improving vad;                        */
/*           (6) detecting voied speech with high prediction gain */
/*               but noise-like HF excitation.         */
/*-----------------------------------------------------*/
/* INPUT ARGUMENTS :                                   */
/*     _ (INT16 *)  frame_class_m :  vad decision.     */
/*        class_m, Rp_sub[], NSR, **refl, frm_sharp,   */
/*        energy_m, energy, FrmResEng, lpcgain         */
/*-----------------------------------------------------*/
/* OUTPUT ARGUMENTS :                                  */
/*        *OnSetFlag,  *NoisyV_flag                    */
/*-----------------------------------------------------*/
/* INPUT/OUTPUT ARGUMENTS :                            */
/*        *class, *class_pp, *Vad, *VUV                */
/*-----------------------------------------------------*/
/* RETURN ARGUMENTS :                                  */
/*        _None                                        */
/*====================================================*/


void CLA_Class_Correct(INT16 *frame_class, INT16 *frame_class_pp, INT16 *Vad,
                INT16 *VUV, INT16 *OnSetFlag,
                INT16 frame_class_m, FLOAT64 Rp_sub[], FLOAT64 NSR,
                FLOAT64 **refl, FLOAT64 frm_sharp, INT16 smv_mode,FLOAT64 energy_m,
                FLOAT64 energy, FLOAT64 FrmResEng, FLOAT64 lpcgain,
                INT16 *NoisyV_flag)
        {
        /*-----------------------------------------------------*/


        FLOAT64 x, y;
```

```
/*----------------------------------------------------------------*/
/*                    Class correction                    */
/*----------------------------------------------------------------*/


/*----------------------------------------------------------------*/
/*                    unvoiced to voiced                  */
/*----------------------------------------------------------------*/


if ((((*frame_class) < 3) && (frame_class_m > 2) &&
    (Rp_sub[0] > 0.43) && (Rp_sub[1] > 0.43))
            {
        if ((frm_sharp < 0.15) && ((Rp_sub[0] + Rp_sub[1]) > 0.9) &&
    (refl[2][0] > -0.4))
                            (*frame_class) = 5;
        if ((frm_sharp < 0.25) && ((Rp_sub[0]+Rp_sub[1]) > 1.0) &&
    (refl[2][0] > -0.1))
                    (*frame_class) = 5;
        if ((frm_sharp < 0.3) && ((Rp_sub[0]+Rp_sub[1]) > 1.15) &&
    (refl[2][0] >-0.1))
                    (*frame_class) = 5;
            }


/*----------------------------------------------------------------*/
/*               .       voiced to unvoiced               */
/*----------------------------------------------------------------*/


x = MIN(3*frm_sharp-0.2, 0.65);


if (((*frame_class>2) && (Rp_m_cla<x) && (Rp_sub[0]<x) &&
            (Rp_sub[1]<x) && (Rp_sub[2]<x))
                (*frame_class) = 2;


/*----------------------------------------------------------------*/
/*                    noise-like unvoiced                 */
/*----------------------------------------------------------------*/


if (((*VUV==2) && ((Rp_sub[0]>0.75) || (Rp_sub[1]>0.75)))
        (*VUV) = 3;


if (((*VUV==2) && (refl[2][0]>-0.1) &&
```

```
            ((Rp_sub[0]>0.55) || (Rp_sub[1]>0.55)))
                    (*VUV) = 3;


        if ((*VUV==2) && (frm_sharp>0.2) && ((Rp_m_cla>0.75) || (Rp_sub[2]>0.75)))
                    (*VUV) = 3;


        if ((*frame_class<3) && (*frame_class>0) &&
            (((NSR < 0.25) && (Rp_sub[1]<0.7) && (frm_sharp>0.16)) ||
            ((Rp_sub[1]<0.5) && ((*VUV)==2))))
                    (*frame_class) = 1;


        /*------------------------------------------------------*/
        /*                Onset detection                */
        /*------------------------------------------------------*/


        x = energy/MAX(energy_m, 0.1);
        y = refl[0][0]-refl[N_SF4-1][0];
        (*OnSetFlag) = (*frame_class==3) && (y+0.2*x-0.6>0) && (Rp_sub[2]>0.5);



        /*------------------------------------------------------*/
        /*        Classification for pitch preprocessing      */
        /*------------------------------------------------------*/


    if (*frame_class>=3)
        {
                (*frame_class_pp) = 2;
                if (Rp_sub[1] > 0.5)
                        (*frame_class_pp) = 3;
                if (Rp_sub[1] > 0.75)
                        (*frame_class_pp) = 4;
        }
        else
                (*frame_class_pp) = 0;
    if ((*VUV) == 0)
        (*frame_class_pp) = 0;
    if ((frame_class_m < 3) &&
        ((*frame_class < 2) || (((*frame_class) == 2) && (Rp_sub[1] < 0.5))))
                (*frame_class_pp) = -1;
```

```c
/*------------------------------------------------------------*/
/*              Making the VAD more agressive            */
/*------------------------------------------------------------*/


if (smv_mode == 2)
    {
            if ((FrmResEng < 400*L_FRM) && (refl[2][0] < 0.125) &&
                (Rp_sub[1] < 0.55) && ((*frame_class) < 3) &&
                (frm_sharp > 0.15))
                    {
                      (*frame_class) = 0;
                      (*Vad) = 0;
                    }
        }
else
        {
        if (((NSR > 0.6) || (FrmResEng < 100*L_FRM)) &&
                        (refl[2][0] < 0) && (Rp_sub[1] < 0.4) &&
                            ((*frame_class) < 3) && (frm_sharp > 0.18))
                            {
                              (*frame_class) = 0;
                              (*Vad) = 0;
                            }
            }



/*------------------------------------------------------------*/
/*    Voiced speech with high prediction gain but noise-like   */
/*                     HF excitation                      */
/*------------------------------------------------------------*/


x = 10*frm_sharp - 1.5*refl[2][0] + Rp_sub[1] + lpcgain/20.0;
*NoisyV_flag = 0;
if ((*frame_class) > 2)
        {
        if (x > 4.5)
                (*NoisyV_flag) = 1;
        if ((x > 5.7) && (frm_sharp > 0.29) && (refl[2][0] < -0.92))
                (*NoisyV_flag) = 2;
        }
```

```
        Rp_m_cla = Rp_sub[1];

        lpcg_m_cla = lpcgain;


        /*----------------------------------------------------*/


        return ;


        /*----------------------------------------------------*/

        }


/*----------------------------------------------------------*/


/*==============================================================*/
/* FUNCTION:  CLA_Rate_Select ().                     */
/*----------------------------------------------------*/
/* PURPOSE:   This function select the SMV bitrate.          */
/*----------------------------------------------------*/
/* INPUT ARGUMENTS :                          */
/*        class_m, Rp_sub[], NSR, **refl, frm_sharp,       */
/*        energy_m, energy, FrmResEng, lpcgain          */
/*----------------------------------------------------*/
/* OUTPUT ARGUMENTS :                          */
/*        *OnSetFlag,  *NoisyV_flag                 */
/*----------------------------------------------------*/
/* INPUT/OUTPUT ARGUMENTS :                       */
/*        *class, *class_pp, *Vad, *VUV              */
/*----------------------------------------------------*/
/* RETURN ARGUMENTS :                          */
/*        _None                            */
/*==============================================================*/


void CLA_Rate_Select(INT16 smv_mode, INT16 frame_class, INT16 frame_class_m,
                 INT16 onsetflag, FLOAT64 Rp[], FLOAT64 NSR, FLOAT64 sharp,
                 FLOAT64 refl0, FLOAT64 frm_eng, INT16 *codec_rate)
        {
        /*----------------------------------------------------*/


        FLOAT64 x;
```

```
/*-------------------------------------------------*/

switch (smv_mode)
        {
        /*-------------------------------------------------*/
        /*      Mode 0. Note: average rate must be equal to EVRC      */
        /*-------------------------------------------------*/

        case 0: (*codec_rate) = RATE8_5K;

                        if ((frame_class == 1) && (sharp > 0.2) &&
                                        (Rp[1] < 0.32) && (Rp[2] < 0.3))
                                                (*codec_rate) = RATE4_0K;

                        if ((frame_class == 1) && (NSR > 0.15) &&
                                        (Rp[1] < 0.5) && (Rp[2] < 0.5))
                                                (*codec_rate) = RATE4_0K;

                        if ((frame_class < 3) && (NSR > 0.5) && (refl0 < 0.0)
                                                && (Rp[1] < 0.5))
                                                (*codec_rate) = RATE4_0K;

                        if (frame_class==0)
                                        (*codec_rate) = RATE4_0K;

                        if ((frame_class == 0) && (frame_class_m==0))
                                        (*codec_rate) = RATE0_8K;
                break;


        /*-------------------------------------------------*/
        /* Mode 1. Note: average rate must be equal to 0.7 EVRC      */
        /*-------------------------------------------------*/

        case 1: (*codec_rate) = RATE8_5K;
                        x = MAX(0.77-NSR, 0.7);
                        if ((frame_class > 3) && (frame_class_m > 5) &&
                                        (Rp[0] > x) && (Rp[1] > x))
                                                (*codec_rate) = RATE4_0K;

                        if ((frame_class == 2) && (Rp[0] > 0.31) &&
```

```
                                (Rp[1] > 0.31))
                                        (*codec_rate) = RATE4_0K;

                        if ((frame_class == 2) && (sharp > 0.18))
                                (*codec_rate) = RATE4_0K;

                        if ((frame_class == 2) && (NSR > 0.5))
                                (*codec_rate) = RATE4_0K;

                        if (frame_class == 1)
                                (*codec_rate) = RATE4_0K;

                        if ((frame_class == 1) && (Rp[0] < 0.5) && (Rp[1] < 0.5)
                                        && (Rp[2] < 0.5) &&
                                        (((refl0 > 0.0) && (sharp > 0.15)) ||
                                                (sharp > 0.25)))
                                        (*codec_rate) = RATE2_0K;

                        if ((NSR > 0.08) && (frame_class == 1) && (sharp > 0.15))
                                (*codec_rate) = RATE2_0K;

                        if (frame_class == 0)
                                (*codec_rate) = RATE0_8K;
                break;

        /*---------------------------------------------------*/
        /*  Mode 2. Note: average rate must be equal to 0.55 EVRC   */
        /*---------------------------------------------------*/

        case 2: (*codec_rate) = RATE4_0K;

                        if ((OnSet == 1) && (NSR > 0.02) && (frame_class > 2))
                                (*codec_rate) = RATE8_5K;

                        if ((OnSet == 1) && (Rp[0] < 0.85) && (frame_class > 2))
                                (*codec_rate) = RATE8_5K;
                        if ((onsetflag == 1) || ((frame_class_m < 3) &&
                                (frame_class >= 3)) || (frame_class == 3))
                                        OnSet = 1;
                else
```

EP 1 214 706 B1

```
                                OnSet = 0;


            if (OnSet == 1)
                    (*codec_rate) = RATE8_5K;
            if ((frame_class > 3) && (refl0 < -0.8) && (Rp[1] < 0.5)
                            && (sharp < 0.15))
                                    (*codec_rate) = RATE8_5K;
            if ((NSR > 0.025) && (frame_class > 2) && (Rp[1] < 0.57))
                            (*codec_rate) = RATE8_5K;


            if (frame_class < 3)
                            (*codec_rate) = RATE4_0K;
            else
                    {
                    if (frm_eng < 2500*L_FRM)
                            (*codec_rate) = RATE4_0K;
                    if ((frm_eng < 5000*L_FRM) && (frame_class_m < 3)
                                    && (Rp[1] < 0.6))
                            (*codec_rate) = RATE4_0K;
                    }


            if ((frame_class == 1) && (Rp[0] < 0.5) && (Rp[1] < 0.5)
                            && (Rp[2] < 0.5) && (((refl0 > 0.0) &&
                            (sharp > 0.15)) || (sharp > 0.25)))
                                    (*codec_rate) = RATE2_0K;


            if ((NSR > 0.08) && (frame_class == 1) && (sharp > 0.15))
                            (*codec_rate) = RATE2_0K;


            if (frame_class == 0)
                            (*codec_rate) = RATE0_8K;


                break;


        default:
#ifdef VERBOSE
                printf ("Invalid SMV mode: %d\n", smv_mode);
                exit(1);
#endif
                break;
```

248

```
        }

/*-------------------------------------------------------------*/

frame_class_mm = frame_class_m;

/*-------------------------------------------------------------*/

return;

/*-------------------------------------------------------------*/
}

/*-------------------------------------------------------------*/

/*=============================================================*/
/*------------------------- END -------------------------------*/
/*=============================================================*/
```

```
/*======================================================================*/


/*======================================================================*/
/* Conexant System Inc.                         */
/* 4311 Jamboree Road                           */
/* Newport Beach, CA 92660                       */
/*----------------------------------------------------*/
/* Copyright(C) 2000 Conexant System Inc.             */
/*----------------------------------------------------*/
/* ALL RIGHTS RESERVED:                          */
/* No part of this software may be reproduced in any form or by any */
/* means or used to make any derivative work (such as transformation */
/* or adaptation) without the authorisation of Conexant System Inc. */
/*======================================================================*/
/* LIBRARY: lib_cla.h                          */
/*======================================================================*/


/*----------------------------------------------------*/
/*------------------ FUNCTIONS ------------------*/
/*----------------------------------------------------*/


void      CLA_NoisUnvoiceDetect (FLOAT64 [], FLOAT64[], INT16 *, FLOAT64 *,
                                                FLOAT64 *, INT16);

INT16    CLA_signal_classifier    (FLOAT64 *, FLOAT64, FLOAT64, INT16);


void      CLA_Class_Correct           (INT16 *, INT16 *, INT16 *, INT16 *, INT16 *,
                            INT16, FLOAT64 [], FLOAT64, FLOAT64 **,
                                  FLOAT64, INT16, FLOAT64, FLOAT64,
                                        FLOAT64, FLOAT64, INT16 *);



void      CLA_Rate_Select      (INT16 , INT16 , INT16 , INT16 , FLOAT64 [],
                                  FLOAT64 , FLOAT64 , FLOAT64 , FLOAT64 , INT16 *);


void      CLA_init_lib                (void);


void      CLA_Identify_Input (INT16, FLOAT64 *, FLOAT64, FLOAT64,
                                                    FLOAT64 *,
INT16, INT16 *);
```

```
/*==================================================================*/
/*------------------------ END --------------------------------*/
/*==================================================================*/
```

```
/*========================================================================*/


/*========================================================================*/
/* Conexant System Inc.                              */
/* 4311 Jamboree Road                                */
/* Newport Beach, CA 92660                             */
/*-----------------------------------------------------*/
/* Copyright(C) 2000 Conexant System Inc.                  */
/*-----------------------------------------------------*/
/* ALL RIGHTS RESERVED:                              */
/* No part of this software may be reproduced in any form or by any  */
/* means or used to make any derivative work (such as transformation */
/* or adaptation) without the authorisation of Conexant System Inc.  */
/*========================================================================*/
/* LIBRARY: lib_cpr.c                                 */
/*========================================================================*/


/*-----------------------------------------------------*/
/*------------------------ INCLUDE ----------------------*/
/*-----------------------------------------------------*/


#include "main.h"


/*-----------------------------------------------------*/
/*------------------------ FUNCTIONS ---------------------*/
/*-----------------------------------------------------*/


/*========================================================================*/
/* FUNCTION  : print_copyright ().                      */
/*-----------------------------------------------------*/
/* PURPOSE   : Print the Copyright Information.             */
/*-----------------------------------------------------*/
/* ALGORITHM :                                      */
/*-----------------------------------------------------*/
/* INPUT ARGUMENTS  :                                */
/*             _ None                                */
/*-----------------------------------------------------*/
/* OUTPUT ARGUMENTS :                                */
/*             _ None                                */
/*-----------------------------------------------------*/
```

```
/* INPUT/OUTPUT ARGUMENTS :                              */
/*              _ None                          */
/*-----------------------------------------------------*/
/* RETURN ARGUMENTS :                          */
/*              _ None.                         */
/*=====================================================================*/


void     print_copyright (void)
         {
         /*---------------------------------------------------*/


         printf("\n   /**************************************************\n");
         printf("   /*                               */\n");
         printf("   /*   SMV Speech Codec Floating Point Simulation   */\n");
         printf("   /*                               */\n");
         printf("   /* These executable and sources files are delivered */\n");
         printf("   /*   under NDA and are SOLELY to be used for the   */\n");
         printf("   /*   purpose of the 3GPP SMV Collaboration Phase.  */\n");
         printf("   /*                               */\n");
         printf("   /*      Any other use is STRICTLY prohibited.     */\n");
         printf("   /*                               */\n");
         printf("   /*                               */\n");
         printf("   /*         Version 1.0, 30 June 2000        */\n");
         printf("   /*                               */\n");
         printf("   /*    This executable, all sources, object        */\n");
         printf("   /*    and processed files should be deleted by     */\n");
         printf("   /*    the and of the collaboration phase or at     */\n");
         printf("   /*    any time upon the Conexant's request.       */\n");
         printf("   /*                               */\n");
         printf("   /*          CONEXANT SYSTEMS Inc.           */\n");
         printf("   /*                               */\n");
         printf("   /*   All Rights Reserved, November 1999 - June 2000 */\n");
         printf("   /*                               */\n");
         printf("   /**************************************************\n\n");


         /*---------------------------------------------------*/


         return;


         /*---------------------------------------------------*/
```

```
        }


/*--------------------------------------------------------------------*/


/*==================================================================*/
/*------------------------ END ------------------------------*/
/*==================================================================*/




/*==================================================================*/



/*==================================================================*/
/* Conexant System Inc.                           */
/* 4311 Jamboree Road                             */
/* Newport Beach, CA 92660                         */
/*-------------------------------------------------*/
/* Copyright(C) 2000 Conexant System Inc.              */
/*-------------------------------------------------*/
/* ALL RIGHTS RESERVED:                             */
/* No part of this software may be reproduced in any form or by any  */
/* means or used to make any derivative work (such as transformation */
/* or adaptation) without the authorisation of Conexant System Inc.  */
/*==================================================================*/
/* PROTOYPE FILE: lib_cpr.h                        */
/*==================================================================*/


/*--------------------------------------------------------------------*/
/*------------------------ FUNCTIONS ----------------------------*/
/*--------------------------------------------------------------------*/


void    print_copyright  (void);


/*==================================================================*/
/*------------------------ END ------------------------------*/
/*==================================================================*/
```

```
/*====================================================================*/


/*====================================================================*/
/* Conexant System Inc.                         */
/* 4311 Jamboree Road                           */
/* Newport Beach, CA 92660                        */
/*--------------------------------------------------*/
/* Copyright(C) 2000 Conexant System Inc.              */
/*--------------------------------------------------*/
/* ALL RIGHTS RESERVED:                        */
/* No part of this software may be reproduced in any form or by any  */
/* means or used to make any derivative work (such as transformation */
/* or adaptation) without the authorisation of Conexant System Inc.  */
/*====================================================================*/
/* LIBRARY: lib_dia.c                         */
/*====================================================================*/


#ifdef DIAG_SMV


/*--------------------------------------------------*/
/*------------------------ INCLUDE ------------------------*/
/*--------------------------------------------------*/


#include "typedef.h"

#include "main.h"
#include "const.h"
#include "ext_var.h"

#include "mcutil.h"
#include "gputil.h"

#include "lib_dia.h"
#include "lib_swb.h"


/*--------------------------------------------------*/
/*------------------------ FUNCTIONS ------------------------*/
/*--------------------------------------------------*/


/*====================================================================*/
```

255

```
/* FUNCTION     : DIA_enc_open_files ().                    */
/*----------------------------------------------------------*/
/* PURPOSE      : This function open the diagnostics files.  */
/*----------------------------------------------------------*/
/* INPUT ARGUMENTS :                                         */
/*              _ None.                       .  */
/*----------------------------------------------------------*/
/* OUTPUT ARGUMENTS :                                        */
/*              _ None.                        */
/*----------------------------------------------------------*/
/* INPUT/OUTPUT ARGUMENTS :                                  */
/*              _ None.                        */
/*----------------------------------------------------------*/
/* RETURN ARGUMENTS :                                        */
/*              _ None.                        */
/*==========================================================*/


void DIA_enc_open_files (void)
        {
        /*------------------------------------------------*/
        /*              Encoder unquantized              */
        /*------------------------------------------------*/


        fdia_vad = file_open_wb ("vad.enc");


        /*------------------------------------------------*/
        /*              Encoder quantized                */
        /*------------------------------------------------*/


        fdia_sp_enc = file_open_wb ("sp_out.enc");


        /*------------------------------------------------*/


        return;


        /*------------------------------------------------*/
        }


/*------------------------------------------------------------*/
```

```c
/*==================================================================*/
/* FUNCTION     : DIA_enc_close_files ().                   */
/*-----------------------------------------------------------------*/
/* PURPOSE    : This function close the diagnostics files.   */
/*-----------------------------------------------------------------*/
/* INPUT ARGUMENTS :                               */
/*          _ None.                         */
/*-----------------------------------------------------------------*/
/* OUTPUT ARGUMENTS :                              */
/*          _ None.                         */
/*-----------------------------------------------------------------*/
/* INPUT/OUTPUT ARGUMENTS :                           */
/*          _ None.                         */
/*-----------------------------------------------------------------*/
/* RETURN ARGUMENTS :                              */
/*          _ None.                         */
/*==================================================================*/


void DIA_enc_close_files (void)
        {
        /*-----------------------------------------------------------*/
        /*              Encoder unquantized            */
        /*-----------------------------------------------------------*/

        fclose (fdia_vad);


        /*-----------------------------------------------------------*/
        /*              Encoder quantized              */
        /*-----------------------------------------------------------*/


        fclose (fdia_sp_enc);


        /*-----------------------------------------------------------*/

        return;


        /*-----------------------------------------------------------*/
        }
```

```
/*-----------------------------------------------------------------------------*/


/*============================================================================*/
/* FUNCTION    : DIA_dec_open_files ().                    */
/*-----------------------------------------------------------------*/
/* PURPOSE     : This function open the diagnostics files.    */
/*-----------------------------------------------------------------*/
/* INPUT ARGUMENTS :                          */
/*              _ None.                       */
/*-----------------------------------------------------------------*/
/* OUTPUT ARGUMENTS :                         */
/*              _ None.                       */
/*-----------------------------------------------------------------*/
/* INPUT/OUTPUT ARGUMENTS :                     */
/*              _ None.                       */
/*-----------------------------------------------------------------*/
/* RETURN ARGUMENTS :                .         */
/*              _ None.                       */
/*============================================================================*/


void DIA_dec_open_files (void)
        {
        /*-----------------------------------------------------------------*/


        /*-----------------------------------------------------------------*/


        return;


        /*-----------------------------------------------------------------*/
        }


/*-----------------------------------------------------------------*/


/*============================================================================*/
/* FUNCTION    : DIA_dec_close_files ().                   */
/*-----------------------------------------------------------------*/
/* PURPOSE     : This function close the diagnostics files.   */
/*-----------------------------------------------------------------*/
/* INPUT ARGUMENTS :                          */
/*              _ None.                       */
```

```
/*----------------------------------------------------*/
/* OUTPUT ARGUMENTS :                      */
/*          _ None.                  */
/*----------------------------------------------------*/
/* INPUT/OUTPUT ARGUMENTS :                 */
/*          _ None.                  */
/*----------------------------------------------------*/
/* RETURN ARGUMENTS :                      */
/*          _ None.                  */
/*====================================================*/


void DIA_dec_close_files (void)
        {
        /*--------------------------------------------*/


        /*--------------------------------------------*/


        return;


        /*--------------------------------------------*/
        }



        /*--------------------------------------------*/


        /*============================================*/
/* FUNCTION  : DIA_trace_data ().            */
/*--------------------------------------------*/
/* PURPOSE   : Trace the value of the variable by writing a file   */
/*          with data alined with the input signal.    */
/*--------------------------------------------*/
/* INPUT ARGUMENTS :                       */
/*          _ (FLOAT64 ) val:      variable to trace.    */
/*          _ (INT16   ) data_size:  output data size.   */
/*          _ (FLOAT64 ) scale_factor: scale factor for val.   */
/*          _ (FILE   *) file_data:  output file name.    */
/*--------------------------------------------*/
/* OUTPUT ARGUMENTS :                      */
/*          _ None                  */
/*--------------------------------------------*/
```

259

```
/* INPUT/OUTPUT ARGUMENTS :                              */
/*              _ None                        */
/*------------------------------------------------------*/
/* RETURN ARGUMENTS :                            */
/*              _ None.                       */
/*======================================================*/


void    DIA_trace_data (FLOAT64 val, INT16 data_size, FLOAT64 scale_factor,
                               FILE *file_data)
        {
        /*-------------------------------------------------*/


        INT16 *s_val;


        INT16 i, wt_samp;


        /*-------------------------------------------------*/
        /*              Memory Allocation            */
        /*-------------------------------------------------*/


        s_val = svector (0, data_size-1);


        /*-------------------------------------------------*/


        s_val [0] = (INT16) (scale_factor * val);


        for (i = 1; i < data_size; i ++)
                    s_val [i] = s_val [0];


#ifdef BYTE_SWAP_OUTPUT


        for (i = 0; i < data_size; i ++)
                    s_val[i] = byte_swap_int16(s_val[i]);


#endif


        wt_samp = fwrite (s_val, sizeof (INT16), data_size, file_data);


#ifdef VERBOSE
```

```
        if (wt_samp != data_size)
                nrerror("Error Writing output Samples!");
#endif


        /*-----------------------------------------------*/
        /*                  Memory Free                */
        /*-----------------------------------------------*/


        free_svector (s_val, 0, data_size-1);


        /*-----------------------------------------------*/


        return;


        /*-----------------------------------------------*/
        }


/*-----------------------------------------------*/


/*===============================================*/
/* FUNCTION  : DIA_trace_sig ().                 */
/*-----------------------------------------------*/
/* PURPOSE   : Trace a signal by scaling it and writing a file   */
/*            with data alined with the input signal.            */
/*-----------------------------------------------*/
/* INPUT ARGUMENTS :                             */
/*         _ (FLOAT64 []) x:        signal to trace.             */
/*         _ (INT16   ) x_size:     output signal size.          */
/*         _ (FLOAT64 ) scale_factor: scale factor for val.      */
/*         _ (FILE   *) file_x:     output file name.            */
/*-----------------------------------------------*/
/* OUTPUT ARGUMENTS :                            */
/*              _ None                           */
/*-----------------------------------------------*/
/* INPUT/OUTPUT ARGUMENTS :                      */
/*              _ None                           */
/*-----------------------------------------------*/
/* RETURN ARGUMENTS :                            */
/*              _ None.                          */
/*===============================================*/
```

261

```
void     DIA_trace_sig (FLOAT64 x [], INT16 x_size, FLOAT64 scale_factor,
                                                      FILE *file_x)
         {
         /*------------------------------------------------------------*/


         INT16 *s_x;
         INT16 i, wt_samp;


         /*------------------------------------------------------------*/
         /*                    Memory Allocation                    */
         /*------------------------------------------------------------*/


         s_x = svector (0, x_size-1);


         /*------------------------------------------------------------*/


         for (i = 0; i < x_size; i ++)
                 s_x [i] = (short) nint(scale_factor * x [i]);


#ifdef BYTE_SWAP_OUTPUT

         for (i = 0; i < x_size; i ++)
                         s_x[i] = byte_swap_int16(s_x[i]);


#endif


         wt_samp = fwrite (s_x, sizeof (INT16), x_size, file_x);


#ifdef VERBOSE
         if (wt_samp != x_size)
                 nrerror("Error Writing output Samples!");
#endif


         /*------------------------------------------------------------*/
         /*                    Memory Free                    */
         /*------------------------------------------------------------*/


         free_svector (s_x, 0, x_size-1);
```

```
    /*---------------------------------------------------*/

    return;

    /*---------------------------------------------------*/
    }

/*---------------------------------------------------*/

#endif

/*===================================================================*/
/*------------------------------- END ---------------------------------*/
/*===================================================================*/
```

```
/*==============================================================*/


/*==============================================================*/
/* Conexant System Inc.                    */
/* 4311 Jamboree Road                      */
/* Newport Beach, CA 92660                  */
/*--------------------------------------------------*/
/* Copyright(C) 2000 Conexant System Inc.         */
/*--------------------------------------------------*/
/* ALL RIGHTS RESERVED:                  */
/* No part of this software may be reproduced in any form or by any  */
/* means or used to make any derivative work (such as transformation */
/* or adaptation) without the authorisation of Conexant System Inc.  */
/*==============================================================*/
/* PROTOYPE FILE: lib_dia.h                  */
/*==============================================================*/


/*--------------------------------------------------*/
/*------------------------ FUNCTIONS ------------------------*/
/*--------------------------------------------------*/


void    DIA_enc_open_files      (void);
void    DIA_enc_close_files     (void);


void    DIA_dec_open_files     (void);
void    DIA_dec_close_files     (void);



void    DIA_trace_data (FLOAT64, INT16, FLOAT64, FILE *);


void    DIA_trace_sig  (FLOAT64 [], INT16, FLOAT64, FILE *);



/*==============================================================*/
/*------------------------ END ------------------------*/
/*==============================================================*/
```

264

```
/*=========================================================================*/


/*=====================================================================*/
/* Conexant System Inc.                        */
/* 4311 Jamboree Road                          */
/* Newport Beach, CA 92660                      */
/*------------------------------------------------*/
/* Copyright(C) 2000 Conexant System Inc.              */
/*------------------------------------------------*/
/* ALL RIGHTS RESERVED:                        */
/* No part of this software may be reproduced in any form or by any */
/* means or used to make any derivative work (such as transformation */
/* or adaptation) without the authorisation of Conexant System Inc. */
/*=====================================================================*/
/* LIBRARY: lib_fcs.c                        */
/*=====================================================================*/


/*------------------------------------------------*/
/*---------------------- INCLUDE --------------------*/
/*------------------------------------------------*/


#include "typedef.h"

#include "main.h"
#include "const.h"
#include "gputil.h"
#include "mcutil.h"
#include "ext_var.h"

#include "lib_fcs.h"
#include "lib_gcb.h"
#include "lib_flt.h"
#include "lib_lpc.h"
#include "lib_ppp.h"


#include "tracks.tab"


/*------------------------------------------------*/
/*--------------------- FUNCTIONS -------------------*/
/*------------------------------------------------*/
```

```
/*===================================================================*/
/* FUNCTION    : FCS_init_lib ().                          */
/*-----------------------------------------------------------*/
/* PURPOSE     : This function performs the initialisation of the */
/*               global variables of the library FCS.       */
/*-----------------------------------------------------------*/
/* INPUT ARGUMENTS :                                      */
/*      _ None.                                           */
/*-----------------------------------------------------------*/
/* OUTPUT ARGUMENTS :                                     */
/*      _ None.                                           */
/*-----------------------------------------------------------*/
/* INPUT/OUTPUT ARGUMENTS :                               */
/*      _ None.                                           */
/*-----------------------------------------------------------*/
/* RETURN ARGUMENTS :                                     */
/*      _ None.                                           */
/*===================================================================*/


void FCS_init_lib (void)
        {
        /*-----------------------------------------------------------*/


        seed_bfi_exc = (INT64)21845;


        /*-----------------------------------------------------------*/


        lpcg_m        = 0.0;
        alpha         = 0.0125;
        lag_m         = 20;
        SVS_flag_m = 0;


        /*-----------------------------------------------------------*/
        /*          High frequency Noise filter initialisation      */
        /*-----------------------------------------------------------*/


        FCS_Init_HF_Noise (hh_hf, L_HF);


        /*-----------------------------------------------------------*/
```

```
/*              Pulse code-books initialisation        */
/*----------------------------------------------------*/


FCS_Init_CPCB();


/*----------------------------------------------------*/
/*                  13 bits                        */
/*----------------------------------------------------*/


Stab_13b_enc = 0.0;
Stab_13b_dec = 0.0;


/*----------------------------------------------------*/
/*                  15 bits                        */
/*----------------------------------------------------*/


Stab_15b_enc = 0.0;
Stab_15b_dec = 0.0;




/*----------------------------------------------------*/


return;


/*----------------------------------------------------*/
}


/*----------------------------------------------------*/


/*====================================================*/
/* FUNCTION    : FCS_Init_CPCB ().                    */
/*----------------------------------------------------*/
/* PURPOSE     : This function performs the initialisation of the */
/*               pulse code-books.                    */
/*----------------------------------------------------*/
/* INPUT ARGUMENTS :                                 */
/*      _ None.                                      */
/*----------------------------------------------------*/
/* OUTPUT ARGUMENTS :                                */
```

```
/*      _ None.                            */
/*------------------------------------------------*/
/* INPUT/OUTPUT ARGUMENTS :                 */
/*      _ None.                            */
/*------------------------------------------------*/
/* RETURN ARGUMENTS :                       */
/*      _ None.                            */
/*================================================================*/


void FCS_Init_CPCB (void)
       {
       /*------------------------------------------------*/


       INT16  n, i, ph_mode;


       /*------------------------------------------------*/



       /*------------------------------------------------*/
       /*=================== 2 pulses CB ===================*/
       /*------------------------------------------------*/


       /*------------------------------------------------*/
       /* 2 pulses CB : 2pulses x 5bits/pulse + 2 signs = 12 bits    */
       /*------------------------------------------------*/


       for (i = 0; i < 2; i++)
              for (n = 0; n < 32; n++)
                     p_track_2_5_0[i][n] = track_2_5_0[i][n];


       /*------------------------------------------------*/
       /* 2 pulses CB: 2pulses x 7 bits/pulse + 1 sign  = 15 bits    */
       /*------------------------------------------------*/


       for (i = 0; i < 2;i++)
              for (n = 0; n < 80; n++)
                     p_track_2_7_1[i][n] = track_2_7_1[i][n];



       /*------------------------------------------------*/
```

```
/*======================= 3 pulses CB =========================*/
/*------------------------------------------------------------*/

for (ph_mode = 0; ph_mode < 16 ; ph_mode++)
        {
        for (i = 0; i < 3; i++)
                for (n = 0; n < 4; n++)
                        p_track_3_2_80[ph_mode][i][n] = track_3_2_0[i][n] +

track_1_4_0[0][ph_mode];
        for (i = 0; i < 3; i++)
                for (n = 0; n < 4; n++)
                        p_track_3_2_54[ph_mode][i][n] = track_3_2_0[i][n] +

track_1_3_0[0][ph_mode];
        }


        /*------------------------------------------------------------*/
        /*======================= 5 pulses CB =========================*/
        /*------------------------------------------------------------*/

for (i = 0; i < 5; i++)
        for (n = 0; n < 16;n++)
                p_track_5_4_0[i][n] = track_5_4_0[i][n];


for (i = 0; i < 5; i++)
        for (n = 0; n < 8; n++)
                p_track_5_3_1[i][n] = track_5_3_1[i][n];


for (i = 0; i < 5; i++)
        for (n = 0; n < 8; n++)
                p_track_5_3_2[i][n] = track_5_3_2[i][n];

        /*------------------------------------------------------------*/
        /*======================= 8 pulses CB =========================*/
        /*------------------------------------------------------------*/
```

```
for (i = 0; i < 8; i++)
        for (n = 0; n < 16; n++)
                p_track_8_4_0[i][n] = track_8_4_0[i][n];


        /*----------------------------------------------------*/


        return;


        /*----------------------------------------------------*/

        }


/*----------------------------------------------------------*/


/*==========================================================*/
/* FUNCTION      : FCS_Set_CPCB ().                          */
/*----------------------------------------------------------*/
/* PURPOSE      : This function performs the fixed codebook  */
/*                initialisation.                            */
/*----------------------------------------------------------*/
/* INPUT ARGUMENTS :                                         */
/*        _ (INT16) phas_mode:   initial phase for the pulses. */
/*        _ (INT16) bit_p:     number of bits.               */
/*        _ (INT16) n_p:       number of pulses.             */
/*        _ (INT16) Lex:       excitation length.            */
/*----------------------------------------------------------*/
/* OUTPUT ARGUMENTS :                                        */
/*        _ None.                                            */
/*----------------------------------------------------------*/
/* INPUT/OUTPUT ARGUMENTS :                                  */
/*        _ None.                                            */
/*----------------------------------------------------------*/
/* RETURN ARGUMENTS :                                        */
/*        _ None.                                            */
/*==========================================================*/


void FCS_Set_CPCB (INT16 phas_mode, INT16 bit_p, INT16 n_p, INT16 Lex)
        {
        /*----------------------------------------------------*/
```

```
INT16  i;

/*------------------------------------------------*/

switch (n_p)
        {

        /*------------------------------------------------*/
        /*==================== 2 pulses CB ====================*/
        /*------------------------------------------------*/

        case 2:

        /*------------------------------------------------*/
        /* 2 pulses CB : 2pulses x 5bits/pulse + 2 signs = 12 bits   */
        /*------------------------------------------------*/

            if (phas_mode == 0)
                {
                for (i = 0; i < 2; i++)
                        MaxIdx [i] = 32;

                track = p_track_2_5_0;
                }

        /*------------------------------------------------*/
        /* 2 pulses CB: 2pulses x 6.5bits/pulse + 1 sign  = 14 bits   */
        /*------------------------------------------------*/

            if (phas_mode == 1)
                {
            for (i = 0; i < 2; i++)
                        MaxIdx[i] = 80;

                track = p_track_2_7_1;
                }

            break;

        /*------------------------------------------------*/
```

```
/*====================== 3 pulses CB =====================*/
/*---------------------------------------------------*/


case 3:


if (Lex == L_SF)
        {
        /*---------------------------------------------------*/
        /*   3 pulses CB : 3 pulses x 2 bits/pulse +       */
        /*                        3 signs = 9 bits    */
        /*---------------------------------------------------*/


        for (i = 0; i < 3; i++)
                MaxIdx [i] = 4;


        track = p_track_3_2_80 [phas_mode];


        /*---------------------------------------------------*/
        }
    else
        {
        /*---------------------------------------------------*/
        /* 3 pulses CB :  3 pulses x 2 bits/pulse +       */
        /*                        3 signs = 9 bits */
        /* 3 pulses CB : 3 pulses x  2 bits/pulse + 3 signs */
        /*                + 3bits center = 11 bits */
        /*---------------------------------------------------*/


        for (i = 0; i < 3; i++)
                MaxIdx[i] = 4;


        track = p_track_3_2_54 [phas_mode];
        }


        break;


/*---------------------------------------------------*/
/*====================== 5 pulses CB =====================*/
/*---------------------------------------------------*/
```

```
case 5:

/*-------------------------------------------------------*/
/*    5 pulses CB : 3p x 4b + 2p x 3b + 3b signs = 21 bits   */
/*-------------------------------------------------------*/


if (phas_mode == 0)
        {
        for (i = 0; i < 5; i++)
                MaxIdx [i] = 16;
        MaxIdx [2] = 8;
        MaxIdx [4] = 8;
        track = p_track_5_4_0;
        }


/*-------------------------------------------------------*/
/*    5 pulses CB : 5p x 3b + 5b signs = 20 bits            */
/*-------------------------------------------------------*/


if (phas_mode == 1)
        {
        for (i = 0; i < 5; i++)
                MaxIdx [i] = 8;
        track = p_track_5_3_1;
        }


/*-------------------------------------------------------*/
/*    5 pulses CB : 5p x 3b + 5b signs = 20 bits            */
/*-------------------------------------------------------*/


if (phas_mode == 2)
        {
        for (i = 0; i < 5; i++)
                MaxIdx [i] = 8;
        track = p_track_5_3_2;
        }


break;


/*-------------------------------------------------------*/
```

```
/*===================== 8 pulses CB =====================*/
/*--------------------------------------------------*/

case 8:
;

        /*--------------------------------------------------*/
        /*   8 pulses CB : 6p x 3b + 2p x 4b + 4b signs = 30 bits   */
        /*--------------------------------------------------*/

)       for (i = 0; i < 8; i++)
                MaxIdx[i] = 8;
        MaxIdx[0] = 16;
        MaxIdx[4] = 16;
        track=p_track_8_4_0;

        break;

        /*--------------------------------------------------*/

        default:
#ifdef VERBOSE
                nrerror(" Error in the definition of track[][]   !!");
#endif
                break;

        /*--------------------------------------------------*/
        }

    /*--------------------------------------------------*/

    return;

    /*--------------------------------------------------*/
    }

/*--------------------------------------------------*/

/*==================================================*/
/* FUNCTION     : FCS_Init_HF_Noise ().             */
/*--------------------------------------------------*/
```

```
/* PURPOSE    : This function generated a impulse response    */
/*             introducing a random noise in the high        */
/*             frequencies.                                   */
/*----------------------------------------------------------*/
/* INPUT ARGUMENTS :                                          */
/*      _ (INT16   ) l_sf:   sub-frame size.                  */
/*----------------------------------------------------------*/
/* OUTPUT ARGUMENTS :                                         */
/*      _ (FLOAT64 []) hh_hf:   high frequency noise impulse  */
/*                   response.                                */
/*----------------------------------------------------------*/
/* INPUT/OUTPUT ARGUMENTS :                                   */
/*          _ None.                                           */
/*----------------------------------------------------------*/
/* RETURN ARGUMENTS :                                         */
/*          _ None.                                           */
/*==========================================================*/


void FCS_Init_HF_Noise (FLOAT64 hh_hf[], INT16 l_hf)
        {
        /*------------------------------------------------*/

        INT64  seed;
        FLOAT64        Z1=0, Z2=0;
        INT16  i;
        FLOAT64        x;


        /*------------------------------------------------*/
        /*              Initialisation                    */
        /*------------------------------------------------*/


        seed    = 56672;
        Z1      = 0;
        Z2      = 0;

        for (i = 0; i < l_hf; i++)
                hh_hf[i] = GCB_gauss_noise(&seed);

        for (i = 0; i < l_hf; i++)
                {
```

```
        x  = hh_hf[i] - Z1;
        Z1 = hh_hf[i];
        hh_hf[i] = x;


        x        = hh_hf[i] - Z2;
        Z2       = hh_hf[i];
        hh_hf[i] = x;
        }


    for (i = 0; i < l_hf; i++)
            {
            x = cos(i*PI*1.0/l_hf);
            hh_hf[i] *= 0.03*(0.55 + 0.45*x);
            }


    hh_hf [0] = 1.0;

        /*----------------------------------------------------------*/


    return;

        /*----------------------------------------------------------*/
        }




/*--------------------------------------------------------------*/


/*==============================================================*/
/* FUNCTION    : FCS_DetermPulsLoc ().                    */
/*----------------------------------------------------------*/
/* PURPOSE      : This function determines all pulse positions    */
/*               and their magnitudes in terms of the pitch     */
/*               function and the main pulse whose position      */
/*               needs to be coded.                      */
/*----------------------------------------------------------*/
/* INPUT ARGUMENTS :                            */
/*        _ (FLOAT64  )  PitGain:  current pitch gain.       */
/*        _ (INT16   )  pitch:    current pitch value.      */
/*        _ (FLOAT64  )  Mag:      current pulse mgnitude.     */
/*        _ (INT16   )  Loc:     current pulse position.     */
```

```
/*      _ (INT16   )  l_sf:   sub-frame length.        */
/*------------------------------------------------------*/
/* OUTPUT ARGUMENTS :                          */
/*      _ (FLOAT64 [])  MagV:   array of pulse magnitudes.   */
/*      _ (INT16   [])  LocV:   array of locations magnitudes.*/
/*      _ (INT16   *)  NumPit:   number of pulses.        */
/*------------------------------------------------------*/
/* INPUT/OUTPUT ARGUMENTS :                      */
/*      _ None.                          */
/*------------------------------------------------------*/
/* RETURN ARGUMENTS :                          */
/*      _ None.                          */
/*======================================================*/


void FCS_DetermPulsLoc (FLOAT64 PitGain, INT16 pitch, FLOAT64 Mag, INT16 Loc,
                        FLOAT64 MagV[], INT16 LocV[], INT16 *NumPit,
                        INT16 l_sf)
        {
        /*----------------------------------------------*/

        INT16  i, N, M, max_i;

        /*----------------------------------------------*/

        MagV [0] = Mag;
        LocV [0] = Loc;
        N = 0;
        if (PitGain < 0.4)
                max_i = 3;
        else
                max_i = 4;

        for (i = 1; i < max_i; i++)
                {
                if ((Loc + pitch * i) < l_sf)
                        {
                        MagV[i] = MagV[i-1]*PitGain;
                        LocV[i] = Loc + pitch*i;
                        N = i;
                        }
```

```
            else
                break;
        }


    /*----------------------------------------------------------------*/

M = N;

    /*----------------------------------------------------------------*/


if (((Loc-pitch) >= 0) && ((N+1) < max_i))
        {
        MagV [1+N] = MagV[0]*PitGain;
        LocV [1+N] = Loc-pitch;
        M = N+1;

        for (i = 2; i < max_i-N; i++)
                {
                if ((Loc - pitch*i) >= 0)
                        {
                         MagV[i+N]=MagV[i+N-1]*PitGain;
                         LocV[i+N]=Loc-pitch*i;
                         M = N+i;
                        }
                else
                        break;
                }
        }

    /*----------------------------------------------------------------*/

(*NumPit) = M+1;

    /*----------------------------------------------------------------*/

return;

    /*----------------------------------------------------------------*/
}
```

```
/*------------------------------------------------------------*/


/*============================================================*/
/* FUNCTION    : FCS_One_Search_CPCB ().                    */
/*------------------------------------------------------------*/
/* PURPOSE     : This function determines the position of one   */
/*               pulse using the forward pitch enhancement.     */
/*------------------------------------------------------------*/
/* INPUT ARGUMENTS :                                          */
/*      _ (INT16   ) n_p:   number of pulses.              */
/*      _ (INT16  []) Idx:   array of idexes.              */
/*      _ (FLOAT64 []) Mag:   array of current pulse mgnitude.*/
/*      _ (FLOAT64 []) ref_sig: target signal.             */
/*      _ (INT16  []) IdxOpt: optimized index array.        */
/*      _ (INT16  []) PosOpt: optimized pulse postion array.  */
/*------------------------------------------------------------*/
/* OUTPUT ARGUMENTS :                                         */
/*      _ (FLOAT64 *) Rn_m:   maximized criterion numerator.  */
/*      _ (INT16   *) Rd_m:   maximized criterion denominator.*/
/*------------------------------------------------------------*/
/* INPUT/OUTPUT ARGUMENTS :                                   */
/*      _ (FLOAT64 *) MaxCrit: maximized criterion.          */
/*------------------------------------------------------------*/
/* RETURN ARGUMENTS :        . ,                            */
/*      _ None.                                            */
/*============================================================*/


void FCS_One_Search_CPCB(INT16 n_p, INT16 Idx [], FLOAT64 Mag [],
                          FLOAT64 ref_sig [], INT16 IdxOpt [],
                                INT16 PosOpt [], FLOAT64 *MaxCrit,
                                      FLOAT64 *Rn_m, FLOAT64 *Rd_m)

    {
    /*------------------------------------------------------------*/


    INT16   n, k, Pos[MAXPN];
    FLOAT64       GG, Rn, Rd;


    /*------------------------------------------------------------*/


    for (n = 0; n < n_p; n++)
```

```
        Pos[n] = track[n][Idx[n]];


Rn = 0;
for (n = 0; n < n_p; n++)
        Rn += ref_sig[Pos[n]]*Mag[n];


/*------------------------------------------------------------*/


Rd=0;
for (n = 0; n < n_p-1; n++)
        for (k = n+1; k < n_p; k++)
                Rd += Mag[n]*PHI[Pos[n]][Pos[k]]*Mag[k];


Rd *= 2;


for (n = 0; n < n_p; n++)
        Rd += Mag[n]*PHI[Pos[n]][Pos[n]]*Mag[n];


/*------------------------------------------------------------*/


GG = Rn*Rn / MAX(0.1,Rd);
if (GG > (*MaxCrit))
        {
        (*MaxCrit) = GG;
        for (n = 0; n < n_p; n++)
                {
                IdxOpt[n] = Idx[n];
                PosOpt[n] = Pos[n];
            }
        (*Rn_m) = Rn;
        (*Rd_m) = Rd;
        }


/*------------------------------------------------------------*/


return;


/*------------------------------------------------------------*/
}
```

```
/*----------------------------------------------------------------*/

/*================================================================*/
/* FUNCTION    : FCS_One_Search_4kCB ().                     */
/*----------------------------------------------------------------*/
/* PURPOSE     : This function determines the position of one  */
/*                pulse using the forward + backward pitch      */
/*                enhancement.                              */
/*----------------------------------------------------------------*/
/* INPUT ARGUMENTS :                                   */
/*       _ (INT16   [])  SignTab: array of pulse signs.        */
/*       _ (FLOAT64  )  pit_g:  current pitch gain.           */
/*       _ (INT16    )  lag:    current pitch value.         */
/*       _ (INT16    )  n_p:    number of pulses.            */
/*       _ (INT16    )  no_p:   pulse number.               */
/*       _ (INT16   [])  Idx:    array of idexes.            */
/*       _ (FLOAT64 [])  Mag:    array of current pulse mgnitude.*/
/*       _ (FLOAT64 [])  ref_sig: target signal.             */
/*       _ (INT16    )  l_sf:   sub-frame size.             */
/*----------------------------------------------------------------*/
/* OUTPUT ARGUMENTS :                                  */
/*       _ (INT16   [])  IdxOpt: optimized index array.       */
/*       _ (INT16   [])  PosOpt: optimized pulse postion array.  */
/*       _ (FLOAT64  *)  Rn_m:   maximized criterion numerator.  */
/*       _ (INT16    *)  Rd_m:   maximized criterion denominator.*/
/*----------------------------------------------------------------*/
/* INPUT/OUTPUT ARGUMENTS :                             */
/*       _ (FLOAT64  *)  MaxCrit: maximized criterion.         */
/*----------------------------------------------------------------*/
/* RETURN ARGUMENTS :                                  */
/*       _ None.                                       */
/*================================================================*/

void FCS_One_Search_4kCB (INT16 SignTab[], INT16 lag, FLOAT64 pit_g, INT16 no_p,
                          INT16 n_p, INT16 Idx [], FLOAT64 Mag [],
                          FLOAT64 ref_sig [], INT16 IdxOpt [],
                          INT16 PosOpt [], FLOAT64 *MaxCrit,
                          FLOAT64 *Rn_m, FLOAT64 *Rd_m, INT16 l_sf)
        {
        /*----------------------------------------------------------------*/
```

```
INT16   n, k, Pos[MAXPN], Num, NumP, LocP[MAX_FB_PULSE_NUM*MAXPN];
FLOAT64 GG, Rn, Rd, Rd1, MagP[MAX_FB_PULSE_NUM*MAXPN];


/*-------------------------------------------------------------*/
/*              Determine pulses positions              */
/*-------------------------------------------------------------*/


NumP = 0;
for (n = 0; n < n_p; n++)
        {
        Pos[n] = track[n][Idx[n]];
        FCS_DetermPulsLoc (pit_g, lag, (Mag[n]*SignTab[Pos[n]]),
                                        Pos[n], MagP+NumP, LocP+NumP, &Num, 1_sf);
        NumP += Num;
        }


/*-------------------------------------------------------------*/
/*                    Correlation                 */
/*-------------------------------------------------------------*/


Rn = 0;
for (n = 0; n < NumP; n++)
        Rn += ref_sig[LocP[n]]*MagP[n];


/*-------------------------------------------------------------*/
/*                    Energy                      */
/*-------------------------------------------------------------*/


Rd = 0;
for (n = 0; n < NumP-1; n++)
        {
        Rd1 = 0.0;
        for (k = n+1; k < NumP; k++)
                Rd1 += PHI[LocP[n]][LocP[k]]*MagP[k];

        Rd1 *= MagP[n];
        Rd += Rd1;
        }
```

```
        Rd *= 2;


        for (n = 0; n < NumP; n++)
                Rd += MagP[n]*PHI[LocP[n]][LocP[n]]*MagP[n];


        /*-----------------------------------------------------*/
        /*         Criterion calculation and maximisation      */
        /*-----------------------------------------------------*/


        GG = Rn*Rn / MAX(0.1, Rd);


        if (GG > (*MaxCrit))
                {
                (*MaxCrit) = GG;
                IdxOpt [no_p] = Idx[no_p];
                PosOpt [no_p] = Pos[no_p];


                (*Rn_m) = Rn;
                (*Rd_m) = Rd;
                }


        /*-----------------------------------------------------*/


        return;


        /*-----------------------------------------------------*/
        }



/*-----------------------------------------------------*/


/*=====================================================================*/
/* FUNCTION    : FCS_Full_Search_CPCB ().                  */
/*-----------------------------------------------------*/
/* PURPOSE     : This function determines the pulses position   */
/*               using  forward pitch enhancement.        */
/*-----------------------------------------------------*/
/* INPUT ARGUMENTS :                          */
/*        _ (INT16    ) phas_mode: initial phase for the pulses.  */
/*        _ (FLOAT64  ) pmag:     pulse magnitude.           */
```

EP 1 214 706 B1

```
/*      _ (INT16   ) n_p:     number of pulses.           */
/*      _ (INT16   []) SignTab:  array of pulse signs.        */
/*      _ (FLOAT64 []) ref_sig:  target signal.             */
/*      _ (INT16   ) Lex:     excitation size.            */
/*-----------------------------------------------------------*/

/* OUTPUT ARGUMENTS :                             */
/*      _ (INT16   [])  SignOpt: optimized array of pulse signs. */
/*      _ (FLOAT64 [])  EXopt:  optimized excitation signal.   */
/*      _ (INT16   [])  SignOpt: optimized array of indexes.    */
/*-----------------------------------------------------------*/

/* INPUT/OUTPUT ARGUMENTS :                         */
/*      _ (FLOAT64 *)  Criterion: maximized criterion.       */
/*-----------------------------------------------------------*/

/* RETURN ARGUMENTS :                             */
/*              _ None.                        */
/*===========================================================*/


void FCS_Full_Search_CPCB (INT16 phas_mode, INT16 SignOpt[], FLOAT64 pmag,
                           INT16 bits_p, INT16 n_p, INT16 SignTab[],
                           FLOAT64 ref_sig[], FLOAT64 *Criterion,
                           FLOAT64 EXopt[], INT16 Lex,
                           INT16 IndexOpt[])
{
    /*-----------------------------------------------------------*/


    INT16   k, Idx[MAXPN], IdxOpt[MAXPN], PosOpt[MAXPN];
    FLOAT64     GG, Rn_m, Rd_m, MaxCrit, Mag[MAXPN];


    /*-----------------------------------------------------------*/
    /*===================== Algorithm initialisation ===================*/
    /*-----------------------------------------------------------*/


    /*-----------------------------------------------------------*/
    /*              Set-up the track positions             */
    /*-----------------------------------------------------------*/


    FCS_Set_CPCB (phas_mode, bits_p, n_p, Lex);


    /*-----------------------------------------------------------*/
    /*                  Magnitudes of pulses             */
```

```
/*----------------------------------------------*/


GG = 1.0;
for (k = 0; k < n_p; k++)
        {
        Mag[k] =        GG;
        GG              *=      pmag;
        }



/*----------------------------------------------*/
/*==================== Close-loop searching ====================*/
/*----------------------------------------------*/

        .
MaxCrit = -1;


switch (n_p)
        {


        /*----------------------------------------------*/
        /*              2 pulses CB              */
        /*----------------------------------------------*/


        case 2:
                for (Idx[0] = 0; Idx[0] < MaxIdx[0]; Idx[0]++)
                        for (Idx[1] = 0; Idx[1] < MaxIdx[1]; Idx[1]++)
                                FCS_One_Search_CPCB (n_p, Idx, Mag, ref_sig, IdxOpt,
                                                        PosOpt, &MaxCrit,
&Rn_m, &Rd_m);
                break;


        /*----------------------------------------------*/
        /*              3 pulses CB              */
        /*----------------------------------------------*/


        case 3:
                for (Idx[0] = 0; Idx[0] < MaxIdx[0]; Idx[0]++)
                        for (Idx[1] = 0; Idx[1] < MaxIdx[1]; Idx[1]++)
                                for (Idx[2] = 0; Idx[2] < MaxIdx[2]; Idx[2]++)
                                        {
```

```
                              FCS_One_Search_CPCB(n_p, Idx,Mag, ref_sig,

                                                                    IdxOpt,
          PosOpt,

                  &MaxCrit, &Rn_m,

                  &Rd_m);

                                                }
                          break;

                  /*--------------------------------------------------------*/

                  default:
#ifdef VERBOSE
                          nrerror("Invalid number of pulses !! ");
#endif

                          break;

          /*--------------------------------------------------------*/
          }

          /*--------------------------------------------------------*/
          /*                    Excitation                    */
          /*--------------------------------------------------------*/

          if (MaxCrit > (*Criterion))
                  {
                  (*Criterion) = MaxCrit;

                  for (k = 0; k < n_p; k++)
                          SignOpt [k] = SignTab [PosOpt[k]];
                  for (k = 0; k < n_p; k++)
                          IndexOpt[k] = IdxOpt[k];

                  ini_dvector(EXopt, 0, Lex-1, 0.0);

                  for (k = 0; k < n_p; k++)
                          EXopt[PosOpt[k]] += SignOpt[k]*Mag[k];
```

286

```
                }

        /*------------------------------------------------------------*/

        return;

        /*------------------------------------------------------------*/
        }


    /*============================================================*/
    /* FUNCTION    : FCS_Simp_Search_CPCB ().                  */
    /*------------------------------------------------------------*/
    /* PURPOSE     : This function determines the pulses position  */
    /*               using a simplified algorithm and the forward  */
    /*               pitch enhancement.                            */
    /*------------------------------------------------------------*/
    /* INPUT ARGUMENTS :                                       */
    /*       _ (INT16    ) turn0:    first turn number.        */
    /*       _ (INT16    ) turn1:    last turn number.         */
    /*       _ (INT16    ) phas_mode: initial phase for the pulses.  */
    /*       _ (FLOAT64  ) pmag:     pulse magnitude.              */
    /*       _ (INT16    ) n_p:      number of pulses.          */
    /*       _ (INT16   []) SignTab:  array of pulse signs.       */
    /*       _ (FLOAT64 []) ref_sig:  target signal.             */
    /*       _ (INT16    ) Lex:      excitation size.           */
    /*------------------------------------------------------------*/
    /* OUTPUT ARGUMENTS :                                      */
    /*       _ (INT16   []) SignOpt:  optimized array of pulse signs. */
    /*       _ (FLOAT64 []) EXopt:    optimized excitation signal.   */
    /*       _ (INT16   []) IndexOpt: optimized array of indexes.    */
    /*------------------------------------------------------------*/
    /* INPUT/OUTPUT ARGUMENTS :                                */
    /*       _ (FLOAT64 *) Criterion: maximized criterion.       */
    /*------------------------------------------------------------*/
    /* RETURN ARGUMENTS :                                      */
    /*                 _ None.                                 */
    /*============================================================*/
```

```
void FCS_Simp_Search_CPCB (INT16 turn0, INT16 turn1, INT16 phas_mode,
                           INT16 SignOpt[], FLOAT64 pmag, INT16 bits_p, INT16 n_p,
                           INT16 SignTab[], FLOAT64 ref_sig[],
                           FLOAT64 *Criterion, FLOAT64 EXopt[], INT16 Lex,
                           INT16 IndexOpt[])

{
/*------------------------------------------------------------*/

INT16 n, flag;
INT16   k0, k1, k, i, m, POS, Idx[MAXPN], IdxOpt[MAXPN], PosOpt[MAXPN];
FLOAT64 GG, Rn_m, Rd_m, MaxCrit, Mag[MAXPN];


/*------------------------------------------------------------*/
/*==================== Algorithm initialisation ================*/
/*------------------------------------------------------------*/


/*------------------------------------------------------------*/
/*            Set-up the track positions              */
/*------------------------------------------------------------*/


FCS_Set_CPCB (phas_mode, bits_p, n_p, Lex);


/*------------------------------------------------------------*/
/*              Magnitudes of pulses              */
/*------------------------------------------------------------*/


GG = 1.0;
for (k = 0; k < n_p; k++)
        {
        Mag[k] =        GG;
        GG              *=      pmag;
        }


/*------------------------------------------------------------*/
/*            Reset for signed pulses              */
/*------------------------------------------------------------*/


if (turn0 == 0)
        {
```

```
/*------------------------------------------------------*/


for (k = 0; k < n_p; k++)
                Idx [k] = 0;


for (k = 0; k < n_p; k++)
            {
            /*------------------------------------------------*/


            MaxCrit = -32767*32767;
            for (i = 0; i < MaxIdx[k]; i++)
                    {
                    flag    = 1;
                    POS     = track[k][i];
                    for (n = 0; n < k; n++)
                            if (POS == PosOpt[n])
                                    flag = 0;
                    if ((ref_sig[POS] > MaxCrit) && (flag == 1))
                            {
                            MaxCrit = ref_sig[POS];
                            Idx[k]  = i;
                            PosOpt[k]=POS;
                            }
                    }


            IdxOpt[k] = IndexOpt[k];


            /*------------------------------------------------*/
            }


    /*------------------------------------------------*/
    }
else
    for (k = 0; k < n_p; k++)
            {
            Idx [k] = IndexOpt[k];
            IdxOpt[k]=IndexOpt[k];
            PosOpt[k]=track[k][Idx[k]];
            }
```

```
/*-----------------------------------------------------------------*/
/*===================== Close-loop searching =====================*/
/*-----------------------------------------------------------------*/


if (((n_p == 5) || (n_p == 8)) && (turn0 > 0))
        {
        /*-----------------------------------------------*/
        /*            5 and 8 pulses             */
        /*-----------------------------------------------*/


        if (n_p == 5)
                {
                /*-------------------------------------*/
                /*            5 pulses             */
                /*-------------------------------------*/


                MaxCrit = -1;
                k = 0;
                while (k < n_p)
                        {
                        k0 = k;
                        k1 = k+1;
                        if (k1 == n_p)
                                k1 = 0;


                        for (Idx[k0] = 0; Idx[k0] < MaxIdx[k0]; Idx[k0]++)
                                for (Idx[k1] = 0; Idx[k1] < MaxIdx[k1]; Idx[k1]++)
                                FCS_One_Search_CPCB(n_p, Idx, Mag, ref_sig,
                                        IdxOpt, PosOpt, &MaxCrit, &Rn_m, &Rd_m);


                        Idx[k0]=IdxOpt[k0];
                        Idx[k1]=IdxOpt[k1];
                        if (k == n_p-1)
                                k = 1;
                        else
                                k += 2;
                        }
                }


        if (n_p == 8)
```

```
{
/*-------------------------------------------------*/
/*                 8 pulses               */
/*-------------------------------------------------*/


MaxCrit = -1;
k = 0;
while (k < MAXPN)
        {
        k0 = srchpuls[k];
        k1 = srchpuls[k+1];


        for (Idx[k0] = 0; Idx[k0] < MaxIdx[k0]; Idx[k0]++)
                for (Idx[k1] = 0; Idx[k1] < MaxIdx[k1]; Idx[k1]++)
                FCS_One_Search_CPCB(n_p, Idx, Mag, ref_sig,
                        IdxOpt, PosOpt, &MaxCrit, &Rn_m, &Rd_m);



        Idx[k0] = IdxOpt[k0];
        Idx[k1] = IdxOpt[k1];
        k += 2;
        }
    }
}
else
        {
        /*-------------------------------------------------*/
        /*           Others pulse configuration       */
        /*-------------------------------------------------*/


for (m = turn0; m <= turn1; m++)
        {
        for (k = 0; k < n_p; k++)
                {
                MaxCrit=-1;


                for (Idx[k] = 0; Idx[k] < MaxIdx[k]; Idx[k]++)
                        {
                        flag = 1;
                        POS = track[k][Idx[k]];
```

```
                for (i = 0; i < k; i++)
                        {
                        if (POS == PosOpt[i])
                                flag = 0;
                        }
                for (i = k+1; i < n_p; i++)
                        {
                        if (POS == PosOpt[i])
                                flag = 0;
                        }
                if (flag == 1)
                        FCS_One_Search_CPCB(n_p, Idx, Mag, ref_sig,
                                IdxOpt, PosOpt, &MaxCrit, &Rn_m, &Rd_m);
                        }
                Idx[k] = IdxOpt[k];
                }
        }


        /*------------------------------------------------*/
        }


/*------------------------------------------------*/
/*============== Criterion calculation and maximisation ==========*/
/*------------------------------------------------*/


if (MaxCrit > (*Criterion))
        {
        (*Criterion) = MaxCrit;

        for (k = 0; k < n_p; k++)
                SignOpt[k]=SignTab[PosOpt[k]];

        for (k = 0; k < n_p; k++)
                IndexOpt[k] = IdxOpt[k];

        ini_dvector(EXopt, 0, Lex-1, 0.0);

        for (k = 0; k < n_p; k++)
                EXopt[PosOpt[k]] += SignOpt[k]*Mag[k];
```

EP 1 214 706 B1

```
            }

      /*---------------------------------------------------*/

      return;

      /*---------------------------------------------------*/
      }


  /*---------------------------------------------------*/


  /*=================================================================*/
  /* FUNCTION     : FCS_Simp_Search_4kCB ().                  */
  /*---------------------------------------------------*/
  /* PURPOSE     : This function determines the pulses position   */
  /*               using a simplified algorithm and the forward +  */
  /*               backward pitch enhancement.                */
  /*---------------------------------------------------*/
  /* INPUT ARGUMENTS :                              */
  /*       _ (INT16   ) turn0:   first turn number.           */
  /*       _ (INT16   ) turn1:   last  turn number.           */
  /*       _ (INT16   ) phas_mode: initial phase for the pulses.  */
  /*       _ (FLOAT64  ) pmag:    pulse magnitude.            */
  /*       _ (INT16    ) bits_p:   bits per pulse.            */
  /*       _ (INT16    ) n_p:     number of pulses.           */
  /*       _ (INT16   []) SignTab:   array of pulse signs.       */
  /*       _ (FLOAT64 []) ref_sig:   target signal.            */
  /*       _ (INT16    ) Lex:     excitation size.            */
  /*       _ (INT16    ) lag:     current pitch lag.          */
  /*       _ (FLOAT64  ) pit_g:   pitch gain.               */
  /*---------------------------------------------------*/
  /* OUTPUT ARGUMENTS :                             */
  /*       _ (INT16   []) SignOpt: optimized array of pulse signs. */
  /*       _ (FLOAT64 []) EXopt:   optimized excitation signal.   */
  /*       _ (INT16   []) IndexOpt: optimized idex array.       */
  /*---------------------------------------------------*/
  /* INPUT/OUTPUT ARGUMENTS :                         */
  /*       _ (FLOAT64 *) Criterion: maximized criterion.       */
  /*---------------------------------------------------*/
  /* RETURN ARGUMENTS :                             */
```

```
/*      _ None.                              */
/*========================================================================*/


void FCS_Simp_Search_4kCB (INT16 turn0, INT16 turn1, INT16 phas_mode,
                INT16 SignOpt[], FLOAT64 pmag, INT16 bits_p, INT16 n_p,
                INT16 SignTab[], FLOAT64 ref_sig[],
                FLOAT64 *Criterion, FLOAT64 EXopt[],
                INT16 Lex, INT16 IndexOpt[], INT16 lag,
                FLOAT64 pit_g)
        {
        /*----------------------------------------------------------*/


INT16   flag;
INT16   k, i, m, POS, Idx[MAXPN], IdxOpt[MAXPN], PosOpt[MAXPN], LocV[6];
FLOAT64      GG, Rn_m, Rd_m, MaxCrit, Mag[MAXPN], MagV[6];
FLOAT64 x;


        /*----------------------------------------------------------*/
        /*================= Algorithm initialisation ==============*/
        /*----------------------------------------------------------*/


        /*----------------------------------------------------------*/
        /*          Set-up the track positions            */
        /*----------------------------------------------------------*/


FCS_Set_CPCB (phas_mode, bits_p, n_p, Lex);


        /*----------------------------------------------------------*/
        /*          Magnitudes of pulses            */
        /*----------------------------------------------------------*/


GG = 1.0;
for (k = 0; k < n_p; k++)
        {
        Mag[k] =        GG;
        GG          *=      pmag;
        }


        /*----------------------------------------------------------*/
        /*          Reset for signed pulses           */
```

```
/*-----------------------------------------------------------------*/

if (turn0 == 0)
        {
        /*-----------------------------------------------------*/

        for (k = 0; k < n_p; k++)
            {
            POS  = track[k][0];
            MaxCrit = ref_sig[POS];
            Idx[k] = 0;

            for (i = 1; i < MaxIdx[k]; i++)
                {
                POS  = track[k][i];

                x = fabs(ref_sig[POS]);
                if (x > MaxCrit)
                    {
                    MaxCrit = x;
                    Idx[k] = i;
                    PosOpt[k] = POS;
                    }
                }

            IdxOpt[k]=Idx[k];
            }

        /*-----------------------------------------------------*/
        }
else
        for (k = 0; k < n_p; k++)
            {
            Idx[k] = IndexOpt[k];
            IdxOpt[k]=IndexOpt[k];
            PosOpt[k]=track[k][Idx[k]];
            }

/*-----------------------------------------------------------------*/
/*==================== Close-loop searching ====================*/
```

```
/*----------------------------------------------------------*/

for (m = turn0; m <= turn1; m++)
        {
        for (k = 0; k < n_p; k++)
                {
                MaxCrit = -1;
                for (Idx[k] = 0; Idx[k] < MaxIdx[k]; Idx[k]++)
                        {
                        flag = 1;
                        POS = track[k][Idx[k]];
                        for (i = 0; i < k; i++)
                                {
                                if (POS == PosOpt[i])
                                        flag = 0;

                                }

                        for (i = k+1; i < n_p; i++)
                                {
                                if (POS == PosOpt[i])
                                        flag = 0;
                                }
                        if (flag == 1)
                                FCS_One_Search_4kCB(SignTab, lag, pit_g, k, n_p,
                                        Idx, Mag, ref_sig, IdxOpt, PosOpt,
                                                &MaxCrit, &Rn_m, &Rd_m,
Lex);
                        }

                Idx[k] = IdxOpt[k];
                }
        }


/*----------------------------------------------------------*/
/*============= Criterion calculation and maximisation ============*/
/*----------------------------------------------------------*/

if (MaxCrit > (*Criterion))
```

296

```
                {
                (*Criterion) = MaxCrit;
                for (k = 0; k < n_p; k++)
                                SignOpt[k] = SignTab[PosOpt[k]];
                for (k = 0; k < n_p; k++)
                                IndexOpt[k] = IdxOpt[k];


                ini_dvector(EXopt, 0, Lex-1, 0.0);


                for (k = 0; k < n_p; k++)
                        {
                        FCS_DetermPulsLoc (pit_g, lag,Mag[k], PosOpt[k], MagV,
                                                        LocV, &m, Lex);
                            for (i = 0; i < m; i++)
                                    EXopt[LocV[i]] += MagV[i]*SignOpt[k];
                        }
                }


        /*------------------------------------------------*/


        return;


        /*------------------------------------------------*/
        }


/*--------------------------------------------------------*/


/*========================================================*/
/* FUNCTION     : FCS_Decod_CPCB ().                  */
/*----------------------------------------------------*/
/* PURPOSE      : This function decode the fixed codebook.   */
/*----------------------------------------------------*/
/* INPUT ARGUMENTS :                          */
/*       _ (INT16    ) phas_mode: initial phase for the pulses.  */
/*       _ (INT16   []) Sign:     array of pulse signs.       */
/*       _ (FLOAT64  ) pmag:     magnitude of pulses.        */
/*       _ (FLOAT64  ) bits_p:   number of bits per pulse.    */
/*       _ (INT16    ) n_p:      number of pulses.           */
/*       _ (INT16   []) Index:    optimized array of indexes.   */
/*       _ (INT16    ) Lex:      excitation size.            */
```

```
/*------------------------------------------------*/
/* OUTPUT ARGUMENTS :                          */
/*      _ (FLOAT64 []) EXopt:   optimized excitation signal.  */
/*------------------------------------------------*/
/* INPUT/OUTPUT ARGUMENTS :                    */
/*              _ None.                        */
/*------------------------------------------------*/
/* RETURN ARGUMENTS :                          */
/*              _ None.                        */
/*================================================*/


void FCS_Decod_CPCB (INT16 phas_mode, INT16 Sign[], FLOAT64 pmag, INT16 bits_p,
                INT16 n_p, FLOAT64 EXopt[], INT16 Lex, INT16 Index[])
        {
        /*------------------------------------------------*/


        INT16   n, k, Pos[MAXPN];
        FLOAT64 GG;


        /*------------------------------------------------*/
        /*              Set-up the track positions         */
        /*------------------------------------------------*/


        FCS_Set_CPCB (phas_mode, bits_p, n_p, Lex);


        for (n = 0; n < n_p; n++)
                Pos[n] = track[n][Index[n]];


        /*------------------------------------------------*/
        /*              Calculate the excitation signal    */
        /*------------------------------------------------*/


        ini_dvector(EXopt, 0, Lex-1, 0.0);


        GG = 1.0;
        for (k = 0; k < n_p; k++)
                {
                EXopt[Pos[k]]   += Sign[k]*GG;
                GG                      *= pmag;
```

```
                    }


        /*---------------------------------------------------*/


        return;


        /*---------------------------------------------------*/
        }


    /*-------------------------------------------------------*/


    /*=========================================================*/
    /* FUNCTION    : FCS_Decod_PitCB ().                    */
    /*-------------------------------------------------*/
    /* PURPOSE    : This function determines decode the fixed   */
    /*              codebook and performs the forward and backward   */
    /*              pitch enhancement.                     */
    /*-------------------------------------------------*/
    /* INPUT ARGUMENTS :                              */
    /*      _ (INT16   ) phas_mode: initial phase for the pulses.  */
    /*      _ (INT16  []) Sign:    array of pulse signs.        */
    /*      _ (FLOAT64  ) pmag:    magnitude of pulses.         */
    /*      _ (INT16   ) bits_p:   number of bits per pulses.    */
    /*      _ (INT16   ) n_p:     number of pulses.            */
    /*      _ (INT16   ) Lex:     excitation size.            */
    /*      _ (INT16  []) Index:   optimized array of indexes.    */
    /*      _ (INT16   ) lag:     pitch lag.                 */
    /*      _ (FLOAT64  ) pit_g:   pitch gain .              */
    /*-------------------------------------------------*/
    /* OUTPUT ARGUMENTS :                             */
    /*      _ (FLOAT64 []) EXopt:   optimized excitation signal.  */
    /*-------------------------------------------------*/
    /* INPUT/OUTPUT ARGUMENTS :                        */
    /*              _ None.                          */
    /*-------------------------------------------------*/
    /* RETURN ARGUMENTS :                             */
    /*              _ None.                          */
    /*=========================================================*/


void FCS_Decod_PitCB (INT16 phas_mode, INT16 Sign[], FLOAT64 pmag, INT16 bits_p,
```

```
                    INT16 n_p, FLOAT64 EXopt[], INT16 Lex, INT16 Index[],
                    INT16 lag, FLOAT64 pit_g)

{
/*------------------------------------------------------------------*/


INT16   k, i, Pos[MAXPN], LocP[5], NumP;
FLOAT64 GG, MagP[5];


/*------------------------------------------------------------------*/
/*              Set-up the track positions                */
/*------------------------------------------------------------------*/


FCS_Set_CPCB (phas_mode, bits_p, n_p, Lex);


for (k = 0; k < n_p; k++)
        Pos[k] = track[k][Index[k]];


/*------------------------------------------------------------------*/
/*              Calculate the excitation signal            */
/*------------------------------------------------------------------*/


ini_dvector(EXopt, 0, Lex-1, 0.0);


GG = 1.0;
for (k = 0; k < n_p; k++)
        {
        FCS_DetermPulsLoc (pit_g, lag, GG, Pos[k], MagP, LocP, &NumP,
                                                Lex);
        for (i = 0; i < NumP; i++)
                EXopt[LocP[i]] += Sign[k]*MagP[i];
        GG *= pmag;
        }


/*------------------------------------------------------------------*/


return;


/*------------------------------------------------------------------*/
}
```

```
/*-------------------------------------------------------------*/


/*===========================================================================*/
/* FUNCTION    : FCS_Calc_pre_search ().                    */
/*-------------------------------------------------------------*/
/* PURPOSE     : This function determines .              */
/*-------------------------------------------------------------*/
/* INPUT ARGUMENTS :                          */
/*       _ (FLOAT64 []) hh:       impulse sesponse W(z)/A(z).   */
/*       _ (INT16   ) lag:      pitch lag.             */
/*       _ (FLOAT64  ) pgain:     pitch gain .           */
/*       _ (FLOAT64 []) target:    target signal.          */
/*       _ (INT16   []) SignTab:   array of pulse signs.      */
/*       _ (INT16   []) res:      "ideal excitation" signal.   */
/*       _ (FLOAT64  ) SignWeight: weigthing factor for sign pulse*/
/*                    determination (0.0 in all the   */
/*                    calls).             */
/*       _ (INT16   ) AppSign:   use of sign table flag.      */
/*       _ (INT16   ) l_sf:     excitation size.         */
/*-------------------------------------------------------------*/
/* OUTPUT ARGUMENTS :                         */
/*       _ (FLOAT64  *) Gp_m:    modified pitch gain for harmonic*/
/*                    weighting.            */
/*       _ (FLOAT64 []) ref:     reversed target signal.      */
/*       _ (FLOAT64 []) hh_v:    modified impulse sesponse.    */
/*-------------------------------------------------------------*/
/* INPUT/OUTPUT ARGUMENTS :                    */
/*             _ None.              */
/*-------------------------------------------------------------*/
/* RETURN ARGUMENTS :                         */
/*             _ None.              */
/*===========================================================================*/


void FCS_Calc_pre_search(FLOAT64 hh[], FLOAT64 hh_v[], INT16 lag, FLOAT64 pgain,
                 FLOAT64 *Gp_m, FLOAT64 target[], FLOAT64 ref[],
                       INT16 SignTab[], FLOAT64 res[],
                         FLOAT64 SignWeight, INT16 AppSign,
                            INT16 l_sf)
      {
      /*-------------------------------------------------------------*/
```

```
INT16   i, j, k;
FLOAT64        tmp[L_SF], GG, CC;
FLOAT64        *buf;


/*------------------------------------------------------------*/


buf = dvector (0, l_sf-1);


/*------------------------------------------------------------*/
/*              Harmonic weighting on hh                */
/*------------------------------------------------------------*/


cpy_dvector (hh, hh_v, 0, l_sf-1);


(*Gp_m)        = MIN(pgain, PAST_PGAIN_MAX);
(*Gp_m)        = MAX(PAST_PGAIN_MIN, (*Gp_m));
 if (AppSign == 1)
        for (i = lag; i < l_sf; i++)
                hh_v[i] = hh_v[i] + (*Gp_m) * hh_v[i-lag];


/*------------------------------------------------------------*/
/*              Backward filtering                */
/*------------------------------------------------------------*/


for (j = 0; j < l_sf; j++)
        ref[j] = target[l_sf-1-j];


filterAZ (hh_v, ref, tmp, buf, (INT16)(l_sf-1), l_sf);


for (j = 0; j < l_sf; j++)
        ref[j] = tmp[l_sf-1-j];


/*------------------------------------------------------------*/
/*              Calculte  PHI[][]                */
/*------------------------------------------------------------*/


for (i = 0; i < l_sf; i++)
        PHI[i][l_sf-1] = hh_v[l_sf-1-i]*hh_v[0];
```

```
for (k = 1; k < 1_sf; k++)
        for (i = 1; i <= k; i++)
                PHI[k-i][1_sf-1-i] = PHI[k-i+1][1_sf-i] +
                                                          hh_v[1_sf-k+i-
1]*hh_v[i];


/*--------------------------------------------------------------*/
/*                   Set-up Sign table                       */
/*--------------------------------------------------------------*/

if (SignWeight > 0.01)
        {
        dot_dvector(ref, ref, &GG, 0, 1_sf-1);
        dot_dvector(res, res, &CC, 0, 1_sf-1);

        CC  = sqrt(GG/MAX(CC, 0.1));
        CC *= SignWeight;
        for (i = 0; i < 1_sf; i++)
                tmp[i] = CC*res[i]+ref[i];

        for (i = 0; i < 1_sf; i++)
                {
                if (tmp[i] > 0)
                        SignTab[i] = 1;
                else
                        SignTab[i]=-1;
                }
        }
else
        {
        for (i = 0; i < 1_sf; i++)
                {
                if (ref[i] > 0)
                        SignTab[i] = 1;
                else
                        SignTab[i] = -1;
                }
        }
```

```
/*--------------------------------------------------------------------*/
/*                  Apply sign table                       */
/*--------------------------------------------------------------------*/


if (AppSign == 1)
        {
        for (i = 0; i < l_sf; i++)
                ref[i] *= SignTab [i];
        for (i = 0; i < l_sf; i++)
                for (j = i; j < l_sf; j++)
                        PHI[i][j] *= SignTab[i]*SignTab[j];
        }


for (i = 1; i < l_sf; i++)
        for (j = 0; j < i; j++)
                PHI[i][j] = PHI[j][i];


        /*--------------------------------------------------------------*/


free_dvector (buf, 0, l_sf-1);


        /*--------------------------------------------------------------*/


return;


        /*--------------------------------------------------------------*/
        }



/*--------------------------------------------------------------------*/



/*====================================================================*/
/* FUNCTION     : FCS_PulseExchange ().                    */
/*--------------------------------------------------------------*/
/* PURPOSE      : This function swaps pulse 1 and 2 sign and index.*/
/*--------------------------------------------------------------*/
/* INPUT ARGUMENTS :                                   */
/*       _ None.                                  */
/*--------------------------------------------------------------*/
/* OUTPUT ARGUMENTS :                                   */
```

304

```
/*          _ None.                              */
/*-----------------------------------------------*/
/* INPUT/OUTPUT ARGUMENTS :                    */
/*          _ (INT16  *) index1:  pulse 1 index.      */
/*          _ (INT16  *) sign1 :  pulse 1 sign.       */
/*          _ (INT16  *) index2:  pulse 2 index.      */
/*          _ (INT16  *) sign2 :  pulse 2 sign.       */
/*-----------------------------------------------*/
/* RETURN ARGUMENTS :                          */
/*          _ None.                              */
/*===============================================*/


void FCS_PulseExchange(INT16 *index1, INT16 *sign1, INT16 *index2, INT16 *sign2)
        {
        /*-----------------------------------------------*/


        INT16 i;


        /*-----------------------------------------------*/


        i = (*index1);
        (*index1) = (*index2);
        (*index2) = i;
        i = (*sign1);
        (*sign1) = (*sign2);
        (*sign2) = i;


        /*-----------------------------------------------*/


        return;


        /*-----------------------------------------------*/
        }


/*-----------------------------------------------*/


/*===============================================*/
/* FUNCTION     : FCS_ST_parameter ().                */
/*-----------------------------------------------*/
/* PURPOSE      : This function determines the stationary signal  */
```

EP 1 214 706 B1

```
/*          coefficient that is comprise between 0.0 and 1.0.*/
/*-----------------------------------------------*/
/* INPUT ARGUMENTS :                         */
/*      _(INT16   ) i_sf:   sub-frame index.        */
/*      _(INT16   ) rate_m:  selected bit-rate.      */
/*      _(INT16   ) SVS_flag: coding mode (0/1).      */
/*      _(FLOAT64 []) pdcfq:   quantized prediction coeff.   */
/*      _(INT16   ) lag:     pitch lag.            */
/*      _(FLOAT64  ) lpcg:   LPC gain.             */
/*-----------------------------------------------*/
/* OUTPUT ARGUMENTS :                        */
/*      _(FLOAT64 []) pdcfq_w:  weighted quantized predic. coeff.*/
/*-----------------------------------------------*/
/* INPUT/OUTPUT ARGUMENTS :                     */
/*      _(FLOAT64 *) Stab: stationary signal evaluation     */
/*                 coefficient (0.0->1.0).          */
/*-----------------------------------------------*/
/* RETURN ARGUMENTS :                        */
/*          _ None.                        */
/*===============================================*/


void FCS_ST_parameter (INT16 i_sf, INT16 rate_m, INT16 SVS_flag, FLOAT64 pdcfq[],
                       INT16 lag, FLOAT64 *Stab, FLOAT64 pdcfq_w[],
                       FLOAT64 lpcg)
        {
        /*-----------------------------------------------*/


        FLOAT64  y, val;
        INT16 i;

        /*-----------------------------------------------*/
        /*                 LPC gain                 */
        /*-----------------------------------------------*/

        if (i_sf == 0)
               {
               y = fabs(lpcg-lpcg_m) / MAX(fabs(lpcg + lpcg_m), EPSI);

               if ((SVS_flag != 1) && (abs(lag-lag_m) > 0.25*lag))
                       y = 1.0;
```

306

```
(*Stab) = 0.25 * (*Stab) + 0.75*(1.0 - y);


if (rate_m != RATE4_0K)
        (*Stab) = 0;


    /*----------------------------------------------------------*/
    /*                 Update memory                      */
    /*----------------------------------------------------------*/


    lpcg_m = lpcg;
    lag_m   = lag;


    /*----------------------------------------------------------*/
    /*          Update the weighting coefficients       */
    /*----------------------------------------------------------*/


    if (lpcg < 10.0)
                    alpha = 0.0125;
    else
            {
            if (lpcg < 20.0)
                    alpha = 0.025;
            else
                    alpha = 0.05;
            }
        }


    /*----------------------------------------------------------*/


val = 1.0;
for (i = 0; i < NP; i++)
        {
        val *= alpha;
        pdcfq_w[i] = pdcfq[i] * val;
        }


    /*----------------------------------------------------------*/


    return;
```

```
/*----------------------------------------------------------*/
}

/*----------------------------------------------------------*/


/*==========================================================*/
/* FUNCTION     : FCS_Search_pastcorr ().                    */
/*----------------------------------------------------------*/
/* PURPOSE      : This function calculate the autocorrelation of  */
/*                the past weighted quantized speech.        */
/*----------------------------------------------------------*/
/* INPUT ARGUMENTS :                                         */
/*       _ (FLOAT64 []) ext:    excitation signal.           */
/*       _ (FLOAT64 []) pdcfq:  quantized prediction coeff.  */
/*       _ (FLOAT64  ) Stab:    stationary signal evaluation */
/*                   coefficient (0.0->1.0).                 */
/*       _ (INT16   ) pitch:   pitch value.                  */
/*       _ (FLOAT64  ) ltpg:    LTP gain.                    */
/*       _ (INT16   ) SVS_flag: coding mode (0/1).           */
/*       _ (INT16   ) i_sf:    sub-frame index.              */
/*       _ (INT16   ) l_sf:    sub-frame size.               */
/*----------------------------------------------------------*/
/* OUTPUT ARGUMENTS :                                        */
/*       _ (FLOAT64 []) Rw:    autocorrelation values.       */
/*       _ (FLOAT64 []) T_Rw:   index of autocorrelation values. */
/*       _ (FLOAT64  *) N_Rw:   number of autocorrelation values.*/
/*----------------------------------------------------------*/
/* INPUT/OUTPUT ARGUMENTS :                                  */
/*          _ None.                                          */
/*----------------------------------------------------------*/
/* RETURN ARGUMENTS :                                        */
/*          _ None.                                          */
/*==========================================================*/


void FCS_Search_pastcorr (FLOAT64 ext[], FLOAT64 pdcfq[], FLOAT64 Stab,
                          INT16 pitch, FLOAT64 ltpg, INT16 rate_m,
                          INT16 SVS_flag, INT16 i_sf, INT16 l_sf,
                          FLOAT64 Rw[], INT16 T_Rw[], INT16 *N_Rw)

        {
```

```
/*------------------------------------------------------------*/

FLOAT64 x, y, pdcfq_w[NP], wsp[L_WSP], tmpmem[NP], val;
INT16 i, k, m;


/*------------------------------------------------------------*/
/*                    Weighting filtering                 */
/*------------------------------------------------------------*/


val = 1.0;
for (i = 0; i < NP; i++)
        {
        val *= 0.85;
        pdcfq_w[i] = pdcfq[i] * val;
        }


ini_dvector (tmpmem, 0, NP-1, 0.0);


if (SVS_flag != 1)
        FLT_allsyn(ext+MAX_LAG-L_WSP, L_WSP, pdcfq_w, NP, wsp, tmpmem);
else
        {
        if (i_sf==0)
                cpy_dvector (ext+MAX_LAG-L_WSP, wsp_m, 0, L_WSP-1);
        FLT_allsyn(wsp_m, L_WSP, pdcfq_w, NP, wsp, tmpmem);
        }


/*------------------------------------------------------------*/
/*                       Correlation                      */
/*------------------------------------------------------------*/


dot_dvector (wsp+L_WSP-L_CORR, wsp+L_WSP-L_CORR, &x, 0, L_CORR-1);


(*N_Rw) = 0;


ini_dvector(Rw, 0, l_sf-1, 0.0);


for (k = 3; k < 5; k++)
        {
        i = (INT16)(pitch / k + 0.5);
```

```
if ((i < l_sf) && (i > min_pit))
            {
                for (m = 1; m < 6; m++)
                    if (m*i < l_sf && m*i < pitch-6)
                        {
                            dot_dvector (wsp+L_WSP-L_CORR,

                                                    wsp+L_WSP-L_CORR-m*i,

                                                    &Rw[*N_Rw], 0, L_CORR-1);

                            dot_dvector (wsp+L_WSP-L_CORR-m*i,

                                                    wsp+L_WSP-L_CORR-m*i, &y,

                                                    0, L_CORR-1);

                            Rw [*N_Rw] = MAX(MIN(Rw[*N_Rw] /
                                                    MAX(0.5*(x+y), 0.001),
                                                    1.0), 0.0);

                            T_Rw[*N_Rw] = m*i;
                            (*N_Rw)++;
                        }
            }
        }

        /*-------------------------------------------------------*/
        /*              Reduction factor                  */
        /*-------------------------------------------------------*/


        if ((SVS_flag == 1) && (SVS_flag_m == 1) && (rate_m == RATE4_0K))
            {
            for (i = 0; i < *N_Rw; i++)
                    Rw[i] *= Stab * 0.5;
            for (i = 0; i < *N_Rw; i++)
                    Rw[i] *= MIN(ltpg, 1.0);
            }
        else
            {
```

```
                for (i = 0; i < *N_Rw; i++)
                        Rw[i] *= Stab*0.25;
                for (i = 0; i < *N_Rw; i++)
                        Rw[i] *= MIN(ltpg,0.75);
                }


        if (i_sf == 0)
                SVS_flag_m = SVS_flag;




        /*-----------------------------------------------------*/



        return;


        /*-----------------------------------------------------*/
        }



/*-----------------------------------------------------*/



/*========================================================================*/
/* FUNCTION      : FCS_cdbk_search_13b_sub54 ().              */
/*-----------------------------------------------------*/
/* PURPOSE       : This function estimate the optimal fixed      */
/*                 excitation for 4.0 kbps mode 1.               */
/*-----------------------------------------------------*/
/* INPUT ARGUMENTS :                                */
/*        _ (FLOAT64 []) ext:    excitation signal.         */
/*        _ (FLOAT64 []) pdcfq:   quantized prediction coeff.   */
/*        _ (FLOAT64 []) target:  target signal.             */
/*        _ (FLOAT64 []) res:    "ideal excitation" signal after */
/*                        LTP contribution.         */
/*        _ (FLOAT64 []) hh:     W(z)/A(z) impulse response.   */
/*        _ (INT16     ) l_sf:   sub-frame size.             */
/*        _ (INT16     ) i_sf:   sub-frame index.            */
/*        _ (INT16     ) lag:    pitch lag.               */
/*        _ (INT16     ) VUV:    frame class.              */
/*        _ (FLOAT64   ) pgain:  pitch preprocessing quantized  */
/*                        pitch gain.              */
/*        _ (FLOAT64   ) NSR:    noise to signal ratio.       */
/*        _ (FLOAT64   ) Rp:     pitch preprocessing pitch     */
```

```
/*                   correlation.                  */
/*      _ (INT16    ) rate_m:  selected bit-rate.         */
/*      _ (FLOAT64   ) lpcg:   LPC gain.              */
/*-------------------------------------------------------*/
/* OUTPUT ARGUMENTS :                        */
/*      _ (FLOAT64  []) unfcod:  unfiltered excitation signal.  */
/*      _ (PARAMETER *) chan:    output data structure.      */
/*-------------------------------------------------------*/
/* INPUT/OUTPUT ARGUMENTS :                     */
/*      _ None.                           */
/*-------------------------------------------------------*/
/* RETURN ARGUMENTS :                        */
/*      _ None.                           */
/*=======================================================*/


void FCS_cdbk_search_13b_sub54 (FLOAT64 ext [], FLOAT64 pdcfq[], FLOAT64 target[],
                    FLOAT64 res [], FLOAT64 hh[], FLOAT64 unfcod[],
                    INT16 l_sf, INT16 i_sf, INT16 lag,
                       INT16 VUV, FLOAT64 pgain, FLOAT64 NSR, FLOAT64 Rp,
                          INT16 rate_m, FLOAT64 lpcg, PARAMETER *chan)


        {
        /*-------------------------------------------------------*/


        INT16  mode;
        INT16  T_Rw[L_SF3], N_Rw, n;
        INT16  i, Iopt;
        INT16  IdxPuls[MAXPN]={0}, Sign[MAXPN] = {0};
        INT16  SignTab[L_SF3];

        FLOAT64 Criter, Criter_m, Gp_m;
        FLOAT64 hh_v[L_SF3], ref[L_SF3];
        FLOAT64 Rw[L_SF3], tmpmem[NP], pdcfq_w[NP];

        /*-------------------------------------------------------*/


        cpy_dvector(hh, hh_v, 0, l_sf-1);


        FCS_ST_parameter (i_sf, rate_m, 1, pdcfq, lag, &Stab_13b_enc,
                          pdcfq_w, lpcg);
```

```
FCS_Search_pastcorr (ext, pdcfq, Stab_13b_enc, lag, pgain, rate_m,
                                   1, i_sf, l_sf, Rw, T_Rw, &N_Rw);


for (i = 0; i < N_Rw; i++)
        for (n = T_Rw[i]; n < l_sf; n++)
                hh_v[n] += Rw[i]*hh[n-T_Rw[i]];


ini_dvector (tmpmem, 0, NP-1, 0.0);
FLT_allsyn (hh_v, l_sf, pdcfq_w, NP, hh_v, tmpmem);


cpy_dvector (hh_v, ref, 0, l_sf-1);
for (i = 1; i < L_HF; i++)
        for (n = i; n < l_sf; n++)
                hh_v[n] += hh_hf[i]*ref[n-i];


FCS_Calc_pre_search (hh_v, hh_v, lag, pgain, &Gp_m, target, ref,
                                   SignTab, res, 0.0, 1, l_sf);


Iopt = 0;
Criter=-1;


/*--------------------------------------------------------------*/
/*     2 pulses CB :  2pulses x 5bits/pulse + 2 signs = 12 bits    */
/*--------------------------------------------------------------*/


FCS_Full_Search_CPCB (0, Sign, 1.0, 5, 2, SignTab, ref, &Criter,
                                   unfcod,  l_sf, IdxPuls);


mode = 3;
Criter_m = Criter;


/*--------------------------------------------------------------*/
/* 3 pulses CB : 3 pulses x (2 or 1)bits/pulse + 3 signs + 3bits   */
/*                     center = 12 bits                        */
/*--------------------------------------------------------------*/


/*--------------------------------------------------------------*/
/*                     Determine the center                    */
/*--------------------------------------------------------------*/
```

```
for (i = 0; i < SEG_NUM_M1; i++)
        {
        FCS_Full_Search_CPCB (i, Sign, 1.0, 2, 3, SignTab, ref, &Criter,
                                        unfcod, l_sf, IdxPuls);


        if (Criter > Criter_m)
                {
                Iopt = i;
                mode = 2;
                Criter_m = Criter;
                }
        }


/*-----------------------------------------------------*/
/*              Save the Index of the cdbk            */
/*-----------------------------------------------------*/


for (i = 0; i < MAXPN; i++)
        chan->idx_cpcb[i_sf][i] = IdxPuls[i];


for (i = 0; i < MAXPN; i++)
        chan->idx_cpcbsign[i_sf][i] = (Sign[i]+1)/2;


chan->idx_center[i_sf] = Iopt;


if (mode == 3)
        chan->idx_subcpcb[i_sf][0] = 1;
else
        chan->idx_subcpcb[i_sf][0] = 0;




/*-----------------------------------------------------*/
/*              Harmonic weighting on unfcod          */
/*-----------------------------------------------------*/


for (i = lag; i < l_sf; i++)
                unfcod[i] += Gp_m * unfcod[i-lag];


cpy_dvector (unfcod, hh_v, 0, l_sf-1);
```

```
      for (i = 0; i < N_Rw; i++)
            for (n = T_Rw[i]; n < l_sf; n++)
                  unfcod[n] += Rw[i] * hh_v[n-T_Rw[i]];


      ini_dvector (tmpmem, 0, NP-1, 0.0);
      FLT_allsyn(unfcod, l_sf, pdcfq_w, NP, unfcod, tmpmem);


      cpy_dvector (unfcod, ref, 0, l_sf-1);
      for (i = 1; i < L_HF; i++)
            for (n = i; n < l_sf; n++)
                  unfcod[n] += hh_hf[i]*ref[n-i];


      /*---------------------------------------------------*/


      return;


      /*---------------------------------------------------*/
      }


/*---------------------------------------------------*/


/*===================================================================*/
/* FUNCTION    : FCS_cdbk_decod_13b_sub54 ().              */
/*---------------------------------------------------*/
/* PURPOSE     : This function decode the optimal fixed     */
/*               excitation for 4.0 kbps mode 1.            */
/*---------------------------------------------------*/
/* INPUT ARGUMENTS :                                 */
/*       _ (FLOAT64  []) ext:    excitation signal.        */
/*       _ (FLOAT64  []) pdcfq:  quantized prediction coeff.  */
/*       _ (INT16    ) l_sf:   sub-frame size.              */
/*       _ (INT16    ) i_sf:   sub-frame index.             */
/*       _ (INT16    ) lag:    pitch lag.                   */
/*       _ (FLOAT64   ) pgain:  decoded pitch gain.         */
/*       _ (INT16    ) rate_m:  current fixed bit-rate.     */
/*       _ (FLOAT64   ) lpcg:   decoded LPC gain.           */
/*---------------------------------------------------*/
/* OUTPUT ARGUMENTS :                                */
/*       _ (FLOAT64  []) unfcod:  unfiltered excitation signal.  */
/*---------------------------------------------------*/
```

```
/* INPUT/OUTPUT ARGUMENTS :                                    */
/*     _ (PARAMETER *) chan:    output data structure.         */
/*------------------------------------------------------------*/
/* RETURN ARGUMENTS :                                          */
/*     _ None.                                                 */
/*============================================================*/


void FCS_cdbk_decod_13b_sub54 (FLOAT64 ext [], FLOAT64 pdcfq [],
                               FLOAT64 unfcod [], INT16 l_sf, INT16 i_sf,
                          INT16 lag, FLOAT64 pgain,
                               INT16 rate_m, FLOAT64 lpcg,
                                    PARAMETER *chan)
          {
          /*------------------------------------------------------------*/


          INT16   T_Rw[L_SF3], N_Rw, n;
          INT16   i, Iopt, IdxPuls[MAXPN], Sign[MAXPN];
          FLOAT64 Gp_m;
          FLOAT64 Rw[L_SF3], hh_v[L_SF3], tmpmem[NP], pdcfq_w[NP];


          /*------------------------------------------------------------*/


          for (i = 0; i < MAXPN; i++)
                  IdxPuls[i] = chan->idx_cpcb[i_sf][i];
          for (i = 0; i < MAXPN; i++)
                  Sign[i] = 2*chan->idx_cpcbsign[i_sf][i]-1;

          if (chan->idx_subcpcb[i_sf][0] == 1)
                  {
                  /*------------------------------------------------------------*/
                  /* 2 pulses CB: 2pulses x 5bits/pulse + 2 signs = 12 bits    */
                  /*------------------------------------------------------------*/

                  FCS_Decod_CPCB (0, Sign, 1.0, 5, 2, unfcod, l_sf, IdxPuls);
                  }
          else
                  {
                  /*------------------------------------------------------------*/
                  /* 3 pulses CB : 3 pulses x (2 or 1)bits/pulse +            */
                  /*               3 signs + 3bits center = 11 bits           */
```

```
/*------------------------------------------------*/


      Iopt = chan->idx_center[i_sf];
      FCS_Decod_CPCB (Iopt, Sign, 1.0, 2, 3, unfcod, l_sf, IdxPuls);
   }


/*------------------------------------------------*/
/*              Pitch enhancement            */
/*------------------------------------------------*/


Gp_m = MIN(pgain, PAST_PGAIN_MAX);
Gp_m = MAX(PAST_PGAIN_MIN, Gp_m);


for (i = lag; i < l_sf; i++)
      unfcod[i] = unfcod[i] + Gp_m*unfcod[i-lag];


FCS_ST_parameter (i_sf, rate_m, 1, pdcfq, lag, &Stab_13b_dec,
                              pdcfq_w, lpcg);


FCS_Search_pastcorr (ext, pdcfq, Stab_13b_dec, lag, pgain, rate_m, 1,
                              i_sf, l_sf, Rw, T_Rw, &N_Rw);


cpy_dvector (unfcod, hh_v, 0, l_sf-1);


for (i = 0; i < N_Rw; i++)
      for (n = T_Rw[i]; n < l_sf; n++)
            unfcod[n] += Rw[i]*hh_v[n-T_Rw[i]];


ini_dvector (tmpmem, 0, NP-1, 0.0);
FLT_allsyn (unfcod, l_sf, pdcfq_w, NP, unfcod, tmpmem);


cpy_dvector (unfcod, hh_v, 0, l_sf-1);
for (i = 1; i < L_HF; i++)
      for (n = i; n < l_sf; n++)
            unfcod[n] += hh_hf[i]*hh_v[n-i];


/*------------------------------------------------*/


return;
```

```
/*-------------------------------------------------------*/

}


/*-------------------------------------------------------*/


/*===================================================================*/
/* FUNCTION    : FCS_cdbk_search_15b_sub80 ().                */
/*-------------------------------------------------*/
/* PURPOSE     : This function estimate the optimal fixed       */
/*               excitation for 4.0 kbps mode 0.               */
/*-------------------------------------------------*/
/* INPUT ARGUMENTS :                               */
/*        _ (FLOAT64 []) ext:    excitation signal.        */
/*        _ (FLOAT64 []) pdcfq:   quantized prediction coeff.    */
/*        _ (FLOAT64 []) target:  target signal.             */
/*        _ (FLOAT64 []) res:     "ideal excitation" signal after */
/*                   LTP contribution.            */
/*        _ (FLOAT64  []) hh:     W(z)/A(z) impulse response.    */
/*        _ (INT16    ) l_sf:    sub-frame size.           */
/*        _ (INT16    ) i_sf:    sub-frame index.           */
/*        _ (INT16    ) lag:     pitch lag.               */
/*        _ (INT16    ) VUV:     frame class.             */
/*        _ (FLOAT64   ) pgain:   quantized pitch gain.        */
/*        _ (FLOAT64   ) NSR:    noise to signal ratio.        */
/*        _ (FLOAT64   ) Rp:     pitch preprocessing pitch      */
/*                   correlation.               */
/*-------------------------------------------------*/
/* OUTPUT ARGUMENTS :                              */
/*        _ (FLOAT64  []) unfcod:  unfiltered excitation signal.  */
/*        _ (PARAMETER *) chan:    output data structure.       */
/*-------------------------------------------------*/
/* INPUT/OUTPUT ARGUMENTS :                          */
/*        _ None.                          */
/*-------------------------------------------------*/
/* RETURN ARGUMENTS :                              */
/*        _ None.                          */
/*===================================================================*/


void FCS_cdbk_search_15b_sub80 (FLOAT64 ext[], FLOAT64 pdcfq[], FLOAT64 target[],
                            FLOAT64 res[], FLOAT64 hh[], FLOAT64 unfcod[],
```

```
                INT16 l_sf, INT16 i_sf, INT16 lag,
                INT16 VUV, FLOAT64 pgain, FLOAT64 NSR, FLOAT64 Rp,
                INT16 rate_m, FLOAT64 lpcg, PARAMETER *chan)
{
/*---------------------------------------------------------------*/


INT16   mode;
INT16   T_Rw[L_SF], N_Rw;
INT16   IdxPuls[MAXPN]={0}, Sign[MAXPN] = {0};
INT16   i, n, Iopt;
INT16   IdxPuls_tmp[MAXPN],
        Sign_tmp[MAXPN], SignTab[L_SF];
FLOAT64     P1_SHP, Criter, Criter_m, Criter_tmp, Gp_m, gp;
FLOAT64 hh_v[L_SF], ref[L_SF];
FLOAT64 Rw[L_SF], tmpmem[NP], pdcfq_w[NP];


/*---------------------------------------------------------------*/


cpy_dvector (hh, hh_v, 0, l_sf-1);
FCS_ST_parameter (i_sf, rate_m, 1, pdcfq, lag, &Stab_15b_enc,
                            pdcfq_w, lpcg);

FCS_Search_pastcorr(ext, pdcfq, Stab_15b_enc, lag, pgain, rate_m, 0,
                            i_sf, l_sf, Rw, T_Rw, &N_Rw);

for (i = 0; i < N_Rw; i++)
        for (n = T_Rw[i]; n < l_sf; n++)
                hh_v[n] += Rw[i]*hh[n-T_Rw[i]];

ini_dvector (tmpmem, 0, NP-1, 0.0);
FLT_allsyn(hh_v, l_sf, pdcfq_w, NP, hh_v, tmpmem);

cpy_dvector (hh_v, ref, 0, l_sf-1);

for (i = 1; i < L_HF; i++)
        for (n = i; n < l_sf; n++)
                hh_v[n] += hh_hf[i]*ref[n-i];

/*---------------------------------------------------------------*/
/* 2 pulses CB :   2pulses x 6bits/pulse + 2 signs = 14 bits        */
```

```
/*-----------------------------------------------------*/


    FCS_Calc_pre_search (hh_v, hh_v, lag, pgain, &Gp_m, target, ref,
                                    SignTab, res, 0.0, 0, l_sf);


    Criter = -1;


    gp = 0.75;


FCS_Simp_Search_4kCB (0, 1, 1, Sign, 1.0, 7, 2, SignTab, ref, &Criter,
                                unfcod, l_sf, IdxPuls, lag, gp);


    mode = 3;
    Criter_m = Criter;


    /*-----------------------------------------------------*/
    /*                  Sign check                      */
    /*-----------------------------------------------------*/


if (IdxPuls[0]<=IdxPuls[1])
    {
            if (Sign[0]!=Sign[1])
            FCS_PulseExchange(IdxPuls, Sign, IdxPuls+1, Sign+1);
            }
else
    {
            if (Sign[0] == Sign[1])
                    FCS_PulseExchange(IdxPuls, Sign, IdxPuls+1, Sign+1);
            }


IdxPuls[0] = IdxPuls[0]*L_SF + IdxPuls[1];


    /*-----------------------------------------------------*/
    /* 3 pulses CB :  3 pulses x 2 bits/pulse + 3 signs + 4bits center = */
    /*            13 bits                         */
    /*-----------------------------------------------------*/


    /*-----------------------------------------------------*/
    /*                  Reference signal               */
    /*-----------------------------------------------------*/
```

```
FCS_Calc_pre_search (hh_v, hh_v, lag, 0.25, &Gp_m, target, ref,
                                    SignTab, res, 0.0, 1, l_sf);


/*-------------------------------------------------------------*/
/*                  Determine the center                  */
/*-------------------------------------------------------------*/


Iopt = 0;
Criter = -1;
Criter_tmp = Criter;
for (i = 0; i < SEG_NUM_M0; i++)
        {
        FCS_Simp_Search_CPCB(0, 0, i, Sign_tmp, 1.0, 2, 3, SignTab, ref,
                                &Criter, hh_v, l_sf, IdxPuls_tmp);


        if(Criter > Criter_tmp)
                Iopt = i;


        Criter_tmp = Criter;
        }


/*-------------------------------------------------------------*/
/*                  Determine the shape                   */
/*-------------------------------------------------------------*/


Criter = Criter_m;


if ((lag < 35) && (Rp < 0.6))
        Criter*=MIN(0.6+0.4*(lag-MIN_LAG)/(35.0-MIN_LAG), 1.0);



Criter_tmp = Criter;
FCS_Full_Search_CPCB(Iopt, Sign, 1.0, 2, 3, SignTab, ref, &Criter,
                                unfcod, l_sf, IdxPuls);


if (Criter > Criter_tmp)
        mode = 2;
else
        Criter = Criter_m;
```

```
/*-----------------------------------------------------------*/
/*              Perceptual Wheighted decison              */
/*-----------------------------------------------------------*/


P1_SHP = PPP_sharpness (l_sf, res);


if ((VUV >= 3) && (Rp<0.75))
        Criter *= MIN(MAX(1.5-4.0*P1_SHP, 0.5), 1.0);
if (VUV == 2)
        Criter *= MIN(MAX(1.5-5.0*P1_SHP, 0.25), 1.0);
if (VUV <= 1)
        Criter *= 0.75*MIN(MAX(1.5-5.0*P1_SHP, 0.0), 1.0);
if ((VUV == 1) && (mode == 3) && (lag < 50))
        Criter *= 0.5;
if (VUV >= 2)
        Criter *= 1.0 - 0.5*NSR*MIN(P1_SHP+0.5, 1.0);


Criter_m = Criter;


/*-----------------------------------------------------------*/
/*              Gaussian codebook, 13 bits              */
/*-----------------------------------------------------------*/


GCB_gauss_cb_itu4k (target, res, hh, &Criter, unfcod, IdxPuls, Sign,
                                                    N_GAUSS_13b,
N_GAUSS_13b);


if (Criter > Criter_m)
        {
        mode = 1;
        IdxPuls[0] = IdxPuls[0]*N_GAUSS_13b + IdxPuls[1];
        }


/*-----------------------------------------------------------*/
/*              Index of the cdbk              */
/*-----------------------------------------------------------*/


for (i = 0; i < MAXPN; i++)
        chan->idx_cpcb[i_sf][i] = IdxPuls[i];
```

```
for (i = 0; i < MAXPN; i++)
        chan->idx_cpcbsign[i_sf][i] = (Sign[i]+1)/2;


chan->idx_center[i_sf] = Iopt;


if (mode == 3)
        chan->idx_subcpcb[i_sf][0] = 1;
else
        {
        chan->idx_subcpcb[i_sf][0] = 0;
        if (mode == 2)
                chan->idx_subcpcb[i_sf][1] = 1;
        else
                chan->idx_subcpcb[i_sf][1] = 0;
        }


/*------------------------------------------------*/
/*              Harmonic weighting on unfcod       */
/*------------------------------------------------*/


if (mode >= 2)
        {
        if (mode == 2)
                for (i = lag; i < l_sf; i++)
                        unfcod[i] += Gp_m * unfcod[i-lag];

        cpy_dvector (unfcod, hh_v, 0, l_sf-1);
        for (i = 0; i < N_Rw; i++)
                for (n = T_Rw[i]; n < l_sf; n++)
                        unfcod[n] += Rw[i]*hh_v[n-T_Rw[i]];

        ini_dvector (tmpmem, 0, NP-1, 0.0);
        FLT_allsyn(unfcod, l_sf, pdcfq_w, NP, unfcod, tmpmem);

        cpy_dvector (unfcod, ref, 0, l_sf-1);
        for (i = 1; i < L_HF; i++)
                for (n = i; n < l_sf; n++)
                        unfcod[n] += hh_hf[i]*ref[n-i];
        }
```

```
        /*----------------------------------------------------*/


        return;


        /*----------------------------------------------------*/
    }



    /*----------------------------------------------------*/


/*==================================================================*/
/* FUNCTION    :  FCS_cdbk_decod_15b_sub80 ().              */
/*----------------------------------------------------*/
/* PURPOSE     :  This function decode the fixed excitation vector */
/*               for 4.0 kbps mode 0.                */
/*----------------------------------------------------*/
/* INPUT ARGUMENTS :                           */
/*      _ (FLOAT64 []) ext:     excitation signal.        */
/*      _ (FLOAT64 []) pdcfq:   quantized prediction coeff.   */
/*      _ (INT16    ) l_sf:    sub-frame size.          */
/*      _ (INT16    ) i_sf:    sub-frame index.          */
/*      _ (INT16    ) lag:     pitch lag.              */
/*      _ (FLOAT64  ) pgain:   decoded pitch gain.          */
/*      _ (INT16    ) rate_m:  decoded fix bit-rate.      */
/*      _ (FLOAT64  ) lpcg:    decoded LPC gain.          */
/*----------------------------------------------------*/
/* OUTPUT ARGUMENTS :                          */
/*      _ (FLOAT64 []) unfcod:  unfiltered excitation signal.  */
/*----------------------------------------------------*/
/* INPUT/OUTPUT ARGUMENTS :                       */
/*      _ (PARAMETER  *) chan:   output data structure.      */
/*----------------------------------------------------*/
/* RETURN ARGUMENTS :                          */
/*      _ None.                              */
/*==================================================================*/


void    FCS_cdbk_decod_15b_sub80 (FLOAT64 ext[], FLOAT64 pdcfq[],
                        FLOAT64 unfcod[], INT16 l_sf, INT16 i_sf,
                        INT16 lag, FLOAT64 pgain,
                        INT16 rate_m, FLOAT64 lpcg, PARAMETER *chan)
```

```
{
      /*-----------------------------------------------------------*/



      INT16   mode;
      INT16   T_Rw[L_SF], N_Rw;
      INT16   i, n, Iopt, IdxPuls[MAXPN], Sign[MAXPN], IdxGauss[2];
      FLOAT64 gp, tmp[L_SF];
      FLOAT64 Rw[L_SF],tmpmem[NP], pdcfq_w[NP];



      /*-----------------------------------------------------------*/



      for (i = 0; i < MAXPN; i++)
            IdxPuls[i] = chan->idx_cpcb[i_sf][i];


      for (i = 0; i < MAXPN; i++)
            Sign[i] = 2*chan->idx_cpcbsign[i_sf][i] - 1;


      if (chan->idx_subcpcb[i_sf][0] == 1)
            {       .
            /*-----------------------------------------------------------*/
            /* 2 pulses CB: 2pulses x 6bits/pulse + 2 signs = 14 bits    */
            /*-----------------------------------------------------------*/


            mode = 3;
            gp  = 0.75;


            i = IdxPuls[0]/L_SF;
      IdxPuls[1] =  IdxPuls[0] - i*L_SF;
      IdxPuls[0] = i;


            /*-----------------------------------------------------------*/
      /*                  Sign check               */
            /*-----------------------------------------------------------*/


      if (IdxPuls[0] <= IdxPuls[1])
            Sign[1] = Sign[0];
      else
            Sign[1] = -Sign[0];


      FCS_Decod_PitCB (1, Sign, 1.0, 7, 2, unfcod, i_sf, IdxPuls,
```

```
                                                    lag, gp);

                        }
               else
                        {
               if (chan->idx_subcpcb[i_sf][1] == 1)
                               {
                               /*-----------------------------------------------*/
                               /* 3 pulses CB :  3 pulses x 2 bits/pulse + 3 signs +   */
                               /*            4bits  center = 13 bits              */
                               /*-----------------------------------------------*/

                               mode = 2;
                               lopt = chan->idx_center[i_sf];
                               FCS_Decod_CPCB (Iopt, Sign, 1.0, 2, 3, unfcod, l_sf,
                                                            IdxPuls);
                               }
               else
                               {
                               /*-----------------------------------------------*/
                               /*            Gaussian codcbook, 13 bits        */
                               /*-----------------------------------------------*/

                               mode = 1;


#ifdef VERBOSE
                               if (l_sf != 40+40)
                                        nrerror("ERROR: dimension mismatch decoding gaussian excitation\n");
#endif


                               /*-----------------------------------------------*/
                               /*    Decode the 11 bits index into the two 45-entry   */
                               /*                codebooks                */
                               /*-----------------------------------------------*/

                               IdxGauss[0] = IdxPuls[0]/N_GAUSS_13b;
                               IdxGauss[1] = IdxPuls[0] - N_GAUSS_13b*IdxGauss[0];
                               GCB_decode_gauss_cb_itu4k(N_GAUSS_13b, 40, IdxGauss[0],

               Sign[0], unfcod);
                               GCB_decode_gauss_cb_itu4k(N_GAUSS_13b, 40, IdxGauss[1],
```

```
Sign[1], unfcod+1);
                        }
             }


FCS_ST_parameter (i_sf, rate_m, 1, pdcfq, lag, &Stab_15b_dec,
                                pdcfq_w, lpcg);


FCS_Search_pastcorr(ext, pdcfq, Stab_15b_dec, lag, pgain, rate_m, 0,
                                i_sf, l_sf, Rw, T_Rw, &N_Rw);


if (mode >= 2)
             {
             if (mode == 2)
                    for (i = lag; i < l_sf; i++)
                            unfcod[i] = unfcod[i] + 0.25*unfcod[i-lag];

             cpy_dvector (unfcod, tmp, 0, l_sf-1);
             for (i = 0; i < N_Rw; i++)
                    for (n = T_Rw[i]; n < l_sf; n++)
                            unfcod[n] += Rw[i]*tmp[n-T_Rw[i]];

             ini_dvector (tmpmem, 0, NP-1, 0.0);
             FLT_allsyn (unfcod, l_sf, pdcfq_w, NP, unfcod, tmpmem);

             cpy_dvector (unfcod, tmp, 0, l_sf-1);
             for (i = 1; i < L_HF; i++)
                    for (n = i; n < l_sf; n++)
                            unfcod[n] += hh_hf[i]*tmp[n-i];
             }


    /*_____*/


    return;


    /*_____*/
    }


/*_____*/
```

```
/*===========================================================*/
/* FUNCTION    : FCS_cdbk_search_22b_sub40 ().              */
/*-----------------------------------------------------------*/
/* PURPOSE     : This function estimate the optimal fixed    */
/*               excitation for 8.5 kbps mode 0.             */
/*-----------------------------------------------------------*/
/* INPUT ARGUMENTS :                                         */
/*      _ (FLOAT64 []) ext:    excitation signal.            */
/*      _ (FLOAT64 []) pdcfq:  quantized prediction coeff.   */
/*      _ (FLOAT64 []) target: target signal.                */
/*      _ (FLOAT64 []) res:    "ideal excitation" signal after */
/*                    LTP contribution.                      */
/*      _ (FLOAT64 []) hh:     W(z)/A(z) impulse response.   */
/*      _ (INT16   ) l_sf:   sub-frame size.                 */
/*      _ (INT16   ) i_sf:   sub-frame index.                */
/*      _ (INT16   ) lag:    pitch lag.                      */
/*      _ (INT16   ) VUV:    frame class.                    */
/*      _ (FLOAT64  ) pgain:   quantized pitch gain.         */
/*      _ (FLOAT64  ) NSR:    noise to signal ratio.         */
/*      _ (FLOAT64  ) Rp:     pitch preprocessing pitch      */
/*                    correlation.                           */
/*-----------------------------------------------------------*/
/* OUTPUT ARGUMENTS :                                        */
/*      _ (FLOAT64 []) unfcod:  unfiltered excitation signal. */
/*      _ (PARAMETER *) chan:    output data structure.       */
/*-----------------------------------------------------------*/
/* INPUT/OUTPUT ARGUMENTS :                                  */
/*      _ None.                                              */
/*-----------------------------------------------------------*/
/* RETURN ARGUMENTS :                                        */
/*      _ None.                                              */
/*===========================================================*/


void FCS_cdbk_search_22b_sub40 (FLOAT64 ext [], FLOAT64 pdcfq [],
                FLOAT64 target [], FLOAT64 res [], FLOAT64 hh [],
                        FLOAT64 unfcod [], INT16 l_sf, INT16 i_sf,
                                INT16 lag, INT16 VUV, FLOAT64 pgain,
                                        FLOAT64 NSR, FLOAT64 Rp, PARAMETER *chan)


        {
```

```
/*------------------------------------------------------*/
            .

INT16 i, mode;
INT16 IdxPuls[MAXPN], Sign[MAXPN], SignTab[L_SF4];
FLOAT64 P1_SHP, Criter, Criter_m, Criter_m3, Criter_m2, Gp_m, Gp;
FLOAT64 hh_v[L_SF4], ref[L_SF4];


/*------------------------------------------------------*/


if ((lag < 20) && (pgain > 0.5))
        Gp = MIN(pgain, 1.0)*0.75;
else
        Gp = pgain;
Gp = MIN(Gp, PAST_PGAIN_MAX2);


/*------------------------------------------------------*/
/*              Reference signal            */
/*------------------------------------------------------*/


FCS_Calc_pre_search (hh, hh_v, lag, Gp, &Gp_m, target, ref, SignTab,
                                res, 0.5, 1, 1_sf);


/*------------------------------------------------------*/
/*    5 pulses CB : 3p x 4b + 2p x 3b + 3b signs = 21 bits     */
/*------------------------------------------------------*/


Criter=-1;
FCS_Simp_Search_CPCB (0, 1, 0, Sign, 1.0, 4, 5, SignTab, ref, &Criter,
                                unfcod, 1_sf, IdxPuls);
mode = 3;
Criter_m = Criter;
Criter_m3 = Criter;


/*------------------------------------------------------*/
/*    5 pulses CB : 5p x 3b + 5b signs = 20 bits          */
/*------------------------------------------------------*/


FCS_Simp_Search_CPCB(0, 0, 2, Sign, 1.0, 3, 5, SignTab, ref, &Criter,
                                unfcod, 1_sf, IdxPuls);
if (Criter > Criter_m)
```

329

```
        {
        mode = 2;
        Criter_m2 = Criter;
        }


/*---------------------------------------------------*/
/*            Perceptual  Wheighted decison        */
/*---------------------------------------------------*/


P1_SHP = PPP_sharpness(l_sf, res);
if (VUV <= 0)
        Criter *= 0.9*MIN(MAX(1.5-5.0*P1_SHP, 0.7), 1.0);
if (VUV == 1)           .
        Criter *= 0.9;
if (VUV >= 1)
        Criter *= 1.0-0.25*NSR*MIN(P1_SHP+0.5, 1.0);
Criter_m = Criter;


/*---------------------------------------------------*/
/*     5 pulses CB : 5p x 3b + 5b signs = 20 bits        */
/*---------------------------------------------------*/


FCS_Simp_Search_CPCB(0, 1, 1, Sign, 1.0, 3, 5, SignTab, ref, &Criter,
                                     unfcod, l_sf, IdxPuls);


if (Criter > Criter_m)
        mode = 1;



/*---------------------------------------------------*/
/*                Fine serach                */
/*---------------------------------------------------*/



switch (mode)
        {
        /*-------------------------------------------*/
        /*     5 pulses CB : 3p x 4b + 2p x 3b + 3b signs = 21 bits  */
        /*-------------------------------------------*/
```

```
case 3: Criter = Criter_m3;
        FCS_Simp_Search_CPCB(2, 2, 0, Sign, 1.0, 4, 5, SignTab,
                            ref, &Criter, unfcod, l_sf, IdxPuls);


            /*-----------------------------------------------*/
            /*        Sign check on the same track        */
            /*-----------------------------------------------*/


            for (i = 1; i < 3; i++)
                {
                if (IdxPuls[i] <= IdxPuls[i+2])
                    {
                    if (Sign[i] != Sign[i+2])
                            FCS_PulseExchange (IdxPuls+i, Sign+i,
                                        IdxPuls+i+2, Sign+i+2);
                    }
                else
                    {
                    if (Sign[i] == Sign[i+2])
                            FCS_PulseExchange (IdxPuls+i, Sign+i,
                                        IdxPuls+i+2, Sign+i+2);
                    }
                }

        break;

    /*-----------------------------------------------*/
    /*    5 pulses CB : 5p x 3b + 5b signs = 20 bits    */
    /*-----------------------------------------------*/

case 2: Criter = Criter_m2;
        FCS_Simp_Search_CPCB(1, 1, 2, Sign, 1.0, 3, 5, SignTab,
                                ref, &Criter, unfcod, l_sf, IdxPuls);
        break;

    /*-----------------------------------------------*/
    /*    5 pulses CB : 5p x 3b + 5b signs = 20 bits    */
    /*-----------------------------------------------*/
```

```
        case 1: FCS_Simp_Search_CPCB(2, 2, 1, Sign, 1.0, 3, 5, SignTab,
                                        ref, &Criter, unfcod, l_sf, IdxPuls);
                break;


        default: nrerror("Wrong  mode !!");
                break;
            }



/*-----------------------------------------------------------------*/
/*                  Index of the cdbk                  */
/*-----------------------------------------------------------------*/


for (i = 0; i < MAXPN; i++)
        chan->idx_cpcb[i_sf][i] = IdxPuls[i];


for (i = 0; i < MAXPN; i++)
        chan->idx_cpcbsign[i_sf][i] = (Sign[i]+1)/2;



if (mode == 3)
        chan->idx_subcpcb[i_sf][0] = 1;
else
        {  ......
        chan->idx_subcpcb[i_sf][0] = 0;
        if (mode == 2)
                chan->idx_subcpcb[i_sf][1] = 1;
        else
                chan->idx_subcpcb[i_sf][1] = 0;
        }



/*-----------------------------------------------------------------*/
/*                  Harmonic weighting on unfcod             */
/*-----------------------------------------------------------------*/


for (i = lag; i < l_sf; i++)
        unfcod[i] += Gp_m * unfcod[i-lag];


/*-----------------------------------------------------------------*/
```

```
        return;

        /*----------------------------------------------------*/
        }


/*------------------------------------------------------------*/


/*============================================================================*/
/* FUNCTION    :  FCS_cdbk_decod_22b_sub40 ().              */
/*--------------------------------------------------------*/
/* PURPOSE     : This function decode the fixed excitation vector */
/*          for 8.5kbps mode 0.              */
/*--------------------------------------------------------*/
/* INPUT ARGUMENTS :                     */
/*       _ (INT16   ) l_sf:   sub-frame size.          */
/*       _ (INT16   ) i_sf:   sub-frame index.          */
/*       _ (INT16   ) lag:    pitch lag.             */
/*       _ (FLOAT64  ) pgain:   decoded pitch gain.        */
/*       _ (INT16   ) rate_m:  decoded fix bit-rate.      */
/*       _ (FLOAT64  ) lpcg:    decoded LPC gain.          */
/*--------------------------------------------------------*/
/* OUTPUT ARGUMENTS :                     */
/*       _ (FLOAT64 []) unfcod:  unfiltered excitation signal.   */
/*--------------------------------------------------------*/
/* INPUT/OUTPUT ARGUMENTS :                  */
/*       _ (PARAMETER  *) chan:   output data structure.    */
/*--------------------------------------------------------*/
/* RETURN ARGUMENTS :                     */
/*       _ None.                       */
/*============================================================================*/


void FCS_cdbk_decod_22b_sub40(FLOAT64 unfcod [], INT16 l_sf, INT16 i_sf,
        INT16 lag, FLOAT64 pgain, PARAMETER *chan)
        {
        /*--------------------------------------------------*/


        INT16   i, IdxPuls[MAXPN], Sign[MAXPN];
        FLOAT64 Gp_m;


        /*--------------------------------------------------*/
```

```
for (i = 0; i < MAXPN; i++)
        IdxPuls[i]=chan->idx_cpcb[i_sf][i];


for (i = 0; i < MAXPN; i++)
        Sign[i] = 2*chan->idx_cpcbsign[i_sf][i]-1;



if (chan->idx_subcpcb[i_sf][0] == 1)
        {
        /*----------------------------------------------------*/
        /* 5 pulses CB : 3p x 4b + 2p x 3b + 3b signs = 21 bits     */
        /*----------------------------------------------------*/


        for (i = 1; i < 3; i++)
                {
                if (IdxPuls[i] <= IdxPuls[i+2])
                        Sign[i+2] =  Sign[i];
                else
                        Sign[i+2] = -Sign[i];
                }

        FCS_Decod_CPCB(0, Sign, 1.0, 4, 5, unfcod, l_sf, IdxPuls);
        }
else
        {
        if (chan->idx_subcpcb[i_sf][1]==1)
                {
                /*--------------------------------------------*/
                /* 5 pulses CB : 3p x 4b + 2p x 3b + 3b signs = 21 bits */
                /*--------------------------------------------*/


                FCS_Decod_CPCB(2, Sign, 1.0, 3, 5, unfcod, l_sf, IdxPuls);
                }
        else
                {
                /*--------------------------------------------*/
                /* 5 pulses CB : 5p x 3b + 5b signs = 20 bits        */
                /*--------------------------------------------*/
```

```
                    FCS_Decod_CPCB(1, Sign, 1.0, 3, 5, unfcod, l_sf, IdxPuls);
            }
        }


    /*-----------------------------------------------------------*/
    /*                    Pitch enhancement                    */
    /*-----------------------------------------------------------*/


    if ((lag < 20) && (pgain > 0.5))
            Gp_m = MIN(pgain, 1.0)*0.75;
    else
            Gp_m = pgain;


    Gp_m = MIN(Gp_m, PAST_PGAIN_MAX2);
    Gp_m = MAX(PAST_PGAIN_MIN, Gp_m);


    for (i = lag; i < l_sf; i++)
            unfcod[i] = unfcod[i] + Gp_m*unfcod[i-lag];



    /*-----------------------------------------------------------*/


    return;

    /*-----------------------------------------------------------*/
    }


/*-----------------------------------------------------------*/


/*===========================================================*/
/* FUNCTION    : FCS_cdbk_search_30b_sub40 ().               */
/*-----------------------------------------------------------*/
/* PURPOSE     : This function estimate the optimal fixed    */
/*               excitation for 8.5kbps mode 1.              */
/*-----------------------------------------------------------*/
/* INPUT ARGUMENTS :                                         */
/*      _ (FLOAT64 []) ext:    excitation signal.            */
/*      _ (FLOAT64 []) pdcfq:  quantized prediction coeff.   */
/*      _ (FLOAT64 []) target: target signal.                */
/*      _ (FLOAT64 []) res:    "ideal excitation" signal after */
```

335

```
/*                    LTP contribution.              */
/*         _ (FLOAT64 []) hh:     W(z)/A(z) impulse response.    */
/*         _ (INT16    ) l_sf:   sub-frame size.            */
/*         _ (INT16    ) i_sf:   sub-frame index.           */
/*         _ (INT16    ) lag:    pitch lag.                 */
/*         _ (INT16    ) VUV:    frame class.               */
/*         _ (FLOAT64  ) pgain:   quantized pitch gain.      */
/*         _ (FLOAT64  ) NSR:    noise to signal ratio.      */
/*         _ (FLOAT64  ) Rp:      pitch preprocessing pitch   */
/*                       correlation.                */
/*_____*/
/* OUTPUT ARGUMENTS :                               */
/*         _ (FLOAT64 []) unfcod:   unfiltered excitation signal.   */
/*         _ (PARAMETER *) chan:    output data structure.       */
/*_____*/
/* INPUT/OUTPUT ARGUMENTS :                         */
/*       _ None.                                 */
/*_____*/
/* RETURN ARGUMENTS :                               */
/*       _ None.                                 */
/*========================================================*/


void FCS_cdbk_search_30b_sub40(FLOAT64 ext [], FLOAT64 pdcfq [], FLOAT64 target [],
                               FLOAT64 res[], FLOAT64 hh [], FLOAT64 unfcod [],
                               INT16 l_sf, INT16 i_sf, INT16 lag, INT16 VUV,
                               FLOAT64 pgain, FLOAT64 NSR, FLOAT64 Rp,
                               PARAMETER *chan)

    {
    /*_____*/

    INT16 i;
    INT16 IdxPuls[MAXPN], Sign[MAXPN], SignTab[L_SF4];
    FLOAT64 Criter, Gp_m, Gp;
    FLOAT64 hh_v[L_SF4], ref[L_SF4];


    /*_____*/


    if ((lag < 20) && (pgain > 0.5))
            Gp = MIN(pgain, 1.0)*0.75;
    else
```

```
            Gp = pgain;


        /*------------------------------------------------*/


        FCS_Calc_pre_search (hh, hh_v, lag, Gp, &Gp_m, target, ref, SignTab,
                                        res, 0.5, 1, l_sf);


        /*------------------------------------------------*/
        /*   8 pulses CB : 6p x 3b + 2p x 4b + 4b signs = 30 bits      */
        /*------------------------------------------------*/


Criter = -1;
FCS_Simp_Search_CPCB(0, 0, 0, Sign, 1.0, 4, 8, SignTab, ref, &Criter,
                                        unfcod, l_sf, IdxPuls);


FCS_Simp_Search_CPCB(1, 1, 0, Sign, 1.0, 4, 8, SignTab, ref, &Criter,
                                        unfcod, l_sf, IdxPuls);


        /*------------------------------------------------*/
        /*          Sign check on the same track          */
        /*------------------------------------------------*/


for (i = 0; i < 4; i++)
        {
        if (IdxPuls[i] <= IdxPuls[i+4])
                {
                if (Sign[i] != Sign[i+4])
                        FCS_PulseExchange(IdxPuls+i, Sign+i, IdxPuls+i+4,
                                                        Sign+i+4);
                }
        else if (Sign[i] == Sign[i+4])
                        FCS_PulseExchange(IdxPuls+i, Sign+i, IdxPuls+i+4,
                                                        Sign+i+4);

        }


        /*------------------------------------------------*/
        /*             Index of the cdbk                  */
        /*------------------------------------------------*/
```

EP 1 214 706 B1

```c
for (i = 0; i < MAXPN; i++)
        chan->idx_cpcb[i_sf][i] = IdxPuls[i];

for (i = 0; i < MAXPN; i++)
        chan->idx_cpcbsign[i_sf][i] = (Sign[i]+1)/2;

chan->idx_subcpcb[i_sf][0] = 1;

/*------------------------------------------------*/
/*            Harmonic weighting on unfcod        */
/*------------------------------------------------*/

for (i = lag; i < l_sf; i++)
        unfcod[i] += Gp_m * unfcod[i-lag];

/*------------------------------------------------*/

return;

/*------------------------------------------------*/
}

/*------------------------------------------------*/


/*================================================*/
/* FUNCTION    :  FCS_cdbk_decod_30b_sub40 ().          */
/*------------------------------------------------*/
/* PURPOSE     :  This function decode the fixed excitation vector */
/*              for 8.5 kbps mode 1.                  */
/*------------------------------------------------*/
/* INPUT ARGUMENTS :                          */
/*      _ (INT16   ) l_sf:   sub-frame size.          */
/*      _ (INT16   ) i_sf:   sub-frame index.          */
/*      _ (INT16   ) lag:    pitch lag.              */
/*      _ (FLOAT64 ) pgain:  decoded pitch gain.          */
/*      _ (INT16   ) rate_m:  decoded fix bit-rate.          */
/*      _ (FLOAT64 ) lpcg:   decoded LPC gain.          */
/*------------------------------------------------*/
/* OUTPUT ARGUMENTS :                          */
/*      _ (FLOAT64 []) unfcod:  unfiltered excitation signal.   */
```

338

EP 1 214 706 B1

```
/*--------------------------------------------------------*/
/* INPUT/OUTPUT ARGUMENTS :                          */
/*     _ (PARAMETER  *) chan:    output data structure.    */
/*--------------------------------------------------------*/
/* RETURN ARGUMENTS :                               */
/*     _ None.                                 */
/*========================================================*/


void FCS_cdbk_decod_30b_sub40 (FLOAT64 unfcod [], INT16 l_sf,
                                    INT16 i_sf, INT16 lag, FLOAT64 pgain,
                                        PARAMETER *chan)
        {
        /*------------------------------------------------*/


        INT16 i, IdxPuls[MAXPN], Sign[MAXPN];
        FLOAT64 Gp_m;


        /*------------------------------------------------*/


        for (i = 0; i < MAXPN; i++)
                IdxPuls[i] = chan->idx_cpcb[i_sf][i];


        for (i = 0; i < MAXPN; i++)
                Sign[i] = 2*chan->idx_cpcbsign[i_sf][i]-1;


        /*------------------------------------------------*/
        /*   8 pulses CB : 6p x 3b + 2p x 4b + 4b signs = 30 bits        */
        /*------------------------------------------------*/


        for (i = 0; i < 4; i++)
                {
                if (IdxPuls[i] <= IdxPuls[i+4])
                        Sign[i+4] =  Sign[i];
                else
                        Sign[i+4] = -Sign[i];
                }


        FCS_Decod_CPCB(0, Sign, 1.0, 4, 8, unfcod, l_sf, IdxPuls);


        /*------------------------------------------------*/
```

339

```
/*                  Pitch enhancement              */
/*-----------------------------------------------------*/


if ((lag < 20) && (pgain > 0.5))
        Gp_m = MIN(pgain, 1.0)*0.75;
else
        Gp_m = pgain;


Gp_m = MIN(Gp_m, PAST_PGAIN_MAX);
Gp_m = MAX(PAST_PGAIN_MIN, Gp_m);


for (i = lag; i < l_sf; i++)
        unfcod[i] = unfcod[i] + Gp_m*unfcod[i-lag];


        /*-----------------------------------------------------*/


        return;


        /*-----------------------------------------------------*/
}


/*-----------------------------------------------------*/


/*=============================================================*/
/* FUNCTION    :  FCS_ChangeSign ().               */
/*-----------------------------------------------------*/
/* PURPOSE       : This function modify the sign of the excitation */
/*            gain.                          */
/*-----------------------------------------------------*/
/* INPUT ARGUMENTS :                          */
/*       _ (PARAMETER *) chan:    output data structure.      */
/*       _ (INT16     ) i_sf:    sub-frame index.          */
/*       _ (INT16     ) l_sf:    sub-frame size.          */
/*       _ (FLOAT64  []) unfcod:   unfiltered excitation signal.  */
/*       _ (FLOAT64  []) fcod:    filtered excitation signal.   */
/*-----------------------------------------------------*/
/* OUTPUT ARGUMENTS :                          */
/*       _ None.                             */
/*-----------------------------------------------------*/
/* INPUT/OUTPUT ARGUMENTS :                      */
```

340

```
/*        _ (FLOAT64  *) gain:    unquntized excitation gain.   */
/*_____*/
/* RETURN ARGUMENTS :                                    */
/*        _ None.                          */
/*=====================================================================*/


void FCS_ChangeSign (PARAMETER *chan, INT16 i_sf, INT16 l_sf,
          FLOAT64 unfcod [], FLOAT64 fcod [], FLOAT64 *gain)
          {
          /*_____*/


          INT16 i;


          /*_____*/


          for (i = 0; i < MAXPN; i++)
                chan->idx_cpcbsign[i_sf][i] *= -1;
          for (i = 0; i < MAXPN; i++)
                chan->idx_cpcbsign[i_sf][i] += 1;


          for (i = 0; i < l_sf; i++)
                unfcod[i] *= -1.0;
          for (i = 0; i < l_sf; i++)
                fcod[i] *= -1.0;
          (*gain) = -(*gain);


          /*_____*/


          return;


          /*_____*/
          }


/*_____*/



/*=====================================================================*/
/*_____ END _____*/
/*=====================================================================*/
```

341

```
/*=============================================================*/


/*=============================================================*/
/* Conexant System Inc.                        */
/* 4311 Jamboree Road                          */
/* Newport Beach, CA 92660                      */
/*-----------------------------------------------*/
/* Copyright(C) 2000 Conexant System Inc.            */
/*-----------------------------------------------*/
/* ALL RIGHTS RESERVED:                         */
/* No part of this software may be reproduced in any form or by any */
/* means or used to make any derivative work (such as transformation */
/* or adaptation) without the authorisation of Conexant System Inc.  */
/*=============================================================*/
/* PROTOTYPE FILE : lib_fcs.h                   */
/*=============================================================*/


/*-----------------------------------------------*/
/*----------------------- FUNCTIONS ----------------------*/
/*-----------------------------------------------*/


void FCS_init_lib             (void);

void FCS_Init_CPCB               (void);

void FCS_Set_CPCB                (INT16, INT16, INT16, INT16);

void FCS_Init_HF_Noise        (FLOAT64 [], INT16);



void FCS_DetermPulsLoc         (FLOAT64, INT16, FLOAT64, INT16, FLOAT64 [],
                                    INT16 [], INT16 *, INT16);



void FCS_One_Search_CPCB       (INT16, INT16 [], FLOAT64 [], FLOAT64 [], INT16 [],
                                    INT16 [], FLOAT64 *, FLOAT64 *, FLOAT64 *);
```

```
void FCS_One_Search_4kCB        (INT16 [], INT16, FLOAT64, INT16, INT16, INT16 [],
                                    FLOAT64 [], FLOAT64 [], INT16 [], INT16 [],
                                        FLOAT64 *, FLOAT64 *, FLOAT64 *, INT16);

void FCS_Full_Search_CPCB           (INT16, INT16 [], FLOAT64, INT16, INT16, INT16 [],
                                    FLOAT64 [], FLOAT64 *, FLOAT64 [],
                                        INT16, INT16 []);



void FCS_Simp_Search_CPCB (INT16, INT16, INT16, INT16 [], FLOAT64, INT16,
                                INT16, INT16 [], FLOAT64 [], FLOAT64 *,
                                    FLOAT64 [], INT16, INT16 []);



void FCS_Simp_Search_4kCB (INT16, INT16, INT16, INT16 [], FLOAT64, INT16, INT16,
                            INT16 [], FLOAT64 [], FLOAT64 *, FLOAT64 [],
                            INT16, INT16 [], INT16, FLOAT64);



void FCS_Decod_CPCB    (INT16, INT16 [], FLOAT64, INT16, INT16, FLOAT64 [],

        INT16, INT16 []);



void FCS_Decod_PitCB (INT16, INT16 [], FLOAT64, INT16, INT16, FLOAT64 [], INT16,
                                                                        INT16 [],
INT16, FLOAT64);



void FCS_Calc_pre_search(FLOAT64 [], FLOAT64 [], INT16, FLOAT64, FLOAT64 *,
                            FLOAT64 [], FLOAT64 [], INT16 [], FLOAT64 [], FLOAT64,
                            INT16, INT16);



void FCS_cdbk_search_13b_sub54 (FLOAT64 [], FLOAT64 [], FLOAT64 [], FLOAT64 [],
                                    FLOAT64 [], FLOAT64 [], INT16, INT16, INT16,
                                        INT16, FLOAT64, FLOAT64, FLOAT64,
                                        INT16, FLOAT64, PARAMETER
*);
```

EP 1 214 706 B1

```
void FCS_cdbk_decod_13b_sub54 (FLOAT64 [], FLOAT64 [], FLOAT64 [],
                               INT16, INT16, INT16, FLOAT64, INT16,
                               FLOAT64, PARAMETER *);


void FCS_cdbk_search_15b_sub80 (FLOAT64 [], FLOAT64 [], FLOAT64 [], FLOAT64 [],
                               FLOAT64 [], FLOAT64 [], INT16, INT16,
                               INT16, INT16, FLOAT64 , FLOAT64, FLOAT64,
                               INT16, FLOAT64, PARAMETER *);


void FCS_cdbk_decod_15b_sub80 (FLOAT64 [], FLOAT64 [], FLOAT64 [],
                               INT16, INT16, INT16, FLOAT64,
                               INT16, FLOAT64, PARAMETER *);


void FCS_cdbk_search_22b_sub40 (FLOAT64 [], FLOAT64 [], FLOAT64 [], FLOAT64 [],
                               FLOAT64 [], FLOAT64 [], INT16, INT16,
                               INT16, INT16, FLOAT64,
                               FLOAT64, FLOAT64,
PARAMETER *);


void FCS_cdbk_decod_22b_sub40 (FLOAT64 [], INT16, INT16,
                               INT16, FLOAT64, PARAMETER *);


void FCS_cdbk_search_30b_sub40 (FLOAT64 [], FLOAT64 [], FLOAT64 [], FLOAT64 [],
                               FLOAT64 [], FLOAT64 [], INT16, INT16,
                               INT16, INT16, FLOAT64, FLOAT64,
FLOAT64,
                               PARAMETER *);

void FCS_cdbk_decod_30b_sub40 (FLOAT64 [], INT16, INT16, INT16,
                               FLOAT64, PARAMETER *chan);


void FCS_PulseExchange(INT16 *, INT16 *, INT16 *, INT16 *);



void FCS_ChangeSign (PARAMETER *, INT16, INT16, FLOAT64 [], FLOAT64 [], FLOAT64 *);



void FCS_Search_pastcorr (FLOAT64 [], FLOAT64 [], FLOAT64, INT16, FLOAT64, INT16,
```

344

INT16, INT16, INT16, FLOAT64 [], INT16 [], INT16 *);

void FCS_ST_parameter (INT16, INT16, INT16, FLOAT64 [], INT16, FLOAT64 *,
    FLOAT64 [], FLOAT64);

```
/*=========================================================================*/
/*------------------------------ END ------------------------------*/
/*=========================================================================*/
```

```
/*===========================================================================*/


/*===========================================================================*/
/* Conexant System Inc.                              */
/* 4311 Jamboree Road                                */
/* Newport Beach, CA 92660                            */
/*----------------------------------------------------*/
/* Copyright(C) 2000 Conexant System Inc.                */
/*----------------------------------------------------*/
/* ALL RIGHTS RESERVED:                               */
/* No part of this software may be reproduced in any form or by any */
/* means or used to make any derivative work (such as transformation */
/* or adaptation) without the authorisation of Conexant System Inc.  */
/*===========================================================================*/
/* LIBRARY: lib_flt.c                                */
/*===========================================================================*/


/*----------------------------------------------------*/
/*---------------------- INCLUDE ----------------------*/
/*----------------------------------------------------*/


#include "typedef.h"


#include "main.h"
#include "mcutil.h"
#include "gputil.h"
#include "lib_flt.h"


/*----------------------------------------------------*/
/*---------------------- FUNCTIONS ----------------------*/
/*----------------------------------------------------*/


/*===========================================================================*/
/* FUNCTION     : filterAP ().                        */
/*----------------------------------------------------*/
/* PURPOSE      : Frame data all poles filtering.        */
/*----------------------------------------------------*/
/* INPUT ARGUMENTS :                                  */
/*                                                    */
/*    _ (FLOAT64 []) a   : filter coefficients.         */
```

```
/*  _ (FLOAT64 []) x   : input signal frame.              */
/*  _ (INT16)    P   : filter order.                    */
/*  _ (INT16)    N   : number of input samples.           */
/*------------------------------------------------------------*/
/* OUTPUT ARGUMENTS :                                 */
/*                                     */
/*  _ (FLOAT64 []) y : output signal frame.             */
/*------------------------------------------------------------*/
/* INPUT/OUTPUT ARGUMENTS :                             */
/*                                     */
/*  _ (FLOAT64 []) buf : input/output memory array.         */
/*------------------------------------------------------------*/
/* RETURN ARGUMENTS : _ None.                           */
/*============================================================*/


void     filterAP (FLOAT64 a [], FLOAT64 x [], FLOAT64 y [], FLOAT64 buf [],

                                                                    INT16

P, INT16 N)
        {
        /*------------------------------------------------------*/


        INT16   i, j;


        /*------------------------------------------------------*/


        for (i = 0; i < N; i ++)
            {
            buf [0] = x [i];


            for (j = P; j > 0; j --)
                {
                buf [0] -= (a [j] * buf [j]);
                buf [j]  = buf [j-1];
                }


        y [i] = buf [0];
            }


        /*------------------------------------------------------*/
```

```
        return;


        /*_____*/

        }


    /*_____*/


    /*========================================================*/

    /* FUNCTION    : filterAZ ().                        */

    /*_____*/

    /* PURPOSE     : Frame data all zeros filtering.      */

    /*_____*/

    /* INPUT ARGUMENTS :                              */

    /*                                          */

    /* _ (FLOAT64 []) b  : filter coefficients.            */

    /* _ (FLOAT64 []) x  : input signal frame.            */

    /* _ (INT16)    P  : filter order.                 */

    /* _ (INT16)    N  : number of input samples.          */

    /*_____*/

    /* OUTPUT ARGUMENTS :                            */

    /*           .                            */

    /* _ (FLOAT64 []) y : output signal frame.            */

    /*_____*/

    /* INPUT/OUTPUT ARGUMENTS :                       */

    /*                                          */

    /* _ (FLOAT64 []) buf : input/output memory array.      */

    /*_____*/

    /* RETURN ARGUMENTS : _ None.                     */

    /*========================================================*/


    void    filterAZ (FLOAT64 b [], FLOAT64 x [], FLOAT64 y [], FLOAT64 buf [],
                                                    INT16 P, INT16
    N)
        {
        /*_____*/


        INT16  i, j;


        /*_____*/
```

```
        for (i = 0; i < N; i ++)
                {
                buf [0] =           x [i];
                y       [i] =  0.0;

                for (j = P; j > 0; j --)
                        {
                        y       [i] += buf [j] * b [j];
                        buf [j] =  buf [j-1];
                        }

                y [i] += (buf [0] * b [0]);
                }


        /*------------------------------------------------------*/


        return;


        /*------------------------------------------------------*/

        }


/*------------------------------------------------------*/


/*======================================================================*/
/* FUNCTION     : filterPZ ().                           */
/*---------------------------------------------------*/
/* PURPOSE      : Frame data all poles-zeros filtering.          */
/*---------------------------------------------------*/
/* INPUT ARGUMENTS :                           */
/*                                  */
/*   _ (FLOAT64 []) b   : numerator filter coefficients.         */
/*   _ (FLOAT64 []) a   : denominator filter coefficients.       */
/*   _ (FLOAT64 []) x   : input signal frame.               */
/*   _ (INT16)    P  : filter order.                   */
/*   _ (INT16)    N  : number of input samples.             */
/*---------------------------------------------------*/
/* OUTPUT ARGUMENTS :                          */
/*                                  */
/*   _ (FLOAT64 []) y : output signal frame.                */
/*---------------------------------------------------*/
```

```
/* INPUT/OUTPUT ARGUMENTS :                              */
/*                                      */
/*  _ (FLOAT64 []) buf : input/output memory array.        */
/*--------------------------------------------------*/
/* RETURN ARGUMENTS : _ None.                          */
/*================================================*/


void     filterPZ (FLOAT64 b [], FLOAT64 a [], FLOAT64 x [], FLOAT64 y [], \
                                          FLOAT64 buf [], INT16 P, INT16
N)
        {
        /*--------------------------------------------*/


        INT16   i, j;


        /*--------------------------------------------*/


        for (i = 0; i < N; i ++)
                {
                buf [0] = x [i];
                y [i] = 0.0;

                for (j = P; j > 0; j --)
                        {
                        y [i] += (buf [j] * b [j]);
                        buf [0] -= (a [j] * buf [j]);
                        buf [j] = buf [j-1];
                        }

                y [i] += (buf [0] * b [0]);
                }

        /*--------------------------------------------*/

        return;

        /*--------------------------------------------*/
        }

/*------------------------------------------------*/
```

350

```
/*========================================================================*/
/* FUNCTION     : FLT_conv ().                          */
/*_____*/
/* PURPOSE      : This function perform a filtering operation    */
/*                                         */
/*    The input array, x, is assumed to include past input values */
/*    (NCOFS-1 values) for the filter memory, as well as new input  */
/*    values.  The array is set up as follows:              */
/*                                         */
/*          Xin(NCOFS)          Xin(N+NCOFS-1)    */
/*              |     new data      |       */
/*        I---------II-------------------------I       */
/*        |  old  |                    */
/*      Xin(1)   Xin(NCOFS-1)                  */
/*                                         */
/*    The first NCOFS-1 points of array Xin are assumed to be the  */
/*    "warm-up" points for the first output point, Xout(1).      */
/*_____*/
/* INPUT ARGUMENTS :                         */
/*                                         */
/*  _ (FLOAT64 []) x   : input signal frame.               */
/*  _ (FLOAT64 []) a   : denominator filter coefficients.       */
/*  _ (INT16)   P   : filter order.                  */
/*  _ (INT16)    N   : number of input samples to be filtered.  */
/*_____*/
/* OUTPUT ARGUMENTS :                         */
/*  _ (FLOAT64 []) y   : output signal frame.              */
/*_____*/
/* INPUT/OUTPUT ARGUMENTS :                       */
/*  _ (FLOAT64 []) buf : input/output memory array.          */
/*_____*/
/* RETURN ARGUMENTS :                         */
/*  _ None.                               */
/*========================================================================*/


void FLT_conv (FLOAT64 x[], FLOAT64 a[], INT16 P, INT16 N, FLOAT64 y[])
        {
        /*_____*/
```

```
INT16 i, l, k;
FLOAT64  sum;


        /*---------------------------------------------------*/


        for (i = 0; i < N; i++)
                {
                sum = 0.0;
                l = P + i;


                for (k = 0; k < P; k++ )
                        {
                        l -= 1;
                        sum += a[k] * x[l];
                        }


                y[i] = sum;
                }


        /*---------------------------------------------------*/


        return;


        /*---------------------------------------------------*/
        }



        /*--------------------------------------------------------*/


/*==================================================================*/
/* FUNCTION     : FLT_allsyn ().                    */
/*---------------------------------------------------*/
/* PURPOSE      : This function filter a signal using an all-pole */
/*               filter                      */
/*---------------------------------------------------*/
/* INPUT ARGUMENTS :                        */
/*                              */
/*   _ (FLOAT64 []) x    : input signal frame.          */
/*   _ (FLOAT64 []) a    : denominator filter coefficients.      */
/*   _ (INT16)    P   : filter order.               */
```

```
/*  _ (INT16)   N   : number of input samples to be filtered.  */
/*-----------------------------------------------------------*/
/* OUTPUT ARGUMENTS :                              */
/*  _ (FLOAT64 []) y   : output signal frame.            */
/*-----------------------------------------------------------*/
/* INPUT/OUTPUT ARGUMENTS :                          */
/*  _ (FLOAT64 []) buf : input/output memory array.        */
/*-----------------------------------------------------------*/
/* RETURN ARGUMENTS :                              */
/*  _ None.                                    */
/*===========================================================*/


void FLT_allsyn (FLOAT64 x[], INT16 N, FLOAT64 a[], INT16 P, FLOAT64 y[],

                 FLOAT64 buff[])
       {
       /*-----------------------------------------------------*/


       INT16   i, k;
       FLOAT64 sum;


       /*-----------------------------------------------------*/


       for (i = 0; i < N; i++)
              {
              sum = x[i];

              for (k = P-1; k >= 1; k-- )
                     {
                     sum = sum + a[k] * buff[k];
                     buff[k] = buff[k-1];
                     }

              if (P > 0)
              sum = sum +  a[0]*buff[0];

              buff[0] = sum;
              y[i] = sum;


              }
```

```
/*----------------------------------------------*/

    return;

    /*----------------------------------------------*/
    }

/*----------------------------------------------*/

/*==============================================*/
/*------------------ END -----------------------*/
/*==============================================*/
```

```
/*===============================================================*/


/*===============================================================*/
/* Conexant System Inc.                        */
/* 4311 Jamboree Road                          */
/* Newport Beach, CA 92660                      */
/*----------------------------------------------*/
/* Copyright(C) 2000 Conexant System Inc.          */
/*----------------------------------------------*/
/* ALL RIGHTS RESERVED:                         */
/* No part of this software may be reproduced in any form or by any */
/* means or used to make any derivative work (such as transformation */
/* or adaptation) without the authorisation of Conexant System Inc.  */
/*===============================================================*/
/* PROTOTYPE FILE : lib_flt.h                    */
/*===============================================================*/


/*----------------------------------------------*/
/*--------------------- FUNCTIONS ---------------------*/
/*----------------------------------------------*/


void    filterAP (FLOAT64 [], FLOAT64 [], FLOAT64 [], FLOAT64 [], INT16, INT16);


void    filterAZ (FLOAT64 [], FLOAT64 [], FLOAT64 [], FLOAT64 [], INT16, INT16);


void    filterPZ (FLOAT64 [], FLOAT64 [], FLOAT64 [], FLOAT64 [], FLOAT64 [],


            INT16, INT16);
void    FLT_conv      (FLOAT64 [], FLOAT64 [], INT16, INT16, FLOAT64 []);


void    FLT_allsyn    (FLOAT64 [], INT16, FLOAT64 [], INT16, FLOAT64 [], FLOAT64 []);


/*===============================================================*/
/*---------------------- END ----------------------*/
/*===============================================================*/
```

```
/*===========================================================================*/


/*===========================================================================*/
/* Conexant System Inc.                         */
/* 4311 Jamboree Road                           */
/* Newport Beach, CA 92660                       */
/*----------------------------------------------*/
/* Copyright(C) 2000 Conexant System Inc.            */
/*----------------------------------------------*/
/* ALL RIGHTS RESERVED:                          */
/* No part of this software may be reproduced in any form or by any  */
/* means or used to make any derivative work (such as transformation */
/* or adaptation) without the authorisation of Conexant System Inc.  */
/*===========================================================================*/
/* LIBRARY: lib_gcb.c                           */
/*===========================================================================*/


/*----------------------------------------------*/
/*---------------------- INCLUDE ----------------------*/
/*----------------------------------------------*/


#include "typedef.h"
#include "main.h"
#include "const.h"
#include "gputil.h"
#include "mcutil.h"
#include "ext_var.h"

#include "lib_gcb.h"
#include "lib_flt.h"


#include "gauss_bv.tab"


/*----------------------------------------------*/
/*---------------------- DEFINE ----------------------*/
/*----------------------------------------------*/


#define TABLE_SIZE    32.0
#define INV_TABLE_SIZE 1.0/32.0
```

```
#define  a        25173
#define  c        13849
#define  m        65536


#define  UNIF_VAR_NUM       12
#define  GAUSS_VEC_SIZE     40
#define  MAX_VEC_NUM              2


/*----------------------------------------------------*/
/*--------------------- FUNCTIONS --------------------*/
/*----------------------------------------------------*/


/*==================================================================*/
/* FUNCTION     : GCB_init_lib ().                 */
/*----------------------------------------------------*/
/* PURPOSE      : This function initialise the global variable of */
/*               the library GCB.                  */
/*----------------------------------------------------*/
/* INPUT ARGUMENTS :                               */
/*           _ None.                          */
/*----------------------------------------------------*/
/* OUTPUT ARGUMENTS :                              */
/*           _ None.                          */
/*----------------------------------------------------*/
/* INPUT/OUTPUT ARGUMENTS :                          */
/*           _ None.                          */
/*----------------------------------------------------*/
/* RETURN ARGUMENTS :                              */
/*           _ None.                          */
/*==================================================================*/


void GCB_init_lib (void)
        {
        /*----------------------------------------------------*/
        /*              GCB_decode_gauss_cb_itu4k          */
        /*----------------------------------------------------*/


        seed_exc = 21845;
```

```
/*------------------------------------------------*/
/*                GCB_gauss_excit_dec           */
/*------------------------------------------------*/


    Z1_gcb=0;


/*------------------------------------------------*/
/*                GCB_gauss_excit               */
/*------------------------------------------------*/


    ref_eng_gcb = 0;
    rate_mem    = RATE8_5K;


/*------------------------------------------------*/
/*                GCB_gauss_excit_dec           */
/*------------------------------------------------*/


    seed_dec = 0;


/*------------------------------------------------*/

    return;


/*------------------------------------------------*/
    }


/*------------------------------------------------*/


/*================================================*/
/* FUNCTION     : GCB_decode_gauss_cb_itu4k ().          */
/*------------------------------------------------*/
/* PURPOSE      : This function extract the gaussina vector from */
/*               the codebook.                  */
/*------------------------------------------------*/
/* INPUT ARGUMENTS :                            */
/*         _ (INT16   )  N_gauss: gaussian codebook size.    */
/*         _ (INT16   )  L_vec:  gaussian vector size.       */
/*         _ (INT16   )  index:  codebook index.            */
/*         _ (INT16   )  sign:   sign.                      */
```

```
/*-------------------------------------------------*/
/* OUTPUT ARGUMENTS :                     */
/*       _ (FLOAT64 [])  unfcod:  unfiltered excitation   */
/*                  vector.           */
/*-------------------------------------------------*/
/* INPUT/OUTPUT ARGUMENTS :                */
/*       _ None.                */
/*-------------------------------------------------*/
/* RETURN ARGUMENTS :                   */
/*       _ None.                 */
/*=================================================*/


void GCB_decode_gauss_cb_itu4k(INT16 N_gauss, INT16 L_vec, INT16 index,

                                                        INT16 sign,

FLOAT64 unfcod [])
        {
        /*-----------------------------------------*/


        INT16 k, delay, table_entry;
        FLOAT64 x, *unfcod_p;


        /*-----------------------------------------*/


        if (index >= N_gauss)
                {
                index = (INT16)(N_gauss* GCB_quickuran(&seed_exc));
                x = GCB_quickuran(&seed_exc);
                if (x < 0.5)
                        . sign = 1;
                else
                        sign = -1;
                }


        /*-----------------------------------------*/


        if (index < N_gauss)
                {
                delay = (INT16)(index*INV_TABLE_SIZE);
                table_entry = (INT16)(index-delay*TABLE_SIZE);
```

```
            if (sign == 1)
                    {
                    unfcod_p = unfcod - 2*delay;
                    for (k = delay; k < L_vec; k++)
                            unfcod_p[2*k] = bv[table_entry][k];
                    unfcod_p = unfcod + 2*(L_vec - delay);

                    for(k = 0; k < delay; k++)
                            unfcod_p[2*k] = bv[table_entry][k];
                    }
            else
                    {
                    unfcod_p = unfcod - 2*delay;
                    for(k = delay; k < L_vec; k++)
                            unfcod_p[2*k] = -bv[table_entry][k];
                    unfcod_p = unfcod + 2*(L_vec - delay);
                    for(k = 0; k < delay; k++)
                            unfcod_p[2*k] = -bv[table_entry][k];
                    }
            }
        else
                {
#ifdef VERBOSE
                printf("FATAL ERROR: cb index (%d) out of range\n",index);
                exit(0);
#endif
                }
        /*-------------------------------------------------------*/

        return;

        /*-------------------------------------------------------*/
        }


/*-------------------------------------------------------------*/

/*=============================================================*/
/* FUNCTION    : GCB_gauss_cb_itu4k ().                   */
/*-------------------------------------------------------------*/
/* PURPOSE      : This function select the MAX_VEC_NUM gaussian  */
```

```
/*              vectors in the codebooks.              */
/*-------------------------------------------------*/
/* INPUT ARGUMENTS :                               */
/*      _ (FLOAT64 []) target:   target vector.        */
/*      _ (FLOAT64 []) res:      residual vector.       */
/*      _ (INT16   ) i_sf:    sub-frame index.       */
/*      _ (INT16   ) l_sf:    sub-frame index size.   */
/*      _ (FLOAT64 []) hh:       impulse response.      */
/*      _ (FLOAT64 *) Criter:   maximazed criterium.     */
/*      _ (INT16   ) N_gauss_1: 1st gaussian codebook size. */
/*      _ (INT16   ) N_gauss_2: 2nd gaussian codebook size. */
/*-------------------------------------------------*/
/* OUTPUT ARGUMENTS :                              */
/*      _ (FLOAT64 []) unfcod :  unfiltered excitation   */
/*                      vector.              */
/*      _ (INT16  []) index:   selected codebook indexes. */
/*      _ (INT16  []) sign:    selected vectors sign.    */
/*-------------------------------------------------*/
/* INPUT/OUTPUT ARGUMENTS :                         */
/*          _ None.                          */
/*-------------------------------------------------*/
/* RETURN ARGUMENTS :                              */
/*          _ None.                          */
/*=================================================*/


void GCB_gauss_cb_itu4k (FLOAT64 target[], FLOAT64 res[],
                        FLOAT64 hh [], FLOAT64 *Criter,
                        FLOAT64 unfcod [], INT16 *index, INT16 sign [],
                        INT16 N_gauss_1, INT16 N_gauss_2)
    {
    /*-------------------------------------------------*/

    INT16   index1_buf [NUM_PRESELECT], sign1_buf[NUM_PRESELECT];
    INT16   index2_buf [NUM_PRESELECT], sign2_buf[NUM_PRESELECT];
    INT16   index_tmp[MAX_VEC_NUM], sign_tmp[MAX_VEC_NUM];
    FLOAT64 match;

    /*-------------------------------------------------*/
    /*================= Preselection =================*/
    /*-------------------------------------------------*/
```

EP 1 214 706 B1

```
/*-----------------------------------------------*/
/*              First basis vector           */
/*-----------------------------------------------*/


GCB_basis_preselect_itu4k (res, N_gauss_1, GAUSS_VEC_SIZE, index1_buf,
                                                          sign1_buf,
NUM_PRESELECT);


/*-----------------------------------------------*/
/*              Second basis vector          */
/*-----------------------------------------------*/



GCB_basis_preselect_itu4k(res+1, N_gauss_2, GAUSS_VEC_SIZE, index2_buf,

sign2_buf, NUM_PRESELECT);


/*-----------------------------------------------*/
/*================== Fine search ===================*/
/*-----------------------------------------------*/


match = GCB_fine_search_itu4k(target, hh, index1_buf, sign1_buf,
                                        GAUSS_VEC_SIZE, N_gauss_1,
index2_buf,
                                        sign2_buf, GAUSS_VEC_SIZE,
                                        N_gauss_2, NUM_PRESELECT,
index_tmp,
                                        sign_tmp);


/*-----------------------------------------------*/
/*================== Compare match ===================*/
/*-----------------------------------------------*/


if(match > (*Criter))
        {
        (*Criter) = match;
        index[0] = index_tmp[0];
        index[1] = index_tmp[1];
        sign[0] = sign_tmp[0];
```

362

```
            sign[1] = sign_tmp[1];


            GCB_decode_gauss_cb_itu4k (N_gauss_1, GAUSS_VEC_SIZE,

                                             index[0], sign[0],
        unfcod);
            GCB_decode_gauss_cb_itu4k (N_gauss_2, GAUSS_VEC_SIZE,

                                             index[1], sign[1], unfcod+1);

        }
        /*--------------------------------------------------*/


    return;


        /*--------------------------------------------------*/
    }


    /*--------------------------------------------------*/


    /*==================================================*/
    /* FUNCTION    : GCB_basis_preselect_itu4k ().          */
    /*--------------------------------------------------*/
    /* PURPOSE     : This function pre-select the 2 gaussian vectors */
    /*               in the codebooks.                      */
    /*--------------------------------------------------*/
    /* INPUT ARGUMENTS :                                   */
    /*        _ (FLOAT64 []) res :      residual vector.    */
    /*        _ (INT16   ) N_gauss :    gaussian codebook size. */
    /*        _ (INT16   ) L_vec :      gaussian vector size.   */
    /*        _ (INT16   ) skip_fac:    skip factor.        */
    /*        _ (INT16   ) num_preselect: number of pre-selected */
    /*                     candidates.       */
    /*--------------------------------------------------*/
    /* OUTPUT ARGUMENTS :                                  */
    /*        _ (INT16 []) index_buf:   codebook index buffer.  */
    /*        _ (INT16 []) sign_buf:    codebook sign buffer.   */
    /*--------------------------------------------------*/
    /* INPUT/OUTPUT ARGUMENTS :                            */
    /*        _ None.                                      */
    /*--------------------------------------------------*/
    /* RETURN ARGUMENTS :                                  */
    /*        _ None.                                      */
```

```
/*=======================================================*/


void GCB_basis_preselect_itu4k (FLOAT64 res[], INT16 N_gauss, INT16 L_vec,
                                         INT16 index_buf [], INT16 sign_buf [],
                                         INT16 num_preselect)

        {
        /*----------------------------------------------*/


        INT16   i, j, k, table_entry, delay, sign;
        FLOAT64        numer[NUM_PRESELECT], tstnum, x, *res_p;


        /*----------------------------------------------*/


        for (i = 0; i < num_preselect; i++)
                {
                numer[i]               = -1.0;
                index_buf[i]      = 0;
                sign_buf[i]      = 1;
                }


        /*----------------------------------------------*/
        /*         Preselection of the basis vectors          */
        /*----------------------------------------------*/


        for (i = 0; i < N_gauss; i++)
                {
                delay = (INT16)(i*INV_TABLE_SIZE);
                table_entry = (INT16)(i-delay*TABLE_SIZE);


                /*----------------------------------------------*/
                /*      Correlation between target and codebook vector      */
                /*----------------------------------------------*/


                res_p = res - 2*delay;


                for(tstnum=0.0, j=delay; j<L_vec; j++)
                        tstnum += res_p[2*j]*bv[table_entry][j];
                res_p = res + 2*(L_vec - delay);


                for(j=0; j<delay; j++)
```

```
tstnum += res_p[2*j]*bv[table_entry][j];


/*------------------------------------------------*/


if (tstnum >= 0.0)
        sign = 1;
else
        {
        sign = -1;
        tstnum = -tstnum;
        }


/*------------------------------------------------*/
/*      NOTE : see AMR fixed-point code for low complexity    */
/*   (and bit-exact) approachCorrelation between target and    */
/*             codebook vector              */
/*------------------------------------------------*/


if (tstnum > numer[0])
        {
        /*------------------------------------------------*/


        numer[0] = tstnum;
        index_buf[0] = i;
        sign_buf[0] = sign;

        for (j=0; j<num_preselect-1; j++)
                {
                if (numer[j] > numer[j+1])
                        {
                        x = numer[j];
                        numer[j] = numer[j+1];
                        numer[j+1] = x;
                        k = index_buf[j];
                        index_buf[j] = index_buf[j+1];
                        index_buf[j+1] = k;
                        k = sign_buf[j];
                        sign_buf[j] = sign_buf[j+1];
                        sign_buf[j+1] = k;
                        }
```

EP 1 214 706 B1

```
                    }
        /*-------------------------------------------------*/
                    }
                }

        /*-------------------------------------------------*/

        return;

        /*-------------------------------------------------*/
        }


    /*-------------------------------------------------*/

    /*=================================================*/
    /* FUNCTION     : GCB_fine_search_itu4k ().                    */
    /*-------------------------------------------------*/
    /* PURPOSE      : This function pre-select the 2 gaussian vectors */
    /*               in the codebooks.                           */
    /*-------------------------------------------------*/
    /* INPUT ARGUMENTS  :                                        */
    /*       _ (FLOAT64 []) target:    taget vector.             */
    /*       _ (FLOAT64 []) hh:        impulse response.         */
    /*       _ (INT16 []) index1:   1st codebook vector          */
    /*                    indexes.                               */
    /*       _ (INT16 []) sign1:    1st codebook vector signs.   */
    /*       _ (INT16  ) l1:        1st gaussian vector size.    */
    /*       _ (INT16  ) N1:        1st gaussian codebook        */
    /*                    size.                                  */
    /*       _ (INT16 []) index2:    2nd codebook vector         */
    /*                    indexes.                               */
    /*       _ (INT16 []) sign2:    2nd codebook vector signs.   */
    /*       _ (INT16  ) l2:        2nd gaussian vector size.    */
    /*       _ (INT16  ) N2:        2nd gaussian codebook        */
    /*                    size.                                  */
    /*       _ (INT16  ) num_preselect: number of pre-selected   */
    /*                    vectors.                               */
    /*-------------------------------------------------*/
    /* OUTPUT ARGUMENTS :                                        */
    /*       _ (INT16 []) index_tmp: selected codebook vector    */
```

366

```
/*                    indexes.              */
/*         _ (INT16 []) sign_tmp: selected codebook vector    */
/*                    signs.                */
/*_____*/
/* INPUT/OUTPUT ARGUMENTS :                       */
/*         _ None.                        */
/*_____*/
/* RETURN ARGUMENTS :                          */
/*         _ (FLOAT64   ) tmax :   maximized criterion.      */
/*===========================================================*/



FLOAT64 GCB_fine_search_itu4k(FLOAT64 target [], FLOAT64 hh [],
                    INT16 *index1, INT16 *sign1, INT16 l1, INT16 N1,
                    INT16 *index2, INT16 *sign2, INT16 l2, INT16 N2,
                    INT16 num_preselect, INT16 *index_tmp,
                    INT16 *sign_tmp)
        {
        /*_____*/


        INT16 i1, i2, l_sf;
        FLOAT64 unfcod_tmp[L_SF], fcod_tmp[L_SF], tstden, tstnum, x, tmax;


        FLOAT64        *buf;


        /*_____*/


        l_sf = l1 + l2;


        /*_____*/


        buf = dvector (0, l_sf-1);


        /*_____*/


        tmax = -1.0;
        for (i1 = 0; i1 < num_preselect; i1++)
                {
                GCB_decode_gauss_cb_itu4k (N1, l1, index1[i1], sign1[i1],
```

```
                unfcod_tmp);

    for(i2=0; i2<num_preselect; i2++)
        {
        GCB_decode_gauss_cb_itu4k (N2, 12, index2[i2], sign2[i2],

unfcod_tmp+1);


        /*---------------------------------------------------*/
        /*      Compute the filtered random vector        */
        /*---------------------------------------------------*/


        ini_dvector (buf, 0, l_sf-1, 0.0);
        filterAZ (hh, unfcod_tmp, fcod_tmp, buf, (INT16)(l_sf-1),

            l_sf);


        /*---------------------------------------------------*/
        /*              Compute the error             */
        /*---------------------------------------------------*/


        dot_dvector (target,      fcod_tmp, &tstnum, 0, l_sf-1);
        dot_dvector (fcod_tmp, fcod_tmp, &tstden, 0, l_sf-1);
        tstden += EPSI;


        x = tstnum*tstnum/tstden;


        /*---------------------------------------------------*/
        /*          Maximisation of the criterium        */
        /*---------------------------------------------------*/


        if (x > tmax)
                {
                tmax = x;
                index_tmp[0] = index1[i1];
                index_tmp[1] = index2[i2];
                sign_tmp[0] = sign1[i1];
                sign_tmp[1] = sign2[i2];
                }
```

```
                    /*----------------------------------------------*/
                    }


                    /*----------------------------------------------*/
                    }


            /*----------------------------------------------*/


            free_dvector (buf, 0, 1_sf-1);


            /*----------------------------------------------*/


            return tmax;


            /*----------------------------------------------*/
            }


    /*==============================================================*/
    /* FUNCTION    : GCB_quickuran ().                    */
    /*----------------------------------------------*/
    /* PURPOSE     : This function generate Gaussian random values   */
    /*              with mean zero and the variance is 1.        */
    /*----------------------------------------------*/
    /* INPUT ARGUMENTS :                      */
    /*          _ None.                      */
    /*----------------------------------------------*/
    /* OUTPUT ARGUMENTS :                      */
    /*          _ None.                      */
    /*----------------------------------------------*/
    /* INPUT/OUTPUT ARGUMENTS :                    */
    /*      _ (INT64  *) seed :      random generetor seed.  */
    /*----------------------------------------------*/
    /* RETURN ARGUMENTS :                      */
    /*      _ (INT64  *) val:      random gaussian value.  */
    /*==============================================================*/


    FLOAT64 GCB_quickuran (INT64 *seed)
```

```
        {
        /*-------------------------------------------------*/

    FLOAT64 val;

        /*-------------------------------------------------*/

    *seed = (a* (*seed) + c) % m;

    val = (FLOAT64) (*seed) / (FLOAT64) m;

        /*-------------------------------------------------*/

    return val;

        /*-------------------------------------------------*/
        }

/*-------------------------------------------------------*/


/*=====================================================================*/
/* FUNCTION     : GCB_gauss_noise ().                   */
/*-----------------------------------------------------*/
/* PURPOSE      : This function generate Gaussian random values   */
/*               with mean zero and variance 1.            */
/*-----------------------------------------------------*/
/* INPUT ARGUMENTS :                          */
/*               _ None.                      */
/*-----------------------------------------------------*/
/* OUTPUT ARGUMENTS :                         */
/*               _ None.                      */
/*-----------------------------------------------------*/
/* INPUT/OUTPUT ARGUMENTS :                       */
/*         _ (INT64   *) seed :      random generetor seed.  */
/*-----------------------------------------------------*/
/* RETURN ARGUMENTS :                         */
/*         _ (INT64   *) val:       random gaussian value.  */
/*=====================================================================*/


FLOAT64 GCB_gauss_noise (INT64 *seed)
```

```
        {
        /*------------------------------------------------------*/


        INT16   i;
        FLOAT64      sum, val;


        /*------------------------------------------------------*/


        sum = 0.0;
        for (i = 0; i <  UNIF_VAR_NUM; i++)
                sum += GCB_quickuran (seed);


        /*------------------------------------------------------*/


        val = sum - (FLOAT64)UNIF_VAR_NUM / 2.0;


        /*------------------------------------------------------*/


        return val;


        /*------------------------------------------------------*/
        }


/*------------------------------------------------------------*/


/*===========================================================*/
/* FUNCTION     :  GCB_gauss_excit_dec ().                   */
/*----------------------------------------------------------*/
/* PURPOSE      :  This function generate Gaussian noise for the  */
/*                 decoder at very low bit-rate coding.          */
/*----------------------------------------------------------*/
/* INPUT ARGUMENTS  :                                        */
/*          _ (INT16    ) rate :  fixed bit-rate.            */
/*----------------------------------------------------------*/
/* OUTPUT ARGUMENTS :                                        */
/*          _ (FLOAT64 []) ext :   gaussian excitation signal.   */
/*----------------------------------------------------------*/
/* INPUT/OUTPUT ARGUMENTS :                                  */
/*          _ (INT64    *) seed :  random generetor seed.    */
/*----------------------------------------------------------*/
```

```c
/* RETURN ARGUMENTS :                                      */
/*              _ None.                              */
/*==================================================================*/


void GCB_gauss_excit_dec (INT64 *seed, INT16 rate, FLOAT64 ext[])
        {
        /*----------------------------------------------------------*/


        INT16 i;
        FLOAT64 C;


        /*----------------------------------------------------------*/


        C = 0.0;
        for (i = 0; i < L_FRM; i++)
                {
                ext[i] = GCB_gauss_noise(seed) + C*Z1_gcb;
                Z1_gcb = ext[i];
                }


        /*----------------------------------------------------------*/


        return;


        /*----------------------------------------------------------*/
        }


/*----------------------------------------------------------*/


/*==================================================================*/
/* FUNCTION     : GCB_gauss_excit ().                       */
/*----------------------------------------------------------*/
/* PURPOSE      : This function generate Gaussian noise for the  */
/*               encoder at very low bit-rate coding.        */
/*----------------------------------------------------------*/
/* INPUT ARGUMENTS :                                     */
/*       _ (INT16   ) rate :  fixed bit-rate.           */
/*       _ (INT16   ) rate_m : past fixed bit-rate.      */
/*       _ (FLOAT64  ) NSR :   estimated noise to signal ratio.*/
/*       _ (FLOAT64 []) ResEng : estimated residual energy.   */
```

```
/*-----------------------------------------------------*/
/* OUTPUT ARGUMENTS :                              */
/*      _ (FLOAT64 []) ext :    gaussian excitation signal.  */
/*      _ (FLOAT64 []) gc  :    gain scaling factor.      */
/*-----------------------------------------------------*/
/* INPUT/OUTPUT ARGUMENTS :                        */
/*      _ (INT64   *) seed :   random generetor seed.   */
/*-----------------------------------------------------*/
/* RETURN ARGUMENTS :                              */
/*          _ None.                          */
/*=====================================================*/



void GCB_gauss_excit (INT64 *seed, INT16 rate, INT16 rate_m, FLOAT64 NSR,
                        FLOAT64 ResEng[], FLOAT64 ext[], FLOAT64 gc[])
        {
        /*-----------------------------------------------------*/

        FLOAT64 x;

        /*-----------------------------------------------------*/

        GCB_gauss_excit_dec(seed, rate, ext);

        if (rate == RATE2_0K)
                {
                ref_eng_gcb = ResEng[0];
                dot_dvector(ext, ext, &x, 0, L_FRM/2-1);

                gc[0] = 0.7*sqrt(MAX(ref_eng_gcb-80*4, 0) / MAX(x, 0.0001));

                ref_eng_gcb = ResEng[1];

                dot_dvector(ext+L_FRM/2, ext+L_FRM/2, &x, 0, L_FRM/2-1);

                gc[2]=0.7*sqrt(MAX(ref_eng_gcb-80*4, 0) / MAX(x, 0.0001));
                }
        else
                {
                if ((rate_mem != RATE0_8K) || (rate_m != RATE0_8K))
```

```
                ref_eng_gcb = ResEng[0] + ResEng[1];
        else
                ref_eng_gcb = 0.5*ref_eng_gcb + 0.5*(ResEng[0]+ResEng[1]);


        dot_dvector (ext, ext, &x, 0, L_FRM-1);

        gc[0] = 0.7*sqrt(MAX(ref_eng_gcb-160*6, 0) / MAX(x, 0.0001));
        }
/*-------------------------------------------------*/
/*              Memory Up-date              */
/*-------------------------------------------------*/


rate_mem = rate_m;


/*-------------------------------------------------*/


return;


/*-------------------------------------------------*/
}

/*-------------------------------------------------*/


/*=================================================*/
/*--------------------- END ---------------------*/
/*=================================================*/
```

```
/*============================================================*/

/*============================================================*/
/* Conexant System Inc.                        */
/* 4311 Jamboree Road                          */
/* Newport Beach, CA 92660                      */
/*_____*/
/* Copyright(C) 2000 Conexant System Inc.          */
/*_____*/
/* ALL RIGHTS RESERVED:                         */
/* No part of this software may be reproduced in any form or by any */
/* means or used to make any derivative work (such as transformation */
/* or adaptation) without the authorisation of Conexant System Inc. */
/*============================================================*/
/* PROTOTYPE FILE : lib_gcb.h                    */
/*============================================================*/


/*_____*/
/*_____ FUNCTIONS _____*/
/*_____*/


void     GCB_init_lib                    (void);


void     GCB_decode_gauss_cb_itu4k        (INT16, INT16, INT16, INT16, FLOAT64 []);


void     GCB_gauss_cb_itu4k               (FLOAT64 [], FLOAT64 [], FLOAT64 [],
                                           FLOAT64 *, FLOAT64 [], INT16 *,
                                           INT16 [], INT16, INT16);


void     GCB_basis_preselect_itu4k        (FLOAT64 [], INT16, INT16, INT16 [],
                                           INT16 [], INT16);


FLOAT64     GCB_fine_search_itu4k          (FLOAT64 [], FLOAT64 [],
                                           INT16 *, INT16 *, INT16, INT16, INT16
*,
                                           INT16 *, INT16, INT16, INT16,
                                           INT16 *, INT16 *);
```

```
FLOAT64        GCB_quickuran                    (INT64 *);

FLOAT64        GCB_gauss_noise                  (INT64 *);


void    GCB_gauss_excit_dec          (INT64 *, INT16, FLOAT64 []);

void    GCB_gauss_excit              (INT64 *, INT16, INT16, FLOAT64, FLOAT64 [],
                                      FLOAT64 [], FLOAT64 []);


/*===========================================================================*/
/*----------------------- END -----------------------------*/
/*===========================================================================*/
```

```
/*===============================================================*/


/*===============================================================*/
/* Conexant System Inc.                          */
/* 4311 Jamboree Road                            */
/* Newport Beach, CA 92660                        */
/*-----------------------------------------------*/
/* Copyright(C) 2000 Conexant System Inc.              */
/*-----------------------------------------------*/
/* ALL RIGHTS RESERVED:                          */
/* No part of this software may be reproduced in any form or by any */
/* means or used to make any derivative work (such as transformation */
/* or adaptation) without the authorisation of Conexant System Inc.  */
/*===============================================================*/
/* LIBRARY: lib_geq.c                            */
/*===============================================================*/


/*-----------------------------------------------*/
/*------------------------ INCLUDE ---------------------------*/
/*-----------------------------------------------*/


#include "typedef.h"


#include "main.h"
#include "const.h"
#include "gputil.h"


#include "ext_var.h"


#include "lib_geq.h"


/*-----------------------------------------------*/
/*----------------------- FUNCTIONS ---------------------------*/
/*-----------------------------------------------*/


/*===============================================================*/
/* FUNCTION    : GEQ_init_lib (). */
/*-----------------------------------------------*/
/* PURPOSE     : This function initilise the global variables of */
/*               the GEQ library.                       */
```

```
/*-------------------------------------------------*/
/* INPUT ARGUMENTS :                    */
/*              _ None.             */
/*-------------------------------------------------*/
/* OUTPUT ARGUMENTS :                   */
/*              _ None.             */
/*-------------------------------------------------*/
/* INPUT/OUTPUT ARGUMENTS :               */
/*              _ None.             */
/*-------------------------------------------------*/
/* RETURN ARGUMENTS :                   */
/*              _ None.             */
/*=================================================*/


void GEQ_init_lib(void)
      {
      /*-------------------------------------------------*/


   INT16 i,j;


      /*-------------------------------------------------*/


      ini_dvector(past_energyq_2d, 0, GVQ_VEC_SIZE_2D-1, -20.0);
      ini_dvector(past_energyq_3d, 0, GVQ_VEC_SIZE_3D-1, -20.0);
      ini_dvector(past_energyq_4d, 0, GVQ_VEC_SIZE_4D-1, -20.0);


      ini_dvector(gp_buf, 0, GP_BUF_SIZE-1, 0.0);


      past_fixed_energy       = 0.0;
      pgain_past                 = PAST_PGAIN_MIN;
      pgain_past_dec           = PAST_PGAIN_MIN;


      ini_dvector(Prev_Beta_Pitch, 0, BETA_BUF_SIZE-1, 0.0);


      GainNormDeci = 0;
      GainModiDeci = 0;


      /*-------------------------------------------------*/


      energy_pred_coeff_1[0] = 0.6;
```

378

```
energy_pred_coeff_1[1] = 0.3;
energy_pred_coeff_1[2] = 0.1;

energy_pred_coeff_2[0] = 0.40;
energy_pred_coeff_2[1] = 0.25;
energy_pred_coeff_2[2] = 0.10;

energy_pred_coeff_3[0] = 0.300;
energy_pred_coeff_3[1] = 0.150;
energy_pred_coeff_3[2] = 0.075;

energy_pred_coeff4d_1[0] = 0.7;
energy_pred_coeff4d_1[1] = 0.6;
energy_pred_coeff4d_1[2] = 0.4;
energy_pred_cocff4d_1[3] = 0.2;

energy_pred_coeff4d_2[0] = 0.40;
energy_pred_coeff4d_2[1] = 0.20;
energy_pred_cocff4d_2[2] = 0.10;
energy_pred_coeff4d_2[3] = 0.05;

energy_pred_coeff4d_3[0] = 0.300;
energy_pred_coeff4d_3[1] = 0.20;
energy_pred_coeff4d_3[2] = 0.075;
energy_pred_coeff4d_3[3] = 0.025;

energy_pred_coeff4d_4[0] = 0.20;
energy_pred_coeff4d_4[1] = 0.075;
energy_pred_coeff4d_4[2] = 0.025;
energy_pred_coeff4d_4[3] = 0.0;

/*------------------------------------------------*/
/*                VQ Tables                  */
/*------------------------------------------------*/

for (i = 0; i < MSMAX_2_128; i++)
        for (j = 0; j < GVQ_VEC_SIZE_2D; j++)
                {
        gain_cb_2_128[i][j]   = gainVQ_2_128[i][j];
        gain_cb_2_128_8_5[i][j] = gainVQ_2_128_8_5[i][j];
```

```
                    }

        /*-----------------------------------------------------*/

        return;

        /*-----------------------------------------------------*/
        }


    /*-----------------------------------------------------*/


    /*===================================================================*/
    /* FUNCTION    : GEQ_gainVQMA_2 ().                      */
    /*-----------------------------------------------------*/
    /* PURPOSE     : This function performs 2-D VQ of Gp and Gc with */
    /*               7 bits.                                 */
    /*-----------------------------------------------------*/
    /* INPUT ARGUMENTS :                                    */
    /*      _ (FLOAT64 [])    Tgs:  target signal.          */
    /*      _ (FLOAT64 [])    unfcod: adaptive and fixed codebook */
    /*                        excitation.            */
    /*      _ (FLOAT64 [])    fcod:  filtered adaptive and fixed */
    /*                        codebook excitation.      */
    /*      _ (INT16 )        l_sf:  length of subframe.    */
    /*-----------------------------------------------------*/
    /* OUTPUT ARGUMENTS :                                   */
    /*      _ (FLOAT64 [])    gainQ: Quantized adaptive and   */
    /*                        fixed codebook gains.      */
    /*      _ (INT16  *)      idx:  codebook index.         */
    /*-----------------------------------------------------*/
    /* INPUT/OUTPUT ARGUMENTS :                             */
    /*              _ None.                                 */
    /*-----------------------------------------------------*/
    /* RETURN ARGUMENTS :                                   */
    /*              _ None.                                 */
    /*===================================================================*/


    void GEQ_gainVQMA_2(FLOAT64 Tgs [], FLOAT64 **unfcod, FLOAT64 **fcod,
                    FLOAT64 gainQ [], INT16 *idx, INT16 l_sf, INT16 rate)

            {
```

380

```
        /*------------------------------------------------------*/

        FLOAT64 energy, pred_gain, dist, dist_min, g_pitch, g_cdbk,
                corr[CORR_SIZE];
        INT16  i;
        INT16 num_candidate;
        FLOAT64 Renergy;
        FLOAT64 unq_Renergy;
        FLOAT64 pred_energy, err_energy;
   FLOAT64 **ptr;


        /*------------------------------------------------------*/
        /*================= Compute the predicted cdbk gain ================*/
        /*------------------------------------------------------*/


        /*------------------------------------------------------*/
        /* Note: compute the cdbk energy with mean removed (i.e., -30dB)     */
        /*------------------------------------------------------*/

   if (rate == RATE4_0K)
            {
            dot_dvector (past_energyq_2d, energy_pred_coeff_1,
                                        &pred_energy, 0, GVQ_VEC_SIZE_2D-1);
            ptr = gain_cb_2_128;
            }
   else
            {
            dot_dvector (past_energyq_4d, energy_pred_coeff4d_1,
                                        &pred_energy, 0, GVQ_VEC_SIZE_4D-1);
            ptr = gain_cb_2_128_8_5;
            }

   pred_energy = MAX (pred_energy, -20.0);

   dot_dvector(unfcod[1], unfcod[1], &energy, 0, l_sf-1);
   Renergy = energy;

   energy = 30.0 - 10.0*log10(energy/(FLOAT64)l_sf+EPSI);


        /*------------------------------------------------------*/
```

```
/*              Compute the predicted energy              */
/*----------------------------------------------------*/

energy += pred_energy;

/*----------------------------------------------------*/
/*              compute the predicted gain              */
/*----------------------------------------------------*/

pred_gain = pow(10.0, energy/20.0);
err_energy = -energy + 20*log10(fabs(gainQ[1]) + EPSI);
err_energy = pow(10.0, err_energy/20.0);
unq_Renergy = 10.*log10(sqr(gainQ[1])*Renergy+EPSI);

/*----------------------------------------------------*/
/*================= Optimal gainVQ search =================*/
/*----------------------------------------------------*/

dist_min = MAXFLT;

num_candidate = 128;

dot_dvector (fcod[0], fcod[0], &corr[0], 0, l_sf-1);
dot_dvector (fcod[0], Tgs, &corr[1], 0, l_sf-1);
corr[1] *= -2.0;

dot_dvector(fcod[1], fcod[1], &corr[2], 0, l_sf-1);

dot_dvector(fcod[1], Tgs, &corr[3], 0, l_sf-1);
corr[3] *= -2.0;

dot_dvector(fcod[0], fcod[1], &corr[4], 0, l_sf-1);
corr[4] *= 2.0;

for (i = 0; i < num_candidate; i++)
        {
        g_pitch = ptr[i][0];
        g_cdbk = pred_gain*ptr[i][1];
        dist = sqr(g_pitch)*corr[0] + g_pitch*corr[1] +
                        sqr(g_cdbk)*corr[2] + g_cdbk*corr[3] +
```

```
                                                   g_pitch*g_cdbk*corr[4];


                              if (dist < dist_min)
                                      {
                                      dist_min = dist;
                                      (*idx) = i;
                                      }
                              }


                   /*------------------------------------------------*/
                   /*           get the quantized gains           */
                   /*------------------------------------------------*/


              gainQ[0] = ptr[*idx][0];
              gainQ[1] = pred_gain*ptr[*idx][1];


                   /*------------------------------------------------*/
                   /*         update past quantized energies       */
                   /*------------------------------------------------*/


              if( rate == RATE4_0K)
                      {
                      for (i = GVQ_VEC_SIZE_2D-1; i > 0; i--)
                              past_energyq_2d[i] = past_energyq_2d[i-1];

                      past_energyq_2d[0] = 20.0*log10(gainVQ_2_128[*idx][1]);


                      }
              else
                      {
                      for (i = GVQ_VEC_SIZE_4D-1; i > 0; i--)
                              past_energyq_4d[i] = past_energyq_4d[i-1];

                      past_energyq_4d[0] = 20.0*log10(gainVQ_2_128_8_5[*idx][1]);
                      }


                   /*------------------------------------------------*/


              return;
```

```
/*-----------------------------------------------------------*/

        }


/*-----------------------------------------------------------*/


/*===========================================================*/
/* FUNCTION    : GEQ_dec_gains_2_7 ().              */
/*-----------------------------------------------------------*/
/* PURPOSE     : This function decodes the 7 bit 2-D VQ of Gp  */
/*           and Gc.                        */
/*-----------------------------------------------------------*/
/* INPUT ARGUMENTS :                        */
/*      _ (INT16 )      Lag:    current pitch lag.      */
/*      _ (INT16 )      index:  codebook index.        */
/*      _ (INT16 )      N_bfi:  duration of bad frame    */
/*                    seq. (0=good frame)     */
/*      _ (FLOAT64 [])    unfcod:  adaptive and fixed     */
/*                    codebook excitation.    */
/*      _ (INT16 )      i_sf:   subframe number.       */
/*      _ (INT16 )      l_sf:   length of subframe.     */
/*-----------------------------------------------------------*/
/* OUTPUT ARGUMENTS :                       */
/*      _ (FLOAT64 [])   gainQ:   Quantized adaptive and   */
/*                    fixed codebook gains.   */
/*-----------------------------------------------------------*/
/* INPUT/OUTPUT ARGUMENTS :                    */
/*            _ None.                  */
/*-----------------------------------------------------------*/
/* RETURN ARGUMENTS :                       */
/*            _ None.                  */
/*===========================================================*/


void GEQ_dec_gains_2_7(INT16 rate, INT16 Lag, INT16 index, FLOAT64 gainQ [],
             INT16 N_bfi, FLOAT64 unfcod [], INT16 i_sf, INT16 l_sf)

        {
        /*-----------------------------------------------------------*/


        INT16 i, num_count;
```

```
FLOAT64 current_fixed_energy;
FLOAT64 energy, pred_gain;
FLOAT64 pdown, cdown;        .
FLOAT64 val;
FLOAT64 min_erg_27;


        /*-----------------------------------------------------------*/
        /*     Compute the cdbk energy with mean removed (i.e., -30dB)    */
        /*-----------------------------------------------------------*/


        dot_dvector (unfcod, unfcod, &energy, 0, l_sf-1);


        current_fixed_energy = energy;
        energy /= (FLOAT64)l_sf;
        energy = 30.0 - 10.0*log10(energy+EPSI);


        /*-----------------------------------------------------------*/
        /*                 Compute the predicted energy             */
        /*-----------------------------------------------------------*/


if (rate == RATE4_0K)
        dot_dvector (past_energyq_2d, energy_pred_coeff_1, &val, 0,      .
                GVQ_VEC_SIZE_2D-1);
else
    dot_dvector (past_energyq_4d, energy_pred_coeff4d_1, &val, 0,
            GVQ_VEC_SIZE_4D-1);


    val = MAX (val, -20.0);


    energy += val;


        /*-----------------------------------------------------------*/
        /*                 Compute the predicted gain               */
        /*-----------------------------------------------------------*/


    pred_gain = pow(10.0, (energy / 20.0));


    if (N_bfi == 0)
            {
                /*-----------------------------------------------------------*/
```

```
/*====================== good frame ======================*/
/*-----------------------------------------------*/


if (rate == RATE4_0K)
        {
        gainQ[0] = gainVQ_2_128[index][0];
        gainQ[1] = pred_gain*gainVQ_2_128[index][1];


        /*-------------------------------------------*/
        /*        update past quantized energies        */
        /*-------------------------------------------*/


        for (i = GVQ_VEC_SIZE_2D-1; i > 0; i--)
                past_energyq_2d[i] = past_energyq_2d[i-1];


        past_energyq_2d[0] = 20.0*log10(gainVQ_2_128[index][1]);


        }
    else
        {
        gainQ[0] = gainVQ_2_128_8_5[index][0];
        gainQ[1] = pred_gain*gainVQ_2_128_8_5[index][1];


        for (i = GVQ_VEC_SIZE_4D-1; i > 0; i--)
                past_energyq_4d[i] = past_energyq_4d[i-1];


        past_energyq_4d[0] = 20.0*log10(gainVQ_2_128_8_5[index][1]);
        }
    }
else
    {
    /*===========================================================*/


    /*-----------------------------------------------*/
    /*====================== bad frame ======================*/
    /*-----------------------------------------------*/


    /*-----------------------------------------------*/
    /*    set down-scaling according to number of bad frames    */
    /*-----------------------------------------------*/
```

```
switch (N_bfi)
    {
    case 1:
                pdown = 0.95;
                cdown = 0.75;
                break;
    case 2:
                pdown = 0.95;
                cdown = 0.75;
                break;
    case 3:
                pdown = 0.90;
                cdown = 0.75;
                break;
    case 4:
                pdown = 0.90;
                cdown = 0.40;
                break;
    case 5:
                pdown = 0.90;
                cdown = 0.30;
                break;
    case 6:
                pdown = 0.90;
                cdown = 0.20;
                break;

    default:
                pdown = 0.70;
                cdown = 0.20;
                break;
    }


/*-------------------------------------------------------*/
/*==================== pitch gain ====================*/
/*-------------------------------------------------------*/


if (N_bfi == 1)
        {
```

```
            if (i_sf == 0)
                {
                if (Lag <= 40)
                        gp_mean = 0.5*(gp_buf[6]+gp_buf[7]);
                else if (Lag <= 80)
                        {
                        gp_mean = 0.0;
                        num_count = 0;
                        for (i = 4; i < 8;i++)
                                {
                                if (gp_buf[i] >= 0.5)
                                        {
                                        gp_mean += gp_buf[i];
                                        num_count++;
                                        }
                                }
                        if (num_count > 0)
                                gp_mean /= (FLOAT64)num_count;
                        else
                                gp_mean = MAX(MAX(gp_buf[6], gp_buf[7]),

gp_buf[5]);

                        }
                else if (Lag <= 120)
                        {
                        gp_mean = 0.0;
                        num_count = 0;
                        for (i = 2; i < 8;i++)
                                {
                                if (gp_buf[i] >= 0.5)
                                        {
                                        gp_mean += gp_buf[i];
                                        num_count++;
                                        }
                                }
                        if (num_count > 0)
                                gp_mean /= (FLOAT64)num_count;
                        else
                                gp_mean = MAX(MAX(MAX(gp_buf[6], gp_buf[7]),
                                                        gp_buf[5]), gp_buf[4]);
```

```
                              }
                        else
                              {
                        gp_mean =0.0;
                        num_count =0;
                        for (i = 0; i < 8; i++)
                              {
                              if (gp_buf[i] >= 0.5)
                                    {
                                    gp_mean += gp_buf[i];
                                    num_count++;
                                    }
                              }

                        if (num_count > 0)
                              gp_mean /= (FLOAT64)num_count;
                        else
                              gp_mean = MAX(MAX(MAX(MAX(gp_buf[6], gp_buf[7]),
                                                gp_buf[5]), gp_buf[4]),
gp_buf[3]);
                              }

#ifdef ALGO_BUG_FIX
                        if (rate == RATE4_0K)
                              {
                        if (MAX(Prev_Beta_Pitch[0], Prev_Beta_Pitch[1]) > 0.70)
                              gainQ[0] = 0.95;
                        else
                              gainQ[0] = MIN(0.95,gp_mean);
                              }
                        else
                              {
                        if (MAX(Prev_Beta_Pitch[0], MAX(Prev_Beta_Pitch[1],
                                    MAX(Prev_Beta_Pitch[2],
                                          Prev_Beta_Pitch[3]))) > 0.70)
                                                gainQ[0] = 0.95;
                        else
                              gainQ[0] = MIN(0.95,gp_mean);
                              }

#else
```

```
                              if (MAX(Prev_Beta_Pitch[0], Prev_Beta_Pitch[1]) > 0.70)
                                      {
                                        gainQ[0] = 0.95;
                                        cdown = 0.0;
                                      }
                              else
                                        gainQ[0] = MIN(0.95,gp_mean);
#endif
                                }
                        else
                                gainQ[0] = gp_fec;
                        }
                else
                        {
                        gainQ[0] = gp_fec;
                        gainQ[0] *= pdown;
                        }

        gp_fec = gainQ[0];
        gainQ[1] = sqrt(past_fixed_energy/current_fixed_energy);
        gainQ[1] *= cdown;


        /*─────────────────────────────────────────*/
        /*         update past quantized energies         */
        /*─────────────────────────────────────────*/

        if (rate == RATE4_0K)
                {
                min_erg_27 = MIN(past_energyq_2d[0], past_energyq_2d[1]);

                for (i = GVQ_VEC_SIZE_2D-1; i > 0; i--)
                        past_energyq_2d[i] = past_energyq_2d[i-1];

                past_energyq_2d[0] = MIN(min_erg_27, -energy +
                                20*log10(fabs(0.6*gainQ[1]) + EPSI));
                }
        else
                {
                min_erg_27 = MIN(past_energyq_4d[0], past_energyq_4d[1]);
```

```
            min_erg_27 = MIN(min_erg_27, past_energyq_4d[2]);
            min_erg_27 = MIN(min_erg_27, past_energyq_4d[3]);

            for (i = GVQ_VEC_SIZE_4D-1; i > 0; i--)
                past_energyq_4d[i] = past_energyq_4d[i-1];

            past_energyq_4d[0] = MIN(min_erg_27, -energy +
                            20*log10(fabs(0.6*gainQ[1]) + EPSI));
        }

        /*==================================================================*/
        }



    /*------------------------------------------------------------*/
    /*        Update the past fixed codebook energy        */
    /*------------------------------------------------------------*/

    past_fixed_energy = current_fixed_energy*sqr(gainQ[1]);

    /*------------------------------------------------------------*/

    return;

    /*------------------------------------------------------------*/
    }

/*------------------------------------------------------------*/

/*------------------------------------------------------------*/

/*==================================================================*/
/* FUNCTION    : GEQ_Quant_PitchGain_3D ().              */
/*------------------------------------------------------------*/
/* PURPOSE    : This function performs 3-D VQ of Ga1, Ga2, and  */
/*             Ga3 with 4 bits.                  */
/*------------------------------------------------------------*/
/* INPUT ARGUMENTS :                  */
/*                _ None.                  */
/*------------------------------------------------------------*/
```

```
/* OUTPUT ARGUMENTS :                              */
/*      _ (INT16 )        idx: codebook index.      */
/*----------------------------------------------*/
/* INPUT/OUTPUT ARGUMENTS :                        */
/*      _ (FLOAT64 [])    Gp: unquantized/quantized pitch  */
/*                        gains.                   */
/*----------------------------------------------*/
/* RETURN ARGUMENTS :                              */
/*                  _ None.                        */
/*==============================================*/


void GEQ_Quant_PitchGain_3D(FLOAT64 *Gp, INT16 *idx)
        {
        /*------------------------------------------------*/


        INT16 i;
        FLOAT64 min_dist;
        FLOAT64 dist;
        FLOAT64 err[GVQ_VEC_SIZE_3D];


        /*------------------------------------------------*/


        min_dist = MAXFLT;


        for(i = 0; i < TAB_SIZE_GVQ_3D; i++)
                {
                dif_dvector (Gp, gp3_tab[i], err, 0, GVQ_VEC_SIZE_3D-1);
                dot_dvector (err, err, &dist, 0, GVQ_VEC_SIZE_3D-1);


                if (dist < min_dist)
                        {
                        min_dist = dist;
                        (*idx)    = i;
                        }
                }


        for (i = 0; i < GVQ_VEC_SIZE_3D; i++)
                Gp[i] = gp3_tab[(*idx)][i];


        /*------------------------------------------------*/
```

```
        return;


        /*-------------------------------------------------*/
        }


    /*-------------------------------------------------------*/


    /*=======================================================*/
    /* FUNCTION    :  Dec_PitchGain_3D ().                */
    /*-----------------------------------------------------*/
    /* PURPOSE     :  This function decodes the 4 bit 3-D VQ of Ga1,  */
    /*              Ga2, and Ga3.                        */
    /*-----------------------------------------------------*/
    /* INPUT ARGUMENTS :                                 */
    /*      _ (INT16 )       N_bfi:   duration of bad frame   */
    /*                           seq. (0=good frame)     */
    /*      _ (INT16 )       i_sf:   subframe number.      */
    /*      _ (INT16 )       index:  codebook index.       */
    /*-----------------------------------------------------*/
    /* OUTPUT ARGUMENTS :                                */
    /*      _ (FLOAT64 [])    gainQ:   Quantized adaptive     */
    /*                           codebook gains.        */
    /*-----------------------------------------------------*/
    /* INPUT ARGUMENTS :                                 */
    /*                _ None.                        */
    /*-----------------------------------------------------*/
    /* RETURN ARGUMENTS :                                */
    /*                _ None.                        */
    /*=======================================================*/


    void GEQ_Dec_PitchGain_3D (INT16 N_bfi, INT16 i_sf, INT16 index, FLOAT64 *gainQ)
        {
        /*-----------------------------------------------*/


        FLOAT64 pdown;


        /*-----------------------------------------------*/


        if (N_bfi == 0)
```

```
        {
            /*---------------------------------------------------*/
            /*==================== good frame ====================*/
            /*---------------------------------------------------*/

            gainQ[0] = gp3_tab[index][i_sf];
        }
    else
        {
            /*=========================================================*/


            /*---------------------------------------------------*/
            /*==================== bad frame ====================*/
            /*---------------------------------------------------*/


            /*---------------------------------------------------*/
            /*   set down-scaling according to number of bad frames   */
            /*---------------------------------------------------*/

            switch (N_bfi)
                {
                case 1:
                        pdown = 0.99;
                        break;
                case 2:
                        pdown = 0.98;
                        break;
                case 3:
                        pdown = 0.96;
                        break;
                case 4:
                        pdown = 0.96;
                        break;
                case 5:
                        pdown = 0.96;
                        break;
                case 6:
                        pdown = 0.96;
                        break;
                default:
```

```
                pdown = 0.70;
                break;
        }
            .


        /*----------------------------------------------*/
        /*========================= Pitch Gain =======================*/
        /*----------------------------------------------*/


        if (N_bfi == 1)
            gainQ[0] = 0.95;
        else
                {
                gainQ[0] = gp_buf[7];
                gainQ[0] *= pdown;
        }


        }


        /*----------------------------------------------*/


    return;


        /*----------------------------------------------*/
        }


/*--------------------------------------------------------*/


/*============================================================*/
/* FUNCTION      :  GEQ_Quant_PitchGain_4D ().            */
/*----------------------------------------------*/
/* PURPOSE       : This function performs 4-D VQ of Ga1, Ga2, Ga3 */
/*                  and Ga4 with 6 bits.                  */
/*----------------------------------------------*/
/* INPUT ARGUMENTS :                            */
/*                  _ None.                      */
/*----------------------------------------------*/
/* OUTPUT ARGUMENTS :                           */
/*      _ (INT16 )      idx: codebook index.        */
/*----------------------------------------------*/
```

```
/* INPUT/OUTPUT ARGUMENTS :                              */
/*       _ (FLOAT64 [])      Gp: unquantized/quantized pitch    */
/*                      gains.                */
/*---------------------------------------------------------*/
/* RETURN ARGUMENTS :                          */
/*                 _ None.                    */
/*=========================================================*/


void GEQ_Quant_PitchGain_4D(FLOAT64 *Gp, INT16 *idx)
        {
        /*---------------------------------------------------*/


        INT16 i;
        FLOAT64 min_dist;
        FLOAT64 dist;
        FLOAT64 err[GVQ_VEC_SIZE_4D];


        /*---------------------------------------------------*/


        min_dist = MAXFLT;


        for(i = 0; i < TAB_SIZE_GVQ_4D; i++)
              {
              dif_dvector (Gp, gp4_tab[i], err, 0, GVQ_VEC_SIZE_4D-1);
              dot_dvector (err, err, &dist, 0, GVQ_VEC_SIZE_4D-1);


              if (dist < min_dist)
                    {
                    min_dist = dist;
                    (*idx)    = i;
                    }
              }


        for (i = 0; i < GVQ_VEC_SIZE_4D; i++)
              Gp[i] = gp4_tab[(*idx)][i];


        /*---------------------------------------------------*/


        return;
```

```
        /*-------------------------------------------------*/

        }


/*=====================================================================*/
/* FUNCTION    : GEQ_Dec_PitchGain_4D ().                    */
/*-----------------------------------------------*/
/* PURPOSE    : This function decodes the 6 bit 4-D VQ of Ga1,   */
/*          Ga2, Ga3, and Ga4.                   */
/*-----------------------------------------------*/
/* INPUT ARGUMENTS :                      */
/*      _ (INT16 )      N_bfi:    duration of bad frame   */
/*                 seq. (0=good frame)      */
/*      _ (INT16 )      i_sf:    subframe number.        */
/*      _ (INT16 )      index:    codebook index.        */
/*-----------------------------------------------*/
/* OUTPUT ARGUMENTS :                      */
/*      _ (FLOAT64 [])    gainQ:   Quantized adaptive     */
/*                 codebook gains.      */
/*-----------------------------------------------*/
/* INPUT ARGUMENTS :                      */
/*            _ None.                 */
/*-----------------------------------------------*/
/* RETURN ARGUMENTS :                      */
/*            _ None.                 */
/*=====================================================================*/


void GEQ_Dec_PitchGain_4D (INT16 N_bfi, INT16 i_sf, INT16 index, FLOAT64 *gainQ)
    {
    /*-----------------------------------------------*/


    FLOAT64 pdown;


    /*-----------------------------------------------*/


    if (N_bfi == 0)
        {
        /*-----------------------------------------------*/
        /*======================= good frame ======================*/
```

```
/*------------------------------------------------------*/

        gainQ[0] = gp4_tab[index][i_sf];
        }
else
        {
        /*====================================================*/


        /*------------------------------------------------------*/
        /*==================== bad frame ====================*/
        /*------------------------------------------------------*/


        /*------------------------------------------------------*/
        /*   set down-scaling according to number of bad frames   */
        /*------------------------------------------------------*/

        switch (N_bfi)
            {
            case 1:
                    pdown = 0.99;
                    break;
            case 2:
                    pdown = 0.98;
                    break;
            case 3:
                    pdown = 0.96;
                    break;
            case 4:
                    pdown = 0.96;
                    break;
            case 5:
                    pdown = 0.96;
                    break;
            case 6:
                    pdown = 0.96;
                    break;
            default:
                    pdown = 0.70;
                    break;
            }
```

```
            /*----------------------------------------------*/
            /*==================== Pitch Gain ======================*/
            /*----------------------------------------------*/


                if (N_bfi == 1)
            gainQ[0] = 0.95;
                else
                    {
                    gainQ[0] = gp_buf[7];
                    gainQ[0] *= pdown;
                }


            }


            /*----------------------------------------------*/


        return;


            /*----------------------------------------------*/
        }


    /*----------------------------------------------------*/


    /*=========================================================*/
    /* FUNCTION    : GEQ_gainVQMA_3 ().                    */
    /*----------------------------------------------*/
    /* PURPOSE     : This function performs 3-D VQ of Gc1, Gc2, and  */
    /*              Gc3 with 8 bits.                    */
    /*----------------------------------------------*/
    /* INPUT ARGUMENTS :                    */
    /*      _ (FLOAT64 [])     Tgs:  target signal.        */
    /*      _ (FLOAT64 [])     unfcod: fixed codebook excitation.*/
    /*      _ (FLOAT64 [])     fcod:  filtered fixed codebook  */
    /*                  excitation.          */
    /*----------------------------------------------*/
    /* OUTPUT ARGUMENTS :                    */
    /*      _ (FLOAT64 [])     gainQ:  Quantized fixed codebook  */
    /*                  gains.              */
```

```
/*      _ (INT16 )          idx:   codebook index.      */
/*------------------------------------------------------*/
/* INPUT/OUTPUT ARGUMENTS :                        */
/*              _ None.                   */
/*------------------------------------------------------*/
/* RETURN ARGUMENTS :                          */
/*              _ None.                   */
/*======================================================*/


void GEQ_gainVQMA_3 (FLOAT64 Tgs [], FLOAT64 **unfcod, FLOAT64 **fcod,
                FLOAT64 **gainQ, INT16 *idx)

        {
        /*--------------------------------------------*/


        INT16  i;
        INT16 num_candidate;
        INT16 i_s, i_sf;
        INT16 LL_SF[N_SF3]={L_SF0, L_SF0, L_SF3};


        FLOAT64 erg_ratio[N_SF3];
        FLOAT64 pred_energy[N_SF3];
        FLOAT64 err_energy[N_SF3];
        FLOAT64 lin_err_energy[N_SF3];


        FLOAT64 energy[N_SF3], pred_gain[N_SF3], dist, dist_min,
                corr[CORR_SIZE][N_SF3];
        FLOAT64 val;
     FLOAT64 corr_coeff_a[3], corr_coeff_b[3], corr_coeff_c;


        /*--------------------------------------------*/
        /*============ Compute the predicted cdbk gain ============*/
        /*--------------------------------------------*/



        /*--------------------------------------------*/
        /*              MA Prediction              */
        /*--------------------------------------------*/


        dot_dvector(past_energyq_3d, energy_pred_coeff_1,
            &pred_energy[0], 0, GVQ_VEC_SIZE_3D-1);
```

```
pred_energy[0] = MAX(pred_energy[0], -20.0);

dot_dvector(past_energyq_3d, energy_pred_coeff_2,
    &pred_energy[1], 0, GVQ_VEC_SIZE_3D-1);

pred_energy[1] = MAX(pred_energy[1], -20.0);

dot_dvector(past_energyq_3d, energy_pred_coeff_3,
    &pred_energy[2], 0, GVQ_VEC_SIZE_3D-1);

pred_energy[2] = MAX(pred_energy[2], -20.0);


/*-------------------------------------------------------*/
/*==================== Process all subframe ====================*/
/*-------------------------------------------------------*/


i_s = 0;
for (i_sf = 0; i_sf < N_SF3; i_sf++)
        {
        /*-------------------------------------------------------*/
        /*  compute the cdbk energy with mean removed (i.e., -34dB)  */
        /*-------------------------------------------------------*/


        dot_dvector (unfcod[1]+i_s, unfcod[1]+i_s, &energy[i_sf],

0, LL_SF[i_sf]-1);

        energy[i_sf] = 34.0 - 10.0*log10(energy[i_sf] /

(FLOAT64)LL_SF[i_sf]+EPSI);



        /*-------------------------------------------------------*/
        /*          compute the predicted energy          */
        /*-------------------------------------------------------*/

        energy[i_sf] += pred_energy[i_sf];
```

```
/*-------------------------------------------------*/
/*           compute the predicted gain          */
/*-------------------------------------------------*/


    pred_gain[i_sf] = pow(10.0, energy[i_sf]/20.0);
    err_energy[i_sf] = -energy[i_sf] + 20*log10(fabs(gainQ[1][i_sf])


    + EPSI);



    lin_err_energy[i_sf] = pow(10.0, err_energy[i_sf]/20.0);


    i_s += LL_SF[i_sf];
    }


/*-------------------------------------------------*/
/*=============== Optimal gainVQ search ===============*/
/*-------------------------------------------------*/


dist_min = MAXFLT;


num_candidate = 256;
i_s = 0;
for (i_sf = 0; i_sf < N_SF3; i_sf++)
        {
        dot_dvector (fcod[0]+i_s, fcod[0]+i_s, &val, 0, LL_SF[i_sf]-1);
        corr[0][i_sf] = val;


        dot_dvector (fcod[0]+i_s, Tgs+i_s, &val, 0, LL_SF[i_sf]-1);
        corr[1][i_sf] = -2.0 * val;


        dot_dvector (fcod[1]+i_s, fcod[1]+i_s, &val, 0, LL_SF[i_sf]-1);
        corr[2][i_sf] = val;


        dot_dvector(fcod[1]+i_s, Tgs+i_s, &val, 0, LL_SF[i_sf]-1);
        corr[3][i_sf] = -2.0*val;


        dot_dvector(fcod[0]+i_s, fcod[1]+i_s,&val, 0, LL_SF[i_sf]-1);
        corr[4][i_sf] = 2.0*val;
```

```
            dot_dvector(Tgs+i_s, Tgs+i_s, &val, 0, LL_SF[i_sf]-1);
            corr[5][i_sf] = val;


            i_s += LL_SF[i_sf];
            }


        erg_ratio[0] = corr[5][0] /( corr[5][0]+corr[5][1]+corr[5][2] +EPSI);
        erg_ratio[1] = corr[5][1] /( corr[5][0]+corr[5][1]+corr[5][2] +EPSI);
        erg_ratio[2] = corr[5][2] /( corr[5][0]+corr[5][1]+corr[5][2] +EPSI);


    corr_coeff_a[0] = erg_ratio[0] * corr[2][0] * pred_gain[0] * pred_gain[0];
    corr_coeff_b[0] = erg_ratio[0] * (corr[3][0] + gainQ[0][0] * corr[4][0]) * pred_gain[0];


    corr_coeff_a[1] = erg_ratio[1]*corr[2][1]*pred_gain[1]*pred_gain[1];
    corr_coeff_b[1] = erg_ratio[1]*(corr[3][1]+gainQ[0][1]*corr[4][1])*pred_gain[1];


    corr_coeff_a[2] = erg_ratio[2]*corr[2][2]*pred_gain[2]*pred_gain[2];
    corr_coeff_b[2] = erg_ratio[2]*(corr[3][2]+gainQ[0][2]*corr[4][2])*pred_gain[2];


    corr_coeff_c = erg_ratio[0]*(corr[5][0]+sqr(gainQ[0][0])*corr[0][0]+gainQ[0][0]* corr[1][0])+
erg_ratio[1]*(corr[5][1]+sqr(gainQ[0][1])*corr[0][1]+gainQ[0][1]*corr[1][1])+
erg_ratio[2]*(corr[5][2]+sqr(gainQ[0][2])*corr[0][2]+gainQ[0][2]*corr[1][2]);


        for (i = 0; i < num_candidate; i++)
                {
        dist = corr_coeff_a[0]*sqr(gainVQ_3_256[i][0])+
            corr_coeff_b[0]*gainVQ_3_256[i][0] +
            corr_coeff_a[1]*sqr(gainVQ_3_256[i][1])+
            corr_coeff_b[1]*gainVQ_3_256[i][1] +
            corr_cocff_a[2]*sqr(gainVQ_3_256[i][2])+
            corr_coeff_b[2]*gainVQ_3_256[i][2] + corr_coeff_c;


        if (dist < dist_min)
                {
                dist_min = dist;
                (*idx) = i;
                }
            }
```

```
/*----------------------------------------------------------------------*/
/*                    Get the quantized gains                  */
/*----------------------------------------------------------------------*/


    gainQ[1][0] = pred_gain[0]*gainVQ_3_256[*idx][0];

    gainQ[1][1] = pred_gain[1]*gainVQ_3_256[*idx][1];

    gainQ[1][2] = pred_gain[2]*gainVQ_3_256[*idx][2];



/*----------------------------------------------------------------------*/
/*              Update past quantized energies                 */
/*----------------------------------------------------------------------*/


    for (i_sf = 0; i_sf < N_SF3; i_sf++)
            {
            val = gainVQ_3_256[*idx][i_sf];
            past_encrgyq_3d [N_SF3-1-i_sf] = 20.0* log10(val);
            }


/*----------------------------------------------------------------------*/


    return;


/*----------------------------------------------------------------------*/

    }



/*----------------------------------------------------------------------*/


/*======================================================================*/
/* FUNCTION    : GEQ_dec_gc_3_8 ().                            */
/*----------------------------------------------------------------------*/
/* PURPOSE      : This function decodes the 8 bit 3-D VQ of Gc1,   */
/*               Gc2, and Gc3. Note that the gains are decoded    */
/*               one-by-one on a subframe basis.                 */
/*----------------------------------------------------------------------*/
/* INPUT ARGUMENTS :                                      */
/*       _ (INT16 )       index:    codebook index.        */
/*       _ (INT16 )       N_bfi:   duration of bad frame   */
/*                        seq. (0=good frame)       */
```

404

```
/*      _ (FLOAT64 [])   unfcod: fixed codebook excitation.*/
/*      _ (INT16 )    i_sf:   subframe number. */
/*----------------------------------------------------*/
/* OUTPUT ARGUMENTS :                    */
/*      _ (FLOAT64 *)   gainQ:   Quantized fixed codebook */
/*                  gains.        */
/*----------------------------------------------------*/
/* INPUT ARGUMENTS :                    */
/*              _ None.             */
/*----------------------------------------------------*/
/* RETURN ARGUMENTS :                    */
/*              _ None.             */
/*==================================================*/


void GEQ_dec_gc_3_8(INT16 index, FLOAT64 *gainQ, INT16 N_bfi, FLOAT64 **unfcod,
            INT16 i_sf)
        {
        /*--------------------------------------------*/


        INT16 i_sf_local;
        INT16 LL_SF[N_SF3]={L_SF0, L_SF0, L_SF3};

        FLOAT64 cdown, current_fixed_energy, energy, pred_gain;
        FLOAT64 min_erg_38;

        /*--------------------------------------------*/
        /*   Note: the gains are decoded one-by-one on a subframe basis   */
        /*--------------------------------------------*/


        /*--------------------------------------------*/
        /*    Compute the cdbk energy with mean removed (i.e., -34dB)   */
        /*--------------------------------------------*/


        /*--------------------------------------------*/
        /*     Predict energy for all subframes at first subframe   */
        /*--------------------------------------------*/


        if (i_sf == 0)
            {
            dot_dvector(past_energyq_3d, energy_pred_coeff_1,
```

```
            pred_energy_d38, 0, 3-1);
        pred_energy_d38[0] = MAX (pred_energy_d38[0], -20.0);

        dot_dvector(past_energyq_3d, energy_pred_coeff_2,
            pred_energy_d38+1, 0, 3-1);
        pred_energy_d38[1] = MAX (pred_energy_d38[1], -20.0);

        dot_dvector(past_energyq_3d, energy_pred_coeff_3,
            pred_energy_d38+2, 0, 3-1);
        pred_energy_d38[2] = MAX (pred_energy_d38[2], -20.0);
    }

dot_dvector (unfcod[1], unfcod[1], &energy, 0, LL_SF[i_sf]-1);
current_fixed_energy = energy;

energy = 34.0 - 10.0*log10(energy/(FLOAT64)LL_SF[i_sf]+EPSI);

/*----------------------------------------------------*/
/*          Compute the predicted energy           */
/*----------------------------------------------------*/

energy += pred_energy_d38[i_sf];

/*----------------------------------------------------*/
/*          Compute the predicted gain             */
/*----------------------------------------------------*/

pred_gain = pow(10.0, energy/20.0);

if (N_bfi == 0)
        {
        /*----------------------------------------------------*/
        /*================= Good frame ===================*/
        /*----------------------------------------------------*/

        /*----------------------------------------------------*/
        /*          Get the quantized gain             */
        /*----------------------------------------------------*/

        (*gainQ) = pred_gain*gainVQ_3_256[index][i_sf];
```

```
past_fixed_energy = current_fixed_energy*sqr((*gainQ));

if (i_sf == N_SF3-1)
    {
    /*-----------------------------------------------*/
    /*          Update past quantized energies        */
    /*-----------------------------------------------*/

    for (i_sf_local= 0; i_sf_local < N_SF3; i_sf_local++)
        {
        past_energyq_3d[N_SF3-1-i_sf_local] =
                20.0*log10(gainVQ_3_256[index][i_sf_local]);
        }
    }
else
    {
    /*-----------------------------------------------*/
    /*================== Bad frame ==================*/
    /*-----------------------------------------------*/


    /*-----------------------------------------------*/
    /*  set down-scaling according to number of bad frames  */
    /*-----------------------------------------------*/

    switch (N_bfi)
        {
        case 1:
                    cdown = 0.75;
                    break;
        case 2:
                    cdown = 0.75;
                    break;
        case 3:
                    cdown = 0.75;
                    break;
        case 4:
                    cdown = 0.40;
                    break;
```

```
                case 5:
                                cdown = 0.30;
                                break;
                case 6:
                                cdown = 0.20;
                                break;
                default:
                                cdown = 0.20;
                                break;
            }


        /*--------------------------------------------------*/
        /*==================== Fixed Codebook ====================*/
        /*--------------------------------------------------*/


        (*gainQ) = sqrt(past_fixed_energy/current_fixed_energy);
        (*gainQ) *= cdown;

        past_fixed_energy = current_fixed_energy*sqr((*gainQ));


        /*--------------------------------------------------*/
        /*     Buffer data for update after the last subframe     */
        /*--------------------------------------------------*/


        min_erg_38 = MIN(past_energyq_3d[0], past_energyq_3d[1]);
        min_erg_38 = MIN(min_erg_38, past_energyq_3d[2]);

        past_energyq_3d[GVQ_VEC_SIZE_3D-1-i_sf] = MIN(min_erg_38,
                            -energy + 20*log10(fabs(0.6*(*gainQ)) + EPSI));


        /*--------------------------------------------------*/
        /*     Set GC to zero for this mode under FER     */
        /*--------------------------------------------------*/


        (*gainQ) = 0.0;
    }


    /*--------------------------------------------------*/
```

```
                return;


                /*----------------------------------------------------*/
            }


        /*----------------------------------------------------------*/


        /*==========================================================================*/
        /* FUNCTION     :  GEQ_gainVQMA_4 ().                    */
        /*--------------------------------------------------------------*/
        /* PURPOSE      : This function performs 4-D VQ of Gc1, Gc2, Gc3   */
        /*                and Gc4 with 10 bits.                  */
        /*--------------------------------------------------------------*/
        /* INPUT ARGUMENTS :                              */
        /*      _ (FLOAT64 [])      Tgs:   target signal.        */
        /*      _ (FLOAT64 [])      unfcod: fixed codebook excitation.*/
        /*      _ (FLOAT64 [])      fcod:   filtered fixed codebook  */
        /*                          excitation.          */
        /*--------------------------------------------------------------*/
        /* OUTPUT ARGUMENTS :                             */
        /*      _ (FLOAT64 [])      gainQ:  Quantized fixed codebook  */
        /*                          gains.            */
        /*      _ (INT16 )        idx:   codebook index.        */
        /*--------------------------------------------------------------*/
        /* INPUT/OUTPUT ARGUMENTS :                        */
        /*              _ None.                      */
        /*--------------------------------------------------------------*/
        /* RETURN ARGUMENTS :                             */
        /*              _ None.                      */
        /*==========================================================================*/


        void GEQ_gainVQMA_4 (FLOAT64 Tgs [], FLOAT64 **unfcod, FLOAT64 **fcod,
                            FLOAT64 **gainQ, INT16 *idx)
            {
                /*----------------------------------------------------*/


            INT16  i;
            INT16 num_candidate;
            INT16 i_s, i_sf;
```

```
FLOAT64 pred_energy[N_SF4];
FLOAT64 err_energy[N_SF4];
FLOAT64 lin_err_energy[N_SF4];


FLOAT64 energy[N_SF4], pred_gain[N_SF4], dist, dist_min,
       corr[CORR_SIZE][N_SF4];
FLOAT64 val;
FLOAT64 corr_coeff_a[4], corr_coeff_b[4], corr_coeff_c;


/*-------------------------------------------------------*/
/*================ Compute the predicted cdbk gain ============*/
/*-------------------------------------------------------*/



/*-------------------------------------------------------*/
/*              MA Prediction                  */
/*-------------------------------------------------------*/


dot_dvector(past_energyq_4d, energy_pred_coeff4d_1,
   &pred_energy[0], 0, GVQ_VEC_SIZE_4D-1);


pred_energy[0] = MAX(pred_energy[0], -20.0);


dot_dvector(past_energyq_4d, energy_pred_coeff4d_2,
   &pred_energy[1], 0, GVQ_VEC_SIZE_4D-1);


pred_energy[1] = MAX(pred_energy[1], -20.0);


dot_dvector(past_energyq_4d, energy_pred_coeff4d_3,
   &pred_energy[2], 0, GVQ_VEC_SIZE_4D-1);


pred_energy[2] = MAX(pred_energy[2], -20.0);


dot_dvector(past_energyq_4d, energy_pred_coeff4d_4,
   &pred_energy[3], 0, GVQ_VEC_SIZE_4D-1);


pred_energy[3] = MAX(pred_energy[3], -20.0);


/*-------------------------------------------------------*/
/*================= Process all subframe ===================*/
```

```
/*--------------------------------------------------*/

i_s = 0;
for (i_sf = 0; i_sf < N_SF4; i_sf++)
        {
        /*--------------------------------------------------*/
        /*  compute the cdbk energy with mean removed (i.e., -34dB)  */
        /*--------------------------------------------------*/

        dot_dvector (unfcod[1]+i_s, unfcod[1]+i_s, &energy[i_sf],

0, L_SF4-1);

        energy[i_sf] = 34.0 - 10.0*log10(energy[i_sf] /

(FLOAT64)L_SF4+EPSI);

        /*--------------------------------------------------*/
        /*          compute the predicted energy           */
        /*--------------------------------------------------*/

        energy[i_sf] += pred_energy[i_sf];

        /*--------------------------------------------------*/
        /*          compute the predicted gain             */
        /*--------------------------------------------------*/

        pred_gain[i_sf] = pow(10.0, energy[i_sf]/20.0);
        err_energy[i_sf] = -energy[i_sf] + 20*log10(fabs(gainQ[1][i_sf])

        + EPSI);

        lin_err_energy[i_sf] = pow(10.0, err_energy[i_sf]/20.0);

        i_s += L_SF4;
        }

/*--------------------------------------------------*/
/*==================== Optimal gainVQ search ====================*/
```

```
/*-------------------------------------------------------------*/

        dist_min = MAXFLT;

        num_candidate = 1024;
        i_s = 0;
        for (i_sf = 0; i_sf < N_SF4; i_sf++)
                {
                dot_dvector (fcod[0]+i_s, fcod[0]+i_s, &val, 0, L_SF4-1);
                corr[0][i_sf] = val;

                dot_dvector (fcod[0]+i_s, Tgs+i_s, &val, 0, L_SF4-1);
                corr[1][i_sf] = -2.0 * val;

                dot_dvector (fcod[1]+i_s, fcod[1]+i_s, &val, 0, L_SF4-1);
                corr[2][i_sf] = val;

                dot_dvector(fcod[1]+i_s, Tgs+i_s, &val, 0, L_SF4-1);
                corr[3][i_sf] = -2.0*val;

                dot_dvector(fcod[0]+i_s, fcod[1]+i_s,&val, 0, L_SF4-1);
                corr[4][i_sf] = 2.0*val;

                dot_dvector(Tgs+i_s, Tgs+i_s, &val, 0, L_SF4-1);
                corr[5][i_sf] = val;

                i_s += L_SF4;
                }

    corr_coeff_a[0] = corr[2][0]*pred_gain[0]*pred_gain[0];
corr_coeff_b[0] = (corr[3][0]+gainQ[0][0]*corr[4][0])*pred_gain[0];

corr_coeff_a[1] = corr[2][1]*pred_gain[1]*pred_gain[1];
corr_coeff_b[1] = (corr[3][1]+gainQ[0][1]*corr[4][1])*pred_gain[1];

corr_coeff_a[2] = corr[2][2]*pred_gain[2]*pred_gain[2];
corr_coeff_b[2] = (corr[3][2]+gainQ[0][2]*corr[4][2])*pred_gain[2];

corr_coeff_a[3] = corr[2][3]*pred_gain[3]*pred_gain[3];
corr_coeff_b[3] = (corr[3][3]+gainQ[0][3]*corr[4][3])*pred_gain[3];
```

```
corr_coeff_c = corr[5][0]+sqr(gainQ[0][0])*corr[0][0]+gainQ[0][0]*corr[1][0]+
corr[5][1]+sqr(gainQ[0][1])*corr[0][1]+gainQ[0][1]*corr[1][1]+
      corr[5][2]+sqr(gainQ[0][2])*corr[0][2]+gainQ[0][2]*corr[1][2]+
corr[5][3]+sqr(gainQ[0][3])*corr[0][3]+gainQ[0][3]*corr[1][3];


      for (i = 0; i < num_candidate; i++)
            {
      dist =
corr_coeff_a[0]*sqr(gainVQ_4_1024[i][0])+corr_coeff_b[0]*gainVQ_4_1024[i][0]
+


corr_coeff_a[1]*sqr(gainVQ_4_1024[i][1])+corr_coeff_b[1]*gainVQ_4_1024[i][1]
+

                  .

corr_coeff_a[2]*sqr(gainVQ_4_1024[i][2])+corr_coeff_b[2]*gainVQ_4_1024[i][2]
+


corr_coeff_a[3]*sqr(gainVQ_4_1024[i][3])+corr_coeff_b[3]*gainVQ_4_1024[i][3]
+
      corr_coeff_c;


            if (dist < dist_min)
                  {
                  dist_min = dist;
                  (*idx) = i;
                  }
            }



      /*------------------------------------------------------------*/
      /*            Get the quantized gains            */
      /*------------------------------------------------------------*/

      .
gainQ[1][0] = pred_gain[0]*gainVQ_4_1024[*idx][0];
gainQ[1][1] = pred_gain[1]*gainVQ_4_1024[*idx][1];
gainQ[1][2] = pred_gain[2]*gainVQ_4_1024[*idx][2];
gainQ[1][3] = pred_gain[3]*gainVQ_4_1024[*idx][3];
```

```
/*-----------------------------------------------------------*/
/*              Update past quantized energies              */
/*-----------------------------------------------------------*/


for (i_sf = 0; i_sf < N_SF4; i_sf++)
        {
        val = gainVQ_4_1024[*idx][i_sf];
        past_energyq_4d [N_SF4-1-i_sf] = 20.0* log10(val);
        }




    /*-----------------------------------------------------------*/



    return;


    /*-----------------------------------------------------------*/

    }


/*-----------------------------------------------------------*/


/*===========================================================*/
/* FUNCTION     : GEQ_dec_gc_4_10 ().                        */
/*-----------------------------------------------------------*/
/* PURPOSE      : This function decodes the 10 bit 4-D VQ of Gc1, */
/*               Gc2, Gc3, and Gc4. Note that the gains are   */
/*               decoded one-by-one on a subframe basis.      */
/*-----------------------------------------------------------*/
/* INPUT ARGUMENTS :                                         */
/*      _ (INT16 )      index:    codebook index.            */
/*      _ (INT16 )      N_bfi:    duration of bad frame       */
/*                      seq. (0=good frame)                   */
/*      _ (FLOAT64 [])  unfcod:   fixed codebook excitation.  */
/*      _ (INT16 )      i_sf:     subframe number.            */
/*-----------------------------------------------------------*/
/* OUTPUT ARGUMENTS :                                        */
/*      _ (FLOAT64 *)   gainQ:    Quantized fixed codebook    */
/*                      gains.                                 */
/*-----------------------------------------------------------*/
/* INPUT ARGUMENTS :                                         */
/*                 _ None.                                    */
```

```
/*----------------------------------------------------------*/
/* RETURN ARGUMENTS :                              */
/*                  _ None.                    */
/*==========================================================*/


void GEQ_dec_gc_4_10(INT16 index, FLOAT64 *gainQ, INT16 N_bfi, FLOAT64 **unfcod,
                    INT16 i_sf)
        {
        /*----------------------------------------------------------*/


        INT16 i_sf_local;



        FLOAT64 cdown, current_fixed_energy, energy, pred_gain;
        FLOAT64 min_erg_410;


        /*----------------------------------------------------------*/
        /*    Note: the gains are decoded one-by-one on a subframe basis    */
        /*----------------------------------------------------------*/


        /*----------------------------------------------------------*/
        /*    Compute the cdbk energy with mean removed (i.e., -34dB)    */
        /*----------------------------------------------------------*/



        /*----------------------------------------------------------*/
        /*    Predict energy for all subframes at first subframe    */
        /*----------------------------------------------------------*/


        if (i_sf == 0)
                {
                dot_dvector(past_energyq_4d, energy_pred_coeff4d_1,
                    pred_energy_d410, 0, 4-1);
                pred_energy_d410[0] = MAX (pred_energy_d410[0], -20.0);

                dot_dvector(past_energyq_4d, energy_pred_coeff4d_2,
                    pred_energy_d410+1, 0, 4-1);
                pred_energy_d410[1] = MAX (pred_energy_d410[1], -20.0);

                dot_dvector(past_energyq_4d, energy_pred_coeff4d_3,
```

```
                pred_energy_d410+2, 0, 4-1);
            pred_energy_d410[2] = MAX (pred_energy_d410[2], -20.0);


            dot_dvector(past_energyq_4d, energy_pred_coeff4d_4,
                pred_energy_d410+3, 0, 4-1);
            pred_energy_d410[3] = MAX (pred_energy_d410[3], -20.0);
        }


    dot_dvector (unfcod[1], unfcod[1], &energy, 0, L_SF4-1);
    current_fixed_energy = energy;


    energy = 34.0 - 10.0*log10(energy/(FLOAT64)L_SF4+EPSI);


    /*-----------------------------------------------------*/
    /*              Compute the predicted energy           */
    /*-----------------------------------------------------*/


    energy += pred_energy_d410[i_sf];


    /*-----------------------------------------------------*/
    /*              Compute the predicted gain             */
    /*-----------------------------------------------------*/


    pred_gain = pow(10.0, energy/20.0);


    if (N_bfi == 0)
            {
            /*-----------------------------------------------------*/
            /*================== Good frame ===================*/
            /*-----------------------------------------------------*/


            /*-----------------------------------------------------*/
            /*              Get the quantized gain                 */
            /*-----------------------------------------------------*/


            (*gainQ) = pred_gain*gainVQ_4_1024[index][i_sf];


            past_fixed_energy = current_fixed_energy*sqr((*gainQ));


            if (i_sf == N_SF4-1)
```

```
            {
            /*----------------------------------------------------*/
            /*         Update past quantized energies        */
            /*----------------------------------------------------*/


            for (i_sf_local= 0; i_sf_local < N_SF4; i_sf_local++)
                    {
                    past_energyq_4d[N_SF4-1-i_sf_local] =
                            20.0*log10(gainVQ_4_1024[index][i_sf_local]);
                    }
            }
        else
        {
        /*----------------------------------------------------*/
        /*===================== Bad frame =====================*/
        /*----------------------------------------------------*/


        /*----------------------------------------------------*/
        /*   set down-scaling according to number of bad frames   */
        /*----------------------------------------------------*/


        switch (N_bfi)
                {
                case 1:
                            cdown = 0.75;
                            break;
                case 2:
                            cdown = 0.75;
                            break;
                case 3:
                            cdown = 0.75;
                            break;
                case 4:
                    .       cdown = 0.40;
                            break;


                case 5:
                            cdown = 0.30;
                            break;
```

```
                case 6:
                            cdown = 0.20;
                            break;
                default:
                            cdown = 0.20;
                            break;
                }


        /*--------------------------------------------------*/
        /*================= Pitch gain ===================*/
        /*--------------------------------------------------*/


        (*gainQ) = sqrt(past_fixed_energy/current_fixed_energy);
        (*gainQ) *= cdown;
        past_fixed_energy = current_fixed_energy*sqr((*gainQ));


        /*--------------------------------------------------*/
        /*     Buffer data for update after the last subframe     */
        /*--------------------------------------------------*/


    min_erg_410 = MIN(past_energyq_4d[0], past_energyq_4d[1]);
    min_erg_410 = MIN(min_erg_410, past_energyq_4d[2]);
    min_erg_410 = MIN(min_erg_410, past_energyq_4d[3]);


    past_energyq_4d[GVQ_VEC_SIZE_4D-1-i_sf] = MIN(min_erg_410,
                    -energy + 20*log10(fabs(0.6*(*gainQ)) + EPSI));


        /*--------------------------------------------------*/
        /*     Set GC to zero for this mode under FER     */
        /*--------------------------------------------------*/


        (*gainQ) = 0.0;
        }


    /*--------------------------------------------------*/


return;


    /*--------------------------------------------------*/

    }
```

```
/*------------------------------------------------------------------*/


/*================================================================*/
/* FUNCTION    : GEQ_gainNSQMA_1_5 ().                    */
/*------------------------------------------------------------------*/
/* PURPOSE     : This function performs 1-D VQ of Gc with      */
/*               5 bits.                             */
/*------------------------------------------------------------------*/
/* INPUT ARGUMENTS :                              */
/*        _ (FLOAT64 [])    unfcod: fixed codebook         */
/*                          excitation.               */
/*------------------------------------------------------------------*/
/* OUTPUT ARGUMENTS :                              */
/*        _ (FLOAT64 [])     gainQ:  Quantized adaptive and    */
/*                           fixed codebook gains.      */
/*        _ (INT16  *)    idx:   codebook index.         */
/*------------------------------------------------------------------*/
/* INPUT/OUTPUT ARGUMENTS :                         */
/*                _ None.                          */
/*------------------------------------------------------------------*/
/* RETURN ARGUMENTS :                              */
/*                _ None.                          */
/*================================================================*/


void GEQ_gainNSQMA_1_5(FLOAT64 *unfcod, FLOAT64 **gainQ , INT16 *idx)
        {
        /*------------------------------------------------------------------*/


        FLOAT64 energy, pred_gain, dist, dist_min, g_cdbk;
        INT16  i;
        INT16 num_candidate;
        FLOAT64 pred_energy;


        /*------------------------------------------------------------------*/
        /*================= Compute the predicted cdbk gain ===========*/
        /*------------------------------------------------------------------*/


        /*------------------------------------------------------------------*/
        /* Note: compute the cdbk energy with mean removed (i.e., -30dB)     */
        /*------------------------------------------------------------------*/
```

```
dot_dvector (past_energyq_4d, energy_pred_coeff4d_1, &pred_energy, 0,
        GVQ_VEC_SIZE_4D-1);
pred_energy = MAX (pred_energy, -20.0);


dot_dvector(unfcod, unfcod, &energy, 0, L_FRM-1);


energy = 30.0 - 10.0*log10(energy/(FLOAT64)L_FRM+EPSI);


/*----------------------------------------------------*/
/*          Compute the predicted energy              */
/*----------------------------------------------------*/


energy += pred_energy;


/*----------------------------------------------------*/
/*           compute the predicted gain               */
/*----------------------------------------------------*/


pred_gain = pow(10.0, energy/20.0);


/*----------------------------------------------------*/
/*================ Optimal gainVQ search =============*/
/*----------------------------------------------------*/


dist_min = MAXFLT;


num_candidate = 32;


for (i = 0; i < num_candidate; i++)
        {
        g_cdbk = pred_gain*gainSQ_1_32[i];


        dist = sqr(g_cdbk - gainQ[1][0]);


        if (dist < dist_min)
            {
            dist_min = dist;
            (*idx) = i;
```

```
}
        }

/*------------------------------------------------*/
/*              get the quantized gains          */
/*------------------------------------------------*/


gainQ[1][0] = pred_gain*gainSQ_1_32[*idx];


/*------------------------------------------------*/
/*         update past quantized energies        */
/*------------------------------------------------*/


for (i = GVQ_VEC_SIZE_4D-1; i > 0; i--)
        past_energyq_4d[i] = past_energyq_4d[i-1];


past_energyq_4d[0] = 20.0*log10(gainSQ_1_32[*idx]);


/*------------------------------------------------*/


return;


/*------------------------------------------------*/
}
/*------------------------------------------------*/


/*================================================*/
/* FUNCTION    : GEQ_dec_gains_1_5 ().            */
/*------------------------------------------------*/
/* PURPOSE     : This function decodes the 5 bit 1-D VQ of Gc   */
/*------------------------------------------------*/
/* INPUT ARGUMENTS :                             */
/*      _ (INT16 )      index:   codebook index. */
/*      _ (INT16 )      N_bfi:   duration of bad frame   */
/*                      seq. (0=good frame)      */
/*      _ (FLOAT64 [])  unfcod:  adaptive and fixed   */
/*                      codebook excitation.     */
/*------------------------------------------------*/
/* OUTPUT ARGUMENTS :                            */
/*      _ (FLOAT64 [][])   gainQ:   Quantized adaptive and */
```

```
/*                    fixed codebook gains.   */
/*--------------------------------------------------------*/
/* INPUT/OUTPUT ARGUMENTS :                      */
/*              _ None.                */
/*--------------------------------------------------------*/
/* RETURN ARGUMENTS :                        */
/*              _ None.                 */
/*========================================================*/


void GEQ_dec_gains_1_5 (INT16 index, FLOAT64 **gainQ, FLOAT64 *unfcod,
                                  INT16 N_bfi )
        {
        /*------------------------------------------------*/


        INT16 i;

        FLOAT64 current_fixed_energy;
        FLOAT64 energy, pred_gain;
        FLOAT64 cdown;
        FLOAT64 val;
        FLOAT64      min_erg_15;


        /*------------------------------------------------*/
        /*    Compute the cdbk energy with mean removed (i.e., -30dB)    */
        /*------------------------------------------------*/

        dot_dvector (unfcod, unfcod, &energy, 0, L_FRM-1);


        current_fixed_energy = energy;
        energy /= (FLOAT64)L_FRM;
        energy = 30.0 - 10.0*log10(energy+EPSI);



        /*------------------------------------------------*/
        /*          Compute the predicted energy          */
        /*------------------------------------------------*/


        dot_dvector (past_energyq_4d, energy_pred_coeff4d_1, &val, 0,
                GVQ_VEC_SIZE_4D-1);
```

```
val = MAX (val, -20.0);

energy += val;

/*----------------------------------------------------------*/
/*              Compute the predicted gain           */
/*----------------------------------------------------------*/

pred_gain = pow(10.0, energy/20.0);

if (N_bfi == 0)
        {
        /*------------------------------------------------------*/
        /*================== good frame ===================*/
        /*------------------------------------------------------*/

        /*------------------------------------------------------*/
        /*              get the quantized gains          */
        /*------------------------------------------------------*/

        gainQ[1][0] = pred_gain*gainSQ_1_32[index];

        /*------------------------------------------------------*/
        /*          update past quantized energies       */
        /*------------------------------------------------------*/

        for (i = GVQ_VEC_SIZE_4D-1; i > 0; i--)
                past_energyq_4d[i] = past_energyq_4d[i-1];

        past_energyq_4d[0] = 20.0*log10(gainSQ_1_32[index]);

        }
else
        {
        /*===================================================*/

        /*------------------------------------------------------*/
        /*================= bad frame ===================*/
        /*------------------------------------------------------*/
```

```
/*------------------------------------------------*/
/*   set down-scaling according to number of bad frames   */
/*------------------------------------------------*/


    switch (N_bfi)
        {
        case 1:
                    cdown = 0.98;
                    break;
        case 2:
                    cdown = 0.94;
                    break;
        case 3:
                    cdown = 0.88;
                    break;
        case 4:
                    cdown = 0.80;
                    break;
        case 5:
                    cdown = 0.30;
                    break;
        case 6:
                    cdown = 0.20;
                    break;

        default:
                    cdown = 0.20;
                    break;
        }

gainQ[1][0] = sqrt(past_fixed_energy/current_fixed_energy);
gainQ[1][0] *= cdown;


    /*------------------------------------------------*/
    /*         update past quantized energies         */
    /*------------------------------------------------*/


min_erg_15 = MIN(past_energyq_4d[0], past_energyq_4d[1]);
min_erg_15 = MIN(min_erg_15, past_energyq_4d[2]);
min_erg_15 = MIN(min_erg_15, past_energyq_4d[3]);
```

```
        for (i = GVQ_VEC_SIZE_4D-1; i > 0; i--)
            past_energyq_4d[i] = past_energyq_4d[i-1];


        past_energyq_4d[0] = MIN(min_erg_15, -energy +
                    20*log10(fabs(0.6*gainQ[1][0]) + EPSI));
                }


        /*----------------------------------------------------*/
        /*       Update the past fixed codebook energy        */
        /*----------------------------------------------------*/


    past_fixed_energy = current_fixed_energy*sqr(gainQ[1][0]);


        /*----------------------------------------------------*/


    return;


        /*----------------------------------------------------*/
    }


    /*================================================================*/
    /* FUNCTION    : GEQ_gainNSQMA_1_6 ().                    */
    /*----------------------------------------------------*/
    /* PURPOSE     : This function performs 1-D VQ of Gc with  */
    /*          6 bits.                        */
    /*----------------------------------------------------*/
    /* INPUT ARGUMENTS :                        */
    /*      _ (FLOAT64 [])    unfcod: fixed codebook        */
    /*                    excitation.            */
    /*----------------------------------------------------*/
    /* OUTPUT ARGUMENTS :                        */
    /*      _ (FLOAT64 [])    gainQ: Quantized adaptive and   */
    /*                    fixed codebook gains.       */
    /*      _ (INT16  *)    idx:  codebook index.       */
    /*----------------------------------------------------*/
    /* INPUT/OUTPUT ARGUMENTS :                    */
    /*            _ None.                    */
    /*----------------------------------------------------*/
    /* RETURN ARGUMENTS :                        */
```

```
/*                    _ None.                    */
/*=======================================================*/

void GEQ_gainNSQMA_1_6(INT16 pos, FLOAT64 *unfcod, FLOAT64 **gainQ , INT16 *idx)
    {
    /*-----------------------------------------------------*/

    FLOAT64 energy, pred_gain, dist, dist_min, g_cdbk;
    INT16  i;
    INT16 num_candidate;
    FLOAT64 pred_energy;


    /*-----------------------------------------------------*/
    /*================ Compute the predicted cdbk gain ===============*/
    /*-----------------------------------------------------*/


    /*-----------------------------------------------------*/
    /* Note: compute the cdbk energy with mean removed (i.e., -30dB)    */
    /*-----------------------------------------------------*/


    dot_dvector (past_energyq_2d, energy_pred_coeff_1, &pred_energy, 0,
                GVQ_VEC_SIZE_2D-1);
    pred_energy = MAX (pred_energy, -20.0);


    dot_dvector(unfcod+pos*40, unfcod+pos*40, &energy, 0, 80-1);


    energy = 30.0 - 10.0*log10(energy/(FLOAT64)80+EPSI);


    /*-----------------------------------------------------*/
    /*            Compute the predicted energy            */
    /*-----------------------------------------------------*/


    energy += pred_energy;


    /*-----------------------------------------------------*/
    /*            compute the predicted gain              */
    /*-----------------------------------------------------*/


    pred_gain = pow(10.0, energy/20.0);
```

```
/*----------------------------------------------------*/
/*================== Optimal gainVQ search ==================*/
/*----------------------------------------------------*/

dist_min = MAXFLT;

num_candidate = 64;

for (i = 0; i < num_candidate; i++)
        {
        g_cdbk = pred_gain*gainSQ_1_64[i];

        dist = sqr(g_cdbk - gainQ[1][pos]);


        if (dist < dist_min)
                {
                dist_min = dist;
                (*idx) = i;
                }
        }

/*----------------------------------------------------*/
/*              get the quantized gains              */
/*----------------------------------------------------*/

gainQ[1][pos] = pred_gain*gainSQ_1_64[*idx];

/*----------------------------------------------------*/
/*          update past quantized energies           */
/*----------------------------------------------------*/

for (i = GVQ_VEC_SIZE_2D-1; i > 0; i--)
        past_energyq_2d[i] = past_energyq_2d[i-1];

past_energyq_2d[0] = 20.0*log10(gainSQ_1_64[*idx]);

/*----------------------------------------------------*/

return;
```

```
/*-----------------------------------------------*/
        }
/*-----------------------------------------------*/


/*===============================================*/
/* FUNCTION     : GEQ_dec_gains_1_6 ().          */
/*-----------------------------------------------*/
/* PURPOSE      : This function decodes the 6 bit 1-D VQ of Gc   */
/*-----------------------------------------------*/
/* INPUT ARGUMENTS :                             */
/*      _ (INT16 )       index:   codebook index.    */
/*      _ (INT16 )       N_bfi:   duration of bad frame   */
/*                       seq. (0=good frame)     */
/*      _ (FLOAT64 [])   unfcod:  adaptive and fixed   */
/*                       codebook excitation.    */
/*-----------------------------------------------*/
/* OUTPUT ARGUMENTS :                            */
/*      _ (FLOAT64 [][])   gainQ:   Quantized adaptive and */
/*                       fixed codebook gains.   */
/*-----------------------------------------------*/
/* INPUT/OUTPUT ARGUMENTS :                      */
/*                  _ None.                      */
/*-----------------------------------------------*/
/* RETURN ARGUMENTS :                            */
/*                  _ None.                      */
/*===============================================*/


void GEQ_dec_gains_1_6( INT16 pos, INT16 index, FLOAT64 **gainQ,
                        FLOAT64 *unfcod, INT16 N_bfi)
        {
        /*-----------------------------------------------*/

        INT16 i;

        FLOAT64 current_fixed_energy;
        FLOAT64 energy, pred_gain;
        FLOAT64 cdown;
        FLOAT64 val;
        FLOAT64      min_erg_16;
```

```
/*----------------------------------------------------------*/
/*      Compute the cdbk energy with mean removed (i.e., -30dB)    */
/*----------------------------------------------------------*/

dot_dvector (unfcod+pos*40, unfcod+pos*40, &energy, 0, 80-1);


current_fixed_energy = energy;
energy /= (FLOAT64)80;
energy = 30.0 - 10.0*log10(energy+EPSI);


/*----------------------------------------------------------*/
/*              Compute the predicted energy             */
/*----------------------------------------------------------*/


dot_dvector (past_energyq_2d, energy_pred_coeff_1, &val, 0,
            GVQ_VEC_SIZE_2D-1);


val = MAX (val, -20.0);


energy += val;


/*----------------------------------------------------------*/
/*              Compute the predicted gain               */
/*----------------------------------------------------------*/


pred_gain = pow(10.0, energy/20.0);


if (N_bfi == 0)
        {
        /*----------------------------------------------------------*/
        /*==================== good frame ====================*/
        /*----------------------------------------------------------*/


        /*----------------------------------------------------------*/
        /*              get the quantized gains             */
        /*----------------------------------------------------------*/


gainQ[1][pos] = pred_gain*gainSQ_1_64[index];
```

```
/*------------------------------------------------*/
/*       update past quantized energies       */
/*------------------------------------------------*/


        for (i = GVQ_VEC_SIZE_2D-1; i > 0; i--)
                past_energyq_2d[i] = past_energyq_2d[i-1];


        past_energyq_2d[0] = 20.0*log10(gainSQ_1_64[index]);



        }
else

        {
        /*==============================================================*/


        /*------------------------------------------------*/
        /*======================== bad frame ========================*/
        /*------------------------------------------------*/


        /*------------------------------------------------*/
        /*    set down-scaling according to number of bad frames    */
        /*------------------------------------------------*/


        switch (N_bfi)
                {
                case 1:
                                cdown = 0.98;
                                break;
                case 2:
                                cdown = 0.94;
                                break;
                case 3:
                                cdown = 0.88;
                                break;
                case 4:
                                cdown = 0.80;
                                break;
                case 5:
                                cdown = 0.30;
                                break;
                case 6:
```

```
                                    cdown = 0.20;
                                    break;                     .

                        default:
                                    cdown = 0.20;
                                    break;
                                }


            gainQ[1][pos] = sqrt(past_fixed_energy/current_fixed_energy);
            gainQ[1][pos] *= cdown;


                /*---------------------------------------------------*/
                /*          update past quantized energies          */
                /*---------------------------------------------------*/


            min_erg_16 = MIN(past_energyq_2d[0], past_energyq_2d[1]);


            for (i = GVQ_VEC_SIZE_2D-1; i > 0; i--)
              past_energyq_2d[i] = past_energyq_2d[i-1];


            past_energyq_2d[0] = MIN(min_erg_16, -energy +
                        20*log10(fabs(0.6*gainQ[1][pos]) + EPSI));
                }


                /*---------------------------------------------------*/
                /*          Update the past fixed codebook energy     */
                /*---------------------------------------------------*/


            past_fixed_energy = current_fixed_energy*sqr(gainQ[1][pos]);


                /*---------------------------------------------------*/


            return;


                /*---------------------------------------------------*/
            }
/*===================================================================*/
/* FUNCTION    : GEQ_gain_reopt_2 ().                      */
/*-------------------------------------------------------------------*/
/* PURPOSE     : This function jointly estimates Ga and Gc.      */
```

```
/*--------------------------------------------------*/
/* INPUT ARGUMENTS :                                */
/*      _ (FLOAT64 [])     vec0:  filtered adaptive codebook */
/*                         excitation.              */
/*      _ (FLOAT64 [])     vec1:  filtered fixed codebook   */
/*                         excitation.              */
/*      _ (FLOAT64 [])     target: target signal.   */
/*      _ (INT16 )         l_sf:  length of subframe.   */
/*--------------------------------------------------*/
/* OUTPUT ARGUMENTS :                               */
/*      _ (FLOAT64 )       gain0:  adaptive codebook gain.   */
/*      _ (FLOAT64 )       gain1:  fixed codebook gain.      */
/*--------------------------------------------------*/
/* INPUT ARGUMENTS :                                */
/*               _ None.                            */
/*--------------------------------------------------*/
/* RETURN ARGUMENTS :                               */
/*               _ None.                            */
/*==================================================*/


void GEQ_gain_reopt_2(FLOAT64 *vec0, FLOAT64 *vec1, FLOAT64 *target,
                      FLOAT64 *gain0, FLOAT64 *gain1, INT16 l_sf)
        {
        /*--------------------------------------------------*/

        FLOAT64 *Cp, *Tgs, *Cc;
        FLOAT64 R_Cp_Tgs, R_Cp_Cp, R_Cc_Cc, R_Cp_Cc, R_Cc_Tgs;
        FLOAT64 den, num;


        /*--------------------------------------------------*/

        Tgs = target;
        Cp  = vec0;
        Cc  = vec1;

        dot_dvector(Cp, Tgs,    &R_Cp_Tgs,   0, l_sf-1);
        dot_dvector(Cp, Cp,     &R_Cp_Cp,    0, l_sf-1);
        dot_dvector(Cc, Cc,     &R_Cc_Cc,    0, l_sf-1);
        dot_dvector(Cp, Cc,     &R_Cp_Cc,    0, l_sf-1);
        dot_dvector(Cc, Tgs,    &R_Cc_Tgs,   0, l_sf-1);
```

```
/*-------------------------------------------------*/
/*              Optimize all gains            */
/*-------------------------------------------------*/


    num = R_Cp_Tgs*R_Cc_Cc - R_Cp_Cc*R_Cc_Tgs;
    den = R_Cp_Cp*R_Cc_Cc - R_Cp_Cc*R_Cp_Cc;


    if (den > 0)
            den = MAX(0.001, den);
    else
            den = MIN(-0.001, den);


    (*gain0) = num/den;
    (*gain0) = MAX(0.0, *gain0);
    (*gain0) = MIN(1.2, *gain0);
    (*gain1) = (R_Cc_Tgs - (*gain0)*R_Cp_Cc)/MAX(R_Cc_Cc, 0.00001);


    /*-----------------------------------------*/


    return;


    /*-----------------------------------------*/
    }


/*-----------------------------------------------*/


/*=================================================================*/
/* FUNCTION     : GEQ_energy_extrapolation ().          */
/*-----------------------------------------------*/
/* PURPOSE      : This function extrapolate the energy of the    */
/*               excitation when a frame erasure occurs.      */
/*-----------------------------------------------*/
/* INPUT ARGUMENTS :                         */
/*  _ (INT16 )   i_s:      subframe starting sample.      */
/*  _ (INT16 )   i_sf:     subframe number.            */
/*  _ (INT16 )   l_sf:     length of subframe.          */
/*  _ (FLOAT64 []) gainQ:   adaptive and fixed codebook gains. */
/*  _ (FLOAT64 **) unfcod_dec:  adaptive and fixed codebook excit. */
```

```
/*  _ (INT16 )   bfi:        current frame Bad Frame Indicator. */
/*  _ (INT16   []) lag:        subframe lags.                */
/*  _ (FLOAT64 []) ForPitch_dec: decoded picth evolution.        */
/*  _ (PARAMETER) channel:    decoded indexes.              */
/*-----------------------------------------------------------*/
/* OUTPUT ARGUMENTS :                          */
/*  _ (FLOAT64 []) ext_dec:      final scaled excitation.      */
/*  _ (FLOAT64 []) Prev_Beta_Pitch: excitation scaling factor.    */
/*  _ (FLOAT64 []) ET_buf:      subframe energy factor.       */
/*-----------------------------------------------------------*/
/* INPUT ARGUMENTS :                           */
/*               _ None.                    */
/*-----------------------------------------------------------*/
/* RETURN ARGUMENTS :                          */
/*               _ None.                    */
/*===========================================================*/


void GEQ_energy_extrapolation (INT16 i_s, INT16 i_sf, INT16 l_sf,
                               FLOAT64 gainQ [], FLOAT64 **qua_unfcod,
                               INT16 bfi, INT16 lag [], FLOAT64 ext_dec [],
                               FLOAT64 Prev_Beta_Pitch [], FLOAT64 ET_buf [],
                               FLOAT64 ForPitch_dec [], PARAMETER channel)
        {
        /*---------------------------------------------------*/

        INT16   i;

        FLOAT64 E1, E2, ET, FET, PFET;
        FLOAT64 *px, AA, BB;
        FLOAT64 tmp_vec1[L_SF], tmp_vec2[L_SF], tmp_vec3[L_SF];

        /*---------------------------------------------------*/

        for(i = 0; i < l_sf; i++)
                {
                tmp_vec1[i] = gainQ[1] * qua_unfcod[1][i+i_s];
                tmp_vec2[i] = gainQ[0] * qua_unfcod[0][i+i_s];
                tmp_vec3[i] = gainQ[0] * qua_unfcod[0][i+i_s] +
                                        gainQ[1] * qua_unfcod[1][i+i_s];
                }
```

```
dot_dvector(tmp_vec1, tmp_vec1, &E1, 0, l_sf-1);
dot_dvector(tmp_vec2, tmp_vec2, &E2, 0, l_sf-1);
dot_dvector(tmp_vec3, tmp_vec3, &ET, 0, l_sf-1);


ET_buf[i_sf] = 10.0*log10(ET + EPSI);
Prev_Beta_Pitch[i_sf] = E2 / (E1 + E2 + EPSI);


px = ext_dec+MAX_LAG;
dot_dvector(px, px, &FET, 0, l_sf-1);


FET += EPSI;


if (bfi == 1)
        {
        /*---------------------------------------------------*/


        if (gainQ[0] > 0.6)
          if (channel.idx_SVS_deci == 0)
                        BB = 0.90;
                else
                        BB = 0.95;
        else
                BB = 0.8;


        /*---------------------------------------------------*/


        if (channel.idx_SVS_deci == 0)
                {
                if ((lag[i_sf] > 0) && (gainQ[0] >= 0.6))
                        px = ext_dec+MAX_LAG-lag[i_sf];
                else
                        px = ext_dec+MAX_LAG-l_sf;
                }
        else
                {
                if (lag[i_sf] > 0)
                        px = ext_dec+MAX_LAG-(INT16)ForPitch_dec[i_s];
                else
                        px = ext_dec+MAX_LAG-l_sf;
```

```
                 }


        /*--------------------------------------------------*/


    dot_dvector(px, px, &PFET, 0, l_sf-1);
    AA = BB*sqrt(PFET/FET);


    px = ext_dec+MAX_LAG;
    sca_dvector(px, AA, px, 0, l_sf-1);
         }


        /*--------------------------------------------------*/


    return;


        /*--------------------------------------------------*/

    }


    /*--------------------------------------------------*/


    /*============================================================*/
    /* FUNCTION    : GEQ_update_mem_4d_to_2d ().          */
    /*--------------------------------------------------*/
    /* PURPOSE     : This function update the cross memories    */
    /*                for the gain quantizers for the transition   */
    /*                4 to 2 gains.                    */
    /*--------------------------------------------------*/
    /* INPUT ARGUMENTS :                      */
    /*                _ None.                 */
    /*--------------------------------------------------*/
    /* OUTPUT ARGUMENTS :                     */
    /*                _ None.                 */
    /*--------------------------------------------------*/
    /* INPUT/OUTPUT ARGUMENTS :                   */
    /*                _ None.                 */
    /*--------------------------------------------------*/
    /* RETURN ARGUMENTS :                     */
    /*                _ None.                 */
    /*============================================================*/
```

```
void GEQ_update_mcm_4d_to_2d (void)
        {
        /*----------------------------------------------------*/


        past_energyq_2d[0] = 0.5*(past_energyq_4d[0]+ past_energyq_4d[1]);
        past_energyq_2d[1] = 0.5*(past_energyq_4d[2]+ past_energyq_4d[3]);


        /*----------------------------------------------------*/


        return;


        /*----------------------------------------------------*/
        }


/*----------------------------------------------------*/


/*==================================================================*/
/* FUNCTION     : GEQ_update_mem_2d_to_4d ().              */
/*----------------------------------------------------*/
/* PURPOSE      : This function update the cross memories      */
/*                for the gain quantizers for the transition    */
/*                2 to 4 gains.                     */
/*----------------------------------------------------*/
/* INPUT ARGUMENTS :                         */
/*                _ None.                      */
/*----------------------------------------------------*/
/* OUTPUT ARGUMENTS :                        */
/*                _ None.                      */
/*----------------------------------------------------*/
/* INPUT/OUTPUT ARGUMENTS :                     */
/*                _ None.                      */
/*----------------------------------------------------*/
/* RETURN ARGUMENTS :                        */
/*                _ None.                      */
/*==================================================================*/


void GEQ_update_mem_2d_to_4d(void)
        {
        /*----------------------------------------------------*/
```

```
        FLOAT64 val;


        /*------------------------------------------------*/


        val = 0.5*(past_energyq_2d[0] + past_energyq_2d[1]);


        past_energyq_4d[0] = past_energyq_2d[0];
        past_energyq_4d[1] = val;
        past_energyq_4d[2] = val;
        past_energyq_4d[3] = past_energyq_2d[1];


        /*------------------------------------------------*/


        return;


        /*------------------------------------------------*/
        }


/*------------------------------------------------*/


/*================================================*/
/* FUNCTION     : GEQ_update_mem_3d_to_2d ().              */
/*------------------------------------------------*/
/* PURPOSE      : This function update the cross memories    */
/*               for the gain quantizers for the transition  */
/*               3 to 2 gains.                               */
/*------------------------------------------------*/
/* INPUT ARGUMENTS :                              */
/*               _ None.                          */
/*------------------------------------------------*/
/* OUTPUT ARGUMENTS :                             */
/*               _ None.                          */
/*------------------------------------------------*/
/* INPUT/OUTPUT ARGUMENTS :                       */
/*               _ None.                          */
/*------------------------------------------------*/
/* RETURN ARGUMENTS :                             */
/*               _ None.                          */
/*================================================*/
```

```
void GEQ_update_mem_3d_to_2d(void)
        {
        /*-------------------------------------------------------*/


        past_energyq_2d[0] = 0.5*(past_energyq_3d[0]+ past_energyq_3d[1]);
        past_energyq_2d[1] = 0.5*(past_energyq_3d[1]+ past_energyq_3d[2]);


        /*-------------------------------------------------------*/


        return;


        /*-------------------------------------------------------*/
        }


/*-----------------------------------------------------------------*/



/*=================================================================*/
/* FUNCTION    : GEQ_update_mem_2d_to_3d ().                 */
/*-------------------------------------------------------*/
/* PURPOSE     : This function update the cross memories      */
/*              for the gain quantizers for the transition    */
/*              2 to 3 gains.                        */
/*-------------------------------------------------------*/
/* INPUT ARGUMENTS  :                       */
/*              _ None.                   */
/*-------------------------------------------------------*/
/* OUTPUT ARGUMENTS :                        */
/*              _ None.                   */
/*-------------------------------------------------------*/
/* INPUT/OUTPUT ARGUMENTS :                      */
/*              _ None.                   */
/*-------------------------------------------------------*/
/* RETURN ARGUMENTS :                        */
/*              _ None.                   */
/*=================================================================*/


void GEQ_update_mem_2d_to_3d(void)
        {
        /*-------------------------------------------------------*/
```

```
        past_energyq_3d[0] = past_energyq_2d[0];

        past_energyq_3d[1] = 0.5*(past_energyq_2d[0]+ past_energyq_2d[1]);

        past_energyq_3d[2] = past_energyq_2d[1];


        /*------------------------------------------------------*/


        return;


        /*------------------------------------------------------*/
        }


/*------------------------------------------------------*/


/*========================================================*/
/* FUNCTION    : GEQ_update_mem_3d_to_4d ().              */
/*------------------------------------------------------*/
/* PURPOSE     : This function update the cross memories    */
/*               for the gain quantizers for the transition  */
/*               3 to 4 gains.                             */
/*------------------------------------------------------*/
/* INPUT ARGUMENTS :                                      */
/*               _ None.                                 */
/*------------------------------------------------------*/
/* OUTPUT ARGUMENTS :                                     */
/*               _ None.                                 */
/*------------------------------------------------------*/
/* INPUT/OUTPUT ARGUMENTS :                               */
/*               _ None.                                 */
/*------------------------------------------------------*/
/* RETURN ARGUMENTS :                                     */
/*               _ None.                                 */
/*========================================================*/


void GEQ_update_mem_3d_to_4d(void)
        {
        /*------------------------------------------------------*/


        past_energyq_4d[0] = past_energyq_3d[0];
        past_energyq_4d[1] = past_energyq_3d[1];
```

```
            past_energyq_4d[2] = past_energyq_3d[1];

            past_energyq_4d[3] = past_energyq_3d[2];


            /*----------------------------------------------------*/


            return;


            /*----------------------------------------------------*/

            }


/*----------------------------------------------------------*/


/*===========================================================*/
/* FUNCTION    : GEQ_update_mem_4d_to_3d ().             */
/*----------------------------------------------------*/
/* PURPOSE     : This function update the cross memories    */
/*               for the gain quantizers for the transition  */
/*               4 to 3 gains.                        */
/*----------------------------------------------------*/
/* INPUT ARGUMENTS :                          */
/*               _ None.                     */
/*----------------------------------------------------*/
/* OUTPUT ARGUMENTS :                         */
/*               _ None.                     */
/*----------------------------------------------------*/
/* INPUT/OUTPUT ARGUMENTS :                      */
/*               _ None.                     */
/*----------------------------------------------------*/
/* RETURN ARGUMENTS :                         */
/*               _ None.                     */
/*===========================================================*/


void GEQ_update_mem_4d_to_3d(void)
        {
        /*----------------------------------------------------*/


        past_energyq_3d[0] = past_energyq_4d[0];

        past_energyq_3d[1] = 0.5*(past_energyq_4d[1]+ past_energyq_4d[2]);

        past_energyq_3d[2] = past_energyq_4d[3];
```

```
    /*------------------------------------------------*/

    return;

    /*------------------------------------------------*/
    }

/*------------------------------------------------*/

/*================================================*/
/*------------------- END ------------------------*/
/*================================================*/
```

```
/*==============================================================*/


/*==============================================================*/
/* Conexant System Inc.                          */
/* 4311 Jamboree Road                            */
/* Newport Beach, CA 92660                        */
/*------------------------------------------------*/
/* Copyright(C) 2000 Conexant System Inc.            */
/*------------------------------------------------*/
/* ALL RIGHTS RESERVED:                           */
/* No part of this software may be reproduced in any form or by any */
/* means or used to make any derivative work (such as transformation */
/* or adaptation) without the authorisation of Conexant System Inc. */
/*==============================================================*/
/* PROTOTYPE FILE : lib_geq.h                      */
/*==============================================================*/


/*------------------------------------------------*/
/*-------------------- FUNCTIONS ------------------*/
/*------------------------------------------------*/


void GEQ_init_lib          (void);

void GEQ_gainVQMA_2         (FLOAT64 [], FLOAT64 **, FLOAT64 **, FLOAT64 [], INT16 *,
                            INT16,INT16);

void GEQ_dec_gains_2_7 (INT16,INT16, INT16, FLOAT64 [], INT16, FLOAT64 [],
                            INT16, INT16);

void GEQ_gainVQMA_2_8_5     (FLOAT64 [], FLOAT64 **, FLOAT64 **, FLOAT64 [], INT16 *,
                            INT16);

void GEQ_dec_gains_2_7_8_5  (INT16, INT16, FLOAT64 [], INT16, FLOAT64 [],  INT16,
                            INT16);

void GEQ_Quant_PitchGain_3D     (FLOAT64 *, INT16 *);
void GEQ_Quant_PitchGain_4D     (FLOAT64 *, INT16 *);


void GEQ_Dec_PitchGain_3D       (INT16, INT16, INT16, FLOAT64 *);
```

```
void GEQ_Dec_PitchGain_4D          (INT16, INT16, INT16, FLOAT64 *);


void GEQ_gainVQMA_3          (FLOAT64 [], FLOAT64 **, FLOAT64 **, FLOAT64 **, INT16 *);


void GEQ_dec_gc_3_8          (INT16, FLOAT64 *, INT16, FLOAT64 **, INT16);


void GEQ_gainVQMA_4          (FLOAT64 [], FLOAT64 **, FLOAT64 **, FLOAT64 **, INT16 *);


void GEQ_dec_gc_4_10          (INT16, FLOAT64 *, INT16, FLOAT64 **, INT16);



void GEQ_gainNSQMA_1_5(FLOAT64 [], FLOAT64 **, INT16 []);
void GEQ_dec_gains_1_5( INT16 , FLOAT64 **, FLOAT64 [], INT16 );


void GEQ_gainNSQMA_1_6(INT16 , FLOAT64 [], FLOAT64 **, INT16 []);
void GEQ_dec_gains_1_6( INT16 , INT16 , FLOAT64 **, FLOAT64 [], INT16 );


void GEQ_gain_reopt_2   (FLOAT64 [], FLOAT64 [], FLOAT64 [], FLOAT64 *,
                         FLOAT64 *, INT16);



void GEQ_energy_extrapolation (INT16, INT16, INT16, FLOAT64 [], FLOAT64 **,
                         INT16, INT16 [], FLOAT64 [], FLOAT64 [], FLOAT64 [],
                         FLOAT64 [], PARAMETER);



void GEQ_update_mem_4d_to_2d (void);
void GEQ_update_mem_2d_to_4d (void);
void GEQ_update_mem_3d_to_2d (void);
void GEQ_update_mem_2d_to_3d (void);
void GEQ_update_mem_3d_to_4d (void);
void GEQ_update_mem_4d_to_3d (void);


/*==================================================================*/
/*------------------------ END ------------------------*/
/*==================================================================*/
```

```
/*===================================================================*/


/*===================================================================*/
/* Conexant System Inc.                        */
/* 4311 Jamboree Road                          */
/* Newport Beach, CA 92660                      */
/*----------------------------------------------*/
/* Copyright(C) 2000 Conexant System Inc.           */
/*----------------------------------------------*/
/* ALL RIGHTS RESERVED:                        */
/* No part of this software may be reproduced in any form or by any */
/* means or used to make any derivative work (such as transformation */
/* or adaptation) without the authorisation of Conexant System Inc. */
/*===================================================================*/
/* LIBRARY: lib_ini.c                          */
/*===================================================================*/


/*----------------------------------------------*/
/*--------------------- INCLUDE ----------------------*/
/*----------------------------------------------*/


#include "typedef.h"

#include "const.h"

#include "main.h"
#include "mcutil.h"
#include "gputil.h"
#include "ext_var.h"

#include "lib_ini.h"

#include "lib_lpc.h"
#include "lib_qlsf.h"
#include "lib_geq.h"
#include "lib_vad.h"
#include "lib_ppr.h"
#include "lib_cla.h"
#include "lib_snr.h"
#include "lib_pwf.h"
```

445

```
#include "lib_pit.h"
#include "lib_ltp.h"
#include "lib_smo.h"
#include "lib_prc.h"
#include "lib_bit.h"
#include "lib_ppp.h"
#include "lib_fcs.h"


/*-----------------------------------------------------*/
/*---------------------- FUNCTIONS --------------------*/
/*-----------------------------------------------------*/


/*====================================================================*/
/* FUNCTION    : INI_allocate_memory ().                  */
/*-----------------------------------------------------*/
/* PURPOSE     : This function performs memory allocation.    */
/*-----------------------------------------------------*/
/* INPUT ARGUMENTS :                         */
/*              _ None.                  */
/*-----------------------------------------------------*/
/* OUTPUT ARGUMENTS :                        */
/*              _ None.                  */
/*-----------------------------------------------------*/
/* INPUT/OUTPUT ARGUMENTS :                      */
/*              _ None.                  */
/*-----------------------------------------------------*/
/* RETURN ARGUMENTS :                        */
/*              _ None.                  */
/*====================================================================*/


void    INI_allocate_memory ( void )
        {
        /*-----------------------------------------------------*/
        /*      Memory Allocation for Time-Domain Pre Filtering    */
        /*-----------------------------------------------------*/


        pre_flt_num  = dvector (0, PPR_FLT_ORDER-1);
        pre_flt_den  = dvector (0, PPR_FLT_ORDER-1);
        pre_flt_buf_z = dvector (0, PPR_FLT_ORDER-1);
        pre_flt_buf_p = dvector (0, PPR_FLT_ORDER-1);
```

446

```
lp_flt_num = dvector (0, LP_FLT_ORDER-1);
lp_flt_buf = dvector (0, LP_FLT_ORDER-1);


/*----------------------------------------------------*/
/*        Memory Allocation for Silence Enhancement        */
/*----------------------------------------------------*/


zeroed        = svector (0, SE_MEM_SIZE-1);
zero_rate     = dvector (0, SE_MEM_SIZE-1);
low_rate      = dvector (0, SE_MEM_SIZE-1);
high_rate     = dvector (0, SE_MEM_SIZE-1);


low_neg       = dvector (0, 1);
low_pos       = dvector (0, 1);


/*----------------------------------------------------*/
/*    Memory Allocation for Tilt compansation Post Filtering    */
/*----------------------------------------------------*/


tc_buff_exc = dvector (0, L_LPC-1);


/*----------------------------------------------------*/
/*       Memory Allocation for Time-Domain Post Filtering       */
/*----------------------------------------------------*/


buff_LTpost = dvector (0, MAX_LAG+L_SF-1);
PF_mem_syn  = dvector (0, NP-1);


/*----------------------------------------------------*/
/*       Memory Allocation for Time-Domain Post Filtering       */
/*----------------------------------------------------*/


pst_flt_num   = dvector (0, PPR_FLT_ORDER-1);
pst_flt_den   = dvector (0, PPR_FLT_ORDER-1);
pst_flt_buf_z = dvector (0, PPR_FLT_ORDER-1);
pst_flt_buf_p = dvector (0, PPR_FLT_ORDER-1);


/*----------------------------------------------------*/
```

```
/*        Memory Allocation for Linear Prediction Analysis      */
/*--------------------------------------------------------------*/

    siglpc = dvector (0, L_LPC-1);


    tilt_window = dvector (0, L_LPC-1);
    lpc_window  = dvector (0, L_LPC-1);
    lpc_window1 = dvector (0, L_LPC-1);
    lpc_window2 = dvector (0, L_LPC-1);
    bwe_factor      = dvector (0, NP);


    rxx             = dvector (0, NP);
    refl            = dmatrix (0, N_SF_MAX, 0, NP-1);
    lsf_new         = dvector (0, NP-1);
    lsf_old  = dvector (0, NP-1);
    lsf_mid = dvector (0, NP-1);


    IntLSF_C        = dvector (0, N_SF4-1);


    pdcf            = dmatrix (0, N_SF_MAX, 0, NP-1);
    pdcfq           = dmatrix (0, N_SF_MAX, 0, NP-1);
    pdcfq_dec       = dmatrix (0, N_SF_MAX, 0, NP-1);


/*--------------------------------------------------------------*/
/*        Memory Allocation for the LSF quantization      */
/*--------------------------------------------------------------*/

lsf_cb_08k = d3tensor(0, MAXLTT_08k-1, 0,LMSMAX_08k-1, 0, MAXLNp -1);
lsf_cb_40k = d3tensor(0, MAXLTT_40k-1, 0,LMSMAX_40k-1, 0, MAXLNp -1);
lsf_cb_85k = d3tensor(0, MAXLTT_85k-1, 0,LMSMAX_85k-1, 0, MAXLNp -1);


    stage_cand_08k = svector(0, 2);
    stage_cand_40k = svector(0, 3);
    stage_cand_85k = svector(0, 3);


    MS_08k  = svector (0, LTT_08k-1);
    MS_40k  = svector (0, LTT_40k-1);
    MS_85k  = svector (0, LTT_85k-1);
```

```
qes        = dmatrix (0, LQMA_40k-1, 0, NP-1);
qes_dec = dmatrix (0, LQMA_40k-1, 0, NP-1);


last_qlsf  = dvector (0, NP-1);
lsfq_old   = dvector (0, NP-1);
lsfq_old_dec = dvector (0, NP-1);
Mean          = dvector (0, NP-1);


lsfq_mem_dec  = dvector (0, NP-1);
lsfq_mem_enc  = dvector (0, NP-1);


/*------------------------------------------------------*/
/*        Memory Allocation for Perceptual Weighting      */
/*------------------------------------------------------*/


wspeech        = dvector (0, L_OLPIT-1);
wspeech_mem = dvector (0, NP-1);
wpdcf_pole  = dmatrix (0, N_SF_MAX, 0, NP-1);
wpdcf_zero   = dmatrix (0, N_SF_MAX, 0, NP-1);
tmp_ws_m     = dvector (0, NP-1);
ModiSig_m    = dvector (0, NP-1);


/*------------------------------------------------------*/
/*  Memory Allocation for Impulse Response of the synthesis filter  */
/*------------------------------------------------------*/


/*------------------------------------------------------*/
/*        Memory Allocation for Signal Classification     */
/*------------------------------------------------------*/


frame_class_mem = svector (0, CLA_MEM_SIZE-1);
onstplsv_mem    = svector (0, CLA_MEM_SIZE-1);
voiced_mem             = svector (0, CLA_MEM_SIZE-1);


buffer_cla     = dvector (0, L_FRM+MEM_CLASS+L_LPCLHD-1);
Lp_buffer      = dvector (0, N_Lp-1);


window1        = dvector (0, LPC_WIN1-1);


P_w = dmatrix (0, 1, 0, SLOPE_MAX_SIZE-1);
```

```
buffer_refl0 = dvector (0, CLA_MEM_SIZE-1);


buffer_wtilt   = dvector (0, MAX_N_SF-1);
buffer_wmax    = dvector (0, MAX_N_SF-1);
buffer_wRp     = dvector (0, MAX_N_SF-1);
buffer_max_cla = dvector (0, MAX_N_SF-1);


/*-----------------------------------------------------------*/
/*        Memory Allocation for Voice Activity Detection      */
/*-----------------------------------------------------------*/


lag_buf   = svector (0, LTP_BUFF_SIZE-1);
pgain_buf = dvector (0, LTP_BUFF_SIZE-1);



flag_vad_mem    = svector (0, FLAG_VAD_MEM_SIZE-1);
vad_lsf_mem     = dmatrix (0, VAD_MEM_SIZE-1, 0, NP-1);
min_energy_mem          = dvector (0, VAD_MIN_MEM_SIZE-1);
mean_lsf                = dvector (0, NP-1);
norm_mean_lsf   = dvector (0, NP-1);


prev_cml_lsf_diff = dvector (0, VAD_MEM_SIZE-1);
prev_energy       = dvector (0, VAD_MEM_SIZE-1);



/*-----------------------------------------------------------*/
/*    Memory Allocation for Smoothing parameters estimation   */
/*-----------------------------------------------------------*/


lsf_smooth = dvector (0, NP-1);


N_sub = svector (0, N_SF_MAX-1);
lsf_old_smo = dvector (0, NP-1);
ma_lsf = dvector (0, NP-1);
dSP_buf = dvector (0, DSP_BUFF_SIZE-1);;


buffer_smo = dvector (0, HI_LAG2+L_SF-1);
buffer_sum_smo = dvector (0, SMO_BUFF_SIZE-1);
buffer_max_smo = dvector (0, SMO_BUFF_SIZE-1);
```

```
/*-----------------------------------------------------*/
/*      Memory Allocation for Open Loop Pitch Detection      */
/*-----------------------------------------------------*/


ol_lag = svector(0, N_SF_MAX);
lag    = svector(0, N_SF_MAX);
Rp_sub = dvector(0, N_SF_MAX-1);


SincWindows = dvector (0, LEN_SINC_TAB-1);


PITmax0 = svector (0, NUM_MAX_SRCH-1);
Rmax0   = dvector (0, NUM_MAX_SRCH-1);


pitch_f_mem = dvector (0, PIT_F_MEM-1);


PitLagTab5b = dvector (0, LEN_PITCH_TAB_5BIT-1);
PitLagTab7b = dvector (0, LEN_PITCH_TAB_7BIT-1);
PitLagTab8b = dvector (0, LEN_PITCH_TAB_8BIT-1);




/*-----------------------------------------------------*/
/*      Memory Allocation for Open Pitch Pre-processing      */
/*-----------------------------------------------------*/


SincWindows_PP = dvector (0, LEN_SINC_TAB_PP-1);


targ_mem = dvector (0, MAX_LAG-1);


/*-----------------------------------------------------*/
/*      Memory Allocation for Closed Loop Pitch Detection      */
/*-----------------------------------------------------*/


SincWindows_E = dvector (0, LEN_SINC_TAB_E-1);


NewTg = dvector (0, L_FRM+NP-1);
lag_f = dvector (0, N_SF_MAX-1);
ext   = dvector (0, MAX_LAG+L_SF-1);


/*-----------------------------------------------------*/
```

```
/*        Memory Allocation for Short Term Algebraic Analysis      */
/*---------------------------------------------------------------*/


    MaxIdx = svector (0, MAXPN-1);


    p_track_2_5_0 = smatrix(0, 2-1, 0, 32-1);
    p_track_2_7_1 = smatrix(0, 2-1, 0, 80-1);


    p_track_3_2_80 = s3tensor(0, 16-1, 0, 3-1, 0, 4-1);
    p_track_3_2_54 = s3tensor(0, 16-1, 0, 3-1, 0, 4-1);


    p_track_5_4_0 = smatrix(0, 5-1, 0, 16-1);
    p_track_5_3_1 = smatrix(0, 5-1, 0, 8-1);
    p_track_5_3_2 = smatrix(0, 5-1, 0, 8-1);


    p_track_8_4_0 = smatrix(0, 8-1, 0, 16-1);


    PHI      = dmatrix (0, L_SF-1, 0, L_SF-1);


    unfcod = dmatrix (0, 1, 0, L_SF-1);
    fcod   = dmatrix (0, 1, 0, L_SF-1);


    qua_unfcod = dmatrix (0, 1, 0, L_FRM-1);
    qua_fcod   = dmatrix (0, 1, 0, L_FRM-1);


    unfcod_dec = dmatrix (0, 1, 0, L_SF-1);


    wsp_m = dvector (0, L_WSP-1);


    hh_hf = dvector (0, L_HF-1);


    /*---------------------------------------------------------------*/
    /*        Memory Allocation for Gain Vector Quantisation         */
    /*---------------------------------------------------------------*/


qua_gainQ     = dmatrix (0, 1, 0, N_SF_MAX-1);


past_energyq_2d = dvector (0, GVQ_VEC_SIZE_2D-1);
past_energyq_3d = dvector (0, GVQ_VEC_SIZE_3D-1);
```

```
past_energyq_4d = dvector (0, GVQ_VEC_SIZE_4D-1);


gp_buf = dvector (0, GP_BUF_SIZE-1);


pred_energy_d38 = dvector (0, GVQ_VEC_SIZE_3D-1);
pred_energy_d410 = dvector (0, GVQ_VEC_SIZE_4D-1);


Prev_Beta_Pitch  = dvector (0, BETA_BUF_SIZE-1);


energy_pred_coeff_1 = dvector (0, GVQ_VEC_SIZE_3D-1);
energy_pred_coeff_2 = dvector (0, GVQ_VEC_SIZE_3D-1);
energy_pred_coeff_3 = dvector (0, GVQ_VEC_SIZE_3D-1);


energy_pred_coeff4d_1 = dvector (0, GVQ_VEC_SIZE_4D-1);
energy_pred_coeff4d_2 = dvector (0, GVQ_VEC_SIZE_4D-1);
energy_pred_coeff4d_3 = dvector (0, GVQ_VEC_SIZE_4D-1);
energy_pred_coeff4d_4 = dvector (0, GVQ_VEC_SIZE_4D-1);


gain_cb_2_128      = dmatrix (0,MSMAX_2_128-1, 0, GVQ_VEC_SIZE_2D-1);
gain_cb_2_128_8_5   = dmatrix (0,MSMAX_2_128-1, 0, GVQ_VEC_SIZE_2D-1);



/*------------------------------------------------*/
/*        Memory Deallocation for bit stream       */
/*------------------------------------------------*/


bitno0 = svector(0, 3-1);
bitno1 = svector(0, 3-1);



/*------------------------------------------------*/
/*     Memory Deallocation for Frame Erasure Concealenement   */
/*------------------------------------------------*/


enrg_buff = dvector(0, ERNG_MEM_SIZE-1);
ext_dec_mem = dvector (0, MAX_LAG+L_SF-1);


/*------------------------------------------------*/
```

```
/*          Memory Allocation for Speech Synthesis          */
/*------------------------------------------------------------*/


synth_mem            = dvector (0, NP-1);
synth_mem_dec = dvector (0, NP-1);
dif_mem              = dvector (0, L_SF+NP-1);
target_mem           = dvector (0, NP-1);
qua_synth_mem = dvector (0, NP-1);
qua_dif_mem     = dvector (0, L_SF+NP-1);
qua_target_mem = dvector (0, NP-1);


qua_ext = dvector (0, MAX_LAG+L_SF-1);
sigsyn_dec       = dvector (0, L_SF+NP-1);


ext_dec = dvector (0, MAX_LAG+L_SF-1);




/*------------------------------------------------------------*/


return;


/*------------------------------------------------------------*/
}



/*------------------------------------------------------------*/



/*============================================================*/
/* FUNCTION     : INI_deallocate_memory ().          */
/*------------------------------------------------------------*/
/* PURPOSE      : This function performs memory deallocation.   */
/*------------------------------------------------------------*/
/* INPUT ARGUMENTS :                            */
/*              _ None.              */
/*------------------------------------------------------------*/
/* OUTPUT ARGUMENTS :                           */
/*              _ None.              */
/*------------------------------------------------------------*/
/* INPUT/OUTPUT ARGUMENTS :                     */
/*              _ None.              */
/*------------------------------------------------------------*/
```

```
/* RETURN ARGUMENTS :                                    */
/*                    _ None.                      */
/*===================================================================*/


void    INI_deallocate_memory ( void )
        {
        /*--------------------------------------------------------*/
        /*      Memory Deallocation for Time-Domain Pre Filtering      */
        /*--------------------------------------------------------*/


        free_dvector (pre_flt_num, 0, PPR_FLT_ORDER-1);
        free_dvector (pre_flt_den, 0, PPR_FLT_ORDER-1);
        free_dvector (pre_flt_buf_z, 0, PPR_FLT_ORDER-1);
        free_dvector (pre_flt_buf_p, 0, PPR_FLT_ORDER-1);


        free_dvector (lp_flt_num, 0, LP_FLT_ORDER-1);
        free_dvector (lp_flt_buf, 0, LP_FLT_ORDER-1);


        /*--------------------------------------------------------*/
        /*    Memory Deallocation for Time-Domain Silence Enhancement   */
        /*--------------------------------------------------------*/


        free_svector (zeroed,      0, SE_MEM_SIZE-1);
        free_dvector (zero_rate, 0, SE_MEM_SIZE-1);
        free_dvector (low_rate,  0, SE_MEM_SIZE-1);
        free_dvector (high_rate, 0, SE_MEM_SIZE-1);


        free_dvector (low_neg, 0, 1);
        free_dvector (low_pos, 0, 1);


        /*--------------------------------------------------------*/
        /*    Memory Deallocation for Tilt compansation Post Filtering   */
        /*--------------------------------------------------------*/


        free_dvector (tc_buff_exc, 0, L_LPC-1);


        /*--------------------------------------------------------*/
        /*    Memory Deallocation for Time-Domain Post Filtering     */
        /*--------------------------------------------------------*/
```

```
free_dvector (buff_LTpost, 0, MAX_LAG+L_SF-1);
free_dvector (PF_mem_syn, 0, NP-1);


/*---------------------------------------------------------*/
/*      Memory Deallocation for Time-Domain Post Filtering      */
/*---------------------------------------------------------*/


free_dvector (pst_flt_num, 0, PPR_FLT_ORDER-1);
free_dvector (pst_flt_den, 0, PPR_FLT_ORDER-1);
free_dvector (pst_flt_buf_z, 0, PPR_FLT_ORDER-1);
free_dvector (pst_flt_buf_p, 0, PPR_FLT_ORDER-1);


/*---------------------------------------------------------*/
/*      Memory Deallocation for Linear Prediction Analysis      */
/*---------------------------------------------------------*/


free_dvector (siglpc,          0, L_LPC-1);
free_dvector (tilt_window, 0, L_LPC-1);
free_dvector (lpc_window,       0, L_LPC-1);
free_dvector (lpc_window1,      0, L_LPC-1);
free_dvector (lpc_window2, 0, L_LPC-1);
free_dvector (bwe_factor,  0, NP);


free_dvector (rxx,  0, NP);
free_dmatrix (refl, 0, N_SF_MAX, 0, NP-1);
free_dvector (lsf_new, 0, NP-1);
free_dvector (lsf_old, 0, NP-1);
free_dvector (lsf_mid, 0, NP-1);


free_dvector (IntLSF_C, 0, N_SF4-1);


free_dmatrix (pdcf, 0, N_SF_MAX, 0, NP-1);
free_dmatrix (pdcfq, 0, N_SF_MAX, 0, NP-1);
free_dmatrix (pdcfq_dec, 0, N_SF_MAX, 0, NP-1);


/*---------------------------------------------------------*/
/*      Memory Allocation for the LSF quantization      */
/*---------------------------------------------------------*/
```

```
free_d3tensor (lsf_cb_08k, 0, MAXLTT_08k-1, 0,LMSMAX_08k-1,
                                    0, MAXLNp -1);
free_d3tensor (lsf_cb_40k, 0, MAXLTT_40k-1, 0,LMSMAX_40k-1,
                                    0, MAXLNp -1);
free_d3tensor (lsf_cb_85k, 0, MAXLTT_85k-1, 0,LMSMAX_85k-1,
                                    0, MAXLNp -1);


free_svector (stage_cand_08k, 0, 2);
free_svector (stage_cand_40k, 0, 3);
free_svector (stage_cand_85k, 0, 3);


free_svector (MS_08k, 0, LTT_08k-1);
free_svector (MS_40k, 0, LTT_40k-1);
free_svector (MS_85k, 0, LTT_85k-1);


free_dmatrix (qes,            0, LQMA_40k-1, 0, NP-1);
free_dmatrix (qes_dec, 0, LQMA_40k-1, 0, NP-1);


free_dvector (last_qlsf, 0, NP-1);
free_dvector (lsfq_old, 0, NP-1);
free_dvector (lsfq_old_dec, 0, NP-1);
free_dvector (Mean,       0, NP-1);


free_dvector (lsfq_mem_dec, 0, NP-1);
free_dvector (lsfq_mem_enc, 0, NP-1);


/*--------------------------------------------------------------*/
/*        Memory Deallocation for Perceptual Weighting      */
/*--------------------------------------------------------------*/


free_dvector (wspeech,            0, L_OLPIT-1);
free_dvector (wspeech_mem, 0, NP-1);
free_dmatrix (wpdcf_pole,  0, N_SF_MAX, 0, NP-1);
free_dmatrix (wpdcf_zero,  0, N_SF_MAX, 0, NP-1);
free_dvector (tmp_ws_m,        0, NP-1);
free_dvector (ModiSig_m,       0, NP-1);


/*--------------------------------------------------------------*/
/* Memory Deallocation for Impulse Response of the synthesis filter */
/*--------------------------------------------------------------*/
```

```
/*------------------------------------------------------------------*/
/*       Memory Deallocation for Signal Classification        */
/*------------------------------------------------------------------*/


free_svector (frame_class_mem, 0, CLA_MEM_SIZE-1);
free_svector (onstplsv_mem,      0, CLA_MEM_SIZE-1);
free_svector (voiced_mem,              0, CLA_MEM_SIZE-1);


free_dvector (buffer_cla, 0, L_FRM+MEM_CLASS+L_LPCLHD-1);
free_dvector (Lp_buffer, 0, N_Lp-1);


free_dvector (window1, 0, LPC_WIN1-1);


free_dmatrix (P_w, 0, 1, 0, SLOPE_MAX_SIZE-1);


free_dvector (buffer_refl0, 0, CLA_MEM_SIZE-1);


free_dvector (buffer_wtilt,       0, MAX_N_SF-1);
free_dvector (buffer_wmax,            0, MAX_N_SF-1);
free_dvector (buffer_wRp,             0, MAX_N_SF-1);
free_dvector (buffer_max_cla,     0, MAX_N_SF-1);


/*------------------------------------------------------------------*/
/*       Memory Deallocation for Voice Activity Detection        */
/*------------------------------------------------------------------*/


free_svector (lag_buf,     0, LTP_BUFF_SIZE-1);
free_dvector (pgain_buf,  0, LTP_BUFF_SIZE-1);


free_svector (flag_vad_mem,       0, FLAG_VAD_MEM_SIZE-1);
free_dmatrix (vad_lsf_mem,            0, VAD_MEM_SIZE-1, 0, NP-1);
free_dvector (min_energy_mem,  0, VAD_MIN_MEM_SIZE-1);
free_dvector (mean_lsf,          0, NP-1);
free_dvector (norm_mean_lsf,     0, NP-1);


free_dvector (prev_cml_lsf_diff,  0, VAD_MEM_SIZE-1);
free_dvector (prev_energy,            0, VAD_MEM_SIZE-1);


/*------------------------------------------------------------------*/
```

```
/*      Memory Deallocation for Smoothing parameters estimation      */
/*-----------------------------------------------------------------*/


    free_dvector (lsf_smooth, 0, NP-1);


    free_svector (N_sub, 0, N_SF_MAX-1);
    free_dvector (lsf_old_smo, 0, NP-1);
    free_dvector (ma_lsf, 0, NP-1);
    free_dvector (dSP_buf, 0, DSP_BUFF_SIZE-1);;


    free_dvector (buffer_smo, 0, HI_LAG2+L_SF-1);
    free_dvector (buffer_sum_smo, 0, SMO_BUFF_SIZE-1);
    free_dvector (buffer_max_smo, 0, SMO_BUFF_SIZE-1);


/*-----------------------------------------------------------------*/
/*      Memory Deallocation for Open Loop Pitch Detection      */
/*-----------------------------------------------------------------*/


    free_svector (ol_lag,      0, N_SF_MAX);
    free_svector (lag,               0, N_SF_MAX);
    free_dvector (Rp_sub,      0, N_SF_MAX-1);


    free_dvector (SincWindows,       0, LEN_SINC_TAB-1);


    free_svector (PITmax0,    0, NUM_MAX_SRCH-1);
    free_dvector (Rmax0,      0, NUM_MAX_SRCH-1);


    free_dvector (pitch_f_mem, 0, PIT_F_MEM-1);


    free_dvector (PitLagTab5b,       0, LEN_PITCH_TAB_5BIT-1);
    free_dvector (PitLagTab7b,       0, LEN_PITCH_TAB_7BIT-1);
    free_dvector (PitLagTab8b,       0, LEN_PITCH_TAB_8BIT-1);


/*-----------------------------------------------------------------*/
/*      Memory Deallocation for Open Pitch Pre-processing      */
/*-----------------------------------------------------------------*/


    free_dvector (SincWindows_PP,   0, LEN_SINC_TAB_PP-1);
```

```
free_dvector (targ_mem, 0, MAX_LAG-1);


/*-----------------------------------------------------------*/
/*      Memory Deallocation for Closed Loop Pitch Detection     */
/*-----------------------------------------------------------*/


free_dvector (SincWindows_E,  0, LEN_SINC_TAB_E-1);


free_dvector (NewTg,       0, L_FRM+NP-1);
free_dvector (lag_f,       0, N_SF_MAX-1);
free_dvector (ext,              0, MAX_LAG+L_SF-1);


/*-----------------------------------------------------------*/
/*   Memory Allocation for Residual and target signal buffer    */
/*-----------------------------------------------------------*/



/*-----------------------------------------------------------*/
/*      Memory Deallocation for Short Term Algebraic Analysis    */
/*-----------------------------------------------------------*/


free_svector (MaxIdx, 0, MAXPN-1);


free_dmatrix (PHI,        0, L_SF-1,        0, L_SF-1);


free_smatrix(p_track_2_5_0, 0, 2-1, 0, 32-1);
free_smatrix(p_track_2_7_1, 0, 2-1, 0, 80-1);


free_s3tensor(p_track_3_2_80, 0, 16-1, 0, 3-1, 0, 4-1);
free_s3tensor(p_track_3_2_54, 0, 16-1, 0, 3-1, 0, 4-1);


free_smatrix(p_track_5_4_0, 0, 5-1, 0, 16-1);
free_smatrix(p_track_5_3_1, 0, 5-1, 0, 8-1);
free_smatrix(p_track_5_3_2, 0, 5-1, 0, 8-1);


free_smatrix(p_track_8_4_0, 0, 8-1, 0, 16-1);


free_dmatrix (unfcod,     0, 1, 0, L_SF-1);
free_dmatrix (fcod,       0, 1, 0, L_SF-1);
```

```
        free_dmatrix (qua_unfcod,        0, 1, 0, L_FRM-1);
        free_dmatrix (qua_fcod,   0, 1, 0, L_FRM-1);


        free_dmatrix (unfcod_dec,        0, 1, 0, L_SF-1);


        free_dvector (wsp_m, 0, L_WSP-1);


        free_dvector (hh_hf, 0, L_HF-1);


        /*-------------------------------------------------------*/
        /*      Memory Deallocation for Gain Vector Quantisation      */
        /*-------------------------------------------------------*/


        free_dmatrix (qua_gainQ, 0, 1, 0, N_SF_MAX-1);


        free_dvector (past_energyq_2d, 0, GVQ_VEC_SIZE_2D-1);
        free_dvector (past_energyq_3d, 0, GVQ_VEC_SIZE_3D-1);
        free_dvector (past_energyq_4d, 0, GVQ_VEC_SIZE_4D-1);


        free_dvector (gp_buf, 0, GP_BUF_SIZE-1);


        free_dvector (pred_energy_d38, 0, GVQ_VEC_SIZE_3D-1);
        free_dvector (pred_energy_d410, 0, GVQ_VEC_SIZE_4D-1);



        free_dvector (Prev_Beta_Pitch,0, BETA_BUF_SIZE-1);


        free_dvector (energy_pred_coeff_1, 0, GVQ_VEC_SIZE_3D-1);
        free_dvector (energy_pred_coeff_2, 0, GVQ_VEC_SIZE_3D-1);
        free_dvector (energy_pred_coeff_3, 0, GVQ_VEC_SIZE_3D-1);



        free_dvector (energy_pred_coeff4d_1, 0, GVQ_VEC_SIZE_4D-1);
        free_dvector (energy_pred_coeff4d_2, 0, GVQ_VEC_SIZE_4D-1);
        free_dvector (energy_pred_coeff4d_3, 0, GVQ_VEC_SIZE_4D-1);
        free_dvector (energy_pred_coeff4d_4, 0, GVQ_VEC_SIZE_4D-1);


        free_dmatrix (gain_cb_2_128,   0,MSMAX_2_128-1, 0, GVQ_VEC_SIZE_2D-1);
        free_dmatrix (gain_cb_2_128_8_5,0,MSMAX_2_128-1, 0, GVQ_VEC_SIZE_2D-1);
```

```
/*----------------------------------------------------------*/
/*          Memory Deallocation for bit stream              */
/*----------------------------------------------------------*/


free_svector(bitno0, 0, 3-1);
free_svector(bitno1, 0, 3-1);



/*----------------------------------------------------------*/
/*      Memory Deallocation for Frame Erasure Concealenement      */
/*----------------------------------------------------------*/


free_dvector (enrg_buff,  0, ERNG_MEM_SIZE-1);
free_dvector (ext_dec_mem, 0, MAX_LAG+L_SF-1);



/*----------------------------------------------------------*/
/*          Memory Deallocation for Speech Synthesis        */
/*----------------------------------------------------------*/


free_dvector (synth_mem,            0, NP-1);
free_dvector (synth_mem_dec,  0, NP-1);
free_dvector (dif_mem,              0, L_SF+NP-1);
free_dvector (target_mem,           0, NP-1);
free_dvector (qua_synth_mem,  0, NP-1);
free_dvector (qua_dif_mem,          0, L_SF+NP-1);
free_dvector (qua_target_mem, 0, NP-1);


free_dvector (qua_ext,     0, MAX_LAG+L_SF-1);
free_dvector (sigsyn_dec,            0, L_SF+NP-1);


free_dvector (ext_dec,               0, MAX_LAG+L_SF-1);


/*----------------------------------------------------------*/


return;


/*----------------------------------------------------------*/
}
```

```
/*-------------------------------------------------------------*/


/*===========================================================*/
/* FUNCTION : INI_parameters_setup ().                 */
/*-------------------------------------------------------------*/
/* PURPOSE  : Performs the encoder parameter initialisation.   */
/*-------------------------------------------------------------*/
/* INPUT ARGUMENTS :                              */
/*     _ (INT32  ) argc:  number of input parameters.        */
/*     _ (char *[]) argv:  pointer to the input parameters.    */
/*-------------------------------------------------------------*/
/* OUTPUT ARGUMENTS :                             */
/*     _ (FILE **) fp_speech_in:  input speech file.       */
/*     _ (FILE **) fp_bitstream:  input speech file.        */
/*     _ (FILE **) fp_mode:      input speech file.       */
/*     _ (FILE **) fp_signaling:  input speech file.       */
/*     _ (INT16 **) smv_mode:    SMV mode.              */
/*-------------------------------------------------------------*/
/* INPUT/OUTPUT ARGUMENTS :                          */
/*            _ None.                       */
/*-------------------------------------------------------------*/
/* RETURN ARGUMENTS :                             */
/*            _ None.                       */
/*===========================================================*/


void INI_parameters_setup (INT32 argc, char *argv [], FILE **fp_speech_in,
        FILE **fp_bitstream, FILE **fp_mode, FILE **fp_signaling,
        INT16 *smv_mode)
        {
        /*-------------------------------------------------------------*/


        INT16  i, non_switch_cnt;


        /*-------------------------------------------------------------*/
        /*                 Initialisation                */
        /*-------------------------------------------------------------*/


        *fp_speech_in   = NULL;
        *fp_bitstream   = NULL;
        *fp_mode              = NULL;
```

```
*fp_signaling    = NULL;


/*-----------------------------------------------------*/


if(argc < 5)
        {
        printf ("Usage: %s -m M [-f mode_file] [-s signaling_file] ",
                                argv[0]);
        printf (" input_speech_file output_bitstream_file\n");
        exit(1);
        }
else
        {
        i = 1;
        (*smv_mode) = 0;
        non_switch_cnt = 0;
        while (i < argc)
                {
                if (argv[i][0] != '-')
                        {
                        if (non_switch_cnt > 2)
                                nrerror("Usage: smv_enc -m M [-f mode_file]
                                [-s signaling_file] input_speech_file
                                        output_bitstream_file\n");

                        if (non_switch_cnt == 0)
                                {
                                *fp_speech_in = file_open_rb (argv[i]);
                                printf("Input speech file    : %s\n", argv[i]);
                                non_switch_cnt++;
                                }
                        else
                                {
                                *fp_bitstream = file_open_wb (argv[i]);
                                printf("Output bitstream file : %s\n", argv[i]);
                                non_switch_cnt++;
                                }
                        i++;
                        }
                else
```

```
                              {
                          switch(argv[i][1])
                                  {
                              case 'm':        i++;
                                              (*smv_mode) = atoi(argv[i]);
                                              if ((((*smv_mode) < 0) || ((*smv_mode) >
2))
                                                      {
                                                      printf("SMV mode = %hd (0, 1,
and
                                                          2 allowed)\n",
(*smv_mode));
                                                      exit(0);
                                                      }
                                              i++;
                                  break;

                              case 'f':  i++;
                                              *fp_mode = fopen(argv[i], "r");
                                              printf("Mode control file : %s\n", argv[i]);
                                              i++;
                                  break;

                              case 's':  i++;
                                              *fp_signaling = file_open_rb (argv[i]);
                                              printf("Signaling file : %s\n", argv[i]);
                                              i++;
                                  break;

                              default: printf ("Usage: %s -m M [-f mode_file] [-s signaling_file] ",
                                                                  argv[0]);
                                              printf (" input_speech_file
output_bitstream_file\n");

                                              exit(1);
                                  break;
                                  }
                              }
                          }
                      }
```

465

```
        /*-----------------------------------------------*/

        return;

        /*-----------------------------------------------*/
        }


/*-----------------------------------------------------*/


/*=====================================================================*/
/* FUNCTION  : INI_init_decoder ().                    */
/*-------------------------------------------------*/
/* PURPOSE   : Performs the encoder initialisation.          */
/*-------------------------------------------------*/
/* ALGORITHM :                          */
/*-------------------------------------------------*/
/* INPUT ARGUMENTS :                        */
/*              _ None.                  */
/*-------------------------------------------------*/
/* OUTPUT ARGUMENTS :                        */
/*              _ None.                  */
/*-------------------------------------------------*/
/* INPUT/OUTPUT ARGUMENTS :                      */
/*              _ None.                  */
/*-------------------------------------------------*/
/* RETURN ARGUMENTS :                        */
/*              _ None.                  */
/*=====================================================================*/


void INI_init_encoder(void)
        {
        /*-----------------------------------------------*/


        fix_rate = RATE8_5K;


        /*-----------------------------------------------*/


        BIT_init_lib ();
        PPR_silence_enhan_init ();
```

EP 1 214 706 B1

```
            PPR_filters_init ();
            VAD_init_lib ();
            CLA_init_lib ();
            PPP_init_lib ();
            PIT_init_lib ();
            GEQ_init_lib ();
            LPC_init_lib ();
            PWF_init_lib ();
            SMO_init_lib ();
            LSF_Q_init_lib ();
        SNR_init_lib();
            FCS_init_lib ();
            LTP_init_lib ();
            PRC_init_lib ();


        /*----------------------------------------------*/


        return;


        /*----------------------------------------------*/
        }


    /*----------------------------------------------------*/


    /*==================================================*/
    /* FUNCTION  : INI_init_decoder ().                 */
    /*----------------------------------------------*/
    /* PURPOSE   : Performs the decoder initialisation.     */
    /*----------------------------------------------*/
    /* ALGORITHM :                             */
    /*----------------------------------------------*/
    /* INPUT ARGUMENTS  :                      */
    /*            _ None.                 */
    /*----------------------------------------------*/
    /* OUTPUT ARGUMENTS :                      */
    /*            _ None.                 */
    /*----------------------------------------------*/
    /* INPUT/OUTPUT ARGUMENTS :                  */
    /*            _ None.                 */
    /*----------------------------------------------*/
```

467

```
/* RETURN ARGUMENTS :                              */
/*            _ None.                              */
/*==============================================================*/


void INI_init_decoder(void)
        {
        /*----------------------------------------------------*/


        fix_rate_mem = RATE8_5K;
        past_bfi = 0;
        ppast_bfi        = 0;
        bfi_caution = 0;
    nbfi_count  = MAX_BFI_COUNT;
        N_bfi = 0;
        bfh_oh = 0;


        /*----------------------------------------------------*/


        BIT_init_lib ();
        GEQ_init_lib ();
        PPR_filters_init ();
        LPC_init_lib ();
        LSF_Q_init_lib ();
        CLA_init_lib ();
        FCS_init_lib ();
        LTP_init_lib ();


        /*----------------------------------------------------*/


        return;


        /*----------------------------------------------------*/
        }


/*----------------------------------------------------*/


/*==============================================================*/
/*----------------------- END ----------------------*/
/*==============================================================*/
```

```
/*===========================================================================*/


/*=========================================================================*/
/* Conexant System Inc.                                    */
/* 4311 Jamboree Road                                      */
/* Newport Beach, CA 92660                                 */
/*---------------------------------------------------------*/
/* Copyright(C) 2000 Conexant System Inc.                  */
/*---------------------------------------------------------*/
/* ALL RIGHTS RESERVED:                                    */
/* No part of this software may be reproduced in any form or by any  */
/* means or used to make any derivative work (such as transformation */
/* or adaptation) without the authorisation of Conexant System Inc.  */
/*=======================================================================*/
/* PROTOTYPE FILE : lib_ini.h                              */
/*=======================================================================*/


/*----------------------------------------------------*/
/*--------------------------- FUNCTIONS ---------------------------*/
/*----------------------------------------------------*/


void INI_allocate_memory        (void);
void INI_deallocate_memory      (void);


void INI_parameters_setup       (INT32, char *[], FILE **, FILE **, FILE **,
                                             FILE **, INT16 *);


void INI_init_encoder           (void);
void INI_init_decoder           (void);



/*========================================================================*/
/*--------------------------- END ---------------------------*/
/*========================================================================*/
```

```
/*======================================================*/


/*====================================================*/
/* Conexant System Inc.                    */
/* 4311 Jamboree Road                      */
/* Newport Beach, CA 92660                  */
/*------------------------------------------*/
/* Copyright(C) 2000 Conexant System Inc.       */
/*------------------------------------------*/
/* ALL RIGHTS RESERVED:                     */
/* No part of this software may be reproduced in any form or by any  */
/* means or used to make any derivative work (such as transformation  */
/* or adaptation) without the authorisation of Conexant System Inc.  */
/*======================================================*/
/* LIBRARY: lib_io.c                       */
/*======================================================*/


/*------------------------------------------*/
/*---------------------- INCLUDE -----------------------*/
/*------------------------------------------*/


#include "typedef.h"

#include "main.h"
#include "const.h"

#include "mcutil.h"

#include "lib_io.h"
#include "lib_swb.h"


/*------------------------------------------*/
/*-------------------------- FUNCTIONS --------------------------*/
/*------------------------------------------*/


/*======================================================*/
/* FUNCTION     : IO_readsamples ().            */
/*------------------------------------------*/
/* PURPOSE      : This function reads one block from the input  */
/*                file.                      */
```

470

```
/*------------------------------------------------------------*/
/* INPUT ARGUMENTS :                              */
/*        _ (FILE *)   file_x: input file.              */
/*        _ (INT32)    N:    number of samples to be     */
/*                     extracted.                 */
/*------------------------------------------------------------*/
/* OUTPUT ARGUMENTS :                             */
/*        _ (FLOAT64 []) x:    extracted frame.          */
/*        _ (INT16  []) s_x:  extrac. frame short format.   */
/*------------------------------------------------------------*/
/* INPUT/OUTPUT ARGUMENTS :                          */
/*           _ None.                           */
/*------------------------------------------------------------*/
/* RETURN ARGUMENTS :                             */
/*           _ None.                           */
/*============================================================*/


INT32   IO_readsamples (FILE *file_x, INT16 s_x[], FLOAT64 x [], INT32 N)
          {
          /*------------------------------------------------------------*/


          INT32  rd_samp, i, r_val;


          /*------------------------------------------------------------*/


          rd_samp = fread(s_x, sizeof(INT16), N, file_x);


          /*------------------------------------------------------------*/


          if (rd_samp > 0)
               {
               for(i = 0; i < N; i++)
                    {

#ifdef BYTE_SWAP_INPUT

                    s_x[i] = byte_swap_int16(s_x[i]);
#endif

                    x [i] = (FLOAT64) s_x[i];
```

```
                         }


                   r_val = rd_samp;
                }
            else
                r_val = 0;


            /*------------------------------------------------------------*/


            return   r_val;


            /*------------------------------------------------------------*/

            }


    /*------------------------------------------------------------*/



    /*============================================================*/
    /* FUNCTION     : IO_writesamples ().                    */
    /*------------------------------------------------------------*/
    /* PURPOSE      : This function write one block into the output   */
    /*           file.                        */
    /*------------------------------------------------------------*/
    /* INPUT ARGUMENTS :                        */
    /*       _ (FILE *)    file_y: output file.              */
    /*       _ (INT32)    N:    number of samples to write.    */
    /*       _ (FLOAT64 []) y:    output frame.             */
    /*------------------------------------------------------------*/
    /* OUTPUT ARGUMENTS :                       */
    /*       _ (INT16 []) s_y:   output frame short format.   */
    /*------------------------------------------------------------*/
    /* INPUT/OUTPUT ARGUMENTS :                     */
    /*          _ None.                      */
    /*------------------------------------------------------------*/
    /* RETURN ARGUMENTS :                       */
    /*          _ None.                      */
    /*============================================================*/


    INT32   IO_writesamples (FILE *file_y, FLOAT64 y [], INT16 s_y[], INT32 N)
            {
            /*------------------------------------------------------------*/
```

```
INT32 i, wt_samp;
FLOAT64 tmp;


/*----------------------------------------------------------*/


for (i = 0; i < N; i++)
        {
        tmp = y[i];

        if(tmp >= 0.0)
                tmp += 0.5;
        else
                tmp -= 0.5;

        if(tmp > 32767.0)
                tmp = 32767.0;

        if(tmp < -32768.)
                tmp = -32768.;

        if((INT16)tmp < 0.0)
                s_y[i] = (INT16)tmp + 2;
        else
                s_y[i] = (INT16)tmp;

#ifdef BYTE_SWAP_OUTPUT

                s_y[i] = byte_swap_int16(s_y[i]);
#endif


        }

wt_samp = fwrite(s_y, sizeof(INT16), N, file_y);


/*----------------------------------------------------------*/


#ifdef VERBOSE
        if (wt_samp != N)
                nrerror("Error Writing output Samples!");
```

```
#endif

        /*------------------------------------------------*/

        return   wt_samp;

        /*------------------------------------------------*/
        }


    /*------------------------------------------------------*/


/*==========================================================================*/
/*------------------------- END -----------------------------*/
/*==========================================================================*/



/*==========================================================================*/


/*==========================================================================*/
/* Conexant System Inc.                        */
/* 4311 Jamboree Road                          */
/* Newport Beach, CA 92660                       */
/*------------------------------------------------------*/
/* Copyright(C) 2000 Conexant System Inc.             */
/*------------------------------------------------------*/
/* ALL RIGHTS RESERVED:                         */
/* No part of this software may be reproduced in any form or by any  */
/* means or used to make any derivative work (such as transformation */
/* or adaptation) without the authorisation of Conexant System Inc.  */
/*==========================================================================*/
/* PROTOTYPE FILE: lib_io.h                      */
/*==========================================================================*/


    /*------------------------------------------------------*/
    /*------------------------- FUNCTIONS -----------------------------*/
    /*------------------------------------------------------*/


INT32   IO_readsamples  (FILE *, INT16    [], FLOAT64 [], INT32);
INT32   IO_writesamples (FILE *, FLOAT64 [], INT16        [], INT32);
```

```
/*======================================================================*/
/*------------------------------- END ----------------------------------*/
/*======================================================================*/
```

EP 1 214 706 B1

```
/*=================================================================*/


/*=================================================================*/
/* Conexant System Inc.                          */
/* 4311 Jamboree Road                            */
/* Newport Beach, CA 92660                        */
/*--------------------------------------------------*/
/* Copyright(C) 2000 Conexant System Inc.              */
/*--------------------------------------------------*/
/* ALL RIGHTS RESERVED:                          */
/* No part of this software may be reproduced in any form or by any  */
/* means or used to make any derivative work (such as transformation */
/* or adaptation) without the authorisation of Conexant System Inc.  */
/*=================================================================*/
/* LIBRARY: lib_lpc.c                          */
/*=================================================================*/


/*--------------------------------------------------*/
/*------------------------ INCLUDE ------------------------*/
/*--------------------------------------------------*/


#include "typedef.h"


#include "main.h"
#include "const.h"
#include "mcutil.h"
#include "gputil.h"
#include "ext_var.h"


#include "lib_flt.h"
#include "lib_lpc.h"


/*--------------------------------------------------*/
/*------------------------ DEFINE ------------------------*/
/*--------------------------------------------------*/


#define NB_BIS              5
#define MAX_LPC_ORDER       50
#define RESL               0.005
#define NBIS               6
```

476

```
#define  PI2                6.283185307179586


/*------------------------------------------------------------*/
/*------------------------ FUNCTIONS ----------------------------*/
/*------------------------------------------------------------*/


/*============================================================*/
/* FUNCTION    : LPC_init_lib ().                    */
/*------------------------------------------------------------*/
/* PURPOSE     : This function performs the initialisation of the */
/*          global variables of the LPC library.        */
/*------------------------------------------------------------*/
/* INPUT ARGUMENTS :                        */
/*             _ None.                  */
/*------------------------------------------------------------*/
/* OUTPUT ARGUMENTS :                        */
/*             _ None.                  */
/*------------------------------------------------------------*/
/* INPUT/OUTPUT ARGUMENTS :                     */
/*             _ None.                  */
/*------------------------------------------------------------*/
/* RETURN ARGUMENTS :                        */
/*             _ None.                  */
/*============================================================*/


void LPC_init_lib (void)
        {
        /*------------------------------------------------------------*/


        INT16   i, l;
        FLOAT64 x, y;


        /*------------------------------------------------------------*/
        /*          Generate the LPC Hamming window          */
        /*------------------------------------------------------------*/


        l = L_LPC/2;


        for (i = 0; i < l; i++)
                {
```

```
                    x = cos(i*PI/(FLOAT64)l);
                    lpc_window[i] = 0.54 - 0.46 * x;
                    }


        for (i = l; i < L_LPC; i++)
                {
                x = cos((i-l)*PI/(FLOAT64)(L_LPC-l));
                lpc_window[i] = 0.54+0.46 * x;
                }



        /*------------------------------------------------------*/
        /*      Generate the LPC Hamming window for the last sub-frame      */
        /*------------------------------------------------------*/


        l = L_LPC-(L_LPCLHD+L_SF4/2-10);

        for (i = 0; i < l; i++)
                {
                x = cos(i*PI/(FLOAT64)l);
                lpc_window1[i] = 0.54 - 0.46 * x;
                }


        for (i = l; i < L_LPC; i++)
                {
                x = cos((i-l)*PI/(FLOAT64)(L_LPC-l));
                lpc_window1[i] = 0.54+0.46 * x;
                }



        /*------------------------------------------------------*/
        /*              Generate the window for look ahead              */
        /*------------------------------------------------------*/


        l = L_LPC - L_LPCLHD/2;

        for (i = 0; i < l; i++)
                {
                x = cos(i*PI/(FLOAT64)l);
                lpc_window2[i] = 0.54-0.46 * x;
                }
```

```
   for (i = 1; i < L_LPC; i++)
           {
           x = cos((i-1)*0.48*PI/(FLOAT64)(L_LPC-1));
           lpc_window2[i] = x;
           }


   /*----------------------------------------------------*/
   /*      Generate the 60 Hz bandwidth expansion factor       */
   /*          with white noise correction factor          */
   /*----------------------------------------------------*/


   bwe_factor[0] = 1.0001;
   x = 2.0*PI*60.0/FS;
   for (i = 1; i < NP+1; i++)
           {
           y = -0.5*sqr(x*(FLOAT64)i);
           bwe_factor[i] = exp(y);
           }


   /*----------------------------------------------------*/


   erg      = 0.0;
   lpcgain = 0.0;


   /*----------------------------------------------------*/


   sub_lpcg = 0.0;


   /*----------------------------------------------------*/
   /*          LPC Adaptive Interpolation Coeffcients      */
   /*----------------------------------------------------*/


   IntLSF_C[0] = 0.5;
   IntLSF_C[1] = 0.6;
   IntLSF_C[2] = 0.7;
   IntLSF_C[3] = 0.8;


   /*----------------------------------------------------*/


   return;
```

```
    /*--------------------------------------------------*/
    }


    /*--------------------------------------------------------*/


    /*==================================================================*/
    /* FUNCTION    : LPC_analysis ().              */
    /*----------------------------------------------------*/
    /* PURPOSE     : This function performs windowing.        */
    /*----------------------------------------------------*/
    /* INPUT ARGUMENTS :                      */
    /*    _ (INT16  ) l_lpc:    LPC frame size.        */
    /*    _ (FLOAT64 []) sig:      input frame.        */
    /*    _ (FLOAT64 []) lpc_window:  analysis window.       */
    /*    _ (FLOAT64 []) bwe_factor:  bandwidth expansion      */
    /*    _ (INT16  ) Order:     prediction order.      */
    /*    _ (INT16  ) flag_flat:  flat speech flag.      */
    /*----------------------------------------------------*/
    /* OUTPUT ARGUMENTS :                      */
    /*    _ (FLOAT64 []) rxx:      autocrrelation function.   */
    /*    _ (FLOAT64 []) refl:     output reflection coeff.   */
    /*    _ (FLOAT64 *) pderr:     output LPC prediction error.  */
    /*    _ (FLOAT64 []) lpc_alpha:  output LP filter coeff.    */
    /*    _ (FLOAT64 []) lsf:      line spectrum frequencies.  */
    /*    _ (FLOAT64 *) lpc_gain:  output LPC gain.        */
    /*----------------------------------------------------*/
    /* INPUT/OUTPUT ARGUMENTS :                  */
    /*          _ None.               */
    /*----------------------------------------------------*/
    /* RETURN ARGUMENTS :                     */
    /*          _ None.             */
    /*==================================================================*/


void LPC_analysis (INT16 l_lpc, FLOAT64 sig [], FLOAT64 lpc_window [],
                FLOAT64 rxx[], FLOAT64 bwe_factor[], FLOAT64 refl [],
                FLOAT64 *pderr, FLOAT64 lpc_alpha [], FLOAT64 lsf [],
                INT16 LPC_ORDER, FLOAT64 *lpcgain, INT16 flag_flat)


        {
```

```
/*------------------------------------------------------------*/

FLOAT64 w, energy, val;
INT16 i;


/*------------------------------------------------------------*/


energy = 0.0;
for (i = 0; i < l_lpc; i++)
        energy += (INT16)sig[i]*(INT16)sig[i];


if(energy == 0.0)
        {
         ini_dvector (lpc_alpha, 0, LPC_ORDER-1, 0.0);


         ini_dvector (rxx, 0, LPC_ORDER, 0.0);


         ini_dvector (refl, 0, LPC_ORDER-1, 0.0);


         (*pderr) = 0.0;
         (*lpcgain) = -DBL_MAX;
        }
else
        {
         /*------------------------------------------------*/
         /*       Windowing for Linear Prediction Analysis      */
         /*------------------------------------------------*/


         mul_dvector (sig, lpc_window, siglpc, 0, l_lpc-1);


         /*------------------------------------------------*/
         /*            Autocorrelation Function             */
         /*------------------------------------------------*/


         LPC_autocorrelation (siglpc, l_lpc, rxx, (INT16)(LPC_ORDER+1));


         /*------------------------------------------------*/
         /*            Bandwidth Expansion                  */
         /*------------------------------------------------*/
```

```
        mul_dvector (rxx, bwe_factor, rxx, 0, LPC_ORDER);


        /*----------------------------------------------*/
        /*          Leroux-Gueguen Recursion            */
        /*----------------------------------------------*/


        LPC_leroux_gueguen (rxx, refl, pderr, LPC_ORDER);


        /*----------------------------------------------*/
        /*      PARCOR to prediction coefficient convertion    */
        /*----------------------------------------------*/


        LPC_refl2pred(refl, lpc_alpha, LPC_ORDER);


        /*----------------------------------------------*/
        /*              Bandwith expassion              */
        /*----------------------------------------------*/


        (*lpcgain) = -10.*log10((*pderr)/(rxx[0] + EPSI));


    /*----------------------------------------------*/

        if (flag_flat == 1)
                {
                if ((*lpcgain) < 10.0)
                        w = 0.995;
                else if ((*lpcgain) < 20.0)
                        w = 0.995;
                else
                        w = 0.995;
                }
        else
                {
                if ((*lpcgain) < 10.0)
                        w = 0.995;
                else
                        {
                        if ((*lpcgain) < 20.0)
                                w = 0.99;
                        else
```

```
                        w = 0.98;
                    }
                }

        /*------------------------------------------------*/


        val = 1.0;
        for (i = 0; i < LPC_ORDER; i++)
            {
            val *= w;
            lpc_alpha[i] *= val;
            }


        /*------------------------------------------------*/
    }


    /*------------------------------------------------*/
    /*          LPC to LSP CONVERSION              */
    /*------------------------------------------------*/

    LPC_lpctolsf (lpc_alpha, lsf, LPC_ORDER);


    /*------------------------------------------------*/


    return;


    /*------------------------------------------------*/
}

/*------------------------------------------------*/


/*================================================================*/
/* FUNCTION     : LPC_refl2pred ().                   */
/*------------------------------------------------*/
/* PURPOSE      : This function calculate the prediction coeff.   */
/*               using the PARCOR coefficients.            */
/*------------------------------------------------*/
/* INPUT ARGUMENTS :                              */
/*          _ (FLOAT64 []) refl    : output reflection coeff.   */
/*          _ (INT16   ) LPC_ORDER : LPC order.            */
```

```
/*------------------------------------------------*/
/* OUTPUT ARGUMENTS :                         */
/*        _ (FLOAT64 []) a   : output LP filter coeff.   */
/*------------------------------------------------*/
/* INPUT/OUTPUT ARGUMENTS :                      */
/*              _ None.                       */
/*------------------------------------------------*/
/* RETURN ARGUMENTS :                         */
/*              _ None.                       */
/*================================================*/


void     LPC_refl2pred (FLOAT64 refl [], FLOAT64 a [], INT16 LPC_ORDER)
         {
         /*------------------------------------------------*/


         INT32  m, n, j;


         FLOAT64      x;


         /*------------------------------------------------*/


         for (m = 0; m < LPC_ORDER; m ++)
              {
              /*------------------------------------------------*/


              a [m] = -refl[m];


              /*------------------------------------------------*/


              for (j = 0; j < m / 2; j ++)
                   {
                   n   = m - 1 - j;
                   x   = a[j] + refl[m] * a[n];
                   a[n] = a[n] + refl[m] * a[j];
                   a[j] = x;
                   }


              /*------------------------------------------------*/
              /*    Update the prediction coefficients every 2 cycles   */
              /*------------------------------------------------*/
```

```
              if (m & 1)
                    a[m/2] = a[m/2] + refl [m] * a[m/2];


              /*------------------------------------------------*/
              }


         /*------------------------------------------------*/


         return;                        .


         /*------------------------------------------------*/
         }


    /*------------------------------------------------*/


    /*================================================*/
    /* FUNCTION     : LPC_leroux_gueguen ().              */
    /*------------------------------------------------*/
    /* PURPOSE      : This function performs Leroux Gueguen recursion. */
    /*                                              */
    /* This subroutine implements a modified form of Durbin's     */
    /* algorithm for solving a set of auto-correlation equations. This */
    /* routine uses an intermediate variable which is constrained to   */
    /* be less than the energy of the signal, i.e. r [0]. This     */
    /* variable takes the role of the predictor coefficients which    */
    /* normally are used in Durbin's form of the algorithm. This     */
    /* routine returns only the reflection coefficients.          */
    /* Reference: J. Leroux and C.J. Gueguen, "A Fixed Point     */
    /*          Computation of the Partial Correlation       */
    /*          Coefficients", IEEE Trans. ASSP, June 1977,      */
    /*          pp. 257-259.                        */
    /*                                             */
    /* In the case that either numerical instability or an     */
    /* inappropriate auto-correlation vector results in a set of     */
    /* coefficients corresponding to an unstable filter at some stage  */
    /* in the recursion, this routine returns the coefficients as    */
    /* determined at the previous iteration. This is equivalent to    */
    /* truncating the auto-correlation coefficient at a point such    */
    /* that it is positive definite.                  */
```

```
/*----------------------------------------------------*/
/* INPUT ARGUMENTS :                           */
/*        _ (FLOAT64 []) r        : input autocorrelation.*/
/*        _ (INT16   ) LPC_ORDER : LPC order.          */
/*----------------------------------------------------*/
/* OUTPUT ARGUMENTS :                          */
/*        _ (FLOAT64 []) refl : output reflection coeff.  */
/*        _ (FLOAT64 *)  re  : output residual energy.   */
/*----------------------------------------------------*/
/* INPUT/OUTPUT ARGUMENTS :                        */
/*              _ None.                     */
/*----------------------------------------------------*/
/* RETURN ARGUMENTS :                          */
/*              _ None.                     */
/*==================================================*/


void    LPC_leroux_gueguen (FLOAT64 r [], FLOAT64 refl [], FLOAT64 *re,
                                            INT16 LPC_ORDER)
        {
        /*--------------------------------------------------*/


        INT32  k, i;

        FLOAT64.     rf, sum;
        FLOAT64      *ep, *en;

        /*--------------------------------------------------*/


        ep = dvector (0, LPC_ORDER-1);
        en = dvector (0, LPC_ORDER-1);

        /*--------------------------------------------------*/
        /*            Initialisation              */
        /*--------------------------------------------------*/


        (*re) = r[0];

        for (i = 0; i < LPC_ORDER; i++ )
                {
                ep[i] = r[i+1];
```

```
            en[i] = r[i];
        }


/*-----------------------------------------------------------*/
/*                  Algorithm                   */
/*-----------------------------------------------------------*/


for (k = 0; k < LPC_ORDER; k++)
        {
        /*-----------------------------------------------------------*/
        /*          Check for zero prediction error        */
        /*-----------------------------------------------------------*/


if ( (en[0] == 0.0) && (ep[k] == 0.0))
                        rf = 0.0;
else
                rf = -ep[k] / en[0];


        /*-----------------------------------------------------------*/
        /* Calculate the error (equivalent to re = re * (1-rf**2))       */
        /* A change in sign of PRERR means that rf has a magnitude  */
        /* greater than unity (corresponding to an unstable        */
        /* synthesis filter)                        */
        /*-----------------------------------------------------------*/


en [0] += rf * ep[k];


        if (en[0] < 0.0)
                        break;


(*re)            = en[0];


        /*-----------------------------------------------------------*/


        refl [k] = rf;
        if (k == (LPC_ORDER-1))
                        return;

        for (i = k+1; i < (LPC_ORDER-1); i++)
                        {
```

```
                    sum      = ep[i] + rf * en[i-k];
                    en [i-k] += rf * ep[i];
                    ep [i]    = sum;
                    }


            ep [LPC_ORDER-1]  += rf * en [LPC_ORDER-k-1];
                    }


            /*--------------------------------------------------------*/
            /*        Fixup for negative prediction error          */
            /*--------------------------------------------------------*/


            printf ("\nLPC_leroux_gueguen - negative error energy\n");


            for (i = k; i < LPC_ORDER; i++ )
                    refl [i] = 0.0;




            /*--------------------------------------------------------*/


            free_dvector (ep, 0, LPC_ORDER-1);
            free_dvector (en, 0, LPC_ORDER-1);


            /*--------------------------------------------------------*/


            return;


            /*--------------------------------------------------------*/
            }


    /*--------------------------------------------------------*/


    /*========================================================*/
    /* FUNCTION     : LPC_pred2refl ().                       */
    /*--------------------------------------------------------*/
    /* PURPOSE      : This function calculate the PARCOR coefficients */
    /*               using  the prediction coeff.             */
    /*--------------------------------------------------------*/
    /* INPUT ARGUMENTS :                                      */
    /*        _ (FLOAT64 []) a       : output LP filter coeff.   */
```

```
/*        _ (INT16   ) LPC_ORDER : LPC order.           */
/*-----------------------------------------------------*/
/* OUTPUT ARGUMENTS :                        */
/*        _ (FLOAT64 []) refl    : output reflection coeff.  */
/*-----------------------------------------------------*/
/* INPUT/OUTPUT ARGUMENTS :                      */
/*                _ None.                 */
/*-----------------------------------------------------*/
/* RETURN ARGUMENTS :                        */
/*                _ None.                 */
/*=====================================================*/


void LPC_pred2refl (FLOAT64 a [], FLOAT64 refl [], INT16 LPC_ORDER)
        {
        /*-----------------------------------------------*/


        FLOAT64     f[MAX_LPC_ORDER];


        INT16   m, j, n;
        FLOAT64     km, denom, x;


        /*-----------------------------------------------*/


        if (LPC_ORDER > MAX_LPC_ORDER)
                nrerror ("LPC order is too large!!!");


        /*-----------------------------------------------*/
        /*            Initialisation            */
        /*-----------------------------------------------*/


        cpy_dvector (a, f, 0, LPC_ORDER-1);


        /*-----------------------------------------------*/


        for (m = LPC_ORDER-1; m >= 0; m--)
                {
                km = f[m];
                if (km <= -1.0 || km >= 1.0)
                        {
                        printf("Nonstable reflection coeffs !!!\n");
```

```
                    return;

                    }


            refl [m] = -km;
            denom = 1.0/(1.0 - km * km);


            for (j = 0; j < m/2; j++)
                    {
                    n   = m - 1 - j;
                    x   = denom * f[j] + km * denom * f[n];
                    f[n] = denom * f[n] + km * denom * f[j];
                    f[j] = x;
                    }

            if (m & 1)
                            f[j] = denom * f[j] + km * denom * f[j];
                    }


        /*-------------------------------------------------------*/


        return;


        /*-------------------------------------------------------*/

        }


/*-------------------------------------------------------------*/


/*=============================================================*/
/* FUNCTION     : LPC_lpctolsf ().                    */
/*-------------------------------------------------------------*/
/* PURPOSE      : This function onvert predictor coefficients    */
/*               to LSF's.                              */
/*                                                      */
/*      The transfer function of the predictor filter is transformed */
/*      into two reciprocal polynomials having roots on the unit     */
/*      circle.  These roots of these polynomials interlace.  It is  */
/*      these roots that determine the line spectral frequencies. The*/
/*      two reciprocal polynomials are expressed as series expansions*/
/*      in Chebyshev polynomials with roots in the range -1 to +1.The*/
```

490

```
/*      inverse cosine of the roots of the Chebyshev polynomial    */
/*      expansion gives the line spectral frequencies.  If NPTS line */
/*      spectral frequencies are not found, this routine signals an  */
/*      error condition.                                  */
/*                                          */
/*----------------------------------------------------------*/
/* INPUT ARGUMENTS:                                */
/*    _ (FLOAT64 []) PRCOF:    Predictor coefficients.        */
/*    _ (INT16    ) LPC_ORDER : LPC order.                 */
/*    _ (INT16    ) NPTS:    Number of coefficients (at most 50)*/
/*----------------------------------------------------------*/
/* OUTPUT ARGUMENTS:                               */
/*    _ (FLOAT64 []) FRLSF:    line spectral frequencies (in   */
/*                    ascending order).            */
/*----------------------------------------------------------*/
/* INPUT/OUTPUT ARGUMENTS :                          */
/*                _ None.                    */
/*----------------------------------------------------------*/
/* RETURN ARGUMENTS :                              */
/*                _ None.                . */
/*==========================================================*/


void LPC_lpctolsf( FLOAT64 PRCOF[], FLOAT64 FRLSF[], INT16 NPTS)
        {
        /*----------------------------------------------------------*/


        INT16   NC[2], j, i, NF, IP;
        FLOAT64 F1[(MAX_LPC_ORDER+1)/2+1], F2[(MAX_LPC_ORDER+1)/2+1],
                T[2][(MAX_LPC_ORDER+1)/2+1];


        FLOAT64 XLOW,XMID,XHIGH,XINT,YLOW,YMID,YHIGH;


        /*----------------------------------------------------------*/


#ifdef VERBOSE
        if (NPTS > MAX_LPC_ORDER)
                nrerror("PTOLSF - Too many coefficients!!!!!");
#endif
```

```
/*-----------------------------------------------------*/
/* Determine the number of coefficients in each of the polynomials */
/*          with coefficients T(.,1) and T(.,2).          */
/*-----------------------------------------------------*/


if ( (NPTS % 2) != 0 )
        {
        NC[1] = (NPTS+1) / 2;
        NC[0] = NC [1] + 1;
        }
else
        {
        NC[1] = NPTS/2 + 1;
        NC[0] = NC[1];
        }


/*-----------------------------------------------------*/
/* Let D=z**(-1), the unit delay, then the predictor filter with   */
/* N coefficients is                                    */
/*                                                      */
/*        N     n                                       */
/*  P(D) = SUM p(n) D  .                                */
/*        n=1                                           */
/*                                                      */
/* The error filter polynomial is A(D)=1-P(D) with N+1 terms.     */
/* Two auxiliary polynomials * are formed from the error filter    */
/* polynomial,                                          */
/*  F1(D) = A(D) + D**(N+1) A(D**(-1))  (N+2 terms, symmetric)    */
/*  F2(D) = A(D) - D**(N+1) A(D**(-1))  (N+2 terms, anti-symmetric) */
/*                                                      */
/* Establish the symmetric polynomial F1(D) and the anti-symmetric  */
/* polynomial F2(D)                                     */
/* Only about half of the coefficients are evaluated since the     */
/* polynomials are symmetric and will later be reduced in order by  */
/* division by polynomials with roots at +1 and -1               */
/*-----------------------------------------------------*/


F1[0] = 1.0;
j = NPTS-1;
for (i = 1; i < NC[0]; i++)
```

```
                        {
                        F1[i] = -PRCOF[i-1] - PRCOF[j];
                        j = j - 1;
                        }


    F2[0] = 1.0;
    j = NPTS-1;
    for (i = 1; i < NC[1]; i++)
                {
                F2[i] = -PRCOF[i-1] + PRCOF[j];
                j = j - 1;
                }


    /*-------------------------------------------------------------*/
    /* N even,  F1(D) includes a factor 1+D,                  */
    /*        F2(D) includes a factor 1-D                     */
    /* N odd,  F2(D) includes a factor 1-D**2                 */
    /* Divide out these factors, leaving even order symmetric      */
    /* polynomials, M is the total number of terms and Nc is the number */
    /* of unique terms,                           */
    /*  N      polynomial      M      Nc=(M+1)/2         */
    /* even,  G1(D) = F1(D)/(1+D)    N+1       N/2+1          */
    /*        G2(D) = F2(D)/(1-D)    N+1       N/2+1          */
    /* odd,   G1(D) = F1(D)         N+2      (N+1)/2+1        */
    /*        G2(D) = F2(D)/(1-D**2)  N       (N+1)/2         */
    /*-------------------------------------------------------------*/


    if ( (NPTS % 2) != 0)
                for (i = 2; i < NC[1]; i++)
                        F2[i] = F2[i] + F2[i-2];
    else
                for (i = 1; i < NC[0]; i++)
                        {
                        F1[i] = F1[i] - F1[i-1];
                        F2[i] = F2[i] + F2[i-1];
                        }


    /*-------------------------------------------------------------*/
    /* To look for roots on the unit circle, G1(D) and G2(D) are     */
    /* evaluated for D=exp(ja).  Since G1(D) and G2(D) are symmetric,  */
```

```
/* they can be expressed in terms of a series in cos(na) for D on   */
/* the unit circle.  Since M is odd and D=exp(ja)                    */
/*                                                                   */
/*        M-1      n                                                 */
/*  G1(D) = SUM f1(n) D         (symmetric, f1(n) = f1(M-1-n))  */
/*        n=0                                                        */
/*                       Mh-1            .                           */
/*        = exp(j Mh a) [ f1(Mh) + 2 SUM f1(n) cos((Mh-n)a) ]    */
/*                       n=0                                        */
/*                     Mh                                           */
/*        = exp(j Mh a) SUM t1(n) cos(na) ,                  */
/*                     n=0                                          */
/*                                                                  */
/* where Mh=(M-1)/2=Nc-1.  The Nc=Mh+1 coefficients t1(n) are    */
/* defined as                                                       */
/*  t1(n) =  f1(Nc-1) ,   n=0,                           */
/*        = 2 f1(Nc-1-n) ,  n=1,...,Nc-1.                    */
/* The next step is to identify cos(na) with the Chebyshev polynomial*/
/* T(n,x).  The Chebyshev polynomials satisfy T(n,cos(x)) = cos(nx). */
/* Then omitting the exponential delay term which does not affect the*/
/* positions of the roots on the unit circle, the series expansion in*/
/* terms of Chebyshev polynomials is                                */
/*                                                                  */
/*         Nc-1                                                     */
/*  T1(x) = SUM t1(n) T(n,x)                           */
/*         n=0                                                      */
/*                                                                  */
/* The domain of T1(x) is -1 < x < +1.  For a given root of T1(x),  */
/* say x0, the corresponding position of the root of F1(D) on the   */
/* unit circle is exp(j arccos(x0)).                       */
/*                                                                  */
/* Establish the coefficients of the series expansion in Chebyshev  */
/* polynomials                                              */
/*-----------------------------------------------------------------*/


T[0][0] = F1[NC[0]-1];
j = NC[0]-2;
for (i = 1; i < NC[0]; i++)
        {
        T[0][i] = 2.0*F1[j];
```

```
                    j = j - 1;
                    }


T[1][0] = F2[NC[1]-1];
j = NC[1]-2;
for (i = 1; i < NC[1]; i++)
               {
               T[1][i] = 2.0*F2[j];
               j = j - 1;
               }


/*------------------------------------------------------------*/
/* Sample at equally spaced intervals between -1 and 1 to look for  */
/* sign changes.  RESL is chosen small enough to avoid problems with */
/* multiple roots in an interval.  After detecting a sign change,   */
/* successive bisections and linear interpolation are used to find   */
/* roots corresponding to LSF frequencies. Since the roots of the   */
/* two polynomials interlace, the search alternates between the    */
/* polynomials T(.,1) and T(.,2).IP is either 1 or 2 depending on   */
/* which polynomial is being examined.                 */
/*------------------------------------------------------------*/


NF = 0;
IP = 0;
XLOW = 1.0;
YLOW = LPC_chebyshev (XLOW,T[IP],NC[IP]);


while ((XLOW > -1.) &&  (NF < NPTS))
               {
               XHIGH = XLOW;
               YHIGH = YLOW;


               if ((XHIGH-RESL) > -1.0 )
                       XLOW = XHIGH-RESL;
               else
                       XLOW = -1.0;


               YLOW = LPC_chebyshev(XLOW,T[IP],NC[IP]);


               if (YLOW*YHIGH <= 0.0)
```

```
{
NF = NF + 1;


/*-------------------------------------------------*/
/* Bisections of the interval containing a sign change  */
/*-------------------------------------------------*/


for (i = 0; i < NBIS; i++)
        {
XMID = 0.5*(XLOW+XHIGH);
YMID = LPC_chebyshev(XMID,T[IP],NC[IP]);
if (YLOW*YMID <= 0.0)
            {
        YHIGH=YMID;
        XHIGH=XMID;
                }
else
            {
        YLOW=YMID;
        XLOW=XMID;
            }
            }


/*-------------------------------------------------*/
/* Linear interpolation in the subinterval with a sign  */
/* change (take care if YHIGH=YLOW=0)               */
/*-------------------------------------------------*/


if (YHIGH != YLOW)
        XINT = XLOW - YLOW*(XHIGH-XLOW)/(YHIGH-YLOW);
else
        XINT=0.5*(XLOW+XHIGH);


FRLSF[NF-1] = acos(XINT)/PI2;


/*-------------------------------------------------*/
/* Start the search for the roots of the next polynomial */
/* at the estimated location of the root just found    */
/*-------------------------------------------------*/
```

```
                    IP = 1 - IP;
                    XLOW = XINT;
                    YLOW = LPC_chebyshev (XLOW,T[IP],NC[IP]);
                }
            }


    /*----------------------------------------------------------------*/
    /*          Halt if NPTS frequencies have not been found      */
    /*----------------------------------------------------------------*/


#ifdef VERBOSE
        if (NF != NPTS)
                nrerror("LPC_lpctolsf - Too few frequencies computed");
#endif



    /*----------------------------------------------------------------*/


    return;


    /*----------------------------------------------------------------*/
    }


/*----------------------------------------------------------------*/



/*================================================================*/
/* FUNCTION     : LPC_chebyshev ().                    */
/*----------------------------------------------------------------*/
/* PURPOSE      :  Evaluate a series expansion in Chebyshev      */
/*                 polynomials.                          */
/*                                                       */
/*      The series expansion in Chebyshev polynomials is defined as */
/*                                                       */
/*          N-1                                          */
/*      Y(x) = SUM c(i) T(i,x) ,                         */
/*             i=0                                       */
/*                                                       */
/*      where Y(x) is the resulting value (Y(x) = CHEBPS(...)),    */
/*          N is the order of the expansion,            */
/*          c(i) is the coefficient for the i'th Chebyshev      */
```

```
/*          polynomial                          */
/*             (c(i) = COF(i+1)), and              */
/*        T(i,x) is the i'th order Chebyshev polynomial      */
/*            evaluated at x.                    */
/*     The Chebyshev polynomials satisfy the recursion       */
/*       T(i,x) = 2x T(i-1,x) - T(i-2,x),            */
/*     with the initial conditions T(0,x)=1 and T(1,x)=x.  This   */
/*     routine evaluates the expansion using a backward recursion  */
/*     to obtain a numerically stable solution.             */
/*                                      */
/*---------------------------------------------------------------*/
/* INPUT ARGUMENTS:                          */
/*    _ (FLOAT64  ) X:   Input value.              */
/*    _ (FLOAT64 []) COF:  Array of coefficient values. COF[i] is */
/*               the coefficient corresponding to the   */
/*               i-1'th order Chebyshev polynomial.       */
/*    _ (INT16    ) N:   Order of the polynomial and number of  */
/*               coefficients.                 */
/*---------------------------------------------------------------*/
/* OUTPUT ARGUMENTS:                          */
/*    _ None.                             */
/*---------------------------------------------------------------*/
/* INPUT/OUTPUT ARGUMENTS :                       */
/*    _ None.                             */
/*---------------------------------------------------------------*/
/* RETURN ARGUMENTS :                          */
/*    _ (FLOAT64  ) CHEBPS:   Predictor coefficients.       */
/*===============================================================*/


FLOAT64 LPC_chebyshev( FLOAT64 X, FLOAT64 COF[], INT16 N)
        {
        /*-------------------------------------------------------*/


        INT16   i;
        FLOAT64 B1, B0, B2, CHEBPS;


        /*-------------------------------------------------------*/
        /* Consider the backward recursion b(i,x)=2xb(i+1,x)-b(i+2,x)+c(i),  */
        /* with initial conditions b(N,x)=0 and b(N+1,x)=0.            */
        /* Then dropping the dependence on x, c(i)=b(i)-2xb(i+1)+b(i+2).    */
```

EP 1 214 706 B1

```
/*                                                    */
/*        N-1                                          */
/*  Y(x) = SUM c(i) T(i)                               */
/*        i=0                                          */
/*                                                    */
/*   N-1                                               */
/*  = SUM [b(i)-2xb(i+1)+b(i+2)] T(i)                  */
/*   i=0                                               */
/*                        N-1                          */
/*  = b(0)T(0)+b(1)T(1)-2xb(1)T(0) + SUM b(i)[T(i)-2xT(i-1)+T(i-2)]  */
/*                        i=2                          */
/* The term inside the sum is zero because of the recursive    */
/* relationship satisfied by the Chebyshev polynomials.  Then  */
/* substituting the values T(0)=1 and T(1)=x, Y(x) is expressed in   */
/* terms of the difference between b(0) and b(2) (errors in b(0) and */
/* b(2) tend to cancel),                               */
/*                                                    */
/*   Y(x) = b(0)-xb(1) = [b(0)-b(2)+c(0)] / 2          */
/*--------------------------------------------------------*/


B2 = 0.0;
B1 = 0.0;
B0 = 0.0;
for (i = N-1; i >= 0; i--)
        {
        B2 = B1;
        B1 = B0;
        B0 = (2.*X)*B1 - B2 + COF[i];
        }


CHEBPS = 0.5*(B0 - B2 + COF[0]);


        /*--------------------------------------------------------*/


return (CHEBPS);


        /*--------------------------------------------------------*/
}


/*--------------------------------------------------------*/
```

```
/*==============================================================*/
/* FUNCTION     : LPC_autocorrelation ().                        */
/*--------------------------------------------------------------*/
/* PURPOSE      : Calculate the correlation for a data sequence. */
/*                                                               */
/*     This subroutine calculates the auto-correlation for a     */
/*     given data vector.  Rxx(i) gives the auto-correlation at  */
/*     lag i, for i running from 0 to NTERM-1.                   */
/*                                                               */
/*          NX                                                   */
/*     Rxx(i) = SUM X(j) * X(j-i)                                */
/*           j=i                                                 */
/*                                                               */
/*     This algorithm requires                                  */
/*     (N+1)*(NX+N/2) multiplies and                            */
/*     (N+1)*(NX+N/2) adds.                                      */
/*                                                               */
/*--------------------------------------------------------------*/
/* INPUT ARGUMENTS:                                              */
/*   _ (FLOAT64 []) x:    Input data vector with NX elements.    */
/*   _ (INT16   ) L:    Number of data points.                  */
/*   _ (INT16   ) ORDER_1: Order of the polynomial and number of */
/*                   coefficients.                               */
/*--------------------------------------------------------------*/
/* OUTPUT ARGUMENTS:                                             */
/*   _ (FLOAT64 []) r:   Auto-correlation vector with ORDER_1    */
/*                   elements.                                   */
/*--------------------------------------------------------------*/
/* INPUT/OUTPUT ARGUMENTS :                                      */
/*   _ None.                                                     */
/*--------------------------------------------------------------*/
/* RETURN ARGUMENTS :                                            */
/*   _ None.                                                     */
/*==============================================================*/


void LPC_autocorrelation (FLOAT64 x[], INT16 L, FLOAT64 r[], INT16 ORDER_1)
    {
        /*--------------------------------------------------------------*/
```

```
INT16 i;

        /*------------------------------------------------------------*/

        for (i = 0; i < ORDER_1; i++ )
                dot_dvector(x, x+i, r+i, 0, (INT16)(L-i-1));

        /*------------------------------------------------------------*/

        return;

        /*------------------------------------------------------------*/
        }

/*------------------------------------------------------------*/


/*============================================================*/
/* FUNCTION      : LPC_ptoa ().                           */
/*------------------------------------------------------------*/
/* PURPOSE       : This function convert the prediction coeff. in  */
/*                 tha classical LP filter coefficients.      */
/*                                                       */
/*------------------------------------------------------------*/
/* INPUT ARGUMENTS:                                      */
/*    _ (FLOAT64 []) p:      prediction coeffcients.      */
/*    _ (INT16   ) LPC_ORDER:  order of the LPC.           */
/*------------------------------------------------------------*/
/* OUTPUT ARGUMENTS:                                     */
/*    _ (FLOAT64 []) a:      LP filter coefficients.      */
/*------------------------------------------------------------*/
/* INPUT/OUTPUT ARGUMENTS :                              */
/*    _ None.                                            */
/*------------------------------------------------------------*/
/* RETURN ARGUMENTS :                                    */
/*    _ None.                                            */
/*============================================================*/

void LPC_ptoa( FLOAT64 p[], FLOAT64 a[], INT16 LPC_ORDER)
        {
        /*------------------------------------------------------------*/
```

```
        INT16  i;


        /*--------------------------------------------------------*/


#ifdef VERBOSE
        if (LPC_ORDER > MAX_LPC_ORDER)
                nrerror("LPC order is too large in ptoa()!!!");
#endif


        /*--------------------------------------------------------*/


        a[0] = 1.;
        for (i = 0; i < LPC_ORDER; i++)
                a[i+1] = - p[i];


        /*--------------------------------------------------------*/


        return;


        /*--------------------------------------------------------*/
        }


/*----------------------------------------------------------------*/


/*================================================================*/
/* FUNCTION    : LPC_lsftop ().                        */
/*----------------------------------------------------*/
/* PURPOSE     : This function convert LSF's to predictor coeff. */
/*                                          */
/*  The line spectral frequencies are assumed to be frequencies    */
/*  corresponding to roots on the unit circle.  Alternate roots on */
/*  the unit circle belong to two polynomials.  These polynomials  */
/*  are formed by polynomial multiplication of factors representing */
/*  conjugate pairs of roots.  Additional factors are used to give  */
/*  a symmetric polynomial and an anti-symmetric polynomial.  The   */
/*  sum (divided by 2) of these polynomials gives the predictor     */
/*  polynomial.                              */
/*                                          */
/*----------------------------------------------------*/
```

```
/* INPUT ARGUMENTS:                                        */
/*    _ (FLOAT64 []) FRLSF:   Array of NPTS line spectral    */
/*                    frequencies (in ascending order).   */
/*                    Each line spectral frequency lies in */
/*                    the range 0 to 0.5.                 */
/*    _ (INT16   ) NPTS:   Number of coefficients (at most 50). */
/*------------------------------------------------------------*/
/* OUTPUT ARGUMENTS:                                       */
/*    _ (FLOAT64 []) PRCOF:  predictor coefficients.         */
/*------------------------------------------------------------*/
/* INPUT/OUTPUT ARGUMENTS :                                */
/*    _ None.                                             */
/*------------------------------------------------------------*/
/* RETURN ARGUMENTS :                                      */
/*    _ None.                                             */
/*============================================================*/


void LPC_lsftop( FLOAT64 FRLSF[], FLOAT64 PRCOF[], INT16 NPTS)
        {
        /*------------------------------------------------------------*/


        INT16 NC, i, M, k;


        FLOAT64 F1[(MAX_LPC_ORDER+1)/2 +1], F2[(MAX_LPC_ORDER/2)+1];
        FLOAT64 A, x;


        /*------------------------------------------------------------*/


        F1[0] = 1.0;
        F2[0] = 1.0;


        /*------------------------------------------------------------*/
        /* Each line spectral frequency w contributes a second order     */
        /* polynomial of the form Y(D)=1-2*cos(w)*D+D**2.  These polynomials */
        /* are formed for each frequency and then multiplied together.     */
        /* Alternate line spectral frequencies are used to form two       */
        /* polynomials with interlacing roots on the unit circle.  These two */
        /* polynomials are again multiplied by 1+D and 1-D if NPTS is even   */
        /* or by 1 and 1-D**2 if NPTS is odd.  This gives the symmetric and  */
        /* anti-symmetric polynomials that in turn are added to give the     */
```

```
/* predictor coefficients.                              */
/*----------------------------------------------------*/


#ifdef VERBOSE
        if (NPTS > MAX_LPC_ORDER)
                nrerror ("LSFTOP - Too many coefficients!!!");
#endif


        /*----------------------------------------------------*/
        /*    Form a symmetric F1(D) by multiplying together second order   */
        /*      polynomials corresponding to odd numbered LSF's             */
        /*----------------------------------------------------*/


        NC = 0;
        for (i = 0; i < NPTS; i += 2)
                {
                x = cos(PI2*FRLSF[i]);
                A = -2.0 * x;
                LPC_convsm(F1, &NC, A);
                }


        /*----------------------------------------------------*/
        /*    Form a symmetric F2(D) by multiplying together second order   */
        /*.      polynomials corresponding to even numbered LSF's           */
        /*----------------------------------------------------*/


        NC = 0;
        for (i = 1; i < NPTS; i += 2)
                {
                x = cos(PI2*FRLSF[i]);
                A = -2.0 * x;
                LPC_convsm(F2, &NC, A);
                }


        /*----------------------------------------------------*/
        /* Both F1(D) and F2(D) are symmetric, with leading coefficient   */
        /* equal to unity.  Exclusive of the leading coefficient, the     */
        /* number of coefficients needed to specify F1(D) and F2(D) is:   */
        /*  NPTS     F1(D)    F2(D)                              */
        /*  even    NPTS/2    NPTS/2                             */
```

```
/*   odd   (NPTS+1)/2   (NPTS-1)/2                              */
/*----------------------------------------------------------*/


if ( (NPTS % 2) != 0)
        {
        /*----------------------------------------------------------*/
        /* NPTS odd                                        */
        /* F2(D) is multiplied by the factor (1-D**2)          */
        /*----------------------------------------------------------*/


        M = (NPTS-1)/2;
        for (i = M; i >= 2; i--)
        F2[i] = F2[i] - F2[i-2];


        /*----------------------------------------------------------*/
        /* Form the predictor filter coefficients           */
        /* Note that F1(D) is symmetric and F2(D) is now       */
        /* anti-symmetric. Since only the first half of the      */
        /* coefficients are available, symmetries are used to get  */
        /* the other half.                                 */
        /*----------------------------------------------------------*/


        k = NPTS-1;
        for (i=0; i < M; i++ )
                {
                PRCOF[i] = -0.5*(F1[i+1] + F2[i+1]);
                PRCOF[k] = -0.5*(F1[i+1] - F2[i+1]);
                k = k - 1;
                }
        PRCOF[k] = -0.5*F1[k];
        }
else
        {
        /*----------------------------------------------------------*/
        /* NPTS even                                       */
        /* F1(D) is multiplied by the factor (1+D)            */
        /* F2(D) is multiplied by the factor (1-D)            */
        /*----------------------------------------------------------*/


M = NPTS/2;
```

```
for ( i=M; i >= 1; i-- )
        {
        F1[i]=F1[i]+F1[i-1];
        F2[i]=F2[i]-F2[i-1];
        }


        /*-------------------------------------------------*/
        /* Form the predictor filter coefficients          */
        /* Note that F1(D) is symmetric and F2(D) is now   */
        /* anti-symmetric.                                 */
        /*-------------------------------------------------*/

        k = NPTS - 1;
        for (i = 0; i < M; i++)
            {
            PRCOF[i]=-0.5*(F1[i+1]+F2[i+1]);
            PRCOF[k]=-0.5*(F1[i+1]-F2[i+1]);
            k = k - 1;
            }
        }


    /*-------------------------------------------------*/


    return;


    /*-------------------------------------------------*/
    }



/*-----------------------------------------------------*/


/*=====================================================*/
/* FUNCTION     : LPC_adptive_interp ().               */
/*-----------------------------------------------------*/
/* PURPOSE      : This function this function generates the LPC */
/*               coefficients by interpolating in a NON linear */
/*               way the lsf.                          */
/*-----------------------------------------------------*/
/* INPUT ARGUMENTS:                                    */
/*    _ (FLOAT64 []) lsf_1:   first set of lsf.        */
/*    _ (FLOAT64 []) lsf_2:   second set of lsf.       */
```

```
/*    _ (FLOAT64 []) lsf_old:  lsf from last frame.              */
/*    _ (INT16   *) int_idx:  codebook index.                    */
/*-------------------------------------------------------------*/
/* OUTPUT ARGUMENTS:                                             */
/*    _ (FLOAT64 **) pdcf:   predictor coefficients.             */
/*------------------------------------------------------------*/
/* INPUT/OUTPUT ARGUMENTS :                                        */
/*    _ None.                                                     */
/*-------------------------------------------------------------*/
/* RETURN ARGUMENTS :                                             */
/*    _ None.                                                       */
/*=======================================================================*/


void LPC_adptive_interp (FLOAT64 lsf [], FLOAT64 lsf1 [], FLOAT64 lsf_old [],
                                            FLOAT64 **pdcf, INT16 *int_idx)
        {
        /*---------------------------------------------------------*/

        FLOAT64 ref_lsf[NP], int_lsf[NP], dis, mindis, delta, val1, val2;
        INT16   i, k;

        /*---------------------------------------------------------*/
        /*              Middle lsf search                  */
        /*---------------------------------------------------------*/

        /*---------------------------------------------------------*/
        /*              Weights                  */
        /*---------------------------------------------------------*/

        int_lsf[0] = (1.0-lsf1[0]) * (1.0 - lsf1[1] + lsf1[0]);

        for (i = 1; i < NP-1; i++)
                {
                val1 = lsf1[i+1] - lsf1[i];
                val2 = lsf1[i]        - lsf1[i-1];
                delta = MIN(val1, val2);

                int_lsf[i] = (1.0 - lsf1[i]) * (1.0 - delta );
                }
```

```
delta = lsf1[NP-1]+lsf1[NP-2];
int_lsf[NP-1] = (1.0 - lsf1[NP-1]) * (1.0 - delta);


/*------------------------------------------------*/
/*                    Search                    */
/*------------------------------------------------*/


mindis = DBL_MAX;


for (k = 0; k < N_SF4; k++)
        {
        for (i = 0 ; i < NP ; i++)
                ref_lsf[i] = IntLSF_C[k]*lsf[i]+(1-IntLSF_C[k])*lsf_old[i];


        dis = 0.0;
        for (i = 0; i < NP; i++)
                dis += fabs(ref_lsf[i]-lsf1[i]) * int_lsf[i];


        if (dis < mindis)
                {
                mindis   = dis;
                *int_idx = k;
                }
        }


        /*------------------------------------------------*/


k = *int_idx;
for (i = 0; i < NP; i++)
        ref_lsf[i] = IntLSF_C[k]*lsf[i]+ (1-IntLSF_C[k])*lsf_old[i];


/*------------------------------------------------*/
/*      LSF to prediction coefficients convertion      */
/*------------------------------------------------*/


/*------------------------------------------------*/
/*                  Sub-frame #0                  */
/*------------------------------------------------*/


for (i = 0; i < NP; i++)
```

```
                int_lsf[i] = 0.5*(lsf_old[i]+ref_lsf[i]);


        LPC_lsftop(int_lsf, pdcf[0], NP);


        /*--------------------------------------------------*/
        /*              Sub-frame #1                  */
        /*--------------------------------------------------*/


        LPC_lsftop(ref_lsf,pdcf[1], NP);


        /*--------------------------------------------------*/
        /*              Sub-frame #2                  */
        /*--------------------------------------------------*/


        for (i = 0; i < NP; i++)
                int_lsf[i] = 0.5*(ref_lsf[i] + lsf[i]);


        LPC_lsftop(int_lsf, pdcf[2], NP);


        /*--------------------------------------------------*/
        /*              Sub-frame #1                  */
        /*--------------------------------------------------*/


        LPC_lsftop(lsf, pdcf[3], NP);


        /*--------------------------------------------------*/
        /*              Update the memories           */
        /*--------------------------------------------------*/


        cpy_dvector (lsf, lsf_old, 0, NP-1);


        /*--------------------------------------------------*/


        return;


        /*--------------------------------------------------*/
}


/*--------------------------------------------------*/
```

```
/*==================================================================*/
/* FUNCTION     : LPC_adptive_interp_dec ().                */
/*----------------------------------------------------------*/
/* PURPOSE      : This function this function generates the LPC   */
/*               coefficients by interpolating in a NON linear    */
/*               way the lsf.                               */
/*----------------------------------------------------------*/
/* INPUT ARGUMENTS:                                         */
/*     _ (FLOAT64 []) lsf_1:   first  set of lsf.               */
/*     _ (FLOAT64 []) lsf_old:  lsf from last frame.             */
/*     _ (INT16    *) int_idx:  codebook index.                  */
/*----------------------------------------------------------*/
/* OUTPUT ARGUMENTS:                                        */
/*     _ (FLOAT64 **) pdcf:   predictor coefficients.           */
/*----------------------------------------------------------*/
/* INPUT/OUTPUT ARGUMENTS :                                 */
/*     _ None.                                              */
/*----------------------------------------------------------*/
/* RETURN ARGUMENTS :                                       */
/*     _ None.                                              */
/*==================================================================*/


void LPC_adptive_interp_dec (FLOAT64 lsf [], FLOAT64 lsf_old [],
                                          FLOAT64 **pdcf, INT16 int_idx)
    {
        /*----------------------------------------------------------*/


        FLOAT64 ref_lsf[NP], int_lsf[NP];
        INT16   i;


        /*----------------------------------------------------------*/
        /*                  Middle LSF                         */
        /*----------------------------------------------------------*/


        for (i = 0; i < NP; i++)
                ref_lsf[i] = IntLSF_C[int_idx]*lsf[i] +
                                            (1-IntLSF_C[int_idx])*lsf_old[i];


        /*----------------------------------------------------------*/
        /*         LSF to prediction coefficients convertion       */
```

```
/*-------------------------------------------------*/


/*-------------------------------------------------*/
/*                Sub-frame #0                  */
/*-------------------------------------------------*/


for (i = 0; i < NP; i++)
        int_lsf[i] = 0.5*(lsf_old[i]+ref_lsf[i]);


LPC_lsftop(int_lsf, pdcf[0], NP);


/*-------------------------------------------------*/
/*                Sub-frame #1                  */
/*-------------------------------------------------*/


LPC_lsftop(ref_lsf, pdcf[1], NP);


/*-------------------------------------------------*/
/*                Sub-frame #2                  */
/*-------------------------------------------------*/


for (i = 0; i < NP; i++)
        int_lsf[i] = 0.5*(ref_lsf[i] + lsf[i]);


LPC_lsftop(int_lsf, pdcf[2], NP);


/*-------------------------------------------------*/
/*                Sub-frame #1                  */
/*-------------------------------------------------*/


LPC_lsftop(lsf, pdcf[3], NP);


/*-------------------------------------------------*/
/*           Update the memories                */
/*-------------------------------------------------*/


cpy_dvector (lsf, lsf_old, 0, NP-1);


/*-------------------------------------------------*/
```

```
        return;


        /*------------------------------------------------*/
        }


    /*------------------------------------------------------*/


    /*==================================================================*/
    /* FUNCTION     : LPC_interpolate_lpc_4to2 ().            */
    /*------------------------------------------------------*/
    /* PURPOSE      : This function this function generates the LPC   */
    /*                coefficients by interpolating the lsf          */
    /*                (frequency domain).                            */
    /*------------------------------------------------------*/
    /* INPUT ARGUMENTS:                                      */
    /*    _ (FLOAT64 []) lsf_1:   first  set of lsf.          */
    /*    _ (FLOAT64 []) lsf_2:   second set of lsf.          */
    /*    _ (FLOAT64 []) lsf_old: lsf from last frame.        */
    /*    _ (INT16    ) flag:   switch between interpolation coeff. */
    /*                    for quantized (1) or unquantized    */
    /*                      (0) LSF.                          */
    /*------------------------------------------------------*/
    /* OUTPUT ARGUMENTS:                                     */
    /*    _ (FLOAT64 **) pdcf:   predictor coefficients.      */
    /*------------------------------------------------------*/
    /* INPUT/OUTPUT ARGUMENTS :                              */
    /*    _ None.                                            */
    /*------------------------------------------------------*/
    /* RETURN ARGUMENTS :                                    */
    /*    _ None.                                            */
    /*==================================================================*/


    void LPC_interpolate_lpc_4to2 (FLOAT64 lsf_1 [], FLOAT64 lsf_2 [],
                              FLOAT64 lsf_old [], FLOAT64 **pdcf, INT16 flag)
        {
        /*------------------------------------------------*/


        INT16   i;
        FLOAT64 C;
        FLOAT64 tmpmem[NP];
```

```
/*------------------------------------------------------------*/
/*                    Sub-frame #1                         */
/*------------------------------------------------------------*/


if (flag == 1)
        {
        C = 60.0 / 160.0;
        for (i = 0; i < NP; i++)
                tmpmem[i] = C*lsf_1[i] + (1-C)*lsf_old[i];
        }
else
        {
        C = 60.0 / 80.0;
        for (i = 0; i < NP; i++)
                tmpmem[i] = (1-C)*lsf_old[i] + C*lsf_2[i];
        }


LPC_lsftop (tmpmem, pdcf[0], NP);


/*------------------------------------------------------------*/
/*                    Sub-frame #2                         */
/*------------------------------------------------------------*/


if (flag == 1)
        {
        C = (60.0 + 80.0) / 160.0;
        for (i = 0; i < NP; i++)
                tmpmem[i] = C*lsf_1[i] + (1-C)*lsf_old[i];
        }
else
        {
        C = 60.0 / 80.0;
        for (i = 0; i < NP; i++)
                tmpmem[i] = C*lsf_1[i] + (1-C)*lsf_2[i];

        LPC_lsftop (tmpmem, pdcf[1], NP);
        }


LPC_lsftop (tmpmem, pdcf[1], NP);
```

```
/*----------------------------------------------------*/
/*     Update the lsf for interpolation in the next coding frame   */
/*----------------------------------------------------*/


cpy_dvector (lsf_1, lsf_old, 0, NP-1);


/*----------------------------------------------------*/


return;


/*----------------------------------------------------*/
}


/*----------------------------------------------------*/


/*====================================================*/
/* FUNCTION     : LPC_interpolate_lpc_4to3 ().              */
/*----------------------------------------------------*/
/* PURPOSE      : This function this function generates the LPC   */
/*                coefficients by interpolating the lsf       */
/*                (frequency domain).                      */
/*----------------------------------------------------*/
/* INPUT ARGUMENTS:                                    */
/*    _ (FLOAT64 []) lsf_1:   first  set of lsf.           */
/*    _ (FLOAT64 []) lsf_2:   second set of lsf.            */
/*    _ (FLOAT64 []) lsf_old: lsf from last frame.           */
/*    _ (INT16   ) flag:   switch between interpolation coeff. */
/*                  for quantized (1) or unquantized    */
/*                  (0) LSF.                             */
/*----------------------------------------------------*/
/* OUTPUT ARGUMENTS:                                   */
/*    _ (FLOAT64 **) pdcf:   predictor coefficients.         */
/*----------------------------------------------------*/
/* INPUT/OUTPUT ARGUMENTS :                            */
/*    _ None.                                          */
/*----------------------------------------------------*/
/* RETURN ARGUMENTS :                                  */
/*    _ None.                                          */
/*====================================================*/
```

```
void LPC_interpolate_lpc_4to3 (FLOAT64 lsf_1 [], FLOAT64 lsf_2 [],

                                FLOAT64 lsf_old [], FLOAT64 **pdcf, INT16 flag)

        {
        /*--------------------------------------------------------*/


        INT16   i;
        FLOAT64 C;
    FLOAT64 tmpmem[NP];


        /*--------------------------------------------------------*/
        /*                   Sub-frame #1                   */
        /*--------------------------------------------------------*/


        if (flag == 1)
                {
                C = 46.5 / 160.0;
                for (i = 0; i < NP; i++)
                        tmpmem[i] = C*lsf_1[i] + (1-C)*lsf_old[i];
                }
        else
                {
                C = 46.5 / 80.0;
                for (i = 0; i < NP; i++)
                        tmpmem[i] = (1-C)*lsf_old[i] + C*lsf_2[i];    .
                }


        LPC_lsftop (tmpmem, pdcf[0], NP);


        /*--------------------------------------------------------*/
        /*                   Sub-frame #2                   */
        /*--------------------------------------------------------*/


        if (flag == 1)
                {
                C = (46.5 + 53.0) / 160.0;
                for (i = 0; i < NP; i++)
                        tmpmem[i] = C*lsf_1[i] + (1-C)*lsf_old[i];
                }
        else
```

```
                    {
                    C = 20.0 / 80.0;
                    for (i = 0; i < NP; i++)
                            tmpmem[i] = C*lsf_1[i] + (1-C)*lsf_2[i];


                    LPC_lsftop (tmpmem, pdcf[1], NP);
                    }


LPC_lsftop (tmpmem, pdcf[1], NP);


/*_____*/
/*                    Sub-frame #3                    */
/*_____*/


if (flag == 1)
        {
        C = (46.5 + 2.0*53.0) / 160.0;
        for (i = 0; i < NP; i++)
                tmpmem[i] = C*lsf_1[i] + (1-C)*lsf_old[i];
        }
else
        {
        C = (20.0 + 53.0) / 80.0;
        for (i = 0; i < NP; i++)
                tmpmem[i] = C*lsf_1[i] + (1-C)*lsf_2[i];
        }


LPC_lsftop (tmpmem, pdcf[2], NP);


/*_____*/
/*    Update the lsf for interpolation in the next coding frame    */
/*_____*/


cpy_dvector (lsf_1, lsf_old, 0, NP-1);


/*_____*/


return;


/*_____*/
```

```
        }

/*----------------------------------------------------517---------------*/


/*===============================================================*/
/* FUNCTION     : LPC_convsm ().                        */
/*----------------------------------------------------------------*/
/* PURPOSE      : This function convolve coefficients for      */
/*               symmetric polynomials.                   */
/*----------------------------------------------------------------*/
/* INPUT ARGUMENTS:                                */
/*     _ (INT16   *) N:      number of coefficients.        */
/*     _ (FLOAT64  ) A:      cosinusoidal coefficient.        */
/*----------------------------------------------------------------*/
/* OUTPUT ARGUMENTS:                               */
/*     _ None.                                */
/*----------------------------------------------------------------*/
/* INPUT/OUTPUT ARGUMENTS :                            */
/*     _ (FLOAT64 []) X:      input/outuput signal.         */
/*----------------------------------------------------------------*/
/* RETURN ARGUMENTS :                              */
/*     _ None.                                */
/*===============================================================*/

void LPC_convsm (FLOAT64 X[], INT16 *N, FLOAT64 A)
        {
        /*----------------------------------------------------------------*/

        INT16 k, n;

        /*----------------------------------------------------------------*/

        n = (*N);

        if (n >= 2)
                {
                X[n+1] = X[n-1];
                for (k = n+1; k >= 3; k--)
                        X[k] = X[k] + A * X[k-1] + X[k-2];
```

```
            X[2] = X[2] + A*X[1] + 1.0;
            X[1] = X[1] + A;
            }
    else if (n == 1)
            {
            X[2] = 2.0 + A*X[1];
            X[1] = X[1] + A;
            }
    else if (n == 0)
            X[1] = A;


    n = n + 1;


    (*N) = n;


    /*--------------------------------------------------------*/


    return;


    /*--------------------------------------------------------*/
    }


/*--------------------------------------------------------*/


/*========================================================================*/
/* FUNCTION     : LPC_ImpulseResponse ().                    */
/*--------------------------------------------------------*/
/* PURPOSE      : This function calculates the LPC synthesis     */
/*                 filter filter response including perceptual     */
/*                 weighting.                                */
/*--------------------------------------------------------*/
/* INPUT ARGUMENTS :                                  */
/*        _ (FLOAT64 []) wpdcf_zero: precetual filter numerator     */
/*                        coefficients.               */
/*        _ (FLOAT64 []) wpdcf_pole: precetual filter denominator   */
/*                        coefficients.               */
/*        _ (FLOAT64 []) pdcfq:     quantized prediction coeff.    */
/*        _ (INT16   ) l_sf:     sub-frame size.            */
/*--------------------------------------------------------*/
/* OUTPUT ARGUMENTS :                                 */
```

```
/*         _ (FLOAT64 []) hh:        impulse response.        */
/*-----------------------------------------------------------*/
/* INPUT/OUTPUT ARGUMENTS :                          */
/*              _ None.                          */
/*-----------------------------------------------------------*/
/* RETURN ARGUMENTS :                            */
/*              _ None.                          */
/*===========================================================*/


void LPC_ImpulseResponse (FLOAT64 hh[], FLOAT64 wpdcf_zero [],
                    FLOAT64 wpdcf_pole[], FLOAT64 pdcfq [],
                    INT16 l_sf)
        {
        /*-----------------------------------------------------*/

        FLOAT64       tmpmem[NP];

        /*-----------------------------------------------------*/

        ini_dvector (hh, 0, l_sf-1, 0.0);
        LPC_ptoa (wpdcf_zero, hh, NP);

        ini_dvector (tmpmem, 0, NP-1, 0.0);
        FLT_allsyn (hh, l_sf, pdcfq, NP, hh, tmpmem);

        ini_dvector (tmpmem, 0, NP-1, 0.0);
        FLT_allsyn (hh, l_sf, wpdcf_pole, NP, hh, tmpmem);

        /*-----------------------------------------------------*/


        return;

        /*-----------------------------------------------------*/
        }

/*-----------------------------------------------------------*/


/*===========================================================*/
/*---------------------- END ----------------------------*/
/*===========================================================*/
```

```
/*=====================================================*/


/*=====================================================*/
/* Conexant System Inc.                    */
/* 4311 Jamboree Road                      */
/* Newport Beach, CA 92660                  */
/*----------------------------------------------*/
/* Copyright(C) 2000 Conexant System Inc.         */
/*----------------------------------------------*/
/* ALL RIGHTS RESERVED:                     */
/* No part of this software may be reproduced in any form or by any */
/* means or used to make any derivative work (such as transformation */
/* or adaptation) without the authorisation of Conexant System Inc. */
/*=====================================================*/
/* PROTOTYPE FILE: lib_lpc.h                   */
/*=====================================================*/


/*----------------------------------------------*/
/*---------------------- FUNCTIONS ----------------------*/
/*----------------------------------------------*/


void    LPC_init_lib            (void);


void    LPC_analysis            (INT16, FLOAT64 [], FLOAT64 [], FLOAT64 [],
                                   FLOAT64 [], FLOAT64 [], FLOAT64 *, FLOAT64 [],
                                   FLOAT64 [], INT16, FLOAT64 *, INT16);


void    LPC_autocorrelation  (FLOAT64 [], INT16, FLOAT64 [], INT16);
void    LPC_leroux_gueguen      (FLOAT64 [], FLOAT64 [], FLOAT64 *, INT16);


void    LPC_refl2pred           (FLOAT64 [], FLOAT64 [], INT16);


void    LPC_lpctolsf            (FLOAT64 [], FLOAT64 [], INT16);
FLOAT64      LPC_chebyshev           (FLOAT64,  FLOAT64 [], INT16);


void    LPC_ptoa                    (FLOAT64 [], FLOAT64 [], INT16);
void    LPC_lsftop                  (FLOAT64 [], FLOAT64 [], INT16);


void    LPC_pred2refl           (FLOAT64 [], FLOAT64 [], INT16);
```

```
void    LPC_adptive_interp (FLOAT64 [], FLOAT64 [], FLOAT64 [], FLOAT64 **,
                                                            INT16 *);

void    LPC_adptive_interp_dec (FLOAT64 [], FLOAT64 [], FLOAT64 **, INT16);

void    LPC_interpolate_lpc_4to3 (FLOAT64 [], FLOAT64 [], FLOAT64 [],

        FLOAT64 **, INT16);
void    LPC_interpolate_lpc_4to2 (FLOAT64 [], FLOAT64 [], FLOAT64 [],

        FLOAT64 **, INT16);

void    LPC_convsm                      (FLOAT64 [], INT16 *, FLOAT64);

void    LPC_ImpulseResponse (FLOAT64 [], FLOAT64 [], FLOAT64 [], FLOAT64 [],
                                            INT16);
```

/*=========================================================================*/
/*------------------------------ END -----------------------------------*/
/*=========================================================================*/

```
/*===================================================================*/

/*===================================================================*/
/* Conexant System Inc.                    */
/* 4311 Jamboree Road                      */
/* Newport Beach, CA 92660                  */
/*----------------------------------------------*/
/* Copyright(C) 2000 Conexant System Inc.          */
/*----------------------------------------------*/
/* ALL RIGHTS RESERVED:                     */
/* No part of this software may be reproduced in any form or by any  */
/* means or used to make any derivative work (such as transformation */
/* or adaptation) without the authorisation of Conexant System Inc.  */
/*===================================================================*/
/* LIBRARY: lib_ltp.c                      */
/*===================================================================*/


/*----------------------------------------------*/
/*----------------------- INCLUDE ----------------------*/
/*----------------------------------------------*/


#include "typedef.h"

#include "main.h"
#include "const.h"
#include "gputil.h"
#include "mcutil.h"


#include "ext_var.h"

#include "lib_flt.h"
#include "lib_ltp.h"
#include "lib_pit.h"


/*----------------------------------------------*/
/*----------------------- FUNCTIONS ----------------------*/
/*----------------------------------------------*/


/*===================================================================*/
/* FUNCTION : LTP_init_lib ().                  */
```

```
/*----------------------------------------------------------------*/
/* PURPOSE   : This function initialise the gloval variable of the   */
/*        library LTP.                                   */
/*----------------------------------------------------------------*/
/* ALGORITHM :                                      */
/*----------------------------------------------------------------*/
/* INPUT ARGUMENTS :                                  */
/*               _ None.                            */
/*----------------------------------------------------------------*/
/* OUTPUT ARGUMENTS :                                 */
/*               _ None.                            */
/*----------------------------------------------------------------*/
/* INPUT/OUTPUT ARGUMENTS :                             */
/*               _ None.                            */
/*----------------------------------------------------------------*/
/* RETURN ARGUMENTS :                                 */
/*               _ None.                            */
/*================================================================*/


void LTP_init_lib (void)
        {
        /*--------------------------------------------------------*/


        ini_dvector(lag_f, 0, N_SF_MAX-1, 30.0);


        /*--------------------------------------------------------*/


        min_pit = MIN_LAG;
        max_pit = HI_LAG;

        LTP_Init_SincWindows  ();
        LTP_generate_PitLagTab();


        /*--------------------------------------------------------*/


        return;


        /*--------------------------------------------------------*/
        }
```

```
/*----------------------------------------------------------*/


/*==========================================================*/
/* FUNCTION : Hwind ().                              */
/*----------------------------------------------------------*/
/* PURPOSE   : This function returns a value of a Hamming window   */
/*        centered at WinLim.                        */
/*----------------------------------------------------------*/
/* ALGORITHM :                                  */
/*----------------------------------------------------------*/
/* INPUT ARGUMENTS :                   ,         */
/*        _ (INT16   ) WinLim: the center of the Hamming window.   */
/*        _ (FLOAT64 ) t:    the location of the value.      */
/*----------------------------------------------------------*/
/* OUTPUT ARGUMENTS :                          */
/*              _ None.                       */
/*----------------------------------------------------------*/
/* INPUT/OUTPUT ARGUMENTS :                        */
/*              _ None.                       */
/*----------------------------------------------------------*/
/* RETURN ARGUMENTS :                           */
/*        _ (FLOAT64 ) val:  hamming window value at t.      */
/*==========================================================*/



FLOAT64 Hwind (FLOAT64 t, INT16 WinLim)
        {
        /*----------------------------------------------------------*/


        FLOAT64 val, x;


        /*----------------------------------------------------------*/


        val = 0.0;


        if (fabs(t) <= WinLim)
                {
                x = cos(t*PI/WinLim);
                val = 0.54 + 0.46 * x;
                }
```

524

```
        /*----------------------------------------------------*/


        return   val;


        /*----------------------------------------------------*/
        }


    /*----------------------------------------------------*/


    /*==================================================================*/
    /* FUNCTION  :  sincFwin2 ().                    */
    /*----------------------------------------------------*/
    /* PURPOSE   : This function returns returns a value of a Hamming   */
    /*          windowed SINC function to interpolate a discrete     */
    /*          digital signal.                    */
    /*----------------------------------------------------*/
    /* ALGORITHM :                        */
    /*----------------------------------------------------*/
    /* INPUT ARGUMENTS :                      */
    /*       _ (INT16   ) WinLim: the center of the Hamming window.  */
    /*       _ (FLOAT64 ) t:    the location of the value.       */
    /*----------------------------------------------------*/
    /* OUTPUT ARGUMENTS :                     */
    /*          _ None.                    */
    /*----------------------------------------------------*/
    /* INPUT/OUTPUT ARGUMENTS :                   */
    /*          _ None.                    */
    /*----------------------------------------------------*/
    /* RETURN ARGUMENTS :                     */
    /*       _ (FLOAT64 ) F:    hamming window value at t.       */
    /*==================================================================*/



FLOAT64  sincFwin2(FLOAT64 t, INT16 WinLim)
        {
        /*----------------------------------------------------*/


        FLOAT64 x, num, den, sinc;
        FLOAT64 F;
```

```
        /*----------------------------------------------*/

        x = t;

        if (fabs(t) < 0.000001)
                F = 1.0;
        else
                {
                if (WinLim <= 6)
                        {
                        num = sin(x*PI*0.9);
                        den = PI*x*0.9;
                        sinc = num / den;
                        F = Hwind(t,WinLim) * sinc;
                        }
                else
                        {
                        num = sin(x*PI*0.95);
                        den = PI*x*0.95;
                        sinc = num / den;
                        F = Hwind(t,WinLim) * sinc;
                        }
                }

        /*----------------------------------------------*/

        return F;

        /*----------------------------------------------*/
        }



/*================================================================*/
/* FUNCTION  : sincFwin ().                        */
/*----------------------------------------------*/
/* PURPOSE   : This function returns returns a value of a Hamming    */
/*        windowed SINC function to interpolate a discrete      */
/*        digital signal.                          */
```

```
/*------------------------------------------------*/
/* ALGORITHM :                              */
/*------------------------------------------------*/
/* INPUT ARGUMENTS :                        */
/*      _ (INT16   ) WinLim: the center of the Hamming window.  */
/*      _ (FLOAT64 ) t:    the location of the value.       */
/*------------------------------------------------*/
/* OUTPUT ARGUMENTS :                       */
/*            _ None.                  */
/*------------------------------------------------*/
/* INPUT/OUTPUT ARGUMENTS :                     */
/*            _ None.                  */
/*------------------------------------------------*/
/* RETURN ARGUMENTS :                       */
/*      _ (FLOAT64 ) F:    hamming window valuea at t.      */
/*================================================*/


FLOAT64  sincFwin(FLOAT64 t, INT16 WinLim)
        {
        /*------------------------------------------------*/

        FLOAT64 x, num, den, sinc;
        FLOAT64 F;

        /*------------------------------------------------*/

        x = t;
        if (fabs(t) < 0.000001)
                F = 1.0;
        else
                {
                num = sin(x*PI);
                den = PI*x;
                sinc = num / den;
                F = Hwind(t,WinLim) * sinc;
                }

        /*------------------------------------------------*/
```

527

```
        return F;


        /*--------------------------------------------------*/
        }


    /*------------------------------------------------------*/



    /*======================================================*/
    /* FUNCTION  :  D2A_InterpWeight ().                    */
    /*------------------------------------------------------*/
    /* PURPOSE   : This function produces a weighting function w[] for  */
    /*        the purpose of interpolating signal.                      */
    /*------------------------------------------------------*/
    /* ALGORITHM :                                          */
    /*------------------------------------------------------*/
    /* INPUT ARGUMENTS  :                                   */
    /*        _ (INT16    ) WinLim : half Weighting function length.  */
    /*        _ (FLOAT64   ) f :    Interpolation fractional value.  */
    /*------------------------------------------------------*/
    /* OUTPUT ARGUMENTS :                                   */
    /*        _ (FLOAT64 []) w :    Weighting function.     */
    /*------------------------------------------------------*/
    /* INPUT/OUTPUT ARGUMENTS :                             */
    /*            _ None.                                   */
    /*------------------------------------------------------*/
    /* RETURN ARGUMENTS :                                   */
    /*            _ None.                                   */
    /*======================================================*/


    void D2A_InterpWeight (FLOAT64 w[], FLOAT64 f, INT16 WinLim)
        {
        /*--------------------------------------------------*/


        INT16  k;
        FLOAT64       C;


        /*--------------------------------------------------*/
        /*            Sinc Function                         */
        /*--------------------------------------------------*/
```

```
            for (k = 0; k < 2*WinLim; k++)
                    w[k] = sincFwin((f+WinLim-1-k), WinLim);


            /*--------------------------------------------------*/
            /*                  Normalization                 */
            /*--------------------------------------------------*/

            C = 0;
            for (k = 0; k < 2*WinLim; k++)
                    C += w[k];
            C = 1.0/MAX(C, 0.1);


            for (k = 0; k < 2*WinLim; k++)
                    w[k] *= C;




            /*--------------------------------------------------*/


            return;


            /*--------------------------------------------------*/
            }




/*--------------------------------------------------------------*/


/*===============================================================*/
/* FUNCTION  :  D2A_InterpWeight2 ().                    */
/*--------------------------------------------------*/
/* PURPOSE   : This function produces a weighting function w[] for  */
/*          the purpose of interpolating signal.          */
/*--------------------------------------------------*/
/* ALGORITHM :                                    */
/*--------------------------------------------------*/
/* INPUT ARGUMENTS  :                             */
/*          _ (INT16    ) WinLim : half Weighting function length.  */
/*          _ (FLOAT64  ) f :    Interpolation fractional value.  */
/*--------------------------------------------------*/
/* OUTPUT ARGUMENTS :                             */
/*          _ (FLOAT64 []) w :    Weighting function.        */
```

```
/*------------------------------------------------*/
/* INPUT/OUTPUT ARGUMENTS :                        */
/*              _ None.                            */
/*------------------------------------------------*/
/* RETURN ARGUMENTS :                              */
/*              _ None.                            */
/*================================================*/


void D2A_InterpWeight2(FLOAT64 w[],FLOAT64 f,INT16 WinLim)
         {
         /*------------------------------------------------*/


         INT16  k;
         FLOAT64       C;


         /*------------------------------------------------*/
         /*            Sinc Function            */
         /*------------------------------------------------*/


         for (k = 0; k < 2*WinLim; k++)
                 w[k] = sincFwin2((f+WinLim-1-k), WinLim);


         /*------------------------------------------------*/
         /*            Normalization            */
         /*------------------------------------------------*/


         C = 0;
         for (k = 0; k < 2*WinLim; k++)
                 C += w[k];


         C = 1.0/MAX(C, 0.1);
         for (k = 0; k < 2*WinLim; k++)
                 w[k] *= C;


         /*------------------------------------------------*/


         return;


         /*------------------------------------------------*/
         }
```

```
/*---------------------------------------------------------*/

/*=========================================================*/
/* FUNCTION :  D2A_interp ().                       */
/*---------------------------------------------------------*/
/* PURPOSE   : This function produces a interpolation of digital   */
/*        signal to return the signal value between two samples */
/*                                            */
/*---------------------------------------------------------*/
/* ALGORITHM :                               */
/*---------------------------------------------------------*/
/* INPUT ARGUMENTS :                            */
/*      _ (FLOAT64 []) w :    Weighting function.         */
/*      _ (FLOAT64 []) s :    signal.                */
/*      _ (INT16    ) WinLim : half Weighting function length.  */
/*      _ (INT16    ) Len  :  Length of signal.           */
/*      _ (FLOAT64  ) t :    Time point of the signal value   */
/*                  between two samples.          */
/*---------------------------------------------------------*/
/* OUTPUT ARGUMENTS :                           */
/*            _ None.                      */
/*---------------------------------------------------------*/
/* INPUT/OUTPUT ARGUMENTS :                        */
/*            _ None.                      */
/*---------------------------------------------------------*/
/* RETURN ARGUMENTS :                          */
/*      _ (FLOAT64  ) X :    Interpolated signal sample.     */
/*=========================================================*/


FLOAT64 D2A_interp (FLOAT64 w[],FLOAT64 s[],INT16 Len,FLOAT64 t,INT16 WinLim)
       {
       /*---------------------------------------------------------*/


       INT16  k, L1, L2, LowL, HighL;
       FLOAT64      X;


       /*---------------------------------------------------------*/


       LowL   = (INT16)t-WinLim+1;
```

```
L1      = MAX(0,LowL);
HighL   = LowL+2*WinLim;
L2      = MIN(Len,HighL);
X       = 0.0;


for (k = L1; k < L2; k++)
        X += s[k]*w[k-LowL];




/*-----------------------------------------------------------*/


return X;


/*-----------------------------------------------------------*/
}


/*-----------------------------------------------------------*/


/*===========================================================*/
/* FUNCTION : LTP_lag_to_idx7b ().                         */
/*-----------------------------------------------------------*/
/* PURPOSE  : This function produces the extract the 7 bits index   */
/*          corresponding to the pitch value              */
/*                                          */
/*-----------------------------------------------------------*/
/* ALGORITHM :                              */
/*-----------------------------------------------------------*/
/* INPUT ARGUMENTS :                           */
/*      _ (FLOAT64 ) pit :   pitch value.              */
/*-----------------------------------------------------------*/
/* OUTPUT ARGUMENTS :                           */
/*      _ None.                               */
/*-----------------------------------------------------------*/
/* INPUT/OUTPUT ARGUMENTS :                        */
/*      _ None.                               */
/*-----------------------------------------------------------*/
/* RETURN ARGUMENTS :                           */
/*      _ (INT16  ) idx :   corresponding index.          */
/*===========================================================*/
```

```
INT16 LTP_lag_to_idx7b (FLOAT64 pit)
      {
      /*-----------------------------------------------------*/

      FLOAT64      Min, D;
      INT16  i, idx;

      /*-----------------------------------------------------*/


    if ( pit <53) {
      Min = fabs(PitLagTab7b[0] - pit);
      idx = 0;
      for (i = 1; i <= 60 ;i++) {
        D = fabs(PitLagTab7b[i] - pit);
        if ( D < Min) {
          Min = D;
          idx = i;
        }
      }
    }
    else {
      idx = (pit-PitLagTab7b[60]) + 0.5;
      idx= MIN(60 + idx, MAX_PIT_IDX_7b);
    }

      /*-----------------------------------------------------*/


      return (idx);

      /*-----------------------------------------------------*/
      }


/*==================================================================*/
/* FUNCTION : LTP_lag_to_idx8b ().                      */
/*-----------------------------------------------------*/
/* PURPOSE   : This function produces the extract the 8 bits index  */
/*        corresponding to the pitch value                 */
/*                                      */
/*-----------------------------------------------------*/
/* ALGORITHM :                              */
```

```
/*-----------------------------------------------------*/
/* INPUT ARGUMENTS :                          */
/*      _ (FLOAT64 ) pit :   pitch value.          */
/*-----------------------------------------------------*/
/* OUTPUT ARGUMENTS :                          */
/*      _ None.                          */
/*-----------------------------------------------------*/
/* INPUT/OUTPUT ARGUMENTS :                       */
/*      _ None.                          */
/*-----------------------------------------------------*/
/* RETURN ARGUMENTS :                          */
/*      _ (INT16   ) idx :   corresponding index.       */
/*=====================================================*/


INT16 LTP_lag_to_idx8b( FLOAT64 pit)
    {

    FLOAT64 Min, D;
    INT16 i, idx;


    if (pit <= 33.2) {
    idx = (INT16)((pit-MIN_LAG)/0.2 + 0.5);
    }
    else {
     if (pit < 44) {
        Min = fabs( PitLagTab8b[81] - pit);
        idx = 81;
        for ( i = 82; i <= 121;i++) {
           D = fabs( PitLagTab8b[i] - pit);
           if (D < Min) {
             Min = D;
             idx = i;
           }
        }
     }
     else {
        if ( pit < 62.0) {
           Min = fabs(PitLagTab8b[121] - pit);
           idx = 121;
```

534

```
            for ( i = 122; i <=160 ;i++) {
                D = fabs(PitLagTab8b[i] - pit);
                if ( D < Min) {
                    Min = D;
                    idx = i;
                }
            }
        }
        else {
            if ( pit < 92) {
                Min = fabs(PitLagTab8b[160] - pit);
                idx = 160;
                for (i = 161; i <= 199;i++) {
                    D = fabs(PitLagTab8b[i] - pit);
                    if (D < Min) {
                        Min = D;
                        idx = i;
                    }
                }
            }
            else {
                idx = (INT16)((pit - 92) + 199 + 0.5);
            }
        }
    }

    idx = MAX(idx, 0);
    idx = MIN(idx, MAX_PIT_IDX_8b);
    return (idx);
}
/*-----------------------------------------------------------*/


/*===========================================================*/
/* FUNCTION  : LTP_generate_PitLagTab ().                    */
/*-----------------------------------------------------------*/
/* PURPOSE   : This function generates the pitch lag table.  */
/*                                                           */
/*-----------------------------------------------------------*/
/* ALGORITHM :                                               */
```

```
/*----------------------------------------------------*/
/* INPUT ARGUMENTS :                              */
/*            _ None.                     */
/*----------------------------------------------------*/
/* OUTPUT ARGUMENTS :                             */
/*            _ None.                     */
/*----------------------------------------------------*/
/* INPUT/OUTPUT ARGUMENTS :                        */
/*            _ None.                     */
/*----------------------------------------------------*/
/* RETURN ARGUMENTS :                             */
/*            _ None.                     */
/*====================================================*/


void LTP_generate_PitLagTab (void)
        {
        /*----------------------------------------------------*/

        INT16   i, k;
        FLOAT64      D;


        /*----------------------------------------------------*/
        /*                8 bit table               */
        /*----------------------------------------------------*/

        PitLagTab8b[0] = MIN_LAG;
        for (i = 1; i <= MAX_PIT_IDX_8b ; i++) {
         if ( PitLagTab8b[i-1] < 33) {
            PitLagTab8b[i] = PitLagTab8b[i-1] + 0.2;
         }
         else {
            if (PitLagTab8b[i-1] < 91) {
             D = 0.2+0.8*(PitLagTab8b[i-1]-33.0)/(91.0-33.0);
             PitLagTab8b[i] = PitLagTab8b[i-1] + D;
             }
            else {
             k = (INT16)(PitLagTab8b[i-1] + 1.1);
             PitLagTab8b[i] = k;
             }
            }
```

```
}


    /*-------------------------------------------------*/
    /*                7 bit table              */
    /*-------------------------------------------------*/


PitLagTab7b[0] = MIN_LAG;
for (i = 1; i <= MAX_PIT_IDX_7b ;i++) {
  D = MIN(0.325*PitLagTab7b[i-1]/MIN_LAG, 1);
  if (D > 0.99) {
    k = PitLagTab7b[i-1] + D + 0.5;
    PitLagTab7b[i] = k;
    }
  else
    PitLagTab7b[i] = PitLagTab7b[i-1]+D;
  }


    /*-------------------------------------------------*/
    /*                5 bit table              */
    /*-------------------------------------------------*/


PitLagTab5b[0] = 0.0;
for (i = 1; i <= MAX_PIT_IDX_5b ; i++) {
  if (PitLagTab5b[i-1] <= 0.8)
    D = 1.0/5.0;
  else {
    if (PitLagTab5b[i-1] <= 1.8)
      D = 1.0/4.0;
    else
      D = 1.0/3.0;
    }
  PitLagTab5b[i] = PitLagTab5b[i-1] + D;
  }


    /*-------------------------------------------------*/


    /*-------------------------------------------------*/


return;
```

```
        /*----------------------------------------------------*/

        }


    /*----------------------------------------------------*/


    /*====================================================*/
    /* FUNCTION  :  LTP_Init_SincWindows ().              */
    /*----------------------------------------------------*/
    /* PURPOSE   : This function initializes the table of Sinc   */
    /*          interpolation windows.                   */
    /*                                                   */
    /*----------------------------------------------------*/
    /* ALGORITHM :                                       */
    /*----------------------------------------------------*/
    /* INPUT ARGUMENTS  :                                */
    /*              _ None.                              */
    /*----------------------------------------------------*/
    /* OUTPUT ARGUMENTS :                                */
    /*              _ None.                              */
    /*----------------------------------------------------*/
    /* INPUT/OUTPUT ARGUMENTS :                          */
    /*              _ None.                              */
    /*----------------------------------------------------*/
    /* RETURN ARGUMENTS :                                */
    /*              _ None.                              */
    /*====================================================*/


    void LTP_Init_SincWindows (void)
            {
            /*----------------------------------------------------*/


            FLOAT64     f;
            INT16  i;


            /*----------------------------------------------------*/


        for (i=0;i<NUM_SINC_WIN;i++) {
            f=DELT_F*i;
            D2A_InterpWeight2(SincWindows+i*LEN_SINC,f,SINC_LIMIT);
```

```
            }

    for (i=0;i<NUM_SINC_WIN;i++) {
        f=DELT_F*i;
        D2A_InterpWeight(SincWindows_E+i*LEN_SINC_E,f,SINC_LIMIT_E);
    }

    for (i=0;i<NUM_SINC_WIN;i++) {
      f=DELT_F*i;
      D2A_InterpWeight(SincWindows_PP+i*LEN_SINC_PP,f,SINC_LIMIT_PP);
    }


        /*----------------------------------------------------------------*/


      return;

        /*----------------------------------------------------------------*/
      }


/*----------------------------------------------------------------------------*/



/*==============================================================================*/
/* FUNCTION  : LTP_excit_vari_pitch ().                  */
/*----------------------------------------------------------------*/
/* PURPOSE   : This function calculates LTP excitation with      */
/*          interpolated pitch track.                    */
/*----------------------------------------------------------------*/
/* ALGORITHM :                        */
/*----------------------------------------------------------------*/
/* INPUT ARGUMENTS :                         */
/*    _ (FLOAT64 []) SincWindows : table of interpolation weights. */
/*    _ (FLOAT64 []) PitFun :    Pitch track.            */
/*    _ (FLOAT64 []) LTm :      Excitation memory.          */
/*    _ (INT16   ) L_LTm :    Length of the excitation memory.*/
/*    _ (INT16   ) Len :    Length of the LTP excitation.   */
/*----------------------------------------------------------------*/
/* OUTPUT ARGUMENTS :                         */
/*    _ (FLOAT64 []) E :      LTP excitation.          */
```

```
/*-------------------------------------------------*/
/* INPUT/OUTPUT ARGUMENTS :                    */
/*             _ None.                     */
/*-------------------------------------------------*/
/* RETURN ARGUMENTS :                         */
/*             _ None.                      */
/*=================================================*/


void LTP_excit_vari_pitch (FLOAT64 *SincWindows,INT16 Len_Sinc,INT16 Sinc_Limit,
             FLOAT64 PitFun[],INT16 L_LTm,FLOAT64 LTm[],INT16 Len,
             FLOAT64 E[])
        {
        /*-------------------------------------------------*/


        FLOAT64        t, f, *Weight;
        INT16  k, T, m;


        /*-------------------------------------------------*/


        for (k = 0; k < Len; k++)
                {
                t = L_LTm + k - PitFun[k];
                T = (INT16)t;
                f = t-(FLOAT64)T;
                m = (INT16)(f*(FLOAT64)DELT_F2+0.500001);
                Weight = SincWindows + m*Len_Sinc;
                E[k] = D2A_interp (Weight, LTm, (INT16)(L_LTm+Len), t,

                        Sinc_Limit);
                LTm[L_LTm+k] = E[k];
                }


        /*-------------------------------------------------*/


        return;


        /*-------------------------------------------------*/
        }
```

```
/*-------------------------------------------------------------------------*/


/*=========================================================================*/
/* FUNCTION  : LTP_excit_const_pitch ().                    */
/*-------------------------------------------------------------------------*/
/* PURPOSE   : This function calculates LTP excitation with      */
/*          constant pitch track.                      */
/*-------------------------------------------------------------------------*/
/* ALGORITHM :                                */
/*-------------------------------------------------------------------------*/
/* INPUT ARGUMENTS  :                            */
/*      _ (FLOAT64  ) Pit_f :     Pitch lag (fractional).      */
/*      _ (FLOAT64 []) LTm :      Excitation memory.          */
/*      _ (INT16    ) L_LTm :    Length of the excitation memory.*/
/*      _ (INT16    ) Len  :    Length of the LTP excitation.   */
/*      _ (INT16    ) mem_flag :  memory update flag.         */
/*-------------------------------------------------------------------------*/
/* OUTPUT ARGUMENTS :                            */
/*      _ (FLOAT64 []) E :        LTP excitation.            */
/*-------------------------------------------------------------------------*/
/* INPUT/OUTPUT ARGUMENTS :                         */
/*            _ None.                    */
/*-------------------------------------------------------------------------*/
/* RETURN ARGUMENTS :                            */
/*            _ None.                    */
/*=========================================================================*/


void LTP_excit_const_pitch (FLOAT64 Pit_f,INT16 L_LTm, FLOAT64 LTm[],INT16 Len,
                     FLOAT64 E[],INT16 mem_flag)
      {
      /*-------------------------------------------------------------------*/


      FLOAT64      t, f, *Weight;
      INT16  k, T, m;


      /*-------------------------------------------------------------------*/


      t = L_LTm - Pit_f;
      T = (INT16)t;
      f = t - (FLOAT64)T;
```

```
m = (INT16)(f*(FLOAT64)DELT_F2 + 0.500001);
Weight = SincWindows_E + m*LEN_SINC_E;


for (k = 0; k < Len; k++)
        {
        t = L_LTm + k - Pit_f;
        E[k] = D2A_interp (Weight, LTm, (INT16)(L_LTm+Len), t,


SINC_LIMIT_E);
        if (mem_flag == 1)
                LTm[L_LTm+k] = E[k];
        }


        /*-------------------------------------------------*/


        return;


        /*-------------------------------------------------*/
        }



        /*-------------------------------------------------*/


/*=================================================================*/
/* FUNCTION  : LTP_FineIndex_search ().                    */
/*-------------------------------------------------*/
/* PURPOSE   : This function does the fine search of the correlation.*/
/*-------------------------------------------------*/
/* ALGORITHM :                              */
/*-------------------------------------------------*/
/* INPUT ARGUMENTS :                             */
/*      _ (FLOAT64 []) PitTab:    table of pitch values.       */
/*      _ (INT16    ) P1 :      sarch minimum value.          */
/*      _ (INT16    ) P2 :      sarch maximum value.          */
/*      _ (INT16    ) LowL :     lower pitch value.           */
/*      _ (INT16    ) L_R:       length of correlation.       */
/*-------------------------------------------------*/
/* OUTPUT ARGUMENTS :                            */
/*      _ (INT16    ) index :    memory update flag.          */
/*-------------------------------------------------*/
```

```
/* INPUT/OUTPUT ARGUMENTS :                              */
/*    _ (FLOAT64 []) R:        correlation.              */
/*----------------------------------------------------------*/
/* RETURN ARGUMENTS :                                    */
/*             _ None.                        */
/*==============================================================*/


void LTP_FineIndex_search (FLOAT64 PitTab[], INT16 P1,INT16 P2,INT16 LowL,
         INT16 L_R,FLOAT64 R[],INT16 *index)
        {
        /*--------------------------------------------------------*/


        FLOAT64     t, GG, f, MaxR=0, *Weight;
        INT16  i, T, m;


        /*--------------------------------------------------------*/
        /*        Search for the best precise pitch and index      */
        /*--------------------------------------------------------*/


        for (i = P1; i <= P2; i++)
               {
               t = PitTab[i] - LowL;
               T = (INT16)t;
               f = t - (FLOAT64)T;
               m = (INT16)(f*(FLOAT64)DELT_F2 + 0.500001);
               Weight = SincWindows + m*LEN_SINC;
               GG = D2A_interp(Weight, R, L_R, t, SINC_LIMIT);
               if (i == P1 || GG > MaxR)
                      {
                      MaxR = GG;
                      (*index) = i;
                      }
               }


        T = (INT16)(PitTab[*index] + 0.5 - LowL);
        R[T] = MaxR;


        /*--------------------------------------------------------*/


        return;
```

543

```
        /*------------------------------------------------*/

        }



        /*------------------------------------------------*/


    /*================================================*/
    /* FUNCTION  : LTP_PP_pitch_ext ().                   */
    /*------------------------------------------------*/
    /* PURPOSE   : This function extracts the adaptive codebook    */
    /*             excitation for pitch pre-processing (Mode 1) at the   */
    /*             encoder.                              */
    /*------------------------------------------------*/
    /* ALGORITHM :                                  */
    /*------------------------------------------------*/
    /* INPUT ARGUMENTS :                            */
    /*     _ (FLOAT64 []) PitFun:    Pitch track.           */
    /*     _ (FLOAT64 []) Tgs:       target signal.          */
    /*     _ (FLOAT64 []) ext:       excitation signal.       */
    /*     _ (FLOAT64 []) hh:        impulse response.        */
    /*     _ (INT16   ) i_sf :    sub-frame number.        */
    /*     _ (INT16   ) l_sf :    sub-frame size.          */
    /*------------------------------------------------*/.
    /* OUTPUT ARGUMENTS :                           */
    /*     _ (INT16   *) lag :      lag value.            */
    /*     _ (FLOAT64  *) lag_f:    fractional lag value.      */
    /*     _ (FLOAT64  *) R_ltp:    pitch correlation.        */
    /*     _ (FLOAT64 []) unfcod:    unfiltered excitation.      */
    /*     _ (FLOAT64 []) fcod:      filtered excitation.       */
    /*------------------------------------------------*/
    /* INPUT/OUTPUT ARGUMENTS :                      */
    /*            _ None.                           */
    /*------------------------------------------------*/
    /* RETURN ARGUMENTS :                           */
    /*            _ None.                           */
    /*================================================*/


void LTP_PP_pitch_ext(FLOAT64 PitFun[],FLOAT64 Tgs [], FLOAT64 ext [],
                      FLOAT64 hh [], INT16 i_sf,FLOAT64 *unfcod,
```

```
                                      FLOAT64 *fcod, INT16 *lag, FLOAT64 *lag_f,
                                         FLOAT64 *R_ltp, INT16 l_sf)

        {
        /*---------------------------------------------------------------*/


        FLOAT64         numerator, denominator, eng_Tgs, tmp[L_SF];  .


        FLOAT64         *buf;


        /*---------------------------------------------------------------*/


        buf = dvector (0, l_sf-1);


        /*---------------------------------------------------------------*/
        /*              LTP excitation : unfcod[]              */
        /*---------------------------------------------------------------*/


        cpy_dvector(ext + MAX_LAG, tmp, 0, L_SF-1);
        LTP_excit_vari_pitch(SincWindows_E, LEN_SINC_E, SINC_LIMIT_E, PitFun,
                                    MAX_LAG, ext, l_sf, unfcod);


        cpy_dvector(tmp, ext+MAX_LAG, 0, L_SF-1);


        /*---------------------------------------------------------------*/
        /*            Filter the pitch vector (LTP excitation)     */
        /*---------------------------------------------------------------*/


        filterAZ (hh, unfcod, fcod, buf, (INT16)(l_sf-1), l_sf);


        /*---------------------------------------------------------------*/
        /*                  Integer pitch              */
        /*---------------------------------------------------------------*/


        lag[i_sf]  = (INT16)(MIN(PitFun[l_sf/2]+0.5, max_pit));
        lag_f[i_sf] = PitFun[l_sf/2];


        /*---------------------------------------------------------------*/
        /*            Compute the pitch gain (LTP gain)        */
        /*---------------------------------------------------------------*/
```

```
        dot_dvector (Tgs, fcod, &numerator, 0, l_sf-1);   .
        dot_dvector (fcod, fcod, &denominator, 0, l_sf-1);
        dot_dvector (Tgs, Tgs, &eng_Tgs, 0, l_sf-1);
        (*R_ltp) = MAX(numerator, 0.0) / sqrt(MAX(denominator*eng_Tgs, 0.1));


        /*----------------------------------------------------*/


        free_dvector (buf, 0, l_sf-1);


        /*----------------------------------------------------*/


        return;


        /*----------------------------------------------------*/
        }


/*----------------------------------------------------------------*/


/*================================================================*/
/* FUNCTION  : LTP_PP_pitch_ext_decod ().                    */
/*------------------------------------------------------------*/
/* PURPOSE   : This function extracts the adaptive codebook       */
/*             excitation for pitch pre-processing (Mode 1) at the */
/*             decoder.                          */
/*------------------------------------------------------------*/
/* ALGORITHM :                                */
/*------------------------------------------------------------*/
/* INPUT ARGUMENTS :                              */
/*     _ (FLOAT64 []) PitFun:    Pitch track.              */
/*     _ (FLOAT64 []) ext:       excitation signal.          */
/*     _ (INT16   ) i_sf :     sub-frame number.           */
/*     _ (INT16   ) l_sf :     sub-frame size.            */
/*------------------------------------------------------------*/
/* OUTPUT ARGUMENTS :                             */
/*     _ (INT16   *) lag :     lag value.                */
/*     _ (FLOAT64 *) lag_f:    fractional lag value.         */
/*     _ (FLOAT64 []) unfcod:    unfiltered excitation.        */
/*------------------------------------------------------------*/
/* INPUT/OUTPUT ARGUMENTS :                          */
/*            _ None.                        */
```

```
/*-------------------------------------------------------*/
/* RETURN ARGUMENTS :                              */
/*               _ None.                    */
/*=====================================================*/


void LTP_PP_pitch_ext_decod (FLOAT64 PitFun[],FLOAT64 ext[], INT16 i_sf,
                        FLOAT64 *unfcod, INT16 *lag, FLOAT64 *lag_f, INT16 l_sf)
        {
        /*-------------------------------------------------*/


        FLOAT64       tmp[L_SF];


        /*-------------------------------------------------*/
        /*             LTP excitation : unfcod[]        */
        /*-------------------------------------------------*/


        cpy_dvector (ext+MAX_LAG, tmp, 0, L_SF-1);
        LTP_excit_vari_pitch(SincWindows_E, LEN_SINC_E, SINC_LIMIT_E, PitFun,
                                            MAX_LAG, ext, l_sf,
unfcod);


        cpy_dvector(tmp, ext+MAX_LAG, 0, L_SF-1);


        /*-------------------------------------------------*/
        /*              pitch          */
        /*-------------------------------------------------*/


        lag[i_sf] = (INT16)(PitFun[l_sf/2]+0.5);
        lag_f[i_sf] = PitFun[l_sf/2];


        /*-------------------------------------------------*/


        return;


        /*-------------------------------------------------*/
        }


/*-------------------------------------------------------*/


/*=====================================================*/
```

```
/* FUNCTION  : LTP_close_7b_pitch ().                         */
/*--------------------------------------------------------*/
/* PURPOSE   : This function performs the traditional search of the */
/*         the adaptive codebook in Mode 0.                   */
/*--------------------------------------------------------*/
/* ALGORITHM :                                            */
/*--------------------------------------------------------*/
/* INPUT ARGUMENTS  :                                     */
/*   _ (FLOAT64 []) Tgs:      target signal.               */
/*   _ (FLOAT64 []) ext:      excitation signal.            */
/*   _ (FLOAT64 []) hh:       impulse response.             */
/*   _ (INT16   ) i_sf :      sub-frame number.             */
/*   _ (INT16   ) l_sf :      sub-frame size.               */
/*   _ (INT16   ) frm_class_pp : pitch pre-proc. classification. */
/*--------------------------------------------------------*/
/* OUTPUT ARGUMENTS :                                     */
/*     _ (INT16   *) lag :     lag value.                  */
/*     _ (FLOAT64 *) lag_f:     fractional lag value.        */
/*     _ (FLOAT64 *) pgain:     pitch gain.                 */
/*     _ (FLOAT64 *) R_ltp:     LTP criterion.              */
/*     _ (FLOAT64 []) unfcod:    unfiltered excitation.       */
/*     _ (FLOAT64 []) fcod:     filtered excitation.         */
/*     _ (INT16   *) pit_idx :   pitch index.               */
/*--------------------------------------------------------*/
/* INPUT/OUTPUT ARGUMENTS :                               */
/*           _ None.                                       */
/*--------------------------------------------------------*/
/* RETURN ARGUMENTS :                                     */
/*           _ None.                                       */
/*========================================================*/


void LTP_close_7b_pitch(FLOAT64 Tgs [], FLOAT64 ext [], FLOAT64 hh [],
                        INT16 i_sf, FLOAT64 unfcod [],
                        FLOAT64 fcod [], INT16 *lag,FLOAT64 *lag_f,
                        FLOAT64 *pgain, FLOAT64 *R_ltp, INT16 l_sf,
                        INT16 frm_class_pp, INT16 pit_idx [])
        {
        /*--------------------------------------------------*/


        FLOAT64      pit_f, numerator, denominator, MaxR, eng_Tgs;
```

```
FLOAT64      ftmp[L_SF];
INT16        i, k, IP1, IP2, L_Rp, PITCHi;
FLOAT64      *buf;
FLOAT64      Rp[20] = {0.0};


/*—————————————————————————————————*/
/*            Allocate temporary memory            */
/*—————————————————————————————————*/


buf = dvector (0, l_sf-1);


/*—————————————————————————————————*/
/*                Searching range                  */
/*—————————————————————————————————*/


if (lag[i_sf] < MIN_LAG2)
        lag[i_sf] *=2;
IP1 = MAX(MIN_LAG2, lag[i_sf] - 3);
IP2 = MIN(HI_LAG2,      lag[i_sf] + 3);
if ((frm_class_pp > 0) && (i_sf == N_SF2-1) && (lag[i_sf] > l_sf*0.75))
        {
        IP1 = MAX(MIN_LAG2, lag[i_sf]-1);
        IP2 = MIN(HI_LAG2, lag[i_sf]+1);
        }


/*—————————————————————————————————*/
/*          Integer correlation for integer lag          */
/*—————————————————————————————————*/


L_Rp    = IP2 - IP1 + 1;


#ifdef VERBOSE


if (L_Rp >= 20)
        nrerror("L_Rp>=20 !!");


#endif


/*—————————————————————————————————*/
```

```
for (i = IP1; i <= IP2; i++)
        {
        if (i == IP1)
                        filterAZ (hh, ext+MAX_LAG-i, ftmp, buf,

(INT16)(l_sf-1), l_sf);
            else
                {
                for (k = l_sf-1; k > 0; k--)
                        ftmp[k] = ftmp[k-1] + ext[MAX_LAG-i]*hh[k];
                ftmp[0] = ext[MAX_LAG-i]*hh[0];
                }

            dot_dvector (Tgs, ftmp, &Rp[i-IP1], 0, l_sf-1);
            dot_dvector(ftmp, ftmp, &denominator, 0, l_sf-1);
            Rp[i-IP1] /= sqrt(MAX(denominator, 0.1));

            }


/*------------------------------------------------------*/
/*              Searching for integer pitch          */
/*------------------------------------------------------*/


MaxR = Rp[0];
PITCHi = IP1;
for (i = IP1+1; i <= IP2; i++)
        {
        if (Rp[i-IP1] > MaxR)
                {
                MaxR = Rp[i-IP1];
                PITCHi = i;
                }
        }
if ((MaxR < 0) && (i_sf==N_SF2-1) && (frm_class_pp > 0))
        PITCHi = lag[i_sf];


/*------------------------------------------------------*/
/*              Fine index searching                 */
/*------------------------------------------------------*/
```

```
pit_idx[i_sf] = PITCHi - MIN_LAG2;
pit_f = PITCHi;
lag[i_sf] = PITCHi;
lag_f[i_sf] = PITCHi;


/*-------------------------------------------------------------*/
/*              LTP excitation : unfcod[]              */
/*-------------------------------------------------------------*/


cpy_dvector (ext+MAX_LAG, ftmp, 0, l_sf-1);
LTP_excit_const_pitch (pit_f, MAX_LAG, ext, l_sf, unfcod, 1);
cpy_dvector (ftmp, ext+MAX_LAG, 0, l_sf-1);


/*-------------------------------------------------------------*/
/*          Filter the pitch vector (LTP excitation)          */
/*-------------------------------------------------------------*/


ini_dvector (buf, 0, l_sf-1, 0.0);
filterAZ (hh, unfcod, fcod, buf, (INT16)(l_sf-1), l_sf);


/*-------------------------------------------------------------*/
/*              Compute the pitch gain (LTP gain)              */
/*-------------------------------------------------------------*/


dot_dvector (Tgs,         fcod,      &numerator,          0, l_sf-1);
dot_dvector (fcod, fcod,  &denominator,   0, l_sf-1);
dot_dvector (Tgs,         Tgs,      &eng_Tgs,          0, l_sf-1);

(*pgain) = numerator / MAX(denominator, 0.1);


/*-------------------------------------------------------------*/
/*          Limit the pitch gain -> 0 <= pgain <= 1.2          */
/*-------------------------------------------------------------*/


if (((*pgain) < 0.0)
         (*pgain) = 0.0;
if (((*pgain) > 1.2)
         (*pgain) = 1.2;


(*R_ltp) = MAX(numerator, 0.0) / sqrt(MAX(denominator*eng_Tgs, 0.1));
```

```
/*----------------------------------------------------*/
/*              Deallocate temporary memory          */
/*----------------------------------------------------*/


free_dvector (buf, 0, l_sf-1);


/*----------------------------------------------------*/


return;


/*----------------------------------------------------*/
}


/*----------------------------------------------------*/



/*====================================================*/
/* FUNCTION  : LTP_close_8_5k_pitch ().              */
/*----------------------------------------------------*/
/* PURPOSE   : This function performs the traditional search of the */
/*        the adaptive codebook for SMV 8.5 kbps.    */
/*----------------------------------------------------*/
/* ALGORITHM :                                       */
/*----------------------------------------------------*/
/* INPUT ARGUMENTS :                                 */
/*    _ (FLOAT64 []) Tgs:      target signal.        */
/*    _ (FLOAT64 []) ext:      excitation signal.    */
/*    _ (FLOAT64 []) hh:       impulse response.     */
/*    _ (INT16   ) i_sf :   sub-frame number.        */
/*    _ (INT16   ) l_sf :   sub-frame size.          */
/*    _ (INT16   ) frm_class_pp : pitch pre-proc. classification. */
/*----------------------------------------------------*/
/* OUTPUT ARGUMENTS :                                */
/*    _ (INT16   *) lag :     lag value.             */
/*    _ (FLOAT64 *) lag_f:    fractional lag value.  */
/*    _ (FLOAT64 *) pgain:    pitch gain.            */
/*    _ (FLOAT64 *) R_ltp:    LTP criterion.         */
/*    _ (FLOAT64 []) unfcod:   unfiltered excitation. */
/*    _ (FLOAT64 []) fcod:     filtered excitation.  */
```

```
/*      _ (INT16   *) pit_idx :   pitch index.                    */
/*-------------------------------------------------------------*/
/* INPUT/OUTPUT ARGUMENTS :                                     */
/*              _ None.                                         */
/*-------------------------------------------------------------*/
/* RETURN ARGUMENTS :                                          */
/*                  _ None.                                    */
/*============================================================*/


void LTP_close_8_5k_pitch (FLOAT64 Tgs [], FLOAT64 ext [], FLOAT64 hh [],
                        INT16 i_sf, FLOAT64 unfcod [],
                        FLOAT64 fcod [], INT16 *lag,FLOAT64 *lag_f,
                        FLOAT64 *pgain, FLOAT64 *R_ltp, INT16 l_sf,
                        INT16 frm_class_pp, INT16 pit_idx [])
        {
        /*---------------------------------------------------*/


        FLOAT64        pit_f, numerator, denominator, MaxR, eng_Tgs;
        FLOAT64        ftmp[L_SF], DifPitTab[33];
        INT16          i, k, PP1 = 0, PP2 = 0, IP1, IP2, LowL, HighL, L_Rp, PITCHi;
        FLOAT64        *buf;
        FLOAT64        Rp[2*SINC_LIMIT+40] = {0.0};


        /*---------------------------------------------------*/
        /*              Allocate temporary memory            */
        /*---------------------------------------------------*/


        buf = dvector (0, l_sf-1);


        /*---------------------------------------------------*/
        /*                  Searching range                  */
        /*---------------------------------------------------*/


        IP1 = MAX(MIN_LAG, lag[i_sf] - 3);
        IP2 = MIN(HI_LAG2,     lag[i_sf] + 3);


        if ((i_sf == 1) || (i_sf == N_SF4-1))
                {
                for (i = 0; i < 16; i++)
                        DifPitTab[16+i] = MIN (HI_LAG2,
```

```
                                                                    lag_f[i_sf-1] + PitLagTab5b[i]);

        for (i = 1; i <= 16; i++)
                DifPitTab[16-i] = MAX(MIN_LAG,

                                                                    lag_f[i_sf-1] - PitLagTab5b[i]);


        PP1 = 0;
        PP2 = 31;
        if ((frm_class_pp > 0) && (i_sf == N_SF4-1))
                {
                IP1 = MAX(MIN_LAG, lag[i_sf]-1);
                IP2 = MIN(HI_LAG2, lag[i_sf]+1);
                if (DifPitTab[0] >= IP2)
                        PP2 = 0;
                if (DifPitTab[31] <= IP1)
                        PP1 = 31;
                for (i = 0; i < 32; i++)
                        {
                        if (DifPitTab[i] >= IP1)
                                {
                                PP1 = i;
                                break;
                                }
                        }

                for (i = 31; i >= 0; i--)
                        {
                        if (DifPitTab[i] <= IP2)
                                {
                                PP2 = i;
                                break;
                                }
                        }
                }
        IP1 = DifPitTab[PP1] + 0.5;
        IP2 = DifPitTab[PP2]+0.5;
        }


/*------------------------------------------------------------*/
/*          Integer correlation for integer lag          */
/*------------------------------------------------------------*/
```

```
LowL   = IP1 - SINC_LIMIT - 1;
HighL  = IP2 + SINC_LIMIT + 1;
L_Rp   = HighL - LowL + 1;


#ifdef VERBOSE


    if (L_Rp >= 2*SINC_LIMIT + 40)
            nrerror("L_Rp>=2*SINC_LIMIT+24 !! \n");


#endif


    /*------------------------------------------------------*/


    for (i = LowL; i <= HighL; i++)
            {
            if (i == LowL)
                            filterAZ (hh, ext+MAX_LAG-i, ftmp, buf,

(INT16)(l_sf-1), l_sf);
            else
                    {
                    for (k = l_sf-1; k > 0; k--)
                            ftmp[k] = ftmp[k-1] + ext[MAX_LAG-i]*hh[k];
                    ftmp[0] = ext[MAX_LAG-i]*hh[0];
                    }

            dot_dvector (Tgs, ftmp, &Rp[i-LowL], 0, l_sf-1);
            dot_dvector(ftmp, ftmp, &denominator, 0, l_sf-1);
            Rp[i-LowL] /= sqrt(MAX(denominator, 0.1));


            }


    /*------------------------------------------------------*/
    /*          Searching for integer pitch              */
    /*------------------------------------------------------*/


    MaxR = Rp[IP1 - LowL];
    PITCHi = IP1;
    for (i = IP1+1; i <= IP2; i++)
```

```
                {
            if (Rp[i-LowL] > MaxR)
                    {
                    MaxR = Rp[i-LowL];
                    PITCHi = i;
                    }
            }


    if ((MaxR < 0) && (frm_class_pp > 0) && (i_sf == N_SF4-1))
            PITCHi = lag[i_sf];


    /*------------------------------------------------------------*/
    /*                  Fine index searching              */
    /*------------------------------------------------------------*/


    if ((i_sf == 0) || (i_sf == N_SF4/2))
            {
            PP1 = LTP_lag_to_idx8b(MAX(PITCHi - 0.9, MIN_LAG));
            PP2 = LTP_lag_to_idx8b(MIN(PITCHi + 0.9, HI_LAG2));

            LTP_FineIndex_search (PitLagTab8b, PP1, PP2, LowL, L_Rp, Rp,
                                                        pit_idx+i_sf);

            pit_f = PitLagTab8b[pit_idx[i_sf]];
            lag[i_sf] = (INT16)(pit_f + 0.5);
            lag_f[i_sf] = pit_f;
            }
    else
            {
            if (DifPitTab[PP1] >= (PITCHi+0.9))
                    PP2 = PP1;
            if (DifPitTab[PP2] <= (PITCHi-0.9))
                    PP1 = PP2;
            for (i = PP1; i <= PP2; i++)
                    {
                    if (DifPitTab[i] >= (PITCHi-0.9))
                            {
                            PP1 = i;
                            break;
                            }
```

```
                    }

        for (i = PP2; i >= PP1; i--)
                {
                if (DifPitTab[i] <= (PITCHi + 0.9))
                        {
                        PP2 = i;
                        break;
                        }
                }

        PP1 = MIN(PP1, PP2);
        LTP_FineIndex_search (DifPitTab, PP1, PP2, LowL, L_Rp, Rp,
                                                pit_idx+i_sf);

        pit_f = DifPitTab[pit_idx[i_sf]];
        lag[i_sf] = (INT16)(pit_f + 0.5);
        lag_f[i_sf] = pit_f;
        }


/*-------------------------------------------------------------*/
/*              LTP excitation : unfcod[]              */
/*-------------------------------------------------------------*/


cpy_dvector (ext+MAX_LAG, ftmp, 0, l_sf-1);
LTP_excit_const_pitch (pit_f, MAX_LAG, ext, l_sf, unfcod, 1);
cpy_dvector (ftmp, ext+MAX_LAG, 0, l_sf-1);


/*-------------------------------------------------------------*/
/*         Filter the pitch vector (LTP excitation)         */
/*-------------------------------------------------------------*/


ini_dvector (buf, 0, l_sf-1, 0.0);
filterAZ (hh, unfcod, fcod, buf, (INT16)(l_sf-1), l_sf);


/*-------------------------------------------------------------*/
/*           Compute the pitch gain (LTP gain)           */
/*-------------------------------------------------------------*/


dot_dvector (Tgs,        fcod,    &numerator,        0, l_sf-1);
```

```
        dot_dvector (fcod, fcod,    &denominator,    0, l_sf-1);
        dot_dvector (Tgs,        Tgs,      &eng_Tgs,              0, l_sf-1);


        (*pgain) = numerator / MAX(denominator, 0.1);


        /*------------------------------------------------------------*/
        /*          Limit the pitch gain -> 0 <= pgain <= 1.2      */
        /*------------------------------------------------------------*/


        if ((*pgain) < 0.0)
                (*pgain) = 0.0;
        if ((*pgain) > 1.2)
                (*pgain) = 1.2;


        (*R_ltp) = MAX(numerator, 0.0) / sqrt(MAX(denominator*eng_Tgs, 0.1));


        /*------------------------------------------------------------*/
        /*              Dellocate temporary memory           */
        /*------------------------------------------------------------*/


        free_dvector (buf, 0, l_sf-1);


        /*------------------------------------------------------------*/


        return;


        /*------------------------------------------------------------*/
        }


/*------------------------------------------------------------*/


/*============================================================*/
/* FUNCTION  : LTP_pitch_decodtemp ().                    */
/*------------------------------------------------------------*/
/* PURPOSE   : This function perfroms a temporary decoding of the   */
/*         LTP information codebook contribution.           */
/*------------------------------------------------------------*/
/* ALGORITHM :                                       */
/*------------------------------------------------------------*/
```

```
/* INPUT ARGUMENTS :                                    */
/*    _ (FLOAT64 []) ext:      excitation signal.        */
/*    _ (INT16   ) i_sf :     sub-frame number.          */
/*    _ (INT16   ) l_sf :     sub-frame size.            */
/*    _ (FLOAT64  ) pit_f:     fractional lag value.      */
/*----------------------------------------------------*/
/* OUTPUT ARGUMENTS :                                    */
/*    _ (FLOAT64 []) unfcod:    unfiltered LTP excitation.   */
/*----------------------------------------------------*/
/* INPUT/OUTPUT ARGUMENTS :                              */
/*            _ None.                                    */
/*----------------------------------------------------*/
/* RETURN ARGUMENTS :                                    */
/*            _ None.                                    */
/*====================================================*/


void LTP_pitch_decodtemp (FLOAT64 ext [], INT16 i_sf, FLOAT64 unfcod [],
                                  FLOAT64 pit_f, INT16 l_sf)
        {
        /*--------------------------------------------*/

        FLOAT64 LTm[MAX_LAG+L_SF];

        /*--------------------------------------------*/

        cpy_dvector (ext, LTm, 0, MAX_LAG-1);

        LTP_excit_const_pitch (pit_f, MAX_LAG, LTm, l_sf, unfcod, 1);

        /*--------------------------------------------*/

        return;

        /*--------------------------------------------*/
        }

/*------------------------------------------------------*/


/*======================================================*/
/* FUNCTION : LTP_7b_pitch_decod ().                    */
```

559

```
/*----------------------------------------------------*/
/* PURPOSE   : This function decodes the traditional adaptive    */
/*       codebook contribution.              */
/*----------------------------------------------------*/
/* ALGORITHM :                   */
/*----------------------------------------------------*/
/* INPUT ARGUMENTS  :                 */
/*    _ (INT16   ) bfi :     bad frame indicator.      */
/*    _ (FLOAT64 []) ext:      excitation signal.       */
/*    _ (INT16   ) i_sf :    sub-frame number.        */
/*    _ (INT16   ) l_sf :    sub-frame size.        */
/*    _ (INT16   *) pit_idx :   pitch index.          */
/*----------------------------------------------------*/
/* OUTPUT ARGUMENTS :                 */
/*    _ (INT16   *) lag :     lag value.          */
/*    _ (FLOAT64 *) lag_f:    fractional lag value.      */
/*    _ (FLOAT64 []) unfcod:    unfiltered excitation.      */
/*----------------------------------------------------*/
/* INPUT/OUTPUT ARGUMENTS :               */
/*         _ None.                */
/*----------------------------------------------------*/
/* RETURN ARGUMENTS :                 */
/*         _ None.                */
/*====================================================*/


void LTP_7b_pitch_decod (INT16 bfi, FLOAT64 ext [], INT16 i_sf,
                         FLOAT64 unfcod [], INT16 lag [], FLOAT64 lag_f [],
                    INT16 l_sf, INT16 pit_idx [])
        {
        /*--------------------------------------------*/


        FLOAT64      LTm[MAX_LAG+L_SF], pit_f;


        /*--------------------------------------------*/
        /*            Decode lag          */
        /*--------------------------------------------*/


        if (bfi == 0)
             {
             pit_f = pit_idx[i_sf] + MIN_LAG2;
```

```
                    lag[i_sf] = (INT16)(pit_f+0.5);

                    lag_f[i_sf]=pit_f;

                    }

            else

                    {

                    if (i_sf == 0)

                            lag[i_sf] = lag[1];

                    else

                            lag[i_sf] = MIN(lag[i_sf-1], HI_LAG2);


                    lag_f[i_sf] = (FLOAT64) lag[i_sf];

                    pit_f = (FLOAT64) lag[i_sf];

                    }



            /*------------------------------------------------*/
            /*              LTP excitation : unfcod[]         */
            /*------------------------------------------------*/


            cpy_dvector (ext, LTm, 0, MAX_LAG-1);

            LTP_excit_const_pitch (pit_f, MAX_LAG, LTm, l_sf, unfcod, 1);


            /*------------------------------------------------*/


            return;


            /*------------------------------------------------*/

            }



    /*------------------------------------------------*/


    /*================================================================*/
    /* FUNCTION  : LTP_8_5k_pitch_decod ().                       */
    /*------------------------------------------------*/
    /* PURPOSE   : This function decodes the traditional adaptive      */
    /*             codebook contribution in Mode 0.                 */
    /*------------------------------------------------*/
    /* ALGORITHM :                                         */
    /*------------------------------------------------*/
    /* INPUT ARGUMENTS :                                      */
    /*      _(INT16   ) bfi :       bad frame indicator.         */
```

```
/*      _ (FLOAT64 []) ext:        excitation signal.          */
/*      _ (INT16    ) i_sf :       sub-frame number.           */
/*      _ (INT16    ) l_sf :       sub-frame size.             */
/*      _ (INT16   *) pit_idx :    pitch index.                */
/*-------------------------------------------------------------*/
/* OUTPUT ARGUMENTS :                                          */
/*      _ (INT16   *) lag :        lag value.                  */
/*      _ (FLOAT64 *) lag_f:       fractional lag value.       */
/*      _ (FLOAT64 []) unfcod:     unfiltered excitation.      */
/*-------------------------------------------------------------*/
/* INPUT/OUTPUT ARGUMENTS :                                    */
/*              _ None.                                        */
/*-------------------------------------------------------------*/
/* RETURN ARGUMENTS :                                          */
/*              _ None.                                        */
/*=============================================================*/


void LTP_8_5k_pitch_decod (INT16 bfi, FLOAT64 ext [], INT16 i_sf,
                            FLOAT64 unfcod [], INT16 lag [], FLOAT64 lag_f [],
                    INT16 l_sf, INT16 pit_idx [])
        {
        /*-----------------------------------------------------*/


        FLOAT64 LTm[MAX_LAG+L_SF], pit_f, DifPitTab[33];
        INT16   i;


        /*-----------------------------------------------------*/
        /*                    Decode lag                       */
        /*-----------------------------------------------------*/


        if (bfi == 0)
                {
                if ((i_sf == 1) || (i_sf == N_SF4-1))
                        {
                        for (i = 0; i < 16; i++)
                                DifPitTab [16+i] = MIN (HI_LAG2,
                                                                    lag_f[i_sf-
1]+PitLagTab5b[i]);


                        for (i = 1; i <= 16; i++)
```

DifPitTab [16-i] = MAX(MIN_LAG,

lag_f[i_sf-1]-

PitLagTab5b[i]);

```
                    pit_f = DifPitTab[pit_idx[i_sf]];
                }
            else
                pit_f = PitLagTab8b[pit_idx[i_sf]];

            lag[i_sf] = (INT16)(pit_f+0.5);
            lag_f[i_sf] = pit_f;
            }
        else
            {
            if (i_sf == 0)
                    lag[i_sf] = lag[3];
            else
                lag[i_sf] = MIN(lag[i_sf-1], HI_LAG2);

            lag_f[i_sf] = (FLOAT64) lag[i_sf];
            pit_f = (FLOAT64) lag[i_sf];

            }

    /*─────────────────────────────────────────*/
    /*              LTP excitation : unfcod[]            */
    /*─────────────────────────────────────────*/

    cpy_dvector (ext, LTm, 0, MAX_LAG-1);
    LTP_excit_const_pitch (pit_f, MAX_LAG, LTm, l_sf, unfcod, 1);

    /*─────────────────────────────────────────*/

    return;

    /*─────────────────────────────────────────*/
}
```

```
/*-------------------------------------------------------------*/


/*===============================================================*/
/* FUNCTION  :LTP_adap_cbk_correction ().               */
/*-------------------------------------------------------------*/
/* PURPOSE  : This function extrapolated the adaptive codebook    */
/*         excitation when a frame erasure occurs.         */
/*-------------------------------------------------------------*/
/* ALGORITHM :                              */
/*-------------------------------------------------------------*/
/* INPUT ARGUMENTS :                         */
/* _ (INT16   ) fix_rate_m: previous frame bit-rate.       */
/* _ (INT16   ) bfi:     frame # n Bad Frame Indicator.     */
/* _ (INT16   ) past_bfi:  frame # n-1 Bad Frame Indicator.   */
/* _ (INT16   ) ppast_bfi: frame # n-2 Bad Frame Indicator.    */
/* _ (FLOAT64 **) qua_gainQ:  adaptive and fixed codebook gains.   */
/* _ (INT16   ) SVS_deci_m: frame # n-1 mode indicator.      */
/* _ (FLOAT64 []) lag_f:    decoded pitch lags          */
/* _ (FLOAT64  ) temp_lagf: extrapolated fractional pitch lags  */
/*-------------------------------------------------------------*/
/* OUTPUT ARGUMENTS :                          */
/* _ (INT16   *) update :      update flag.          */
/* _ (INT16   []) lag :      extrapolated lag values.     */
/* _ (FLOAT64 **) gainQ:    adaptive and fixed codebook gains.  */
/* _ (FLOAT64 []) lag_f:       extrapolated fract. lag values. */
/* _ (FLOAT64  *) ForPitch_decTEMP: interpolated pitch track.    */
/* _ (FLOAT64 []) ext_dec :     updated LTP memory.        */
/* _ (FLOAT64 **) unfcod_dec :   extrapolated LTP excitation.   */
/*-------------------------------------------------------------*/
/* INPUT/OUTPUT ARGUMENTS :                      */
/* _ (FLOAT64 []) pitch_f_mem : past pitch values.          */
/* _ (FLOAT64 []) tempext_dec : temporary LTP memory.         */
/*-------------------------------------------------------------*/
/* RETURN ARGUMENTS :                          */
/*            _ None.                  */
/*===============================================================*/


void LTP_adap_cbk_correction (INT16 fix_rate_m, INT16 bfi, INT16 past_bfi,
                              INT16 ppast_bfi, FLOAT64 **qua_gainQ,
                              FLOAT64 gainQ [], INT16 SVS_deci_m,
```

```
                              FLOAT64 temp_lagf, INT16 *update,
                              FLOAT64 pitch_f_mem [], INT16 lag [],
                              FLOAT64 lag_f [], FLOAT64 ForPitch_decTEMP [],
                              FLOAT64 tempext_dec [], FLOAT64 ext_dec [],
                              FLOAT64 **unfcod_dec, PARAMETER channel)
     {
     /*--------------------------------------------------------*/


     INT16   n_sf, i_s, i_sf, l_sf;
     INT16   curr_lsf;


     FLOAT64 *px, temp_lag;
     FLOAT64 FET, PFET, AA;


     /*--------------------------------------------------------*/


     if ((bfi == 0) && (past_bfi == 1) && (ppast_bfi == 0) &&
     ((channel.fix_rate == RATE4_0K) || (channel.fix_rate == RATE8_5K))
     && ((fix_rate_m == RATE4_0K) || (fix_rate_m == RATE8_5K)) &&
             (qua_gainQ[0][0] > 0.6))
             {
             (*update) = 1;


             if (fix_rate_m == RATE8_5K)
                     n_sf = N_SF4;
             else
                     {
                     if (SVS_deci_m == 1)
                             n_sf = N_SF3;
                     else
                             n_sf = N_SF2;
                     }


             if (channel.fix_rate ==RATE8_5K)
                     curr_lsf = L_SF4;
             else
                     curr_lsf = L_SF0;



             if ((SVS_deci_m == 1) && (channel.idx_SVS_deci == 0))
```

```
        {
        /*------------------------------------------*/
        /*              PP then LTP              */
        /*------------------------------------------*/


        temp_lag = (temp_lagf- pitch_f_mem [0])*159.0 /
                        ((double) L_FRM+curr_lsf-1.0)+pitch_f_mem [0];


        PIT_PitchInterpolat (temp_lag, pitch_f_mem,

                                                ForPitch_decTEMP, 0);

        }


/*------------------------------------------*/
/*              Sub-frame loop              */
/*------------------------------------------*/


i_s = 0;
for (i_sf = 0; i_sf < n_sf; i_sf++)
        {
        /*==========================================*/


        /*------------------------------------------*/
        /*              Set subframe size           */
        /*------------------------------------------*/


        if (fix_rate_m != RATE4_0K)
                l_sf = L_SF4;
        else
                {
                if (SVS_deci_m == 1)
                        {
                        if (i_sf == N_SF3-1)
                                l_sf = L_SF3;
                        else
                                l_sf = L_SF0;
                        }
                else
                        l_sf = L_SF;
                }
```

```
/*-------------------------------------------------*/
/*        Adaptive Codebook Contribution        */
/*-------------------------------------------------*/


if (SVS_deci_m == 1)
        {


                /*-------------------------------------------------*/
                /*        PP then LTP  ( LTP or PP )        */
                /*-------------------------------------------------*/


                LTP_PP_pitch_ext_decod (ForPitch_decTEMP+i_s,
                                tempext_dec, i_sf, unfcod_dec[0], lag,
                                        lag_f, l_sf);


        }
else


        {
        if ((SVS_deci_m == 0) && (channel.idx_SVS_deci == 1))
                {
                /*-------------------------------------------------*/
                /*              LTP then PP              */
                /*-------------------------------------------------*/


                temp_lag = ((pitchf- lag_f[0])*(i_sf+1.0)*l_sf)/
                                ((double) L_FRM*2.0) + lag_f[0];
                }
        else


                {
                /*-------------------------------------------------*/
                /*              LTP then PP              */
                /*-------------------------------------------------*/


                temp_lag = ((temp_lagf - lag_f[0])*(i_sf+1.0)*l_sf) /
                                ((double) L_FRM+curr_lsf) + lag_f[0];


                }
        lag[i_sf] = (short) temp_lag;
        LTP_pitch_decodtemp(tempext_dec, i_sf, unfcod_dec[0],
                                        temp_lag, l_sf);
```

```
                    }


        /*---------------------------------------------*/
        /*              Gains                    */
        /*---------------------------------------------*/


        gainQ[0] = qua_gainQ[0][i_sf];
        gainQ[1] = qua_gainQ[1][i_sf];


        /*---------------------------------------------*/
        /*          RE-Build the excitation        */
        /*---------------------------------------------*/


        wad_dvector (unfcod_dec[0], gainQ[0], qua_unfcod[1]+i_s,
                            gainQ[1], tempext_dec+MAX_LAG, 0, l_sf-1);


        dot_dvector (tempext_dec+MAX_LAG, tempext_dec+MAX_LAG, &FET,
                            0, l_sf-1);
        FET += EPSI;


        if (lag[i_sf] > 0 )
                {
                if (SVS_deci_m == 1)
                        px = tempext_dec+MAX_LAG-(short)ForPitch_decTEMP[i_s];
                else
                        px = tempext_dec+MAX_LAG-lag[i_sf];


                dot_dvector (px, px, &PFET, 0, l_sf-1);


                AA = sqrt(PFET/FET);
                }
        else
                {
                px = tempext_dec+MAX_LAG-l_sf;
                dot_dvector(px, px, &PFET, 0, l_sf-1);
        AA = sqrt(PFET/FET);
                }


        px = tempext_dec+MAX_LAG;
        sca_dvector(px, AA, px, 0, l_sf-1);
```

```
            cpy_dvector (tempext_dec+l_sf, tempext_dec, 0, MAX_LAG-1);

            i_s += l_sf;

        /*===========================================================*/
        }

    /*-------------------------------------------------------*/
    /*              Replace Adaptive CB                    */
    /*-------------------------------------------------------*/

        cpy_dvector (tempext_dec, ext_dec, 0, MAX_LAG-1);
        }
    /*-------------------------------------------------------*/

    return;

    /*-------------------------------------------------------*/
    }



/*-----------------------------------------------------------*/


/*===========================================================*/
/*----------------------- END -----------------------*/
/*===========================================================*/
```

```
/*=============================================================*/


/*=========================================================*/
/* Conexant System Inc.                        */
/* 4311 Jamboree Road                          */
/* Newport Beach, CA 92660                         */
/*------------------------------------------------------*/
/* Copyright(C) 2000 Conexant System Inc.              */
/*------------------------------------------------------*/
/* ALL RIGHTS RESERVED:                             */
/* No part of this software may be reproduced in any form or by any */
/* means or used to make any derivative work (such as transformation */
/* or adaptation) without the authorisation of Conexant System Inc. */
/*=============================================================*/
/* PROTOTYPE FILE : lib_ltp.h                      */
/*=============================================================*/


/*------------------------------------------------------*/
/*------------------------ FUNCTIONS ------------------------*/
/*------------------------------------------------------*/


void    LTP_init_lib                  (void);


void    LTP_Init_SincWindows  (void);
void    LTP_generate_PitLagTab (void);


FLOAT64     Hwind            (FLOAT64, INT16);
FLOAT64 sincFwin2      (FLOAT64, INT16);
FLOAT64 sincFwin        (FLOAT64, INT16);


void    D2A_InterpWeight      (FLOAT64 [], FLOAT64, INT16);
void    D2A_InterpWeight2     (FLOAT64 [], FLOAT64, INT16);
FLOAT64     D2A_interp                  (FLOAT64 [],FLOAT64 [],INT16, FLOAT64, INT16);


INT16   LTP_lag_to_idx5b          (FLOAT64);
INT16   LTP_lag_to_idx7b          (FLOAT64);
INT16   LTP_lag_to_idx8b          (FLOAT64);
void    LTP_FineIndex_search  (FLOAT64 [], INT16, INT16, INT16, INT16,
                                      FLOAT64 [], INT16 *);
```

```
void    LTP_excit_vari_pitch (FLOAT64 *, INT16, INT16, FLOAT64 [], INT16,
                            FLOAT64[], INT16, FLOAT64 []);


void    LTP_excit_const_pitch    (FLOAT64, INT16, FLOAT64 [], INT16, FLOAT64 [],
                            INT16);


void    LTP_PP_pitch_ext         (FLOAT64 [], FLOAT64 *, FLOAT64 *, FLOAT64 *,
                            INT16, FLOAT64 *, FLOAT64 *, INT16 *,
                            FLOAT64 *, FLOAT64 *, INT16);


void    LTP_PP_pitch_ext_decod   (FLOAT64 [], FLOAT64 *, INT16, FLOAT64 *,
                            INT16 *, FLOAT64 *, INT16);


void    LTP_close_8_5k_pitch (FLOAT64 [], FLOAT64 [], FLOAT64 [], INT16,
                            FLOAT64 [],    FLOAT64 [], INT16 *, FLOAT64 *,
                            FLOAT64 *, FLOAT64 *, INT16, INT16, INT16
[]);


void    LTP_close_7b_pitch       (FLOAT64 [], FLOAT64 [], FLOAT64 [], INT16,
                            FLOAT64 [], FLOAT64 [], INT16 *, FLOAT64 *,
                            FLOAT64 *, FLOAT64 *, INT16, INT16,
                            INT16 []);


void    LTP_pitch_decodtemp (FLOAT64 [], INT16, FLOAT64 [], FLOAT64, INT16);


void    LTP_7b_pitch_decod       (INT16, FLOAT64 [], INT16, FLOAT64 [], INT16 [],
                            FLOAT64 [], INT16, INT16 []);

void    LTP_8_5k_pitch_decod (INT16, FLOAT64 [], INT16, FLOAT64 [], INT16 [],
                            FLOAT64 [], INT16, INT16 []);


void LTP_adap_cbk_correction (INT16, INT16, INT16, INT16, FLOAT64 **,
                            FLOAT64 [], INT16, FLOAT64, INT16 *, FLOAT64 [],
                            INT16 [], FLOAT64 [], FLOAT64 [], FLOAT64 [],
```

FLOAT64 [], FLOAT64 **, PARAMETER);

```
/*========================================================*/
/*----------------- END -------------------------*/
/*========================================================*/
```

```
/*=========================================================*/


/*=========================================================*/
/* Conexant System Inc.                    */
/* 4311 Jamboree Road                      */
/* Newport Beach, CA 92660                  */
/*--------------------------------------------*/
/* Copyright(C) 2000 Conexant System Inc.        */
/*--------------------------------------------*/
/* ALL RIGHTS RESERVED:                    */
/* No part of this software may be reproduced in any form or by any */
/* means or used to make any derivative work (such as transformation */
/* or adaptation) without the authorisation of Conexant System Inc. */
/*=========================================================*/
/* LIBRARY: lib_pit.c                     */
/*=========================================================*/


/*--------------------------------------------*/
/*---------------------- INCLUDE ---------------------*/
/*--------------------------------------------*/


#include "typedef.h"

#include "main.h"
#include "const.h"
#include "gputil.h"

    .

#include "ext_var.h"

#include "lib_pit.h"
#include "lib_ltp.h"


#ifdef DIAGNOSTICS

#include "lib_dia.h"

#endif


/*--------------------------------------------*/
```

573

```c
/*----------------- FUNCTIONS ----------------------*/
/*------------------------------------------------*/


/*================================================================*/
/* FUNCTION    : PIT_LT_Corr_Rmax ().                    */
/*------------------------------------------------*/
/* PURPOSE     : This function performs initialisa the global    */
/*               variables of the PIT library.            */
/*------------------------------------------------*/
/* INPUT ARGUMENTS  :                         */
/*               _ None.                    */
/*------------------------------------------------*/
/* OUTPUT ARGUMENTS :                         */
/*               _ None.                    */
/*------------------------------------------------*/
/* INPUT/OUTPUT ARGUMENTS :                       */
/*               _ None.                    */
/*------------------------------------------------*/
/* RETURN ARGUMENTS :                         */
/*               _ None.                    */
/*================================================================*/

void    PIT_init_lib (void)
        {
        /*------------------------------------------------*/

        lagl = 20;

        /*------------------------------------------------*/

        pitchf = MIN_LAG;

        ini_dvector (pitch_f_mem, 0, PIT_F_MEM-1, MIN_LAG);

        /*------------------------------------------------*/
        /*               PIT_ol_2pitchs               */
        /*------------------------------------------------*/

        VUVm = 1;
        VUVmm = 0;
```

```
        pitch_m = 20;
        pitch_mm = 40;
        Iopt0 = 0;


        ini_svector (PITmax0, 0, NUM_MAX_SRCH-1, 20);


        LagCount = 0;
        VadCount = 0;
        Av_lag = MIN_LAG;


        Rp_m = 0.0;



        ini_svector(ol_lag, 0, N_SF_MAX, 30);
        ini_svector(lag, 0, N_SF_MAX, 30);


        /*----------------------------------------------------------*/


        return;


        /*----------------------------------------------------------*/

        }


/*------------------------------------------------------------------*/


/*================================================================================*/
/* FUNCTION     : PIT_LT_Corr_Rmax ().                      */
/*------------------------------------------------------------*/
/* PURPOSE      : This function performs a first pitch       */
/*               determination by finding NUM_MAX_SRCH maxima in  */
/*               the autocorrelation.                  */
/*                                                */
/*------------------------------------------------------------*/
/* INPUT ARGUMENTS :                              */
/*       _ (INT16)   Low_order : lower autocorrelation order.   */
/*       _ (INT16)   High_order: Higher autocorrelation order.  */
/*       _ (INT16)   L:       length of correlation window.  */
/*       _ (INT16)   L_r:     length of input.           */
/*       _ (FLOAT64 []) res:     input frame.             */
/*------------------------------------------------------------*/
```

```
/* OUTPUT ARGUMENTS :                                    */
/*      _ (INT16 []) PITmax:    autocorrelation maxima       */
/*                  position.                  */
/*      _ (FLOAT64 []) Rmax:    autocorrelation maxima values */
/*-----------------------------------------------------------*/
/* INPUT/OUTPUT ARGUMENTS :                                */
/*              _ None.                   */
/*-----------------------------------------------------------*/
/* RETURN ARGUMENTS :                                */
/*              _ None.                   */
/*===========================================================*/


void     PIT_LT_Corr_Rmax (INT16 Low_order, INT16 High_order, INT16 L,
                            INT16 L_r, FLOAT64 res[], INT16 PITmax [],
                            FLOAT64 Rmax [])

     {
     /*-----------------------------------------------------------*/


     INT16 i, k, i0, T1, T2, K1, K2, L_R, low, high;
     FLOAT64 x, y, eng;
     FLOAT64 R[(HI_LAG2-MIN_LAG+4+2*SINC_LIMIT)];


     /*-----------------------------------------------------------*/
     /*          Residual Aurocorrelation Calculation       */
     /*-----------------------------------------------------------*/


     low    = Low_order-SINC_LIMIT-1;
     high   = High_order+SINC_LIMIT+1;
     L_R    = high-low+1;

#ifdef VERBOSE
     if (L_R>=HI_LAG2-MIN_LAG+4+2*SINC_LIMIT)
             {
             printf(" L_R>=HI_LAG2-MIN_LAG+4+2*SINC_LIMIT !!!\n");
             exit(0);
             }
#endif

     i0 = L_r-L;
     dot_dvector (res+i0, res+i0, &eng, 0, L-1);
```

```
dot_dvector (res+i0-low+1, res+i0-low+1, &y, 0, L-1);
for (i = low; i <= high; i++)
        {
        dot_dvector (res+i0, res+i0-i, &R[i-low], 0, L-1);
        y += res[i0-i]*res[i0-i];
        y -= res[i0-i+L]*res[i0-i+L];
        R[i-low] /= sqrt(MAX(y*eng, 0.01));
        }


/*----------------------------------------------------*/
/*              Determine 4 best lags              */
/*----------------------------------------------------*/


T2 = Low_order;
for (k = 0; k < 4; k++)
    {
    /*----------------------------------------------------*/
    /*                  Initial search                 */
    /*----------------------------------------------------*/


    T1 = T2;
    T2 = MIN(T1*2, High_order+1);
    PITmax[k] = T1;
    Rmax[k] = R[T1-low];
    for (i = T1+1; i < T2; i++)
            {
            if(R[i-low] > Rmax[k])
                    {
                    Rmax[k]=R[i-low];
                    PITmax[k]=i;
            }
            }


    /*----------------------------------------------------*/
    /*        Further search with low-pass filtering     */
    /*----------------------------------------------------*/


    K1 = MAX(PITmax[k]-1, Low_order);
    K2 = MIN(PITmax[k]+1, High_order);
    x = K1-low;
```

```
R[K1-low] = D2A_interp(SincWindows, R, L_R, x, SINC_LIMIT);
PITmax[k] = K1;
Rmax[k] = R[K1-low];
for(i = K1+1; i <= K2; i++)
        {
        x = i-low;
        R[i-low] = D2A_interp(SincWindows, R, L_R, x, SINC_LIMIT);
        if (R[i-low] > Rmax[k])
                {
                PITmax[k] = i;
                Rmax[k]=R[i-low];
                }
        }


        /*===============================================================*/
    }


        /*--------------------------------------------------------*/
        /*           In case of 3 regions           */
        /*--------------------------------------------------------*/


        if (Low_order*8 >= High_order)
                {
                PITmax[3] = PITmax[2];
                Rmax[3] = Rmax[2];
                }


        /*--------------------------------------------------------*/


        return;


        /*--------------------------------------------------------*/
    }



/*--------------------------------------------------------*/


/*===============================================================*/
/* FUNCTION    : PIT_FirstPitchLag ().           */
/*--------------------------------------------------------*/
```

```
/* PURPOSE    :  This function performs a first pitch        */
/*              determination.                      */
/*                                         */
/*---------------------------------------------------------*/
/* INPUT ARGUMENTS :                          */
/*       _ (INT16  []) PITmax:   autocorrelation maxima      */
/*                       position.                */
/*       _ (FLOAT64 []) Rmax:    autocorrelation maxima values  */
/*---------------------------------------------------------*/
/* OUTPUT ARGUMENTS :                         */
/*       _ (INT16  *) lag_opt:  optimum lag position.       */
/*       _ (FLOAT64 *) R_opt:    optimum lag frame          */
/*                       autocorrelation value.       */
/*       _ (INT16  *) Iopt:    optimum PITmax index.        */
/*---------------------------------------------------------*/
/* INPUT/OUTPUT ARGUMENTS :                       */
/*                 _ None.                  */
/*---------------------------------------------------------*/
/* RETURN ARGUMENTS :                         */
/*                 _ None.                  */
/*=========================================================*/


void    PIT_FirstPitchLag (INT16 PITmax [], FLOAT64 Rmax [], INT16 *lag_opt,
                                          FLOAT64 *R_opt, INT16 *Iopt)

        {
        /*---------------------------------------------------------*/


        FLOAT64 MaxR;
        INT16   i;


        /*---------------------------------------------------------*/
        /*              First search and correction          */
        /*---------------------------------------------------------*/


        (*Iopt) = 0;
        MaxR  = Rmax[0];
        for (i = 1; i < NUM_MAX_SRCH; i++)
                {
                if (Rmax[i] > MaxR)
                        {
```

```
                    (*Iopt) = i;
                    MaxR    = Rmax[i];
                    }
            }


        /*----------------------------------------------------*/


        (*lag_opt)        = PITmax[(*Iopt)];
        (*R_opt)         = MaxR;


        /*----------------------------------------------------*/


        return;


        /*----------------------------------------------------*/
        }


    /*----------------------------------------------------------*/


    /*============================================================*/
    /* FUNCTION     : PIT_PitchLagCorrect ().              */
    /*--------------------------------------------------------*/
    /* PURPOSE      : This function corrects the first pitch    */
    /*                determination.                       */
    /*                                                  */
    /*--------------------------------------------------------*/
    /* INPUT ARGUMENTS :                              */
    /*        _ (INT16    ) pitch_m:   pitch of previous frame.    */
    /*        _ (INT16    ) VUVm:     voice / unvoiced decision of  */
    /*                      previous frame.          */
    /*        _ (INT16    ) pitch_mm:  pitch value of 2 frames      */
    /*                      earlier.              */
    /*        _ (INT16    ) VUVmm:    voice / unvoiced decision of  */
    /*                      2 frames earlier.           */
    /*        _ (INT16   []) PITmax:   autocorrelation maxima      */
    /*                      position.              */
    /*        _ (FLOAT64 []) Rmax:     autocorrelation maxima values  */
    /*--------------------------------------------------------*/
    /* OUTPUT ARGUMENTS :                             */
    /*        _ (INT16   *) Iop:      optimum PITmax index.      */
```

```
/*------------------------------------------------------*/
/* INPUT/OUTPUT ARGUMENTS :                    */
/*              _ None.                   */
/*------------------------------------------------------*/
/* RETURN ARGUMENTS :                      */
/*     _ (INT16  ) PITi:    corrected pitch value.   */
/*======================================================*/


INT16 PIT_PitchLagCorrect(INT16 pitch_m,INT16 VUVm,INT16 pitch_mm,INT16 VUVmm,
           INT16 hi_lag,INT16 *Iop,INT16 *PITmax,FLOAT64 *Rmax)
        {
        /*------------------------------------------------*/


        INT16   PITi, i, k, P1, P2, PIT_test, Iopt, flag;
        INT16   Decis_m, Decis_mm;


        FLOAT64      D, D0;


        /*------------------------------------------------*/


        Iopt    = *Iop;
        PITi    = PITmax[Iopt];


        /*------------------------------------------------*/
        /*              Second Correction            */
        /*------------------------------------------------*/


        D0 = 1.0;
        for (i = Iopt-1; i >= 0; i--)
            {
            /*------------------------------------------*/


            P1 = (INT16)MAX(PITmax[i]*0.7, MIN_LAG);
            P2 = (INT16)MIN(PITmax[i]*1.3, hi_lag);


            D = D0;
            if (VUVm>3 || (VUVm>2 && VUVmm>2))
                {
                if (Rmax[i] > 0.95) D = 0.95*D0;
                }
```

```
else
        {
        if (Rmax[i] > 0.85) D=0.9*D0;
        }


/*---------------------------------------------*/


Decis_m =  (VUVm  > 2 && pitch_m  >= P1 && pitch_m  <= P2);
Decis_mm = (VUVmm > 2 && pitch_mm >= P1 && pitch_mm <= P2);


if (Decis_m || Decis_mm)
        D = 0.85*D0;
if (Decis_m && Decis_mm)
        D = 0.65*D0;


/*---------------------------------------------*/


Decis_m = (VUVm > 3 && pitch_m >= P1 && pitch_m <= P2);
Decis_mm = (VUVmm > 3 && pitch_mm >= P1 && pitch_mm <= P2);


if (Decis_m || Decis_mm)
        D = 0.75*D0;
if (Decis_m && Decis_mm)
        D = 0.6*D0;


/*---------------------------------------------*/


flag = 0;
for (k = 2; k <= 4; k++)
        {
        PIT_test        =        PITmax[Iopt]/k;
        P1              =        (INT16)MAX(PIT_test*0.8, MIN_LAG);
        P2              =        (INT16)MIN(PIT_test*1.2, hi_lag);

        if (PITmax[i] >= P1 && PITmax[i] <= P2)
                flag=1;
        }


/*---------------------------------------------*/
```

```
                    if ((flag == 1) && (Rmax[i] > D*Rmax[Iopt])
                        && (Rmax[i] > 0.25))
                        {
                        PITi = PITmax[i];
                        *Iop = i;


                        break;
                        }


              /*_____*/
              }


          /*_____*/


          return  PITi;


          /*_____*/
          }


      /*_____*/


      /*================================================================*/
      /* FUNCTION     : PIT_ol_2pitchs ().                 */
      /*_____*/
      /* PURPOSE      : This function estimati the 2 pitch per frame.   */
      /*                                        */
      /*_____*/
      /* INPUT ARGUMENTS :                       */
      /*     _ (FLOAT64 []) wspeech:   weighted input speech.      */
      /*     _ (INT16    ) L_ws:     input frame size.        */
      /*     _ (FLOAT64 []) Rp:      autocorrelation maxima values */
      /*     _ (INT16    ) vad:     vad decision.          */
      /*_____*/
      /* OUTPUT ARGUMENTS :                      */
      /*     _ (INT16   []) lag:     estimated lag values.      */
      /*_____*/
      /* INPUT/OUTPUT ARGUMENTS :                    */
      /*             _ None.                  */
      /*_____*/
      /* RETURN ARGUMENTS :                       */
```

```
/*                  _ None.                    */
/*==========================================================*/



void   PIT_ol_2pitchs (FLOAT64 wspeech[], INT16 L_ws, INT16 lag[] ,
                             FLOAT64 Rp[], INT16 frame_class, INT16 hi_lag)
     {
        /*----------------------------------------------------*/


        INT16  i, L_corr, L, Iopt, Iopt1, Iopt2, CorrectFlag,
           PITmax1[NUM_MAX_SRCH], PITmax2[NUM_MAX_SRCH];


        FLOAT64  Rmax1[NUM_MAX_SRCH], Rmax2[NUM_MAX_SRCH];


        /*----------------------------------------------------*/
        /*        Open loop pitch estimation in lookahead       */
        /*----------------------------------------------------*/


        L_corr = L_FRM/2;
        lag[0] = lag[2];
        Rp[0]  = Rp[2];


        /*----------------------------------------------------*/
        /*        Calculate the autocorrelation values        */
        /*----------------------------------------------------*/


        L = MIN(L_ws-L_LPCLHD+L_corr, L_ws);
        PIT_LT_Corr_Rmax(MIN_LAG,hi_lag,L_corr,L,wspeech,PITmax2,Rmax2);


        /*----------------------------------------------------*/
        /*          Searching for integer pitch             */
        /*----------------------------------------------------*/


        PIT_FirstPitchLag(PITmax2, Rmax2, &(lag[2]), &(Rp[2]), &Iopt2);
        Iopt = Iopt2;
           lag[2] = PIT_PitchLagCorrect(pitch_m, VUVm, pitch_mm, VUVmm, hi_lag,
                        &Iopt2, PITmax2, Rmax2);
        Rp[2] = Rmax2[Iopt2];


        /*----------------------------------------------------*/
```

```
/*              Open loop pitch in second half frame          */
/*----------------------------------------------------------*/


if ((VUVmm < 3) && (VUVm < 3))
        {
        if (Rp[2] > 0.5)
                {
                VUVmm=3;
                pitch_mm=lag[2];
                if (Rp[0]>0.5 && lag[0]<lag[2])
                        pitch_mm=lag[0];
                }
        else
                {
                if (Rp[0] > 0.5)
                        {
                        VUVmm = 3;
                        pitch_mm = lag[0];
                        }
                }
        }


/*----------------------------------------------------------*/
/*        Calculate the autocorrelation values          */
/*----------------------------------------------------------*/


L = L_ws-L_LPCLHD;
PIT_LT_Corr_Rmax(MIN_LAG,hi_lag,L_corr,L,wspeech,PITmax1,Rmax1);


/*----------------------------------------------------------*/
/*            Searching for integer pitch          */
/*----------------------------------------------------------*/


PIT_FirstPitchLag (PITmax1, Rmax1, &(lag[1]), &(Rp[1]), &Iopt1);
Iopt = Iopt1;
lag[1] = PIT_PitchLagCorrect(pitch_m, VUVm, pitch_mm, VUVmm, hi_lag,
            &Iopt1, PITmax1, Rmax1);
Rp[1] = Rmax1[Iopt1];
```

```
/*------------------------------------------------------------*/
/*              Second correction for lag [1]            */
/*------------------------------------------------------------*/


CorrectFlag=0;

if (abs(lag[2]-pitch_m) < 0.25*MIN(lag[2],pitch_m) &&
    abs(lag[2]-lag[1]) > 0.25*lag[1] &&
    (Rp[2]>0.5 || Rp_m>0.5) )
    {
            if (Rp[2] > 0.5)
                    pitch_mm = lag[2];
            else
                    pitch_mm = pitch_m;
            CorrectFlag = 1;
            }


if (abs(lag[2]-lag[0]) < 0.25*MIN(lag[2],lag[0]) &&
    abs(lag[2]-lag[1]) > 0.25*lag[1] )
    {
            if ((Rp[2] > 0.5) && (Rp[0] > 0.5))
                    {
                    lag[1] = (lag[0]+lag[2])/2;
                    CorrectFlag = 0;
                    }
            else
                    {
                    if (Rp[0] > 0.5)
                            {
                            pitch_mm = lag[0];
                            CorrectFlag = 1;
                            }
                    if (Rp[2] > 0.5)
                            {
                            pitch_mm = lag[2];
                            CorrectFlag = 1;
                            }
                    }
            }
```

```
if (((lag[1]-lag[2] >= 0.3*MIN(lag[1],lag[2])) &&
(Rp[2]>1.25*Rp[1] && Rp[1]<0.75 && Rp[2]>0.5)) ||
    ((lag[2]-lag[1]>0.3*lag[1]) && (Rp[2]>1.25*Rp[1] && Rp[2]>0.5)))
                {
                lag[1] = lag[2];
                CorrectFlag = 0;
                }


if (CorrectFlag==1)
        {
        for (i=0;i<NUM_MAX_SRCH;i++)
                {
                if ((PITmax1[i] > 0.75*pitch_mm) &&
                        (PITmax1[i] < 1.25*pitch_mm) &&
                            (Rmax1[i] > 0.5*Rmax1[Iopt1]) &&
                            (PITmax1[i] >
PITmax1[Iopt1]/NUM_MAX_SRCH) )
                                {
                                lag[1] = PITmax1[i];
                                Rp[1] = Rmax1[i];

                                break;
                                }
                        }
                }


/*-------------------------------------------------*/
/*          Second correction for lag [0]          */
/*-------------------------------------------------*/

CorrectFlag=0;
if ((lag[0]-lag[1] >= 0.25*MIN(lag[0],lag[1])) &&
(Rp[1] > 1.1*Rp[0]) && (Rp[0] < 0.75) && (Rp[1] > 0.5))
        {
        pitch_mm = lag[1];
        CorrectFlag = 1;
        }


if (abs(lag[2]-lag[1]) < 0.25*MIN(lag[2],lag[1]) &&
    abs(lag[0]-lag[1]) > 0.25*lag[0] && Rp[1] > 0.5) {
```

```
                  pitch_mm=lag[1];
                  CorrectFlag=1;
              }

      if (abs(lag[1]-pitch_m) < 0.25*MIN(lag[1],pitch_m) &&
         abs(lag[1]-lag[0]) > 0.25*lag[0] ) {
             if (Rp[1]>0.5 && Rp_m>0.5) {
                 lag[0]=(pitch_m+lag[1])/2;
                     CorrectFlag=0;
             }
             else {
                     if (Rp_m>0.5) {
                 pitch_mm=pitch_m;
                 CorrectFlag=1;
             }
                     if (Rp[1]>0.5) {
                 pitch_mm=lag[1];
                 CorrectFlag=1;
             }
             }
         }

      if (CorrectFlag==1) {
             for (i=0;i<NUM_MAX_SRCH;i++) {
                     if (PITmax0[i] > 0.75*pitch_mm &&
                 PITmax0[i] < 1.25*pitch_mm &&
                     Rmax0[i] > 0.75*Rmax0[Iopt0] &&
                 PITmax0[i] > PITmax0[Iopt0]/NUM_MAX_SRCH )
                     {
                         lag[0]=PITmax0[i];
                         Rp[0]=Rmax0[i];
                         break;
                     }
             }
      }


/*----------------------------------------------------------*/
/*                    Set large lag                 */
/*----------------------------------------------------------*/
```

```
if ((frame_class >= 3) && (lag[1] < 50) &&
        (Av_lag > MAX(2.25*lag[1], 50)))
    {
        if (PITmax1[1]>lag[1] && Rmax1[1]>Rmax1[2])
            {
            lag[1] = MAX(PITmax1[1], pitch_m);
            Rp[1]  = Rmax1[1];
            }
        else
            {
            if (Rmax1[3]>Rmax1[2])
                {
                lag[1] = MAX(PITmax1[3], pitch_m);
                Rp[1]  = Rmax1[3];
                }
            else
                {
                lag[1] = MAX(PITmax1[2], pitch_m);
                Rp[1]  = Rmax1[2];
                }
            }
    }

if ((frame_class >= 3) && (lag[0] < 50) &&
        (Av_lag > MAX(2.25*lag[0], 50)))
    {
        if ((PITmax0[1] > lag[0]) && (Rmax0[1] > Rmax0[2]))
            {
            lag[0] = MAX(PITmax0[1], pitch_m);
            Rp[0]  = Rmax0[1];
            }
        else
            {
            if (Rmax0[3] > Rmax0[2])
                {
                lag[0] = MAX(PITmax0[3], pitch_m);
                Rp[0] = Rmax0[3];
                }
            else
                {
```

```
                                        lag[0] = MAX(PITmax0[2], pitch_m);
                                        Rp[0]  = Rmax0[2];
                                    }
                                }
                            }


/*------------------------------------------------------------------*/
/*                 Estimate Average pitch               */
/*------------------------------------------------------------------*/


if ((frame_class >=3) && (Rp[1] > 0.5) && (lag[1] > 0.7*pitch_m)
    && (lag[1] < 1.3*pitch_m))
                LagCount++;
else
                LagCount = 0;


if (LagCount >= 2)
    Av_lag=(short)((double)Av_lag*0.75+(double)lag[1]*0.25);


if (frame_class <= 0)
    VadCount++;
else
    VadCount=0;


if (VadCount > 3)
    Av_lag = 40/*MIN_LAG*/;




/*------------------------------------------------------------------*/
/*                 Update memory               */
/*------------------------------------------------------------------*/


pitch_mm = pitch_m;
pitch_m = lag[1];
VUVmm = VUVm;
VUVm = 1;
if (Rp[1] > 0.25)
    VUVm = 2;
if (Rp[1] > 0.5)
    VUVm = 3;
```

```
if (Rp[1] > 0.75)
    VUVm = 4;
Rp_m = Rp[1];
Iopt0 = Iopt2;
for (i = 0; i < NUM_MAX_SRCH; i++)
    {
            PITmax0[i] = PITmax2[i];
            Rmax0[i] = Rmax2[i];
            }


/*---------------------------------------------------*/
/*                  high limit                */
/*---------------------------------------------------*/


if (hi_lag == HI_LAG)
    {
        if (lag[0] > HI_LAG)
                {
                if ((PITmax0[2] <= HI_LAG) && (PITmax0[2] > L_SF))
                        lag[0] = PITmax0[2];
                else
                        lag[0] = HI_LAG;
                }


        if (lag[1] > HI_LAG)
                {
                if ((PITmax1[2] <= HI_LAG) && (PITmax1[2] > L_SF))
                        lag[1] = PITmax1[2];
                else
                        lag[1] = HI_LAG;
                }
        }


        /*---------------------------------------------------*/


        return;


        /*---------------------------------------------------*/
        }
```

EP 1 214 706 B1

```
/*-------------------------------------------------------------*/


/*==========================================================*/
/* FUNCTION    : PIT_FinePitch ().                  */
/*-------------------------------------------------------------*/
/* PURPOSE     : This function corrects the pitch refinement.   */
/*                                         */
/*-------------------------------------------------------------*/
/* INPUT ARGUMENTS :                        */
/*      _ (INT16    ) bitrate:    bitrate value.          */
/*      _ (INT16    ) low_pitch:  low pitch value.         */
/*      _ (INT16    ) high_pitch: high pitch value.        */
/*      _ (FLOAT64 []) res:     weighted speech.         */
/*      _ (INT16    ) L_r:      length of wspeech.        */
/*      _ (FLOAT64  ) Delay_pp:  pre-processing delay.       */
/*-------------------------------------------------------------*/
/* OUTPUT ARGUMENTS :                       */
/*      _ (FLOAT64 *) Rp_max:    autocorrelation maximum value */
/*      _ (FLOAT64 *) pitchf:    PitLagTab7b extracted pitch   */
/*                   value           */
/*      _ (INT16   *) index:    optimum PitLagTab7b index.   */
/*-------------------------------------------------------------*/
/* INPUT/OUTPUT ARGUMENTS :                    */
/*             _ None.                 */
/*-------------------------------------------------------------*/
/* RETURN ARGUMENTS :                       */
/*      _ (INT16   ) PITi:    pitch value.          */
/*==========================================================*/


INT16   PIT_FinePitch (INT16 bitrate, INT16 low_pit, INT16 high_pit, FLOAT64 res[],
                       INT16 L_r, FLOAT64 Delay_pp, FLOAT64 *Rp_max,
                       FLOAT64 *pitchf, INT16 *index)

        {
        /*-------------------------------------------------------------*/


        FLOAT64      MaxR, x, y, z, R[(20+2*SINC_LIMIT)];
        INT16   i0, i, LowL, HighL, L_R, PITi, L, P1, P2;


        /*-------------------------------------------------------------*/
        /*            Determine the correlation          */
```

592

```
/*---------------------------------------------------------------*/


LowL   = low_pit  - SINC_LIMIT - 2;
HighL  = high_pit + SINC_LIMIT + 2;
L_R    = HighL - LowL + 1;


/*---------------------------------------------------------------*/


L      = L_FRM/2;
i0     = L_r-L/2;


dot_dvector (res+i0, res+i0, &x, 0, L-1);


for (i = LowL; i <= HighL; i++)
        {
        dot_dvector (res+i0-i, res+i0-i, &y, 0, L-1);
        dot_dvector (res+i0, res+i0-i, &z, 0, L-1);
        R[i-LowL] =  z / sqrt(MAX(x*y, 0.0001));
        }


/*---------------------------------------------------------------*/
/*              Searching for integer pitch              */
/*---------------------------------------------------------------*/


PITi = low_pit;
MaxR = R[low_pit-LowL];
for (i = low_pit+1; i <= high_pit; i++)
if (R[i-LowL] > MaxR)
        {
        PITi = i;
        MaxR = R[i-LowL];
        }


if (bitrate == RATE8_5K)
    {
        /*---------------------------------------------------------------*/
        /*      Search for the best precise pitch and index      */
        /*---------------------------------------------------------------*/
```

```
            P1 = LTP_lag_to_idx8b ((double)(PITi-1.0));

            P2 = LTP_lag_to_idx8b ((double)(PITi+1.0));

            LTP_FineIndex_search (PitLagTab8b, P1, P2, LowL, L_R, R, index);


            /*----------------------------------------------------------*/

            /*                  Estimate Rp_max                    */

            /*----------------------------------------------------------*/


            PITi = (INT16)(PitLagTab8b[*index]+0.5-LowL);

            (*Rp_max) = R[PITi];

            PITi = (INT16)(PitLagTab8b[*index]+0.5);


            /*----------------------------------------------------------*/

            /*                  Modify pitch index                 */

            /*----------------------------------------------------------*/


            if (Delay_pp > 10)

                    (*index) = MIN((*index)+1, MAX_PIT_IDX_8b);


            if (Delay_pp < -10)

                    (*index) = MAX((*index)-1,0);


            if (Delay_pp > 15)

                    (*index) = MIN((*index)+1, MAX_PIT_IDX_8b);

            if (Delay_pp<-15)

                    (*index) = MAX((*index)-1, 0);


            (*pitchf) = PitLagTab8b[(*index)];

            PITi = (INT16)MIN(*pitchf+0.5, high_pit);

            }

    else

            {

            /*----------------------------------------------------------*/

            /*      Search for the best precise pitch and index       */

            /*----------------------------------------------------------*/


            P1 = LTP_lag_to_idx7b((FLOAT64)(PITi-1.0));

            P2 = LTP_lag_to_idx7b((FLOAT64)(PITi+1.0));


            LTP_FineIndex_search(PitLagTab7b, P1, P2, LowL, L_R, R, index);
```

```
/*-----------------------------------------------------*/
/*              Estimate Rp_max              */
/*-----------------------------------------------------*/


PITi      = (INT16)(PitLagTab7b[*index] + 0.5 - LowL);
(*Rp_max) = R[PITi];
PITi      = (INT16)(PitLagTab7b[*index] + 0.5);




/*-----------------------------------------------------*/
/*              Modify pitch index              */
/*-----------------------------------------------------*/


if (Delay_pp > 10)
        (*index) = MIN((*index)+1, MAX_PIT_IDX_7b);


if (Delay_pp < -10)
        (*index) = MAX((*index)-1, 0);


(*pitchf) = PitLagTab7b[(*index)];


PITi = (INT16)MIN(*pitchf+0.5, high_pit);


        }


/*-----------------------------------------------------*/


return   PITi;


/*-----------------------------------------------------*/
}


/*-----------------------------------------------------*/


/*=====================================================*/
/* FUNCTION    : PIT_PitchInterpolat ().           */
/*-----------------------------------------------------*/
/* PURPOSE    : This function calculate the interpolated pitch */
/*              track.                        */
```

```
/*------------------------------------------------*/
/* INPUT ARGUMENTS :                          */
/*      _ (FLOAT64  ) pitch:    current pitch value.      */
/*      _ (FLOAT64  ) pitch_1:   previous frame (n-1) pitch.   */
/*      _ (FLOAT64  ) pitch_2:   previous frame (n-2) pitch.   */
/*      _ (INT16    ) enc_flag:  signals encoder (=1) or decoder*/
/*                  (=0) operation.            */
/*------------------------------------------------*/
/* OUTPUT ARGUMENTS :                         */
/*      _ (FLOAT64 []) ForPitch:   interpolated pitch track.    */
/*------------------------------------------------*/
/* INPUT/OUTPUT ARGUMENTS :                       */
/*            _ None.                    */
/*------------------------------------------------*/
/* RETURN ARGUMENTS :                         */
/*            _ None.                    */
/*================================================*/


void PIT_PitchInterpolat (FLOAT64 pitch, FLOAT64 pitch_mem [],
                    FLOAT64 ForPitch[], INT16 enc_flag)
       {
       /*------------------------------------------------*/

       INT16   i;
       FLOAT64 pitch_mean;

       /*------------------------------------------------*/

       pitch_mean     = (pitch_mem [1] + pitch)*0.5;

       /*------------------------------------------------*/

       if ( (fabs(pitch_mem [0]-pitch)< 0.2*0.5*(pitch_mem [0]+pitch)) ||
                (fabs(pitch_mem [0]-pitch_mean) < 0.15*pitch_mem [0]))
            {
            for (i = 0; i < L_FRM; i++)
                   ForPitch [i] = (i*pitch+(L_FRM-i)*pitch_mem [0]) / L_FRM;
            if(enc_flag == 1)
             for (i = 0; i < L_FRM/2; i++)
               ForPitch [i + L_FRM] = pitch;
```

```
                    }
            else
                {
                if(enc_flag == 1)
                        for (i = 0; i < L_FRM+L_FRM/2; i++)
                                ForPitch[i] = pitch;
                    else
                        for (i = 0; i < L_FRM; i++)
                                ForPitch[i] = pitch;
                }


            /*----------------------------------------------------*/


            return;


            /*----------------------------------------------------*/
            }


/*----------------------------------------------------------*/


/*==========================================================*/
/* FUNCTION     : PIT_pitch_track_recons ().            */
/*----------------------------------------------------*/
/* PURPOSE      : This function reconstruct the pitch track in  */
/*               case of frame erasure.                */
/*----------------------------------------------------*/
/* INPUT ARGUMENTS :                          */
/* _ (INT16) fix_rate_m:    previous frame fixed rate.      */
/* _ (INT16) bfi:          frame # n Bad Frame Indicator.     */
/* _ (INT16) past_bfi:     frame # n-1 Bad Frame Indicator.    */
/* _ (INT16) ppast_bfi:    frame # n-2 Bad Frame Indicator.    */
/* _ (FLOAT64 []) lag_f:    decoded pitch lags             */
/* _ (INT16) SVS_deci_m:    frame # n-1 mode indicator.       */
/* _ (FLOAT64 **) qua_gainQ: adaptive and fixed codebook gains.  */
/* _ (parameter) channel:   decoded parameters indexes structure. */
/*----------------------------------------------------*/
/* OUTPUT ARGUMENTS :                         */
/*    _ (FLOAT64 *) pitchf:      extrapolated pitch value.   */
/*    _ (FLOAT64 *) ForPitch_decTEMP: interpolated pitch track.  */
/*----------------------------------------------------*/
```

597

```
/* INPUT/OUTPUT ARGUMENTS :                      */
/*    _ (FLOAT64 []) pitch_f_mem : past pitch values.      */
/*---------------------------------------------------*/
/* RETURN ARGUMENTS :                  ·      */
/*    _ None.                        */
/*===========================================================*/


void PIT_pitch_track_recons (INT16        fix_rate_m, INT16        bfi, INT16        past_bfi,
                             INT16 ppast_bfi, FLOAT64 lag_f[], INT16 SVS_deci_m,
                             FLOAT64 **qua_gainQ, PARAMETER channel,
                             FLOAT64 *pitchf, FLOAT64 pitch_f_mem [],
                             FLOAT64 ForPitch_decTEMP [])
    {
    /*---------------------------------------------------*/

    FLOAT64 temp_lagf;

    /*---------------------------------------------------*/

    if ((bfi == 0) && ((ppast_bfi == 1) || (past_bfi == 0)))
            {
            pitch_index = channel.idx_pitch[0];

            pitch_f_mem [1] = pitch_f_mem [0];
            pitch_f_mem [0] = (*pitchf);

            if (channel.fix_rate==RATE8_5K)
                    (*pitchf) = PitLagTab8b[pitch_index];
            else
                    (*pitchf) = PitLagTab7b[pitch_index];

            if ((fix_rate_m == RATE2_0K) || (fix_rate_m == RATE0_8K))
                    {
            pitch_f_mem [1] = (*pitchf);
            pitch_f_mem [0] = (*pitchf);
                    }
            else if (SVS_deci_m == 0)
                    {
                    if (fix_rate_m != RATE8_5K)
                            {
```

```
                              pitch_f_mem [1] = lag_f[N_SF2-1];
                              pitch_f_mem [0] = lag_f[N_SF2-1];
                              }
                    else
                              {
                              pitch_f_mem [1] = lag_f[N_SF4-1];
                              pitch_f_mem [0] = lag_f[N_SF4-1];
                              }
                    }
          }
else
     {
     if ((bfi == 0) && (ppast_bfi == 0) && (past_bfi == 1))
               {
               if ((fix_rate_m == RATE2_0K) ||
                              (fix_rate_m == RATE0_8K))
                              {
                               pitch_f_mem [1] = (*pitchf);
                               pitch_f_mem [0] = (*pitchf);
                               }
               else if (SVS_deci_m == 0)
                    {
                    if (fix_rate_m != RATE8_5K)
                              {
                              pitch_f_mem [1] = lag_f[N_SF2-1];
                              pitch_f_mem [0] = lag_f[N_SF2-1];
                              }
                         else
                              {
                              pitch_f_mem [1] = lag_f[N_SF4-1];
                              pitch_f_mem [0] = lag_f[N_SF4-1];
                              }
                    }

     pitch_index = channel.idx_pitch[0];
     if (channel.fix_rate == RATE8_5K)
               (*pitchf) = PitLagTab8b[pitch_index];
     else
               (*pitchf) = PitLagTab7b[pitch_index];
     temp_lagf = ((*pitchf) - pitch_f_mem [0])*159.0 / 319.0
```

```
                                                + pitch_f_mem [0];

               if (SVS_deci_m == 1)
                     PIT_PitchInterpolat (temp_lagf, pitch_f_mem,
                                    ForPitch_decTEMP, 0);

               pitch_f_mem [1] = pitch_f_mem [0];

               if ((SVS_deci_m == 1) || (qua_gainQ[0][0] >= 0.6))
                            pitch_f_mem [0] = temp_lagf;

          }
     else
          {
          pitch_f_mem [1] = pitch_f_mem [0];
          pitch_f_mem [0] = (*pitchf);
          }
     }

     /*--------------------------------------------------------*/

     return;

     /*--------------------------------------------------------*/
     }

/*-----------------------------------------------------------*/

/*=========================================================*/
/*---------------------- END ----------------------*/
/*=========================================================*/
```

```
/*===========================================================================*/


/*=====================================================================*/
/* Conexant System Inc.                          */
/* 4311 Jamboree Road                            */
/* Newport Beach, CA 92660                        */
/*------------------------------------------------*/
/* Copyright(C) 2000 Conexant System Inc.              */
/*------------------------------------------------*/
/* ALL RIGHTS RESERVED:                           */
/* No part of this software may be reproduced in any form or by any  */
/* means or used to make any derivative work (such as transformation */
/* or adaptation) without the authorisation of Conexant System Inc.  */
/*======================================================================*/
/* LIBRARY: lib_pit.h                           */
/*======================================================================*/



/*-------------------------------------------------*/
/*-------------------------- FUNCTIONS -------------------------*/
/*-------------------------------------------------*/


void PIT_init_lib              (void);


void PIT_LT_Corr_Rmax          (INT16, INT16, INT16, INT16, FLOAT64 [], INT16 *,
                                    FLOAT64 *);


void PIT_FirstPitchLag          (INT16 *, FLOAT64 *, INT16 *, FLOAT64 *, INT16 *);


INT16 PIT_PitchLagCorrect       (INT16, INT16, INT16, INT16, INT16, INT16 *,
                                    INT16 *, FLOAT64 *);


void PIT_ol_2pitchs                (FLOAT64 [], INT16, INT16 [] , FLOAT64 [], INT16,
                                    INT16);


INT16 PIT_FinePitch                (INT16, INT16, INT16, FLOAT64 [], INT16, FLOAT64,
                                    FLOAT64 *, FLOAT64 *, INT16 *);



void PIT_PitchInterpolat (FLOAT64, FLOAT64 [], FLOAT64 [], INT16);
```

.

```
void PIT_pitch_track_recons (INT16, INT16, INT16, INT16, FLOAT64 [], INT16,
                                        FLOAT64 **, PARAMETER, FLOAT64 *,
                                        FLOAT64 [], FLOAT64 []);



/*=============================================================================*/
/*----------------------------- END -----------------------------*/
/*=============================================================================*/
```

```
/*====================================================================*/


/*===============================================================*/
/* Conexant System Inc.                        */
/* 4311 Jamboree Road                          */
/* Newport Beach, CA 92660                       */
/*----------------------------------------------*/
/* Copyright(C) 2000 Conexant System Inc.              */
/*----------------------------------------------*/
/* ALL RIGHTS RESERVED:                        */
/* No part of this software may be reproduced in any form or by any */
/* means or used to make any derivative work (such as transformation */
/* or adaptation) without the authorisation of Conexant System Inc.  */
/*===============================================================*/
/* LIBRARY: lib_ppp.c                         */
/*===============================================================*/


/*----------------------------------------------*/
/*---------------------- INCLUDE -------------------------*/
/*----------------------------------------------*/


#include "typedef.h"


#include "main.h"
#include "const.h"
#include "gputil.h"
#include "ext_var.h"


#include "lib_lpc.h"
#include "lib_flt.h"
#include "lib_ltp.h"
#include "lib_ppp.h"


#ifdef DIAGNOSTICS


#include "lib_dia.h"


#endif
```

```
/*—————————————————————————*/
/*————————————— FUNCTIONS —————————————*/
/*—————————————————————————*/


/*=======================================================*/
/* FUNCTION    :  PPP_init_lib ().              */
/*—————————————————————————*/
/* PURPOSE     : This function initialise the global variables of */
/*          the library PPP.                  */
/*—————————————————————————*/
/* INPUT ARGUMENTS :                      */
/*     _ None.                          */
/*—————————————————————————*/
/* OUTPUT ARGUMENTS :                      */
/*     _ None.                          */
/*—————————————————————————*/
/* INPUT/OUTPUT ARGUMENTS :                    */
/*     _ None.                          */
/*—————————————————————————*/
/* RETURN ARGUMENTS :                      */
/*     _ None.                          */
/*=======================================================*/


void PPP_init_lib (void)
        {
        /*—————————————————————————*/
        /*              pitch_preproc              */
        /*—————————————————————————*/


        Delay_pp = 0.0;
        frame_class_pp_m = 3;
        Last_Rp = 0.0;


        /*—————————————————————————*/


        return;


        /*—————————————————————————*/
        }
```

```
/*-------------------------------------------------------------*/


/*==========================================================*/
/* FUNCTION    : PPP_mapping_residu (). */
/*-------------------------------------------------------------*/
/* PURPOSE     : This function this subroutine maps the residual */
/*               (from T0 to T1) to modified residual */
/*               (MapResidu[0, 1, ...., Len-1]). */
/*-------------------------------------------------------------*/
/* INPUT ARGUMENTS : */
/*       _ (FLOAT64 []) Sinc:    table of interpolation weights.*/
/*       _ (INT16   ) sinc_limit: half interpolation table size. */
/*       _ (INT16   ) len_sinc:  interpolation table size. */
/*       _ (FLOAT64 []) residu:    number of pulses. */
/*       _ (INT16   ) T0:       Original starting time point. */
/*       _ (INT16   ) T1:       Original ending time point. */
/*-------------------------------------------------------------*/
/* OUTPUT ARGUMENTS : */
/*       _ (FLOAT64 []) MapResidu:  mapped residual. */
/*-------------------------------------------------------------*/
/* INPUT/OUTPUT ARGUMENTS : */
/*       _ None. */
/*-------------------------------------------------------------*/
/* RETURN ARGUMENTS : */
/*       _ None. */
/*==========================================================*/


void PPP_mapping_residu (FLOAT64 sinc [], INT16 sinc_limit, INT16 len_sinc,
                   FLOAT64 residu [], FLOAT64 T0, FLOAT64 T1, INT16 Len,
                   FLOAT64 MapResidu[])
        {
        /*-------------------------------------------------------------*/


        FLOAT64 *Weight;
        FLOAT64 t, f, D;
        INT16   i, m, T;


        /*-------------------------------------------------------------*/


        D = (T1-T0)/(FLOAT64)Len;
```

```
            if (fabs(D-1.0) > 0.0001)
                    {
                    for (i = 0; i < Len; i++)
                        {
                        t = T0 + i*D;
                        T = (INT16)t;
                        f = t-(FLOAT64)T;
                        m = (INT16)(f*(FLOAT64)DELT_F2+0.500001);
                        Weight = sinc + m*len_sinc;
                        MapResidu[i] = D2A_interp (Weight, residu, L_OLPIT, t,

                                                                    sinc_limit);

                        }
                    }
            else

                    {
                    T = (INT16)T0;
                    f = T0 - (FLOAT64)T;
                    m = (INT16)(f*(FLOAT64)DELT_F2+0.500001);
                    Weight = sinc + m*len_sinc;


                    for (i = 0; i < Len; i++)
                        {
                        t = T0 + i;
                        MapResidu[i] = D2A_interp (Weight, residu, L_OLPIT, t,

                                                                    sinc_limit);

                        }
                    }


        /*---------------------------------------------------------*/


        return;


        /*---------------------------------------------------------*/
        }


/*---------------------------------------------------------*/

/*=========================================================*/
/* FUNCTION    : PPP_update_LT_mem ().                    */
```

```
/*---------------------------------------------------*/
/* PURPOSE    : This function updates the excitation memory.   */
/*---------------------------------------------------*/
/* INPUT ARGUMENTS :                          */
/*      _(FLOAT64 []) LTm:   table of interpolation weights.  */
/*      _(INT16   ) L_LTm: excitation memory size.        */
/*      _(INT16   ) L_E:   new excitation memory size.     */
/*---------------------------------------------------*/
/* OUTPUT ARGUMENTS :                         */
/*      _(FLOAT64 []) E:    new excitation.           */
/*---------------------------------------------------*/
/* INPUT/OUTPUT ARGUMENTS :                     */
/*      _ None.                             */
/*---------------------------------------------------*/
/* RETURN ARGUMENTS :                         */
/*      _ None.                             */
/*=================================================*/


void PPP_update_LT_mem (INT16 L_LTm, FLOAT64 LTm[], INT16 L_E, FLOAT64 E[])
        {
        /*-------------------------------------------*/

        INT16  j;

        /*-------------------------------------------*/

        for (j = 0; j < L_LTm-L_E; j++)
                LTm[j] = LTm [j+L_E];

        /*-------------------------------------------*/

        cpy_dvector (E, LTm+L_LTm-L_E, 0, L_E-1);

        /*-------------------------------------------*/

        return;

        /*-------------------------------------------*/
        }
```

```
/*----------------------------------------------------*/


/*==================================================================*/
/* FUNCTION     : PPP_search_shift_pp ().                  */
/*----------------------------------------------------*/
/* PURPOSE      : This function find the first sub-optimal shift  */
/*               by maximising the intercorrelation between the  */
/*               target signal and the input signal.         */
/*----------------------------------------------------*/
/* INPUT ARGUMENTS :                         */
/*       _ (FLOAT64 []) residu: original signal.           */
/*       _ (INT16   ) T0:   original starting time point.    */
/*       _ (INT16    ) i0:   starting index for the intercorr.  */
/*       _ (INT16    ) i1:   ending index for the intercorr.   */
/*       _ (INT16    ) Len:   input signal length.          */
/*       _ (FLOAT64 []) Tg:   target signal.             */
/*----------------------------------------------------*/
/* OUTPUT ARGUMENTS :                        */
/*       _ (FLOAT64  *) Shift:   optimum shift.            */
/*       _ (FLOAT64  *) MaxRp:   maximum intercorrelation value. */
/*----------------------------------------------------*/
/* INPUT/OUTPUT ARGUMENTS :                     */
/*       _ None.                         */
/*----------------------------------------------------*/
/* RETURN ARGUMENTS :                        */
/*       _ None.                         */
/*==================================================================*/



void PPP_search_shift_pp (FLOAT64 residu[], FLOAT64 T0, INT16 i0, INT16 i1,
          INT16 Len, FLOAT64 Tg[], FLOAT64 *Shift, FLOAT64 *MaxRp)
       {
       /*----------------------------------------------------*/


       INT16   L, i, i00, i11, i0L, i1H, t0, Iopt, Idx, L_R;
       FLOAT64 R, R1, R2, crit, Rp[20+2*SINC_LIMIT],
              DifTab[MAX_DIF_TAB], ShiftRes[MAX_L_TG+30], TT1, TT0;


       /*----------------------------------------------------*/
```

```
(*Shift) = 0;
Iopt      = 0;
dot_dvector (Tg, Tg, &R1, 0, Len-1);
i00 = i0 - SINC_LIMIT - 1;
i11 = i1 + SINC_LIMIT + 1;
TT0 = T0 + i00;
TT1 = T0 + i11 + Len + 1;
L = i11 + Len + 1 - i00;


/*----------------------------------------------------*/


PPP_mapping_residu(SincWindows_PP, SINC_LIMIT_PP, LEN_SINC_PP, residu,
                              TT0, TT1, L, ShiftRes);


for (i = i0; i <= i1; i++)
        {
        t0 = i - i00;
        dot_dvector (Tg, ShiftRes+t0, &R, 0, Len-1);
        dot_dvector (ShiftRes+t0, ShiftRes+t0, &R2, 0, Len-1);
        Rp[i-i00] = R / sqrt(MAX(0.001, R2*R1));
        crit = Rp[i-i00];
        if (crit > (*MaxRp))
                {
                (*MaxRp) = crit;
                (*Shift) = i;
                Iopt      = i;
                }
        }
/*----------------------------------------------------*/
/*              Additional correlation              */
/*----------------------------------------------------*/


i0L = Iopt - SINC_LIMIT - 1;
i1H = Iopt + SINC_LIMIT + 1;


for (i = i0L; i < i0; i++)
        {
        t0 = i - i00;
        dot_dvector (Tg, ShiftRes+t0, &R, 0, Len-1);
        dot_dvector (ShiftRes+t0, ShiftRes+t0, &R2, 0, Len-1);
```

```
                Rp[i-i00] = R / sqrt(MAX(0.001, R2*R1));
            }

        for (i = i1+1; i <= i1H; i++)
            {
            t0 = i - i00;
            dot_dvector (Tg, ShiftRes+t0, &R, 0, Len-1);
            dot_dvector (ShiftRes+t0, ShiftRes+t0, &R2, 0, Len-1);
            Rp[i-i00] = R / sqrt(MAX(0.001, R2*R1));
            }

        /*--------------------------------------------------*/
        /*        Fractional search of the delay          */
        /*--------------------------------------------------*/

        for (i = 0; i < MAX_DIF_TAB; i++)
            DifTab[i] = Iopt - 0.75 + 0.1*i;

#ifdef PROG_BUG_FIX
        L_R = i1H - i00;
#else
        L_R = i1H - i0L + 1;
#endif

        LTP_FineIndex_search (DifTab, 0, MAX_DIF_TAB-1, i00, L_R, Rp, &Idx);

        (*Shift) = DifTab[Idx];
        i = (INT16)(DifTab[Idx] + 0.5 - i00);
        (*MaxRp) = MAX(Rp[i], 0);

        /*--------------------------------------------------*/

        return;

        /*--------------------------------------------------*/
    }

/*--------------------------------------------------*/

/*==================================================*/
```

```
/* FUNCTION    : PPP_search_opt_shift_pp ().                */
/*------------------------------------------------------*/
/* PURPOSE     : This function find the optimal shift by    */
/*                maximising the intercorrelation between the   */
/*                target signal and the input signal. And if the  */
/*                procedure "fails" the waveform interpolation is */
/*                performed.                               */
/*------------------------------------------------------*/
/* INPUT ARGUMENTS :                                  */
/*    _ (INT16   ) frame_class: class of the current frame.    */
/*    _ (FLOAT64  ) PitLag:    current pitch lag.          */
/*    _ (FLOAT64 []) residu:   original signal.           */
/*    _ (INT16   ) T0:       starting time point.         */
/*    _ (INT16   ) Center:   segment center.            */
/*    _ (INT16   ) l_sf:    sub-frame size.             */
/*    _ (INT16   ) L_Tg:    target size.               */
/*    _ (FLOAT64 []) Tg:       target signal.            */
/*    _ (INT16    ) SRCH0:    starting index for max intercorr. */
/*                    search.                          */
/*    _ (INT16    ) SRCH1:    ending index for max intercorr.   */
/*          .           search.                       */
/*------------------------------------------------------*/
/* OUTPUT ARGUMENTS :                                 */
/*    _ (FLOAT64 []) MapResOpt:   wrapped signal.           */
/*    _ (FLOAT64  *) Delay:      optimum shift.          */
/*    _ (FLOAT64  *) Rp_Opt:     maximum intercorrelation value. */
/*------------------------------------------------------*/
/* INPUT/OUTPUT ARGUMENTS :                            */
/*     _ None.                                   */
/*------------------------------------------------------*/
/* RETURN ARGUMENTS :                                 */
/*     _ None.                                   */
/*==================================================*/

void PPP_search_opt_shift_pp (INT16 frame_class, FLOAT64 PitLag, FLOAT64 residu[],
                FLOAT64 T0, INT16 Center, INT16 l_sf, INT16 L_Tg,
                FLOAT64 Tg[], FLOAT64 MapResOpt[], INT16 SRCH0,
                INT16 SRCH1, FLOAT64 *Delay, FLOAT64 *Rp_Opt)
     {
        /*------------------------------------------------------*/
```

```
FLOAT64 Shift, CRITmax, TT0, T1;
FLOAT64 Tg_m[MAX_L_TG];
INT16   i;


/*------------------------------------------------------------*/
/*                  Search of the delay                    */
/*------------------------------------------------------------*/


if (frame_class >= 3)
            {
            CRITmax = 0.3;
            for (i = 0; i < Center; i++)
                    Tg_m[i] = (0.25 + 0.75*i/Center)*Tg[i];
            }
else
            {
            CRITmax = 0.4;
            for (i = 0; i < Center; i++)
                    Tg_m [i] = (0.5 + 0.5*i / Center)*Tg[i];
            }


cpy_dvector(Tg, Tg_m, Center, L_Tg-1);



PPP_search_shift_pp (residu, T0, SRCH0, SRCH1, L_Tg, Tg_m, &Shift,
                                              &CRITmax);


(*Delay)          = Shift;
(*Rp_Opt)         = CRITmax;


/*------------------------------------------------------------*/
/*                  Wrapped residual                       */
/*------------------------------------------------------------*/


T1 = T0 + Center + Shift;


PPP_mapping_residu (SincWindows_E, SINC_LIMIT_E, LEN_SINC_E, residu,
                                           T0, T1, Center, MapResOpt);
```

```
            if (L_Tg > Center)
                    {
                    TT0 = T1;
                    T1 = TT0 + L_Tg - Center;
                    PPP_mapping_residu (SincWindows_E, SINC_LIMIT_E, LEN_SINC_E,
                                          residu, TT0, T1, (INT16)(L_Tg - Center),
                                          (MapResOpt + Center));
                    }
            /*---------------------------------------------------*/


        return;


            /*---------------------------------------------------*/
            }


        /*---------------------------------------------------*/


        /*=================================================*/
        /* FUNCTION     : PPP_periodicity_detect ().            */
        /*---------------------------------------------------*/
        /* PURPOSE      : This function estimate the level of periodicity */
        /*               of the input signal and calculate the normalized */
        /*               crosscorrelation factors.              */
        /*---------------------------------------------------*/
        /* INPUT ARGUMENTS :                           */
        /*    _ (FLOAT64 []) Tg0:     target signal.           */
        /*    _ (INT16   ) L_ModiSig: size of the modified signal.    */
        /*---------------------------------------------------*/
        /* OUTPUT ARGUMENTS :                          */
        /*    _ (FLOAT64 *) Gp:     optimum shift.            */
        /*    _ (FLOAT64 *) Rp:     normalized crosscorrelation factor.*/
        /*---------------------------------------------------*/
        /* INPUT/OUTPUT ARGUMENTS :                      */
        /*    _ (FLOAT64 []) ModiSig0:  modified signal.         */
        /*---------------------------------------------------*/
        /* RETURN ARGUMENTS :                          */
        /*    _ None.                              */
        /*=================================================*/


void PPP_periodicity_detect (FLOAT64 ModiSig0 [], FLOAT64 Tg0 [], INT16 L_ModiSig,
```

```
                        FLOAT64 *Gp, FLOAT64 *Rp, INT16 smv_mode, FLOAT64 nsr)
{
/*-------------------------------------------------------------*/

      .

FLOAT64 R0, R1, R2, R3;
FLOAT64 Tg[MAX_L_TG], ModiSig[MAX_L_TG];
INT16 i;

/*-------------------------------------------------------------*/

dot_dvector (ModiSig0, ModiSig0, &R0, 0, L_ModiSig-1);

cpy_dvector (Tg0,              Tg,              0, L_ModiSig-1);
cpy_dvector (ModiSig0, ModiSig, 0, L_ModiSig-1);

dot_dvector (ModiSig,    Tg,      &R1, 0, L_ModiSig-1);
dot_dvector (Tg,                  Tg,      &R2, 0, L_ModiSig-1);
dot_dvector (ModiSig,    ModiSig, &R3, 0, L_ModiSig-1);

(*Gp) = R1 / MAX(R2, 0.001);
(*Rp) = R1 / sqrt(MAX(0.1, R2*R3));

/*-------------------------------------------------------------*/

if ((*Rp) > 0.5)
        {
        if (smv_mode >= 1)
                R1 = MIN(nsr*4 + 0.25, 0.4) * MIN((*Gp), 1.0);
        else
                R1 = MIN(nsr*4 + 0.125, 0.25) * MIN((*Gp), 1.0);

  .     for (i = 0; i < L_ModiSig; i++)
                ModiSig0[i] += R1 * Tg0[i];

        dot_dvector (ModiSig0, ModiSig0, &R3, 0, L_ModiSig-1);

        R2 = sqrt (R0 / MAX(R3, 0.0001));

        for (i = 0; i < L_ModiSig; i++)
                ModiSig0[i] *= R2;
```

```
        }


        /*----------------------------------------------------------*/


        return;


        /*----------------------------------------------------------*/
        }


/*----------------------------------------------------------------------*/


/*======================================================================*/
/* FUNCTION    :  PPP_sharpness ().                        */
/*----------------------------------------------------------*/
/* PURPOSE     :  This function estimate the sharpeness of the   */
/*                input signal.                        */
/*----------------------------------------------------------*/
/* INPUT ARGUMENTS :                                */
/*    _ (INT16   ) Len:      size of the input signal.      */
/*    _ (FLOAT64 []) res:      target signal.              */
/*----------------------------------------------------------*/
/* OUTPUT ARGUMENTS :                               */
/*    _ None.                                   */
/*----------------------------------------------------------*/
/* INPUT/OUTPUT ARGUMENTS :                            */
/*    _ None.                                   */
/*----------------------------------------------------------*/
/* RETURN ARGUMENTS :                               */
/*    _ (FLOAT64  ) P_SHP:    sharpness factor.          */
/*======================================================================*/


FLOAT64 PPP_sharpness (INT16 len, FLOAT64 res[])
        {
        /*----------------------------------------------------------*/


        FLOAT64 Max, E_x, M, P_SHP;
        INT16 i;


        /*----------------------------------------------------------*/
```

```
        E_x = 0.0;
        Max = 0.0;

        for (i = 0; i < len; i++)
                {
                M        = fabs(res[i]);
                E_x += M;
                if (M > Max)
                        Max = M;
                }
        P_SHP = E_x / (len * MAX(1.0, Max));


        /*-----------------------------------------------------*/


        return (P_SHP);


        /*-----------------------------------------------------*/
        }


/*-----------------------------------------------------------*/


/*===========================================================*/
/* FUNCTION     : PPP_locat_max_puls ().                     */
/*-----------------------------------------------------------*/
/* PURPOSE      : This function locate the peak of energy into a   */
/*                pitch period.                              */
/*-----------------------------------------------------------*/
/* INPUT ARGUMENTS :                                         */
/*      _ (FLOAT64 []) Res:      input signal.               */
/*      _ (INT16    ) Start:     starting index.             */
/*      _ (INT16    ) End:       ending index.               */
/*      _ (INT16    ) n_peak:    number of peaks.            */
/*-----------------------------------------------------------*/
/* OUTPUT ARGUMENTS :                                        */
/*      _ (INT16   *) PulsLoc:   pulse index.                */
/*      _ (FLOAT64  *) PeakRatio: ration between the peak energy and */
/*                      signal energy.                       */
/*-----------------------------------------------------------*/
/* INPUT/OUTPUT ARGUMENTS :                                  */
/*      _ None.                                              */
```

```
/*----------------------------------------------------------------*/
/* RETURN ARGUMENTS :                              */
/*    _ None.                              */
/*================================================================*/


void PPP_locat_max_puls (FLOAT64 Res[], INT16 Start, INT16 End, INT16 n_peak,
        INT16 *PulsLoc, FLOAT64 *PeakRatio)
        {
        /*------------------------------------------------------*/


        FLOAT64 Eng, MaxEng[MAX_PULS_NUM], AvgEng;
        INT16 i, k, Loc, PulsLocat[MAX_PULS_NUM];


        /*------------------------------------------------------*/


        for (k = 0; k < n_peak; k++)
                PulsLocat[k] = Start;
        Eng = 0;
        for (k = -HALFP; k <= HALFP; k++)
                Eng += Res[Start+k]*Res[Start+k];
        AvgEng = Eng;
        for (k = 0; k < n_peak; k++)
                MaxEng[k] = Eng;


        /*------------------------------------------------------*/


        for (i = Start+1; i <= End; i++)
                {
                Eng = 0.0;
                for (k = -HALFP; k <= HALFP; k++)
                        Eng += Res[i+k]*Res[i+k];
                if (Eng < 4*AvgEng)
                        AvgEng = 0.875*AvgEng + 0.125*Eng;

                if (Eng > MaxEng[0])
                        {
                        MaxEng[0] = Eng;
                        PulsLocat[0] = i;
                        for (k = 1; k < n_peak; k++)
                                if (MaxEng[k-1] > MaxEng[k])
```

```
                                            {
                    Eng                              = MaxEng[k];
                    MaxEng[k]                        = MaxEng[k-1];
                    MaxEng[k-1]     = Eng;
                    Loc                              = PulsLocat[k];
                    PulsLocat[k]    = PulsLocat[k-1];
                    PulsLocat[k-1]  = Loc;
                    }
            }
        }


        /*------------------------------------------------*/


        Loc = PulsLocat[n_peak-1];
        Eng = MaxEng[n_peak-1];


        for (k = n_peak-2; k >= 0; k--)
                if ((MaxEng[k] > 0.75*MaxEng[n_peak-1]) &&
                            (AvgEng/MAX(MaxEng[k],0.1) < 1/9.0))
                {
                 Loc = PulsLocat[k];
                 Eng = MaxEng[k];
                 break;
                }


        (*PulsLoc)  = Loc;
        (*PeakRatio) = AvgEng/MAX(Eng, 0.1);


        /*------------------------------------------------*/


        return;


        /*------------------------------------------------*/
        }


/*------------------------------------------------------*/


/*================================================================*/
/* FUNCTION    : PPP_pitch_preproc ().                   */
/*------------------------------------------------------*/
```

```
/* PURPOSE     : This function perform the pitch modify the input */
/*              signal in order to improve the LTP performance    */
/*              and without introducing perceptually significant  */
/*              distortions.                     */
/*------------------------------------------------------------*/
/* INPUT ARGUMENTS :                             */
/*     _ (INT16   ) smv_mode:      selected SMV mode.            */
/*     _ (INT16   ) fix_rate:     selected fixed bit-rate.       */
/*     _ (INT16   ) flat_flag:    flat input speech flag.        */
/*     _ (FLOAT64  ) nsr:          estim. noise to signal ratio. */
/*     _ (FLOAT64 []) wspeech:      input signal.                */
/*     _ (FLOAT64 []) ForPitch:     forward pitch estimations.   */
/*     _ (INT16    ) frame_class_pp: class of the current frame for */
/*                    picth preprocessing.       */
/*------------------------------------------------------------*/
/* OUTPUT ARGUMENTS :                            */
/*     _ (FLOAT64 []) ModiSig:      modified signal.             */
/*     _ (FLOAT64 *) Delay_pp:     pitch pre-processing delay.   */
/*     _ (INT16   *) frame_class:   class of the current frame.  */
/*     _ (INT16   *) VUV:          voice unvoice decision.       */
/*     _ (INT16   []) gp:          Pitch gains.                  */
/*------------------------------------------------------------*/
/* INPUT/OUTPUT ARGUMENTS :                          */
/*     _ None.                                   */
/*------------------------------------------------------------*/
/* RETURN ARGUMENTS :                            */
/*     _ None.                                   */
/*============================================================*/


void PPP_pitch_preproc (INT16 smv_mode, INT16 fix_rate, INT16 flat_flag,
                         FLOAT64 nsr, FLOAT64 wspeech[], FLOAT64 ModiSig[],
                         FLOAT64 ForPitch[], FLOAT64 *Delay_pp,
                            INT16 frame_class_pp, INT16 *frame_class,
                              INT16 *VUV, FLOAT64 gp[])
        {
        /*------------------------------------------------------------*/

        INT16   i0, i, i_s, L_Tg, L, l_sf, Center;
        FLOAT64 T0, T1, Delay, Delay_tmp, P_SHP, P_SHP_Tg, Rp_Opt;
        FLOAT64 LTm[MAX_LAG+MAX_L_TG], Tg[MAX_L_TG], PitFunc[L_FRM+L_FRM/2];
```

```
FLOAT64 ModiRes[MAX_L_TG];
INT16   SRCH0, SRCH1, StartPoint, EndPoint, LocPuls, PulsLen;
INT16   cond_abs, cond0, cond1, cond2, cond3, cond;
FLOAT64 ltp_gain=0, pit_corr=0, avg_Rp, min_Rp;
FLOAT64 Rp[N_SF4] = {0.0};


    /*--------------------------------------------------------*/


Delay_tmp = (*Delay_pp);

if ((frame_class_pp <= 0) || (frm_count == 1))
        {
        /*------------------------------------------------*/
        /*              Reset of the delay              */
        /*------------------------------------------------*/

        if (frame_class_pp == -1)
                Delay_tmp = 0;

        T0 = L_OLPIT - L_LPCLHD - L_FRM + Delay_tmp;
        T1 = T0 + L_FRM;
        PPP_mapping_residu (SincWindows_E, SINC_LIMIT_E, LEN_SINC_E,
                                        wspeech, T0, T1, L_FRM, ModiSig);


        /*------------------------------------------------*/
        /*              Memorize the wspeech            */
        /*------------------------------------------------*/

        PPP_update_LT_mem (MAX_LAG, targ_mem, L_FRM, ModiSig);
        ltp_gain= 0.0;
        pit_corr= 0.0;
        avg_Rp          = 0.0;
        min_Rp          = 1;

        ini_dvector(gp, 0, N_SF4-1, 0.0);
        ini_dvector(Rp, 0, N_SF4-1, 0.0);
        }
else
        {
        i0  = 0;
```

```
i_s = 0;

ini_dvector(gp, 0, N_SF4 - 1, 0.0);
ini_dvector(Rp, 0, N_SF4 - 1, 0.0);
avg_Rp = 0.0;
min_Rp = 1.0;

while (i0 < L_FRM)
        {
    /*----------------------------------------------*/
        /*        Determine some parameters        */
    /*----------------------------------------------*/


    /*----------------------------------------------*/
        /*            Pulse Length            */
    /*----------------------------------------------*/


        PulsLen = (INT16)MAX(ForPitch[i0]*0.2, 5);
        PulsLen = MIN(PulsLen, 30);


    /*----------------------------------------------*/
        /*            Peak location            */
    /*----------------------------------------------*/


    /*----------------------------------------------*/
        /*      Starting point on the original wspeech      */
    /*----------------------------------------------*/


        T0 = L_OLPIT - L_LPCLHD - L_FRM + i0 + Delay_tmp;

        StartPoint = (INT16)T0;
        EndPoint        = (INT16)MIN(StartPoint + ForPitch[i0],
                                        L_OLPIT - 8 - SINC_LIMIT);

        PPP_locat_max_puls (wspeech, StartPoint, EndPoint, 1,
                                        &LocPuls, &P_SHP);

        if ((i0 == 0) && (LocPuls < PulsLen + T0))
                LocPuls = (INT16)(PulsLen + T0);
```

```
/*-----------------------------------------------------*/
/*                  Searching Length            */
/*-----------------------------------------------------*/


l_sf = (INT16)MIN(LocPuls - T0 + PulsLen, L_FRM - i0);
L_Tg = (INT16)(LocPuls - T0 + 2*PulsLen);
if (LocPuls + ForPitch[i0]*1.25 >
                              L_OLPIT - L_LPCLHD + Delay_tmp)
         {
         StartPoint = (INT16)(LocPuls + ForPitch[i0]*0.5);
         EndPoint      = (INT16)MIN(StartPoint+ForPitch[i0],
                              L_OLPIT - 8 - SINC_LIMIT);
         PPP_locat_max_puls (wspeech, StartPoint, EndPoint, 1,
                              &L, &P_SHP);
         if (L > L_OLPIT - L_LPCLHD + Delay_tmp)
                {
                l_sf = L_FRM - i0;
                L_Tg = (INT16)MAX(l_sf, LocPuls-T0 + 2*PulsLen);
                }
         }


SRCH1 = 5;
L = L_FRM - i0 + MAX(0, L_LPCLHD - (INT16)Delay_tmp -

SINC_LIMIT_E - SRCH1);
         L_Tg = MIN(L_Tg, L);
         L_Tg = MIN(L_Tg, MAX_L_TG);
         Center = (INT16)MAX(LocPuls-T0-PulsLen, PulsLen/2);
         Center = MIN(l_sf, Center);


/*-----------------------------------------------------*/
/*   Calculate the target : Tg[0,..,L_Tg-1], for the   */
/*              wspeech modification           */
/*-----------------------------------------------------*/


cpy_dvector (targ_mem, LTm, 0, MAX_LAG-1);
L = MIN(L_Tg, L_FRM - i0 + L_FRM / 2);
cpy_dvector (ForPitch + i0, PitFunc, 0, L-1);


ini_dvector (PitFunc, L, L_Tg-1, PitFunc[L-1]);
```

```
LTP_excit_vari_pitch(SincWindows_E, LEN_SINC_E,

                              SINC_LIMIT_E, PitFunc, MAX_LAG,

                                             LTm, L_Tg, Tg);


/*----------------------------------------------*/
/*              Searching Range             */
/*----------------------------------------------*/


/*----------------------------------------------*/
/*                 Peakness                 */
/*----------------------------------------------*/


StartPoint = (INT16)(LocPuls - ForPitch[i0]*0.5);
EndPoint       = (INT16)MIN(StartPoint + ForPitch[i0],

                            L_OLPIT - 8 - SINC_LIMIT);
PPP_locat_max_puls (wspeech, StartPoint, EndPoint, 1, &L,


&P_SHP);


PPP_locat_max_puls (Tg, (INT16)(HALFP+1),

                        (INT16)(L_Tg-HALFP-1), (INT16)1, &L, &P_SHP_Tg);


/*----------------------------------------------*/
/*              Search range                */
/*----------------------------------------------*/


SRCH1=MAX(MIN(Center*0.075 + 0.5, SRCH1), 1);
SRCH0 = -SRCH1;


/*----------------------------------------------*/
/*            Influence of P_SHP            */
/*----------------------------------------------*/


if (P_SHP > 1/4.0)
        {
        SRCH1 = MIN(SRCH1,  3);
        SRCH0 = MAX(SRCH0, -3);
        }
else if (P_SHP > 1/12.0)
```

```
                {
                 SRCH1 = MIN(SRCH1, 4);
                 SRCH0 = MAX(SRCH0, -4);
                }


/*---------------------------------------------------*/
/*            Influence of P_SHP_Tg            */
/*---------------------------------------------------*/


        if (frame_class_pp >= 3)
                L = 4;
        else
                L = 3;


        if (P_SHP_Tg > 1/3.0)
                {
                 SRCH1 = MIN(SRCH1, L);
                 SRCH0 = MAX(SRCH0, -L);
                }
        else if (P_SHP_Tg > 1/6.0)
                {
                        SRCH1 = MIN(SRCH1, (L+1));
                        SRCH0 = MAX(SRCH0, -(L+1));
                }


/*---------------------------------------------------*/
/*    Influence of LocPuls and non-voiced speech     */
/*---------------------------------------------------*/


        if ((L_Tg < LocPuls - T0 - HALFP) || (ForPitch[i0] < 25)
                        || (LocPuls <= PulsLen + T0))
                {
                if (P_SHP > 1/4.0)
                        {
                        SRCH1 = MIN(SRCH1, 1);
                        SRCH0 = MAX(SRCH0, -1);
                        }
                else
                        {
                        SRCH1 = MIN(SRCH1, 2);
```

```
                    SRCH0 = MAX(SRCH0, -2);
                }
            }


/*-----------------------------------------------*/
/*          Influence of Delay_tmp          */
/*-----------------------------------------------*/

        if (Delay_tmp > 5)
                SRCH1 = MIN(SRCH1, 4);
        if (Delay_tmp > 10)
                SRCH1 = MIN(SRCH1, 2);
        if (Delay_tmp > 15)
                SRCH1 = 0;

        if (Delay_tmp < -5)
                SRCH0 = MAX(SRCH0, -4);
        if (Delay_tmp < -10)
                SRCH0 = MAX(SRCH0, -2);
        if (Delay_tmp < -15)
                SRCH0 = 0;


/*-----------------------------------------------*/
/*          Searching for the best delay;        */
/*-----------------------------------------------*/

        PPP_search_opt_shift_pp (frame_class_pp, ForPitch[i0+l_sf-1],
                                 wspeech,T0, Center, l_sf, L_Tg, Tg,
                                 ModiRes, SRCH0,SRCH1,
    &Delay,
                                 &Rp_Opt);


/*-----------------------------------------------*/
/* Determine the delay at the end point: ModiRes[l_sf] */
/*-----------------------------------------------*/

        if (Center > l_sf)
                Delay *= (FLOAT64)l_sf/(FLOAT64)Center;

        Delay = Delay_tmp + Delay;
```

```
                        if (fabs(Delay) > MAX_DELAY)
                                {
#ifdef VERBOSE
                                if (frame_class_pp >= 3)
                                        printf("Danger!!!,  Delay_tmp>MAX_DELAY \n");
                                else
                                        printf("Danger!!!!,  Delay_tmp>MAX_DELAY \n");
#endif


                                T1 = T0 + L_Tg;
                                PPP_mapping_residu (SincWindows_E, SINC_LIMIT_E,
                                                                LEN_SINC_E, wspeech,
T0, T1,
                                                                                L_Tg,
ModiRes);
                                }
                        else
                                Delay_tmp = Delay;


                /*------------------------------------------------*/
                /*       Memorize the modified wspeech       */
                /*------------------------------------------------*/


                PPP_update_LT_mem (MAX_LAG, targ_mem, l_sf, ModiRes);


                /*------------------------------------------------*/
                /*              Periodicity            */
                /*------------------------------------------------*/


                PPP_periodicity_detect(ModiRes, Tg, L_Tg, &ltp_gain,
                                        &pit_corr, smv_mode, nsr);


                cpy_dvector (ModiRes, ModiSig+i0, 0, l_sf-1);


                if (((P_SHP < 1.0/30) || (ltp_gain > 0.7) ||
                                (pit_corr > 0.6)) && (L_Tg > LocPuls - T0 + HALFP)
                                        .           && ((*VUV) == 2))
                                                (*VUV) = 3;
```

626

```
if (pit_corr < min_Rp)
                        min_Rp = pit_corr;


pit_corr = MAX(pit_corr, 0.0);
avg_Rp  += pit_corr*l_sf;



/*-----------------------------------------------*/



if (fix_rate == RATE8_5K)
            {
            for (i=0; i < N_SF4; i++)
                    {
                    L = MIN(i0 + l_sf, (i+1)*L_SF4) - MAX(i0, i*L_SF4);
                    gp[i] += ltp_gain*MAX(L, 0);
                    Rp[i] += pit_corr*MAX(L, 0);
                    }
            }
    else
            {
            for (i=0; i < N_SF3; i++)
                    {
                    L = MIN(i0 + l_sf, (i+1)*L_SF0) - MAX(i0, i*L_SF0);
                    gp[i] += ltp_gain*MAX(L, 0);
                    Rp[i] += pit_corr*MAX(L, 0);
                    }
            }

    i0 += l_sf;
    }
        }


/*-----------------------------------------------*/
/*          Classification and output LTP gains          */
/*-----------------------------------------------*/


avg_Rp /= L_FRM;
```

```
if (fix_rate == RATE8_5K)
        {
        /*----------------------------------------*/
        /*            RATE 8.5 kbit/s           */
        /*----------------------------------------*/


        /*----------------------------------------*/
        /*               gains                  */
        /*----------------------------------------*/


        for (i = 0; i < N_SF4; i++)
                Rp[i] /= L_SF4;


        for (i = 0; i < N_SF4; i++)
                gp[i] /= L_SF4;


        if (flat_flag == 1)
                {
                for (i = 0; i < N_SF4; i++)
                        gp[i] = MAX(MIN(gp[i]*(0.75+0.25*Rp[i]), 1.2), 0);
                }
        else
                {
                for (i = 0; i < N_SF4; i++)
                        gp[i] = MAX(MIN(gp[i]*(0.7+0.3*avg_Rp), 1.2), 0);
                }


        /*----------------------------------------*/
        /*          Correct classfication       */
        /*----------------------------------------*/


        if ((Last_Rp > 0.6) && (avg_Rp > 0.6) && (frame_class_pp > 0))
                {
                ltp_gain = (gp[0] + gp[1] + gp[2] + gp[3]) / 4.0;


                cond0 = (fabs(gp[0]-ltp_gain) < 0.25);
                cond1 = (fabs(gp[1]-ltp_gain) < 0.25);
                cond2 = (fabs(gp[2]-ltp_gain) < 0.25);
                cond3 = (fabs(gp[3]-ltp_gain) < 0.25);
```

```
                        cond_abs = cond0 && cond1 && cond2 && cond3;


                        cond0 = (gp[0] > 0.5);
                        cond1 = (gp[1] > 0.5);
                        cond2 = (gp[2] > 0.5);
                        cond3 = (gp[3] > 0.5);


                        cond = cond0 && cond1 && cond2 && cond3;


                        if ((cond_abs == 1) && (cond == 1) && (ltp_gain > 0.5)
                                    && (min_Rp > 0.5))
                                         (*frame_class) = 6;


                        cond0 = (Rp[0] > 0.75);
                        cond1 = (Rp[1] > 0.75);
                        cond2 = (Rp[2] > 0.75);
                        cond3 = (Rp[3] > 0.75);


                        cond = cond0 && cond1 && cond2 && cond3;


                        if ((ltp_gain > 0.5) && (cond == 1))
                                (*frame_class) = 6;


                    }
            Last_Rp = Rp[N_SF4-1];
            }
        else
            {
            /*--------------------------------------------------*/
            /*            RATE 4.0 kbit/s                  */
            /*--------------------------------------------------*/


            /*--------------------------------------------------*/
            /*                  gains                  */
            /*--------------------------------------------------*/


        for (i = 0; i < N_SF3; i++)
                Rp[i] /= L_SF0;
```

```
for (i = 0; i < N_SF3; i++)
        gp[i] /= L_SF0;

for (i = 0; i < N_SF4; i++)
        gp[i] = MAX(MIN(gp[i]*(0.75+0.25*Rp[i]), 1.2), 0);

ltp_gain = (gp[0] + gp[1] + gp[2]) / 3.0;


/*-----------------------------------------*/
/*            Correct classfication         */
/*-----------------------------------------*/

if ((avg_Rp > 0.6) && (frame_class_pp > 0))
        {
        cond0 = (fabs(gp[0]-ltp_gain) < 0.25);
        cond1 = (fabs(gp[1]-ltp_gain) < 0.25);
        cond2 = (fabs(gp[2]-ltp_gain) < 0.25);

        cond_abs = cond0 && cond1 && cond2;

        cond0 = (gp[0] > 0.4);
        cond1 = (gp[1] > 0.4);
        cond2 = (gp[2] > 0.4);

        cond = cond0 && cond1 && cond2;

        if ((cond_abs == 1) && (cond == 1) && (ltp_gain > 0.5)
                        && (min_Rp > 0.4))
                                (*frame_class) = 6;
        }

        Last_Rp = Rp[N_SF3-1];
        }


/*-----------------------------------------*/
/*            Reset the delay                */
/*-----------------------------------------*/

(*Delay_pp) = Delay_tmp;
```

```
    frame_class_pp_m = frame_class_pp;

    /*---------------------------------------------------*/

    return;

    /*---------------------------------------------------*/
    }

/*-------------------------------------------------------*/

/*=======================================================*/
/*---------------------- END ----------------------------*/
/*=======================================================*/
```

```
/*===================================================================*/

/*===================================================================*/
/* Conexant System Inc.                          */
/* 4311 Jamboree Road                            */
/* Newport Beach, CA 92660                       */
/*-----------------------------------------------*/
/* Copyright(C) 2000 Conexant System Inc.         */
/*-----------------------------------------------*/
/* ALL RIGHTS RESERVED:                          */
/* No part of this software may be reproduced in any form or by any */
/* means or used to make any derivative work (such as transformation */
/* or adaptation) without the authorisation of Conexant System Inc.  */
/*===================================================================*/
/* PROTOTYPE FILE : lib_ppp.h                    */
/*===================================================================*/


/*------------------------------------------------*/
/*------------------ FUNCTIONS ------------------*/
/*------------------------------------------------*/


void PPP_init_lib         (void);


void PPP_mapping_residu (FLOAT64 [], INT16, INT16, FLOAT64 [], FLOAT64,
                                    FLOAT64, INT16,        FLOAT64 []);


void PPP_update_LT_mem        (INT16, FLOAT64 [], INT16, FLOAT64 []);


void PPP_search_shift_pp (FLOAT64 [], FLOAT64, INT16, INT16,   INT16, FLOAT64 [],

FLOAT64 *, FLOAT64 *);


void PPP_search_opt_shift_pp (INT16, FLOAT64, FLOAT64 [], FLOAT64, INT16, INT16,
                                    INT16, FLOAT64 [], FLOAT64 [], INT16, INT16,
                                        FLOAT64 *, FLOAT64 *);
```

```
void PPP_periodicity_detect          (FLOAT64 [], FLOAT64 [], INT16, FLOAT64 *, FLOAT64 *,
                                      INT16, FLOAT64);


FLOAT64 PPP_sharpness (INT16, FLOAT64 []);


void PPP_locat_max_puls (FLOAT64 [], INT16, INT16, INT16, INT16 *, FLOAT64 *);


void PPP_pitch_preproc (INT16 smv_mode, INT16 fix_rate, INT16 flat_flag,
                        FLOAT64 nsr, FLOAT64 wspeech[], FLOAT64 ModiSig[],
                        FLOAT64 ForPitch[], FLOAT64 *Delay_pp,
                        INT16 frame_class_pp, INT16 *frame_class,
                        INT16 *VUV, FLOAT64 gp[]);


/*======================================================================*/
/*-------------------------------- END --------------------------------*/
/*======================================================================*/
```

```
/*===============================================================================*/

/*===============================================================================*/
/* Conexant System Inc.                              */
/* 4311 Jamboree Road                                */
/* Newport Beach, CA 92660                            */
/*-----------------------------------------------------*/
/* Copyright(C) 2000 Conexant System Inc.                */
/*-----------------------------------------------------*/
/* ALL RIGHTS RESERVED:                               */
/* No part of this software may be reproduced in any form or by any  */
/* means or used to make any derivative work (such as transformation */
/* or adaptation) without the authorisation of Conexant System Inc.  */
/*===============================================================================*/
/* LIBRARY: lib_ppr.c                                */
/*===============================================================================*/

/*-----------------------------------------------------*/
/*----------------------- INCLUDE ---------------------*/
/*-----------------------------------------------------*/

#include "typedef.h"

#include "main.h"
#include "const.h"
#include "ext_var.h"

#include "mcutil.h"
#include "gputil.h"
#include "lib_ppr.h"
#include "lib_flt.h"
#include "lib_lpc.h"
#include "lib_ltp.h"
#include "lib_ppp.h"

/*-----------------------------------------------------*/
/*----------------------- FUNCTIONS -------------------*/
/*-----------------------------------------------------*/

/*===============================================================================*/
```

```
/* FUNCTION     :   PPR_filters_init ()                    */
/*-----------------------------------------------------------*/
/* PURPOSE      :   This function performs the initialisation   */
/*                  for the post and pre processing.        */
/*-----------------------------------------------------------*/
/* INPUT ARGUMENTS :                                        */
/*                  _ None.                                  */
/*-----------------------------------------------------------*/
/* OUTPUT ARGUMENTS :                                       */
/*                  _ None.                                  */
/*-----------------------------------------------------------*/
/* RETURN ARGUMENTS :                                       */
/*                  _ None.                                  */
/*===========================================================*/


void    PPR_filters_init (void)
        {
        /*-------------------------------------------------------*/


        INT16   i, l;


        FLOAT64 x;


        /*-------------------------------------------------------*/
        /*          Generate the window for Tilt Compensation       */
        /*-------------------------------------------------------*/


        l = L_LPC-L_SF/3;


        for (i = 0; i < l; i++)
                {
                x = cos(i*PI/(FLOAT64)l);
                tilt_window[i] = 0.54-0.46 * x;
                }


        for (i = l; i < L_LPC; i++)
           tilt_window[i] = cos((i-l)*PI*0.49/(L_LPC-l));


        /*-------------------------------------------------------*/
        /*              Pre-processing High-pass filters            */
```

```
/*-------------------------------------------------------------*/


pre_flt_num [0] = -0.92724705/0.46363718;
pre_flt_num [1] = +1.00000000,


pre_flt_den [0] = -1.9059465;
pre_flt_den [1] = +0.9114024;


pre_gain = 0.46363718;


/*-------------------------------------------------------------*/
/*                    Tilt compensation                     */
/*-------------------------------------------------------------*/


tc_mem_dec = 0.0;
tc_coeff = 0.0;
tc_gain = 1.0;



/*-------------------------------------------------------------*/
/*                   Post-processing filters                */
/*-------------------------------------------------------------*/


r_zero = 0.57;
r_pole = 0.75;


pst_scale = 1.0;
pst_hp_mem = 0.0;


/*-------------------------------------------------------------*/
/*                   Post-processing filters                */
/*-------------------------------------------------------------*/


pst_flt_num [0] = -1.8544941/0.92727435;
pst_flt_num [1] = +1.00000000,


pst_flt_den [0] = -1.9059465;
pst_flt_den [1] = +0.9114024;


pst_gain = 0.92727435*2.0;
```

```
        /*----------------------------------------------*/

        return;

        /*----------------------------------------------*/
        }


/*----------------------------------------------------*/


/*==================================================*/
/* FUNCTION    :   PPR_silence_enhan_init ()              */
/*------------------------------------------------*/
/* PURPOSE     :   This function performs the initialisation   */
/*              for the silence enhancement in the input    */
/*              frame                         */
/*------------------------------------------------*/
/* INPUT ARGUMENTS :                         */
/*              _ None.                      */
/*------------------------------------------------*/
/* OUTPUT ARGUMENTS :                        */
/*              _ None.                      */
/*------------------------------------------------*/
/* RETURN ARGUMENTS :                        */
/*              _ None.                      */
/*==================================================*/


void    PPR_silence_enhan_init (void)
        {
        /*----------------------------------------------*/


        INT16  i;


        /*----------------------------------------------*/
        /*           Set-up the initial values       */
        /*----------------------------------------------*/


        zero_level = 8.0;
        min_delta = 65534;
```

```
        for (i = 0; i < SE_MEM_SIZE; i++)
            {
            zero_rate [i] = 0.0;
            low_rate  [i] = 0.0;
            high_rate [i] = 0.0;
            zeroed    [i] = 1;
            }


        l2_neg = -24.0;
        l1_neg = -8.0;
        l1_pos =  8.0;
        l2_pos =  24.0;


        low_neg[0] = -32766.0;
        low_neg[1] = -32767.0;
        low_pos[0] =  32767.0;
        low_pos[1] =  32768.0;


        /*------------------------------------------------------*/


        return;


        /*------------------------------------------------------*/

            }


        /*------------------------------------------------------*/


    /*===========================================================================*/
    /* FUNCTION      :   PPR_silence_enhan ()                */
    /*------------------------------------------------------*/
    /* PURPOSE       :   This function perfroms the enhancement of the */
    /*             silence in the input frame.            */
    /*------------------------------------------------------*/
    /* INPUT ARGUMENTS :                        */
    /*          _ (FLOAT64 []) x_in:  input speech frame.   */
    /*          _ (INT16   ) N  :  speech frame size.      */
    /*------------------------------------------------------*/
    /* OUTPUT ARGUMENTS :                       */
    /*          _ (FLOAT64 []) x_out: output speech frame.  */
    /*------------------------------------------------------*/
```

```
/* RETURN ARGUMENTS :                              */
/*               _ None.                      */
/*======================================================================*/


void     PPR_silence_enhan (FLOAT64 x_in [], FLOAT64 x_out [], INT16 N)
         {
         /*--------------------------------------------------------*/


         INT16  tmp;
         INT16  i, idle_noise;
         INT16  cond1, cond2, cond3, cond4;
         INT16  *hist;
         INT32  delta;
         FLOAT64 *min, *max;


         /*--------------------------------------------------------*/


         hist        = svector (0, SE_HIS_SIZE-1);
            max      = dvector (0, 1);
         min         = dvector (0, 1);


         /*--------------------------------------------------------*/
         /*                 Initialisation                 */
         /*--------------------------------------------------------*/


         min[0] =  32767.0;
         min[1] =  32766.0;
         max[0] = -32767.0;
         max[1] = -32766.0;


         /*--------------------------------------------------------*/
         /*           Loop on the input sample frame          */
         /*--------------------------------------------------------*/


         for(i = 0; i < N; i++)
                {
                /*--------------------------------------------*/


                tmp = (INT16) x_in[i];
```

```
/*----------------------------------------------------*/
/*       Find the 2 Max values in the input frame       */
/*----------------------------------------------------*/


if (tmp > max[0])
        {
        max [1] = max[0];
        max [0] = tmp;
        }
else if ((tmp > max[1]) && (tmp < max[0]))
        max[1] = tmp;



/*----------------------------------------------------*/
/*       Find the 2 Min values in the input frame       */
/*----------------------------------------------------*/


if (tmp < min[0])
        {
        min[1] = min[0];
        min[0] = tmp;
        }
else if ((tmp < min[1]) && (tmp > min[0]))
        min[1] = tmp;



/*----------------------------------------------------*/
/*       Find the 2 Min positive values and the 2 Min      */
/*       abs. negative values in the input frame        */
/*----------------------------------------------------*/


if (tmp >= 0)
        {
        if (tmp < low_pos[0])
                {
                low_pos[1] = low_pos[0];
                low_pos[0] = tmp;
                }
        else if ((tmp < low_pos[1]) && (tmp > low_pos[0]))
                low_pos[1] = tmp;
        }
else
```

```
                        {
                if (tmp > low_neg[0])
                        {
                          low_neg[1] = low_neg[0];
                          low_neg[0] = tmp;
                        }
                else if ((tmp > low_neg[1]) && (tmp < low_neg[0]))
                          low_neg[1] = tmp;


                }
        /*----------------------------------------------*/
                }


/*----------------------------------------------------*/
/*        Calculate the difference between Max and Min        */
/*----------------------------------------------------*/

        delta = (INT32)(max[0]-min[0]);

        if ((delta < min_delta) && (max[0] > min[0]))
                {
                min_delta        = delta;

                if (min_delta <= DELTA_THRLD)
                        {
                        /*----------------------------------------*/

                        if ((max[1] >= 0.0) && (max[0] > 0.0))
                                {
                                l1_pos = max[1];
                                l2_pos = max[0];
                                }
                        else
                                {
                                if (low_pos[0] < 32767.0)
                                        l1_pos = low_pos[0];
                                if (low_pos[1] < 32767.0)
                                        l2_pos = low_pos[1];
                                }
```

```
                           /*----------------------------------------*/


                           if ((min[0] < 0.0) && (min[1] < 0.0))
                                   {
                                   l2_neg = min[0];
                                   l1_neg = min[1];
                                   }
                           else
                                   {
                                   if (low_neg[0] > -32766.0)
                                           l1_neg = low_neg[0];
                                   if (low_neg[1] > -32766.0)
                                           l2_neg = low_neg[1];
                                   }


                           /*------------------------------------*/
                           }
                   }



   /*--------------------------------------------------*/
   /*              Update zero level              */
   /*--------------------------------------------------*/


       if (low_pos[0] < zero_level)
               zero_level = low_pos[0];


   /*--------------------------------------------------*/
   /*              Update the Histogramm          */
   /*--------------------------------------------------*/


       for(i = 0; i < N; i++)
               {
               if ((x_in[i] >= l2_neg) && (x_in[i] < l1_neg))
                       hist [0]++;
               else if ((x_in[i] >= l1_neg) && (x_in[i] < 0.0))
                       hist [1]++;
               else if ((x_in[i] >= 0.0) && (x_in[i] <= l1_pos))
                       hist [2]++;
               else if ((x_in[i] > l1_pos) && (x_in[i] <= l2_pos))
```

```
                        hist [3]++;
            else
                        hist [4]++;
            }


/*---------------------------------------------------------------*/
/*                 Update the History              */
/*---------------------------------------------------------------*/


    for(i = SE_MEM_SIZE-1; i > 0; i--)
            {
            zero_rate [i] = zero_rate [i-1];
            low_rate [i]  = low_rate [i-1];
            high_rate [i] = high_rate [i-1];
            zeroed [i]    = zeroed [i-1];
            }


/*---------------------------------------------------------------*/
/*            Current Frame Rate Calculation        */
/*---------------------------------------------------------------*/


    if (hist [2] == N)
            zero_rate[0] = 1.0;
    else
            zero_rate[0] = (FLOAT64) hist [2] / (FLOAT64)N;

    if ( (hist[1] + hist[2]) == N)
            low_rate[0] = 1.0;
    else
            low_rate[0] = (FLOAT64)(hist[1] + hist[2]) / (FLOAT64)N;

    if (hist[4] == N)
            high_rate[0] = 1.0;
    else
            high_rate[0] = (FLOAT64)hist[4] / (FLOAT64)N;


/*---------------------------------------------------------------*/
/*              Silence Frame Detection             */
/*---------------------------------------------------------------*/
```

```
idle_noise = 1;

for (i = 0; i < SE_MEM_SIZE; i++)
    {
    if ((zero_rate[i] < 0.55) || (low_rate[i] < 0.80) ||
                            (high_rate[i] > 0.07))
                                    idle_noise = 0;
    }

cond1 = ((zero_rate[0] >= 0.95) && (high_rate[0] <= 0.03));

cond2 = ((low_rate[0]  >= 0.90) && (low_rate[1]  >= 0.90) &&
                (high_rate[0] <= 0.030));

cond3 = ((low_rate[0]  >= 0.80) && (low_rate[1]  >= 0.90) &&
                (high_rate[0] <= 0.010) && (zeroed[1] == 1));

cond4 = ((low_rate[0]  >= 0.75) && (low_rate[1]  >= 0.75) &&
                (high_rate[0] <= 0.004) && (zeroed[1] == 1));

/*----------------------------------------------------------*/
/*        Modify the dignal if is a silence frame           */
/*----------------------------------------------------------*/

if (cond1 || cond2 || cond3 || cond4 || idle_noise)
        {
        if (zeroed [1] == 1)
                {
                /*------------------------------------------*/
                /*            Keep the Signal Down          */
                /*------------------------------------------*/

                ini_dvector(x_out, 0, N-1, zero_level);
                }
        else
                {
                /*------------------------------------------*/
                /*            Ramp Signal Down              */
                /*------------------------------------------*/
```

```c
        for (i = 0; i < SE_RAMP_SIZE; i++)
            x_out [i] = ((FLOAT64)(SE_RAMP_SIZE - 1 - i) * x_in[i] +
                                        (FLOAT64)i * zero_level) /

(FLOAT64)(SE_RAMP_SIZE - 1);

            ini_dvector (x_out, SE_RAMP_SIZE, N-1, zero_level);
        }
    zeroed [0] = 1;
    }
else if (zeroed[1] == 1)
    {
    /*-----------------------------------------------*/
    /*              Ramp Signal Up              */
    /*-----------------------------------------------*/

        for (i = 0; i < SE_RAMP_SIZE; i++)
            x_out [i] = ((FLOAT64)i * x_in[i] +
                                (FLOAT64)(SE_RAMP_SIZE - 1 - i) * zero_level) /
                                (FLOAT64)(SE_RAMP_SIZE - 1);
        zeroed[0] = 0;
        }
    else
        zeroed[0] = 0;


/*-----------------------------------------------*/

    free_svector (hist, 0, SE_HIS_SIZE-1);
    free_dvector (max, 0, 1);
    free_dvector (min, 0, 1);

/*-----------------------------------------------*/

return;

/*-----------------------------------------------*/
    }
```

```
/*-----------------------------------------------------------*/


/*=========================================================*/
/* FUNCTION    :   PPR_lowpass ()                    */
/*-----------------------------------------------------------*/
/* PURPOSE     :   This function perfroms the lowpass filtering */
/*                of the input frame.                */
/*-----------------------------------------------------------*/
/* INPUT ARGUMENTS :                              */
/*    _ (INT16   ) l_frm:    speech frame size.         */
/*    _ (INT16   ) smv_mode:  SMV running mode.            */
/*    _ (INT16   ) flat_flag: flat input speech flag.     */
/*-----------------------------------------------------------*/
/* OUTPUT ARGUMENTS :                             */
/*           _ None.                      */
/*-----------------------------------------------------------*/
/* INPUT/OUTPUT ARGUMENTS :                        */
/*    _ (FLOAT64 []) x_in:  input/output speech frame.     */
/*-----------------------------------------------------------*/
/* RETURN ARGUMENTS :                             */
/*           _ None.                      */
/*=========================================================*/


void PPR_lowpass (FLOAT64 x_in[], INT16 l_frm, INT16 smv_mode, INT16 flat_flag)
        {
        /*-----------------------------------------------------------*/


        FLOAT64 x;
        INT16   i;


        /*-----------------------------------------------------------*/


        if (flat_flag==0)
             {
             switch (smv_mode)
                  {
                   case 0: lp_flt_num[0] = 0.0;
                          break;
                   case 1: lp_flt_num[0] = 0.05;
                          break;
```

```
                            case 2: lp_flt_num[0] = 0.075;
                                    break;
                                }
                        }
                else
                        {
                        switch (smv_mode)
                                {
                                case 0: lp_flt_num[0] = -0.1;
                                        break;
                                case 1: lp_flt_num[0] = 0.0;
                                        break;
                                case 2: lp_flt_num[0] = 0.0;
                                        break;
                                }
                        }


        /*------------------------------------------------*/


        for (i = 0; i < l_frm; i++)
                {
                x  = x_in[i] + lp_flt_buf[0]*lp_flt_num[0];
                lp_flt_buf[0] = x_in[i];
                x_in[i] = x;
                }


        /*------------------------------------------------*/


        return;


        /*------------------------------------------------*/
        }


/*------------------------------------------------*/


/*================================================*/
/* FUNCTION     :   PPR_highpass ()                */
/*------------------------------------------------*/
/* PURPOSE      :   This function perfroms the highpass filtering */
/*                  of the input frame.            */
```

```c
/*---------------------------------------------------*/
/* INPUT ARGUMENTS :                          */
/*       _ (INT16    ) l_frm:  speech frame size.    */
/*---------------------------------------------------*/
/* OUTPUT ARGUMENTS :                          */
/*           _ None.                     */
/*---------------------------------------------------*/
/* INPUT/OUTPUT ARGUMENTS :                     */
/*       _ (FLOAT64 []) x   : input/output speech frame.   */
/*---------------------------------------------------*/
/* RETURN ARGUMENTS :                       */
/*           _ None.                     */
/*===================================================*/


void PPR_highpass(INT16 l_frm, FLOAT64 x[])
        {
        /*-------------------------------------------*/


        PPR_ZeroPoleFilter (l_frm, x, pre_flt_buf_z, pre_flt_buf_p,
                            pre_flt_num, pre_flt_den, pre_gain,
                                PPR_FLT_ORDER);


        /*-------------------------------------------*/


        return;


        /*-------------------------------------------*/
        }


/*-----------------------------------------------*/


/*===================================================*/
/* FUNCTION    :   PPR_pitch_postfilter ()          */
/*---------------------------------------------------*/
/* PURPOSE     :   This function perfroms the pitch     */
/*            postfiltering in order to enhance the speech */
/*            periodicity.                  */
/*---------------------------------------------------*/
/* INPUT ARGUMENTS :                        */
/*           _ (FLOAT64   ) lag_f: decoded lag value.   */
```

```
/*              _ (FLOAT64   ) PSF:   pitch gain scale factor.*/
/*              _ (INT16    ) l_sf:  sub-frame size.      */
/*------------------------------------------------------*/
/* OUTPUT ARGUMENTS :                         */
/*          _ None.                     */
/*------------------------------------------------------*/
/* INPUT/OUTPUT ARGUMENTS :                     */
/*          _ (FLOAT64 []) ext:   input excitation signal.*/
/*------------------------------------------------------*/
/* RETURN ARGUMENTS :                       */
/*          _ None.                     */
/*==========================================================*/


void    PPR_pitch_postfilter(FLOAT64 ext [], FLOAT64 lag_f, FLOAT64 PSF, INT16 l_sf)
        {
        /*------------------------------------------------------*/


        FLOAT64     Rp[2*SINC_LIMIT+8], x, y, gain, pit_step, pit_tab[25],

                    tmp[L_SF];
        INT16  i, IP1, IP2, P1, P2, pit_idx, LowL, HighL, L_Rp;


        /*------------------------------------------------------*/
        /*              Searching range definition          */
        /*------------------------------------------------------*/


        pit_step = 1.0 / 8.0;
        P1      = 0;
        P2      = 24;
        pit_tab[0] = MAX(min_pit, lag_f-1.5);

        for (i = 1; i <= P2; i++)
                {
                pit_tab[i] = pit_tab[i-1] + pit_step;
                pit_tab[i] = MIN(HI_LAG2, pit_tab[i]);
                }

        IP1 = (INT16)pit_tab[P1];
        IP2 = (INT16)(pit_tab[P2]+1.0);
        IP2 = MAX(IP1, IP2);
```

```
LowL = IP1 - SINC_LIMIT - 1;
LowL = MAX (0, LowL);
HighL = IP2 + SINC_LIMIT + 1;
L_Rp = HighL - LowL + 1;


#ifdef VERBOSE
        if (L_Rp >= 2*SINC_LIMIT + 8)
                nrerror("Memory Error: L_Rp>=2*SINC_LIMIT+8 !!\n");
#endif


        /*_____*/
        /*                Integer correlation          */
        /*_____*/


        cpy_dvector (ext, buff_LTpost+MAX_LAG, 0, 1_sf-1);
        dot_dvector (buff_LTpost+MAX_LAG-LowL+1, buff_LTpost+MAX_LAG-LowL+1, &y,
                                        0, 1_sf-1);
        for (i = LowL; i <= HighL; i++)
                {
                dot_dvector (ext, buff_LTpost+MAX_LAG-i, &x, 0, 1_sf-1);
                y += buff_LTpost[MAX_LAG-i] * buff_LTpost[MAX_LAG-i];
                y -= buff_LTpost[MAX_LAG-i+1_sf]*buff_LTpost[MAX_LAG-i+1_sf];
                Rp[i-LowL] = x / sqrt(MAX(y, 0.1));
                }


        /*_____*/
        /*                Fine index searching         */
        /*_____*/


        LTP_FineIndex_search (pit_tab, P1, P2, LowL, L_Rp, Rp, &pit_idx);


        /*_____*/
        /*                LTP excitation               */
        /*_____*/


        LTP_excit_const_pitch (pit_tab[pit_idx], MAX_LAG, buff_LTpost, 1_sf,
                                        tmp, 0);


        /*_____*/
```

```
/*                  Update residual buffer                  */
/*------------------------------------------------------------*/


PPP_update_LT_mem (MAX_LAG, buff_LTpost, l_sf, ext);


/*------------------------------------------------------------*/
/*          Compute the harmonic filter coefficient          */
/*------------------------------------------------------------*/


dot_dvector (ext, tmp, &x, 0, l_sf-1);
dot_dvector (tmp, tmp, &y, 0, l_sf-1);
gain = x / MAX(y, 0.001);


gain = MIN(1.0, gain);
gain*= PSF;


/*------------------------------------------------------------*/
/*              Perform the harmonic filtering               */
/*------------------------------------------------------------*/


for (i = 0; i < l_sf; i++)
        tmp[i] = ext[i] + gain*tmp[i];


/*------------------------------------------------------------*/
/*                        AGC                        */
/*------------------------------------------------------------*/


dot_dvector (ext, ext, &x, 0, l_sf-1);
dot_dvector (tmp, tmp, &y, 0, l_sf-1);


gain=sqrt(x / MAX(y, 0.001));
for (i = 0; i < l_sf; i++)
        ext[i] = tmp[i]*gain;


/*------------------------------------------------------------*/


return;
```

```
            /*-------------------------------------------------*/
            }


    /*-------------------------------------------------*/



    /*=================================================*/
    /* FUNCTION     :  PPR_post_process ()              */
    /*-------------------------------------------------*/
    /* PURPOSE      :   This function perfroms post-filtering     */
    /*                  (harmonic + formant) in order to enhance the  */
    /*                  speech quality.                 */
    /*-------------------------------------------------*/
    /* INPUT ARGUMENTS :                               */
    /*                  _ (FLOAT64 []) pdcfq:  decoded prediction coeff.*/
    /*                  _ (FLOAT64 []) lag_f:  decoded lag value.    */
    /*                  _ (INT16    ) l_sf:  sub-frame size.    */
    /*-------------------------------------------------*/
    /* OUTPUT ARGUMENTS :                              */
    /*                  _ None.                         */
    /*-------------------------------------------------*/
    /* INPUT/OUTPUT ARGUMENTS :                        */
    /*                  _ (FLOAT64 []) sigsyn: synthetised signal.   */
    /*-------------------------------------------------*/
    /* RETURN ARGUMENTS :                              */
    /*                  _ None.                         */
    /*=================================================*/


void PPR_post_process(FLOAT64 sigsyn [], FLOAT64 pdcfq [], FLOAT64 r_0,
                      FLOAT64 r_p, FLOAT64 lag_f, INT16 l_sf, INT16 flat_flag,
                      INT16 fix_rate)
        {
        /*-------------------------------------------------*/
        /*          Adaptive (weighted) postfilter variables     */
        /*-------------------------------------------------*/


        FLOAT64 wpdcf_pole[NP], wpdcf_zero[NP], ai_zero[NP+1];
        FLOAT64 tmpmem[NP], hh[L_SF], after_syn[L_SF];
        FLOAT64 val1, val2;


        /*-------------------------------------------------*/
```

```
/*              Harmonic Filtering  variables              */
/*-------------------------------------------------------*/


INT16   i, Lh, L2;
FLOAT64 gain, numerator, denominator;
FLOAT64 residu_w[L_SF];


/*-------------------------------------------------------*/
/*              Tilt compensation variables              */
/*-------------------------------------------------------*/


FLOAT64 r0, r1, k1, coeff, after_tilt[L_SF];


/*-------------------------------------------------------*/
/*          Compute the weighted LPC coefficients        */
/*-------------------------------------------------------*/


r_zero = 0.75*r_zero + 0.25*r_0;


val1 = 1.0;
val2 = 1.0;
for (i = 0; i < NP; i++)
        {
        val1 *= r_pole;
        val2 *= r_zero;
        wpdcf_pole[i] = pdcfq[i] * val1;
        wpdcf_zero[i] = pdcfq[i] * val2;
        }


/*-------------------------------------------------------*/
/*              Compute the residual signal              */
/*-------------------------------------------------------*/


LPC_ptoa (wpdcf_zero, ai_zero, NP);
FLT_conv (sigsyn, ai_zero, NP+1, l_sf, residu_w);


/*-------------------------------------------------------*/
/*              Update the memory                        */
/*-------------------------------------------------------*/
```

```
cpy_dvector(sigsyn+l_sf, sigsyn, 0, NP-1);


/*------------------------------------------------------------*/
/*                    Pitch post-filter                 */
/*------------------------------------------------------------*/


if (l_sf == L_SF)
        {
        L2 = L_SF / 2;
        for (i = 0; i < N_SF2; i++)
                PPR_pitch_postfilter (residu_w+i*L2, lag_f, r_p, L2);
        }
else
        PPR_pitch_postfilter (residu_w, lag_f, r_p, l_sf);


/*------------------------------------------------------------*/
/*                    Tilt compensation                 */
/*------------------------------------------------------------*/


/*------------------------------------------------------------*/
/*      Compute the impulse response of the zero-pole filter    */
/*------------------------------------------------------------*/


Lh = 22;
ini_dvector (hh, 0, l_sf-1, 0.0);
LPC_ptoa (wpdcf_zero, hh, NP);
ini_dvector (tmpmem, 0, NP-1, 0.0);
FLT_allsyn(hh, (INT16)(Lh+1), wpdcf_pole, NP, hh, tmpmem);


/*------------------------------------------------------------*/
/*          Compute the first reflection coefficient        */
/*------------------------------------------------------------*/


dot_dvector (hh, hh, &r0, 0, Lh-1);
dot_dvector (hh, hh+1, &r1, 0, Lh-2);
k1 = -r1/MAX(r0, 0.0001);


coeff = MAX(MIN(0.5*k1, 0.0), -0.1);


if (k1 < 0.0)
```

```
          {
          if (flat_flag == 0)
                  coeff = 0.1;
          else
                  coeff = 0.05;
          }
```

```
/*-----------------------------------------------------------*/
/*               Perform the tilt compensation               */
/*-----------------------------------------------------------*/

after_tilt[0] = residu_w[0] + coeff*pst_hp_mem;
for (i = 1; i < l_sf; i++)
        after_tilt[i] = residu_w[i] + coeff*residu_w[i-1];
```

```
/*-----------------------------------------------------------*/
/*                  Update the memory                        */
/*-----------------------------------------------------------*/

pst_hp_mem = residu_w[l_sf-1];
```

```
/*-----------------------------------------------------------*/
/*                  Synthesis filter                         */
/*-----------------------------------------------------------*/

FLT_allsyn (after_tilt, l_sf, wpdcf_pole, NP, after_syn, PF_mem_syn);
```

```
/*-----------------------------------------------------------*/
/*                  Adaptive gain control                    */
/*-----------------------------------------------------------*/


/*-----------------------------------------------------------*/
/*         Compute the gain factor for the current subframe  */
/*-----------------------------------------------------------*/

dot_dvector (sigsyn+NP, sigsyn+NP, &numerator, 0, l_sf-1);
dot_dvector (after_syn, after_syn, &denominator, 0, l_sf-1);
```

```
gain = sqrt(numerator / MAX(denominator, 0.001));


if (flat_flag == 0)
        gain *= 1.1;
else
        gain *= 1.15;


/*----------------------------------------------*/
/*              Perform the gain control        */
/*----------------------------------------------*/


for (i = 0; i < l_sf; i++)
        {
        pst_scale = 0.9*pst_scale + 0.1*gain;
        after_syn[i] *= pst_scale;
        }


/*----------------------------------------------*/
/*              High-pass filtering             */
/*----------------------------------------------*/


PPR_post_highpass (l_sf, after_syn);


cpy_dvector (after_syn, sigsyn+NP, 0, l_sf-1);


/*----------------------------------------------*/


return;


/*----------------------------------------------*/
}


/*----------------------------------------------*/


/*==============================================*/
/* FUNCTION    : PPR_ZeroPoleFilter ()          */
/*----------------------------------------------*/
/* PURPOSE     :  This function perfroms the pole and zero   */
/*                filtering.                    */
```

```
/*----------------------------------------------*/
/* INPUT ARGUMENTS  :                            */
/*          _ (INT16    ) Len:    signal size.        */
/*          _ (FLOAT64 []) Zz :   zero filter memory.    */
/*          _ (FLOAT64 []) Zp :   pole filter memory.    */
/*          _ (FLOAT64 []) b  :   numerator coefficients. */
/*          _ (FLOAT64 []) a  :   denominator coefficients.*/
/*          _ (FLOAT64  ) K  :   filter gain.          */
/*          _ (INT16    ) order:  filter order.        */
/*----------------------------------------------*/
/* OUTPUT ARGUMENTS :                            */
/*          _ None.                          */
/*----------------------------------------------*/
/* INPUT/OUTPUT ARGUMENTS :                       */
/*          _ (FLOAT64 []) InOut:   input output signal.  */
/*----------------------------------------------*/
/* RETURN ARGUMENTS :                            */
/*          _ None.                          */
/*==============================================*/


void PPR_ZeroPoleFilter (INT16 Len, FLOAT64 InOut[], FLOAT64 Zz[], FLOAT64 Zp[],
                         FLOAT64 b[], FLOAT64 a[], FLOAT64 K, INT16 order)
        {
        /*----------------------------------------------*/

        INT16 i, k;
        FLOAT64 S;


        /*----------------------------------------------*/


        for (i = 0; i < Len; i++)
                {
                S = InOut[i];
                for (k = 0; k < order; k++)
                        S += b[k]*Zz[k];
                for (k = order-1; k > 0; k--)
                        Zz[k] = Zz[k-1];
                Zz[0] = InOut[i];
                InOut[i] = S;
                }
```

```
/*--------------------------------------------------------*/

for (i = 0; i < Len; i++)
        {
        S = InOut[i];
        for (k = 0; k < order; k++)
                S -= a[k]*Zp[k];
        for (k = order-1; k > 0; k--)
                Zp[k] = Zp[k-1];
        Zp[0] = S;
        InOut[i] = S*K;
        }


        /*--------------------------------------------------------*/


return;


        /*--------------------------------------------------------*/
        }


/*--------------------------------------------------------*/


/*========================================================================*/
/* FUNCTION      :  PPR_post_highpass ()                    */
/*--------------------------------------------------------*/
/* PURPOSE       :   This function perfroms G.729 high pass     */
/*                filtering.                    */
/*--------------------------------------------------------*/
/* INPUT ARGUMENTS :                        */
/*               _ (INT16    ) Len:   signal size.        */
/*--------------------------------------------------------*/
/* OUTPUT ARGUMENTS :                        */
/*               _ None.                    */
/*--------------------------------------------------------*/
/* INPUT/OUTPUT ARGUMENTS :                        */
/*               _ (FLOAT64 []) InOut: input output signal.     */
/*--------------------------------------------------------*/
/* RETURN ARGUMENTS :                        */
/*               _ None.                    */
```

```
/*===============================================================*/


void PPR_post_highpass (INT16 Len, FLOAT64 InOut[])
        {
        /*---------------------------------------------------*/


        PPR_ZeroPoleFilter(Len, InOut, pst_flt_buf_z, pst_flt_buf_p,
                                pst_flt_num, pst_flt_den, pst_gain,
                                        PPR_FLT_ORDER);


        /*---------------------------------------------------*/


        return;


        /*---------------------------------------------------*/
        }


/*---------------------------------------------------*/


/*===============================================================*/
/*------------------------- END ---------------------------*/
/*===============================================================*/
```

```
/*=====================================================================*/

/*=====================================================================*/
/* Conexant System Inc.                                    */
/* 4311 Jamboree Road                                      */
/* Newport Beach, CA 92660                                 */
/*-------------------------------------------------------*/
/* Copyright(C) 2000 Conexant System Inc.                  */
/*-------------------------------------------------------*/
/* ALL RIGHTS RESERVED:                                    */
/* No part of this software may be reproduced in any form or by any  */
/* means or used to make any derivative work (such as transformation */
/* or adaptation) without the authorisation of Conexant System Inc.  */
/*=====================================================================*/
/* PROTOYPE FILE: lib_ppr.h                                */
/*=====================================================================*/


/*-------------------------------------------------------*/
/*------------------------ FUNCTIONS ---------------------*/
/*-------------------------------------------------------*/



void      PPR_filters_init          (void);


void      PPR_silence_enhan_init   (void);


void      PPR_silence_enhan          (FLOAT64 [], FLOAT64 [], INT16 );


void      PPR_ZeroPoleFilter          (INT16, FLOAT64 [],FLOAT64 [], FLOAT64 [],
                                             FLOAT64 [],FLOAT64 [],FLOAT64, INT16);


void      PPR_lowpass                 (FLOAT64 [], INT16, INT16, INT16);


void      PPR_highpass                (INT16, FLOAT64 []);



void      PPR_post_highpass           (INT16, FLOAT64 []);
```

```
void      PPR_post_process           (FLOAT64 [], FLOAT64 [], FLOAT64, FLOAT64,
                                          FLOAT64, INT16, INT16, INT16);


void      PPR_pitch_postfilter       (FLOAT64 [], FLOAT64, FLOAT64, INT16);



/*===============================================================*/
/*------------------------ END ------------------------*/
/*===============================================================*/
```

```
/*=================================================================*/


/*===============================================================*/
/* Conexant System Inc.                            */
/* 4311 Jamboree Road                              */
/* Newport Beach, CA 92660                          */
/*-----------------------------------------------------*/
/* Copyright(C) 2000 Conexant System Inc.              */
/*-----------------------------------------------------*/
/* ALL RIGHTS RESERVED:                              */
/* No part of this software may be reproduced in any form or by any  */
/* means or used to make any derivative work (such as transformation */
/* or adaptation) without the authorisation of Conexant System Inc.  */
/*==============================================================*/
/* LIBRARY: lib_prc.c                              */
/*==============================================================*/


/*-----------------------------------------------------*/
/*------------------------ INCLUDE -----------------------*/
/*-----------------------------------------------------*/


#include "typedef.h"


#include "main.h"                                    ...  .
#include "const.h"
#include "gputil.h"
#include "mcutil.h"


#include "ext_var.h"


#include "lib_flt.h"
#include "lib_lpc.h"
#include "lib_prc.h"


/*-----------------------------------------------------*/
/*------------------------ FUNCTIONS ---------------------*/
/*-----------------------------------------------------*/


/*==============================================================*/
/* FUNCTION     : PRC_init_lib ().                    */
```

```
/*-----------------------------------------------------*/
/* PURPOSE     : This function performs initialise the PRC    */
/*          library global variables.           */
/*-----------------------------------------------------*/
/* INPUT ARGUMENTS :                    */
/*          _ None.                */
/*-----------------------------------------------------*/
/* OUTPUT ARGUMENTS :                   */
/*          _ None.                */
/*-----------------------------------------------------*/
/* INPUT/OUTPUT ARGUMENTS :                 */
/*          _ None.                */
/*-----------------------------------------------------*/
/* RETURN ARGUMENTS :                   */
/*          _ None.                */
/*=====================================================*/


void PRC_init_lib (void)
        {


        /*-------------------------------------------------*/
        /*          PRC_ol_cl_GainNorm             */
        /*-------------------------------------------------*/

                                . .

        cl_Eg = -1;
        ol_Eg = -1;

        m_lpc_gain = 0.8;


        /*-------------------------------------------------*/


        return;


        /*-------------------------------------------------*/
        }


/*-----------------------------------------------------*/


/*=====================================================*/
/* FUNCTION    : PRC_GainsNorm_Gc_Gp ().            */
```

663

```
/*-----------------------------------------------------*/
/* PURPOSE      : This function performs the Mode 0 energy     */
/*               manipulation.                        */
/*-----------------------------------------------------*/
/* INPUT ARGUMENTS :                              */
/*      _ (FLOAT64  ) nsr:    Noise to Signal Ratio.     */
/*      _ (FLOAT64  ) sub_eng: sub-frame energy.         */
/*      _ (FLOAT64 []) res:    excitation signal.        */
/*      _ (FLOAT64 **) unfcod:  excitation vectors (ALG and  */
/*                          LTP). */
/*      _ (FLOAT64 **) fcod:    filtered excitation vectors  */
/*                          (ALG and LTP).     */
/*      _ (FLOAT64 []) Tgs:    target signal.        */
/*      _ (INT16   ) exc_mode: excitation mode.         */
/*      _ (FLOAT64  ) beta_sub: smoothing factor.        */
/*      _ (INT16   ) l_sf:    sub-frame size.        */
/*-----------------------------------------------------*/
/* OUTPUT ARGUMENTS :                             */
/*          _ None.                         */
/*-----------------------------------------------------*/
/* INPUT/OUTPUT ARGUMENTS :                       */
/*      _ (FLOAT64 []) gainQ:   quantizied gains.       */
/*-----------------------------------------------------*/
/* RETURN ARGUMENTS :       .                     */
/*          _ None.                         */
/*=====================================================*/


void    PRC_GainsNorm_Gc_Gp (FLOAT64 nsr, FLOAT64 sub_eng, FLOAT64 res[],
                            FLOAT64 gainQ [], FLOAT64 **unfcod,
                            FLOAT64 **fcod, FLOAT64 Tgs [],
                            INT16 exc_mode, FLOAT64 beta_sub,
                            INT16 l_sf)
        {
        /*-------------------------------------------------*/

        FLOAT64      lpc_gain, ol_g, cl_g, gain, x, y, E_ex, E_Tgs, Temp[L_SF];

        /*-------------------------------------------------*/

        if (nsr > 0.125)
```

```
{
/*-------------------------------------------------*/
/*                  Energy                   */
/*-------------------------------------------------*/


E_ex = sub_eng / L_SF;
dot_dvector(Tgs, Tgs, &E_Tgs, 0, l_sf-1);
E_Tgs /= l_sf;


/*-------------------------------------------------*/
/*              Energy smooth                */
/*-------------------------------------------------*/


if (cl_Eg < 0)
        {
        ol_Eg   = E_ex;
        cl_Eg   = E_Tgs;
        }
else
        {
        ol_Eg = beta_sub*ol_Eg + (1.0-beta_sub)*E_ex;
        cl_Eg = beta_sub*cl_Eg + (1.0-beta_sub)*E_Tgs;

        }



/*-------------------------------------------------*/
/*              Open-loop gain              */
/*-------------------------------------------------*/


wad_dvector (unfcod[0], gainQ[0], unfcod[1], gainQ[1],
                                        Temp, 0, l_sf-1);


dot_dvector (Temp, Temp, &x,  0, l_sf-1);


x /= l_sf;


x = sqrt(MAX(ol_Eg-5.0, 0)/MAX(x, 0.1));
gain = MIN(0.75*x, (1.2 / MAX(gainQ[0], 0.01)));
}
```

```
else
        {
        /*--------------------------------------------------*/
        /*               LPC gain                    */
        /*--------------------------------------------------*/


        dot_dvector (res, res, &E_ex,  0, l_sf-1);
        E_ex /= l_sf;
        dot_dvector (Tgs, Tgs, &E_Tgs, 0, l_sf-1);
        E_Tgs /= l_sf;


        lpc_gain        = sqrt(E_ex / MAX(E_Tgs, 0.1));
        lpc_gain        = MIN(lpc_gain, m_lpc_gain);



        /*--------------------------------------------------*/
        /*               Energy smooth               */
        /*--------------------------------------------------*/


        if (cl_Eg < 0)
                {
                ol_Eg  = E_ex;
                cl_Eg  = E_Tgs;
                }
        else
                {
                ol_Eg = beta_sub*ol_Eg + (1.0-beta_sub)*E_ex;
                cl_Eg = beta_sub*cl_Eg + (1.0-beta_sub)*E_Tgs;


                }


        /*--------------------------------------------------*/
        /*               Open-loop gain              */
        /*--------------------------------------------------*/


        wad_dvector (unfcod[0], gainQ[0], unfcod[1], gainQ[1],
                                                Temp, 0, l_sf-1);



        dot_dvector (Temp, Temp, &x,  0, l_sf-1);
```

```
        x /= l_sf;

        ol_g = sqrt(MAX(ol_Eg-5.0, 0) / MAX(x, 0.1));



        /*-----------------------------------------*/
        /*              Close-loop gain          */
        /*-----------------------------------------*/


        wad_dvector (fcod[0], gainQ[0], fcod[1], gainQ[1],
                                                Temp, 0, l_sf-1);



        dot_dvector (Temp, Temp, &y,  0, l_sf-1);
        y /=  l_sf;

        cl_g = sqrt(MAX(cl_Eg-5.0, 0) / MAX(y, 0.1));

        /*-----------------------------------------*/
        /*              Apply the gain           */
        /*-----------------------------------------*/


        if(exc_mode != 0)   ...
                {
                x = lpc_gain / MAX(m_lpc_gain, 0.1);
                y = 1.0 - x;
                gain = x*ol_g + y*cl_g;
                gain = MIN(0.75*gain, 1.2/MAX(gainQ[0], 0.01));
                gain = MIN((1 + lpc_gain), gain);
                }
        else
                {
                gain = 0.75*MIN(ol_g, cl_g);
                gain = MIN(gain, 1.2/MAX(gainQ[0], 0.01));
                }
        }


/*-----------------------------------------------*/
```

```
        gain = MAX(1.0, gain);
        gainQ[0] *= gain;
        gainQ[1] *= gain;


        /*-------------------------------------------------*/


        return;


        /*-------------------------------------------------*/
        }


/*-------------------------------------------------------*/


/*================================================================*/
/* FUNCTION     : PRC_ol_cl_GainNorm_Gc ().                    */
/*-------------------------------------------------------*/
/* PURPOSE      : This function performs the Mode 1 energy     */
/*                manipulation.                                */
/*-------------------------------------------------------*/
/* INPUT ARGUMENTS :                                          */
/*        _ (FLOAT64 []) res2:    excitation signal.          */
/*        _ (FLOAT64 **) unfcod:  excitation vectors (ALG and */
/*                                LTP). */
/*        _ (FLOAT64 **) fcod:    filtered excitation vectors */
/*                                (ALG and LTP).    */
/*        _ (FLOAT64 []) Tg:      target signal.              */
/*        _ (INT16   ) exc_mode: excitation mode.             */
/*        _ (INT16   ) l_sf:    sub-frame size.              */
/*-------------------------------------------------------*/
/* OUTPUT ARGUMENTS :                                         */
/*            _ None.                                          */
/*-------------------------------------------------------*/
/* INPUT/OUTPUT ARGUMENTS :                                   */
/*        _ (FLOAT64 []) gainQ:   quantizied gains.           */
/*-------------------------------------------------------*/
/* RETURN ARGUMENTS :                                         */
/*            _ None.                                          */
/*================================================================*/


void PRC_GainNorm_Gc (FLOAT64 res2[], FLOAT64 gainQ [], FLOAT64 **unfcod,
```

```
                               FLOAT64 **fcod, FLOAT64 Tg [], INT16 l_sf)
      {
      /*---------------------------------------------------------------*/


      FLOAT64 lpc_gain, ol_g, cl_g, gain, E_ex, E_Tg;
      FLOAT64 val;


      /*---------------------------------------------------------------*/
      /*                    LPC gain                      */
      /*---------------------------------------------------------------*/


      dot_dvector (res2, res2,   &E_ex, 0, l_sf-1);
      dot_dvector (Tg,       Tg,     &E_Tg, 0, l_sf-1);


      lpc_gain       = sqrt  (E_ex/MAX(E_Tg, 0.1));
      lpc_gain       = MIN   (lpc_gain, 0.8);


      /*---------------------------------------------------------------*/
      /*                    Open-loop gain                */
      /*---------------------------------------------------------------*/


      dot_dvector(unfcod[1], unfcod[1], &val, 0, l_sf-1);


      ol_g = gainQ[1] * gainQ[1] * val;


      ol_g = sqrt(E_ex/MAX(ol_g, 0.1));


      /*---------------------------------------------------------------*/
      /*                    Close-loop gain               */
      /*---------------------------------------------------------------*/


      dot_dvector(fcod[1], fcod[1], &val, 0, l_sf-1);


      cl_g = gainQ[1] * gainQ[1] * val;


      cl_g = sqrt(E_Tg/MAX(cl_g, 0.1));


      /*---------------------------------------------------------------*/
      /*                    Apply the gain                */
      /*---------------------------------------------------------------*/
```

```
lpc_gain        *=       0.75;
gain            =        lpc_gain*ol_g + (1-lpc_gain)*cl_g;
gain            =        MAX(1.0, 0.5*gain);
gain            =        MIN(1+lpc_gain, gain);
gainQ[1]        *=       gain;


        /*----------------------------------------------------------*/


        return;


        /*----------------------------------------------------------*/
        }


        /*----------------------------------------------------------*/


        /*==========================================================*/
        /* FUNCTION     : PRC_Ideal_Excit().                    */
        /*----------------------------------------------------------*/
        /* PURPOSE      : This function calculates the ideal fixed   */
        /*                codebook excitation.                  */
        /*----------------------------------------------------------*/
        /* INPUT ARGUMENTS :                                    */
        /*      _ (FLOAT64 []) Tg:       target signal.          */
        /*      _ (FLOAT64 []) pdcfq:    quantized prediction coeff.  */
        /*      _ (FLOAT64 []) wpdcf_den: precetual filter denominator  */
        /*                    coefficients.              */
        /*      _ (FLOAT64 []) wpdcf_num: precetual filter numerator   */
        /*                    coefficients.              */
        /*      _ (INT16   ) l_sf:     sub-frame size.           */
        /*----------------------------------------------------------*/
        /* OUTPUT ARGUMENTS :                                   */
        /*      _ (FLOAT64 []) res2:     ideal excitation signal.    */
        /*----------------------------------------------------------*/
        /* INPUT/OUTPUT ARGUMENTS :                             */
        /*          _ None.                             */
        /*----------------------------------------------------------*/
        /* RETURN ARGUMENTS :                                   */
        /*          _ None.                             */
        /*==========================================================*/
```

```
void PRC_Ideal_Excit(FLOAT64 Tg [], FLOAT64 pdcfq [], FLOAT64 wpdcf_den [],
                        FLOAT64 wpdcf_num [], FLOAT64 res2 [], INT16 l_sf)
        {
        /*———————————————————————————————————*/


        FLOAT64 ai_zero[NP+1], tmpmem[NP+1], tmp[L_SF+NP];


        /*———————————————————————————————————*/


        ini_dvector (tmp, 0, NP-1, 0.0);
        cpy_dvector (Tg, tmp+NP, 0, l_sf-1);


        LPC_ptoa      (pdcfq, ai_zero, NP);
        FLT_conv      (tmp, ai_zero, NP+1, l_sf, res2);


        ini_dvector (tmpmem, 0, NP-1, 0.0);
        FLT_allsyn (res2, l_sf, wpdcf_num, NP, tmp+NP, tmpmem);


        LPC_ptoa (wpdcf_den, ai_zero, NP);
        FLT_conv (tmp, ai_zero, NP+1, l_sf, res2);


        /*———————————————————————————————————*/


        return;

        /*———————————————————————————————————*/
        }


/*———————————————————————————————————*/


/*════════════════════════════════════════════════════════════*/
/* FUNCTION      : PRC_TargetSignal ().                  */
/*———————————————————————————————————*/
/* PURPOSE       : This function calculates the target signal.   */
/*———————————————————————————————————*/
/* INPUT ARGUMENTS :                           */
/*       _ (FLOAT64 []) wpdcf_num: precetual filter numerator    */
/*                     coefficients.              */
/*       _ (FLOAT64 []) wpdcf_den: precetual filter denominator  */
```

EP 1 214 706 B1

```
/*                        coefficients.                    */
/*        _ (FLOAT64 [])  pdcfq:     quantized prediction coeff.  */
/*        _ (FLOAT64 [])  OriSig:    original signal              */
/*        _ (FLOAT64 [])  dif_mem:   memory for synthesis filter  */
/*        _ (INT16    )   target_mem: memory for taget synthesis. */
/*        _ (INT16    )   l_sf:      sub-frame size.              */
/*---------------------------------------------------------*/
/* OUTPUT ARGUMENTS :                                      */
/*        _ (FLOAT64 [])  res:       residual signal.             */
/*        _ (FLOAT64 [])  Tgs:       target signal.               */
/*---------------------------------------------------------*/
/* INPUT/OUTPUT ARGUMENTS :                                */
/*            _ None.                                       */
/*---------------------------------------------------------*/
/* RETURN ARGUMENTS :                                      */
/*            _ None.                                       */
/*=========================================================*/


void     PRC_TargetSignal(FLOAT64 wpdcf_num [], FLOAT64 wpdcf_den [],
                  FLOAT64 pdcfq [], FLOAT64 OriSig[], FLOAT64 res[],
                  FLOAT64 Tgs [], FLOAT64 dif_mem [],
                  FLOAT64 target_mem [], INT16 l_sf)

         {
         /*-------------------------------------------------*/


         FLOAT64 ai_zero[NP+1], tmpmem[NP];


         /*-------------------------------------------------*/
         /*  The residual signal is located at ext+MAX_LAG for use in the  */
         /*            close-loop pitch search              */
         /*-------------------------------------------------*/


         LPC_ptoa (pdcfq, ai_zero, NP);
         FLT_conv (OriSig, ai_zero, NP+1, l_sf, res);



         /*-------------------------------------------------*/
         /*     Filter the residual signal with the synthesis filter    */
         /*           NOTES: reverse the order of the memory            */
         /*-------------------------------------------------*/
```

672

```
        rev_dvector (dif_mem, tmpmem, 0, NP-1);
        FLT_allsyn(res, l_sf, pdcfq, NP, dif_mem+NP, tmpmem);


        /*-----------------------------------------------------*/
        /*            Perceptual weighting filter              */
        /*-----------------------------------------------------*/


        LPC_ptoa (wpdcf_num, ai_zero, NP);
        FLT_conv (dif_mem, ai_zero, NP+1, l_sf, Tgs);


        /*-----------------------------------------------------*/
        /*          NOTES: reverse the order of the memory     */
        /*-----------------------------------------------------*/


        rev_dvector (target_mem, tmpmem, 0, NP-1);
        FLT_allsyn (Tgs, l_sf, wpdcf_den, NP, Tgs, tmpmem);


        /*-----------------------------------------------------*/


        return;


        /*-----------------------------------------------------*/
    }


    /*------------------------------------------------------------*/


    /*============================================================================*/
    /* FUNCTION       : PRC_average_rate ().                   */
    /*----------------------------------------------------------*/
    /* PURPOSE        : This function calculates the SMV average     */
    /*            bit rate.                       */
    /*----------------------------------------------------------*/
    /* INPUT ARGUMENTS :                           */
    /*      _ (INT16   ) codec_rate: current frame bitrate.      */
    /*----------------------------------------------------------*/
    /* OUTPUT ARGUMENTS :                          */
    /*            _ None.                        */
    /*----------------------------------------------------------*/
    /* INPUT/OUTPUT ARGUMENTS :                            */
```

```
/*      _ (FLOAT64 *) avg_rate : average bit rate.        */
/*_____*/
/* RETURN ARGUMENTS :                              */
/*              _ None.                            */
/*================================================*/


void PRC_average_rate (INT16 codec_rate, FLOAT64 *avg_rate)
        {
        /*_____*/

        INT16 bits = 0;

        /*_____*/
        /*      Set bits incl. overhead in order to measure the    */
        /*              average SMV bit-rate                       */
        /*_____*/

        switch (codec_rate)
                {
                case RATE8_5K: bits = RATE_1_1;
                        break;

                case RATE4_0K: bits = RATE_1_2;
                        break;

                case RATE2_0K: bits = RATE_1_4;
                        break;

                case RATE0_8K: bits = RATE_1_8;
                        break;

                default: nrerror ("Invalid codec rate !!!\n");
                        break;
                }

        /*_____*/

        (*avg_rate) = ((*avg_rate)*(FLOAT64)(frm_count-1)+(FLOAT64)bits)/(double)frm_count;

        /*_____*/
```

```
        return;

        /*---------------------------------------------*/
    }

/*---------------------------------------------*/

/*=============================================*/
/*----------------- END ------------------*/
/*=============================================*/
```

```
/*==================================================================*/


/*==================================================================*/
/* Conexant System Inc.                          */
/* 4311 Jamboree Road                            */
/* Newport Beach, CA 92660                        */
/*----------------------------------------------*/
/* Copyright(C) 2000 Conexant System Inc.               */
/*----------------------------------------------*/
/* ALL RIGHTS RESERVED:                          */
/* No part of this software may be reproduced in any form or by any  */
/* means or used to make any derivative work (such as transformation */
/* or adaptation) without the authorisation of Conexant System Inc.  */
/*==================================================================*/
/* PROTOTYPE FILE : lib_prc.h                      */
/*==================================================================*/


/*----------------------------------------------*/
/*------------------- FUNCTIONS -----------------*/
/*----------------------------------------------*/


void     PRC_init_lib                  (void);


void     PRC_GainsNorm_Gc_Gp (FLOAT64, FLOAT64, FLOAT64 [], FLOAT64 [],
                             FLOAT64 **, FLOAT64 **, FLOAT64 [], INT16,
                                 FLOAT64, INT16);



void     PRC_GainNorm_Gc     (FLOAT64 [], FLOAT64 [], FLOAT64 **, FLOAT64 **,
                                     FLOAT64 [], INT16);



void     PRC_Ideal_Excit     (FLOAT64 [], FLOAT64 [], FLOAT64 [], FLOAT64 [],
                                     FLOAT64 [], INT16);



void     PRC_TargetSignal     (FLOAT64 *, FLOAT64 *, FLOAT64 *, FLOAT64 *,
```

FLOAT64 \*, FLOAT64 \*, FLOAT64 \*, FLOAT64

\*,

INT16);

void    PRC_average_rate        (INT16, FLOAT64 \*);

/\*==============================================================\*/
/\*-------------------------- END --------------------------\*/
/\*==============================================================\*/

```
/*=================================================================*/

/*=================================================================*/
/* Conexant System Inc.                           */
/* 4311 Jamboree Road                             */
/* Newport Beach, CA 92660                         */
/*_____*/
/* Copyright(C) 2000 Conexant System Inc.           */
/*_____*/
/* ALL RIGHTS RESERVED:                             */
/* No part of this software may be reproduced in any form or by any */
/* means or used to make any derivative work (such as transformation */
/* or adaptation) without the authorisation of France Telecom and   */
/* Conexant System Inc.                            */
/*=================================================================*/
/* LIBRARY: lib_pwf.c                              */
/*=================================================================*/


/*_____*/
/*_____ INCLUDE _____*/
/*_____*/


#include "main.h"
#include "typedef.h"


#include "const.h"
#include "gputil.h"
#include "ext_var.h"


#include "lib_lpc.h"
#include "lib_flt.h"


#ifdef DIAG_SMV


#include "lib_dia.h"


#endif


/*_____*/
/*_____ FUNCTIONS _____*/
```

```
/*------------------------------------------------------------------*/


/*==================================================================*/
/* FUNCTION      : PWF_init_lib ().                      */
/*------------------------------------------------------------------*/
/* PURPOSE      : This function initialise the global variables  */
/*                 of the PWF library.                   */
/*------------------------------------------------------------------*/
/* INPUT ARGUMENTS :                              */
/*               _ None.                         */
/*------------------------------------------------------------------*/
/* OUTPUT ARGUMENTS :                             */
/*               _ None.                         */
/*------------------------------------------------------------------*/
/* INPUT/OUTPUT ARGUMENTS :                        */
/*               _ None.                         */
/*------------------------------------------------------------------*/
/* RETURN ARGUMENTS :                             */
/*               _ None.                         */
/*==================================================================*/


void PWF_init_lib (void)
        {
        /*------------------------------------------------------------------*/
        /*                  wspeech_to_speech                    */
        /*------------------------------------------------------------------*/


        r_pole_ws = 0.55;
        Z1_ws_1 = 0.0;
        Z1_ws_2 = 0.0;


        /*------------------------------------------------------------------*/


        return;


        /*------------------------------------------------------------------*/
        }


/*------------------------------------------------------------------*/
```

```
/*========================================================================*/
/* FUNCTION    : PWF_speech_to_residu ().                    */
/*------------------------------------------------------------------------*/
/* PURPOSE     : This function perform a filtering operation to  */
/*                pass from the input signal domain to the       */
/*                perceptually weighted domain residual.         */
/*------------------------------------------------------------------------*/
/* INPUT ARGUMENTS :                                 */
/*     _ (FLOAT64 []) sigpp:     input signal.                   */
/*     _ (FLOAT64 **) pdcf:      prediction coeff. matrix.       */
/*     _ (FLOAT64  ) r_zero:     band-expantion oefficient       */
/*------------------------------------------------------------------------*/
/* OUTPUT ARGUMENTS :                                */
/*     _ (FLOAT64 []) residu:    perceptually weigthed domain    */
/*                   residual.                       */
/*     _ (FLOAT64 **) wpdcf_zero: band-expanded prediction coeff. */
/*                   matrix.                         */
/*------------------------------------------------------------------------*/
/* INPUT/OUTPUT ARGUMENTS :                          */
/*     _ None.                                       */
/*------------------------------------------------------------------------*/
/* RETURN ARGUMENTS :                                */
/*     _ None.                                       */
/*========================================================================*/


void PWF_speech_to_residu (FLOAT64 sigpp[], FLOAT64 residu[], FLOAT64 **pdcf,
                           FLOAT64 **wpdcf_zero, FLOAT64 r_zero)
    {
    /*--------------------------------------------------------------*/


    INT16   i, j, i_s;
    FLOAT64 ai_zero[NP+1], val;


    /*--------------------------------------------------------------*/
    /*    Generate the perceptual weighting filter zeros coefficients  */
    /*--------------------------------------------------------------*/


    for (i = 0; i <= N_SF4; i++)
        {
        val = 1.0;
```

```
        for (j = 0; j < NP; j++)
            {
            val *= r_zero;
            wpdcf_zero[i][j] = pdcf[i][j]*val;
            }
        }


    /*------------------------------------------------------------*/
    /*            Generate the  weighted residual            */
    /*------------------------------------------------------------*/


    i_s = 0;


    for (i = 0; i < N_SF4; i++)
        {
        LPC_ptoa (wpdcf_zero[i], ai_zero, NP);

        FLT_conv(sigpp+L_PP-L_FRM-L_LPCLHD+i_s-NP, ai_zero, NP+1, L_SF4,
                                    residu+L_OLPIT-L_FRM-L_LPCLHD+i_s);

        i_s += L_SF4;
        }


    /*------------------------------------------------------------*/


LPC_ptoa(wpdcf_zero[i], ai_zero, NP);

FLT_conv(sigpp + L_PP - L_LPCLHD - NP, ai_zero, NP+1, L_LPCLHD,
                                    residu + L_OLPIT -
L_LPCLHD);

    /*------------------------------------------------------------*/


return;

    /*------------------------------------------------------------*/
    }

/*------------------------------------------------------------*/
```

```
/*=======================================================================*/
/* FUNCTION     : PWF_residu_to_wspeech ().                  */
/*---------------------------------------------------------------*/
/* PURPOSE     : This function perform a filtering operation to  */
/*               pass from the perceptually weighted domain      */
/*               residual to the perceptually weighted domain    */
/*               signal.                                          */
/*---------------------------------------------------------------*/
/* INPUT ARGUMENTS :                                         */
/*   _ (INT16    ) flat_flag:    flat input speech flag.      */
/*   _ (FLOAT64 []) residu:      residual signal.             */
/*   _ (FLOAT64 **) refl:        partial corr. coeff. matrix.  */
/*   _ (FLOAT64  ) r_zero:       band-expantion oefficient     */
/*---------------------------------------------------------------*/
/* OUTPUT ARGUMENTS :                                        */
/*   _ (FLOAT64 []) wspeech:     perceptually weigthed domain   */
/*                  signal.                                    */
/*   _ (FLOAT64 **) pdcf:        prediction coeff. matrix.      */
/*   _ (FLOAT64 **) wpdcf_pole:  band-expanded prediction coeff. */
/*                  matrix.                                     */
/*   _ (FLOAT64 []) LP_CF:       first adaptive order lowpass    */
/*                  coefficient.                                */
/*---------------------------------------------------------------*/
/* INPUT/OUTPUT ARGUMENTS :                                  */
/*   _ (FLOAT64 []) wspeech_mem: synthesis filter memory.       */
/*   _ (FLOAT64 *) Z1_ws:        first adaptive order lowpass    */
/*                  memory.                                     */
/*---------------------------------------------------------------*/
/* RETURN ARGUMENTS :                                        */
/*   _ None.                                                  */
/*=======================================================================*/


void PWF_residu_to_wspeech (INT16 flat_flag, FLOAT64 residu[],
                       FLOAT64 wspeech[],FLOAT64 **refl, FLOAT64 **pdcf,
                       FLOAT64 **wpdcf_pole, FLOAT64 *LP_CF,
                          FLOAT64 wspeech_mem[], FLOAT64 *Z1_ws)
        {
        /*---------------------------------------------------------------*/

        INT16   i, k, j, i_s, i0;
```

```
FLOAT64 val, x, y, tmpmem[NP];


/*---------------------------------------------------------*/
/*    Generate the perceptual weighting filter poles coefficients   */
/*---------------------------------------------------------*/


for (i = 0; i <= N_SF4; i++)
        {
        val = 1.0;
        for (j = 0; j < NP; j++)
                {
                val *= 0.5;
                wpdcf_pole[i][j] = pdcf[i][j]*val;
                }
        }


/*---------------------------------------------------------*/


if (flat_flag==0)
        y = 0.2;
else
        y = 0.0;


/*---------------------------------------------------------*/


for (i = 0; i <= N_SF4; i++)
LP_CF[i] =  y;


/*---------------------------------------------------------*/
/*    Generate the weighted speech for openloop pitch lag search    */
/*---------------------------------------------------------*/


i_s = 0;
for (i = 0; i < N_SF4; i++)
        {
        FLT_allsyn (residu + L_OLPIT - L_FRM - L_LPCLHD + i_s, L_SF4,
                                wpdcf_pole[i], NP, wspeech + L_OLPIT - L_FRM -
                                        L_LPCLHD + i_s, wspeech_mem);
        i_s += L_SF4;
        }
```

```
        cpy_dvector (wspeech_mem, tmpmem, 0, NP-1);

        FLT_allsyn (residu + L_OLPIT - L_LPCLHD, L_LPCLHD, wpdcf_pole[i], NP,
                                                wspeech+L_OLPIT-L_LPCLHD,
tmpmem);

        /*-----------------------------------------------*/
        /*              Adaptive low pass             */
        /*-----------------------------------------------*/

        i_s = 0;
        for (i = 0; i < N_SF4; i++)
                {
                for (k = 0; k < L_SF4; k++)
                        {
                        i0 = L_OLPIT - L_FRM - L_LPCLHD + i_s;
                        x = wspeech[i0 + k] + LP_CF[i]*(*Z1_ws);
                        (*Z1_ws) = wspeech[i0 + k];
                        wspeech[i0 + k] = x;
                        }
                i_s += L_SF4;
                }

        y = (*Z1_ws);
        for (i = 0; i < L_LPCLHD; i++)
                {
                x = wspeech[L_OLPIT-L_LPCLHD+i] + LP_CF[N_SF4]*y;
                y = wspeech[L_OLPIT-L_LPCLHD+i];
                wspeech[L_OLPIT-L_LPCLHD+i] = x;
                }

        /*-----------------------------------------------*/

        return;

        /*-----------------------------------------------*/
        }

/*-----------------------------------------------*/
```

```
/*=======================================================*/
/* FUNCTION    : PWF_wspeech_to_speech ().               */
/*-----------------------------------------------------*/
/* PURPOSE     : This function perform a filtering operation to */
/*               pass from the perceptually weighted domain   */
/*               signal to the signal.                        */
/*-----------------------------------------------------*/
/* INPUT ARGUMENTS :                                    */
/*    _ (FLOAT64 **) wpdcf_zero:  band-expanded prediction coeff. */
/*                   matrix numarator.                  */
/*    _ (FLOAT64 **) wpdcf_pole:  band-expanded prediction coeff. */
/*                   matrix denominator.                */
/*    _ (FLOAT64 []) LP_CF:     first adaptive order lowpass   */
/*                   coefficient.                       */
/*-----------------------------------------------------*/
/* OUTPUT ARGUMENTS :                                   */
/*    _ (FLOAT64 []) ModiSig:    pitch preprocessed signal.    */
/*-----------------------------------------------------*/
/* INPUT/OUTPUT ARGUMENTS :                             */
/*    _ (FLOAT64 *) Z1_ws_2:     first adaptive order lowpass  */
/*                   memory.                            */
/*-----------------------------------------------------*/
/* RETURN ARGUMENTS :                                   */
/*    _ None.                                           */
/*=======================================================*/


void PWF_wspeech_to_speech (FLOAT64 ModiSig[], FLOAT64 **wpdcf_zero,
                                    FLOAT64 **wpdcf_pole, FLOAT64 LP_CF [],
                                    FLOAT64 *Z1_ws_2)
        {
        /*-----------------------------------------------------*/

        FLOAT64 tmp_ws[L_FRM+NP], ai_zero[NP+1];
        INT16 i, k, i_s;


        /*-----------------------------------------------------*/


        cpy_dvector (tmp_ws_m, tmp_ws, 0, NP-1);
        i_s = 0;
```

```
for (i = 0; i < N_SF4; i++)
        {
        for (k = 0; k < L_SF4; k++)
                {
                tmp_ws[NP + i_s + k] = ModiSig[i_s + k] -

                                                LP_CF[i]*(*Z1_ws_2);

                (*Z1_ws_2) = tmp_ws[NP + i_s + k];
                }
                i_s += L_SF4;

        }


        cpy_dvector(tmp_ws+L_FRM, tmp_ws_m, 0, NP-1);


        /*------------------------------------------------*/


        i_s = 0;
        for (i=0; i<N_SF4; i++)
                {
                LPC_ptoa (wpdcf_pole[i], ai_zero, NP);
                FLT_conv (tmp_ws+i_s, ai_zero, NP+1, L_SF4, ModiSig+i_s);
                FLT_allsyn (ModiSig+i_s, L_SF4, wpdcf_zero[i], NP, ModiSig+i_s,
                                                ModiSig_m);
                i_s += L_SF4;
                }
        /*------------------------------------------------*/


        return;


        /*------------------------------------------------*/
        }


/*================================================*/
/*-------------------- END --------------------*/
/*================================================*/
```

```
/*==================================================================*/


/*==================================================================*/
/* Conexant System Inc.                          */
/* 4311 Jamboree Road                            */
/* Newport Beach, CA 92660                         */
/*_____*/
/* Copyright(C) 2000 Conexant System Inc.             */
/*_____*/
/* ALL RIGHTS RESERVED:                           */
/* No part of this software may be reproduced in any form or by any  */
/* means or used to make any derivative work (such as transformation */
/* or adaptation) without the authorisation of France Telecom and   */
/* Conexant System Inc.                          */
/*==================================================================*/
/* PROTOTYPE FILE : lib_pwf.h                       */
/*_____*/
/* IMPLEMENTATION :                    [26/05/2000] */
/* Conexant System Inc.                          */
/* Media Access Department                        */
/* Speech Technology Development                    */
/*_____*/
/* Last Version                    [26/05/2000] */
/* C. Murgia                               */
/*_____*/
/* PURPOSE :  Perceptuel Weighting Filter library           */
/*==================================================================*/


/*_____*/
/*------------------------ FUNCTIONS -------------------------*/
/*_____*/


void PWF_init_lib                    (void);


void PWF_speech_to_residu         (FLOAT64 [], FLOAT64 [], FLOAT64 **, FLOAT64 **,


                 FLOAT64);


void PWF_residu_to_wspeech        (INT16, FLOAT64 [], FLOAT64 [], FLOAT64 **,
                                 FLOAT64 **, FLOAT64 **, FLOAT64 *, FLOAT64 [],
```

FLOAT64 *);

```
void PWF_wspeech_to_speech    (FLOAT64 [], FLOAT64 **, FLOAT64 **, FLOAT64 [],
                                   .      FLOAT64 *);
```

```
/*==========================================================================*/
/*------------------------- END ----------------------------*/
/*==========================================================================*/
```

```
/*===================================================================*/


/*===================================================================*/
/* Conexant System Inc.                          */
/* 4311 Jamboree Road                            */
/* Newport Beach, CA 92660                        */
/*-----------------------------------------------*/
/* Copyright(C) 2000 Conexant System Inc.              */
/*-----------------------------------------------*/
/* ALL RIGHTS RESERVED:                          */
/* No part of this software may be reproduced in any form or by any  */
/* means or used to make any derivative work (such as transformation */
/* or adaptation) without the authorisation of Conexant System Inc.  */
/*===================================================================*/
/* LIBRARY: lib_qlsf.c                          */
/*===================================================================*/


/*-----------------------------------------------*/
/*----------------------- INCLUDE -------------------------*/
/*-----------------------------------------------*/


#include "typedef.h"


#include "main.h"
#include "const.h"
#include "gputil.h"
#include "mcutil.h"
#include "ext_var.h"


#include "lib_qlsf.h"


/*-----------------------------------------------*/
/*----------------------- FUNCTIONS -------------------------*/
/*-----------------------------------------------*/


/*===================================================================*/
/* FUNCTION     : LSF_Q_init_lib ().                   */
/*-----------------------------------------------*/
/* PURPOSE      : This function initialise the global variable    */
/*                 for the LSF_Q library.                  */
```

```
/*-----------------------------------------------*/
/* INPUT ARGUMENTS :                         */
/*            _ None.                    */
/*-----------------------------------------------*/
/* OUTPUT ARGUMENTS :                        */
/*            _ None.                    */
/*-----------------------------------------------*/
/* INPUT/OUTPUT ARGUMENTS :                    */
/*            _ None.                    */
/*-----------------------------------------------*/
/* RETURN ARGUMENTS :                        */
/*            _ None.                    */
/*===============================================*/


void LSF_Q_init_lib (void)
        {
        /*-----------------------------------------*/


        INT16  i, j, k;


        /*-----------------------------------------*/


        MS_08k[0] = LMS1_08k;
        MS_08k[1] = LMS2_08k;
        MS_08k[2] = LMS3_08k;

        MS_40k[0] = LMS1_40k;
        MS_40k[1] = LMS2_40k;
        MS_40k[2] = LMS3_40k;

        MS_85k[0] = LMS1_85k;
        MS_85k[1] = LMS2_85k;
        MS_85k[2] = LMS3_85k;
        MS_85k[3] = LMS4_85k;


        /*-----------------------------------------*/


        last_qlsf[0] = 0.049793355045123;
        last_qlsf[1] = 0.071543733408561;
        last_qlsf[2] = 0.115002634382656;
```

690

```
last_qlsf[3] =  0.164845365833111;
last_qlsf[4] =  0.211800568342986;
last_qlsf[5] =  0.252341845504398;
last_qlsf[6] =  0.303571730115036;
last_qlsf[7] =  0.341160910229804;
last_qlsf[8] =  0.387682253964778;
last_qlsf[9] =  0.418740763446287;


/*--------------------------------------------------------------*/


Mean[0] = 0.049793355045123;
Mean[1] = 0.071543733408561;
Mean[2] = 0.115002634382656;
Mean[3] = 0.164845365833111;
Mean[4] = 0.211800568342986;
Mean[5] = 0.252341845504398;
Mean[6] = 0.303571730115036;
Mean[7] = 0.341160910229804;
Mean[8] = 0.387682253964778;
Mean[9] = 0.418740763446287;


/*--------------------------------------------------------------*/
/*          Table of candidates for 0.8k LSF quantization       */
/*--------------------------------------------------------------*/


ini_svector(stage_cand_08k, 0, 2, 8);


/*--------------------------------------------------------------*/
/*          Table of candidates for 4.0k LSF quantization       */
/*--------------------------------------------------------------*/


ini_svector(stage_cand_40k, 0, 3, 10);


/*--------------------------------------------------------------*/
/*          Table of candidates for 8.5k LSF quantization       */
/*--------------------------------------------------------------*/


ini_svector(stage_cand_85k, 0, 3, 10);


/*--------------------------------------------------------------*/
```

```
/*              Copy the MA-VQ Tables              */
/*--------------------------------------------------------------*/


for (i = 0; i < MAXLTT_08k; i++)
        for (j = 0; j < LMSMAX_08k; j++)
                for (k = 0; k < MAXLNp; k++)
                        lsf_cb_08k[i][j][k] = CBes_08k[i][j][k];


for (i = 0; i < MAXLTT_40k; i++)
        for (j = 0; j < LMSMAX_40k; j++)
                for (k = 0; k < MAXLNp; k++)
                        lsf_cb_40k[i][j][k] = CBes_40k[i][j][k];


for (i = 0; i < MAXLTT_85k; i++)
 for (j = 0; j < LMSMAX_85k; j++)
   for (k = 0; k < MAXLNp; k++)
                        lsf_cb_85k[i][j][k] = CBes_85k[i][j][k];


/*--------------------------------------------------------------*/


for (i = 0; i < NP; i++)
        lsf_new[i] = (i+0.5)*0.5/NP;


for (i = 0; i < NP; i++)
        lsf_mid[i] = (i + 0.5)*0.5 / NP;


for (i = 0; i < NP; i++)
        lsf_old[i] = (i+0.5)*0.5/NP;


for (i = 0; i < NP; i++)
        lsfq_old[i] = (i+0.5)*0.5/NP;


for (i = 0; i < NP; i++)
        lsfq_old_dec[i] = (i+0.5)*0.5/NP;


/*--------------------------------------------------------------*/


return;


/*--------------------------------------------------------------*/
```

}

/*------------------------------------------------------------*/


/*==========================================================*/
/* FUNCTION      : LSF_Q_lsfqnt ().                    */
/*------------------------------------------------------*/
/* PURPOSE      : This function quntize the LSF unsig an MA    */
/*                residual quntization algorithm.          */
/*------------------------------------------------------*/
/* INPUT ARGUMENTS :                              */
/*        _ (FLOAT64 []) lsf :    LSF vector.            */
/*------------------------------------------------------*/
/* OUTPUT ARGUMENTS :                            */
/*        _ (FLOAT64 []) qntlsf:    quantized LSF vector.    */
/*        _ (INT16   []) channel_idx: bitstream buffer.     */
/*        _ (INT16   []) stage_cnd:  prooning information.   */
/*------------------------------------------------------*/
/* INPUT/OUTPUT ARGUMENTS :                        */
/*          _ None.                          */
/*------------------------------------------------------*/
/* RETURN ARGUMENTS :                            */
/*        ·  _ None.                          */
/*==========================================================*/


void LSF_Q_lsfqnt (FLOAT64 lsf [], FLOAT64 qntlsf [], INT16 channel_idx [],

INT16 rate)

{
/*------------------------------------------------------*/


INT16    flip_total;
INT16    k, l, p;

INT16    Pbest[1];
INT16    indices[LTT_85k];

FLOAT64 weight[NP];
FLOAT64 e_lsf[LP_40k*NP];
FLOAT64 tmp_qe_qlsf[NP];

```
/*----------------------------------------------------*/
/*                Weights calculation              */
/*----------------------------------------------------*/


LSF_Q_lsf_to_weight (lsf, weight,rate);


/*----------------------------------------------------*/
/*             Mean subtraction from lsf        .   */
/*----------------------------------------------------*/


dif_dvector (lsf, Mean, lsf, 0, NP-1);


/*----------------------------------------------------*/
/*             Vector Prediction and Quantization */
/*----------------------------------------------------*/


switch (rate) {
  case RATE0_8K:
    for (p=0 ; p < LP_08k ; p++) {
      for (l=0 ; l < NP ; l++) {
        e_lsf[p*NP+l] = lsf[l];
        for (k=0 ; k < LQMA_08k ; k++) {
          e_lsf[p*NP+l] -= B_08k[p][k][l]*qes[k][l];
        }
      }
    }


    LSF_Q_Qnt_e(e_lsf,weight,LP_08k,tmp_qe_qlsf,Pbest,1,
            indices,lsf_cb_08k,MS_08k,stage_cand_08k,LTT_08k);


      for (l = 0; l < LTT_08k; l++)
          channel_idx[l] = (INT16)indices[l];


  break;


  case RATE4_0K:
    for (p=0 ; p < LP_40k ; p++) {
      for (l=0 ; l < NP ; l++) {
```

```
          e_lsf[p*NP+l] = lsf[l];
          for (k=0 ; k < LQMA_40k ; k++) {
            e_lsf[p*NP+l] -= B_40k[p][k][l]*qes[k][l];
          }
        }
      }
      LSF_Q_Qnt_e(e_lsf,weight,LP_40k,tmp_qe_qlsf,Pbest,1,
              indices,lsf_cb_40k,MS_40k,stage_cand_40k,LTT_40k);

        for (l = 0; l < LTT_40k; l++)
              channel_idx[l] = (INT16)indices[l];

        channel_idx[LTT_40k] = (INT16)Pbest[0];
    break;


    case RATE8_5K:
    case RATE2_0K:
      for (p=0 ; p < LP_85k ; p++) {
        for (l=0 ; l < NP ; l++) {
          e_lsf[p*NP+l] = lsf[l];
          for (k=0 ; k < LQMA_85k ; k++) {
            e_lsf[p*NP+l] -= B_85k[p][k][l]*qes[k][l];
          }
        }
      }
      LSF_Q_Qnt_e(e_lsf,weight,LP_85k,tmp_qe_qlsf,Pbest,1,
              indices,lsf_cb_85k,MS_85k,stage_cand_85k,LTT_85k);

        for (l = 0; l < LTT_85k; l++)
              channel_idx[l] = (INT16)indices[l];

    break;


    default:
      printf(" Invalid rate !! \n");
      exit(0);
    }


      /*-------------------------------------------------------*/
```

```
/*    Note: all the delayed decision information are available    */
/*-----------------------------------------------------------*/

    ini_dvector (qntlsf, 0, NP-1, 0.0);


switch (rate) {
  case RATE0_8K:
    for (l=0 ; l < NP ; l++) {
      for (k=0 ; k < LQMA_08k ; k++) {
        qntlsf[l] += B_08k[0][k][l]*qes[k][l];
      }
    }
  break;


  case RATE4_0K:
    for (l=0 ; l < NP ; l++) {
      for (k=0 ; k < LQMA_40k ; k++) {
        qntlsf[l] += B_40k[Pbest[0]][k][l]*qes[k][l];
      }
    }
  break;


  case RATE8_5K:
  case RATE2_0K:
    for (l=0 ; l < NP ; l++) {
      for (k=0 ; k < LQMA_85k ; k++) {
        qntlsf[l] += B_85k[0][k][l]*qes[k][l];
      }
    }
  break;


  default:
    printf(" Invalid rate !! \n");
    exit(0);
}



    add_dvector(qntlsf, tmp_qe_qlsf,  qntlsf, 0, NP-1);
    add_dvector(qntlsf, Mean,                          qntlsf, 0, NP-1);
```

EP 1 214 706 B1

```
flip_total = 0;
if(qntlsf[0] <= 0.0)
        flip_total++;


for (k = 1; k < NP; k++)
        {
        if(qntlsf[k] < qntlsf[k-1])
                flip_total++;
        }


        /*---------------------------------------------------------*/
        /*          simulate decoder lsf-erasure           */
        /*---------------------------------------------------------*/


        if (flip_total > 1)
                {
                wad_dvector(last_qlsf, 0.9, Mean,0.1, qntlsf, 0, NP-1);
#ifdef VERBOSE
                printf("\nWARNING frame %ld: Encoder flipped %d lsf pairs\n",
                                frm_count, flip_total);
#endif
                }


        /*---------------------------------------------------------*/


        LSF_Q_Order (qntlsf);
        LSF_Q_Space_lsf (qntlsf, 0);


        /*---------------------------------------------------------*/
        /*          Shifting the prediction states         */
        /*---------------------------------------------------------*/


switch (rate) {
  case RATE0_8K:
  case RATE4_0K:/*MA order is 4 for 0.8k and 4.0k */
        for (k = LQMA_40k-1;  0 < k; k--)
                cpy_dvector (qes[k-1], qes[k], 0, NP-1);


        break;
```

```
case RATE8_5K:
case RATE2_0K:/*MA order is 2 for 8.5k and 2.0k */
        for (k=LQMA_40k-1 ;  LQMA_85k <= k ; k--) {
          ini_dvector(qes[k],0, NP-1,0.0);
        }
        for (k=LQMA_85k-1 ;  0 < k ; k--) {
          cpy_dvector(qes[k-1],qes[k],0, NP-1);
        }
      break;

    default:
      printf(" Invalid rate !! \n");
      exit(0);
    }

        cpy_dvector (tmp_qe_qlsf, qes[0], 0, NP-1);

    /*-------------------------------------------------*/
    /*          Add the Mean vector to the LSF         */
    /*-------------------------------------------------*/

    add_dvector (lsf, Mean, lsf, 0, NP-1);  .

    /*-------------------------------------------------*/

    return;

    /*-------------------------------------------------*/
    }

/*-------------------------------------------------*/

/*=================================================*/
/* FUNCTION     : LSF_Q_lsf_decode ().              */
/*-------------------------------------------------*/
/* PURPOSE      : This function decodes the LSF vector.   */
/*-------------------------------------------------*/
/* INPUT ARGUMENTS  :                              */
/*        _ (INT16   []) channel_idx: indices.      */
```

```
/*          _ (INT16   ) bfi:        Bad Farme Indicator.     */
/*          _ (INT16   ) count:      Bad Farme counter.       */
/*          _ (FLOAT64 []) bfi_lpcg:   lpc gain of previous frame.*/
/*---------------------------------------------------------*/
/* OUTPUT ARGUMENTS :                                      */
/*          _ (FLOAT64 []) qntlsf:    decoded LSF vector.   */
/*---------------------------------------------------------*/
/* INPUT/OUTPUT ARGUMENTS :                                */
/*             _ None.                                     */
/*---------------------------------------------------------*/
/* RETURN ARGUMENTS :                                      */
/*             _ None.                                     */
/*=========================================================*/


void LSF_Q_lsf_decode(INT16 bfi_caution, INT16 *exp_flg,FLOAT64 qntlsf [],
              INT16 channel_idx [], INT16 bfi, INT16 count, INT16 rate)
            {
            /*-------------------------------------------------*/


        INT16 prd_idx;
        INT16 flip_total;
        INT16 lsf_caution;
        INT16 k, l;


        FLOAT64 tmp_qe_qlsf[NP];


        /*-------------------------------------------------*/
        /*             Not frame erasure                   */
        /*-------------------------------------------------*/


        prd_idx = 0;
        if (bfi == 0)
                {
                lsf_caution = 0;
                if (rate == RATE4_0K)
                        prd_idx = channel_idx[3];


            /*-------------------------------------------------*/
            /*             Generate the codebook vector        */
            /*-------------------------------------------------*/
```

```
            ini_dvector(tmp_qe_qlsf, 0, NP-1, 0.0);


            switch (rate)
                    {
                case RATE0_8K:
                            for (l = 0; l < LTT_08k; l++)
                                    {
                                    k = channel_idx[l];
                                    add_dvector (tmp_qe_qlsf, lsf_cb_08k[l][k],

tmp_qe_qlsf, 0, NP-1);
                                    }


                            break;


                case RATE4_0K:

                            for (l = 0; l < LTT_40k; l++)
                                    {
                                    k = channel_idx[l];
                                    add_dvector (tmp_qe_qlsf, lsf_cb_40k[l][k],

tmp_qe_qlsf, 0, NP-1);
                                    }
                            break;


                case RATE8_5K:
                case RATE2_0K:

                            for (l = 0; l < LTT_85k; l++)
                                    {
                                    k = channel_idx[l];
                                    add_dvector (tmp_qe_qlsf, lsf_cb_85k[l][k],

tmp_qe_qlsf, 0, NP-1);
                                    }

                            break;
```

```
        default: nrerror(" Invalid rate !! \n");
                break;
        }


/*-----------------------------------------------*/
/*       Generate the predicted lsf vector       */
/*-----------------------------------------------*/


ini_dvector(qntlsf, 0, NP-1, 0.0);


switch (rate)
        {
        case RATE0_8K:
                for (l = 0; l < NP ; l++)
                        for (k = 0 ; k < LQMA_08k; k++)
                                qntlsf[l] += B_08k[0][k][l]*qes_dec[k][l];
break;


        case RATE4_0K:
                for (l = 0; l < NP; l++)
                        for (k = 0; k < LQMA_40k; k++)
                                qntlsf[l] += B_40k[prd_idx][k][l]*qes_dec[k][l];
break;


        case RATE8_5K:
        case RATE2_0K:
                for (l = 0; l < NP; l++)
                        for (k = 0; k < LQMA_85k; k++)
                                qntlsf[l] += B_85k[0][k][l]*qes_dec[k][l];
break;


        default: nrerror("Invalid rate !!");
break;
        }


/*-----------------------------------------------*/


add_dvector (qntlsf, tmp_qe_qlsf, qntlsf, 0, NP-1);
add_dvector (qntlsf, Mean,                    qntlsf, 0, NP-1);
```

```
flip_total = 0;
if (qntlsf[0] <= 0.0)
        flip_total++;


for (k = 1; k < NP; k++)
        {
        if (qntlsf[k] < qntlsf[k-1])
                flip_total++;
        }


/*----------------------------------------------------*/
/*       lsf-erasure, synchronized with encoder       */
/*----------------------------------------------------*/


if (flip_total > 1)
        {
        wad_dvector (last_qlsf, 0.9, Mean,0.1, qntlsf, 0, NP-1);
#ifdef VERBOSE
                printf ("WARNING frame %ld: Decoder flipped %d lsf pairs\n",
                        frm_count, flip_total);
#endif
        }


/*----------------------------------------------------*/


LSF_Q_Order (qntlsf);
LSF_Q_Space_lsf (qntlsf, lsf_caution);

if( count <= 2 && count>=1 && bfi_caution == 1 )
        {
lsf_caution = 0;
*exp_flg =0;
for (k =0; k< NP -1; k++)
        {
        if( 8000.0*(qntlsf[k+1] - qntlsf[k]) < 75.0)
                {
        lsf_caution = 2;
        *exp_flg =1;
#ifdef VERBOSE
                printf(" LSF_CAUTION1 HAPPENED at FRAME %ld %hd %f \n",
```

```
                                                  frm_count, k,8000.0*(qntlsf[k+1] - qntlsf[k]));
#endif
                                          }
                                      }
                                  }
                  else
                          {
                                  lsf_caution = 0;
                  *exp_flg =0;
                  }


                  /*------------------------------------------------*/


                  LSF_Q_Space_lsf(qntlsf,lsf_caution);
                  }
          else
                  {
                  /*------------------------------------------------*/
                  /*              Frame erasure              */
                  /*------------------------------------------------*/


                  /*------------------------------------------------*/
                  /*      Generate the average past error lsf vector     */
                  /*------------------------------------------------*/


          (*exp_flg) = 0;


                  /*------------------------------------------------*/
                  /*      Shift previous LPC slightly towards mean     */
                  /*------------------------------------------------*/


                  wad_dvector (last_qlsf, 0.9, Mean, 0.1, qntlsf, 0, NP-1);


                  LSF_Q_Order (qntlsf);
                  lsf_caution = 5;
                  LSF_Q_Space_lsf (qntlsf, lsf_caution);


                  ini_dvector (tmp_qe_qlsf, 0, NP-1, 0.0);


                  switch (rate)
```

```
        {
        case RATE0_8K:
                for (l = 0; l < NP ; l++)
                        for (k = 0; k < LQMA_08k; k++)
                                tmp_qe_qlsf[l] += B_08k[0][k][l]*qes_dec[k][l];
                break;


        case RATE4_0K:
                for (l = 0; l < NP; l++)
                        for (k = 0; k < LQMA_40k; k++)
                                tmp_qe_qlsf[l] += B_40k[0][k][l]*qes_dec[k][l];
                break;


        case RATE8_5K:
        case RATE2_0K:
                for (l = 0; l < NP; l++)
                        for (k = 0; k < LQMA_85k; k++)
                                tmp_qe_qlsf[l] += B_85k[0][k][l]*qes_dec[k][l];
                break;


        default: nrerror ("Invalid rate !!");
                break;
        }


        /*-----------------------------------------------*/


        dif_dvector(qntlsf,          tmp_qe_qlsf, tmp_qe_qlsf, 0, NP-1);
        dif_dvector(tmp_qe_qlsf, Mean,          tmp_qe_qlsf, 0, NP-1);


        }


/*-----------------------------------------------*/
/*          Shifting the prediction states          */
/*-----------------------------------------------*/


cpy_dvector (qntlsf, last_qlsf, 0, NP-1);


switch (rate)
        {
        /*-----------------------------------------------*/
```

```
              /*          MA order is 4 for 0.8k and 4.0k        */
              /*-------------------------------------------------*/


              case RATE0_8K:
              case RATE4_0K:
                      for (k = LQMA_40k-1;  0 < k; k--)
                              cpy_dvector (qes_dec[k-1], qes_dec[k], 0, NP-1);


                      break;


              /*-------------------------------------------------*/
              /*          MA order is 2 for 8.5k and 2.0k        */
              /*-------------------------------------------------*/


              case RATE8_5K:
              case RATE2_0K:
                      for (k = LQMA_40k-1;  LQMA_85k <= k; k--)
                              ini_dvector(qes_dec[k],0, NP-1,0.0);


                      for (k = LQMA_85k-1;  0 < k; k--)
                              cpy_dvector(qes_dec[k-1],qes_dec[k],0, NP-1);


                      break;


              default: nrerror ("Invalid rate !!");
                      break;
                  }


      cpy_dvector (tmp_qe_qlsf, qes_dec[0], 0, NP-1);


      /*-------------------------------------------------*/


      return;


      /*-------------------------------------------------*/
          }


  /*-------------------------------------------------*/


  /*=================================================*/
```

```
/* FUNCTION    : LSF_Q_Order ().                    */
/*_____*/
/* PURPOSE     : This function reorder the decoded LSF vector. */
/*_____*/
/* INPUT ARGUMENTS :                                */
/*          _ None.                                 */
/*_____*/
/* OUTPUT ARGUMENTS :                               */
/*          _ None.                                 */
/*_____*/
/* INPUT/OUTPUT ARGUMENTS :                         */
/*      _ (FLOAT64 []) qlsf:   decoded LSF vector.  */
/*_____*/
/* RETURN ARGUMENTS :                               */
/*          _ None.                                 */
/*=================================================*/


void LSF_Q_Order (FLOAT64    qlsf [])
        {
        /*_____*/


        INT16  i, j;
        FLOAT64 temp;


        /*_____*/


        for (i = NP-1; i >= 0; i--)
            {
            /*_____*/


            for (j = 0 ; j < i; j++)
                {
                if (qlsf[j] > qlsf[j+1])
                    {
                    temp           = qlsf[j];
                    qlsf[j]   = qlsf[j+1];
                    qlsf[j+1]          = temp;
                    }
                }
```

```
          /*------------------------------------------------*/
          }

          /*-------------------------------------------------*/


       return;

          /*------------------------------------------------*/
          }


   /*-----------------------------------------------------*/


   /*================================================================*/
   /* FUNCTION     : LSF_Q_Space_lsf ().                    */
   /*-------------------------------------------------*/
   /* PURPOSE      : This function preserve the minimum spacing   */
   /*               between the decoded LSF vector         */
   /*               (range: 0<=val<=0.5).                 */
   /*-------------------------------------------------*/
   /* INPUT ARGUMENTS  :                          */
   /*       _ (INT16   []) lsf_caution: flag for LSF caution.    */
   /*-------------------------------------------------*/
   /* OUTPUT ARGUMENTS :                          */
   /*          _ None.                       */
   /*-------------------------------------------------*/
   /* INPUT/OUTPUT ARGUMENTS :                        */
   /*       _ (FLOAT64 []) lsf:      decoded LSF vector.     */
   /*-------------------------------------------------*/
   /* RETURN ARGUMENTS :                          */
   /*          _ None.                       */
   /*================================================================*/


   void LSF_Q_Space_lsf (FLOAT64 lsf [], INT16 lsf_caution)
          {
          /*------------------------------------------------*/


       INT16   i;
       FLOAT64 lsf_min, min_dist;


          /*------------------------------------------------*/
```

```
        lsf_min  = 0.0;
        min_dist = 0.0;


        /*-----------------------------------------------------*/


if(lsf_caution == 0)
        lsf_min = min_dist = 0.00625;  /* At least 50 Hz Spacing */
else if(lsf_caution == 1)
        lsf_min = min_dist = 0.01250;  /* At least 100 Hz Spacing */
else if(lsf_caution == 2)
        lsf_min = min_dist = 0.015625;  /* At least 125 Hz Spacing */
else if(lsf_caution == 3)
        lsf_min = min_dist = 0.01875;  /* At least 150 Hz Spacing */
else if(lsf_caution == 4)
        lsf_min = min_dist = 0.03125;  /* At least 250 Hz Spacing */
else if(lsf_caution == 5)
        lsf_min = min_dist = 0.0075;  /* At least  60 Hz Spacing */


        /*-----------------------------------------------------*/


        for (i = 0; i < NP; i++)
                {
                if (lsf[i] < lsf_min)
                        lsf[i] = lsf_min;
                lsf_min = lsf[i] + min_dist;
                }


        /*-----------------------------------------------------*/


        return;


        /*-----------------------------------------------------*/
        }


/*-----------------------------------------------------*/

/*=====================================================*/
/* FUNCTION     : LSF_Q_lsf_to_weight ().                 */
/*-----------------------------------------------------*/
```

```
/* PURPOSE     : This function calculates the proper weight   */
/*               factor of each LS value.                     */
/*----------------------------------------------------------*/
/* INPUT ARGUMENTS :                                      */
/*          _ (FLOAT64 []) lsf:     LSF vector.           */
/*----------------------------------------------------------*/
/* OUTPUT ARGUMENTS :                                     */
/*          _ (FLOAT64 []) weight:    error weights.      */
/*----------------------------------------------------------*/
/* INPUT/OUTPUT ARGUMENTS :                                  */
/*          _ None.                                       */
/*----------------------------------------------------------*/
/* RETURN ARGUMENTS :                                     */
/*          _ None.                                       */
/*==========================================================*/


void LSF_Q_lsf_to_weight (FLOAT64 lsf[], FLOAT64 weight[], INT16 ratc)
        {
        /*--------------------------------------------------*/


        INT16   j, i;
        INT16 idx1, idx2;

        FLOAT64  p[NP+1], q[NP+1];
        FLOAT64  p_poly, q_poly;
        FLOAT64  inv_pow_spect;
        FLOAT64  p_coeff, q_coeff, pi_arg, x;


        /*--------------------------------------------------*/


        pi_arg = 2*PI;
        p [0] = 1.0;
        q [0] = 1.0;
        p [2] = 1.0;
        q [2] = 1.0;
        p [1] = cos (lsf[1] * pi_arg);
        p [1] = -2.0 * p[1];
        q [1] = cos (lsf[0] * pi_arg);
        q [1] = -2.0 * q[1];
```

```
/*------------------------------------------------------------*/

for (i = 2; i <= NP/2; i++)
        {

        idx1 = 2 * i - 1;
        idx2 = 2 * i;

        p_coeff = cos (lsf[idx2 - 1] * pi_arg);
        p_coeff = -2.0 * p_coeff;
        q_coeff = cos (lsf[idx2 - 2] * pi_arg);
        q_coeff = -2.0 * q_coeff;

        for (j = i; j >= 2; j--)
                {
                q [j] = q [j] + q [j-1] * q_coeff + q [j-2];
                p [j] = p [j] + p [j-1] * p_coeff + p [j-2];
                q [idx2 - j] = q [j];
                p [idx2 - j] = p [j];
                }


        p [1]    = p [1] + p_coeff;
        p [idx1] = p [1];
        q [1]    = q [1] + q_coeff;
        q [idx1] = q [1];
        p [idx2] = 1.0;
        q [idx2] = 1.0;


        }


/*------------------------------------------------------------*/
/*    Calculating the (1 / (power spectrum)) and the proper weight    */
/*------------------------------------------------------------*/

for (i = 0; i < NP; i += 2)
        {
        p_poly = LSF_Q_cosine_polynomial(p, pi_arg*lsf[i]);

        x = cos(pi_arg*lsf[i]);
```

```
            inv_pow_spect = 4*sqr(p_poly)*(2.-2.*x);


            weight[i] = pow(inv_pow_spect/4.,-0.4);
            }


    for (i = 1; i < NP; i += 2)
            {
            q_poly = LSF_Q_cosine_polynomial(q,pi_arg*lsf[i]);


            x = cos(pi_arg*lsf[i]);
            inv_pow_spect = 4*sqr(q_poly)*(2.+2.*x);
            weight[i] = pow(inv_pow_spect/4.,-0.4);
            }


if (rate == RATE0_8K) {
  /* different weights for different frequencies.  10/24/99, Eyal */
  for (i=4 ; i < NP ; i++) {
    weight[i] *= -0.16*(FLOAT64)i+1.64;  /* 1.0 at i=4 an 0.2 at i=9 */
  }
}
    /*_____*/


    return;


    /*_____*/
    }


/*_____*/


/*=================================================================*/
/* FUNCTION     : LSF_Q_cosine_polynomial ().                */
/*_____*/
/* PURPOSE      : This function calculates the cosine polynomial. */
/*              Note that coef[0] should be 1.0.           */
/*_____*/
/* INPUT ARGUMENTS :                          */
/*       _ (INT16 []) coef:  coefficients.             */
/*       _ (INT16  ) omega: frequency.               */
/*_____*/
/* OUTPUT ARGUMENTS :                          */
```

```
/*              _ None.                    */
/*_____*/
/* INPUT/OUTPUT ARGUMENTS :                */
/*              _ None.                    */
/*_____*/
/* RETURN ARGUMENTS :                      */
/*        _ (FLOAT64 ) sum:  polynomial cosinus modulated sum.  */
/*=========================================================*/


FLOAT64 LSF_Q_cosine_polynomial (FLOAT64 coef[], FLOAT64 omega)
        {
        /*_____*/


        INT16  j;
        FLOAT64 sum, x;


        /*_____*/


        sum = coef[NP/2]/2.;


        for (j = 0; j < NP/2; j++){
          x = cos((NP/2-j)*omega);
          sum += coef[j] * x;
        }


        /*_____*/


        return (sum);


        /*_____*/
        }


/*_____*/


/*=========================================================*/
/* FUNCTION     : LSF_Q_Qnt_e ().                 */
/*_____*/
/* PURPOSE      : This function quantizes the prediction error of */
/*              the lsf prediction.                */
/*_____*/
```

```
/* INPUT ARGUMENTS :                                    */
/*      _ (FLOAT64     []) e:     prediction residual.        */
/*      _ (FLOAT64     []) w:     LSP weight factor.          */
/*      _ (INT16       ) DIn:   number of input candidates    */
/*                       (always 1 in the ITU-T 4kbit/s). */
/*      _ (INT16       ) DOut:   number of output candidates  */
/*                       (always 1 in the ITU-T 4kbit/s). */
/*      _ (FLOAT64 [][][]) CBe:   codebooks.                  */
/*      _ (INT16       []) MS:     size of codebooks.         */
/*      _ (INT16       []) stage_cnd: prooning information.   */
/*---------------------------------------------------------*/
/* OUTPUT ARGUMENTS :                                    */
/*      _ (INT16       *) Pptr:   best predictor.            */
/*      _ (FLOAT64     []) qe:     quantized prediction residual. */
/*      _ (INT16       *) cluster:best indices.              */
/*---------------------------------------------------------*/
/* INPUT/OUTPUT ARGUMENTS :                              */
/*             _ None.                                    */
/*---------------------------------------------------------*/
/* RETURN ARGUMENTS :                                    */
/*             _ None.                                    */
/*=========================================================*/


void LSF_Q_Qnt_e (FLOAT64 e [], FLOAT64 w [], INT16 DIn, FLOAT64 qe[], INT16 *Pptr,
                  INT16 DOut, INT16 cluster [],
                     FLOAT64 ***CBe, INT16 MS[],
                        INT16 *stage_cnd, INT16 ltt)
        {
        /*---------------------------------------------------------*/



        INT16   ptr_back[LTT_85k][MAX_CAND_LSFQ];
        INT16   best_indx[LTT_85k][MAX_CAND_LSFQ];
        INT16   N_indx[LTT_85k];
        INT16   ptr;
        INT16   i;


        FLOAT64     d_data [LTT_85k][MAX_CAND_LSFQ*NP];


        /*---------------------------------------------------------*/
```

```
        LSF_Q_New_ML_search (e,w, DIn, d_data[0], (INT16)stage_cnd[0],

                                        best_indx[0], ptr_back[0], CBe[0], MS[0]);



        for (i = 1; i < ltt-1; i++)
                {
                LSF_Q_New_ML_search (d_data[i-1], w, (INT16)stage_cnd[i-1],

                                                d_data[i], (INT16)stage_cnd[i],

                                                    best_indx[i], ptr_back[i], CBe[i],

                                                            MS[i]);

                }


        LSF_Q_New_ML_search (d_data[ltt-2], w, (INT16)stage_cnd[ltt-2],

                                        d_data[ltt-1], DOut, best_indx[ltt-1],

                                            ptr_back[ltt-1], CBe[ltt-1], MS[ltt-1]);


        /*-------------------------------------------------------*/


N_indx[ltt-1] = best_indx[ltt-1][0];

ptr = ptr_back[ltt-1][0];

for (i=ltt-2 ; i >= 0 ; i-- ) {

  N_indx[i] = best_indx[i][ptr];

  ptr = ptr_back[i][ptr];

}


        /* this is the pointer to the best predictor */

*Pptr = ptr;



for (i=0 ; i < ltt ; i++) {

  cluster[i] = N_indx[i];

}


ini_dvector (qe, 0, NP-1, 0.0);

for (i=0 ; i < ltt ; i++) {

  add_dvector (qe, CBe[i][N_indx[i]], qe, 0, NP-1);

}

        /*-------------------------------------------------------*/
```

```
        return;


        /*----------------------------------------------------*/
    }



    /*------------------------------------------------------------*/


    /*============================================================*/
    /* FUNCTION     : LSF_Q_New_ML_search ().              */
    /*----------------------------------------------------*/
    /* PURPOSE      : This function performs the ML search. The data */
    /*                pointer points to a J vectors array (each of   */
    /*                length NP , concatenated), the diff_data       */
    /*                pointer points to a J*K vectors array (each of */
    /*                lengts NP, concatenated). The diff_data holds, */
    /*                for each vector in data, the K smallest        */
    /*                quantization error vector, using the given     */
    /*                code book.                                     */
    /*----------------------------------------------------*/
    /* INPUT ARGUMENTS :                                 */
    /*        _ (FLOAT64  []) d_data:    prediction residual.      */
    /*        _ (FLOAT64  []) weight:    LSP weight factor.        */
    /*        _ (INT16     ) J:        number of input candidates. */
    /*        _ (INT16     ) K:        number of output candidates. */
    /*        _ (FLOAT64 [][]) code:    codebook.                  */
    /*        _ (INT16     ) MQ:       size of codebook.           */
    /*----------------------------------------------------*/
    /* OUTPUT ARGUMENTS :                                */
    /*        _ (FLOAT64  []) new_d_data: new prediction residual.  */
    /*        _ (INT16    []) best_indx:  array of the optmisaed     */
    /*                        indexes.                              */
    /*        _ (INT16    []) ptr_back:   best candidates of past.   */
    /*----------------------------------------------------*/
    /* INPUT/OUTPUT ARGUMENTS :                          */
    /*            _ None.                                 */
    /*----------------------------------------------------*/
    /* RETURN ARGUMENTS :                                */
    /*            _ None.                                 */
    /*============================================================*/
```

```
void LSF_Q_New_ML_search (FLOAT64 d_data [], FLOAT64 weight [], INT16 J,
                          FLOAT64 new_d_data [], INT16 K, INT16 best_indx [],
                          INT16 ptr_back [], FLOAT64 **code,
                          INT16 MQ)
{
    /*-------------------------------------------------------------*/

    INT16   idx1, idx2;

    INT16   m,l,p,q;
    FLOAT64 sum[LMSMAX_85k*MAX_CAND_LSFQ];
    FLOAT64 min[MAX_CAND_LSFQ];
    INT16   min_indx_p[MAX_CAND_LSFQ];
    INT16   min_indx_m[MAX_CAND_LSFQ];


    /*-------------------------------------------------------------*/
    /*                  Initialisation                  */
    /*-------------------------------------------------------------*/

    for (q = 0; q < K; q++)
            min[q] = DBL_MAX;

    /*-------------------------------------------------------------*/


    for (p = 0; p < J; p++)
            {
            for(m=0 ; m < MQ ; m++)
                    {
                    sum[p*MQ+m] = 0.0;

                    for (l = 0; l < NP; l++)
                            sum[p*MQ+m] += weight[l]*sqr(d_data[p*NP+l]-code[m][l]);
                    }
            }


    /*-------------------------------------------------------------*/


    for (q = 0; q < K; q++)
            {
```

```
/*------------------------------------------------*/


for (p = 0; p < J; p++)
        {
                for (m=0 ; m < MQ ; m++)
                        {
                                if (sum[p*MQ+m] < min[q])
                                        {
                                        min[q] = sum[p*MQ+m];
                                        min_indx_p[q] = p;
                                        min_indx_m[q] = m;
                                        }
                        }
        }


        idx1 = min_indx_p[q]*MQ+min_indx_m[q];

        sum[idx1] = DBL_MAX;

        /*------------------------------------------------*/
        }


/*------------------------------------------------*/


for (q = 0; q < K; q++)
        {
        /*------------------------------------------------*/


        for (1 = 0; 1 < NP; 1++)
                {
                idx1 = min_indx_p[q]*NP + 1;
                idx2 = min_indx_m[q];

                new_d_data[q*NP+1] = d_data[idx1]-code[idx2][1];
                }


        /*------------------------------------------------*/


        ptr_back[q] = min_indx_p[q];
```

```
                best_indx[q] = min_indx_m[q];

            /*------------------------------------------------*/
            }


        /*----------------------------------------------------*/

    return;

        /*------------------------------------------------*/
    }


/*------------------------------------------------*/

/*================================================*/
/*----------------- END --------------------*/
/*================================================*/
```

```
/*===================================================================*/


/*===============================================================*/
/* Conexant System Inc.                          */
/* 4311 Jamboree Road                            */
/* Newport Beach, CA 92660                        */
/*-----------------------------------------------*/
/* Copyright(C) 2000 Conexant System Inc.               */
/*-----------------------------------------------*/
/* ALL RIGHTS RESERVED:                          */
/* No part of this software may be reproduced in any form or by any */
/* means or used to make any derivative work (such as transformation */
/* or adaptation) without the authorisation of Conexant System Inc.  */
/*===============================================================*/
/* PROTOTYPE FILE : lib_q_lsf.h                     */
/*===============================================================*/


/*-----------------------------------------------*/
/*----------------------- FUNCTIONS ----------------------*/
/*-----------------------------------------------*/


void LSF_Q_init_lib               (void);


void LSF_Q_lsfqnt               (FLOAT64 [], FLOAT64 [], INT16 *, INT16 );


void LSF_Q_Order               (FLOAT64 []);


void LSF_Q_lsf_to_weight          (FLOAT64 [], FLOAT64 [], INT16);


FLOAT64 LSF_Q_cosine_polynomial    (FLOAT64 [], FLOAT64);


void LSF_Q_Space_lsf            (FLOAT64 [], INT16);


void LSF_Q_lsf_decode           (INT16 , INT16 * ,FLOAT64 [], INT16 [],
                                INT16 , INT16 , INT16);



void LSF_Q_Qnt_e               (FLOAT64  [], FLOAT64  [], INT16 , FLOAT64 [],
                                INT16 [], INT16 , INT16  [], FLOAT64 ***,
```

```
                                         INT16 [], INT16 *, INT16 );

void LSF_Q_New_ML_search          (FLOAT64 [], FLOAT64 [], INT16, FLOAT64 [],
                                       INT16, INT16 [], INT16 [],
                                          FLOAT64 **, INT16);
```

/*=======================================================================*/
/*--------------------------- END ----------------------------*/
/*=======================================================================*/

```
/*===============================================================*/


/*===============================================================*/
/* Conexant System Inc.                          */
/* 4311 Jamboree Road                            */
/* Newport Beach, CA 92660                        */
/*_____*/
/* Copyright(C) 2000 Conexant System Inc.              */
/*_____*/
/* ALL RIGHTS RESERVED:                           */
/* No part of this software may be reproduced in any form or by any  */
/* means or used to make any derivative work (such as transformation */
/* or adaptation) without the authorisation of Conexant System Inc.  */
/*===============================================================*/
/* LIBRARY: lib_smo.c                          */
/*===============================================================*/


/*_____*/
/*_____ INCLUDE _____*/
/*_____*/


#include "typedef.h"


#include "main.h"
#include "const.h"
#include "gputil.h"


#include "ext_var.h"


#include "lib_smo.h"


/*_____*/
/*_____ FUNCTIONS _____*/
/*_____*/


/*===============================================================*/
/* FUNCTION     : SMO_init_lib ().                   */
/*_____*/
/* PURPOSE      : This function initialisa the global variables  */
/*                  for the library SMO.                    */
```

```
/*------------------------------------------------*/  .
/* INPUT ARGUMENTS :                          */
/*              _ None.                        */
/*------------------------------------------------*/
/* OUTPUT ARGUMENTS :                         */
/*              _ None.                        */
/*------------------------------------------------*/
/* INPUT/OUTPUT ARGUMENTS :                      */
/*              _ None.                        */
/*------------------------------------------------*/
/* RETURN ARGUMENTS :                         */
/*              _ None.                        */
/*================================================================*/


void SMO_init_lib (void)
        {
        /*------------------------------------------------*/
        /*              SMO_lsf_smooth_est            */
        /*------------------------------------------------*/

        N_mode_sub_est = 0;
        N_mode_frm = 0;


        /*------------------------------------------------*/
        /*              SMO_initial_analysis          */
        /*------------------------------------------------*/

        consec_low = 0;
        consec_high = 0;
        consec_vad_0 = 0;

        updates_noise = 0;
        updates_speech = 0;
        calls = 0;
        lev_reset = 0;
        ma_max_noise = 0.0;
        ma_max_speech = 0.0;
        ma_cp = 0.0;


        buffer_p = buffer_smo+HI_LAG2;
```

```
/*-------------------------------------------------*/
/*              SMO_refined_analysis            */
/*-------------------------------------------------*/
;

N_mode_sub_ref = N_MODE_SUB_START;
consec = 0;
updates = 0;
ma_max = 0.0;


/*-------------------------------------------------*/


return;


/*-------------------------------------------------*/
}


/*-------------------------------------------------*/


/*===================================================================*/
/* FUNCTION     : SMO_lsf_smooth_est ().              */
/*-------------------------------------------------*/
/* PURPOSE      : This function classify teh input signal frame: */
/*               file.                        */
/*-------------------------------------------------*/
/* INPUT ARGUMENTS :                         */
/*         _ (INT16    ) Vad   :  VAD of current frame.      */
/*         _ (INT16    ) PastVad:  VAD of previous frame.      */
/*         _ (FLOAT64  ) refl  :  first reflection coefficient. */
/*         _ (FLOAT64 []) lsf  :  curent frame LSF coefficients.*/
/*-------------------------------------------------*/
/* OUTPUT ARGUMENTS :                        */
/*         _ (FLOAT64  ) beta_frm: estimated LSF smoothing    */
/*                  factor.                */
/*-------------------------------------------------*/
/* INPUT/OUTPUT ARGUMENTS :                     */
/*         _ None.                        */
/*-------------------------------------------------*/
/* RETURN ARGUMENTS :                        */
/*         _ None.                        */
```

723

```
/*=====================================================================*/

void SMO_lsf_smooth_est (INT16 Vad, INT16 PastVad, FLOAT64 refl,
                         FLOAT64 lsf [], FLOAT64 beta_frm [])
        {
        /*------------------------------------------------------------*/

        INT16 i, i_sf;
        INT16 mode_frm, N_sub_and;
        FLOAT64 dSP, dSP_avg, dSP_int;


        /*------------------------------------------------------------*/
        /*           Algorithm initialisation              */
        /*------------------------------------------------------------*/

        if (frm_count == 1)
                {
                cpy_dvector (lsf, lsf_old_smo, 0, NP-1);
                cpy_dvector (lsf, ma_lsf,  0, NP-1);
                ini_dvector (dSP_buf,  0, DSP_BUFF_SIZE-1, 0.0);
                }


        /*------------------------------------------------------------*/
        /*           Calculate subframe smoothing          */
        /*------------------------------------------------------------*/

        for (i_sf = 0; i_sf < N_SF4; i_sf++)
                {
                if(Vad == 1 || PastVad == 1)
                        {
                        /*--------------------------------------------*/
                        /*              Speech/spike mode        */
                        /*--------------------------------------------*/

                        N_mode_sub_est = 0;
                        }

                N_sub[i_sf] = N_mode_sub_est;

                if(Vad == 0 && PastVad == 0)
```

```
            {
            /*----------------------------------------------------------*/
            /*              Unvoiced/non-speech mode          */
            /*----------------------------------------------------------*/


            N_mode_sub_est++;
            if(N_mode_sub_est > 4)
                      N_mode_sub_est = 4;
            }


        }


/*----------------------------------------------------------*/
/*              Calculate frame smoothing           */
/*----------------------------------------------------------*/


for (dSP = 0.0, dSP_avg = 0.0, i = 0; i < NP; i++)
        {
        dSP += (lsf[i] - lsf_old_smo[i])*(lsf[i] - lsf_old_smo[i]);
        dSP_avg += (lsf[i]-ma_lsf[i])*(lsf[i]-ma_lsf[i]);
        }

for(dSP_int = 0.0, i = DSP_BUFF_SIZE-1; i > 0; i--)
        {
        dSP_buf[i]  = dSP_buf[i-1];
        dSP_int         += dSP_buf[i];
        }

dSP_buf[0] = dSP_avg;
dSP_int += dSP_buf[0];


/*----------------------------------------------------------*/


mode_frm = 0;
N_sub_and = 1;
for (i = 0; i < N_SF4; i++)
        {
        if (Vad == 1 || PastVad == 1)
                mode_frm = 3;
        if(N_sub[i] == 0)
```

```
                    N_sub_and = 0;
            }


    /*-----------------------------------------------------------------*/


    if(mode_frm == 3 || N_sub_and == 0 || refl > R1lim)
            {
            N_mode_frm = 0;
            *beta_frm = 0.0;

                    ini_dvector (dSP_buf, 0, DSP_BUFF_SIZE-1, 0.0);
            }
    else if((dSP > dSP1 || dSP_int > dSP_int1) && N_mode_frm > 0)
            {
            N_mode_frm = 0;
            *beta_frm = 0.0;

                    ini_dvector (dSP_buf, 0, DSP_BUFF_SIZE-1, 0.0);


            }
    else if(dSP > dSP2 && N_mode_frm > 1)
                    N_mode_frm = 1;


    /*-----------------------------------------------------------------*/


    if(mode_frm == 0)
            {
            N_mode_frm++;
            if (N_mode_frm > 5)
                    N_mode_frm = 5;
            *beta_frm = (FLOAT64)((N_mode_frm-1)*(N_mode_frm-1)) /

            16.0*BETA_FRM;
            }


    /*-----------------------------------------------------------------*/
    /*                    Buffer parameters                    */
    /*-----------------------------------------------------------------*/


    cpy_dvector (lsf, lsf_old_smo, 0, NP-1);
```

```
for (i = 0; i < NP; i++)
        ma_lsf[i] = (*beta_frm)*ma_lsf[i] + (1.0-(*beta_frm))*lsf[i];


        /*---------------------------------------------------------*/


        return;
        /*---------------------------------------------------------*/

        }


/*---------------------------------------------------------------*/


/*===============================================================*/
/* FUNCTION     : SMO_refined_analysis ().                    */
/*---------------------------------------------------------*/
/* PURPOSE      : This function performs the refined analysis of */
/*                the energy evolution and calculates the      */
/*                smoothing factor for the energy manipulation.  */
/*---------------------------------------------------------*/
/* INPUT ARGUMENTS :                                 */
/*        _ (FLOAT64 []) res      : input frame.         */
/*        _ (INT16   ) speech_mode: result of the initial   */
/*                        analysis.             */
/*        _ (FLOAT64 []) pitch_corr : pitch correlation values.  */
/*        _ (FLOAT64 []) lsf      : curent frame LSF       */
/*                        coefficients.        */
/*---------------------------------------------------------*/
/* OUTPUT ARGUMENTS :                               */
/*        _ (FLOAT64 *) exc_mode :  smoothing mode.        */
/*        _ (FLOAT64 *) beta_sub :  estimated smoothing factor.*/
/*---------------------------------------------------------*/
/* INPUT/OUTPUT ARGUMENTS :                            */
/*            _ None.                      */
/*---------------------------------------------------------*/
/* RETURN ARGUMENTS :                                */
/*            _ None.                      */
/*===============================================================*/


void SMO_refined_analysis (FLOAT64 res [], INT16 speech_mode,
                                FLOAT64 pitch_corr [], INT16 *exc_mode,
```

```
                                        FLOAT64 *beta_sub, INT16 l_sf)
{
/*------------------------------------------------------------*/


INT16 i;
FLOAT64 max, max_mes, val;


/*------------------------------------------------------------*/
/*              Find the max excitation value              */
/*------------------------------------------------------------*/


for(max = -DBL_MAX, i = 0; i < l_sf; i++)
        {
        val = (res[i] > 0.0 ? res[i] : -res[i]);
        if (val > max)
                max = val;
        }



/*------------------------------------------------------------*/


max_mes = max/(ma_max+EPSI);

if (speech_mode == 1)
        {
        /*------------------------------------------------------------*/
        /*              speech/spike mode              */
        /*------------------------------------------------------------*/


        N_mode_sub_ref = N_MODE_SUB_START;
        (*beta_sub) = 0.0;
        (*exc_mode) = 1;
        }
else
        {
        /*------------------------------------------------------------*/


        if(max_mes < 1.75)
                {
                /*------------------------------------------------------------*/
```

```
                    /*          Unvoiced/non-speech mode          */
            /*_____*/


                    N_mode_sub_ref++;
                    if (N_mode_sub_ref > 4)
                            N_mode_sub_ref = 4;


            /*_____*/
                    /*    Smooth energy if sustained unvoiced/non-speech    */
            /*_____*/


                    if (N_mode_sub_ref > 0)
                            (*beta_sub) = BETA_SUB*(FLOAT64)((N_mode_sub_ref-1)*

(N_mode_sub_ref-1))/9.0;
                        else
                                (*beta_sub) = 0.0;


                        (*exc_mode) = 0;
                        }
                else
                    {
                    /*_____*/
                    /*              speech/spike mode              */
                    /*_____*/


                    N_mode_sub_ref = N_MODE_SUB_START;
                    (*beta_sub) = 0.0;
                    (*exc_mode) = 1;
                    }


            if(max_mes <= 0.5)
                    {
                    if (consec < CONSEC_MAX)
                            consec++;
                    }
            else
                    consec = 0;


            /*_____*/
```

```
/*          Update moving average of maximum        */
/*------------------------------------------------*/


if((*exc_mode == 0 && (max_mes > 0.5 || consec > CONSEC_MAX-1)) ||
        (updates <= UPDATE_MAX  && pitch_corr[1] < 0.60 &&
                    pitch_corr[0] < 0.65))
                {
                        ma_max = 0.9*ma_max + 0.1*max;

                    if (updates <= UPDATE_MAX)
                            updates++;
                }
    /*------------------------------------------------*/
    }


/*------------------------------------------------*/


return;


/*------------------------------------------------*/
}


/*================================================*/
/* FUNCTION    : SMO_initial_analysis ().              */
/*------------------------------------------------*/
/* PURPOSE     : This function performs the initial analysis of */
/*          the energy evolution.                  */
/*------------------------------------------------*/
/* INPUT ARGUMENTS :                        */
/*      _ (FLOAT64 []) signal: input frame.          */
/*      _ (INT16   ) Vad  : VAD of current frame.       */
/*      _ (FLOAT64  ) lag _: sub-frame lag value.       */
/*      _ (FLOAT64  ) refl : first reflection coefficient   */
/*                  analysis.            */
/*      _ (FLOAT64 []) lsf  : curent frame LSF coefficients. */
/*------------------------------------------------*/
/* OUTPUT ARGUMENTS :                       */
```

```
/*         _ (FLOAT64 []) pitch_corr : pitch correlation values. */
/*         _ (FLOAT64 *) speech_mode : smoothing mode (1/0).    */
/*-----------------------------------------------------------------*/
/* INPUT/OUTPUT ARGUMENTS :                                    */
/*           _ None.                               */
/*-----------------------------------------------------------------*/
/* RETURN ARGUMENTS :                                    */
/*           _ None.                               */
/*=================================================================*/


void SMO_initial_analysis(FLOAT64 signal [], INT16 Vad,
                FLOAT64 lag, FLOAT64 refl, INT16 *speech_mode,
                FLOAT64 *pitch_corr, INT16 l_sf)
          {
          /*-----------------------------------------------------*/


          INT16   i, j;
          INT16   lag1, lag2, start;
          INT16   cond1, cond2, cond3, cond4;


          FLOAT64 max, max_mes, val, energy;
          FLOAT64 cp1, cp2, cp, SNR_max, alpha_speech;
          FLOAT64 deci_max_mes, deci_ma_cp;
          FLOAT64 update_max_mes;
          FLOAT64 update_ma_cp_speech;
          FLOAT64 max_group[MAX_GRP_SIZE], min_max, end_max;
          FLOAT64 y, yx, slope, sum;
          FLOAT64 val1, val2, val3;


          /*-----------------------------------------------------*/
          /*    Update counter for consecutive non-speech subframes    */
          /*-----------------------------------------------------*/


          if(Vad == 0)
                {
                /*-------------------------------------------*/
                /*       Counts to max 2 frames (8 subframes)      */
                /*-------------------------------------------*/


                if (consec_vad_0 < 8)
```

```
                    consec_vad_0++;
            }
    else
            consec_vad_0 = 0;


    /*------------------------------------------------------------*/
    /*    Estimate speech to noise ratio for adaptation of thresholds  */
    /*------------------------------------------------------------*/


    if (updates_noise >= 20 && updates_speech >= 20)
            {
            SNR_max = ma_max_speech/(ma_max_noise + EPSI);
            SNR_max = (SNR_max > 32.0 ? 32.0 : SNR_max);
            }
    else
            SNR_max = 3.5;


    if (SNR_max < 1.75 && ADAPT_THRESHOLDS)
            {
            deci_max_mes = 1.30;
            deci_ma_cp = 0.70;

            update_max_mes = 1.10;
            update_ma_cp_speech = 0.72;
            }
    else if(SNR_max < 2.5 && ADAPT_THRESHOLDS)
            {
            deci_max_mes = 1.65;
            deci_ma_cp = 0.73;

            update_max_mes = 1.30;

            update_ma_cp_speech = 0.72;
            }
    else
            {
            /*------------------------------------------------------------*/
            /*        Start-up and non-adaptive thresholds        */
            /*------------------------------------------------------------*/
```

```
                deci_max_mes   = 1.75;
                deci_ma_cp              = 0.77;

                update_max_mes = 1.30;

                update_ma_cp_speech = 0.77;
        }


/*----------------------------------------------------------*/
/*              Update signal buffer              */
/*----------------------------------------------------------*/


for (i = 0; i < HI_LAG2; i++)
        buffer_smo[i] = buffer_smo[i+l_sf];

for (i = 0; i < l_sf; i++)
        buffer_p[i] = signal[i];


/*----------------------------------------------------------*/
/*      Calculate pitch correlation of the speech signal       */
/*----------------------------------------------------------*/


energy = 0.0;
for (i = 0; i < l_sf; i++)
        energy += (INT16)buffer_p[i]*(INT16)buffer_p[i];

lag1 = (INT16)lag;

if (lag1 == HI_LAG2)
        lag2 = lag1-1;
else
        lag2 = lag1+1;

if (energy == 0.0)
        cp = 0.0;
else
        {
        dot_dvector (buffer_p, buffer_p-lag1,        &val1, 0, l_sf-1);
        dot_dvector (buffer_p, buffer_p,             &val2, 0, l_sf-1);
        dot_dvector (buffer_p-lag1, buffer_p-lag1, &val3, 0, l_sf-1);
```

```
            cp1 = val1 / (sqrt(val2 * val3) + EPSI);


            dot_dvector (buffer_p, buffer_p-lag2,        &val1, 0, l_sf-1);
            dot_dvector (buffer_p, buffer_p,             &val2, 0, l_sf-1);
            dot_dvector (buffer_p-lag2, buffer_p-lag2, &val3, 0, l_sf-1);


            cp2 = val1 / (sqrt (val2 * val3) + EPSI);


            cp = (cp1 > cp2) ? cp1 : cp2;
            }


ma_cp = 0.9*ma_cp + 0.1*cp;


/*----------------------------------------------------------------*/
/*              Find the max in pitch period              */
/*----------------------------------------------------------------*/


start = (lag2 > l_sf) ? (l_sf-lag2) : 0;


sum = 0.0;
max = -MAXFLT;


for (i = start; i < l_sf; i++)
        {
        val = (buffer_p[i] > 0.0) ? buffer_p[i] : -buffer_p[i];


        /*----------------------------------------------------------------*/
        /*              Mean Update              */
        /*----------------------------------------------------------------*/


        sum += val;


        /*----------------------------------------------------------------*/
        /*              Max Update              */
        /*----------------------------------------------------------------*/


        if (val > max)
                max = val;
```

```
                        }


        max_mes  = max/(ma_max_noise+EPSI);


        /*-----------------------------------------------*/
        /*              Update buffer of maxima          */
        /*-----------------------------------------------*/


        for (i = 0; i < SMO_BUFF_SIZE-1; i++)
                {
                buffer_max_smo[i] = buffer_max_smo[i+1];
                buffer_sum_smo[i] = buffer_sum_smo[i+1];
                }


        buffer_sum_smo [SMO_BUFF_SIZE-1] = sum;
        buffer_max_smo [SMO_BUFF_SIZE-1] = max;


        /*-----------------------------------------------*/
        /*   Find sum excluding current subframe, and max in groups of   */
        /*              3 subframes                       */
        /*-----------------------------------------------*/


        sum = 0.0;
        for(i = 0; i < MAX_GRP_SIZE; i++)
                {
                max_group[i] = buffer_max_smo[3*i];
                for (j = 1; j < 3; j++)
                        {
                        /*-----------------------------------*/
                        /*              sum Update            */
                        /*-----------------------------------*/


                        if (3*i+j < SMO_BUFF_SIZE-1)
                                sum += buffer_sum_smo[3*i+j];


                        /*-----------------------------------*/
                        /*              Update subgroup max   */
                        /*-----------------------------------*/


                        if (buffer_max_smo[3*i+j] > max_group[i])
```

```
                                    max_group[i] = buffer_max_smo[3*i+j];
                        }
            }

/*---------------------------------------------------------------*/

sum *= 1.7857e-03;

/*---------------------------------------------------------------*/
/*          Find minimum among first 4 subgroups          */
/*---------------------------------------------------------------*/

min_max = max_group[0];
for (i = 1; i < MAX_GRP_SIZE-1; i++)
            {
            if(max_group[i] < min_max)
                        min_max = max_group[i];
            }

/*---------------------------------------------------------------*/
/*          Extract the maximum of last subgroup          */
/*---------------------------------------------------------------*/

end_max = max_group[MAX_GRP_SIZE-1];

/*---------------------------------------------------------------*/
/*          Find slope of MSE linear fit to the 5 maximums          */
/*---------------------------------------------------------------*/

yx = 0.0;
y  = 0.0;

for (i = 0; i < MAX_GRP_SIZE; i++)
            {
            yx += (FLOAT64)i * max_group[i];
            y  += max_group[i];
            }

slope = 0.1*(yx - 2.0*y);
```

```
/*------------------------------------------------------*/
/*               Classify subframe              */
/*------------------------------------------------------*/


if (((max_mes < deci_max_mes && ma_cp < deci_ma_cp) || (Vad == 0)))
        *speech_mode = 0;
else
        *speech_mode = 1;



/*------------------------------------------------------*/
/*    Measure consecutive low level (compared to noise) subframes   */
/*------------------------------------------------------*/


if(updates_noise == 21 && max_mes <= 0.3)
        {
        if(consec_low < HL_COUNT_MAX)
                consec_low++;
        }
else
        consec_low = 0;



/*------------------------------------------------------*/
/*    Reset noise update if significant decrease compared to    */
/*              the noise level             */
/*------------------------------------------------------*/


if(consec_low == HL_COUNT_MAX)
        {
        updates_noise = 0;
        lev_reset = -1;
        }



/*------------------------------------------------------*/
/*  Measure consecutive stationary high level (compared to noise)   */
/*              subframes likely to be noise            */
/*------------------------------------------------------*/


if( (updates_noise >= 20 || lev_reset == -1) && max_mes > 1.5 &&
        ma_cp < 0.70 && cp < 0.85 && refl < -0.40 &&
                end_max < 50.0*min_max && max < 35.0*sum && slope > -100.0 &&
```

```
                                    slope < 120.0)
                                    {
                                    if(consec_high < HL_COUNT_MAX)
                                            consec_high++;


                                    }
        else
                consec_high = 0;


        /*---------------------------------------------*/
        /*      Reset noise update if significant stationary increase    */
        /*          in noise level subframes likely to be noise       */
        /*---------------------------------------------*/


        if ((consec_high == HL_COUNT_MAX) && (end_max < 6.0*min_max) &&
                    (max < 5.0*sum))
                {
                updates_noise = 20;
                lev_reset = 1;
                }


        /*---------------------------------------------*/
        /*              Update of noise max               */
        /*---------------------------------------------*/



        /*---------------------------------------------*/
        /*          1. condition: regular update          */
        /*---------------------------------------------*/


        cond1 = ((max_mes < update_max_mes) && (ma_cp < 0.60) &&
                    (cp < 0.65) && (max_mes > 0.3));


        /*---------------------------------------------*/
        /*          2. condition: vad conditioned update      */
        /*---------------------------------------------*/


        cond2 = (consec_vad_0 == 8);


        /*---------------------------------------------*/
        /*          3. condition: start-up/reset update       */
```

```
/*-------------------------------------------------*/


cond3 = (updates_noise <= 20 && ma_cp < 0.70 && cp < 0.75 &&
            refl < -0.40 && end_max < 5.0*min_max &&
                (lev_reset != -1 || (lev_reset == -1 && max_mes < 2.0)));


/*-------------------------------------------------*/
/*          4. condition: pitch correlation              */
/*-------------------------------------------------*/


cond4   = (ma_cp > update_ma_cp_speech);


if(calls == 3 && (cond1 || cond2 || cond3))
        {
        /*-------------------------------------------*/
        /*       Update moving average of noise maximum        */
        /*-------------------------------------------*/


        ma_max_noise = 0.9*ma_max_noise + 0.1*max;


        if (updates_noise <= 20)
                updates_noise++;
        else
                lev_reset = 0;


        /*-------------------------------------------*/
        }


/*-------------------------------------------------*/
/*          Update of speech max                 */
/*-------------------------------------------------*/


else if (calls == 3 && cond4)
        {
        /*-------------------------------------------*/
        /*       Update moving average of speech maximum       */
        /*-------------------------------------------*/


        if (updates_speech <= 60)
```

```
                    alpha_speech = 0.95;
              else
                    alpha_speech = 0.999;


          ma_max_speech = alpha_speech*ma_max_speech +
                                                            (1.0-
alpha_speech)*max;


          if (updates_speech <= 60)
                      updates_speech++;


          /*-------------------------------------------------*/
          }


    /*-------------------------------------------------*/


    if (calls < 3)
          calls++;

    pitch_corr[0] = cp;
    pitch_corr[1] = ma_cp;


    /*-------------------------------------------------*/


    return;


    /*-------------------------------------------------*/
    }


/*-------------------------------------------------*/


/*=================================================*/
/*----------------------- END -----------------------*/
/*=================================================*/
```

```
/*==================================================================*/

/*==================================================================*/
/* Conexant System Inc.                          */
/* 4311 Jamboree Road                            */
/* Newport Beach, CA 92660                        */
/*--------------------------------------------------*/
/* Copyright(C) 2000 Conexant System Inc.            */
/*--------------------------------------------------*/
/* ALL RIGHTS RESERVED:                           */
/* No part of this software may be reproduced in any form or by any */
/* means or used to make any derivative work (such as transformation */
/* or adaptation) without the authorisation of Conexant System Inc.  */
/*==================================================================*/
/* PROTOTYPE FILE : lib_smo.h                      */
/*==================================================================*/


/*--------------------------------------------------*/
/*--------------------- FUNCTIONS -------------------*/
/*--------------------------------------------------*/


void SMO_init_lib                 (void);

void SMO_lsf_smooth_est       (INT16, INT16, FLOAT64, FLOAT64 [], FLOAT64 []);

void SMO_initial_analysis(FLOAT64 [], INT16, FLOAT64, FLOAT64, INT16 *,

        FLOAT64 *, INT16);

void SMO_refined_analysis       (FLOAT64 *, INT16, FLOAT64 *, INT16 *, FLOAT64 *,
                                                                INT16);


/*==================================================================*/
/*--------------------- END -------------------------*/
/*==================================================================*/
```

```
/*===================================================================*/


/*===================================================================*/
/* Conexant System Inc.                     */
/* 4311 Jamboree Road                       */
/* Newport Beach, CA 92660                   */
/*------------------------------------------------*/
/* Copyright(C) 2000 Conexant System Inc.            */
/*------------------------------------------------*/
/* ALL RIGHTS RESERVED:                     */
/* No part of this software may be reproduced in any form or by any  */
/* means or used to make any derivative work (such as transformation */
/* or adaptation) without the authorisation of Conexant System Inc.  */
/*===================================================================*/
/* LIBRARY: lib_snr.c                       */
/*===================================================================*/


/*------------------------------------------------*/
/*---------------------- INCLUDE ------------------------*/
/*------------------------------------------------*/


#include "typedef.h"


#include "main.h"
#include "const.h"
#include "gputil.h"


#include "ext_var.h"


#include "lib_snr.h"


#ifdef DIAGNOSTICS


#include "lib_dia.h"

#endif



/*------------------------------------------------*/
```

```
/*---------------------- FUNCTIONS ----------------------*/
/*------------------------------------------------------*/


/*====================================================================*/
/* FUNCTION     : SNR_Calc_NSR_dec ().                    */
/*----------------------------------------------------*/
/* PURPOSE      : This function performs the initialisation of   */
/*             the global variables of the SNR library        */
/*----------------------------------------------------*/
/* INPUT ARGUMENTS :                          */
/*             _ None.                         */
/*----------------------------------------------------*/
/* OUTPUT ARGUMENTS :                          */
/*             _ None.                         */
/*----------------------------------------------------*/
/* INPUT/OUTPUT ARGUMENTS :                       */
/*             _ None.                         */
/*----------------------------------------------------*/
/* RETURN ARGUMENTS :                          */
/*             _ None.                         */
/*====================================================================*/

void SNR_init_lib (void)
    {
        /*--------------------------------------------------*/

        NoiseGainFactor = 1.0;

        /*--------------------------------------------------*/
        /*              SNR_Calc_NSR_enc              */
        /*--------------------------------------------------*/

        NoisEng_enc = -1.0;
        snr_frm_count = 0;
        snr_count_vad = 0;
        eng_m_enc = 0.0;

        diff_lsf_m_enc = 0.0;
        diff_eng_m_enc = 0.0;
        n_nois_ext_enc = 0;
```

```
        /*---------------------------------------------------*/

        return;

        /*---------------------------------------------------*/
        }

    /*---------------------------------------------------*/

    /*===================================================*/
    /* FUNCTION     : SNR_Calc_NSR_enc ().                */
    /*---------------------------------------------------*/
    /* PURPOSE      : This function performs the SNR estimation at  */
    /*                the encoder                          */
    /*---------------------------------------------------*/
    /* INPUT ARGUMENTS :                                  */
    /*          _ (FLOAT64 []) syn:     synthetized signal.      */
    /*          _ (FLOAT64 []) lsfq:    quntised LSF vector      */
    /*          _ (INT16   ) Vad:      vad information.          */
    /*          _ (INT16   ) fame_class: input frame fame_class. */
    /*          _ (INT16   ) l_frm:     frame size.              */
    /*---------------------------------------------------*/
    /* OUTPUT ARGUMENTS :                                 */
    /*          _ (FLOAT64 *) NSR:     estimated NSR at the encoder */
    /*---------------------------------------------------*/
    /* INPUT/OUTPUT ARGUMENTS :                           */
    /*              _ None.                                */
    /*---------------------------------------------------*/
    /* RETURN ARGUMENTS :                                 */
    /*              _ None.                                */
    /*===================================================*/

    void    SNR_Calc_NSR_enc (FLOAT64 syn[], FLOAT64 lsfq[], INT16 Vad,
                              INT16 frame_class, FLOAT64 *NSR, INT16 l_frm)

            {
            /*---------------------------------------------------*/

            FLOAT64 snr, eng, diff_lsf, diff_eng, val1, val2;
            INT16 i, vad_nsr;
```

```
/*--------------------------------------------------*/

if (frame_class < 3)
        n_nois_ext_enc++;
else
        n_nois_ext_enc=0;
if (Vad == 0)
        snr_count_vad++;
else
        snr_count_vad=0;


dot_dvector (syn, syn, &eng, 0, l_frm-1);


/*--------------------------------------------------*/


if (snr_frm_count==0)
        {
        (*NSR) = 0.0;
        vad_nsr = 1;
        eng_m_enc = eng;
        }
else
        {
        /*--------------------------------------------------*/

        diff_lsf=0;
        for (i = 0; i < NP; i++)
        diff_lsf += fabs(lsfq[i]-lsfq_mem_enc[i]);

        diff_lsf *= 100;
        diff_lsf_m_enc = diff_lsf_m_enc*0.75 + diff_lsf*0.25;


        /*--------------------------------------------------*/


        diff_eng = fabs(eng-eng_old_enc)/MAX(eng+eng_old_enc, 50*l_frm);
        diff_eng_m_enc = diff_eng_m_enc*0.75 + diff_eng*0.25;


        /*--------------------------------------------------*/
```

```
snr = eng/MAX(eng_m_enc, 0.1);


if (Vad == 0)
        {
        if (eng_m_enc < 0.1)
                eng_m_enc = eng;
        else
                eng_m_enc = 0.75*eng_m_enc + 0.25*eng;     .
        }


/*------------------------------------------------------------------*/


vad_nsr = 1;


if ((snr_count_vad > 15) && (snr_count_vad < 30) &&
                (diff_lsf_m_enc < 10) && (diff_lsf < 10) &&
                        (diff_eng_m_enc < 0.25) && (diff_eng < 0.25) &&
                        (snr < 10))
                                vad_nsr=0;
else
        {
        if (((snr_count_vad > 15) || (snr_frm_count < 100)) &&
                        (n_nois_ext_enc>10) && (diff_lsf_m_enc<7) &&
                        (diff_lsf<7) && (diff_eng_m_enc<0.2) &&
                                (diff_eng<0.2) && (snr<8))
                                        vad_nsr=0;
        }


/*------------------------------------------------------------------*/


if ((NoisEng_enc < 0.0) && (snr_frm_count > 500))
        vad_nsr = Vad;


/*------------------------------------------------------------------*/


if (vad_nsr == 0)
        {
        if (NoisEng_enc < 0.0)
                NoisEng_enc = eng;
        else
```

```
                NoisEng_enc = NoisEng_enc*0.85 + eng*0.15;


            NoisEng_enc = MIN(NoisEng_enc, eng);
        }


    /*--------------------------------------------*/


    val1 = MAX(NoisEng_enc - 100*l_frm, 0);   .
    val2 = MAX(eng, 0.1);
    (*NSR) = MIN(sqrt(val1 / val2), 1.0);


    /*--------------------------------------------*/
    }


/*--------------------------------------------*/


snr_frm_count = MIN(snr_frm_count+1, 1000);


for (i = 0; i < NP; i++)
        lsfq_mem_enc[i] = lsfq[i];


eng_old_enc = eng;


/*--------------------------------------------*/


return;


/*--------------------------------------------*/
}


/*--------------------------------------------*/


/*==========================================*/
/*-------------------- END --------------------*/
/*==========================================*/
```

```
/*=================================================================*/

/*===========================================================*/
/* Conexant System Inc.                         */
/* 4311 Jamboree Road                           */
/* Newport Beach, CA 92660                       */
/*-----------------------------------------*/
/* Copyright(C) 2000 Conexant System Inc.            */
/*-----------------------------------------*/
/* ALL RIGHTS RESERVED:                          */
/* No part of this software may be reproduced in any form or by any  */
/* means or used to make any derivative work (such as transformation */
/* or adaptation) without the authorisation of Conexant System Inc.  */
/*==============================================================*/
/* PROTOTYPE FILE : lib_snr.h                     */
/*===============================================================*/


/*-------------------------------------------*/
/*----------------- FUNCTIONS ----------------*/
/*-------------------------------------------*/


void SNR_init_lib (void);


void SNR_Calc_NSR_enc (FLOAT64 [], FLOAT64 [], INT16, INT16, FLOAT64 *, INT16);


/*=================================================================*/
/*----------------------- END -----------------------*/
/*=================================================================*/
```

```
/*=====================================================================*/

/*=====================================================================*/
/* Conexant System Inc.                          */
/* 4311 Jamboree Road                            */
/* Newport Beach, CA 92660                        */
/*_____*/
/* Copyright(C) 2000 Conexant System Inc.            */
/*_____*/
/* ALL RIGHTS RESERVED:                          */
/* No part of this software may be reproduced in any form or by any  */
/* means or used to make any derivative work (such as transformation */
/* or adaptation) without the authorisation of Conexant System Inc.  */
/*=====================================================================*/
/* LIBRARY: lib_swb.c                            */
/*=====================================================================*/


/*_____*/
/*------------------------ INCLUDE -------------------------*/
/*_____*/


#include "typedef.h"

#include "main.h"

#include "lib_swb.h"


/*_____*/
/*------------------------ FUNCTIONS -------------------------*/
/*_____*/


/*=====================================================================*/
/* FUNCTION  : byte_swap_int16 ().                  */
/*_____*/
/* PURPOSE   : Byte swap a 16 bit integer number.        */
/*_____*/
/* INPUT ARGUMENTS :                            */
/*       _ (INT16  ) input:   data to be swapped.        */
/*_____*/
/* OUTPUT ARGUMENTS :                           */
```

```
/*            _ None                    */
/*----------------------------------------*/
/* INPUT/OUTPUT ARGUMENTS :                    */
/*            _ None                    */
/*----------------------------------------*/
/* RETURN ARGUMENTS :                    */
/*         _ (INT16   ) output:   data to be swapped.       */
/*========================================*/


INT16    byte_swap_int16 (INT16 input)
         {
         /*----------------------------------------*/


         INT16 output;


         /*----------------------------------------*/


         output = (input >> 8 & 0x00ff)^(input << 8);


         /*----------------------------------------*/


         return output;


         /*----------------------------------------*/
         }


/*----------------------------------------*/


/*========================================*/
/* FUNCTION  : byte_swap_int32 ().                    */
/*----------------------------------------*/
/* PURPOSE   : Byte swap a 32 bit integer point number.       */
/*         Verified for swapping between SGI Unix and PC Linux.  */
/*----------------------------------------*/
/* INPUT ARGUMENTS :                    */
/*         _ (INT32   ) input:   data to be swapped.       */
/*----------------------------------------*/
/* OUTPUT ARGUMENTS :                    */
/*            _ None                    */
/*----------------------------------------*/
```

```
/* INPUT/OUTPUT ARGUMENTS :                              */
/*              _ None                          */
/*----------------------------------------------------*/
/* RETURN ARGUMENTS :                            */
/*         _ (INT32  ) output:  swapped data.          */
/*====================================================*/


INT32   byte_swap_int32 (INT32 input)
        {
          /*--------------------------------------------*/


          INT16 i;
          INT32 output;


          /*--------------------------------------------*/


          for (i = 0; i < 4; i++)
                  *((char *)(&output) + i) = *((char *)(&input) + 3 - i);


          /*--------------------------------------------*/


          return output;


          /*--------------------------------------------*/
        }


/*----------------------------------------------------*/



/*====================================================*/
/* FUNCTION : byte_swap_int64 ().                  */
/*----------------------------------------------------*/
/* PURPOSE  : Byte swap a 64 bit integer point number.     */
/*          Verified for swapping between SGI Unix and PC Linux. */
/*----------------------------------------------------*/
/* INPUT ARGUMENTS :                            */
/*         _ (INT64  ) input:   data to be swapped.        */
/*----------------------------------------------------*/
/* OUTPUT ARGUMENTS :                            */
/*              _ None                          */
/*----------------------------------------------------*/
```

```c
/* INPUT/OUTPUT ARGUMENTS :                        */
/*            _ None                        */
/*---------------------------------------------------*/
/* RETURN ARGUMENTS :                       */
/*         _ (INT64   ) output:  swapped data.        */
/*===================================================*/


INT64   byte_swap_int64 (INT64 input)
        {
        /*-------------------------------------------*/


        INT16 i;
        INT64 output;


        /*-------------------------------------------*/


        for (i = 0; i < 8; i++)
                *((char *)(&output) + i) = *((char *)(&input) + 3 - i);


        /*-------------------------------------------*/


        return output;


        /*-------------------------------------------*/
        }


/*---------------------------------------------------*/


/*===================================================*/
/* FUNCTION  : byte_swap_float32 ().              */
/*---------------------------------------------------*/
/* PURPOSE   : Byte swap a 32 bit floating point number.      */
/*         Verified for swapping between SGI Unix and PC Linux. */
/*---------------------------------------------------*/
/* INPUT ARGUMENTS :                        */
/*         _ (FLOAT32  *) input:   data to be swapped.      */
/*---------------------------------------------------*/
/* OUTPUT ARGUMENTS :                       */
/*         _ (FLOAT32  *) output:   swapped data.        */
/*---------------------------------------------------*/
```

```
/* INPUT/OUTPUT ARGUMENTS :                          */
/*             _ None                     */
/*-----------------------------------------------*/
/* RETURN ARGUMENTS :                         */
/*             _ None.                    */
/*===============================================*/


void byte_swap_float32 (FLOAT32 *input, FLOAT32 *output)
        {
        /*-----------------------------------------*/


        INT16 i;


        /*-----------------------------------------*/


        for (i = 0; i < 4; i++)
                *((char *)(output) + i) = *((char *)(input) + 3 - i);


        /*-----------------------------------------*/


        return;


        /*-----------------------------------------*/
        }


/*-----------------------------------------------*/


/*===============================================*/
/* FUNCTION  : byte_swap_float64 ().                */
/*-----------------------------------------------*/
/* PURPOSE   : Byte swap a 64 bit floating point number.    */
/*          Verified for swapping between SGI Unix and PC Linux. */
/*-----------------------------------------------*/
/* INPUT ARGUMENTS :                          */
/*          _ (FLOAT64  ) input:   data to be swapped.      */
/*-----------------------------------------------*/
/* OUTPUT ARGUMENTS :                         */
/*          _ (FLOAT64  ) output:   swapped data.        */
/*-----------------------------------------------*/
/* INPUT/OUTPUT ARGUMENTS :                       */
```

```
/*              _ None                    */
/*------------------------------------------*/
/* RETURN ARGUMENTS :                  */
/*              _ None.                   */
/*==========================================*/


void    byte_swap_float64(FLOAT64 *input, FLOAT64 *output)
        {
        /*------------------------------------------*/

        INT16 i;

        /*------------------------------------------*/

        for (i = 0; i < 8; i++)
                *((char *)(output) + i) = *((char *)(input) + 7 - i);

        /*------------------------------------------*/

        return;

        /*------------------------------------------*/
        }

/*------------------------------------------*/

/*==========================================*/
/*--------------- END ---------------*/
/*==========================================*/
```

```
/*=====================================================================*/


/*=================================================================*/
/* Conexant System Inc.                    */
/* 4311 Jamboree Road                    */
/* Newport Beach, CA 92660                  */
/*----------------------------------------------*/
/* Copyright(C) 2000 Conexant System Inc.          */
/*----------------------------------------------*/
/* ALL RIGHTS RESERVED:                  */
/* No part of this software may be reproduced in any form or by any */
/* means or used to make any derivative work (such as transformation */
/* or adaptation) without the authorisation of Conexant System Inc.  */
/*================================================================*/
/* PROTOYPE FILE: lib_swb.h                 */
/*================================================================*/


/*----------------------------------------------*/
/*--------------------- FUNCTIONS ----------------------*/
/*----------------------------------------------*/


INT16   byte_swap_int16(INT16);
INT32   byte_swap_int32(INT32);
INT64   byte_swap_int64(INT64);


void    byte_swap_float32(FLOAT32 *, FLOAT32 *);
void    byte_swap_float64(FLOAT64 *, FLOAT64 *);


/*===================================================================*/
/*-------------------------- END ------------------------*/
/*===================================================================*/
```

```c
/*==============================================================*/


/*==============================================================*/
/* Conexant System Inc.                          */
/* 4311 Jamboree Road                            */
/* Newport Beach, CA 92660                        */
/*----------------------------------------------*/
/* Copyright(C) 2000 Conexant System Inc.              */
/*----------------------------------------------*/
/* ALL RIGHTS RESERVED:                          */
/* No part of this software may be reproduced in any form or by any */
/* means or used to make any derivative work (such as transformation */
/* or adaptation) without the authorisation of Conexant System Inc.  */
/*==============================================================*/
/* LIBRARY: lib_vad.c                          */
/*==============================================================*/


/*----------------------------------------------*/
/*------------------------ INCLUDE ----------------------*/
/*----------------------------------------------*/


#include "typedef.h"

#include "main.h"
#include "const.h"
#include "gputil.h"
#include "mcutil.h"
#include "ext_var.h"

#include "lib_lpc.h"
#include "lib_vad.h"


/*----------------------------------------------*/
/*------------------------ FUNCTIONS ----------------------*/
/*----------------------------------------------*/


/*==============================================================*/
/* FUNCTION     : VAD_init_lib ().                   */
/*----------------------------------------------*/
```

```
/* PURPOSE     : This function performs initialisation of the    */
/*             global variables of the VAD library.          */
/*---------------------------------------------------------------*/
/* INPUT ARGUMENTS :                                    */
/*             _ None.                          */
/*---------------------------------------------------------------*/
/* OUTPUT ARGUMENTS :                                  */
/*             _ None.                          */
/*---------------------------------------------------------------*/
/* INPUT/OUTPUT ARGUMENTS :                               */
/*             _ None.                          */
/*---------------------------------------------------------------*/
/* RETURN ARGUMENTS :                                  */
/*             _ None.                          */
/*===============================================================*/


void VAD_init_lib (void)
        {
        /*-----------------------------------------------------*/


        INT16  i, j;


        /*-----------------------------------------------------*/


        ini_svector (lag_buf,      0, LTP_BUFF_SIZE-1, 20);
        ini_dvector (pgain_buf, 0, LTP_BUFF_SIZE-1, 0.7);


        /*-----------------------------------------------------*/


        Vad          = 1;


        ini_svector (flag_vad_mem, 0, 1, 1);


        /*-----------------------------------------------------*/


        flag = 1;


        count_sil = 0;
        count_ext = 0;
        dec3_flg_mem = 0;
```

```
        pitch_gain_mean = 0.5;

        for (i = 0; i < VAD_MEM_SIZE; i++)
                for (j = 1; j < NP; j++)
                        vad_lsf_mem [i][j] = vad_lsf_mem [i][j-1] + 0.05;

        min_energy = MAX_ENERGY;
        mean_energy = 0.0;

        mean_max = 0;
        mean_s_energy = 0.0;

        ini_dvector(prev_cml_lsf_diff, 0, VAD_MEM_SIZE-1, 0.0);
        ini_dvector(prev_energy,         0, VAD_MEM_SIZE-1, 0.0);

        snr = 0.0;
        onset_flg = 0;
        count_onset = 0;
        count_noise = 0;

        /*----------------------------------------------------------*/

        return;

        /*----------------------------------------------------------*/
        }


/*==========================================================================*/
/* FUNCTION      : VAD_voice_detection ().                    */
/*----------------------------------------------------------*/
/* PURPOSE       : This function performs Voice Activity Detection. */
/*----------------------------------------------------------*/
/* INPUT ARGUMENTS :                                   */
/*       _ (FLOAT64 []) x :      input frame.                */
/*       _ (FLOAT64 []) rc:      reflection coefficients.       */
/*       _ (FLOAT64   ) pderr:   energy of residual.           */
/*       _ (INT16   []) lag_mem: history of pitch lag.          */
```

```
/*      _ (FLOAT64 []) pitch_gain_mem: history of pitch gain.   */
/*      _ (FLOAT64 []) lsf:    lsf vector.                */
/*      _ (FLOAT64 []) rxx:    autocorrelation coefficients.   */
/*      _ (INT64    ) frm_count: frame counter.            */
/*      _ (INT16    ) flag_vad_mem_1: past vad decision (n-1). */
/*      _ (INT16    ) flag_vad_mem_2: past vad decision (n-2). */
/*------------------------------------------------------------*/
/* OUTPUT ARGUMENTS :                              */
/*      _ (INT16   *) flag_vad: vad decision.            */
/*------------------------------------------------------------*/
/* INPUT/OUTPUT ARGUMENTS :                           */
/*           _ None.                          */
/*------------------------------------------------------------*/
/* RETURN ARGUMENTS :                             */
/*           _ None.                          */
/*============================================================*/


void VAD_voice_detection(FLOAT64 x [], FLOAT64 rc [], FLOAT64 pderr,
                INT16 lag_mem [], FLOAT64 pitch_gain_mem [],
                FLOAT64 lsf [], FLOAT64 rxx [], INT64 frm_count,
                INT16 *flag_vad, INT16 flag_vad_mem [])


        {
        /*------------------------------------------------------------*/

        FLOAT64 pitch_gain_avg;

        INT16 decision;
        INT16 i;
        INT16 pflag, pflag1, pflag2;
        INT16 dec3_flg;

        FLOAT64 lags_std;
        FLOAT64 max_frame, val;
        FLOAT64 w1, w2;
        FLOAT64 norm_energy;
        FLOAT64 nnorm_energy;
        FLOAT64 *sum2_p, *sum2_a, *temp;
        FLOAT64 norm_cml_lsf_diff;
        FLOAT64 spd;
```

```
FLOAT64 vad_partial_lpc_gain, vad_lpc_gain;
FLOAT64 nthrs;
FLOAT64 cml_lsf_diff = 0.0;
FLOAT64 *sum1_lsf, *sum2_lsf;


/*----------------------------------------------------*/
/*                Memory allocation              */
/*----------------------------------------------------*/


sum1_lsf = dvector (0, NP-1);
sum2_lsf = dvector (0, NP-1);


/*----------------------------------------------------*/


decision = NOISE;
    dec3_flg = 0;


max_frame = -(FLOAT64)INT_MAX;


for (i = 0; i < L_FRM; i++)
        {
        val = fabs(x [i]);

        if (val > max_frame)
                max_frame = val;
        }


/*----------------------------------------------------*/
/*        Calculate the oder VAD_NP prediction error        */
/*----------------------------------------------------*/


vad_partial_lpc_gain = 1.0;
for(i = 0; i < VAD_LPC_ORDER; i++)
        vad_partial_lpc_gain *= (1.0 - rc[i]*rc[i]);


vad_lpc_gain = vad_partial_lpc_gain;
for (i=VAD_LPC_ORDER; i<NP; i++)
    vad_lpc_gain *= (1.0-sqr(rc[i]));
```

```
vad_lpc_gain = -10.0*log10(vad_lpc_gain+EPSI);


/*-------------------------------------------------------*/
/*        Calculate the average prediction gain and the lag      */
/*                      standard deviation                       */
/*-------------------------------------------------------*/


VAD_mean_std_calc (lag_mem, pitch_gain_mem, &lags_std, &pitch_gain_avg);


pitch_gain_mean = 0.8*pitch_gain_mean + 0.2*pitch_gain_avg;


/*-------------------------------------------------------*/
/*              Set-up the classification flags              */
/*-------------------------------------------------------*/


if ( pitch_gain_mean > 0.7)
        pflag2 = 1;
else
        pflag2 = 0;


if ( (lags_std < 1.30) && (pitch_gain_mean > 0.45) )
        pflag1 = 1;
else
        pflag1 = 0;



pflag = (flag_vad_mem [0] || pflag2) && pflag1;


/*-------------------------------------------------------*/
/*              Calculate the signals energies              */
/*-------------------------------------------------------*/


val = rxx[0] / (FLOAT64)L_LPC;


norm_energy = 10.0 * log10 (vad_partial_lpc_gain * val + EPSI);
norm_energy = MAX (0.0, norm_energy);


nnorm_energy = 10.0 * log10 (val + EPSI);
nnorm_energy = MAX (10.0, nnorm_energy);
```

```
/*--------------------------------------------------------*/
/*        Calculate the weighted sum of lsf coefficeints    */
/*--------------------------------------------------------*/


add_dvector (lsf,         &vad_lsf_mem[0][0], sum1_lsf, 0, NP-1);
add_dvector (sum1_lsf,    &vad_lsf_mem[1][0], sum1_lsf, 0, NP-1);


wad_dvector (sum1_lsf,   0.25, &vad_lsf_mem[2][0], 0.25, sum1_lsf,

0, NP-1);


add_dvector (&vad_lsf_mem[0][0], &vad_lsf_mem[1][0], sum2_lsf,

0, NP-1);


wad_dvector (sum2_lsf,   0.3333, &vad_lsf_mem[2][0], 0.3333, sum2_lsf,

0, NP-1);


/*--------------------------------------------------------*/
/*              min_energyimum energies tracking          */
/*--------------------------------------------------------*/


if (frm_count < 65)
        {
        if ( norm_energy < min_energy )
                {
                min_energy      = norm_energy;
                prev_min_energy = norm_energy;
                }
        if ((frm_count % VAD_MIN_MEM_SIZE) == 0)
                {
                i = frm_count / VAD_MIN_MEM_SIZE - 1;

                min_energy_mem [i] = min_energy;

                min_energy             = MAX_ENERGY;
                }
        }
```

```
if ((frm_count % VAD_MIN_MEM_SIZE) == 0)
        {
        prev_min_energy = min_energy_mem[0];
        for (i = 1; i < VAD_MIN_MEM_SIZE; i++)
                {
                if (min_energy_mem[i] < prev_min_energy )
                        prev_min_energy = min_energy_mem[i];
                }
        }


if( frm_count >= 65 )
        {
        if( (frm_count % VAD_MIN_MEM_SIZE ) == 1)
                {
                min_energy = prev_min_energy;
                next_min_energy = MAX_ENERGY;
                }

        if( norm_energy < min_energy )
                min_energy = norm_energy;

        if( norm_energy < next_min_energy )
                next_min_energy = norm_energy;

        if( (frm_count % VAD_MIN_MEM_SIZE) == 0)
                {
                for (i = 0; i < VAD_MIN_MEM_SIZE-1; i++)
                        min_energy_mem[i] = min_energy_mem[i+1];

                min_energy_mem[VAD_MIN_MEM_SIZE-1]  = next_min_energy;

                prev_min_energy = min_energy_mem[0];

                for (i = 1; i < VAD_MIN_MEM_SIZE; i++)
                        {
                        if (min_energy_mem[i] <  prev_min_energy )
                                prev_min_energy = min_energy_mem[i];
                        }
                }
```

```
                    }


/*------------------------------------------------------------*/
/*        First INIT_FRAME frames parameters calculation      */
/*------------------------------------------------------------*/


if (frm_count <= INIT_FRAME)
        {
        if (pflag ==0 &&
      ( (((max_frame/mean_max < 12.0) && (nnorm_energy <= 30.0) &&
        (nnorm_energy-norm_energy < 9.0) &&
        ( (rc[0] < -0.55 && vad_lpc_gain < 5.0) ||
        (vad_lpc_gain) < 2.75)) || (nnorm_energy <= 10.0) ||
        ( (nnorm_energy <= 25.0) && ( (rc[0] < -0.55 &&
        vad_lpc_gain < 5.0)|| (vad_lpc_gain) < 2.75)&&
        (max_frame/mean_max < 12.0)) ) )


                    decision = NOISE;
            else
                    decision = VOICE;


            mean_energy = (mean_energy*( (FLOAT64)(frm_count-1)) +
                                        norm_energy) / (FLOAT64) (frm_count);


            mean_max = (mean_max*( (FLOAT64)(frm_count-1)) +
                                        max_frame)/(FLOAT64) (frm_count);


            w1 = (FLOAT64) (frm_count -1);
            w2 = 1.0;


            wad_dvector (mean_lsf, w1, lsf, w2, mean_lsf, 0, NP-1);


            w1 = 1.0 / (FLOAT64)frm_count;
            sca_dvector (mean_lsf, w1, mean_lsf, 0, NP-1);


            cpy_dvector (mean_lsf, norm_mean_lsf, 0, NP-1);
            }



/*------------------------------------------------------------*/
```

```
/*        First INIT_FRAME frames final VAD flag set-up        */
/*------------------------------------------------------------*/


(*flag_vad) = decision;


/*------------------------------------------------------------*/
/*                Parameters calculation                */
/*------------------------------------------------------------*/


if (frm_count >= INIT_FRAME )
        {
        if (frm_count == INIT_FRAME)
                mean_s_energy = MAX(mean_energy - 12.0,0.0);


        /*--------------------------------------------------*/
        /*        Spectral Distortion Calculation        */
        /*--------------------------------------------------*/


        sum2_p = dvector(0, NP-1);
        sum2_a = dvector(0, NP);
        temp   = dvector(0, NP-1);


        /*--------------------------------------------------*/


        LPC_lsftop (sum2_lsf, sum2_p, NP);
        LPC_ptoa   (sum2_p, sum2_a,  NP);


        /*--------------------------------------------------*/


        VAD_itakura_saito (rxx, sum2_a, &spd, NP);



        spd /= (EPSI + pderr);


        /*--------------------------------------------------*/


        dif_dvector (lsf,  norm_mean_lsf, temp, 0, NP-1);
dot_dvector (temp, temp, &norm_cml_lsf_diff, 0, NP-1);


        dif_dvector (sum1_lsf, mean_lsf, temp, 0, NP-1);
```

```
dot_dvector (temp, temp, &cml_lsf_diff, 0, NP-1);


                        /*--------------------------------------------------*/


        free_dvector(sum2_p, 0, NP-1);
        free_dvector(sum2_a,     0, NP);
        free_dvector(temp,                  0, NP-1);


                        /*--------------------------------------------------*/


        if((frm_count == INIT_FRAME) || ((prev_cml_lsf_diff[0] < 0.5e-4)
                                                                        &&
(cml_lsf_diff > 0.1e-3)))
                                cml_lsf_diff_filt = cml_lsf_diff;
        else
                        cml_lsf_diff_filt = 0.4*cml_lsf_diff +

0.6*cml_lsf_diff_filt;


                        /*--------------------------------------------------*/


        dec3_flg = 0;


                        /*--------------------------------------------------*/


        if (snr <= 5.0)
                nthrs = 3.0;
        else if (snr <= 10.0)
                nthrs = 4.7;
        else
                nthrs = 5.5;


                        /*--------------------------------------------------*/


        if (pflag == 1 && nnorm_energy > 10.0)
                decision = VOICE;
        else if (( norm_energy >= mean_s_energy + 6.5) ||
        (cml_lsf_diff > 1000.0e-6))
            {
                decision = VOICE;
```

```
                count_ext = 0;
            }
else if( (norm_energy - mean_s_energy) < nthrs)
            decision = NOISE;
else
            {
            decision        = VOICE;
            dec3_flg         = 1;
            count_ext        = 0;
            }


/*-------------------------------------------------------*/


if ( snr <= 5.0)
            onset_trhsd = 6.0;
else if ( snr <= 10.0)
            onset_trhsd = 8.0;
else
            onset_trhsd = 10.0;


/*-------------------------------------------------------*/

if ((nnorm_energy > 0.5*(prev_energy[1] + prev_energy[0])+
    onset_trhsd) || ((nnorm_energy > 35.0) &&
    ( (spd > 2.5) || (norm_cml_lsf_diff > 0.008) ||
    (norm_energy-mean_s_energy>10.0)))) {
    onset_flg =1;
    flag =1;
}
else {
  if (nnorm_energy <= 10.0) {
    onset_flg =0;
  }
}

if (onset_flg ){
  count_onset++;
}
if ( count_onset == 4){
  onset_flg = 0;
```

```
count_onset = 0;
count_ext = 4;
}


        /*------------------------------------------------------*/


if (onset_flg == 0 && pflag ==0 &&
    ((( (max_frame/mean_max < 12.0) && (nnorm_energy <= 30.0)
    && (nnorm_energy-norm_energy < 9.0) &&
    ( (rc[0] < -0.55 && vad_lpc_gain < 5.0)||
    (vad_lpc_gain) < 2.75)) || (nnorm_energy <= 10.0)
    || ( (nnorm_energy <= 25.0) && ( (rc[0] < -0.55 &&
    vad_lpc_gain < 5.0)|| (vad_lpc_gain) < 2.75) &&
    (max_frame/mean_max < 12.0)) ) )
                            {
                            decision = NOISE;
                            flag =0;

                }
    else
        {
                if ( (prev_energy[0] - nnorm_energy > 10.0) &&
        (nnorm_energy < 20.0) && (max_frame/mean_max < 12.0))
                            {
                            decision = NOISE;
                            flag =0;
                            }
                    else
                    {
        if (frm_count <= 65)
        decision = VOICE;
                        }
                        }


if ( pflag ==0 && count_noise > 8 && (nnorm_energy < 30.0) &&
    (max_frame/mean_max < 15.0) &&
    ( norm_energy - mean_s_energy < 6.5))
                    {
                    decision = NOISE;
                    flag =0;
                    }
```

```
else
        {
                if (pflag ==0 && count_noise > 4 && cml_lsf_diff < 900.0e-6
        && (norm_cml_lsf_diff < 3500.0e-6) && (onset_flg == 0)
        && (max_frame/mean_max < 15.0) &&
        ( norm_energy - mean_s_energy < 6.0))
          {
            decision = NOISE;
            flag =0;
          }
                else if ((nnorm_energy> 25.0) && (flag_vad_mcm [1] == VOICE) &&
        (flag_vad_mem [0] == VOICE) && (decision == NOISE) &&
        (norm_cml_lsf_diff > 4000.0e-6) )
            decision = VOICE;
                }


        /*----------------------------------------------*/


if (decision == NOISE)
    count_noise++;
else
    count_noise=0;


        /*----------------------------------------------*/


        if ((norm_cml_lsf_diff > 0.0003) &&
                ( nnorm_energy - prev_energy[2] < -12.0))
                count_ext = 4;


        /*----------------------------------------------*/


        if (flag == 1)
                {
                /*----------------------------------------------*/


        if (((nnorm_energy> 25.0) &&
            (flag_vad_mem [1] == VOICE) &&
            (flag_vad_mem [0] == VOICE) &&
            (decision == NOISE)) || (onset_flg))
```

```
                                        {
                                        count_ext++;
                                        decision = VOICE;


            if(count_ext <= 26-0 && snr <= 0.0)
               flag =1;
            else if(count_ext <= 22-0 && snr <= 5.0)
               flag =1;
            else if(count_ext <= 20-0-0 && snr <= 6.5)
               flag =1;
            else if(count_ext <= 16-0-2 && snr <= 8.0)
               flag =1;
            else if(count_ext <= 14-2-2 && snr <= 11.0)
               flag =1;
            else if(count_ext <= 10-2-2 && snr <= 14.0)
               flag =1;
            else if(count_ext <= 8-2-2 && snr <= 17.0)
               flag =1;
            else if(count_ext <= 3 && snr <= 21.0)
               flag =1;
            else if(count_ext <= 1 && snr > 21.0)
               flag =1;


                                     else
                                        {
                                        flag = 0;
                                        count_ext=0;
                                        }
                                     }
            /*---------------------------------------------*/
                }
        else
            {
            flag = 1;
            count_ext = 0;
            }


    /*------------------------------------------------*/


    if (decision == NOISE)
```

```
                       count_ext=0;


/*------------------------------------------------------*/
/*              Compute mean_energy              */
/*------------------------------------------------------*/


if ( norm_energy > min_energy + 12.0)
        mean_energy = 0.9 * mean_energy + 0.1 * norm_energy;


/*------------------------------------------------------*/
/*                 Compute snr               */
/*------------------------------------------------------*/


snr = mean_energy - mean_s_energy;


/*------------------------------------------------------*/
/*            Compute the new mean_s_energy        */
/*------------------------------------------------------*/


if (((norm_energy < MAX(mean_s_energy,min_energy) + 3.5)
                                              && (!pflag)) || decision
== NOISE)
               {

        mean_max = MAX(EPSI,0.95 * mean_max + (1.0- 0.95)* max_frame);

        count_sil++;

        if (count_sil < INIT_COUNT)
               {
               w1      = 0.75;
               w2 = 0.60;
               }
        else if (count_sil < INIT_COUNT + 10)
               {
               w1      = 0.85;
               w2 = 0.65;
               }
        else if (count_sil < INIT_COUNT + 20)
               {
```

```
                w1      = 0.85;
                w2 = 0.65;
                }
        else
                {
                w1      = 0.65;
                w2 = 0.65;
                }

        wad_dvector (mean_lsf, w2, lsf, (1.0 - w2), mean_lsf,

0, NP-1);
        if (nnorm_energy > 18.0)
                mean_s_energy = w1 * mean_s_energy +
                                        (1.0- w1) * norm_energy;

        mean_s_energy = MAX(mean_s_energy, 0.0);
                }


        /*-----------------------------------------*/


        wad_dvector (norm_mean_lsf, 0.85, lsf, (1.0 - 0.85),

                                        norm_mean_lsf, 0, NP-1);


        /*-----------------------------------------*/
        /*      Current frames final VAD flag set-up      */
        /*-----------------------------------------*/


        (*flag_vad) = decision;          .


        /*-----------------------------------------*/


        if ((frm_count >64) && (mean_s_energy +10.0 < min_energy ) &&

                (!pflag))
                {
        mean_s_energy = MAX(0.5*( min_energy+mean_s_energy),0.0);
        mean_s_energy = 0.75*mean_s_energy +
                                        0.25*min_energy;
        mean_s_energy = MAX(mean_s_energy, 0.0);
```

```
                    count_sil = 0;
                }

        else if ((frm_count >64) && (mean_s_energy > min_energy + 4.0 ))
                {
                mean_s_energy = MAX(min_energy, 0.0);
                count_sil = 0;
                }


        /*--------------------------------------------------*/
        }


    /*--------------------------------------------------*/
    /*      Save parameters for the processing of the next frame      */
    /*--------------------------------------------------*/


    sfr_dvector (prev_energy, prev_energy, 1, 0, VAD_MEM_SIZE-1);
    prev_energy[0] = nnorm_energy;


    sfr_dvector (prev_cml_lsf_diff, prev_cml_lsf_diff, 1, 0, VAD_MEM_SIZE-1);
    prev_cml_lsf_diff[0] = cml_lsf_diff;



    cpy_dvector (vad_lsf_mem[1],    vad_lsf_mem[2], 0, NP-1);
    cpy_dvector (vad_lsf_mem[0],    vad_lsf_mem[1], 0, NP-1);
    cpy_dvector (lsf,                        vad_lsf_mem[0], 0, NP-1);


    dec3_flg_mem = dec3_flg;


    /*--------------------------------------------------*/


    free_dvector (sum1_lsf, 0, NP-1);
    free_dvector (sum2_lsf, 0, NP-1);


    /*--------------------------------------------------*/


    return;


    /*--------------------------------------------------*/
    }
```

EP 1 214 706 B1

```
/*--------------------------------------------------------*/


/*========================================================*/
/* FUNCTION    :  VAD_itakura_saito. ().                  */
/*--------------------------------------------------------*/
/* PURPOSE     :  This function calculate the Itakura Saito   */
/*              distance.                                 */
/*--------------------------------------------------------*/
/* INPUT ARGUMENTS :                                      */
/*   _ (FLOAT64 []) r  : input  signal autocorrelation.   */
/*   _ (FLOAT64 []) a  : LPC filter coefficients.         */
/*   _ (INT16   ) P  : filter order.                      */
/*--------------------------------------------------------*/
/* OUTPUT ARGUMENTS :                                     */
/*   _ (FLOAT64 *) isd : output Itakura Saito distance.   */
/*--------------------------------------------------------*/
/* INPUT/OUTPUT ARGUMENTS :                               */
/*              _ None.                                   */
/*--------------------------------------------------------*/
/* RETURN ARGUMENTS : _ None.                             */
/*========================================================*/


void    VAD_itakura_saito (FLOAT64 r [], FLOAT64 a [], FLOAT64 *isd, INT16 P)
        {
        /*--------------------------------------------------------*/

        INT16  k, m;
        FLOAT64        sum;
        FLOAT64        r_a[20];


        /*--------------------------------------------------------*/


        for (k = 0; k <= P; k++)
            {

            sum = 0.0;
            for(m = 0; m <= P-k; m++)
                    sum = sum + a[m]*a[m+k];
            r_a[k] = sum;
            }
```

774

```
/*----------------------------------------------------*/


sum = 0.0;
for (m = 1; m <= P; m++)
        sum = sum + r[m]*r_a[m];


/*----------------------------------------------------*/


(*isd) = (r[0]*r_a[0] + 2*sum);


/*----------------------------------------------------*/


return;


/*----------------------------------------------------*/
}


/*----------------------------------------------------*/



/*====================================================*/
/* FUNCTION     : VAD_mean_std_calc ().               */
/*----------------------------------------------------*/
/* PURPOSE      : This function calculate average prediction  */
/*               gain and the lag standard deviation  */
/*----------------------------------------------------*/
/* INPUT ARGUMENTS :                                  */
/*        _ (INT16   []) lags_mem:     history of pitch lag.  */
/*        _ (FLOAT64 []) pitch_gain_mem: history of pitch gain.  */
/*----------------------------------------------------*/
/* OUTPUT ARGUMENTS :                                 */
/*        _ (FLOAT64 *) l_std:     lag standard deviation.  */
/*        _ (FLOAT64 *) pg_mean:     average prediction gain.  */
/*----------------------------------------------------*/
/* INPUT/OUTPUT ARGUMENTS :                           */
/*            _ None.                                 */
/*----------------------------------------------------*/
/* RETURN ARGUMENTS :                                 */
/*            _ None.                                 */
```

```
/*==================================================================*/


void     VAD_mean_std_calc      (INT16 lags_mem [], FLOAT64 pitch_gain_mem [],
                                                                 FLOAT64 *l_std,
FLOAT64 *pg_mean)
          {
          /*--------------------------------------------------------*/


          INT16  i;
          FLOAT64 val, sum1, sum2;


          /*--------------------------------------------------------*/


          sum1 = 0.0;
          sum2 = 0.0;
          for(i = 0; i < LTP_BUFF_SIZE; i++)
                  {
                  sum1 += (FLOAT64) lags_mem [i];
                  sum2 +=  pitch_gain_mem [i];
                  }


          /*--------------------------------------------------------*/


          sum1 = sum1 / (FLOAT64)LTP_BUFF_SIZE;


          /*--------------------------------------------------------*/


          (*pg_mean) = sum2 / (FLOAT64)LTP_BUFF_SIZE;


          /*--------------------------------------------------------*/


          (*l_std) = 0.0;


          for(i = 0; i < LTP_BUFF_SIZE; i++)
                  {
                  val             = (FLOAT64) lags_mem [i] - sum1;
                  (*l_std) += val*val;
                  }
          (*l_std) = sqrt ((*l_std) / (FLOAT64)(LTP_BUFF_SIZE - 1));
```

```
        /*----------------------------------------------------*/

    return;

        /*----------------------------------------------------*/
    }

/*----------------------------------------------------*/

/*================================================================*/
/*----------------------- END ----------------------------*/
/*================================================================*/
```

```
/*====================================================================*/


/*====================================================================*/
/* Conexant System Inc.                             */
/* 4311 Jamboree Road                               */
/* Newport Beach, CA 92660                           */
/*------------------------------------------------*/
/* Copyright(C) 2000 Conexant System Inc.              */
/*------------------------------------------------*/
/* ALL RIGHTS RESERVED:                            */
/* No part of this software may be reproduced in any form or by any  */
/* means or used to make any derivative work (such as transformation */
/* or adaptation) without the authorisation of Conexant System Inc.  */
/*====================================================================*/
/* PROTOTYPE FILE : lib_vad.h                       */
/*====================================================================*/


/*------------------------------------------------*/
/*------------------- FUNCTIONS -------------------*/
/*------------------------------------------------*/


void VAD_init_lib (void);


void VAD_voice_detection (FLOAT64 [], FLOAT64 [], FLOAT64, INT16 [], FLOAT64 *,
          FLOAT64 [], FLOAT64 [], INT64, INT16 [], INT16 []);


void VAD_itakura_saito   (FLOAT64 [], FLOAT64 [], FLOAT64 *, INT16);



void VAD_mean_std_calc(INT16 [], FLOAT64 [],   FLOAT64 *, FLOAT64 *);


/*====================================================================*/
/*------------------- END -------------------*/
/*====================================================================*/
```

```
/*======================================================================*/


/*==================================================================*/
/* Conexant System Inc.                            */
/* 4311 Jamboree Road                              */
/* Newport Beach, CA 92660                          */
/*------------------------------------------------*/
/* Copyright(C) 2000 Conexant System Inc.              */
/*------------------------------------------------*/
/* ALL RIGHTS RESERVED:                              */
/* No part of this software may be reproduced in any form or by any  */
/* means or used to make any derivative work (such as transformation */
/* or adaptation) without the authorisation of Conexant System Inc.  */
/*==================================================================*/
/* PROTOTYPE FILE : main.h                          */
/*==================================================================*/


/*------------------------------------------------*/
/*------------------------ INCLUDE ------------------------*/
/*------------------------------------------------*/


#include <stdio.h>
#include <stdlib.h>
#include <math.h>
#include <string.h>
#include <malloc.h>
#include <errno.h>
#include <memory.h>
#include <float.h>
#include <limits.h>


/*------------------------------------------------*/
/*------------------------ DEFINE ------------------------*/
/*------------------------------------------------*/


#define nint(x) ((x>=0)? (INT16)(x+0.5):(INT16)(x-0.5))

#define MAX_n(x,y) ((x)>(y))?(x):(y)
#define MIN_n(x,y) ((x)<(y))?(x):(y)
```

```
#define ABS_n(x) ((x)<0)?(-x):(x)


/*---------------------------------------------------------*/
/*------------------------ DEFINE --------------------------*/
/*---------------------------------------------------------*/


#define       EXIT_FAILURE 1
#define       NB_MAX_CHAR              128
#define       NB_ALGO_MAX             100
#define       MAXSENTENCE            100
#define       NB_MAX_VEC     100


/*
#define PI       3.14159265358979311599796346854418516159057617187 5
#define TWO_PI 6.283185307179586231995926937088370323181152343 75
*/
#define  PI 3.141592654




/*═════════════════════════════════════════════════════════*/
/*------------------------ END -------------------------*/
/*═════════════════════════════════════════════════════════*/
```

```
/*=====================================================================*/


/*==============================================================*/
/* Conexant System Inc.                          */
/* 4311 Jamboree Road                            */
/* Newport Beach, CA 92660                        */
/*------------------------------------------------*/
/* Copyright(C) 2000 Conexant System Inc.             */
/*------------------------------------------------*/
/* ALL RIGHTS RESERVED:                          */
/* No part of this software may be reproduced in any form or by any  */
/* means or used to make any derivative work (such as transformation */
/* or adaptation) without the authorisation of Conexant System Inc.  */
/*==============================================================*/
/* MAIN PROGRAM : main_dec.c                       */
/*==============================================================*/


/*------------------------------------------------*/
/*------------------------ INCLUDE ------------------------*/
/*------------------------------------------------*/


#include "typedef.h"
#include "main.h"
#include "const.h"
#include "glb_var.h"

#include "mcutil.h"
#include "gputil.h"

#include "decoder.h"

#include "lib_io.h"
#include "lib_ini.h"
#include "lib_cpr.h"


#ifdef DIAG_SMV

#include "lib_dia.h"
```

```
#endif

/*==================================================================*/
/*------------------------- MAIN --------------------------*/
/*==================================================================*/


int main( int argc, char *argv[] )
{
        /*--------------------------------------------------*/
        /*              Pointers to I/O files            */
        /*--------------------------------------------------*/

        FILE    *fp_speech_out;
        FILE    *fp_bitstream;

        /*--------------------------------------------------*/
        /*              I/O buffers                      */
        /*--------------------------------------------------*/

        FLOAT64 dec_sigout[L_FRM];
        INT16   i, switch_flag=1;
        INT16   *s_y;

        INT16   serial[PACKWDSNUM];

        /*--------------------------------------------------*/
        /*              Print copyright information        */
        /*--------------------------------------------------*/

#ifdef VERBOSE

        print_copyright ();

#endif

        /*--------------------------------------------------*/
        /*              Check the number of input parameters */
        /*--------------------------------------------------*/

        if (argc < 3)
```

```
                        {
        #ifdef VERBOSE
                        printf("\n%s bitstream_file decoded_speech_file \n\n",

                        argv[0]);
        #endif
                        exit (1);
                        }


                /*----------------------------------------------------*/
                /*                 Open IO files                 */
                /*----------------------------------------------------*/


                fp_bitstream = file_open_rb (argv [1]);

                fp_speech_out = file_open_wb (argv [2]);



                if (argc == 4)
                        switch_flag = atoi(argv[3]);


        #ifdef VERBOSE
                printf("\nExecutable      : %s\n",argv[0]);
                printf("Input bitstream : %s\n", argv[1]);
                printf("Output speech   : %s\n", argv[2]);



        #ifdef BYTE_SWAP_OUTPUT

                printf("Output is byte-swapped\n");


        #endif


        #endif


        #ifdef DIAGNOSTICS


                /*----------------------------------------------------*/
                /*            Open DIAGNOSTICS files             */
                /*----------------------------------------------------*/
```

```
        DIA_dec_open_files ();

#endif


        /*----------------------------------------------------*/
        /*              Memory Allocation              */
        /*----------------------------------------------------*/


        s_y = svector (0, L_FRM-1);


        INI_allocate_memory ();



        /*----------------------------------------------------*/
        /*            Algorithm Initialization            */
        /*----------------------------------------------------*/


        INI_init_decoder();


/*==================================================================*/
/* ◻◻◻◻◻◻◻◻◻◻◻◻◻◻◻◻◻◻◻◻◻◻◻◻◻◻ SYNTHESIS PART ◻◻◻◻◻◻◻◻◻◻◻◻◻◻◻◻◻◻◻◻◻◻◻◻◻◻◻◻◻ */
/*==================================================================*/



        while ((i = fread(serial, sizeof(short), PACKWDSNUM, fp_bitstream))
                    == PACKWDSNUM)
                {
                frm_count++;


#ifdef VERBOSE
                printf ("[%ld frame(s), %6.3f sec.]\r", frm_count,
                            (FLOAT64)(frm_count*L_FRM)/(FLOAT64)FS);
#endif


        /*----------------------------------------------------*/
        /*             Decoding Bitstream              */
        /*----------------------------------------------------*/

```

```
        dec_smv_frame(serial, dec_sigout, switch_flag);

        IO_writesamples (fp_speech_out, dec_sigout, s_y, L_FRM);

    }

    /*----------------------------------------------------*/
    /*            Memory Deallocation            */
    /*----------------------------------------------------*/

    free_svector (s_y, 0, L_FRM-1);

    INI_deallocate_memory ();

    /*----------------------------------------------------*/
    /*            Close IO files            */
    /*----------------------------------------------------*/

    fclose (fp_bitstream);
    fclose (fp_speech_out);

#ifdef DIAGNOSTICS

    /*----------------------------------------------------*/
    /*            Close DIAGNOSTICS files            */
    /*----------------------------------------------------*/

    DIA_dec_close_files ();

#endif

    printf("\n");

    /*----------------------------------------------------*/

    return 0;

    /*----------------------------------------------------*/
}
```

```
/*--------------------------------------------------*/

/*==================================================*/
/*------------------ END ----------------------*/
/*==================================================*/
```

```
/*===========================================================================*/


/*=======================================================================*/
/* Conexant System Inc.                              */
/* 4311 Jamboree Road                               */
/* Newport Beach, CA 92660                           */
/*------------------------------------------------*/
/* Copyright(C) 2000 Conexant System Inc.                  */
/*------------------------------------------------*/
/* ALL RIGHTS RESERVED:                              */
/* No part of this software may be reproduced in any form or by any */
/* means or used to make any derivative work (such as transformation */
/* or adaptation) without the authorisation of Conexant System Inc.  */
/*=======================================================================*/
/* MAIN PROGRAM : main_enc.c                         */
/*=======================================================================*/


/*------------------------------------------------*/
/*--------------------- INCLUDE ------------------*/
/*------------------------------------------------*/


#include "typedef.h"
#include "main.h"
#include "const.h"
#include "glb_var.h"


#include "mcutil.h"
#include "gputil.h"


#include "encoder.h"


#include "lib_ini.h"
#include "lib_io.h"
#include "lib_cpr.h"
#include "lib_ppr.h"
#include "lib_sns.h"


#ifdef DIAG_SMV


#include "lib_dia.h"
```

```
        #endif

/*==================================================================*/
/*----------------------------- MAIN ------------------------------*/
/*==================================================================*/


int main (int argc, char *argv[] )
        {
        /*--------------------------------------------------------*/
        /*                I/O Files                */
        /*--------------------------------------------------------*/


        FILE *fp_speech_in;
        FILE *fp_bitstream;
        FILE *fp_signaling;
        FILE *fp_mode;


        /*--------------------------------------------------------*/
        /*                Variables                */
        /*--------------------------------------------------------*/


        FLOAT64 *px;
        FLOAT64 avg_rate;


//      INT16   flat_flag=0;
        INT16   switch_flag=1;
        INT16   input_samples;
        char    signaling;


        INT16   VoicingClass=0;


        /*--------------------------------------------------------*/
        /*                I/O buffers                */
        /*--------------------------------------------------------*/


        FLOAT64 *sig_in, *signn_buf, *sig_ppr, *sig_out;
        INT16   *s_x, *s_y;


        INT16   *serial;
```

```
/*---------------------------------------------*/
/*           Print copyright information       */
/*---------------------------------------------*/


#ifdef VERBOSE

        print_copyright ();

#endif


/*---------------------------------------------*/
/*              Parameters Set-up              */
/*---------------------------------------------*/


    INI_parameters_setup (argc, argv, &fp_speech_in, &fp_bitstream,
                          &fp_mode, &fp_signaling, &smv_mode);


#ifdef DIAG_SMV
    )

/*---------------------------------------------*/
/*          Open DIAGNOSTICS files             */
/*---------------------------------------------*/


    i

        DIA_enc_open_files    ();


#endif

    )
/*---------------------------------------------*/
/*              Memory Allocation              */
/*---------------------------------------------*/


        s_x = svector (0, L_FRM-1);
        s_y = svector (0, L_FRM-1);


        sig_in   = dvector (0, L_FRM-1);
        signn_buf      = dvector (0, L_FRM+ENH_DELAY-1);
        sig_ppr = dvector (0, L_PP-1);
        sig_out        = dvector (0, L_FRM-1);
```

```
serial = svector (0, PACKWDSNUM-1);

INI_allocate_memory ();

/*----------------------------------------------------------*/
/*              Algorithm Initialization              */
/*----------------------------------------------------------*/

INI_init_encoder();

/*----------------------------------------------------------*/
/*                  Read the input signal                  */
/*----------------------------------------------------------*/

px = sig_in+L_FRM-L_LPCLHD-ENH_DELAY;

IO_readsamples(fp_speech_in, s_x, px, L_LPCLHD+ENH_DELAY);

/*----------------------------------------------------------*/
/*      Silence enhancement of the Input signal frame      */
/*----------------------------------------------------------*/

PPR_silence_enhan (px, px, L_LPCLHD+ENH_DELAY);

/*----------------------------------------------------------*/
/*              High pass filter at 80 Hz              */
/*----------------------------------------------------------*/

PPR_highpass (L_FRM, sig_in);

cpy_dvector(sig_in, signn_buf+ENH_DELAY, 0, L_FRM-1);

/*----------------------------------------------------------*/
/*              Input Speech Enhancement              */
/*----------------------------------------------------------*/

SNS_modified_noise_suprs(VoicingClass, sig_in);
SNS_modified_noise_suprs(VoicingClass, sig_in+L_FRM/2);
```

```
cpy_dvector (sig_in+L_FRM-L_LPCLHD, sig_ppr+L_PP-L_LPCLHD, 0, L_LPCLHD-1);


       /*-----------------------------------------------------*/
       /*          Low pass filter for tilt compensation       */
       /*-----------------------------------------------------*/


       px = sig_ppr+L_PP-L_LPCLHD;
       PPR_lowpass (px, (INT16)(L_LPCLHD), smv_mode, FlatSp_Flag);


   /*=================================================================*/
   /* oooooooooooooooooooooooooooo ANALYSIS PART oooooooooooooooooooooooooooo */
   /*=================================================================*/



       /*-----------------------------------------------------*/


       input_samples = L_FRM;


       while (input_samples == L_FRM)
               {
               /*---------------------------------------------*/


               frm_count++;


               /*---------------------------------------------*/

#ifdef VERBOSE
               printf ("[%ld frame(s), %6.3f sec.]\r", frm_count,


       (FLOAT64)(frm_count*L_FRM)/FS);
#endif
               /*---------------------------------------------*/
               /*          Reading the signaling information       */
               /*---------------------------------------------*/


               if (fp_signaling != NULL)
                       fread(&signaling, sizeof(char), 1, fp_signaling);
               else
                       signaling = (char) 0;
```

```
/*-------------------------------------------------------*/
/*              Read the input signal                */
/*-------------------------------------------------------*/


input_samples = (INT16)IO_readsamples (fp_speech_in, s_x, sig_in,

L_FRM);


/*-------------------------------------------------------*/
/*      Silence enhancement of the Input signal frame   */
/*-------------------------------------------------------*/


PPR_silence_enhan (sig_in, sig_in, input_samples);


/*-------------------------------------------------------*/
/*      Zero Padding if necessary for the last frame    */
/*-------------------------------------------------------*/


ini_dvector(sig_in, input_samples, L_FRM-1, 0.0);


PPR_highpass (L_FRM, sig_in);


cpy_dvector(signn_buf+L_FRM, signn_buf, 0, ENH_DELAY-1);
cpy_dvector(sig_in, signn_buf+ENH_DELAY, 0, L_FRM-1);



if (FlatSp_Flag == 1)
            MIN_GAIN = -14.0;


/*-------------------------------------------------------*/
/*              Input Speech Enhancement             */
/*-------------------------------------------------------*/


SNS_modified_noise_suprs(VoicingClass, sig_in);
SNS_modified_noise_suprs(VoicingClass, sig_in+L_FRM/2);


/*-------------------------------------------------------*/
/*      Update the pre-processed speech buffer       */
/*-------------------------------------------------------*/
```

```
cpy_dvector (sig_ppr+L_FRM, sig_ppr,      0, L_PP-L_FRM-1);
cpy_dvector (sig_in, sig_ppr+L_PP-L_FRM, 0, L_FRM-1);


/*-----------------------------------------------------*/
/*        Low pass filter for tilt compensation      */
/*-----------------------------------------------------*/


px = sig_ppr+L_PP-L_FRM;
PPR_lowpass (px, L_FRM, smv_mode, FlatSp_Flag);

#ifdef SCRATCH_PAD_MEM


ini_dvector(sig_in,      0, L_FRM-1, -1.0);
ini_dvector(signn_buf, 0, L_FRM-1, -1.0);


#endif


enc_smv_frame (sig_ppr, serial, sig_out, smv_mode,
                        switch_flag, &FlatSp_Flag, signaling,
                            &avg_rate, &VoicingClass);



#ifdef DIAG_SMV


IO_writesamples (fdia_sp_enc, sig_out, s_y, L_FRM);


#endif



fwrite(serial, sizeof(short), PACKWDSNUM, fp_bitstream);
}


/*-----------------------------------------------------*/
/*        Print the Average bit rate         */
/*-----------------------------------------------------*/


printf("\n\t\t\taverage_rate = %f\n", avg_rate);


/*-----------------------------------------------------*/
/*            Memory Deallocation              */
```

```
/*-----------------------------------------------*/

free_svector (s_x, 0, L_FRM-1);
free_svector (s_y, 0, L_FRM-1);


free_dvector (sig_in,          0, L_FRM-1);
free_dvector (signn_buf,  0, L_FRM+ENH_DELAY-1);
free_dvector (sig_ppr,          0, L_PP-1);
free_dvector (sig_out,          0, L_FRM-1);


free_svector (serial, 0, PACKWDSNUM-1);


INI_deallocate_memory ();


/*-----------------------------------------------*/
/*              Close IO files              */
/*-----------------------------------------------*/


fclose(fp_speech_in);
fclose(fp_bitstream);


if (fp_signaling != NULL)
        fclose(fp_signaling);


#ifdef DIAG_SMV


/*-----------------------------------------------*/
/*            Close DIAGNOSTICS files          */
/*-----------------------------------------------*/


DIA_enc_close_files ();


#endif


/*-----------------------------------------------*/


#ifdef VERBOSE


printf("\n");
```

EP 1 214 706 B1

```
#endif
        /*----------------------------------------------------*/

    return 0;

        /*----------------------------------------------------*/
    }

/*----------------------------------------------------*/

/*================================================================*/
/*------------------------ END ----------------------------*/
/*================================================================*/
```

795

```
/*==========================================================*/


/*==========================================================*/
/* Conexant System Inc.                    */
/* 4311 Jamboree Road                      */
/* Newport Beach, CA 92660                   */
/*-----------------------------------------*/
/* Copyright(C) 2000 Conexant System Inc.         */
/*-----------------------------------------*/
/* ALL RIGHTS RESERVED:                    */
/* No part of this software may be reproduced in any form or by any  */
/* means or used to make any derivative work (such as transformation */
/* or adaptation) without the authorisation of Conexant System Inc.  */
/*==========================================================*/
/* LIBRARY: mcutil.c                     */
/*==========================================================*/


/*-----------------------------------------*/
/*----------------------- INCLUDE -------------------------*/
/*-----------------------------------------*/


#include "typedef.h"

#include <malloc.h>
#include <stdio.h>
#include <stdlib.h>


/*-----------------------------------------*/
/*----------------------- FUNCTIONS -----------------------*/
/*-----------------------------------------*/


/*==========================================================*/
/* FUNCTIONS    :   nrerror ()                */
/*-----------------------------------------*/
/* PURPOSE     :   Standard error handler.          */
/*-----------------------------------------*/
/* INPUT ARGUMENTS  :  _ (char*) error_text : output string.     */
/*-----------------------------------------*/
/* OUTPUT ARGUMENTS :  _ None.                */
/*-----------------------------------------*/
```

796

```
/* RETURN ARGUMENTS : _ None.                          */
/*====================================================*/


void nrerror ( char error_text [] )
{
        fprintf(stderr,"Run-time error...\n");
        fprintf(stderr,"%s\n",error_text);
        fprintf(stderr,"...now exiting to system...\n");
        exit(1);
}


/*-------------------------------------------------*/


/*====================================================*/
/* FUNCTIONS    :   vector ()                   */
/*-------------------------------------------------*/
/* PURPOSE      :   Allocate a float vector with subscript range */
/*               v [nl, ..., nh].                 */
/*-------------------------------------------------*/
/* INPUT ARGUMENTS :  _ (INT32) nl.                  */
/*               _ (INT32) nh.                    */
/*-------------------------------------------------*/
/* OUTPUT ARGUMENTS : _ None.                    */
/*-------------------------------------------------*/
/* RETURN ARGUMENTS : _ (FLOAT32*): pointer to the allocated vector.*/
/*====================================================*/


FLOAT32 *vector( INT32 nl, INT32 nh)
{
        FLOAT32 *v;

        v=(FLOAT32 *)calloc((unsigned) (nh-nl+1),sizeof(FLOAT32));
        if (!v) nrerror("allocation failure in vector()");
        return v-nl;
}


/*-------------------------------------------------*/


/*====================================================*/
/* FUNCTIONS    :   svector ()                  */
```

797

```
/*---------------------------------------------------*/
/* PURPOSE      :   Allocate a short vector with subscript range */
/*               v [nl, ..., nh].                    */
/*---------------------------------------------------*/
/* INPUT ARGUMENTS : _ (INT32) nl.                   */
/*                _ (INT32) nh.                       */
/*---------------------------------------------------*/
/* OUTPUT ARGUMENTS : _ None.                        */
/*---------------------------------------------------*/
/* RETURN ARGUMENTS : _ (INT16*): pointer to the allocated vector. */
/*=================================================*/


INT16 *svector( INT32 nl, INT32 nh)
{
        INT16 *v;

        v=(INT16 *)calloc((unsigned) (nh-nl+1),sizeof(INT16));
        if (!v) nrerror("allocation failure in svector()");
        return v-nl;
}


        /*---------------------------------------------------*/


        /*=================================================*/
/* FUNCTIONS    :   ivector ()                       */
/*---------------------------------------------------*/
/* PURPOSE      :   Allocate an int vector with subscript range */
/*               v [nl, ..., nh].                    */
/*---------------------------------------------------*/
/* INPUT ARGUMENTS : _ (INT32) nl.                   */
/*                _ (INT32) nh.                       */
/*---------------------------------------------------*/
/* OUTPUT ARGUMENTS : _ None.                        */
/*---------------------------------------------------*/
/* RETURN ARGUMENTS : _ (INT32*): pointer to the allocated vector. */
/*=================================================*/


INT32 *ivector( INT32 nl, INT32 nh )
{
        INT32 *v;
```

```
        v=(INT32 *)calloc((unsigned) (nh-nl+1),sizeof(INT32));
        if (!v) nrerror("allocation failure in ivector()");
        return v-nl;
}


/*--------------------------------------------------------------*/


/*==============================================================*/
/* FUNCTIONS    :   lvector ()                       */
/*--------------------------------------------------------------*/
/* PURPOSE     :   Allocate a long vector with subscript range  */
/*                 v [nl, ..., nh].                  */
/*--------------------------------------------------------------*/
/* INPUT ARGUMENTS  : _ (INT32) nl.                      */
/*                    _ (INT32) nh.                  */
/*--------------------------------------------------------------*/
/* OUTPUT ARGUMENTS : _ None.                        */
/*--------------------------------------------------------------*/
/* RETURN ARGUMENTS : _ (INT64*): pointer to the allocated vector.  */
/*==============================================================*/


INT64 *lvector( INT32 nl, INT32 nh )
{
        INT64 *v;

        v=(INT64 *)calloc((unsigned) (nh-nl+1),sizeof(INT64));
        if (!v) nrerror("allocation failure in lvector()");
        return v-nl;
}


/*--------------------------------------------------------------*/


/*==============================================================*/
/* FUNCTIONS    :   dvector ()                       */
/*--------------------------------------------------------------*/
/* PURPOSE     :   Allocate a double vector with subscript range */
/*                 v [nl, ..., nh].                  */
/*--------------------------------------------------------------*/
/* INPUT ARGUMENTS  : _ (INT32) nl.                      */
```

```
/*             _ (INT32) nh.                              */
/*------------------------------------------------------*/
/* OUTPUT ARGUMENTS : _ None.                           */
/*------------------------------------------------------*/
/* RETURN ARGUMENTS : _ (FLOAT64*): pointer to the allocated vector.*/
/*=====================================================*/


FLOAT64 *dvector( INT32 nl, INT32 nh )
{
        FLOAT64 *v;

        v=(FLOAT64 *)calloc((unsigned) (nh-nl+1),sizeof(FLOAT64));
    .   if (!v) nrerror("allocation failure in dvector()");
        return v-nl;
}



/*------------------------------------------------------*/



/*=====================================================*/
/* FUNCTIONS    :   matrix ()                           */
/*------------------------------------------------------*/
/* PURPOSE      :   Allocate a float matrix with subscript range */
/*                  m [nrl, ..., nrh][ncl, ..., nch].   */
/*------------------------------------------------------*/
/* INPUT ARGUMENTS :  _ (INT32) nrl (low row).         */
/*                    _ (INT32) nrh (high row).         */
/*                    _ (INT32) ncl (low column).       */
/*                    _ (INT32) nch (high column).      */
/*------------------------------------------------------*/
/* OUTPUT ARGUMENTS : _ None.                           */
/*------------------------------------------------------*/
/* RETURN ARGUMENTS : _ (FLOAT32**): pointer to the allocated     */
/*                       matrix.                        */
/*=====================================================*/


FLOAT32 **matrix( INT32 nrl, INT32 nrh, INT32 ncl, INT32 nch )
{
        INT32 i;
        FLOAT32 **m;
```

```
        m=(FLOAT32 **) calloc((unsigned) (nrh-nrl+1),sizeof(FLOAT32*));
        if (!m) nrerror("allocation failure 1 in matrix()");
        m -= nrl;

        for(i=nrl;i<=nrh;i++) {
                m[i]=(FLOAT32 *) calloc((unsigned) (nch-ncl+1),sizeof(FLOAT32));
                if (!m[i]) nrerror("allocation failure 2 in matrix()");
                m[i] -= ncl;
        }
        return m;
}


/*----------------------------------------------------------*/


/*==========================================================*/
/* FUNCTIONS    :   smatrix ()                    */
/*----------------------------------------------------------*/
/* PURPOSE      :   Allocate a short matrix with subscript range */
/*                  m [nrl, ..., nrh][ncl, ..., nch].       */
/*----------------------------------------------------------*/
/* INPUT ARGUMENTS  :  _ (INT32) nrl (low row).             */
/*                     _ (INT32) nrh (high row).            */
/*                     _ (INT32) ncl (low column).          */
/*                     _ (INT32) nch (high column).         */
/*----------------------------------------------------------*/
/* OUTPUT ARGUMENTS :  _ None.                              */
/*----------------------------------------------------------*/
/* RETURN ARGUMENTS :  _ (INT16**): pointer to the allocated matrix. */
/*==========================================================*/

INT16 **smatrix( INT32 nrl, INT32 nrh, INT32 ncl, INT32 nch )
{
        INT32 i;
        INT16 **m;

        m=(INT16 **) calloc((unsigned) (nrh-nrl+1),sizeof(INT16*));
        if (!m) nrerror("allocation failure 1 in smatrix()");
        m -= nrl;

        for(i=nrl;i<=nrh;i++) {
```

```
            m[i]=(INT16 *) calloc((unsigned) (nch-ncl+1),sizeof(INT16));
            if (!m[i]) nrerror("allocation failure 2 in smatrix()");
            m[i] -= ncl;
      }
      return m;
}


/*----------------------------------------------------------------*/


/*================================================================*/
/* FUNCTIONS    :   dmatrix ()                        */
/*----------------------------------------------------------------*/
/* PURPOSE     :    Allocate a double matrix with subscript range */
/*              m [nrl, ..., nrh][ncl, ..., nch].         */
/*----------------------------------------------------------------*/
/* INPUT ARGUMENTS :  _ (INT32) nrl (low row).            */
/*              _ (INT32) nrh (high row).         */
/*              _ (INT32) ncl (low column).          */
/*              _ (INT32) nch (high column).         */
/*----------------------------------------------------------------*/
/* OUTPUT ARGUMENTS : _ None.                     */
/*----------------------------------------------------------------*/
/* RETURN ARGUMENTS : _ (FLOAT64**): pointer to the allocated     */
/*                    matrix.               */
/*================================================================*/


FLOAT64 **dmatrix( INT32 nrl, INT32 nrh, INT32 ncl, INT32 nch )
{
      INT32 i;
      FLOAT64 **m;

      m=(FLOAT64 **) calloc((unsigned) (nrh-nrl+1),sizeof(FLOAT64*));
      if (!m) nrerror("allocation failure 1 in dmatrix()");
      m -= nrl;

      for(i=nrl;i<=nrh;i++) {
            m[i]=(FLOAT64 *) calloc((unsigned) (nch-ncl+1),sizeof(FLOAT64));
            if (!m[i]) nrerror("allocation failure 2 in dmatrix()");
            m[i] -= ncl;
      }
```

```
        return m;

}


/*─────────────────────────────────────────────────────*/


/*═════════════════════════════════════════════════════════*/
/* FUNCTIONS    :   imatrix ()                    */
/*─────────────────────────────────────────*/
/* PURPOSE      :   Allocate an int matrix with subscript range  */
/*              m [nrl, ..., nrh][ncl, ..., nch].          */
/*─────────────────────────────────────────*/
/* INPUT ARGUMENTS  :  _ (INT32) nrl (low row).              */
/*              _ (INT32) nrh (high row).            */
/*              _ (INT32) ncl (low column).          */
/*              _ (INT32) nch (high column).          */
/*─────────────────────────────────────────*/
/* OUTPUT ARGUMENTS : _ None.                      */
/*─────────────────────────────────────────*/
/* RETURN ARGUMENTS : _ (INT32**): pointer to the allocated matrix. */
/*═════════════════════════════════════════════════════════*/


INT32 **imatrix( INT32 nrl, INT32 nrh, INT32 ncl, INT32 nch)
{
        INT32 i,**m;


        m=(INT32 **)calloc((unsigned) (nrh-nrl+1),sizeof(INT32*));
        if (!m) nrerror("allocation failure 1 in imatrix()");
        m -= nrl;


        for(i=nrl;i<=nrh;i++) {
                m[i]=(INT32 *)calloc((unsigned) (nch-ncl+1),sizeof(INT32));
                if (!m[i]) nrerror("allocation failure 2 in imatrix()");
                m[i] -= ncl;
        }
        return m;

}


/*─────────────────────────────────────────────────────*/


/*═════════════════════════════════════════════════════════*/
```

```
/* FUNCTIONS    :   submatrix ()                    */
/*--------------------------------------------------*/
/* PURPOSE      :   Allocate a float matrix with subscript range */
/*           m [nrl, ..., nrh][ncl, ..., nch].       */
/*--------------------------------------------------*/
/* INPUT ARGUMENTS :  _ (INT32) nrl (low row).            */
/*           _ (INT32) nrh (high row).              */
/*           _ (INT32) ncl (low column).            */
/*           _ (INT32) nch (high column).           */
/*--------------------------------------------------*/
/* OUTPUT ARGUMENTS : _ None.                       */
/*--------------------------------------------------*/
/* RETURN ARGUMENTS : _ (FLOAT32**): pointer to the allocated   */
/*                matrix.           */
/*================================================================*/


FLOAT32 **submatrix( FLOAT32 **a, INT32 oldrl, INT32 oldrh, INT32 oldcl, \
                                   INT32 newrl, INT32 newcl)
{
        INT32 i,j;
        FLOAT32 **m;

        m=(FLOAT32 **) calloc((unsigned) (oldrh-oldrl+1),sizeof(FLOAT32*));
        if (!m) nrerror("allocation failure in submatrix()");
        m -= newrl;

        for(i=oldrl,j=newrl;i<=oldrh;i++,j++) m[j]=a[i]+oldcl-newcl;

        return m;
}


/*--------------------------------------------------*/


/*================================================================*/
/* FUNCTIONS    :   s3tensor ()                    */
/*--------------------------------------------------*/
/* PURPOSE      :   Allocate a short tensor with subscript range */
/*           t [nrl,..., nrh][ncl,..., nch][ndl,...,ndh].  */
/*--------------------------------------------------*/
/* INPUT ARGUMENTS :  _ (INT32) nrl.                      */
```

```
/*              _ (INT32) nrh.              */
/*              _ (INT32) ncl.              */
/*              _ (INT32) nch.              */
/*              _ (INT32) ndl.              */
/*              _ (INT32) ndh.              */
/*_____*/
/* OUTPUT ARGUMENTS : _ None.                  */
/*_____*/
/* RETURN ARGUMENTS : _ (INT16***): pointer to the allocated tensor.*/
/*=================================================================*/


INT16 ***s3tensor (INT32 nrl, INT32 nrh, INT32 ncl, INT32 nch, INT32 ndl, INT32 ndh)
{
        INT32 i,j,nrow=nrh-nrl+1,ncol=nch-ncl+1,ndep=ndh-ndl+1;
        INT16 ***t;

        t=(INT16***)calloc((unsigned) (nrow+1), sizeof(INT16**));
        if (!t) nrerror("allocation failure 1 in s3tensor()");
        t+=1;
        t-=nrl;

        t[nrl]=(INT16**)calloc((unsigned) (nrow*ncol+1), sizeof(INT16*));
        if (!t[nrl]) nrerror("allocation failure 2 in s3tensor()");
        t[nrl]+=1;
        t[nrl]-=ncl;

        t[nrl][ncl]=(INT16*)calloc((unsigned) (nrow*ncol*ndep+1), sizeof(INT16));
        if (!t[nrl][ncl]) nrerror("allocation failure 3 in s3tensor()");
        t[nrl][ncl]+=1;
        t[nrl][ncl]-=ndl;

        for(j=ncl+1;j<=nch;j++) t[nrl][j]=t[nrl][j-1]+ndep;
        for(i=nrl+1;i<=nrh;i++){
                t[i]=t[i-1]+ncol;
                t[i][ncl]=t[i-1][ncl]+ncol*ndep;
                for(j=ncl+1;j<=nch;j++) t[i][j]=t[i][j-1]+ndep;
        }

        return t;
}
```

```
/*--------------------------------------------------*/

/*==================================================*/
/* FUNCTIONS    :   i3tensor ()                  */
/*--------------------------------------------------*/
/* PURPOSE      :   Allocate an int tensor with subscript range   */
/*               t [nrl,..., nrh][ncl,..., nch][ndl,...,ndh].  */
/*--------------------------------------------------*/
/* INPUT ARGUMENTS :  _ (INT32) nrl.                 */
/*               _ (INT32) nrh.                   */
/*               _ (INT32) ncl.                   */
/*               _ (INT32) nch.                   */
/*               _ (INT32) ndl.                   */
/*               _ (INT32) ndh.                   */
/*--------------------------------------------------*/
/* OUTPUT ARGUMENTS :  _ None.                       */
/*--------------------------------------------------*/
/* RETURN ARGUMENTS :  _ (INT32***): pointer to the allocated      */
/*                    tensor.                    */
/*==================================================*/


INT32 ***i3tensor (INT32 nrl, INT32 nrh, INT32 ncl, INT32 nch, INT32 ndl, INT32 ndh)
{
        INT32 i,j,nrow=nrh-nrl+1,ncol=nch-ncl+1,ndep=ndh-ndl+1;
        INT32 ***t;

        t=(INT32***)calloc((unsigned) (nrow+1), sizeof(INT32**));
        if (!t) nrerror("allocation failure 1 in i3tensor()");
        t+=1;
        t-=nrl;

        t[nrl]=(INT32**)calloc((unsigned) (nrow*ncol+1), sizeof(INT32*));
        if (!t[nrl]) nrerror("allocation failure 2 in i3tensor()");
        t[nrl]+=1;
        t[nrl]-=ncl;

        t[nrl][ncl]=(INT32*)calloc((unsigned) (nrow*ncol*ndep+1), sizeof(INT32));
        if (!t[nrl][ncl]) nrerror("allocation failure 3 in i3tensor()");
        t[nrl][ncl]+=1;
```

```
        t[nrl][ncl]-=ndl;


        for(j=ncl+1;j<=nch;j++) t[nrl][j]=t[nrl][j-1]+ndep;
        for(i=nrl+1;i<=nrh;i++){
                t[i]=t[i-1]+ncol;
                t[i][ncl]=t[i-1][ncl]+ncol*ndep;
                for(j=ncl+1;j<=nch;j++) t[i][j]=t[i][j-1]+ndep;
        }


        return t;
}



/*_____*/



/*===============================================*/
/* FUNCTIONS     :   l3tensor ()                   */
/*_____*/
/* PURPOSE      :    Allocate a long tensor with subscript range   */
/*               t [nrl,..., nrh][ncl,..., nch][ndl,...,ndh].  */
/*_____*/
/* INPUT ARGUMENTS  : _ (INT32) nrl.                        */
/*                _ (INT32) nrh.                   */
/*                _ (INT32) ncl.                   */
/*                _ (INT32) nch.                   */
/*                _ (INT32) ndl.                   */
/*                _ (INT32) ndh.                   */
/*_____*/
/* OUTPUT ARGUMENTS : _ None.                          */
/*_____*/
/* RETURN ARGUMENTS : _ (INT64***): pointer to the allocated       */
/*                   tensor.                   */
/*===============================================*/


INT64 ***l3tensor (INT32 nrl, INT32 nrh, INT32 ncl, INT32 nch, INT32 ndl, INT32 ndh)
{
        INT32 i,j,nrow=nrh-nrl+1,ncol=nch-ncl+1,ndep=ndh-ndl+1;
        INT64 ***t;

        t=(INT64***)calloc((unsigned) (nrow+1), sizeof(INT64**));
        if (!t) nrerror("allocation failure 1 in l3tensor()");
```

```
        t+=1;
        t-=nrl;

        t[nrl]=(INT64**)calloc((unsigned) (nrow*ncol+1), sizeof(INT64*));
        if (!t[nrl]) nrerror("allocation failure 2 in I3tensor()");
        t[nrl]+=1;
        t[nrl]-=ncl;

        t[nrl][ncl]=(INT64*)calloc((unsigned) (nrow*ncol*ndep+1), sizeof(INT64));
        if (!t[nrl][ncl]) nrerror("allocation failure 3 in I3tensor()");
        t[nrl][ncl]+=1;
        t[nrl][ncl]-=ndl;

        for(j=ncl+1;j<=nch;j++) t[nrl][j]=t[nrl][j-1]+ndep;
        for(i=nrl+1;i<=nrh;i++){
                t[i]=t[i-1]+ncol;
                t[i][ncl]=t[i-1][ncl]+ncol*ndep;
                for(j=ncl+1;j<=nch;j++) t[i][j]=t[i][j-1]+ndep;
        }

        return t;
}


/*---------------------------------------------------------------*/


/*===============================================================*/
/* FUNCTIONS    :   f3tensor ()                         */
/*---------------------------------------------------------------*/
/* PURPOSE      :   Allocate a float tensor with subscript range */
/*                  t [nrl,..., nrh][ncl,..., nch][ndl,...,ndh].  */
/*---------------------------------------------------------------*/
/* INPUT ARGUMENTS :  _ (INT32) nrl.                      */
/*                    _ (INT32) nrh.                   */
/*                    _ (INT32) ncl.                   */
/*                    _ (INT32) nch.                   */
/*                    _ (INT32) ndl.                   */
/*                    _ (INT32) ndh.                   */
/*---------------------------------------------------------------*/
/* OUTPUT ARGUMENTS : _ None.                           */
/*---------------------------------------------------------------*/
```

```
/* RETURN ARGUMENTS : _ (FLOAT32***): pointer to the allocated    */
/*                          tensor.              */
/*===============================================================*/


FLOAT32 ***f3tensor (INT32 nrl, INT32 nrh, INT32 ncl, INT32 nch, INT32 ndl, INT32 ndh)
{
        INT32 i,j,nrow=nrh-nrl+1,ncol=nch-ncl+1,ndep=ndh-ndl+1;
        FLOAT32 ***t;

        t=(FLOAT32***)calloc((unsigned) (nrow+1), sizeof(FLOAT32**));
        if (!t) nrerror("allocation failure 1 in f3tensor()");
        t+=1;
        t-=nrl;

        t[nrl]=(FLOAT32**)calloc((unsigned) (nrow*ncol+1), sizeof(FLOAT32*));
        if (!t[nrl]) nrerror("allocation failure 2 in f3tensor()");
        t[nrl]+=1;
        t[nrl]-=ncl;

        t[nrl][ncl]=(FLOAT32*)calloc((unsigned) (nrow*ncol*ndep+1), sizeof(FLOAT32));
        if (!t[nrl][ncl]) nrerror("allocation failure 3 in f3tensor()");
        t[nrl][ncl]+=1;
        t[nrl][ncl]-=ndl;

        for(j=ncl+1;j<=nch;j++) t[nrl][j]=t[nrl][j-1]+ndep;
        for(i=nrl+1;i<=nrh;i++){
                t[i]=t[i-1]+ncol;
                t[i][ncl]=t[i-1][ncl]+ncol*ndep;
                for(j=ncl+1;j<=nch;j++) t[i][j]=t[i][j-1]+ndep;
        }

        return t;
}


/*--------------------------------------------------------------*/


/*==============================================================*/
/* FUNCTIONS    :   d3tensor ()                    */
/*--------------------------------------------------------------*/
/* PURPOSE    :   Allocate a double tensor with subscript range */
```

```
/*              t [nrl,..., nrh][ncl,..., nch][ndl,...,ndh]. */
/*----------------------------------------------------*/
/* INPUT ARGUMENTS :  _ (INT32) nrl.                        */
/*              _ (INT32) nrh.                    */
/*              _ (INT32) ncl.                    */
/*              _ (INT32) nch.                    */
/*              _ (INT32) ndl.                    */
/*              _ (INT32) ndh.                    */
/*----------------------------------------------------*/
/* OUTPUT ARGUMENTS :  _ None.                         */
/*----------------------------------------------------*/
/* RETURN ARGUMENTS :  _ (FLOAT64***): pointer to the allocated    */
/*                          tensor.          */
/*==================================================================*/


FLOAT64 ***d3tensor (INT32 nrl, INT32 nrh, INT32 ncl, INT32 nch, INT32 ndl, INT32 ndh)
{
        INT32 i,j,nrow=nrh-nrl+1,ncol=nch-ncl+1,ndep=ndh-ndl+1;
        FLOAT64 ***t;

        t=(FLOAT64***)calloc((unsigned) (nrow+1), sizeof(FLOAT64**));
        if (!t) nrerror("allocation failure 1 in d3tensor()");
        t+=1;
        t-=nrl;

        t[nrl]=(FLOAT64**)calloc((unsigned) (nrow*ncol+1), sizeof(FLOAT64*));
        if (!t[nrl]) nrerror("allocation failure 2 in d3tensor()");
        t[nrl]+=1;
        t[nrl]-=ncl;

        t[nrl][ncl]=(FLOAT64*)calloc((unsigned) (nrow*ncol*ndep+1), sizeof(FLOAT64));
        if (!t[nrl][ncl]) nrerror("allocation failure 3 in d3tensor()");
        t[nrl][ncl]+=1;
        t[nrl][ncl]-=ndl;

        for(j=ncl+1;j<=nch;j++) t[nrl][j]=t[nrl][j-1]+ndep;
        for(i=nrl+1;i<=nrh;i++){
                t[i]=t[i-1]+ncol;
                t[i][ncl]=t[i-1][ncl]+ncol*ndep;
                for(j=ncl+1;j<=nch;j++) t[i][j]=t[i][j-1]+ndep;
```

```
        }


        return t;

}


/*------------------------------------------------------*/


/*======================================================*/
/* FUNCTIONS    :   free_vector ()                  */
/*------------------------------------------------------*/
/* PURPOSE      :    free a float vector allocated with vector (). */
/*------------------------------------------------------*/
/* INPUT ARGUMENTS :  _ (FLOAT32*) v.                  */
/*                _ (INT32) nl.                     */
/*                _ (INT32) nh.                     */
/*------------------------------------------------------*/
/* OUTPUT ARGUMENTS :  _ None.                     */
/*------------------------------------------------------*/
/* RETURN ARGUMENTS :  _ None.                     */
/*======================================================*/


void free_vector( FLOAT32 *v, INT32 nl, INT32 nh)
{
        free((char*) (v+nl));
}


/*------------------------------------------------------*/


/*======================================================*/
/* FUNCTIONS    :   free_svector ()                 */
/*------------------------------------------------------*/
/* PURPOSE      :    free a short vector allocated with svector ().*/
/*------------------------------------------------------*/
/* INPUT ARGUMENTS :  _ (INT16*) v.                  */
/*                _ (INT32) nl.                     */
/*                _ (INT32) nh.                     */
/*------------------------------------------------------*/
/* OUTPUT ARGUMENTS :  _ None.                     */
/*------------------------------------------------------*/
/* RETURN ARGUMENTS :  _ None.                     */
```

```
/*===========================================================*/


void free_svector( INT16 *v, INT32 nl, INT32 nh)
{
        free((char*) (v+nl));
}


/*-----------------------------------------------------------*/



/*===========================================================*/
/* FUNCTIONS    :   free_ivector ()                    */
/*-----------------------------------------------------------*/
/* PURPOSE      :   free an int vector allocated with ivector (). */
/*-----------------------------------------------------------*/
/* INPUT ARGUMENTS  : _ (INT32*) v.                        */
/*                _ (INT32) nl.                    */
/*                _ (INT32) nh.                    */
/*-----------------------------------------------------------*/
/* OUTPUT ARGUMENTS : _ None.                          */
/*-----------------------------------------------------------*/
/* RETURN ARGUMENTS : _ None.                          */
/*===========================================================*/


void free_ivector( INT32 *v, INT32 nl, INT32 nh)
{
        free((char*) (v+nl));
}


/*-----------------------------------------------------------*/



/*===========================================================*/
/* FUNCTIONS    :   free_lvector ()                    */
/*-----------------------------------------------------------*/
/* PURPOSE      :   free a long vector allocated with lvector (). */
/*-----------------------------------------------------------*/
/* INPUT ARGUMENTS  : _ (INT64*) v.                        */
/*                _ (INT32) nl.                    */
/*                _ (INT32) nh.                    */
/*-----------------------------------------------------------*/
/* OUTPUT ARGUMENTS : _ None.                          */
```

```
/*-------------------------------------------------------*/
/* RETURN ARGUMENTS :  _ None.                        */
/*=======================================================*/


void free_lvector( INT64 *v, INT32 nl, INT32 nh)
{
        free((char*) (v+nl));
}



/*-------------------------------------------------------*/



/*=======================================================*/
/* FUNCTIONS    :  free_dvector ()                    */
/*-------------------------------------------------------*/
/* PURPOSE      :  free a double vector allocated with dvector ().*/
/*-------------------------------------------------------*/
/* INPUT ARGUMENTS :  _ (FLOAT64*) v.                   */
/*                _ (INT32) nl.                     */
/*                _ (INT32) nh.                     */
/*-------------------------------------------------------*/
/* OUTPUT ARGUMENTS :  _ None.                       */
/*-------------------------------------------------------*/
/* RETURN ARGUMENTS :  _ None.                       */
/*=======================================================*/


void free_dvector( FLOAT64 *v, INT32 nl, INT32 nh)
{
        free((char*) (v+nl));
}



/*-------------------------------------------------------*/



/*=======================================================*/
/* FUNCTIONS    :  free_matrix ()                     */
/*-------------------------------------------------------*/
/* PURPOSE      :  free a float matrix allocated with matrix ().  */
/*-------------------------------------------------------*/
/* INPUT ARGUMENTS :  _ (FLOAT32**) m.                  */
/*                _ (INT32) nrl.                    */
/*                _ (INT32) nrh.                    */
```

```
/*              _ (INT32) ncl.                    */
/*              _ (INT32) nch.                    */
/*--------------------------------------------------------*/
/* OUTPUT ARGUMENTS : _ None.                        */
/*--------------------------------------------------------*/
/* RETURN ARGUMENTS : _ None.                        */
/*========================================================*/


void free_matrix( FLOAT32 **m, INT32 nrl, INT32 nrh, INT32 ncl, INT32 nch)
{
        INT32 i;

        for(i=nrh;i>=nrl;i--) free((char*) (m[i]+ncl));
        free((char*) (m+nrl));
}


/*--------------------------------------------------------*/


/*========================================================*/
/* FUNCTIONS     :  free_smatrix ()                  */
/*--------------------------------------------------------*/
/* PURPOSE       :  free a short matrix allocated with smatrix (). */
/*--------------------------------------------------------*/
/* INPUT ARGUMENTS  : _ (INT16**) m.                 */
/*              _ (INT32) nrl.                     */
/*              _ (INT32) nrh.                     */
/*              _ (INT32) ncl.                     */
/*              _ (INT32) nch.                     */
/*--------------------------------------------------------*/
/* OUTPUT ARGUMENTS : _ None.                        */
/*--------------------------------------------------------*/
/* RETURN ARGUMENTS : _ None.                        */
/*========================================================*/


void free_smatrix( INT16 **m, INT32 nrl, INT32 nrh, INT32 ncl, INT32 nch)
{
        INT32 i;

        for(i=nrh;i>=nrl;i--) free((char*) (m[i]+ncl));
        free((char*) (m+nrl));
```

}

```
/*--------------------------------------------------------------*/


/*==============================================================*/
/* FUNCTIONS   :  free_dmatrix ()                    */
/*--------------------------------------------------------------*/
/* PURPOSE      :   free a double matrix allocated with dmatrix ().*/
/*--------------------------------------------------------------*/
/* INPUT ARGUMENTS  :  _ (FLOAT64**) m.                    */
/*               _ (INT32) nrl.                 */
/*               _ (INT32) nrh.                 */
/*               _ (INT32) ncl.                 */
/*               _ (INT32) nch.                 */
/*--------------------------------------------------------------*/
/* OUTPUT ARGUMENTS :  _ None.                        */
/*--------------------------------------------------------------*/
/* RETURN ARGUMENTS :  _ None.                        */
/*==============================================================*/


void free_dmatrix( FLOAT64 **m, INT32 nrl, INT32 nrh, INT32 ncl, INT32 nch)
{
        INT32 i;

        for(i=nrh;i>=nrl;i--) free((char*) (m[i]+ncl));
        free((char*) (m+nrl));
}


/*--------------------------------------------------------------*/


/*==============================================================*/
/* FUNCTIONS   :  free_imatrix ()                    */
/*--------------------------------------------------------------*/
/* PURPOSE      :   free an int matrix allocated with imatrix (). */
/*--------------------------------------------------------------*/
/* INPUT ARGUMENTS  :  _ (INT32**) m.                    */
/*               _ (INT32) nrl.                 */
/*               _ (INT32) nrh.                 */
/*               _ (INT32) ncl.                 */
/*               _ (INT32) nch.                 */
```

```
/*----------------------------------------------------------*/
/* OUTPUT ARGUMENTS : _ None.                    */
/*----------------------------------------------------------*/
/* RETURN ARGUMENTS : _ None.                    */
/*==========================================================*/


void free_imatrix( INT32 **m, INT32 nrl, INT32 nrh, INT32 ncl, INT32 nch)
{
        INT32 i;

        for(i=nrh;i>=nrl;i--) free((char*) (m[i]+ncl));
        free((char*) (m+nrl));
}


/*----------------------------------------------------------*/


/*==========================================================*/
/* FUNCTIONS   :   free_submatrix ()             */
/*----------------------------------------------------------*/
/* PURPOSE     : free a float submatrix allocated with submatrix (). */
/*----------------------------------------------------------*/
/* INPUT ARGUMENTS  : _ (FLOAT32**) b.             */
/*              _ (INT32) nrl.              */
/*              _ (INT32) nrh.              */
/*              _ (INT32) ncl.              */
/*              _ (INT32) nch.              */
/*----------------------------------------------------------*/
/* OUTPUT ARGUMENTS : _ None.                    */
/*----------------------------------------------------------*/
/* RETURN ARGUMENTS : _ None.                    */
/*==========================================================*/


void free_submatrix( FLOAT32 **b, INT32 nrl, INT32 nrh, INT32 ncl, INT32 nch)
{
        free((char*) (b+nrl));
}


/*----------------------------------------------------------*/


/*==========================================================*/
```

```
/* FUNCTIONS   :   free_i3tensor ()                     */
/*-----------------------------------------------------*/
/* PURPOSE     :   free an int tensor allocated with i3tensor ().   */
/*-----------------------------------------------------*/
/* INPUT ARGUMENTS :  _ (INT32***) t.                   .*/
/*              _ (INT32) nrl.                     */
/*              _ (INT32) nrh.                     */
/*              _ (INT32) ncl.                     */
/*              _ (INT32) nch.                     */
/*              _ (INT32) ndl.                     */
/*              _ (INT32) ndh.                     */
/*-----------------------------------------------------*/
/* OUTPUT ARGUMENTS : _ None.                       */
/*-----------------------------------------------------*/
/* RETURN ARGUMENTS : _ None.                       */
/*====================================================*/


void free_i3tensor(INT32 ***t, INT32 nrl, INT32 nrh, INT32 ncl, INT32 nch, INT32 ndl, INT32 ndh)
{
        free((char*) (t[nrl][ncl]+ndl-1));
        free((char*) (t[nrl]+ncl-1));
        free((char*) (t+nrl-1));
}


        /*-----------------------------------------------------*/


        /*====================================================*/
/* FUNCTIONS   :   free_s3tensor ()                     */
/*-----------------------------------------------------*/
/* PURPOSE     :   free a short tensor allocated with s3tensor ().   */
/*-----------------------------------------------------*/
/* INPUT ARGUMENTS :  _ (INT16***) t.                   */
/*              _ (INT32) nrl.                     */
/*              _ (INT32) nrh.                     */
/*              _ (INT32) ncl.                     */
/*              _ (INT32) nch.                     */
/*              _ (INT32) ndl.                     */
/*              _ (INT32) ndh.                     */
/*-----------------------------------------------------*/
/* OUTPUT ARGUMENTS : _ None.                       */
```

EP 1 214 706 B1

```
/*-----------------------------------------------------------------*/
/* RETURN ARGUMENTS : _ None.                           */
/*=================================================================*/


void free_s3tensor(INT16 ***t, INT32 nrl, INT32 nrh, INT32 ncl, INT32 nch, INT32 ndl, INT32 ndh)
{
        free((char*) (t[nrl][ncl]+ndl-1));
        free((char*) (t[nrl]+ncl-1));
        free((char*) (t+nrl-1));
}



/*-----------------------------------------------------------------*/


/*=================================================================*/
/* FUNCTIONS  :  free_l3tensor ()                  */
/*-----------------------------------------------------------------*/
/* PURPOSE    :  free a long tensor allocated with l3tensor ().  */
/*-----------------------------------------------------------------*/
/* INPUT ARGUMENTS  : _ (INT64***) t.                  */
/*               _ (INT32) nrl.            */
/*               _ (INT32) nrh.            */
/*               _ (INT32) ncl.            */
/*               _ (INT32) nch.             */
/*               _ (INT32) ndl.            */
/*               _ (INT32) ndh.            */
/*-----------------------------------------------------------------*/
/* OUTPUT ARGUMENTS : _ None.                    */
/*-----------------------------------------------------------------*/
/* RETURN ARGUMENTS : _ None.                    */
/*=================================================================*/


void free_l3tensor(INT64 ***t, INT32 nrl, INT32 nrh, INT32 ncl, INT32 nch, INT32 ndl, INT32 ndh)
{
        free((char*) (t[nrl][ncl]+ndl-1));
        free((char*) (t[nrl]+ncl-1));
        free((char*) (t+nrl-1));
}


/*-----------------------------------------------------------------*/
```

818

```
/*======================================================================*/
/* FUNCTIONS  :  free_f3tensor ()                    */
/*--------------------------------------------------------*/
/* PURPOSE    :  free a float tensor allocated with f3tensor ().  */
/*--------------------------------------------------------*/
/* INPUT ARGUMENTS :  _ (FLOAT32***) t.                    */
/*              _ (INT32) nrl.                    */
/*              _ (INT32) nrh.                    */
/*              _ (INT32) ncl.                    */
/*              _ (INT32) nch.                    */
/*              _ (INT32) ndl.                    */
/*              _ (INT32) ndh.                    */
/*--------------------------------------------------------*/
/* OUTPUT ARGUMENTS :  _ None.                    */
/*--------------------------------------------------------*/
/* RETURN ARGUMENTS :  _ None.                    */
/*======================================================================*/


void free_f3tensor(FLOAT32 ***t, INT32 nrl, INT32 nrh, INT32 ncl, INT32 nch, INT32 ndl, INT32 ndh)
{
        free((char*) (t[nrl][ncl]+ndl-1));
        free((char*) (t[nrl]+ncl-1));
        free((char*) (t+nrl-1));
}


/*--------------------------------------------------------*/


/*======================================================================*/
/* FUNCTIONS  :  free_d3tensor ()                    */
/*--------------------------------------------------------*/
/* PURPOSE    :  free a double tensor allocated with d3tensor ().  */
/*--------------------------------------------------------*/
/* INPUT ARGUMENTS :  _ (FLOAT64***) t.                    */
/*              _ (INT32) nrl.                    */
/*              _ (INT32) nrh.                    */
/*              _ (INT32) ncl.                    */
/*              _ (INT32) nch.                    */
/*              _ (INT32) ndl.                    */
/*              _ (INT32) ndh.                    */
/*--------------------------------------------------------*/
```

```
/* OUTPUT ARGUMENTS : _ None.                              */
/*-----------------------------------------------------*/
/* RETURN ARGUMENTS : _ None.                              */
/*=====================================================*/


void free_d3tensor(FLOAT64 ***t, INT32 nrl, INT32 nrh, INT32 ncl, INT32 nch, INT32 ndl, INT32 ndh)
{
        free((char*) (t[nrl][ncl]+ndl-1));
        free((char*) (t[nrl]+ncl-1));
        free((char*) (t+nrl-1));
}


/*-----------------------------------------------------*/


/*=====================================================*/
/* FUNCTIONS   : convert_matrix ()                         */
/*-----------------------------------------------------*/
/* PURPOSE     : allocate a float matrix m[nrl,...,nrh][ncl,...,nch] */
/*              that points to the matrix declared in the standard  */
/*              C manner as a[nrow][ncol], where nrow=nrh-nrl+1 and  */
/*              ncol=nch-ncl+1. The routine should be called with    */
/*              the address &a[0][0] as the first argument.          */
/*-----------------------------------------------------*/
/* INPUT ARGUMENTS : _ (FLOAT32*) a.                       */
/*                  _ (INT32) nrl.                         */
/*                  _ (INT32) nrh.                         */
/*                  _ (INT32) ncl.                         */
/*                  _ (INT32) nch.                         */
/*-----------------------------------------------------*/
/* OUTPUT ARGUMENTS : _ None.                              */
/*-----------------------------------------------------*/
/* RETURN ARGUMENTS : _ (FLOAT32**) pointer to array of pointers to */
/*                     rows.                               */
/*=====================================================*/


FLOAT32 **convert_matrix( FLOAT32 *a, INT32 nrl, INT32 nrh, INT32 ncl, INT32 nch)
{
        INT32 i,j,nrow,ncol;
        FLOAT32 **m;
```

```
nrow=nrh-nrl+1;
ncol=nch-ncl+1;
m = (FLOAT32 **) calloc((unsigned) (nrow),sizeof(FLOAT32*));
if (!m) nrerror("allocation failure in convert_matrix()");
m -= nrl;
for(i=0,j=nrl;i<=nrow-1;i++,j++) m[j]=a+ncol*i-ncl;
return m;

}
```

```
/*----------------------------------------------------------------*/
```

```
/*================================================================*/
/* FUNCTIONS   : free_convert_matrix ()                    */
/*----------------------------------------------------------------*/
/* PURPOSE     : free a matrix allocated by convert_matrix ().   */
/*----------------------------------------------------------------*/
/* INPUT ARGUMENTS :  _ (FLOAT32**) b.                     */
/*              _ (INT32) nrl.                */
/*              _ (INT32) nrh.                */
/*              _ (INT32) ncl.                */
/*              _ (INT32) nch.                */
/*----------------------------------------------------------------*/
/* OUTPUT ARGUMENTS :  _ None.                      */
/*----------------------------------------------------------------*/
/* RETURN ARGUMENTS :  _ None.                      */
/*================================================================*/
```

```
void free_convert_matrix( FLOAT32 **b, INT32 nrl, INT32 nrh, INT32 ncl, INT32 nch)
{
      free((char*) (b+nrl));
}
```

```
/*----------------------------------------------------------------*/
```

```
/*================================================================*/
/* FUNCTIONS    :   pdvector ()                    */
/*----------------------------------------------------------------*/
/* PURPOSE      :   Allocate a double a vector of pointers to   */
/*                 double datawith subscript range             */
```

```
/*              v [nl, ..., nh].                    */
/*-------------------------------------------------*/
/* INPUT ARGUMENTS  : _ (INT32) nl.                */
/*              _ (INT32) nh.                       */
/*-------------------------------------------------*/
/* OUTPUT ARGUMENTS : _ None.                       */
/*-------------------------------------------------*/
/* RETURN ARGUMENTS : _ (FLOAT64*): pointer to the allocated vector.*/
/*===============================================================*/


FLOAT64 **pdvector( INT32 nl, INT32 nh )
{
        FLOAT64 **v;


        /*-------------------------------------------------*/


        v = (FLOAT64 **) calloc((unsigned) (nh-nl+1), sizeof(FLOAT64 *));


        if (!v) nrerror("allocation failure in pdvector()");


        /*-------------------------------------------------*/


        return v-nl;


        /*-------------------------------------------------*/
}


/*-------------------------------------------------*/


/*===============================================================*/
/* FUNCTIONS    : free_pdvector ()                  */
/*-------------------------------------------------*/
/* PURPOSE      : free a vector of pointer to double allocated  */
/*               with pdvector ().                  */
/*-------------------------------------------------*/
/* INPUT ARGUMENTS  : _ (FLOAT64 **) v.             */
/*              _ (INT32    ) nl.                   */
/*              _ (INT32    ) nh.                   */
/*-------------------------------------------------*/
/* OUTPUT ARGUMENTS : _ None.                       */
```

```
/*-------------------------------------------------*/
/* RETURN ARGUMENTS : _ None.                      */
/*=================================================*/

void free_pdvector( FLOAT64 **v, INT32 nl, INT32 nh)
{
        /*-----------------------------------------*/

        free((char*) (v+nl));

        /*-----------------------------------------*/

        return;

        /*-----------------------------------------*/

}

/*-------------------------------------------------*/


/*=================================================*/
/*--------------------- END -----------------------*/
/*=================================================*/
```

```
/*===========================================================================*/


/*=========================================================================*/
/* Conexant System Inc.                          */
/* 4311 Jamboree Road                            */
/* Newport Beach, CA 92660                        */
/*----------------------------------------------------*/
/* Copyright(C) 2000 Conexant System Inc.            */
/*----------------------------------------------------*/
/* ALL RIGHTS RESERVED:                            */
/* No part of this software may be reproduced in any form or by any */
/* means or used to make any derivative work (such as transformation */
/* or adaptation) without the authorisation of Conexant System Inc. */
/*=========================================================================*/
/* PROTOYPE FILE: mcutil.h                         */
/*=========================================================================*/


/*----------------------------------------------------*/
/*----------------------- FUNCTIONS -----------------------*/
/*----------------------------------------------------*/


void     nrerror          ( char [] );
INT16   *svector          ( INT32, INT32 );
FLOAT32       *vector             ( INT32, INT32 );
INT32   *ivector          ( INT32, INT32 );
INT64   *lvector          ( INT32, INT32 );
FLOAT64       *dvector          ( INT32, INT32 );
FLOAT32       **matrix             ( INT32, INT32, INT32, INT32 );
INT16   **smatrix         ( INT32, INT32, INT32, INT32 );
FLOAT64       **dmatrix          ( INT32, INT32, INT32, INT32 );
INT32   **imatrix         ( INT32, INT32, INT32, INT32 );
FLOAT32       **submatrix           ( FLOAT32 **, INT32, INT32, INT32, INT32, INT32 );
INT16   ***s3tensor       ( INT32, INT32, INT32, INT32, INT32, INT32 );
INT32   ***i3tensor       ( INT32, INT32, INT32, INT32, INT32, INT32 );
INT64   ***l3tensor       ( INT32, INT32, INT32, INT32, INT32, INT32 );
FLOAT32       ***f3tensor           ( INT32, INT32, INT32, INT32, INT32, INT32 );
FLOAT64       ***d3tensor          ( INT32, INT32, INT32, INT32, INT32, INT32 );
void     free_vector      ( FLOAT32 *, INT32, INT32 );
void     free_svector     ( INT16 *, INT32, INT32 );
void     free_ivector     ( INT32 *, INT32, INT32 );
```

```
void     free_lvector               ( INT64 *, INT32, INT32 );
void     free_dvector               ( FLOAT64 *, INT32, INT32 );
void     free_matrix                ( FLOAT32 **, INT32, INT32, INT32, INT32 );
void     free_smatrix               ( INT16 **, INT32, INT32, INT32, INT32 );
void     free_dmatrix               ( FLOAT64 **, INT32, INT32, INT32, INT32 );
void     free_imatrix               ( INT32 **, INT32, INT32, INT32, INT32 );
void     free_submatrix             ( FLOAT32 **, INT32, INT32, INT32, INT32 );
void     free_i3tensor              ( INT32 ***t  , INT32, INT32, INT32, INT32, INT32, INT32 );
void     free_s3tensor              ( INT16 ***t , INT32, INT32, INT32, INT32, INT32, INT32 );
void     free_l3tensor              ( INT64 ***t , INT32, INT32, INT32, INT32, INT32, INT32 );
void     free_f3tensor              ( FLOAT32 ***t , INT32, INT32, INT32, INT32, INT32, INT32 );
void     free_d3tensor              ( FLOAT64 ***t, INT32, INT32, INT32, INT32, INT32, INT32 );


FLOAT32          **convert_matrix( FLOAT32 *, INT32, INT32, INT32, INT32 );
void     free_convert_matrix        ( FLOAT32 **, INT32, INT32, INT32, INT32 );


FLOAT64          **pdvector              ( INT32, INT32 );
void     free_pdvector     ( FLOAT64 **, INT32, INT32 );


/*===================================================================*/
/*--------------------- END ----------------------------*/
/*===================================================================*/
```

825

```
/*=====================================================================*/


    /*=================================================================*/
    /* Conexant System Inc.                          */
    /* 4311 Jamboree Road                            */
    /* Newport Beach, CA 92660                         */
    /*------------------------------------------------*/
    /* Copyright(C) 2000 Conexant System Inc.               */
    /*------------------------------------------------*/
    /* ALL RIGHTS RESERVED:                           */
    /* No part of this software may be reproduced in any form or by any */
    /* means or used to make any derivative work (such as transformation */
    /* or adaptation) without the authorisation of Conexant System Inc. */
    /*=================================================================*/
    /* FILE: typedef.h                          */
    /*=================================================================*/


#if defined(__BORLANDC__) || defined (__WATCOMC__) || defined(_MSC_VER) || defined(__ZTC__) ||
defined(__HIGHC__) || defined (__CYGWIN32__)
    typedef long  int INT64;
    typedef long  int INT32;
    typedef short int INT16;
    typedef unsigned short int UNS_INT16;
    typedef short int FLAG;
    typedef double   FLOAT64;
    typedef float    FLOAT32;
#elif defined( __sun)
    typedef long   INT64;
    typedef long   INT32;
    typedef short  INT16;
    typedef unsigned short  UNS_INT16;
    typedef int    FLAG;
    typedef double FLOAT64;
    typedef float FLOAT32;
#elif defined(__unix__) || defined(__unix)
    typedef long   INT64;
    typedef int    INT32;
    typedef short  INT16;
    typedef unsigned short  UNS_INT16;
```

```
typedef int    FLAG;
typedef double FLOAT64;
typedef float  FLOAT32;
#elif defined(VMS) || defined(__VMS)
typedef long   INT64;
typedef long   INT32;
typedef short  INT16;
typedef unsigned short  UNS_INT16;
typedef int    FLAG;
typedef double FLOAT64;
typedef float  FLOAT32;
#else
#error  COMPILER NOT TESTED typedef.h needs to be updated, see readme
#endif


/*=================================================================*/
/*------------------------- END ----------------------------*/
/*=================================================================*/
```

APPENDIX B

```
/*=================================================================*/


/*===============================================================*/
/* Conexant System Inc.                        */
/* 4311 Jamboree Road                          */
/* Newport Beach, CA 92660                      */
/*--------------------------------------------*/
/* Copyright(C) 2000 Conexant System Inc.            */
/*--------------------------------------------*/
/* ALL RIGHTS RESERVED:                        */
/* No part of this software may be reproduced in any form or by any  */
/* means or used to make any derivative work (such as transformation */
/* or adaptation) without the authorisation of Conexant System Inc.  */
/*===============================================================*/
/* LIBRARY: gain_vq.tab                        */
/*===============================================================*/


/*--------------------------------------------*/
/*--------------------- TABLES ---------------------*/
/*--------------------------------------------*/


/*===================================================================*/


/*===============================================================*/
/* Conexant System Inc.                        */
/* 4311 Jamboree Road                          */
/* Newport Beach, CA 92660                      */
/*--------------------------------------------*/
/* Copyright(C) 2000 Conexant System Inc.            */
/*--------------------------------------------*/
/* ALL RIGHTS RESERVED:                        */
/* No part of this software may be reproduced in any form or by any  */
/* means or used to make any derivative work (such as transformation */
/* or adaptation) without the authorisation of Conexant System Inc.  */
/*===============================================================*/
/* FILE: FLOAT64 gp4_tab                       */
/*===============================================================*/



FLOAT64 gp4_tab[TAB_SIZE_GVQ_4D][GVQ_VEC_SIZE_4D]={
```

```
{  0.60699869,   0.59090763,   0.64920781,   0.64610492},
{  0.68101613,   0.65403889,   0.64210982,   0.63130892},
{  0.63010482,   0.56235514,   0.65643759,   0.75672188},
{  0.68659859,   0.57330071,   0.58744429,   0.81576573},
{  0.64851060,   0.64851060,   0.71451327,   0.71451327},
{  0.77682415,   0.68550346,   0.63967832,   0.64221364},
{  0.60611942,   0.63785293,   0.74037768,   0.76724979},
{  0.70282156,   0.70854395,   0.71397421,   0.70622913},
{  0.60640355,   0.64369532,   0.78733321,   0.81281683},
{  0.79313256,   0.75678142,   0.67673117,   0.64600357},
{  0.78871769,   0.78871769,   0.67719160,   0.67719160},
{  0.78750339,   0.65818283,   0.74410403,   0.76624484},
{  0.68666216,   0.71349168,   0.80131080,   0.81487027},
{  0.81564295,   0.77007419,   0.73645773,   0.73009256},
{  0.87690114,   0.83990779,   0.69391460,   0.62411652},
{  0.78900835,   0.72676490,   0.88398786,   0.66963377},
{  0.93272369,   0.74226864,   0.62990265,   0.75901092},
{  0.76976621,   0.76976621,   0.78405048,   0.78405048},
{  0.87041644,   0.83542384,   0.72726860,   0.65975429},
{  0.98828812,   0.57828812,   0.70041292,   0.80041292},
{  0.78642005,   0.77917927,   0.79153969,   0.78921747},
{  0.72998353,   0.72998353,   0.80237917,   0.88237917},
{  0.84850899,   0.79316290,   0.76406702,   0.74795323},
{  0.86473350,   0.82733618,   0.78603639,   0.77772334},
{  0.86598073,   0.86598073,   0.76672185,   0.76672185},
{  0.75717804,   0.76443058,   0.87026008,   0.89448642},
{  0.82990895,   0.82866571,   0.84344056,   0.84482601},
{  0.73643129,   0.73643129,   0.93179791,   0.93179791},
{  0.84091377,   0.84091377,   0.84549563,   0.84549563},
{  0.96705390,   0.93530253,   0.75329477,   0.70990139},
{  0.82417511,   0.88417511,   0.90242800,   0.78242800},
{  0.90565081,   1.00565081,   0.73784063,   0.73784063},
{  0.93696854,   0.89908568,   0.80488500,   0.76745989},
{  0.88864729,   0.87038965,   0.85073556,   0.84218753},
{  0.91005475,   0.86005510,   0.85177958,   0.84228257},
{  0.73978618,   0.82370630,   0.94989275,   0.95972113},
{  0.90821062,   0.90821062,   0.84367096,   0.84367096},
{  0.82123084,   0.84572475,   0.91624881,   0.93452704},
{  0.84262163,   0.90568020,   1.05247535,   0.73518775},
{  0.89073030,   0.89054064,   0.90204609,   0.90276521},
```

```
{  0.93915442,   0.91935059,   0.88462629,   0.87035097},
{  0.94939652,   0.86939652,   1.02255193,   0.76255193},
{  1.02270617,   0.90270617,   0.75324621,   0.95324621},
{  1.06002553,   0.97431233,   0.80897117,   0.78133585},
{  0.97983378,   0.97983378,   0.87774763,   0.87774763},
{  0.93569159,   0.93248467,   0.93336567,   0.93152706},
{  1.01454689,   0.97991575,   0.89630971,   0.86870634},
{  0.90992070,   0.90992070,   0.98329006,   0.98329006},
{  0.88442519,   0.91454256,   0.99448626,   1.00440409},
{  0.84818392,   0.87818392,   1.06200101,   1.00200101},
{  0.97346962,   0.96872528,   0.96372065,   0.95989277},
{  0.97243125,   0.97243125,   0.96175669,   0.96175669},
{  1.10743055,   0.93511480,   0.94874981,   0.94701072},
{  1.08620375,   1.04782334,   0.98763661,   0.96029488},
{  1.01282321,   1.01771063,   1.03454061,   1.02876771},
{  1.13502856,   1.06918208,   0.95687290,   0.92553343},
{  0.95295916,   0.98532512,   1.09705441,   1.11982849},
{  1.03699487,   1.03699487,   1.05224994,   1.05224994},
{  0.93430309,   0.93430309,   1.15479496,   1.15479496},
{  1.10604686,   1.08604686,   1.00380677,   1.01380677},
{  1.04618964,   1.07135141,   1.13934841,   1.12350107},
{  1.13404806,   1.11671807,   1.10434958,   1.07915085},
{  1.04548516,   1.11455931,   1.17914527,   1.18008965},
{  1.18984056,   1.19371846,   1.19065201,   1.18269596},
};
```

```
/*======================================================*/
/* Conexant System Inc.                       */
/* 4311 Jamboree Road                         */
/* Newport Beach, CA 92660                      */
/*----------------------------------------------*/
/* Copyright(C) 2000 Conexant System Inc.          */
/*----------------------------------------------*/
/* ALL RIGHTS RESERVED:                         */
/* No part of this software may be reproduced in any form or by any  */
/* means or used to make any derivative work (such as transformation */
/* or adaptation) without the authorisation of Conexant System Inc.  */
/*======================================================*/
/* FILE:  FLOAT64 gainVQ_4_1024                  */
/*======================================================*/


FLOAT64 gainVQ_4_1024[MSMAX_4_1024][GVQ_VEC_SIZE_4D]= {
  {   0.32430000,   0.14200000,   0.08030000,   0.05200000},
  {   0.36890000,   0.29580000,   0.19540000,   0.20130000},
  {   0.44279383,   0.24252909,   0.20377341,   0.17139738},
  {   0.51880000,   0.18810000,   0.13810000,   0.09180000},
  {   0.45280000,   0.35830000,   0.26890000,   0.23960000},
  {   0.29830000,   0.31750000,   0.37570000,   0.40950000},
  {   0.69840000,   0.17180000,   0.11820000,   0.07790000},
  {   0.67440000,   0.31330000,   0.27020000,   0.22210000},
  {   0.37190000,   0.55970000,   0.40410000,   0.42710000},
  {   0.60470000,   0.47560000,   0.33640000,   0.31260000},
  {   0.44840000,   0.41050000,   0.52590000,   0.40260000},
  {   0.85080000,   0.26840000,   0.22640000,   0.15330000},
  {   0.22760000,   0.51290000,   0.47640000,   0.63220000},
  {   0.38560000,   0.29260000,   0.65040000,   0.58390000},
  {   0.78280000,   0.33410000,   0.33740000,   0.46220000},
  {   0.60340000,   0.67610000,   0.39840000,   0.31230000},
  {   1.02390000,   0.18590000,   0.12790000,   0.06950000},
  {   0.60076348,   0.54890494,   0.49683860,   0.46659198},
  {   0.77820000,   0.47490000,   0.50310000,   0.32480000},
  {   0.61880000,   0.56990000,   0.54730000,   0.50080000},
  {   0.95840000,   0.42240000,   0.33690000,   0.23270000},
  {   1.06343087,   0.38532917,   0.30216593,   0.23571217},
```

```
{  1.12280000,   0.32130000,   0.20780000,   0.16830000},
{  0.57490000,   0.48290000,   0.51640000,   0.80480000},
{  0.29490000,   0.65830000,   0.67120000,   0.72950000},
{  0.81590000,   0.42290000,   0.69880000,   0.44790000},
{  0.79240000,   0.70420000,   0.39600000,   0.50570000},
{  0.62280000,   0.93010000,   0.45110000,   0.40340000},
{  0.71130000,   0.86330000,   0.55250000,   0.30600000},
{  1.05480000,   0.33040000,   0.51770000,   0.40970000},
{  1.02600000,   0.62390000,   0.40110000,   0.25760000},
{  0.51780000,   0.85420000,   0.57490000,   0.58740000},
{  0.51250000,   0.62920000,   0.86850000,   0.64200000},
{  1.10550000,   0.47540000,   0.42340000,   0.45950000},
{  0.68250000,   0.62950000,   0.90900000,   0.41490000},
{  1.26220000,   0.37640000,   0.34070000,   0.22520000},
{  1.29670000,   0.44760000,   0.23550000,   0.10650000},
{  0.71590000,   0.73030000,   0.74280000,   0.64590000},
{  0.90340000,   0.53960000,   0.70500000,   0.64130000},
{  0.94510000,   0.75910000,   0.56230000,   0.50030000},
{  0.27540000,   0.71640000,   0.60050000,   1.09140000},
{  1.12840000,   0.55510000,   0.69720000,   0.34280000},
{  0.18930000,   0.48280000,   0.78730000,   1.14680000},
{  0.64500000,   0.62070000,   0.64830000,   1.01460000},
{  0.20740000,   0.50100000,   0.81480000,   1.14820000},
{  1.47870000,   0.23150000,   0.16690000,   0.13280000},
{  0.47060000,   0.86040000,   0.80580000,   0.88090000},
{  0.67860000,   1.12680000,   0.50270000,   0.63850000},
{  0.96731581,   0.75394827,   0.71442682,   0.61492700},
{  1.35010000,   0.45980000,   0.58980000,   0.11360000},
{  1.35030000,   0.45470000,   0.60810000,   0.12860000},
{  0.61140764,   0.86453614,   0.79724552,   0.82890012},
{  0.77440000,   0.93360000,   0.81210000,   0.57180000},
{  1.05750000,   0.63760000,   0.90530000,   0.39800000},
{  1.42720000,   0.51010000,   0.36410000,   0.28800000},
{  1.41080000,   0.63500000,   0.32840000,   0.15920000},
{  1.30280000,   0.60240000,   0.50470000,   0.48850000},
{  0.86310000,   0.59840000,   0.85430000,   0.85140000},
{  1.35490000,   0.60220000,   0.61180000,   0.14980000},
{  1.29950000,   0.26780000,   0.90600000,   0.29370000},
{  1.18350000,   0.90230000,   0.53350000,   0.43230000},
{  0.96680000,   0.76470000,   0.65440000,   0.88850000},
```

```
{  1.38390000,    0.71660000,    0.56500000,    0.18200000},
{  1.44150000,    0.63080000,    0.46800000,    0.39010000},
{  1.65950000,    0.27920000,    0.23040000,    0.12250000},
{  0.44480000,    1.19650000,    0.69940000,    0.91650000},
{  0.68310000,    0.95110000,    0.98140000,    0.80990000},
{  0.69990000,    0.71050000,    1.21380000,    0.74870000},
{  1.22750000,    0.82230000,    0.78270000,    0.50450000},
{  1.50050000,    0.59740000,    0.59240000,    0.33230000},
{  1.45128760,    0.70277760,    0.57587383,    0.47212700},
{  1.13050000,    0.70160000,    1.01710000,    0.59460000},
{  1.14200000,    1.01440000,    0.63490000,    0.66370000},
{  0.86640000,    1.00810000,    0.74410000,    0.97030000},
{  0.44500000,    0.77610000,    0.89920000,    1.30200000},
{  0.91890000,    0.76170000,    1.02990000,    0.92350000},
{  0.37840000,    0.95900000,    1.06580000,    1.12020000},
{  1.58210000,    0.73680000,    0.43700000,    0.48940000},
{  0.85980000,    0.65090000,    0.55700000,    1.42030000},
{  1.70680000,    0.61080000,    0.38940000,    0.27490000},
{  0.49260000,    1.05000000,    0.77620000,    1.26730000},
{  0.93960000,    1.25930000,    0.88510000,    0.55820000},
{  0.50170000,    1.05780000,    1.38500000,    0.59250000},
{  1.06890000,    1.05570000,    0.94840000,    0.71110000},
{  1.53540000,    0.60810000,    0.70450000,    0.68800000},
{  0.52570774,    0.88028826,    0.98275945,    1.30471831},
{  0.95020000,    1.23000000,    0.70460000,    0.90070000},
{  1.85160000,    0.37420000,    0.37290000,    0.19740000},
{  1.86507422,    0.42602318,    0.33349988,    0.23033006},
{  1.25050000,    0.69770000,    0.78500000,    1.08440000},
{  0.52900000,    1.32630000,    1.00830000,    0.92290000},
{  1.19690000,    1.35160000,    0.70440000,    0.47200000},
{  0.80740000,    0.66150000,    1.07080000,    1.33480000},
{  1.27090000,    0.89000000,    1.06410000,    0.72190000},
{  0.95280000,    0.93720000,    1.37500000,    0.64020000},
{  0.78310000,    0.92700000,    1.39300000,    0.85560000},
{  0.88230000,    1.10330000,    0.98310000,    1.12380000},
{  1.08538360,    1.26958825,    0.91376555,    0.82118439},
{  0.64900000,    1.09760000,    0.85080000,    1.39930000},
{  0.53500000,    0.84810000,    1.35170000,    1.21860000},
{  1.92030000,    0.48420000,    0.55650000,    0.38520000},
{  0.80070000,    1.37500000,    1.17260000,    0.74470000},
```

```
{    1.63540000,    0.74520000,    0.83340000,    0.80460000},
{    1.12160000,    0.81130000,    1.27270000,    1.01790000},
{    0.79188218,    0.96816938,    1.40843300,    1.01964496},
{    1.37600000,    0.99530000,    0.78270000,    1.05730000},
{    1.08890000,    1.17530000,    1.17350000,    0.82630000},
{    1.88390000,    0.64200000,    0.55420000,    0.62580000},
{    1.00670000,    1.03950000,    1.43910000,    0.71870000},
{    0.51050000,    1.25330000,    1.23130000,    1.16600000},
{    1.77890000,    0.88140000,    0.70760000,    0.53880000},
{    1.53260000,    1.17190000,    0.72100000,    0.75600000},
{    0.96260000,    1.10560000,    1.16360000,    1.17150000},
{    1.25210000,    1.35480000,    0.75350000,    0.96460000},
{    0.33240000,    0.71980000,    0.92090000,    1.85140000},
{    1.52927093,    0.94387728,    0.98718908,    0.86465217},
{    0.64397105,    1.46149914,    1.05233363,    1.15080731},
{    1.09258166,    1.02600551,    1.01307653,    1.31767539},
{    2.19580000,    0.34580000,    0.20740000,    0.16710000},
{    0.88180000,    1.46700000,    0.90060000,    1.13530000},
{    0.25120000,    0.97960000,    1.20030000,    1.66510000},
{    1.33380000,    1.14500000,    1.21420000,    0.82470000},
{    0.82950000,    0.99190000,    1.07290000,    1.57270000},
{    0.61390000,    1.55190000,    0.97270000,    1.26230000},
{    0.62410000,    0.95810000,    1.63870000,    1.17470000},
{    0.61080000,    1.94840000,    0.85150000,    0.73860000},
{    1.15510000,    1.46050000,    1.16890000,    0.82670000},
{    1.24210000,    1.15240000,    0.87600000,    1.37610000},
{    1.14580000,    1.48500000,    1.15940000,    0.82150000},
{    1.15560000,    1.49260000,    1.16800000,    0.80390000},
{    1.39280000,    0.85790000,    1.39110000,    1.03370000},
{    0.99230000,    1.16470000,    1.51240000,    1.02880000},
{    0.77640000,    1.37070000,    1.29010000,    1.25970000},
{    1.98670000,    1.04510000,    0.75130000,    0.49690000},
{    1.45950000,    1.55160000,    1.06300000,    0.50150000},
{    0.50750000,    1.29680000,    1.35350000,    1.48850000},
{    0.59059745,    1.09122768,    1.02782035,    1.86392129},
{    0.34540000,    0.94370000,    0.87040000,    2.08760000},
{    0.45610000,    1.40740000,    0.92180000,    1.77210000},
{    1.75360000,    1.24960000,    0.94140000,    0.82600000},
{    0.99480000,    1.64830000,    1.30450000,    0.92420000},
{    0.25740000,    1.40250000,    0.87890000,    1.85970000},
```

```
{   0.48270000,    0.85850000,    1.53020000,    1.72520000},
{   0.80110000,    1.29470000,    1.25350000,    1.55500000},
{   1.14950000,    1.79370000,    0.87410000,    1.02120000},
{   1.60460000,    0.83720000,    0.97480000,    1.45660000},
{   2.20380000,    0.99360000,    0.62840000,    0.41190000},
{   2.06250000,    0.78580000,    0.94360000,    0.83700000},
{   1.44230000,    1.23800000,    1.18820000,    1.20860000},
{   1.85530000,    0.96690000,    0.99110000,    1.07500000},
{   2.16456006,    0.95165953,    0.75498856,    0.64325462},
{   1.09320000,    1.32460000,    1.35680000,    1.33920000},
{   2.36170000,    0.75890000,    0.50860000,    0.48350000},
{   0.60630000,    1.70190000,    1.23140000,    1.38980000},
{   0.50230000,    1.19030000,    1.25370000,    1.86460000},
{   0.99930000,    1.02630000,    1.00470000,    1.91350000},
{   2.50910000,    0.51800000,    0.39210000,    0.26440000},
{   0.78960000,    1.21760000,    1.93660000,    0.96840000},
{   1.09740000,    1.33800000,    1.15750000,    1.59900000},
{   0.71933291,    1.26280819,    1.52180112,    1.58702691},
{   1.04546726,    1.64917411,    1.40294177,    1.17052588},
{   1.34690000,    1.65670000,    1.03860000,    1.31610000},
{   0.50090000,    1.30040000,    1.57560000,    1.71970000},
{   2.56780000,    0.30520000,    0.64210000,    0.61340000},
{   0.31740000,    1.37100000,    1.85150000,    1.44820000},
{   0.63090000,    1.39620000,    1.79550000,    1.43480000},
{   1.40330859,    1.13498021,    1.62829863,    1.31339665},
{   2.69822802,    0.53749854,    0.40876870,    0.30352964},
{   2.78430000,    0.22190000,    0.20170000,    0.12030000},
{   1.70740000,    1.07100000,    1.51480000,    1.24820000},
{   0.64810000,    1.43980000,    1.06370000,    2.08260000},
{   1.09190000,    0.93920000,    1.34240000,    2.03280000},
{   2.00280000,    1.22590000,    1.13890000,    1.10010000},
{   1.15600000,    1.10170000,    1.83630000,    1.46950000},
{   0.36520000,    1.11520000,    1.31280000,    2.24210000},
{   0.62980000,    1.79830000,    1.12150000,    1.80860000},
{   1.67550000,    1.63840000,    1.32570000,    1.07460000},
{   0.26770000,    1.28180000,    0.18830000,    2.58420000},
{   2.05420000,    1.33040000,    1.33120000,    0.81850000},
{   0.36900000,    1.54200000,    1.30330000,    2.05770000},
{   1.53350000,    1.44230000,    1.51650000,    1.33600000},
{   0.92410000,    1.48880000,    1.64380000,    1.65800000},
```

```
{   1.32010000,    1.46880000,    1.46620000,    1.60380000},
{   0.84550000,    1.25590000,    1.59020000,    1.95220000},
{   2.20280000,    0.62690000,    1.38210000,    1.23260000},
{   2.62860000,    0.86670000,    0.84090000,    0.55930000},
{   1.74521323,    1.68473201,    1.17310799,    1.19609837},
{   1.51660000,    1.31360000,    1.88260000,    1.06480000},
{   0.79670000,    1.90030000,    1.73850000,    1.19910000},
{   0.98680000,    1.96410000,    1.16900000,    1.58870000},
{   2.49300000,    0.93570000,    0.82930000,    0.99100000},
{   1.03560000,    2.49260000,    0.94040000,    0.77390000},
{   0.56790000,    1.71420000,    1.55150000,    1.76090000},
{   0.44640000,    1.28630000,    1.81120000,    2.00020000},
{   1.05501900,    1.35801114,    1.27260523,    2.15449016},
{   1.13112081,    1.67490345,    1.49138960,    1.71113831},
{   1.54680000,    2.19610000,    1.21040000,    0.78050000},
{   2.96060000,    0.49720000,    0.51650000,    0.24180000},
{   1.20280000,    1.53980000,    1.23680000,    2.00120000},
{   1.21350000,    1.88360000,    1.72810000,    1.19320000},
{   2.30360000,    0.95850000,    1.21350000,    1.32840000},
{   0.59556365,    1.84799025,    1.42610766,    1.91755447},
{   0.83321592,    1.40566585,    2.15888097,    1.49523955},
{   2.54450000,    1.24210000,    0.91270000,    0.92510000},
{   2.26382744,    1.11917483,    1.39125540,    1.18438389},
{   0.70850000,    0.89840000,    1.26410000,    2.62000000},
{   2.14970000,    2.02550000,    0.85480000,    0.73730000},
{   1.98930000,    1.70300000,    1.46450000,    1.02370000},
{   1.64300000,    1.07540000,    1.77540000,    1.74840000},
{   0.54818095,    1.29470060,    1.81506779,    2.19994573},
{   0.92708840,    2.44326143,    1.24275146,    1.37688712},
{   0.37490000,    1.30980000,    1.52320000,    2.47770000},
{   1.39060000,    1.65500000,    1.48990000,    1.85690000},
{   0.85390000,    1.46700000,    1.67710000,    2.16850000},
{   0.32570000,    1.00200000,    2.09300000,    2.25460000},
{   2.21400000,    1.30480000,    1.19010000,    1.62460000},
{   0.62790000,    1.82040000,    1.36740000,    2.26360000},
{   1.14380000,    2.56880000,    1.16950000,    1.19580000},
{   1.35690000,    1.50710000,    1.94870000,    1.67750000},
{   0.53382826,    1.34692112,    1.33846227,    2.61907917},
{   0.91950000,    1.87320000,    1.63080000,    1.95190000},
{   1.41370000,    1.99910000,    1.54820000,    1.56130000},
```

```
{    0.57330000,    1.55750000,    2.19030000,    1.81220000},
{    1.06640000,    1.19880000,    1.09660000,    2.66680000},
{    2.87763286,    1.17630394,    0.87725081,    0.67950354},
{    1.89720000,    1.52950000,    1.72370000,    1.41750000},
{    0.49710000,    2.07990000,    1.74510000,    1.82260000},
{    2.27530000,    1.30140000,    1.61000000,    1.25190000},
{    1.05320000,    2.98950000,    0.94780000,    0.42250000},
{    1.82500000,    0.89410000,    2.29520000,    1.32420000},
{    1.99440000,    2.02900000,    1.25500000,    1.21920000},
{    2.72010000,    1.23850000,    1.31850000,    0.82520000},
{    1.04180000,    1.03520000,    2.39880000,    1.85630000},
{    1.01960000,    1.70500000,    2.27600000,    1.49890000},
{    0.69140000,    1.07550000,    2.71090000,    1.62580000},
{    1.11170000,    1.33550000,    1.82040000,    2.32830000},
{    0.38540000,    1.18850000,    3.11230000,    0.82370000},
{    1.73090000,    1.33730000,    1.05690000,    2.47140000},
{    0.72310000,    2.46130000,    1.27490000,    1.97000000},
{    1.77267981,    1.53066279,    1.77476873,    1.86776062},
{    0.20970000,    2.49020000,    0.95900000,    2.25440000},
{    3.42700000,    0.58010000,    0.48280000,    0.32410000},
{    3.32030000,    0.99090000,    0.54120000,    0.36710000},
{    0.73390000,    1.90270000,    2.19690000,    1.88990000},
{    1.42540000,    1.79240000,    1.59520000,    2.19790000},
{    1.45050000,    1.62280000,    2.53820000,    1.20120000},
{    1.34900000,    2.51420000,    1.32760000,    1.66820000},
{    3.00300000,    1.08510000,    0.79270000,    1.36770000},
{    2.04850000,    1.78870000,    2.04840000,    1.05170000},
{    3.27310000,    0.80220000,    0.90830000,    0.80130000},
{    3.57010000,    0.30230000,    0.14250000,    0.08090000},
{    0.66950000,    2.05640000,    1.59920000,    2.40270000},
{    1.23889924,    1.37970849,    2.03314994,    2.33416827},
{    0.54840000,    1.39700000,    2.05660000,    2.56930000},
{    1.01880000,    2.21560000,    1.85000000,    1.94130000},
{    0.42680000,    1.62100000,    1.50320000,    2.86480000},
{    1.36709992,    1.92118067,    2.22931649,    1.71369806},
{    2.17150000,    1.72310000,    1.62620000,    1.79850000},
{    0.34030000,    2.60550000,    2.19540000,    1.36160000},
{    0.80558445,    1.92562060,    1.92905300,    2.35004900},
{    0.86223532,    2.45299816,    2.09373970,    1.63564470},
{    1.46710000,    2.28960000,    1.90360000,    1.70410000},
```

```
{    2.06030000,    2.53950000,    1.37030000,    1.16470000},
{    1.39681009,    2.23624337,    1.59579505,    2.11859260},
{    0.70220000,    1.77930000,    1.86580000,    2.61670000},
{    1.59210000,    1.65920000,    2.13170000,    2.04110000},
{    2.81710000,    1.21130000,    1.56300000,    1.47370000},
{    3.11440000,    1.62880000,    1.05310000,    0.82840000},
{    3.68599039,    0.60027243,    0.45011433,    0.33293751},
{    1.13830000,    1.64660000,    2.11410000,    2.41100000},
{    0.61210000,    1.89580000,    2.17130000,    2.37840000},
{    0.82010000,    1.75570000,    1.49690000,    2.89000000},
{    1.57880000,    2.22260000,    1.38510000,    2.25820000},
{    2.45254708,    1.52077343,    1.66535997,    1.83881345},
{    1.17305500,    1.30821566,    3.02978788,    1.52576780},
{    0.66534571,    1.41610565,    2.49625697,    2.46286253},
{    0.29560000,    1.14340000,    1.43040000,    3.37700000},
{    2.12390000,    2.11310000,    1.34410000,    2.03950000},
{    1.63091403,    1.31355448,    1.36763493,    2.95784307},
{    1.09370000,    1.19610000,    1.62170000,    3.13210000},
{    2.16730000,    1.93040000,    2.27320000,    1.25240000},
{    1.53630000,    1.19450000,    2.13630000,    2.63770000},
{    2.53430000,    1.14700000,    2.18010000,    1.72400000},
{    1.77780000,    1.73710000,    1.84070000,    2.43220000},
{    1.20260000,    2.24720000,    1.57010000,    2.59170000},
{    0.48600000,    1.61790000,    2.67430000,    2.38210000},
{    1.43140000,    1.96990000,    2.52130000,    1.86980000},
{    2.09620000,    2.25920000,    1.87530000,    1.67370000},
{    1.15910000,    2.57100000,    2.26780000,    1.72330000},
{    1.05110000,    1.59620000,    3.13560000,    1.64660000},
{    3.99570000,    0.36520000,    0.27530000,    0.20870000},
{    3.77120000,    0.70730000,    0.95870000,    0.77500000},
{    1.40570000,    2.26260000,    2.01590000,    2.25500000},
{    0.65045973,    1.51699407,    2.01006662,    3.08315725},
{    0.96940000,    1.94710000,    2.52800000,    2.30090000},
{    3.07564375,    1.96246650,    1.34859928,    1.15172073},
{    0.70370000,    2.90160000,    1.58210000,    2.25630000},
{    0.37930000,    1.39650000,    2.33010000,    3.03640000},
{    3.21830000,    1.50100000,    1.57160000,    1.29830000},
{    0.81130000,    2.10070000,    1.89350000,    2.90340000},
{    1.24050000,    1.51440000,    1.77690000,    3.17980000},
{    1.67270000,    1.55850000,    2.55210000,    2.32360000},
```

```
{   0.43120000,    2.29240000,    2.37580000,    2.46470000},
{   0.91179847,    2.20528942,    1.69591433,    2.94367275},
{   0.76980000,    1.47560000,    3.08920000,    2.23530000},
{   0.84540000,    1.46810000,    2.49510000,    2.89170000},
{   0.74922509,    1.32090681,    1.27684752,    3.67788317},
{   0.46110000,    1.39270000,    1.65670000,    3.55550000},
{   1.36650000,    1.44440000,    1.00350000,    3.55690000},
{   3.67050517,    1.23688828,    1.20357381,    1.07900474},
{   1.12660000,    2.68590000,    2.10440000,    2.19800000},
{   1.89750000,    1.58590000,    2.82200000,    1.93260000},
{   2.24697910,    2.38873518,    1.97435359,    1.81077415},
{   0.38450000,    2.16850000,    1.74270000,    3.17540000},
{   4.20690000,    0.42420000,    0.42380000,    0.08250000},
{   4.11470000,    0.71740000,    0.68790000,    0.38480000},
{   1.70090000,    1.85320000,    2.32140000,    2.53040000},
{   2.04930000,    2.25220000,    2.13630000,    2.07340000},
{   2.84720000,    1.82540000,    1.67010000,    1.98800000},
{   1.40590000,    1.39600000,    3.16130000,    2.08190000},
{   0.96535206,    2.12754427,    2.68415919,    2.39247721},
{   1.48550000,    2.21360000,    2.04320000,    2.67020000},
{   0.40140000,    3.23100000,    2.12180000,    1.81980000},
{   3.42710000,    1.05860000,    2.28540000,    0.62540000},
{   0.18650000,    3.17660000,    0.82310000,    2.77610000},
{   0.78310000,    2.85280000,    2.63020000,    1.72540000},
{   0.51340000,    1.68440000,    1.91020000,    3.46540000},
{   0.99250000,    2.07730000,    2.42260000,    2.80170000},
{   1.52534714,    1.61117427,    2.95395695,    2.32829275},
{   1.57610859,    2.18452774,    2.25616952,    2.62507013},
{   0.89851630,    2.76341067,    2.10694623,    2.55056387},
{   2.97550000,    2.50580000,    1.72340000,    1.23640000},
{   1.35510000,    1.77910000,    3.65410000,    1.13780000},
{   1.53930000,    3.26830000,    1.77780000,    2.02230000},
{   0.95750000,    2.91210000,    2.26980000,    2.41370000},
{   0.62880000,    2.55740000,    2.45470000,    2.72430000},
{   4.17300000,    1.06450000,    1.04760000,    0.86520000},
{   1.14310000,    2.37170000,    1.82320000,    3.19750000},
{   1.58370199,    2.96836003,    2.27706073,    2.03240403},
{   2.43176411,    1.82966247,    2.78432482,    1.90889963},
{   1.86490000,    2.69770000,    2.52130000,    1.88470000},
{   2.10760000,    1.56670000,    3.54160000,    1.18690000},
```

```
{    3.75830000,    1.26570000,    1.94980000,    1.19300000},
{    0.86350000,    2.57800000,    3.12820000,    1.96290000},
{    1.51580000,    1.60850000,    2.22840000,    3.37700000},
{    3.94730000,    1.77810000,    1.28310000,    0.94200000},
{    3.42344413,    1.55540578,    1.09618002,    2.47782213},
{    0.66041540,    2.18915841,    2.58578828,    3.09596781},
{    0.60980000,    2.59460000,    1.37490000,    3.55740000},
{    0.62668390,    1.92562803,    2.11258815,    3.63723237},
{    0.74780000,    1.72330000,    1.88370000,    3.83750000},
{    1.61350000,    1.00520000,    4.01880000,    1.46700000},
{    3.23495541,    1.72163945,    2.59655973,    1.33940018},
{    0.38850000,    1.39810000,    2.51490000,    3.69950000},
{    0.62870000,    1.89250000,    2.70220000,    3.30330000},
{    3.18290000,    2.25710000,    1.91820000,    1.82310000},
{    0.96400000,    1.24870000,    2.82850000,    3.42770000},
{    1.77380000,    2.07210000,    2.52890000,    2.90830000},
{    1.50940000,    2.24310000,    3.07870000,    2.35840000},
{    2.11150000,    2.55510000,    1.75050000,    2.89690000},
{    1.26400000,    2.77440000,    2.62980000,    2.49940000},
{    2.61330000,    1.45850000,    1.97670000,    3.09830000},
{    2.13990000,    1.94870000,    2.85930000,    2.46960000},
{    3.23675679,    1.72320543,    1.97852723,    2.34190916},
{    4.76008462,    0.33310464,    0.27903439,    0.14962236},
{    1.19760000,    2.39550000,    2.64150000,    3.00350000},
{    0.73033089,    1.53066461,    3.39605347,    2.96404732},
{    0.64980000,    4.55530000,    1.04050000,    0.97930000},
{    2.16740000,    1.56460000,    3.43890000,    2.06460000},
{    0.82740000,    1.57650000,    3.51060000,    2.81690000},
{    2.72160000,    3.10920000,    2.08700000,    1.42710000},
{    1.31790000,    1.12640000,    1.24000000,    4.37700000},
{    0.69324727,    2.26567608,    1.45969963,    4.00667818},
{    0.50530000,    2.16930000,    1.40940000,    4.12580000},
{    1.11210000,    2.87040000,    1.88010000,    3.31050000},
{    0.66630000,    2.82910000,    2.45110000,    3.10110000},
{    1.33590000,    2.89490000,    3.68240000,    0.65810000},
{    2.93090000,    2.38840000,    2.07860000,    2.36470000},
{    1.28667958,    2.04826107,    2.65566781,    3.41804337},
{    3.94810000,    1.80510000,    1.66920000,    1.72480000},
{    2.62115775,    1.36101297,    2.48365661,    3.12389449},
{    0.96340000,    2.19290000,    3.22950000,    2.93730000},
```

```
{   2.22410000,    3.34520000,    1.92750000,    2.22420000},
{   1.34990000,    2.55940000,    3.38100000,    2.25480000},
{   3.98355945,    1.62050242,    1.86586909,    1.75003931},
{   1.45670000,    1.96900000,    2.46570000,    3.60150000},
{   3.29180000,    0.57080000,    0.94640000,    3.62270000},
{   1.14401268,    2.35151050,    3.56543838,    2.39104454},
{   2.05950000,    3.34370000,    2.61720000,    1.75590000},
{   1.87540000,    1.98800000,    1.73030000,    3.87560000},
{   3.38890000,    1.81050000,    1.78110000,    2.79100000},
{   3.29220000,    1.36330000,    3.16320000,    1.77060000},
{   3.18027283,    1.45944882,    1.71626835,    3.27811030},
{   1.93300775,    2.95380479,    2.14151386,    3.00884031},
{   0.81990000,    2.46050000,    2.15850000,    3.86990000},
{   1.14122290,    3.68786928,    1.67502304,    2.94593763},
{   4.55780000,    1.41040000,    1.67570000,    1.05670000},
{   2.04350000,    2.88820000,    2.26570000,    3.01880000},
{   0.73210000,    1.30000000,    2.88790000,    4.04000000},
{   0.68450000,    3.63810000,    2.57410000,    2.56440000},
{   1.25130000,    2.48210000,    2.80700000,    3.37540000},
{   1.22334247,    2.93218987,    2.87129861,    2.97077885},
{   4.15430000,    2.62750000,    1.52140000,    0.87560000},
{   4.00998503,    2.44785350,    1.91086193,    1.26495926},
{   0.96334199,    3.67493280,    2.53065106,    2.55194596},
{   1.86980000,    2.73670000,    3.53870000,    1.97080000},
{   2.09590000,    2.38780000,    2.88250000,    3.00680000},
{   0.51105028,    0.95473004,    4.82149731,    1.76786886},
{   0.79809573,    1.73747912,    3.08641885,    3.79319320},
{   0.61920315,    1.56245166,    2.03613905,    4.54355831},
{   0.80690000,    2.93290000,    2.85130000,    3.20020000},
{   5.07533511,    1.11492899,    0.76600689,    0.58857315},
{   0.88400000,    2.94980000,    3.38330000,    2.65950000},
{   0.83560000,    2.01790000,    2.22550000,    4.28230000},
{   3.26488329,    2.53220768,    2.39822027,    2.31965482},
{   5.15360000,    1.03590000,    0.69850000,    0.30780000},
{   0.47680000,    2.01850000,    2.88800000,    3.95730000},
{   1.86250000,    3.63570000,    2.53310000,    2.32350000},
{   2.32650000,    1.64910000,    3.97760000,    2.15240000},
{   1.31220000,    2.84950000,    2.52880000,    3.51660000},
{   3.73900000,    3.03360000,    1.57910000,    1.71230000},
{   1.03140000,    1.76600000,    4.09070000,    2.77620000},
```

```
{   2.55040000,    3.02110000,    3.03810000,    2.02110000},
{   1.56630000,    2.27920000,    2.12510000,    4.20290000},
{   0.80128484,    3.20209641,    2.11458149,    3.80989857},
{   2.75810000,    2.61700000,    2.52250000,    3.01760000},
{   1.56170520,    2.51828258,    2.37504668,    3.94070071},
{   1.32800000,    2.01560000,    3.37940000,    3.59480000},
{   0.81991044,    2.74699922,    2.83105528,    3.74056560},
{   2.58517545,    2.41831906,    3.32046360,    2.63086107},
{   1.22610000,    3.16100000,    1.83930000,    3.94990000},
{   0.58860000,    3.34140000,    1.53090000,    4.08610000},
{   3.21800000,    2.89890000,    2.62590000,    2.25470000},
{   1.53063335,    2.00389576,    3.74615530,    3.22482145},
{   0.73982063,    2.21496390,    2.57762397,    4.32390171},
{   2.78358948,    3.74601756,    2.30742134,    1.93518870},
{   5.43400000,    1.00760000,    0.56080000,    0.46840000},
{   0.62260000,    3.56230000,    4.22540000,    0.41350000},
{   1.02070000,    2.48650000,    2.65140000,    4.11070000},
{   2.19711701,    1.95745934,    3.03561042,    3.64705327},
{   1.27560000,    3.48400000,    2.79200000,    3.10450000},
{   2.38060000,    2.13400000,    3.69000000,    2.71690000},
{   4.05209972,    2.97601237,    1.05845013,    2.20333198},
{   1.41410000,    3.00250000,    3.56970000,    2.76670000},
{   0.78509386,    2.56013083,    3.49976941,    3.50728587},
{   0.32550000,    3.48650000,    3.46410000,    2.75360000},
{   0.59520000,    2.45070000,    2.79830000,    4.20350000},
{   3.87180000,    1.52880000,    2.96370000,    2.40460000},
{   1.40848596,    4.29965314,    2.83277234,    1.85370326},
{   0.86360000,    2.30210000,    2.02710000,    4.67130000},
{   2.08470000,    3.65530000,    2.68660000,    2.69140000},
{   1.29520000,    2.61240000,    2.78910000,    4.00780000},
{   1.33671645,    3.62780768,    3.60451483,    2.09970850},
{   0.58190000,    0.85490000,    5.50760000,    1.03020000},
{   1.83990000,    3.33240000,    2.04680000,    3.74140000},
{   1.37853169,    4.85910095,    2.17229283,    1.59148523},
{   0.57161173,    1.94082970,    4.37862081,    3.10624563},
{   1.75980000,    4.12590000,    2.83200000,    2.24320000},
{   4.82590000,    2.25190000,    2.00940000,    0.89920000},
{   1.69460000,    3.02990000,    3.65540000,    2.82720000},
{   2.09890000,    3.08470000,    3.54600000,    2.63500000},
{   0.87630000,    2.93340000,    3.12870000,    3.78810000},
```

```
{   2.18650000,     1.79660000,     4.22310000,     2.79610000},
{   1.67344150,     0.81455177,     5.43940756,     0.90626129},
{   0.72940000,     1.75350000,     1.50550000,     5.32680000},
{   2.00440000,     2.88580000,     3.10610000,     3.50850000},
{   1.41916748,     2.63672001,     3.30211908,     3.80230884},
{   0.53660000,     1.74370000,     4.91290000,     2.67730000},
{   3.99540000,     3.24990000,     2.19120000,     2.05650000},
{   3.31361447,     1.99125651,     2.36964801,     3.89028633},
{   1.23957085,     1.68046134,     2.76294455,     4.90581248},
{   0.64230000,     2.47180000,     3.96360000,     3.72930000},
{   0.30620000,     1.85530000,     2.54970000,     5.11440000},
{   4.93780000,     1.02110000,     1.07490000,     3.10510000},
{   5.08416611,     2.69266311,     1.28280505,     1.21614623},
{   1.06202757,     3.23024339,     3.98737130,     3.01629803},
{   1.85270000,     3.64740000,     3.59020000,     2.63670000},
{   0.42090000,     2.28950000,     3.00040000,     4.70910000},
{   6.02390000,     0.55130000,     0.43540000,     0.29940000},
{   2.45192326,     1.27458394,     5.09054783,     1.82353777},
{   2.36859242,     2.87308793,     2.34889970,     4.21827325},
{   6.06878102,     0.52032041,     0.27836222,     0.17747753},
{   0.79655073,     3.61273913,     3.09842639,     3.76228895},
{   0.83310000,     2.82610000,     2.57390000,     4.72600000},
{   5.73680000,     1.78970000,     0.96460000,     0.81660000},
{   0.58407500,     1.84587724,     5.51249561,     1.93870128},
{   5.90110000,     1.47060000,     0.82040000,     0.62560000},
{   5.27372066,     1.95474391,     2.08813292,     1.44696665},
{   4.29324640,     0.99574963,     3.67595988,     2.27814963},
{   1.58583128,     3.50477846,     2.85482397,     3.90040356},
{   2.92780000,     2.06760000,     2.60230000,     4.32290000},
{   2.95790000,     3.14450000,     2.62950000,     3.57840000},
{   0.81834272,     2.87245938,     2.75295959,     4.72288374},
{   2.06730000,     3.19430000,     2.99680000,     3.94410000},
{   0.69103962,     2.09490823,     2.07533947,     5.47096960},
{   1.06787758,     2.54948360,     4.93249276,     2.70387501},
{   0.84177292,     2.34414462,     4.25769786,     3.87569075},
{   2.82920000,     2.28550000,     3.94430000,     3.26140000},
{   2.36390000,     1.86180000,     5.07850000,     2.18120000},
{   0.65489458,     2.25669250,     3.20732270,     4.88338271},
{   1.25106359,     4.65043045,     3.52244164,     2.03890043},
{   1.82056859,     4.33030509,     2.86284938,     3.08333608},
```

```
{    4.37190892,    3.22778677,    1.92061395,    2.63155550},
{    2.83983941,    1.25029093,    3.74029839,    4.06793610},
{    6.33440000,    0.20610000,    0.18340000,    0.07240000},
{    1.96460000,    4.14700000,    2.89830000,    3.29460000},
{    2.68902407,    3.36225081,    4.46315484,    1.37878565},
{    1.42930000,    3.63160000,    3.30210000,    3.77640000},
{    0.70630000,    3.54960000,    3.29080000,    4.06750000},
{    2.84011995,    1.63505747,    4.61551440,    2.94856695},
{    3.65141071,    1.33548270,    1.58514901,    4.81007096},
{    0.71878761,    3.18202357,    2.11465505,    5.06695686},
{    1.75150000,    1.18490000,    2.99670000,    5.23270000},
{    4.73153889,    3.11406144,    2.33970423,    1.86251529},
{    4.65127395,    2.01181917,    3.25468045,    2.18044744},
{    3.61183309,    3.54603755,    2.63541011,    2.92819326},
{    0.92680000,    2.20390000,    3.19860000,    5.02150000},
{    2.56503216,    1.58975653,    2.60967534,    5.03269844},
{    3.34320000,    4.03360000,    2.12130000,    3.06690000},
{    2.91820207,    3.26652531,    3.22688812,    3.47625388},
{    1.14890000,    2.56140000,    3.95150000,    4.32590000},
{    2.33193530,    2.78844872,    4.85525658,    2.33572626},
{    1.70380383,    1.89138318,    5.20960374,    2.97871515},
{    1.29468463,    2.48073368,    3.68984850,    4.59198055},
{    0.75150000,    2.30010000,    5.12440000,    3.24270000},
{    2.43660000,    4.03490000,    2.78280000,    3.55950000},
{    1.39571596,    2.98717298,    5.31293823,    1.88456673},
{    0.42260000,    2.03090000,    2.70920000,    5.57090000},
{    2.28560000,    3.06910000,    4.07370000,    3.39390000},
{    1.54900000,    3.36760000,    4.40450000,    3.14580000},
{    0.54330000,    2.32260000,    1.63890000,    5.89780000},
{    0.52120000,    1.69440000,    4.77190000,    4.16630000},
{    1.13533825,    4.21336258,    3.35039205,    3.62398879},
{    4.76010000,    2.53950000,    3.16580000,    2.06660000},
{    2.19344627,    3.43219256,    4.03262765,    3.25957476},
{    2.07480000,    3.62880000,    2.53270000,    4.42860000},
{    1.48670000,    1.58540000,    4.75710000,    4.01830000},
{    3.94542427,    1.66762709,    4.60522500,    1.99800769},
{    0.98170000,    3.19900000,    3.54280000,    4.48010000},
{    3.47310000,    3.85340000,    3.04650000,    2.78760000},
{    0.96020000,    3.35330000,    2.66210000,    4.98370000},
{    1.75470000,    2.91190000,    4.25020000,    3.80990000},
```

```
{    3.23533192,    1.78075003,    5.13125190,    2.07635214},
{    2.98960000,    3.27590000,    3.47410000,    3.61430000},
{    3.71170000,    3.12140000,    2.24830000,    4.03450000},
{    0.83160540,    5.27080821,    2.34385364,    3.33209484},
{    0.87220000,    3.25440000,    1.70760000,    5.55630000},
{    5.88160000,    1.96120000,    1.98250000,    1.69550000},
{    3.74031025,    2.84627624,    4.31810366,    2.20077353},
{    2.52374471,    2.53443727,    2.06814049,    5.34249457},
{    0.86920000,    2.05700000,    3.87540000,    5.09560000},
{    0.89340000,    4.19870000,    3.46330000,    3.95430000},
{    1.04736786,    3.28184828,    3.80030221,    4.48701367},
{    3.13043324,    4.41084229,    3.63023782,    2.05619319},
{    0.65966102,    2.16674527,    4.18144183,    4.92740563},
{    6.57983288,    1.40124660,    0.96786416,    0.85867058},
{    3.35074877,    2.75183379,    4.48829525,    2.82973677},
{    1.27764018,    3.34726470,    2.68655894,    5.19887799},
{    0.75751911,    1.75396851,    2.25633391,    6.22409454},
{    1.25000000,    4.62890000,    4.33260000,    2.41310000},
{    0.62940000,    3.16160000,    3.43410000,    5.06030000},
{    2.45350000,    3.75020000,    3.84530000,    3.59470000},
{    4.87626497,    2.56036558,    2.45779634,    3.42594829},
{    0.98093726,    2.08646156,    5.44679975,    3.66584299},
{    2.33936922,    2.45815422,    3.16505020,    5.19117839},
{    3.95671149,    4.35419644,    2.86804508,    2.41211706},
{    2.35120000,    2.74980000,    3.49010000,    4.85120000},
{    2.53763044,    2.47313728,    5.71954141,    1.88679211},
{    1.74477118,    3.08104358,    4.47236303,    4.06142477},
{    0.80260000,    2.59630000,    4.23390000,    4.88340000},
{    4.25070000,    2.52830000,    3.79050000,    3.28040000},
{    1.06014378,    4.48295498,    4.21073676,    3.34387977},
{    1.25800000,    5.14240000,    3.26050000,    3.39630000},
{    3.00991094,    4.38850915,    2.93409343,    3.65165489},
{    0.83779322,    3.91360870,    3.29054241,    4.89145670},
{    0.94729704,    2.69844817,    4.97688102,    4.23372361},
{    0.95990000,    3.11660000,    4.86420000,    4.09760000},
{    2.65720000,    2.50210000,    4.66650000,    4.00880000},
{    2.39358827,    4.23570202,    2.73723567,    4.47274600},
{    4.82560000,    3.23690000,    3.64730000,    2.07680000},
{    3.35848505,    2.07937403,    4.26952516,    4.22710761},
{    7.13930000,    0.63680000,    0.68290000,    0.26020000},
```

```
{   0.86360000,    3.41520000,    2.41750000,    5.83370000},
{   0.88786330,    2.31985683,    3.30707266,    5.93670451},
{   1.35105752,    2.25352076,    6.13801118,    2.79824132},
{   6.46725843,    2.59934414,    1.22993150,    1.52384793},
{   2.83080000,    3.78080000,    3.01180000,    4.59890000},
{   1.98640000,    3.49750000,    3.49800000,    4.92290000},
{   1.25427821,    4.14099769,    5.12550743,    2.80090203},
{   1.79632249,    4.12473829,    3.90350471,    4.19774142},
{   1.74950000,    4.45070000,    3.52330000,    4.27160000},
{   3.36830000,    2.47820000,    1.86270000,    5.71510000},
{   1.16340000,    2.94620000,    4.03690000,    5.26660000},
{   6.08168511,    2.06159119,    2.59760812,   -2.46738713},
{   6.00380000,    3.17760000,    2.26150000,    1.69430000},
{   1.87097762,    1.66186174,    5.66704574,    4.01505658},
{   1.13942515,    4.92995903,    3.01265234,    4.49908189},
{   1.13599002,    3.76458773,    4.85215715,    3.99237659},
{   2.43338062,    4.56185058,    4.30232241,    3.12435691},
{   0.98210000,    3.51220000,    4.36150000,    4.78210000},
{   2.21852398,    4.32542442,    5.24655839,    2.01304070},
{   1.89539186,    3.62961827,    3.34033346,    5.24982067},
{   1.55167113,    2.97316140,    2.36098436,    6.25179618},
{   1.27760000,    2.87500000,    3.61290000,    5.76000000},
{   5.08750000,    3.98500000,    3.30870000,    1.85940000},
{   7.27884130,    0.43634440,    1.19087294,    1.28602147},
{   5.04580000,    2.67300000,    2.90250000,    3.98090000},
{   0.95598487,    3.57483341,    5.79884845,    3.11644411},
{   2.00200000,    2.84520000,    5.57680000,    3.72390000},
{   0.75802169,    3.49915542,    3.41138838,    5.74028008},
{   0.67849510,    2.00708481,    6.98162116,    2.05146073},
{   7.39726170,    1.25672874,    0.78634411,    0.74244139},
{   1.32780000,    1.33310000,    5.67880000,    4.65880000},
{   3.96910000,    2.51670000,    3.41660000,    4.87720000},
{   0.80357940,    2.88161482,    4.14131463,    5.61858173},
{   0.91250000,    2.10780000,    3.51560000,    6.32990000},
{   0.60779465,    2.80880035,    2.98099351,    6.39145735},
{   2.72247506,    3.12542020,    4.16791135,    4.84392556},
{   1.46740000,    3.82300000,    5.06350000,    3.96880000},
{   0.83620000,    1.59670000,    6.46550000,    3.65070000},
{   0.57500818,    0.94499890,    7.23442796,    2.22807746},
{   2.41430000,    5.02900000,    3.54340000,    3.86070000},
```

```
{   3.83043148,    3.53651179,    4.26399631,    3.65112635},
{   0.40580662,    1.69759804,    2.09269962,    7.16427115},
{   7.62126692,    0.61037761,    0.49868253,    0.22652113},
{   1.80006813,    1.51991392,    1.18641710,    7.20856992},
{   0.78890077,    3.49779039,    2.52692026,    6.30751374},
{   1.14190000,    2.39680000,    5.54210000,    4.63100000},
{   6.43706349,    2.32429301,    2.13960614,    2.91797811},
{   4.63790156,    3.35933359,    3.90938881,    3.45367361},
{   7.64850000,    0.75530000,    0.82330000,    0.61570000},
{   1.68271536,    2.27970327,    4.51399560,    5.63405952},
{   4.66340000,    1.92330000,    4.92400000,    3.24680000},
{   0.76463354,    1.11363357,    6.04482209,    4.72046674},
{   0.50380000,    2.46800000,    2.66820000,    6.87490000},
{   2.85130000,    3.28510000,    5.56670000,    3.28950000},
{   0.90860000,    4.61770000,    2.32590000,    5.79640000},
{   1.69079978,    3.16486754,    4.18771878,    5.54553607},
{   2.82496638,    3.59337709,    2.48811001,    5.87756784},
{   0.93202861,    3.91025719,    4.24521168,    5.27086141},
{   1.21270000,    2.95180000,    5.57880000,    4.59080000},
{   0.55659530,    2.91938894,    1.93771385,    7.08849726},
{   2.32410000,    4.45640000,    4.91380000,    3.66750000},
{   6.56354517,    3.45828242,    2.40487691,    1.46204629},
{   1.39481420,    1.95864980,    3.39553636,    6.78175799},
{   6.06147968,    2.30430262,    3.85349629,    2.53132522},
{   3.31308290,    3.93501851,    5.24822818,    3.06107242},
{   1.28189201,    3.49630780,    4.91269656,    5.03990293},
{   1.87110000,    4.81960000,    2.42370000,    5.55270000},
{   3.29160000,    1.88870000,    6.52260000,    2.54980000},
{   1.02577027,    6.26717017,    3.02097770,    3.79330646},
{   1.08889792,    4.76053318,    3.12725908,    5.52869854},
{   0.94890142,    2.64725255,    5.18459808,    5.43431448},
{   0.60869645,    1.66104147,    4.96642227,    6.05535654},
{   2.32501156,    4.85889731,    4.09460333,    4.37618124},
{   2.33124361,    4.13115147,    5.03832451,    4.13482425},
{   5.62670000,    3.57940000,    3.63050000,    2.72240000},
{   4.19700000,    2.15840000,    1.59240000,    6.35300000},
{   3.23570000,    2.28700000,    3.77150000,    5.95120000},
{   2.35500000,    1.31420000,    7.47490000,    1.63760000},
{   3.51240000,    3.22170000,    5.28090000,    3.90830000},
{   1.71041317,    2.21460454,    4.07049629,    6.47787010},
```

```
{   2.11300000,   3.85200000,   4.84450000,   4.87270000},
{   1.69840000,   2.54980000,   5.29430000,   5.39470000},
{   2.18880000,   4.56550000,   3.92940000,   5.05700000},
{   4.47398373,   4.50340956,   3.58449025,   3.68002318},
{   1.62780000,   4.09750000,   3.93600000,   5.68580000},
{   2.32854646,   4.37697399,   3.44268627,   5.55910428},
{   1.05221393,   5.00173427,   4.36603813,   4.70822559},
{   2.68874890,   2.25631323,   2.77983225,   6.87844782},
{   2.83360000,   4.55100000,   5.06100000,   3.63050000},
{   0.76750000,   5.49700000,   2.76150000,   5.39660000},
{   1.05210876,   5.90140772,   3.95237833,   4.20375004},
{   1.41379518,   4.56902792,   5.73150822,   3.69802958},
{   1.56540000,   4.22360000,   2.95510000,   6.35820000},
{   3.46482515,   2.69167159,   5.57198957,   4.39476063},
{   0.32788487,   4.92846336,   1.00250413,   6.66896778},
{   8.01610000,   1.01500000,   1.24210000,   1.99590000},
{   1.40965071,   3.24859511,   3.79414337,   6.62744235},
{   3.34300000,   5.07500000,   3.52970000,   4.66440000},
{   4.36383328,   0.52545936,   7.03324499,   1.69303124},
{   1.43053111,   3.42535818,   6.06395491,   4.60538222},
{   1.52553424,   4.69652916,   3.97731977,   5.65061263},
{   0.78785547,   3.40374091,   6.81701971,   3.68285553},
{   1.99643828,   1.56993227,   7.74196039,   2.43448988},
{   3.59059653,   1.10493742,   2.43114793,   7.23283747},
{   0.59157348,   2.33388011,   3.11138786,   7.56332882},
{   1.60134200,   4.96999648,   5.00033777,   4.51971684},
{   1.64715460,   3.02527827,   3.09226268,   7.16914776},
{   4.14762195,   5.66690873,   3.93081195,   2.88388851},
{   7.30991321,   2.34282240,   2.01737109,   3.17802929},
{   1.81813544,   5.81146695,   5.04057775,   3.28586763},
{   2.72500000,   4.18810000,   4.01950000,   5.68190000},
{   0.72434022,   4.46930762,   5.73036749,   4.50028370},
{   1.12271355,   2.49240949,   6.45401174,   4.96676666},
{   8.18580000,   1.25740000,   1.11490000,   2.02940000},
{   7.03134055,   1.64326599,   2.00461569,   4.31727359},
{   8.63372164,   0.59648853,   0.25332698,   0.13267083},
{   2.88343302,   5.24472346,   3.57891079,   5.13451082},
{   0.63238137,   2.96357169,   4.46461341,   6.78488039},
{   0.79300000,   3.08870000,   5.52690000,   5.87910000},
{   1.83841929,   3.89459053,   4.37188474,   6.13341834},
```

```
{   0.91034777,    7.34639828,    3.96714020,    2.21509820},
{   5.63760000,    1.89710000,    2.94260000,    5.62110000},
{   0.78936768,    4.34413774,    4.12190400,    6.34302781},
{   7.96615945,    2.19625988,    1.99605833,    2.13240970},
{   1.98143078,    1.73449291,    4.93402285,    6.77309050},
{   3.14640000,    5.61260000,    4.79230000,    3.79180000},
{   1.69972168,    2.08214425,    3.63080163,    7.63872174},
{   1.32483125,    3.17048114,    5.51070206,    6.08730243},
{   0.70967677,    3.49808735,    3.43704395,    7.40203101},
{   4.62297428,    2.82356685,    3.59430579,    6.12762489},
{   4.53330000,    4.73910000,    3.55300000,    4.92870000},
{   1.22840000,    3.70640000,    4.28130000,    6.81860000},
{   1.34928961,    1.92196756,    1.70876240,    8.46603751},
{   1.42498187,    7.16423478,    4.12999496,    3.11605446},
{   2.40047727,    3.16623823,    4.84382122,    6.43272213},
{   2.48100000,    5.33260000,    4.42190000,    5.22120000},
{   2.50150000,    6.67730000,    3.64890000,    4.23680000},
{   4.74551033,    2.15867910,    5.37583194,    5.10838658},
{   1.82390000,    4.57140000,    4.45490000,    6.27150000},
{   1.72228501,    5.90465699,    4.91117534,    4.63947570},
{   3.20810000,    4.45020000,    3.31560000,    6.51400000},
{   1.56708064,    4.57070311,    3.02755847,    7.15550803},
{   0.68148307,    2.60453842,    5.94508113,    6.42076711},
{   0.86744786,    5.67480038,    3.78103456,    6.05159981},
{   8.27156126,    3.36082584,    1.46801232,    1.50535956},
{   1.40032892,    4.30054766,    5.19078747,    6.08324039},
{   2.60722692,    4.12078931,    5.31474241,    5.71035520},
{   0.64930000,    4.10450000,    6.95650000,    4.43020000},
{   2.28980000,    4.66040000,    4.02230000,    6.51540000},
{   1.27230000,    3.49690000,    5.94890000,    6.08530000},
{   1.37639266,    5.00782932,    5.07692743,    5.81954311},
{   8.84097806,    2.00111843,    1.73112804,    1.37213075},
{   0.77910000,    4.47790000,    2.17170000,    7.91160000},
{   1.43196785,    5.12906569,    5.66872837,    5.34237086},
{   1.39041995,    2.85303302,    4.99406517,    7.35233623},
{   3.08580000,    6.88330000,    3.84090000,    4.18050000},
{   8.42319800,    2.05509723,    3.29452524,    1.76688336},
{   0.92688007,    4.04050755,    5.16138576,    6.73502941},
{   8.07521848,    3.43824000,    2.71793398,    2.34016158},
{   0.76947542,    2.08881931,    4.45080288,    8.07823273},
```

```
{    2.39837942,    5.13450154,    4.89299397,    5.83591003},
{    2.85605118,    4.97967334,    5.92350670,    4.70366764},
{    7.22200000,    1.88540000,    1.76530000,    5.60820000},
{    2.71980000,    4.01000000,    6.88780000,    4.41360000},
{    2.51716590,    3.98307107,    6.51702084,    5.07484723},
{    0.94537419,    6.88451592,    2.39514517,    6.04870988},
{    1.09245706,    4.16002330,    6.22830437,    5.79351873},
{    2.35093743,    5.86161935,    3.78206776,    6.07997328},
{    0.94850000,    5.31470000,    5.66010000,    5.48090000},
{    1.18755839,    2.46547989,    7.47799145,    5.30335101},
{    0.72777489,    3.06658013,    4.30110855,    7.94716925},
{    3.82981518,    2.52393877,    7.76001968,    3.23000876},
{    3.61010000,    4.27680000,    5.84660000,    5.12760000},
{    0.53551137,    3.15274769,    2.55147392,    8.67419909},
{    0.97926023,    2.55946697,    3.12285282,    8.66607081},
{    0.55532941,    2.19165307,    6.72824320,    6.50502937},
{    1.83760000,    2.31470000,    2.84280000,    8.71560000},
{    1.83760000,    2.31470000,    2.84280000,    8.71560000},
{    3.32083951,    4.75174962,    4.49785660,    6.26028150},
{    0.65130649,    6.90970999,    5.25399243,    4.17564007},
{    3.11438237,    5.83427486,    5.23631431,    4.70630209},
{    2.28429836,    3.03809429,    7.56678149,    4.72660390},
{    1.08165983,    3.09801020,    6.00229530,    6.89725278},
{    3.08790000,    2.42480000,    5.68320000,    6.83060000},
{    0.80320364,    4.88645184,    3.23307075,    7.71215730},
{    2.82470000,    5.50430000,    5.11480000,    5.48230000},
{    9.66457469,    0.72241715,    0.73603961,    0.38577852},
{    2.99327170,    5.54300234,    6.26703953,    3.98960049},
{    1.62140000,    5.94360000,    4.16200000,    6.29700000},
{    1.78410000,    5.15330000,    5.85290000,    5.68430000},
{    0.78120200,    1.63672160,    8.38575221,    4.80601352},
{    1.31678939,    8.01834598,    4.34605541,    3.51102864},
{    0.97820851,    4.26692920,    4.31887746,    7.74837962},
{    5.06340000,    4.17620000,    6.01510000,    4.32810000},
{    3.51597902,    6.08494491,    4.29446519,    5.51676685},
{    3.36139114,    3.91637920,    5.72115014,    6.24741169},
{    6.08830000,    5.43630000,    3.61600000,    4.32470000},
{    2.39830000,    6.44330000,    3.75540000,    6.11600000},
{    1.11147149,    4.30328685,    1.82271108,    8.71934150},
{    1.63871436,    3.95275142,    5.45264894,    7.18239961},
```

```
{    2.02855085,    5.65075047,    4.64130877,    6.49530022},
{    1.94580000,    3.61490000,    5.67930000,    7.16100000},
{    1.59700000,    5.26450000,    4.68320000,    6.94710000},
{    6.68990000,    1.12770000,    5.68740000,    4.70270000},
{    1.47240000,    6.58020000,    7.51260000,    0.43750000},
{    1.43605682,    3.57129694,    4.86798865,    7.98218446},
{    1.35082975,    4.79978242,    5.08229820,    7.18782116},
{    6.59810000,    5.16070000,    4.99920000,    2.68740000},
{    0.85804042,    2.66036181,    3.79617269,    8.97038032},
{    0.57752720,    3.85584150,    2.82063576,    8.92126344},
{    2.76601934,    2.14587280,    8.29033879,    4.68348890},
{    2.27580364,    4.89175504,    6.71997795,    5.39041896},
{    3.47641496,    4.79028162,    6.81795681,    4.71102312},
{    0.93039801,    2.35470380,    2.03067856,    9.66158653},
{    5.24280269,    5.87342961,    5.03715168,    4.13401730},
{    3.33721370,    2.67548096,    6.40789015,    6.76233708},
{    1.56216251,    3.93947215,    7.00708175,    6.20403383},
{    1.34391255,    7.73137752,    5.14339005,    4.25486324},
{    7.41750178,    3.73637944,    3.08194778,    5.37902423},
{    7.32120000,    6.00560000,    3.62490000,    2.16290000},
{    2.19962531,    6.52325907,    5.40432758,    5.56807852},
{    4.93620000,    4.72110000,    4.68730000,    6.25250000},
{    0.73187601,    6.21119149,    4.09183251,    7.21092005},
{    1.79253652,    3.77408073,    7.68580382,    5.60820558},
{    1.13078036,    5.25850420,    6.01079823,    6.58637956},
{    2.43485111,    5.68917861,    6.85232992,    4.84402754},
{    0.67366505,    5.02560379,    3.47361526,    8.45349077},
{    6.86360000,    5.21520000,    4.96220000,    3.22840000},
{    2.16212799,    1.53191572,    7.40567293,    6.89578635},
{    3.73873971,    3.92260064,    5.06203969,    7.37882615},
{    2.10942410,    3.14277918,    4.37038407,    8.75774237},
{    1.59757456,    6.22510211,    4.05319557,    7.29190653},
{    3.25559742,    4.73046932,    6.86808354,    5.56511651},
{    4.52622292,    2.85841971,    8.69240887,    2.65417944},
{    1.26056004,    6.38198672,    4.94052448,    6.67484228},
{    2.27077447,    3.23092900,    3.31767289,    9.27355446},
{    4.64362250,    5.54476344,    4.24857384,    6.54073713},
{    0.87778876,    6.21262913,    3.32501727,    7.93294120},
{    2.75102335,    4.16448628,    6.81864507,    6.56788614},
{    1.03724763,    4.46209680,    3.36610756,    9.07190901},
```

```
{   10.61430744,    1.25248983,     0.79488974,     0.29825722},
{    1.70130689,    5.21562264,     3.88195218,     8.38963395},
{    2.43120000,    3.76240000,     5.84110000,     7.84170000},
{    1.02946661,    3.90428545,     6.27275391,     7.78510770},
{    1.65699034,    8.74949369,     2.90585411,     5.37319588},
{    2.58759134,    6.43089846,     4.54053428,     6.94813984},
{    4.90500000,    4.89560000,     5.64060000,     6.11540000},
{    0.55686275,    9.28114166,     4.00477472,     3.90742606},
{    0.61038329,    4.81204953,     6.88326204,     6.84747708},
{    1.71815125,    4.85510539,     7.30381518,     6.17795442},
{    1.08169894,    2.89362957,     5.80959118,     8.65315647},
{    2.37142070,    7.51711915,     4.55736525,     5.95203251},
{    3.94834328,    2.68050954,     7.56836449,     6.20361178},
{    0.54564044,    3.87758027,     3.78915025,     9.52346278},
{    2.58081047,    2.92320529,     8.86926268,     5.17420821},
{    5.02738528,    6.32462173,     4.26820623,     6.09839784},
{    0.72903170,    3.65300944,     7.51390394,     7.17462046},
{    8.17356086,    5.10349515,     2.83298496,     4.62976344},
{    1.97532238,    4.91565205,     6.22708762,     7.51136992},
{    4.55151377,    5.92192617,     6.06545553,     5.56364263},
{    1.39045819,    5.61386640,     8.47073728,     4.34796448},
{    3.03632675,    4.64320306,     6.10075658,     7.53789117},
{    0.79977125,    3.95429196,     4.90566833,     9.20754096},
{    1.85265733,    6.14864006,     6.64512400,     6.36440196},
{    0.85921269,    2.57878725,     6.54695825,     8.70481673},
{    5.33913754,    4.58169580,     6.78995113,     5.57926637},
{    1.61137513,    4.23667418,     4.59640634,     9.23438768},
{    0.77773039,    5.42284598,     3.34374173,     9.26591404},
{    0.92001029,    5.75573266,     4.85671240,     8.33930244},
{    0.82972835,    2.10488103,    10.90536338,     1.87756289},
{    1.68184517,    7.80682195,     6.38121141,     4.82567879},
{    1.00885512,    5.17437788,     6.03487798,     7.97500318},
{    7.37866048,    5.56609740,     4.51195592,     4.70703726},
{    1.82483053,    3.67395636,     7.54960019,     7.40223826},
{    2.81360015,    3.43055611,     8.08047384,     6.65810927},
{    9.30274846,    3.31031206,     4.83883820,     2.94065967},
{    2.02215437,    8.54068625,     5.46996516,     4.78197345},
{    1.25579314,    5.90596091,     6.42340888,     7.25139056},
{    3.16855201,    1.96299080,     9.27163800,     5.55042314},
{    1.12197104,    3.47627070,     6.03946668,     9.00379796},
```

```
{    2.31795965,    4.61985356,    5.71764273,    8.45523545},
{    0.86830400,    3.48560358,    2.79081647,   10.50157611},
{    1.32731682,    4.35604190,    5.57674297,    8.91360522},
{    1.36907020,    6.03370451,    7.31392598,    6.31342063},
{    0.81461105,    5.91799246,    7.21449418,    6.71863286},
{    0.77676785,    8.61742544,    4.51391237,    6.20183459},
{    0.96955818,    2.29484854,    9.56821601,    6.01982002},
{    2.86384706,    4.56902790,    4.56249623,    9.24250741},
{    9.74533365,    1.73357571,    1.57835884,    5.95028919},
{    2.79767056,    8.79170726,    3.56330502,    6.20074132},
{    2.28836879,    2.75465096,    5.61332411,    9.63187411},
{    2.72413650,    6.18191018,    5.53391462,    7.86097490},
{   11.76160020,    0.63134542,    0.47546805,    0.29555005},
{    1.91094350,    6.07895552,    5.48544428,    8.27568275},
{    1.21370233,    4.32335055,    6.66457502,    8.67477432},
{    1.18594424,    2.78138448,    5.45502842,   10.05371769},
{    2.22929878,    6.14469068,    7.46699295,    6.45298636},
{    2.79591683,    2.83135167,    4.33735740,   10.38711814},
{    0.78747333,    6.39393375,    5.81692357,    8.20503567},
{    0.76370119,    2.78809390,    3.14370946,   11.15474098},
{    1.11723835,    4.71483644,    4.66368120,    9.88152823},
{    0.93916682,    6.88785336,    6.77076684,    6.99982520},
{    1.60276368,    3.30514684,    8.77524914,    7.28178295},
{    0.92251764,    3.39023345,    4.43048766,   10.56820176},
{    5.79340376,    2.36312960,    9.56320308,    3.63330121},
{    2.71241676,    3.49872684,    3.53303480,   10.61515174},
{    0.67386409,    6.69675668,    2.95976231,    9.52757871},
{    2.49519916,    7.29936215,    6.10335316,    7.01099285},
{    0.99832686,    2.40880100,    6.42354357,    9.90514258},
{    4.01387376,    6.59162609,    6.09807071,    7.10802951},
{    3.49608352,    4.71858106,    8.28710217,    6.68725791},
{    2.27787473,    4.95617707,    6.63521261,    8.67353220},
{    4.14506250,    3.64127269,    3.89205582,   10.20440879},
{    0.97399178,    6.33869199,    4.56383367,    9.41534855},
{    4.15984043,    9.54777210,    5.48922705,    3.56800194},
{    2.40056464,    5.81852817,    5.71816354,    8.97781973},
{    2.35045777,    6.73328445,    7.98562753,    6.25923663},
{    0.85625841,    6.72016523,    8.18650368,    6.42988217},
{    4.19542367,    5.39098152,    6.31874100,    8.26237198},
{    1.27547780,    5.76620603,    4.99258436,    9.80522343},
```

```
{    3.68529387,    4.15915911,    9.86937700,    5.32615633},
{    0.71107447,    4.70978679,    3.77271030,   10.97679112},
{    0.66877494,    5.93834796,    2.38106951,   10.81466644},
{    1.33751968,    5.13029803,    6.53386722,    9.36491156},
{   12.56307254,    0.93468157,    0.84920832,    0.42348664},
{    1.23085824,    4.25341291,    8.71342657,    8.03306504},
{    0.82949585,    3.82074178,    6.17543646,   10.36898905},
{    1.10644169,    3.89956692,    5.41639199,   10.78030461},
{    1.75701769,    4.30332918,    9.57778642,    6.98441454},
{    2.58670629,    3.61601573,    9.40930720,    7.38252302},
{    1.11711964,    5.33961164,    7.26247097,    8.97399030},
{    1.12884095,    6.31375030,    6.51816011,    8.91813271},
{    1.31484974,    2.18370089,   12.27551106,    2.62253120},
{    1.01443115,    2.54877355,   11.73818233,    4.33309132},
{    0.34774385,    1.82783722,    1.62876661,   12.59549507},
{    0.97994586,    7.28869946,    5.89794637,    8.71481793},
{   12.11453168,    2.95318899,    2.36450881,    2.08030365},
{    3.20328426,    2.91523634,    4.79849243,   11.16087122},
{    0.39407780,    4.99498194,    2.57332231,   11.61269552},
{    1.99022794,    6.13419229,    7.38379789,    8.40500380},
{    1.40306662,    2.69579878,   10.61501684,    6.69882981},
{    0.74186835,    7.70994201,    4.64414578,    9.25069602},
{    4.89704263,    5.35918710,    8.09906544,    6.99708383},
{    0.92288588,    4.09518940,    3.92972179,   11.59674741},
{    2.42897489,    4.64757197,    7.89471050,    8.96657111},
{    1.38902492,    5.96627182,    7.94008793,    8.35998654},
{    1.86051693,    7.14098385,    7.09990896,    8.12643961},
{    1.96359013,    5.27636059,    7.41503586,    9.21637756},
{    2.24507052,    8.53059177,    5.42855859,    8.06965501},
{    1.36089784,    7.72918602,    7.98738655,    6.85762618},
{    4.98127968,    8.23828278,    7.66412694,    4.72203251},
{    0.81803441,    3.64700350,   10.77046446,    6.63265844},
{    2.64396095,    6.64740820,    5.36249272,    9.73302651},
{    0.85721046,    8.97648757,    5.41140639,    8.01509140},
{    1.42735279,    4.50433704,    8.27851263,    9.27178244},
{    0.58781859,    1.49262189,   12.38415019,    4.64545873},
{    2.65351582,    2.42853441,   11.17485949,    6.31403683},
{    2.04620521,    6.60779533,    7.14834362,    8.97875001},
{    0.80439323,    3.85181763,    2.26196590,   12.61279665},
{    2.92145764,    4.34267811,    6.43522260,   10.53267242},
```

```
{   2.33482997,   5.15803099,   6.46659454,   10.34054980},
{   1.65316504,   7.47331814,   9.05799951,    6.47094250},
{   0.41531975,   6.32611792,   7.81048780,    9.02794475},
{   0.72163873,   5.22495540,   3.45639623,   11.97224325},
{   2.09052746,   5.11789887,   3.52197500,   11.83862453},
{   0.64174199,   7.23509890,   3.49107988,   10.87245652},
{   0.58136635,   6.03319986,   3.77340852,   11.52051703},
{   1.88847880,   4.00700903,   7.34681808,   10.49367730},
{   1.40901082,   5.45959436,   4.73007662,   11.40544217},
{   0.73776988,   4.83606269,   9.18284567,    8.72715339},
{   3.96879248,   2.18603979,   2.84762095,   12.49903569},
{   3.15568267,   6.13406295,   6.90737855,    9.48656145},
{   0.80374107,   4.65769736,   6.39948760,   11.09516625},
{   2.09661987,   3.39005710,  10.38768437,    7.95667875},
{   0.88332189,   3.59791465,   3.82394388,   12.61316034},
{   1.08942200,   3.27182927,   5.96210209,   11.86106055},
{   1.55847253,   6.22902600,   6.74851950,   10.07945058},
{   0.60905689,   3.35885813,  12.06024258,    5.61285870},
{   1.08382049,   5.48905940,   6.05852153,   10.98325259},
{   3.34331887,   6.47396440,   9.59220445,    6.68259687},
{   1.59318007,   2.09545050,   7.16202899,   11.48541550},
{   1.03897082,   4.38732526,   4.70222853,   12.26779854},
{   1.92798261,   5.11639063,   8.09865625,    9.94129707},
{   0.93720103,   8.05063136,   3.78686375,   10.74107924},
{   0.91119552,   1.81953111,   6.03538728,   12.51843564},
{   2.16380492,   7.70566504,   8.84913274,    7.42392169},
{   1.76924750,   7.78185077,   5.57395979,   10.29984737},
{   1.15987388,   9.05765050,   8.75415366,    6.40474782},
{   1.21371823,   4.84729610,   7.22481775,   11.13905058},
{   1.38288988,   7.46133933,   6.82601120,    9.87555447},
{   1.29664362,   4.30129589,   6.03512857,   12.14216497},
{   0.52458287,   7.00147036,   5.23429062,   11.28921139},
{   1.33509209,   6.23521497,   9.42836940,    8.66014090},
{   1.37643962,   4.17636451,   8.02931336,   11.20717250},
{   6.43419688,   7.68704523,   7.96430106,    6.95934814},
{   1.72236359,   7.06395633,   8.26901970,    9.59938874},
{   1.56927388,  10.37173887,   5.72851106,    8.39896556},
{   1.45839622,   5.78397321,   4.50445026,   12.61358842},
{   3.02747083,   4.17525110,  12.32314067,    6.22746505},
{   2.05146571,   4.41343489,   9.23736091,   10.44153825},
```

```
{   5.66453026,    9.06175578,     5.41182386,     8.64337000},
{   1.66093555,    5.57904772,     9.05000208,    10.17884825},
{   3.18681036,    7.89504069,     8.51476704,     8.77388749},
{   1.40298641,    5.16091442,     8.03962112,    11.38025515},
{   1.41520071,   10.44754810,     9.48927862,     4.87137641},
{   1.26011031,    5.96100155,     8.35697698,    11.03176007},
{   4.83543487,   11.84478099,     7.29747421,     4.03998236},
{   0.87323832,    5.89116239,     7.64276889,    11.96499196},
{   1.99570001,    8.78756782,     9.06747983,     8.83198069},
{   1.02235503,    7.76639722,     6.94261495,    11.61034744},
{   1.04732053,    6.97494232,     7.32229666,    11.90627484},
{   0.73854685,    8.17096188,     5.40060392,    12.21403914},
{   2.20843937,    7.57276899,     9.57229093,     9.59665485},
{   1.77535285,    9.00145328,     8.05075125,     9.85487384},
{   2.68551656,    6.70379889,     6.01662021,    12.59967759},
{   1.24885269,    9.81972571,     6.75838303,    10.27901643},
{   0.66894325,    4.60403323,     8.62708990,    12.46731496},
{   1.51766960,    4.82660767,     8.14967773,    12.78600143},
{   1.86877729,    4.64809996,     9.05742322,    12.44275804},
{   2.76648261,    4.64942870,     9.22799940,    12.23678137},
{   1.61202857,    8.63397367,     8.87509927,    10.65521375},
{   1.82511547,    6.22777413,    10.73435912,    10.87911384},
{   1.38093430,    6.71588232,     9.28350958,    12.07393045},
{   1.80444067,    6.76445168,     8.12958854,    12.92111925},
{   3.47440527,    7.88500975,     8.59696339,    11.60054876},
{   2.32572109,    7.77723715,     8.46668374,    12.10644316},
{   1.33688750,   10.89975644,     6.29384729,    11.29444386},
{   2.64792469,    9.15374122,     8.45512575,    11.39900161},
{   2.83404531,    9.18932276,     9.77927438,    10.32461184},
{   1.47207345,    9.63668301,     6.51404099,    12.72973192},
{   2.01073179,    8.11557312,     9.57967353,    11.77710059},
{   1.52741425,    6.98063061,     9.30346179,    12.90851820},
{   2.15975449,   11.64209182,     6.12475536,    11.56924015},
{   3.66580372,    9.64803926,     7.39415298,    12.26516569},
{   2.14898470,    7.40531177,    10.12399765,    12.64288098},
{   1.65172109,    9.12415911,    10.26071926,    12.04537711},
{  11.37380673,    6.17262402,    10.98932460,     7.69678064},
{   1.93257054,    9.82814492,    10.03906878,    12.83940772},
{   3.30729405,   11.02212306,    12.58337589,     8.68245192},
{   4.93277768,   12.49805088,    10.53402702,    11.30795961},
```

857

```
{   7.46673668,    9.95870339,    11.92110909,    11.13530351},
{   1.79166482,    12.16424221,    11.50508223,    12.66257869},
};


/*=================================================================*/
/* Conexant System Inc.                              */
/* 4311 Jamboree Road                                */
/* Newport Beach, CA 92660                              */
/*------------------------------------------------------*/
/* Copyright(C) 2000 Conexant System Inc.                  */
/*------------------------------------------------------*/
/* ALL RIGHTS RESERVED:                              */
/* No part of this software may be reproduced in any form or by any */
/* means or used to make any derivative work (such as transformation */
/* or adaptation) without the authorisation of Conexant System Inc. */
/*=================================================================*/
/* FILE:  FLOAT64 gainVQ_2_128_8_5                    */
/*=================================================================*/



FLOAT64 gainVQ_2_128_8_5[MSMAX_2_128][GVQ_VEC_SIZE_2D]={
{ 1.13718400, 2.00167200,},
{ 1.15061100, 0.80219900,},
{ 0.98207800, 0.51399000,},
{ 1.10500000, 0.15447500,},
{ 0.11378400, 9.42551300,},
{ 0.94094200, 0.70526500,},
{ 0.80243560, 0.34683600,},
{ 0.13515300, 11.12709900,},
{ 0.75909900, 2.88632700,},
{ 0.82919900, 1.39055100,},
{ 0.54780000, 0.75109900,},
{ 0.64942200, 0.21226600,},
{ 0.66705400, 2.16333100,},
{ 0.63880400, 1.02172900,},
{ 0.22345900, 0.31303700,},
{ 0.27085500, 0.04820600,},
{ 1.15294600, 4.53179200,},
{ 1.16686600, 2.75126500,},
{ 1.18999500, 1.39510700,},
```

```
{ 1.11778400,  0.58757400,},
{ 1.18887200,  3.80809000,},
{ 1.05657500,  2.13161600,},
{ 1.13064700,  1.15821700,},
{ 1.04200000,  0.40869700,},
{ 1.04338300,  5.44336600,},
{ 0.88449000,  3.34760400,},
{ 0.72784500,  1.94726600,},
{ 0.70959500,  0.80566400,},
{ 0.65729500,  4.38794000,},
{ 0.70740000,  2.66792200,},
{ 0.57385300,  1.50683600,},
{ 0.47064300,  0.58837900,},
{ 0.88597700,  2.27373000,},
{ 1.05926600,  1.16308600,},
{ 0.12943500,  13.50132800,},
{ 0.85623100,  0.15288900,},
{ 0.69171100,  1.80786200,},
{ 0.91399200,  0.86047400,},
{ 0.10358200,  16.23313000,},
{ 0.68111100,  0.08475100,},
{ 0.31958000,  3.21447800,},
{ 0.62654300,  1.71266600,},
{ 0.16217000,  0.85778800,},
{ 0.38586700,  0.25569800,},
{ 0.25176000,  2.38515800,},
{ 0.43364500,  1.23491300,},
{ 0.05389400,  0.50441900,},
{ 0.10640600,  0.05330000,},
{ 0.84213600,  4.74540700,},
{ 1.14440800,  3.24315600,},
{ 0.80336500,  1.68015100,},
{ 0.55854300,  0.54247600,},
{ 0.89434200,  3.77774700,},
{ 1.01672700,  2.42313600,},
{ 0.84586000,  1.08642000,},
{ 0.90643900,  0.47559100,},
{ 0.33732200,  5.75193400,},
{ 0.62728700,  3.78905800,},
{ 1.05076300,  1.70952200,},
```

```
{ 0.48097400,  1.01267000,},
{ 0.31390400,  4.65732500,},
{ 0.55670200,  3.24914600,},
{ 0.38080300,  1.55972500,},
{ 0.42559800,  0.68530300,},
{ 1.09926500,  2.79674000,},
{ 0.95508100,  1.41049800,},
{ 0.78678600,  0.68538000,},
{ 0.95358200,  0.23313000,},
{ 0.92961200,  1.97636200,},
{ 0.75708000,  0.97509800,},
{ 0.68356300,  0.40566400,},
{ 0.51043900,  0.10678230,},
{ 0.53942900,  3.70803200,},
{ 0.57837000,  1.86535700,},
{ 0.35109200,  1.20642100,},
{ 0.45661300,  0.29890300,},
{ 0.61108400,  2.72753900,},
{ 0.49322600,  1.42651300,},
{ 0.24345900,  0.70303700,},
{ 0.05047600,  0.12981000,},
{ 1.16051300,  5.56319400,},
{ 0.99243800,  3.29063900,},
{ 0.99072500,  1.99141000,},
{ 1.02200000,  0.79869700,},
{ 1.09807600,  4.16487000,},
{ 0.94571700,  2.61474000,},
{ 0.88639400,  1.28403400,},
{ 0.85020100,  0.57653900,},
{ 0.80787100,  5.79903300,},
{ 0.75617700,  3.83105500,},
{ 0.51556400,  2.39465400,},
{ 0.60559000,  1.20642100,},
{ 0.46290200,  5.67811350,},
{ 0.72930000,  3.37976100,},
{ 0.33557200,  1.97353600,},
{ 0.37945600,  0.95202600,},
{ 0.81490800,  3.26847000,},
{ 0.86360200,  1.76652000,},
{ 0.58850100,  0.88940500,},
```

```
{ 0.74833100, 0.45808200,},
{ 0.80934600, 2.36844300,},
{ 0.67389000, 1.19824200,},
{ 0.63538600, 0.54712000,},
{ 0.57660000, 0.21887700,},
{ 0.12176500, 4.18505900,},
{ 0.37830600, 2.25265100,},
{ 0.21637000, 1.49602100,},
{ 0.31155400, 0.54434500,},
{ 0.10000000, 3.25577100,},
{ 0.14343300, 1.80127000,},
{ 0.11508100, 0.98077200,},
{ 0.10320100, 0.30653900,},
{ 0.90839600, 5.76712400,},
{ 0.96277000, 3.76910300,},
{ 0.77146900, 2.04766000,},
{ 0.95915800, 0.98334300,},
{ 0.91656900, 4.61102600,},
{ 0.87191100, 2.95691000,},
{ 0.70257400, 1.49621600,},
{ 0.73999100, 0.65808200,},
{ 0.11899700, 7.01306400,},
{ 0.48773200, 4.70539500,},
{ 0.39770600, 2.79362800,},
{ 0.46171900, 1.68674400,},
{ 0.04775300, 5.83900400,},
{ 0.24515600, 3.71567400,},
{ 0.07214400, 2.04602100,},
{ 0.22776900, 1.16631900,},
};
```

```
/*========================================================*/
/* Conexant System Inc.                    */
/* 4311 Jamboree Road                      */
/* Newport Beach, CA 92660                  */
/*-------------------------------------------------*/
/* Copyright(C) 2000 Conexant System Inc.      */
/*-------------------------------------------------*/
/* ALL RIGHTS RESERVED:                   */
/* No part of this software may be reproduced in any form or by any */
/* means or used to make any derivative work (such as transformation */
/* or adaptation) without the authorisation of Conexant System Inc. */
/*========================================================*/
/* FILE:  FLOAT64 gp3_tab                   */
/*========================================================*/


FLOAT64 gp3_tab[TAB_SIZE_GVQ_3D][GVQ_VEC_SIZE_3D]={
{ 1.16184904, 1.16859789, 1.13656320,},
{ 1.14613289, 1.06371877, 0.91852525,},
{ 1.00344711, 0.90488701, 0.79197966,},
{ 0.89898517, 0.86585984, 0.57621277,},
{ 0.99149439, 0.97843157, 0.97025005,},
{ 0.89739798, 0.86130891, 0.84842344,},
{ 0.86598496, 0.78195693, 0.74571748,},
{ 0.79213167, 0.68469714, 0.57939861,},
{ 0.99928691, 1.06213737, 1.06047882,},
{ 0.91946603, 0.92523551, 0.93225137,},
{ 0.78015244, 0.80748131, 0.87699716,},
{ 0.72123502, 0.75183948, 0.73110569,},
{ 0.71467869, 1.00925302, 1.04508421,},
{ 0.57918595, 0.91509645, 0.84665658,},
{ 0.58059384, 0.63848156, 0.81308216,},
{ 0.61528823, 0.59858664, 0.56355253,},
};
```

```
/*====================================================================*/
/* Conexant System Inc.                              */
/* 4311 Jamboree Road                                */
/* Newport Beach, CA 92660                            */
/*--------------------------------------------------*/
/* Copyright(C) 2000 Conexant System Inc.               */
/*--------------------------------------------------*/
/* ALL RIGHTS RESERVED:                              */
/* No part of this software may be reproduced in any form or by any  */
/* means or used to make any derivative work (such as transformation */
/* or adaptation) without the authorisation of Conexant System Inc.  */
/*====================================================================*/
/* FILE:  FLOAT64 gainSQ_1_32                        */
/*====================================================================*/


FLOAT64 gainSQ_1_32[MSMAX_1_32]={
    0.35254579,
    0.25370548,
    0.02227783,
    0.01000000,
    0.96400353,
    0.75700023,
    0.19593419,
    0.15817945,
    0.55403371,
    0.44012518,
    0.17369569,
    0.13850902,
    2.00929650,
    1.35393237,
    0.28748898,
    0.22267504,
    3.05406901,
    2.75461276,
    0.39066788,
    0.30225533,
    6.52227783,
    5.48564881,
    1.00617023,
```

```
        0.86949491,
        4.51286186,
        3.52957861,
        0.66628545,
        0.50710786,
        8.51290000,
        7.51286186,
        2.31398228,
        1.83583729,
    };


/*====================================================================*/
/*====================================================================*/
/* Conexant System Inc.                          */
/* 4311 Jamboree Road                            */
/* Newport Beach, CA 92660                        */
/*--------------------------------------------------*/
/* Copyright(C) 2000 Conexant System Inc.             */
/*--------------------------------------------------*/
/* ALL RIGHTS RESERVED:                          */
/* No part of this software may be reproduced in any form or by any  */
/* means or used to make any derivative work (such as transformation */
/* or adaptation) without the authorisation of Conexant System Inc.  */
/*====================================================================*/
/* FILE:  FLOAT64 gainSQ_1_64                      */
/*====================================================================*/



FLOAT64 gainSQ_1_64[MSMAX_1_64]={
        0.00500000,
        0.01000000,
        0.01613892,
        0.02227783,
        0.08039343,
        0.13850902,
        0.14834423,
        0.15817945,
        0.16593757,
        0.17369569,
        0.18481494,
```

0.19593419,

0.20930461,

0.22267504,

0.23819026,

0.25370548,

0.27059723,

0.28748898,

0.29487215,

0.30225533,

0.32740056,

0.35254579,

0.37160684,

0.39066788,

0.41539653,

0.44012518,

0.47361652,

0.50710786,

0.53057078,

0.55403371,

0.61015958,

0.66628545,

0.71164284,

0.75700023,

0.81324757,

0.86949491,

0.91674922,

0.96400353,

0.98508688,

1.00617023,

1.18005130,

1.35393237,

1.59488483,

1.83583729,

1.92256690,

2.00929650,

2.16163939,

2.31398228,

2.53429752,

2.75461276,

2.90434088,

```
        3.05406901,

        3.29182381,

        3.52957861,

        4.02122024,

        4.51286186,

        4.99925533,

        5.48564881,

        6.00396332,

        6.52227783,

        7.01756985,

        7.51286186,

        8.01288093,

        8.51290000

    };


/*=======================================================================*/
/* Conexant System Inc.                          */
/* 4311 Jamboree Road                            */
/* Newport Beach, CA 92660                        */
/*--------------------------------------------------------------*/
/* Copyright(C) 2000 Conexant System Inc.                  */
/*--------------------------------------------------------------*/
/* ALL RIGHTS RESERVED:                          */
/* No part of this software may be reproduced in any form or by any  */
/* means or used to make any derivative work (such as transformation */
/* or adaptation) without the authorisation of Conexant System Inc.  */
/*=======================================================================*/
/* FILE:  FLOAT64 gainVQ_2_128                      */
/*=======================================================================*/


FLOAT64 gainVQ_2_128[MSMAX_2_128][GVQ_VEC_SIZE_2D]={
    {    0.04775300,    5.83900400},
    {    0.05047600,    0.12981000},
    {    0.05389400,    0.50441900},
    {    0.07200000,    1.43869700},
    {    0.07214400,    2.04602100},
    {    0.10000000,    3.25577100},
    {    0.10320100,    0.30653900},
    {    0.10640600,    0.05330000},
```

```
{    0.11508100,    0.98077200},
{    0.11899700,    7.01306400},
{    0.12176500,    4.18505900},
{    0.14343300,    1.80127000},
{    0.16217000,    0.85778800},
{    0.21637000,    1.49602100},
{    0.22345900,    0.31303700},
{    0.22776900,    1.16631900},
{    0.24345900,    0.70303700},
{    0.24515600,    3.71567400},
{    0.25176000,    2.38515800},
{    0.27085500,    0.04820600},
{    0.31155400,    0.54434500},
{    0.31390400,    4.65732500},
{    0.31958000,    3.21447800},
{    0.33557200,    1.97353600},
{    0.33732200,    5.75193400},
{    0.35109200,    1.20642100},
{    0.35586700,    0.25569800},
{    0.37830600,    2.25265100},
{    0.37945600,    0.95202600},
{    0.38080300,    1.55972500},
{    0.39770600,    2.79362800},
{    0.40290200,    4.07811350},
{    0.42559800,    0.68530300},
{    0.42706300,    2.24952200},
{    0.43364500,    1.23491300},
{    0.45661300,    0.29890300},
{    0.46171900,    1.68674400},
{    0.47064300,    0.58837900},
{    0.48097400,    1.01267000},
{    0.48773200,    4.70539500},
{    0.49322600,    1.42651300},
{    0.50338300,    7.44336600},
{    0.51043900,    0.10678230},
{    0.51556400,    2.39465400},
{    0.53942900,    3.70803200},
{    0.54660000,    0.20287700},
{    0.54780000,    0.75109900},
{    0.55670200,    3.24914600},
```

```
{  0.57385300,    1.50683600},
{  0.57837000,    1.86535700},
{  0.58850100,    0.88940500},
{  0.60358200,    0.23313000},
{  0.60559000,    1.20642100},
{  0.61108400,    2.72753900},
{  0.62654300,    1.71266600},
{  0.62728700,    3.78905800},
{  0.63538600,    0.54712000},
{  0.63880400,    1.02172900},
{  0.64942200,    0.21226600},
{  0.65729500,    4.38794000},
{  0.66705400,    2.16333100},
{  0.67111100,    0.05475100},
{  0.67389000,    1.19824200},
{  0.68356300,    0.40566400},
{  0.69171100,    1.80786200},
{  0.69515300,    0.12709900},
{  0.70257400,    1.49621600},
{  0.70740000,    2.66792200},
{  0.70959500,    0.80566400},
{  0.72784500,    1.94726600},
{  0.72930000,    3.37976100},
{  0.73999100,    0.65808200},
{  0.74833100,    0.35808200},
{  0.74943500,    0.50132800},
{  0.75617700,    3.83105500},
{  0.75708000,    0.97509800},
{  0.75909900,    2.88632700},
{  0.77146900,    2.04766000},
{  0.78678600,    0.68538000},
{  0.80243560,    0.34683600},
{  0.80336500,    1.68015100},
{  0.80787100,    5.79903300},
{  0.80934600,    2.36844300},
{  0.81490800,    3.26847000},
{  0.82919900,    1.39055100},
{  0.84213600,    4.74540700},
{  0.84586000,    1.08642000},
{  0.85020100,    0.57653900},
```

```
{    0.85623100,    0.15288900},
{    0.86360200,    1.76652000},
{    0.87191100,    2.95691000},
{    0.88449000,    3.34760400},
{    0.88597700,    2.27373000},
{    0.88639400,    1.28403400},
{    0.89434200,    3.77774700},
{    0.90643900,    0.47559100},
{    0.90839600,    7.06712400},
{    0.91399200,    0.86047400},
{    0.91656900,    4.61102600},
{    0.92961200,    1.97636200},
{    0.94094200,    0.70526500},
{    0.94108100,    1.41049800},
{    0.94571700,    2.61474000},
{    0.95358200,    0.23313000},
{    0.95915800,    0.98334300},
{    0.96277000,    3.76910300},
{    0.97378400,    1.42551300},
{    0.98207800,    0.51399000},
{    0.99072500,    1.99141000},
{    0.99243800,    3.29063900},
{    1.01672700,    2.42313600},
{    1.03854300,    0.79424600},
{    1.04200000,    0.40869700},
{    1.05657500,    2.13161600},
{    1.05926600,    1.16308600},
{    1.09807600,    4.16487000},
{    1.09926500,    2.79674000},
{    1.10500000,    0.15447500},
{    1.11778400,    0.58757400},
{    1.13064700,    1.15821700},
{    1.13718400,    2.00167200},
{    1.14440800,    3.24315600},
{    1.15061100,    0.80219900},
{    1.15294600,    4.53179200},
{    1.16051300,    5.56319400},
{    1.16686600,    2.75126500},
{    1.18887200,    3.80809000},
{    1.18999500,    1.39510700},
```

};

```
/*==============================================================*/
/* Conexant System Inc.                    */
/* 4311 Jamboree Road                      */
/* Newport Beach, CA 92660                  */
/*------------------------------------------*/
/* Copyright(C) 2000 Conexant System Inc.          */
/*------------------------------------------*/
/* ALL RIGHTS RESERVED:                    */
/* No part of this software may be reproduced in any form or by any */
/* means or used to make any derivative work (such as transformation */
/* or adaptation) without the authorisation of Conexant System Inc. */
/*==============================================================*/
/* FILE:  FLOAT64 gainVQ_3_256               */
/*==============================================================*/


FLOAT64 gainVQ_3_256[MSMAX_3_256][GVQ_VEC_SIZE_3D]={
   {   0.18423671,   0.06523999,   0.13390472},
   {   0.27552690,   0.09702324,   0.05427950},
   {   0.43928408,   0.09916646,   0.07929166},
   {   0.30334933,   0.18716016,   0.31678128},
   {   0.41418666,   0.21261386,   0.15384708},
   {   0.37873043,   0.42174574,   0.04961395},
   {   0.29147613,   0.29845310,   0.40867354},
   {   0.43405077,   0.35567807,   0.26669122},
   {   0.53415143,   0.29394379,   0.16766848},
   {   0.50717581,   0.11896112,   0.37699809},
   {   0.66212668,   0.19329986,   0.10043744},
   {   0.54479938,   0.42417890,   0.28406764},
   {   0.72548595,   0.35772887,   0.24749989},
   {   0.60787704,   0.60357108,   0.11571399},
   {   0.44866082,   0.50410116,   0.54628895},
   {   0.63617079,   0.44004655,   0.39629087},
   {   0.60380713,   0.57881179,   0.23710724},
   {   0.57147613,   0.32845310,   0.63867354},
   {   0.58377105,   0.62781041,   0.35943653},
   {   0.84962970,   0.34766924,   0.25346008},
   {   0.70304065,   0.42216057,   0.50275130},
   {   0.56733319,   0.77096928,   0.44681334},
```

```
{   0.67739743,    0.55274660,    0.62815394},
{   0.50377105,    0.59781041,    0.75943653},
{   1.02493622,    0.30657679,    0.22040604},
{   0.89224001,    0.44816208,    0.47573256},
{   0.78742879,    0.65575239,    0.41906662},
{   0.86962970,    0.52766924,    0.45346008},
{   0.70147613,    0.70845310,    0.63867354},
{   0.56375176,    0.54331588,    0.93399510},
{   0.56880138,    0.85878106,    0.65405398},
{   0.89237889,    0.63875680,    0.73716397},
{   1.21640268,    0.51021986,    0.33177812},
{   1.10769596,    0.60105476,    0.51909185},
{   0.92783571,    0.90203672,    0.42962756},
{   0.91304065,    0.82216057,    0.59275130},
{   0.73462016,    0.87102291,    0.79155967},
{   0.51415143,    0.49394379,    1.21766848},
{   0.80147613,    0.80845310,    0.90867354},
{   0.65577617,    0.84190122,    1.06996396},
{   1.04057248,    0.81830130,    0.74445659},
{   1.50153717,    0.23078537,    0.11994055},
{   0.61337482,    1.28879057,    0.59880559},
{   0.92002052,    0.66569019,    1.10918314},
{   0.86113057,    1.00464835,    0.88498578},
{   1.30843346,    0.78609255,    0.56090355},
{   0.68218806,    1.10235747,    1.02459256},
{   0.80147613,    0.80845310,    1.20867354},
{   1.07221236,    1.07266347,    0.70109317},
{   1.04005621,    0.92340675,    1.07639990},
{   1.67199089,    0.43317129,    0.40693115},
{   0.80769819,    1.03723493,    1.21036557},
{   0.65537261,    0.88560134,    1.42463688},
{   0.84912716,    1.37797097,    0.83138440},
{   0.38727281,    0.81106102,    1.61211439},
{   0.97653020,    1.24782107,    0.97497746},
{   1.68437217,    0.69187863,    0.60223674},
{   1.31480645,    0.82070608,    1.13008054},
{   1.40769819,    0.60723493,    1.21036557},
{   1.06758231,    0.90166400,    1.38433931},
{   1.41916427,    0.61926269,    1.23316072},
{   0.76932084,    1.68403889,    0.70472831},
```

{ 1.53994895, 0.92045545, 0.84686607},
{ 1.17434557, 1.25676753, 1.08675163},
{ 0.71281086, 1.31583463, 1.39405615},
{ 1.50787704, 1.35357108, 0.41571399},
{ 1.28870929, 1.43696572, 0.74659127},
{ 1.34769819, 1.23723493, 1.01036557},
{ 1.80304065, 0.92216057, 0.52275130},
{ 1.59276987, 1.19748085, 0.65036773},
{ 0.84678170, 1.14114978, 1.56930890},
{ 2.09205535, 0.42435557, 0.27661303},
{ 1.07739708, 1.25581010, 1.37870129},
{ 2.03213590, 0.68376401, 0.57647235},
{ 2.01481852, 0.45383006, 0.85771860},
{ 0.61943236, 1.95135273, 0.91598867},
{ 1.04773632, 1.59531164, 1.19066755},
{ 0.88978466, 0.85386113, 1.90357651},
{ 1.29776536, 0.96049994, 1.61141126},
{ 1.72645587, 0.69770038, 1.39133233},
{ 0.52462760, 1.59032755, 1.64085701},
{ 1.00705056, 1.38018864, 1.62839872},
{ 2.27773340, 0.42174080, 0.48770699},
{ 1.33914079, 1.44432940, 1.40032266},
{ 1.86798260, 1.23959629, 1.04625425},
{ 1.60300067, 1.45834785, 1.20724126},
{ 1.17075928, 1.17666852, 1.84692307},
{ 1.41613105, 1.75303586, 1.06875197},
{ 0.92063093, 1.92289980, 1.30647683},
{ 0.73106711, 1.10141804, 2.15959529},
{ 1.78833214, 1.08633166, 1.44314613},
{ 0.93493402, 1.72883883, 1.61840939},
{ 0.83214354, 1.44720912, 1.92942400},
{ 1.54501647, 1.16781309, 1.67929750},
{ 1.11904841, 1.57436071, 1.88570305},
{ 1.53104237, 1.66544824, 1.54667736},
{ 1.14438336, 1.79996622, 1.75932112},
{ 1.47409522, 1.21483017, 2.01998560},
{ 0.76523771, 2.00844105, 1.79018034},
{ 2.04771424, 1.67904043, 0.96105927},
{ 0.54181758, 0.98357105, 2.58609881},
{ 1.58307521, 1.51532393, 1.79540195},

```
{    2.43500575,    1.09257895,    0.95481845},
{    0.97756624,    1.44705987,    2.24968026},
{    1.89166746,    1.35363713,    1.80890663},
{    1.18415143,    2.59394379,    0.80766848},
{    1.36028189,    1.68437713,    2.04041326},
{    0.91784174,    2.60471655,    1.20769601},
{    0.80520427,    1.92410272,    2.25712012},
{    2.98285984,    0.68934076,    0.29605000},
{    1.50266600,    2.22699291,    1.50071492},
{    1.82265397,    1.87159390,    1.65277587},
{    1.09905937,    2.18713881,    1.90143173},
{    2.33704557,    1.33227401,    1.58215136},
{    2.35241303,    1.69726111,    1.26872325},
{    1.04808551,    1.49066820,    2.64982303},
{    1.46152881,    1.57356066,    2.40756748},
{    2.72968460,    1.23697995,    1.20994651},
{    2.83739322,    0.72272909,    1.39076807},
{    0.82555146,    1.04009950,    3.02533361},
{    1.42045226,    1.95032360,    2.28339356},
{    1.80302484,    1.44216516,    2.45919838},
{    2.06483654,    1.93254106,    1.86462136},
{    0.67917774,    2.63766396,    2.02787790},
{    1.02634826,    1.92879555,    2.60863396},
{    1.51872521,    2.44014313,    1.86652849},
{    2.30877821,    1.28190051,    2.22497656},
{    0.79031450,    2.45814359,    2.32354362},
{    1.32523818,    2.24315629,    2.36379872},
{    0.98940812,    2.84402782,    1.83831562},
{    1.31665565,    1.82304671,    2.74329139},
{    1.34359003,    1.38343551,    3.00644318},
{    2.20904779,    1.71167907,    2.23001002},
{    1.74638332,    2.10399175,    2.32626365},
{    2.91613501,    1.69537591,    1.26632829},
{    2.59027791,    1.77278764,    1.82930733},
{    1.88338778,    1.81263020,    2.56862447},
{    0.74785364,    1.55314315,    3.25822094},
{    1.84605625,    2.72422494,    1.86433759},
{    1.38835853,    2.41996170,    2.57619188},
{    1.08143706,    2.79353362,    2.34787684},
{    1.69818444,    1.73420492,    2.96331527},
```

```
{   3.43403868,    1.33204645,    1.05436621},
{   0.97007105,    2.32342882,    2.91055973},
{   1.00567140,    1.89901787,    3.20776287},
{   0.87244421,    3.43184209,    1.54058124},
{   1.67492020,    1.53714034,    3.23285723},
{   2.55479938,    2.25417890,    2.01406764},
{   1.34771672,    2.01099296,    3.13226841},
{   2.14304065,    3.02216057,    1.59275130},
{   2.59002574,    1.78610442,    2.55361381},
{   1.32123069,    1.59807627,    3.54650542},
{   1.14300592,    2.57639730,    2.98919441},
{   0.92574076,    2.92308627,    2.74152664},
{   1.57092315,    2.78635648,    2.63951611},
{   3.67927168,    1.24912102,    1.54728078},
{   2.62956938,    2.75787484,    1.75649249},
{   1.95505014,    2.52412798,    2.73521856},
{   0.76806683,    1.46836387,    3.91694578},
{   1.26068455,    2.40119239,    3.29000018},
{   1.25882021,    3.10377934,    2.64643382},
{   2.30050748,    2.41997639,    2.66755866},
{   2.30779695,    1.37761745,    3.38026907},
{   1.38704503,    3.71229947,    1.82595078},
{   1.74924880,    3.12919645,    2.51590930},
{   3.49911398,    1.82501924,    1.95192827},
{   1.22345576,    2.06177866,    3.71631753},
{   1.63398319,    2.49769986,    3.31709109},
{   1.05262452,    2.67912301,    3.51114550},
{   0.93657527,    1.56288763,    4.29946587},
{   2.13113770,    3.61726093,    2.05364738},
{   1.33438889,    3.20149678,    3.15944118},
{   0.94607152,    3.97866725,    2.35162303},
{   1.93477378,    2.25684162,    3.68273848},
{   0.94330124,    2.16329723,    4.12284581},
{   1.33319181,    3.67449053,    2.72883988},
{   2.27147613,    2.74845310,    3.23867354},
{   3.02616395,    3.21716252,    1.94899045},
{   2.10687315,    3.16506001,    2.98488232},
{   4.11022232,    1.91121298,    1.68274465},
{   1.18276551,    2.80005028,    3.81211559},
{   1.09284910,    3.35693149,    3.49793360},
```

```
{   2.12671584,    3.78197824,    2.46859134},
{   2.74764121,    2.89026903,    3.01791201},
{   1.37550113,    2.20827333,    4.31148037},
{   2.11778891,    2.95016434,    3.55388198},
{   1.28935019,    2.59852102,    4.22368022},
{   1.05655533,    3.86933199,    3.24099202},
{   3.05325444,    2.26440201,    3.63344939},
{   3.55488807,    3.33969512,    2.08366736},
{   3.17581401,    3.51831382,    2.49463722},
{   1.86521202,    2.09247637,    4.56744163},
{   1.39255334,    3.07667470,    4.17908984},
{   1.60100173,    2.00209967,    4.75912864},
{   1.79953418,    4.38145628,    2.60616765},
{   1.20655613,    1.79195012,    4.98432651},
{   1.85141571,    3.85261166,    3.44561621},
{   0.87797111,    2.46051806,    4.83101276},
{   2.24150619,    2.50592028,    4.39812285},
{   0.92794754,    0.81807103,    5.40333244},
{   2.07018808,    1.55683902,    4.90385218},
{   1.00141951,    3.09506090,    4.56081930},
{   2.19703965,    4.54754188,    2.58657205},
{   1.68611482,    3.39861080,    4.28953096},
{   2.40798222,    3.84057596,    3.68363236},
{   4.23562265,    2.98668784,    2.85562416},
{   3.35095885,    2.87943539,    3.95403648},
{   1.34643194,    4.30772377,    3.86555652},
{   1.30196206,    3.00084122,    4.97111829},
{   1.16458645,    2.77589093,    5.32708203},
{   2.42328760,    3.86555792,    4.09438379},
{   1.62105343,    1.41238279,    5.79506793},
{   1.87537181,    4.29252889,    4.03861785},
{   1.94915259,    3.75474761,    4.53646174},
{   2.50906157,    3.56636387,    4.51085622},
{   1.88366421,    2.94629459,    5.22399523},
{   2.41081739,    5.11659616,    2.79322600},
{   1.57313722,    3.07734699,    5.34764738},
{   1.79523161,    4.34349109,    4.33952252},
{   2.31312398,    4.51584051,    4.14916283},
{   2.12061524,    3.13076579,    5.38730521},
{   3.91709002,    3.99447396,    3.52701191},
```

```
    {   1.09473208,     3.48204765,     5.54351159},
    {   3.71693971,     4.77440840,     2.95610900},
    {   1.94787704,     2.45357108,     6.01571399},
    {   1.43082216,     5.35753324,     3.95445396},
    {   2.07996690,     3.37146297,     5.54694918},
    {   5.27319185,     3.85749737,     1.99698485},
    {   1.50998753,     4.13463484,     5.32020642},
    {   0.94796341,     5.95733241,     3.40864161},
    {   2.78377105,     2.79781041,     5.95943653},
    {   1.20436564,     2.53343719,     6.67055599},
    {   4.87726112,     4.61271729,     2.71318600},
    {   1.52759187,     5.17921822,     4.83658789},
    {   1.39911614,     5.70091947,     4.30338189},
    {   3.27962970,     4.44766924,     4.94346008},
    {   2.07790477,     4.96770690,     5.11185658},
    {   3.52060468,     5.55065264,     3.52497139},
    {   2.80842248,     4.77477568,     5.04216093},
    {   1.28666983,     3.38891971,     6.66482260},
    {   0.84228383,     3.37245381,     6.81756747},
    {   2.02498925,     4.21727237,     6.17400158},
    {   1.60165594,     2.32140376,     7.49358970},
    {   1.97479938,     5.85417890,     5.31406764},
    {   1.84694789,     3.62386827,     7.09537873},
    {   2.30906157,     7.06636387,     3.61085622},
    {   1.20894988,     4.11824820,     7.18224848},
    {   2.23724030,     4.38107866,     6.83186735},
    {   5.05892405,     3.39578378,     6.21487747},
    {   2.89229838,     6.11530388,     5.49003500},
    {   3.45717581,     3.84896112,     7.37699809},
    {   5.44334933,     5.88716016,     4.31678128},
    {   1.32060468,     5.05065264,     7.72497139},
    {   1.52060468,     7.25065264,     6.12497139},
    {   5.97620545,     6.67676201,     3.96381875},
    {   4.53928408,     6.49316646,     6.57929166},
};


/*------------------------------------------------------*/
/*======================================================*/
/*------------------- END -----------------------------*/
/*======================================================*/
```

```
/*=====================================================================*/


/*=================================================================*/
/* Conexant System Inc.                    */
/* 4311 Jamboree Road                      */
/* Newport Beach, CA 92660                  */
/*-----------------------------------------------*/
/* Copyright(C) 2000 Conexant System Inc.          */
/*-----------------------------------------------*/
/* ALL RIGHTS RESERVED:                       */
/* No part of this software may be reproduced in any form or by any  */
/* means or used to make any derivative work (such as transformation */
/* or adaptation) without the authorisation of Conexant System Inc.  */
/*===============================================================*/
/* LIBRARY: gauss_bv.tab                      */
/*-----------------------------------------------*/
/*===============================================================*/


/*-------------------------------------------------*/
/*------------------ TABLES -----------------------*/
/*-------------------------------------------------*/
```

```
/*====================================================================*/
/* Conexant System Inc.                          */
/* 4311 Jamboree Road                            */
/* Newport Beach, CA 92660                         */
/*------------------------------------------------------*/
/* Copyright(C) 2000 Conexant System Inc.                 */
/*------------------------------------------------------*/
/* ALL RIGHTS RESERVED:                        */
/* No part of this software may be reproduced in any form or by any */
/* means or used to make any derivative work (such as transformation */
/* or adaptation) without the authorisation of Conexant System Inc. */
/*====================================================================*/
/* FILE: double bv                            */
/*------------------------------------------------------*/
/*====================================================================*/


double bv[32][40]={
{ 0.129991,  0.064760, -0.002124,  0.031397, -0.095657,
  0.194382, -0.004066,  0.206616,  0.020785,  0.094439,
 -0.186531, -0.096221,  0.139813, -0.088682,  0.058761,
 -0.054868, -0.027660, -0.174793, -0.165230,  0.108125,
 -0.016666, -0.108074, -0.103980,  0.093234, -0.018041,
  0.051019,  0.036860,  0.080444,  0.037322, -0.173828,
  0.034237,  0.125167,  0.077101, -0.299421, -0.044413,
 -0.050372,  0.027321, -0.073190, -0.011473,  0.183516},
{ 0.097175,  0.029658, -0.109162, -0.009789,  0.015654,
 -0.066477, -0.040802,  0.046798,  0.179909, -0.286337,
 -0.129516,  0.129213,  0.066188, -0.033189,  0.046677,
 -0.115491, -0.120577,  0.035435,  0.175051,  0.085733,
 -0.060723,  0.101562, -0.030479, -0.086184, -0.053423,
 -0.072980, -0.025941,  0.063914, -0.125523,  0.039384,
  0.130419,  0.015899,  0.080340, -0.007682,  0.233579,
  0.106089, -0.212920,  0.002499, -0.212192,  0.118209},
{ 0.035485,  0.065157,  0.093618,  0.200062, -0.051137,
 -0.029000,  0.062292,  0.106185, -0.147534, -0.079012,
 -0.007510, -0.313287,  0.128095, -0.136738,  0.127468,
 -0.107670,  0.064600,  0.087097, -0.033680,  0.055832,
 -0.027791,  0.054826, -0.145352, -0.100984,  0.157922,
 -0.087520,  0.016400, -0.204684, -0.061008, -0.105759,
```

-0.044183, 0.106015, 0.106175, 0.129473, 0.006966,
0.048202, -0.140265, -0.066978, 0.141637, 0.096585},
{ 0.032834, -0.117642, 0.022656, 0.028494, -0.042477,
0.019769, 0.222683, -0.047178, -0.150082, -0.244569,
-0.074121, -0.066537, -0.110890, 0.175115, 0.080115,
0.053503, 0.031178, -0.262706, 0.144141, -0.003827,
-0.086824, -0.189568, 0.001631, 0.179950, 0.026267,
0.069194, -0.022789, 0.085670, -0.142656, 0.079799,
0.040639, -0.022782, 0.011422, 0.135623, -0.003446,
0.073037, -0.122266, 0.099223, 0.155886, -0.058467},
{-0.119203, -0.113097, 0.087872, -0.088533, -0.008026,
-0.167421, 0.129201, -0.088686, 0.110136, 0.096386,
-0.016415, 0.040387, -0.035463, -0.041054, 0.143447,
0.008815, -0.129834, 0.194409, -0.123796, 0.055210,
-0.098973, -0.034145, 0.052178, 0.131509, -0.037693,
0.044694, -0.023161, 0.005800, -0.141310, -0.012245,
0.184772, -0.098049, -0.154527, 0.195311, 0.145655,
0.099465, -0.174075, 0.192918, -0.068933, -0.143525},
{-0.060778, 0.055740, 0.088327, 0.040254, -0.012506,
0.214823, -0.054211, 0.028580, -0.062578, 0.062803,
-0.195928, 0.089170, -0.104766, 0.005199, -0.100068,
-0.119735, -0.191318, -0.090582, 0.039863, 0.070813,
0.186740, 0.087480, -0.219826, -0.096662, 0.000951,
-0.261450, -0.017906, -0.048780, 0.053088, 0.078009,
0.115528, -0.005575, -0.009188, 0.176039, 0.218530,
-0.025600, 0.033588, -0.089599, 0.020791, 0.100739},
{-0.076643, -0.003437, -0.013056, -0.079689, -0.071113,
0.173296, -0.117988, -0.066838, -0.168547, -0.026234,
0.023480, -0.069835, 0.018212, -0.089650, 0.111504,
-0.019748, 0.062012, 0.203651, 0.027630, 0.118083,
0.008768, -0.047952, -0.109822, -0.055457, 0.100392,
0.070526, -0.121105, -0.036054, -0.147873, 0.014376,
0.081282, -0.092077, -0.299010, 0.053782, 0.307327,
0.037548, 0.013553, 0.012098, 0.080340, 0.194269},
{ 0.145778, -0.035171, -0.012813, 0.011288, -0.104526,
0.107178, 0.002405, 0.149185, -0.034991, 0.159099,
-0.214392, 0.177113, -0.174376, -0.125208, -0.009375,
-0.167677, 0.034455, 0.042755, 0.124278, -0.057184,
0.029397, 0.011394, 0.059449, 0.051856, -0.119031,
0.171241, -0.054828, -0.110516, -0.119424, 0.111108,

-0.031403, 0.269853, -0.035512, -0.029505, 0.028640,
-0.138673, -0.043852, -0.180966, 0.095736, 0.017216},
{-0.156350, -0.007272, -0.060885, 0.144463, 0.141658,
0.060423, 0.041233, 0.076823, -0.103529, 0.026638,
-0.061046, 0.084132, -0.035707, 0.200313, 0.004552,
0.130998, -0.019343, -0.187960, 0.026747, -0.038128,
-0.175123, 0.011099, 0.015914, -0.057416, 0.143100,
-0.107010, -0.123022, -0.015558, 0.030280, -0.073788,
-0.046136, -0.139745, 0.216388, 0.208324, -0.190284,
0.207782, -0.118317, -0.050262, 0.048587, -0.052573},
{ 0.165122, 0.151676, -0.173564, -0.112602, -0.077080,
0.059202, -0.039395, 0.092122, 0.036914, -0.106747,
0.026758, -0.075714, -0.061968, 0.171587, -0.179532,
-0.221919, 0.067364, -0.168832, -0.005609, 0.038886,
-0.020248, -0.055190, -0.010993, 0.150090, -0.063108,
0.080500, -0.061449, 0.076655, -0.072982, 0.148202,
0.032169, 0.194680, 0.047698, 0.110655, 0.159702,
0.060739, -0.033952, -0.002372, -0.100670, -0.226797},
{-0.004884, 0.039917, 0.007048, -0.057134, -0.069690,
0.107883, 0.022693, 0.161403, 0.072354, 0.146004,
-0.179598, -0.051756, 0.091652, 0.187559, -0.218109,
-0.012090, 0.201459, -0.003574, -0.093868, -0.186445,
-0.029635, 0.020643, 0.002809, -0.042532, -0.019091,
0.051347, 0.083461, -0.199734, 0.053807, -0.091675,
0.042568, -0.091821, 0.118660, 0.091599, -0.113841,
-0.089584, 0.171276, 0.086920, -0.242580, 0.036581},
{ 0.063443, -0.111705, -0.161460, 0.057088, -0.150777,
0.100319, 0.001226, -0.223638, 0.119079, -0.112969,
-0.058934, 0.266023, -0.023775, -0.013164, 0.142328,
0.184226, -0.061167, -0.083061, -0.105554, 0.081692,
-0.020353, 0.061163, 0.175058, 0.158439, -0.104639,
-0.111540, 0.104562, 0.075431, 0.119800, 0.054572,
-0.203585, -0.113775, -0.072451, -0.034755, 0.021198,
0.003955, -0.072513, 0.042772, 0.027221, -0.019781},
{-0.035894, -0.147947, 0.130019, 0.151861, 0.063417,
-0.099816, 0.059408, -0.133444, 0.037317, 0.055950,
0.126182, 0.145038, 0.096625, -0.125091, 0.121556,
-0.107565, -0.111177, 0.334839, -0.021953, -0.046918,
0.055746, -0.075661, 0.073101, -0.007925, -0.009413,
-0.060847, 0.019674, -0.117516, 0.116550, -0.057020,

.

-0.048908, -0.102843, -0.041116, 0.193840, 0.068291,

-0.231657, -0.087831, -0.039631, -0.108096, -0.031144},

{-0.067140, 0.115233, -0.056616, -0.133510, 0.037545,

-0.141381, 0.016872, 0.159134, 0.023496, 0.094566,

0.028914, -0.039531, 0.140349, -0.185376, 0.329690,

0.027097, 0.079849, -0.040461, -0.119043, -0.198733,

0.161095, -0.155212, -0.082065, -0.014902, -0.116972,

0.026419, 0.009974, -0.071289, 0.056791, -0.111439,

-0.068277, 0.095871, 0.021713, 0.050967, 0.148007,

0.056072, -0.006431, 0.039573, 0.077210, -0.188060},

{-0.021627, -0.127239, 0.057710, 0.094173, 0.114361,

-0.093565, -0.053670, 0.119475, 0.019379, -0.038257,

-0.019357, 0.016154, 0.080195, -0.048479, -0.084186,

0.005792, 0.017708, -0.006798, 0.067724, 0.259880,

0.119032, -0.133580, -0.042929, -0.189572, -0.092819,

0.118637, 0.163395, 0.235459, -0.084208, 0.085962,

-0.059652, 0.137989, 0.116113, -0.039734, -0.243977,

-0.009411, -0.125925, -0.111694, -0.046045, -0.156416},

{ 0.202529, -0.022764, -0.087492, -0.001779, -0.180078,

0.144326, -0.070131, 0.052585, -0.014719, -0.180407,

-0.105484, 0.022611, 0.112231, 0.048219, 0.096614,

-0.100258, 0.182341, 0.259642, 0.139998, -0.161151,

0.057568, 0.049277, -0.053023, -0.002871, -0.071218,

0.032438, 0.019060, 0.092027, 0.018050, 0.007029,

0.038061, -0.044412, -0.205987, 0.069402, -0.034018,

0.024287, 0.102516, -0.065164, -0.132652, -0.237199},

{-0.086428, 0.126977, 0.015658, 0.078085, 0.169923,

-0.042330, 0.080504, 0.184454, -0.116599, -0.101825,

-0.019898, 0.029187, -0.086805, -0.065623, -0.227098,

-0.161420, 0.020457, 0.178183, -0.054298, 0.217385,

-0.023337, -0.090671, 0.092256, -0.118044, 0.226933,

-0.067590, -0.013062, 0.009296, -0.133427, 0.089791,

-0.016346, 0.227444, -0.105377, 0.011219, -0.103441,

-0.063450, -0.008793, -0.016484, -0.086660, 0.051254},

{ 0.288967, -0.037760, -0.002823, -0.181016, 0.139797,

-0.058906, -0.107586, -0.145766, 0.093240, 0.029793,

-0.217238, 0.181808, -0.058832, -0.080496, -0.060148,

0.044365, -0.080336, 0.044204, 0.092757, 0.053558,

0.068310, 0.054278, 0.069427, -0.185461, -0.034244,

-0.020880, 0.144972, -0.173171, -0.003225, -0.046869,

0.031356, 0.072274, 0.090069, -0.072320, -0.068152,
-0.102144, 0.113796, -0.002896, -0.084489, 0.211787},
{-0.004676, 0.012451, -0.068412, -0.050948, 0.094113,
-0.137877, 0.163079, 0.072970, -0.073769, -0.001954,
-0.079508, 0.132505, 0.085707, -0.066978, -0.009364,
0.139783, -0.035495, -0.015433, -0.019735, -0.137403,
-0.027935, 0.214683, -0.175540, 0.129600, 0.152334,
-0.171772, 0.110761, -0.080756, 0.109677, -0.064781,
0.092547, 0.083756, 0.084066, -0.154640, -0.126653,
0.170413, -0.001756, -0.266171, -0.080608, 0.003719},
{-0.142812, 0.178916, 0.030481, -0.018707, -0.014087,
-0.178494, 0.057415, -0.072685, 0.036600, 0.123870,
-0.160648, 0.053520, -0.049866, -0.076900, 0.146260,
0.121778, -0.002098, -0.102769, -0.145513, -0.094709,
0.014600, 0.150337, 0.129071, -0.215866, -0.068744,
-0.032681, 0.158858, -0.167257, 0.043318, 0.160275,
-0.149350, 0.071964, 0.072390, -0.036869, -0.115464,
-0.033315, 0.218166, 0.003469, 0.039092, 0.068452},
{-0.113242, 0.029370, 0.151963, -0.137299, 0.140645,
-0.186259, -0.063780, -0.049865, 0.077783, -0.098684,
0.105277, -0.131765, -0.040499, 0.187960, -0.060280,
0.168357, -0.180927, -0.073977, 0.016167, 0.119988,
0.249310, 0.160828, 0.016432, -0.104951, -0.103452,
-0.085361, 0.045284, 0.003648, -0.098853, 0.014016,
-0.158963, 0.053626, 0.102125, 0.110043, 0.032758,
-0.066453, 0.112142, -0.020935, 0.014141, -0.136316},
{-0.142626, 0.116170, 0.156714, -0.046193, -0.092763,
0.059522, 0.095298, -0.191132, 0.171992, 0.089482,
0.031693, -0.028470, -0.182267, -0.114526, -0.115156,
-0.087294, 0.101460, 0.134756, 0.211311, -0.072667,
-0.184874, 0.016518, 0.073661, 0.117918, -0.099371,
-0.169612, 0.094926, 0.043618, -0.113961, 0.139652,
-0.032290, -0.042327, 0.049550, -0.030139, -0.105134,
0.165565, -0.024617, -0.008021, -0.081065, 0.094700},
{ 0.096715, 0.073130, -0.192145, -0.024840, -0.033337,
-0.146108, 0.030637, 0.013074, 0.053903, 0.179474,
-0.092141, -0.136250, -0.021751, -0.075464, 0.041988,
0.123680, 0.164398, -0.098024, 0.143563, 0.257533,
0.011460, -0.139854, -0.170764, 0.002622, 0.077216,
-0.098878, 0.013664, 0.192634, -0.168319, -0.019956,

0.086204, -0.133177, -0.056676, -0.069633, 0.039126,

0.024861, 0.200507, -0.017833, -0.072507, -0.058732},

{ 0.188312, 0.211973, -0.026577, -0.030511, -0.005324,

-0.089297, -0.108139, -0.100579, -0.092361, -0.086512,

-0.176998, 0.033879, -0.072401, -0.108418, 0.254736,

-0.068285, 0.077788, 0.021740, -0.154785, 0.031473,

0.161897, 0.099157, 0.003835, 0.202560, -0.068410,

-0.028448, 0.166791, 0.157988, -0.081325, -0.096342,

0.113814, -0.053872, -0.037803, 0.003019, -0.105415,

-0.105963, 0.110935, -0.121537, -0.051934, 0.031338},

{-0.005902, -0.025566, 0.090201, -0.202733, -0.087222,

0.025591, 0.088656, -0.075759, 0.102605, -0.043815,

0.098726, -0.172410, -0.058015, 0.136373, 0.073529,

-0.267444, -0.089580, -0.132521, -0.121546, 0.030034,

0.125941, -0.115521, 0.218909, 0.161758, 0.013384,

0.090387, -0.053082, -0.045271, 0.031092, 0.002709,

-0.093612, 0.150086, -0.043744, 0.207734, 0.059490,

0.013707, -0.009697, -0.101506, 0.130092, -0.106058},

{-0.031557, -0.216984, -0.117630, 0.043260, 0.010493,

-0.077562, -0.011722, -0.012750, -0.006706, -0.116933,

-0.037242, 0.043246, 0.189936, -0.001128, 0.348653,

-0.114783, 0.103494, 0.065052, 0.017331, 0.216982,

-0.124355, 0.116175, 0.021859, 0.140445, -0.080528,

-0.021540, -0.059484, -0.039156, -0.003790, -0.013488,

0.024023, 0.127027, -0.085937, 0.029984, 0.005821,

0.113871, -0.155281, -0.188480, -0.138627, 0.038015},

{-0.055477, -0.078725, -0.227185, -0.069835, -0.083334,

-0.103103, 0.126817, 0.097232, -0.148670, -0.003821,

-0.014695, -0.006567, 0.220706, 0.003373, -0.233583,

-0.059080, 0.096967, 0.105144, 0.074281, 0.062384,

-0.238312, -0.011260, -0.087787, 0.053234, 0.114154,

-0.087050, -0.067738, 0.054583, 0.087169, 0.026215,

0.022347, -0.002260, 0.024900, -0.085700, 0.274932,

-0.029898, 0.187180, 0.083484, -0.032945, 0.011922},

{ 0.060811, -0.013551, 0.132393, 0.173236, -0.134129,

-0.025827, 0.146442, -0.144697, -0.165687, -0.041179,

-0.069049, 0.065456, 0.066934, -0.111799, -0.155041,

0.017693, 0.018106, 0.011958, -0.101361, 0.135540,

-0.026952, -0.072444, -0.099615, 0.048850, 0.074227,

-0.006388, 0.274960, -0.180664, -0.035351, 0.147379,

```
        -0.077568, 0.066921, -0.091179, 0.128088, -0.035639,
        -0.050608, -0.081541, 0.011615, 0.254577, -0.114920},
      { 0.092684, -0.170455, -0.066080, -0.104846, 0.063964,
        -0.118125, -0.082160, 0.039378, 0.211586, -0.185354,
        -0.185207, -0.020687, 0.064207, 0.086469, 0.054981,
        -0.041209, 0.119450, 0.052270, -0.011401, -0.010358,
        0.021328, 0.047320, 0.163357, -0.063909, -0.043402,
        -0.037520, -0.080772, -0.077397, -0.043713, 0.170929,
        0.173935, -0.110798, 0.010913, -0.267308, 0.154860,
        -0.004086, -0.048883, 0.062513, -0.033936, 0.217462},
      {-0.102219, -0.085821, 0.120788, -0.004709, 0.153764,
        -0.015832, 0.044615, -0.050922, 0.151970, -0.269232,
        -0.103572, 0.024964, 0.075853, -0.028581, 0.045409,
        -0.060437, 0.030973, -0.070224, 0.212762, -0.005720,
        0.013756, 0.014138, 0.182639, -0.017510, 0.022836,
        -0.192755, -0.200316, -0.034771, 0.217484, -0.066266,
        0.050939, 0.024386, -0.037975, 0.057006, -0.169418,
        0.126019, 0.006018, 0.021719, -0.195182, 0.113427},
      {-0.036546, 0.066393, -0.168702, 0.006627, -0.003036,
        0.003457, -0.305420, -0.074054, 0.088384, -0.033983,
        -0.021283, -0.202710, 0.144675, -0.032790, -0.047744,
        -0.008852, 0.142740, 0.106081, 0.060695, -0.062153,
        -0.168554, 0.085919, -0.085650, -0.138377, 0.021096,
        -0.215684, 0.191959, 0.063860, 0.009517, 0.035008,
        0.177654, 0.126762, 0.055212, -0.008992, 0.022952,
        0.056175, -0.012106, 0.205292, 0.021328, -0.065147},
      { 0.169865, 0.014836, -0.046132, -0.082306, -0.043342,
        -0.145627, -0.056395, -0.148761, -0.028014, 0.116402,
        -0.105617, -0.134907, 0.026502, 0.230587, -0.190304,
        -0.022587, -0.063537, 0.080261, 0.000346, -0.228381,
        0.112714, 0.047662, 0.114726, 0.127581, -0.164887,
        -0.011701, -0.071580, -0.011703, -0.050086, 0.012629,
        0.172233, 0.024553, 0.097856, -0.045110, 0.028485,
        0.053387, 0.206829, 0.082417, 0.106178, -0.175071}};
/*-------------------------------------------------------------------*/
/*===================================================================*/
/*-------------------------- END --------------------------*/
/*===================================================================*/
```

```
/*=============================================================*/


/*=============================================================*/
/* Conexant System Inc.                    */
/* 4311 Jamboree Road                      */
/* Newport Beach, CA 92660                  */
/*---------------------------------------------*/
/* Copyright(C) 2000 Conexant System Inc.            */
/*---------------------------------------------*/
/* ALL RIGHTS RESERVED:                     */
/* No part of this software may be reproduced in any form or by any */
/* means or used to make any derivative work (such as transformation */
/* or adaptation) without the authorisation of Conexant System Inc.  */
/*=============================================================*/
/* LIBRARY: lsf_vq.tab                     */
/*=============================================================*/


/*---------------------------------------------*/
/*------------------ TABLES ------------------*/
/*---------------------------------------------*/
/*=============================================================*/


/*=============================================================*/
/* Conexant System Inc.                    */
/* 4311 Jamboree Road                      */
/* Newport Beach, CA 92660                  */
/*---------------------------------------------*/
/* Copyright(C) 2000 Conexant System Inc.            */
/*---------------------------------------------*/
/* ALL RIGHTS RESERVED:                     */
/* No part of this software may be reproduced in any form or by any */
/* means or used to make any derivative work (such as transformation */
/* or adaptation) without the authorisation of Conexant System Inc.  */
/*=============================================================*/
/* FILE:  FLOAT64 B_08k                    */
/*=============================================================*/


FLOAT64 B_08k[LP_08k][LQMA_08k][MAXLNp] = {
   {
```

```
{
    0.78697605 ,    0.84277373 ,    0.84833453 ,    0.86612158 ,    0.89184674 ,    0.86520149 ,
    0.83213462 ,    0.82649626 ,    0.81292217 ,    0.74918146},
{
    0.48850325 ,    0.51792467 ,    0.54458026 ,    0.57964919 ,    0.65907100 ,    0.62423454 ,
    0.57897302 ,    0.57510412 ,    0.53272744 ,    0.49711640},
{
    0.27060547 ,    0.28492453 ,    0.30887250 ,    0.34767876 ,    0.41578426 ,    0.39193895 ,
    0.36463786 ,    0.34570964 ,    0.31077734 ,    0.30569519},
{
    0.10931949 ,    0.11859086 ,    0.13932375 ,    0.16531784 ,    0.19670950 ,    0.19308363 ,
    0.17434501 ,    0.16239619 ,    0.14627386 ,    0.14728680},
},
};


/*=================================================================*/


/*=================================================================*/
/* Conexant System Inc.                        */
/* 4311 Jamboree Road                          */
/* Newport Beach, CA 92660                      */
/*-----------------------------------------------*/
/* Copyright(C) 2000 Conexant System Inc.             */
/*-----------------------------------------------*/
/* ALL RIGHTS RESERVED:                        */
/* No part of this software may be reproduced in any form or by any */
/* means or used to make any derivative work (such as transformation */
/* or adaptation) without the authorisation of Conexant System Inc. */
/*=================================================================*/
/* FILE:  FLOAT64 B_40k                         */
/*=================================================================*/


FLOAT64 B_40k[LP_40k][LQMA_40k][MAXLNp] = {
{
{
    0.45782564 ,   0.59002827 ,   0.73704688 ,   0.73388197 ,   0.75903791 ,   0.74076479 ,   0.65966007
    ,   0.58070788 ,   0.52280647 ,   0.42738207},
{
```

```
        0.19087084,    0.26721569,    0.38110463,    0.39655069,    0.43984539,    0.42178869,    0.34869783
    ,   0.28691864,    0.23847475,    0.17468375},
    {
        0.13428787,    0.16384420,    0.23402430,    0.25625744,    0.29236925,    0.27922926,    0.22702581
    ,   0.18550745,    0.15394289,    0.11524615},
    {
        0.10410849,    0.10475287,    0.13371967,    0.16283702,    0.18493450,    0.17783386,    0.14728004
    ,   0.11948265,    0.10261001,    0.08146250},
    },
    {
    {
        0.14936742,    0.25397094,    0.42536339,    0.40318214,    0.39778242,    0.34731435,    0.22773174
    ,   0.17583478,    0.12497067,    0.11001108},
    {
        0.09932127,    0.15389237,    0.24021347,    0.24507006,    0.26478926,    0.23018456,    0.15178193
    ,   0.11368182,    0.07674584,    0.06122567},
    {
        0.07376684,    0.10618676,    0.16013783,    0.17315564,    0.19320946,    0.16507346,    0.10600940
    ,   0.07680543,    0.05146135,    0.03790307},
    {
        0.06434994,    0.08328096,    0.10640056,    0.12536714,    0.13771986,    0.11589609,    0.07617342
    ,   0.05429825,    0.03843949,    0.03049829},
    },
};


/*=============================================================================*/


/*=============================================================================*/
/* Conexant System Inc.                      */
/* 4311 Jamboree Road                        */
/* Newport Beach, CA 92660                     */
/*------------------------------------------------*/
/* Copyright(C) 2000 Conexant System Inc.           */
/*------------------------------------------------*/
/* ALL RIGHTS RESERVED:                        */
/* No part of this software may be reproduced in any form or by any  */
/* means or used to make any derivative work (such as transformation */
/* or adaptation) without the authorisation of Conexant System Inc.  */
/*=============================================================================*/
/* FILE:  FLOAT64 B_85k                      */
```

887

```
/*====================================================================*/


FLOAT64 B_85k[LP_85k][LQMA_85k][MAXLNp] = {
   {
   {
     0.12600104,  0.20991762,  0.34262841,  0.34478999,  0.36982213,  0.34486193,  0.25866520
   ,   0.19844608,   0.15549710,   0.10873224},
     {
     0.09497737,  0.14557657,  0.23054897,  0.24608043,  0.27811978,  0.25669288,  0.18951165
   ,   0.14322552,   0.10976944,   0.07578385},
   },
   };


/*====================================================================*/


/*====================================================================*/
/* Conexant System Inc.                          */
/* 4311 Jamboree Road                            */
/* Newport Beach, CA 92660                        */
/*----------------------------------------------*/
/* Copyright(C) 2000 Conexant System Inc.           */
/*----------------------------------------------*/
/* ALL RIGHTS RESERVED:                          */
/* No part of this software may be reproduced in any form or by any  */
/* means or used to make any derivative work (such as transformation */
/* or adaptation) without the authorisation of Conexant System Inc.  */
/*====================================================================*/
/* FILE:  FLOAT64 CBes_08k                        */
/*====================================================================*/


FLOAT64 CBes_08k[MAXLTT_08k][LMSMAX_08k][MAXLNp] = {
   { {   0.00269624,   0.00462087,  -0.00621642,   0.00078393,   0.00203606,  -0.00385235,  -
   0.00063855,  -0.00073735,   0.00002790,  -0.00040057},
     {  -0.00012394,  -0.00089956,  -0.00388915,  -0.00432538,  -0.00236658,  -0.00101884,  -
   0.00111489,  -0.00046467,  -0.00063866,  -0.00059119},
     {  -0.00091016,   0.00047345,   0.00289452,   0.00103649,  -0.00014311,  -0.00025130,  -
   0.00192196,  -0.00149023,   0.00030132,  -0.00024519},
     {  -0.00259585,  -0.00289246,  -0.00766695,  -0.00713197,   0.00507416,   0.00050759,  -
   0.00035725,  -0.00001324,   0.00003991,   0.00018587},
```

{   -0.00261708,   -0.00708436,   -0.00241436,   0.00289209,   0.00368781,   0.00275999,
0.00069364,   0.00112643,   0.00040431,   0.00059968},
{   0.00260231,   0.00259305,   0.01015206,   0.01053691,   0.00816243,   0.00244675,
0.00002146,   0.00051176,   -0.00072191,   0.00095204},
{   0.00086895,   0.00419154,   0.00104835,   -0.00633587,   0.00568223,   0.00322531,
0.00133821,   0.00097780,   0.00104668,   0.00127673},
{   -0.00387241,   -0.00378492,   0.00043591,   -0.00710766,   -0.00551754,   -0.00367991,   -
0.00182042,   -0.00122951,   -0.00064698,   -0.00034216},
{   0.00459307,   0.01194545,   0.00266756,   0.00170909,   -0.00010835,   -0.00194941,   -
0.00260933,   -0.00076864,   -0.00036982,   -0.00138988},
{   -0.00180246,   0.00572317,   0.00494218,   -0.00200888,   -0.00363662,   -0.00552244,   -
0.00125745,   -0.00142807,   -0.00116519,   -0.00105954},
{   -0.00700839,   -0.01278847,   -0.00523787,   -0.00443510,   -0.00440996,   -0.00465344,   -
0.00353442,   -0.00161417,   -0.00096975,   -0.00051261},
{   0.00070303,   0.00616162,   -0.00457122,   -0.01058358,   -0.00684058,   -0.00639819,   -
0.00173663,   -0.00185740,   -0.00100444,   -0.00115079},
{   -0.00451619,   -0.00642493,   0.00633218,   0.00433383,   -0.00216043,   -0.00197399,   -
0.00291948,   -0.00146477,   0.00004796,   -0.00008603},
{   -0.00139753,   -0.00327792,   -0.00410406,   0.00047675,   -0.00586987,   -0.00831267,   -
0.00310294,   -0.00191523,   -0.00096847,   -0.00098327},
{   0.00163188,   0.00087564,   0.00403069,   0.00512087,   -0.00835469,   -0.00591542,   -
0.00381267,   -0.00157757,   -0.00049671,   -0.00114209},
{   -0.00415972,   -0.00603362,   -0.00972475,   -0.01204002,   -0.00696619,   -0.00547653,   -
0.00232354,   -0.00129666,   -0.00119452,   -0.00056966},
},
{{   -0.00027304,   -0.00013603,   -0.00068813,   0.00046191,   -0.00018108,   -0.00143655,   -
0.00143265,   -0.00096053,   -0.00029350,   -0.00041718},
{   0.00327783,   -0.00262084,   -0.00072357,   -0.00152624,   -0.00289651,   0.00242678,   -
0.00709684,   -0.00418617,   -0.00134299,   -0.00114547},
{   0.00178766,   0.00272996,   -0.00424907,   -0.00511227,   -0.00350740,   -0.00574813,   -
0.00298479,   -0.00178375,   -0.00080082,   -0.00091910},
{   -0.00257793,   0.00036133,   0.00264883,   -0.00468006,   -0.00843945,   -0.01043396,   -
0.00919476,   -0.00608852,   -0.00215225,   -0.00192788},
{   -0.00275632,   -0.00064226,   -0.00106406,   -0.00928170,   0.00164921,   0.00177093,   -
0.00330921,   -0.00201606,   -0.00095143,   -0.00074924},
{   0.00098576,   0.00333945,   0.00294397,   -0.00296495,   0.00327592,   0.00031042,   -
0.00304436,   -0.00168756,   -0.00096723,   -0.00066603},
{   -0.00081979,   -0.00166735,   0.00165792,   -0.00361096,   -0.00656657,   0.00213311,
0.00599592,   0.00224467,   0.00019724,   0.00058344},

EP 1 214 706 B1

```
{   -0.00262302,   -0.00197884,    0.00408661,    0.00254664,    0.00058009,    0.00165419,   -
0.00323605,   -0.00381683,   -0.00056288,   -0.00073670},
{   -0.00525909,    0.00144658,    0.00107922,   -0.00301434,   -0.00120794,   -0.00757923,
0.00258690,    0.00014788,    0.00002495,   -0.00031900},
{   -0.00140917,   -0.00409651,    0.00156973,   -0.00483243,    0.00213094,   -0.00734331,   -
0.00348049,    0.00042759,   -0.00052304,   -0.00025610},
{   -0.00026987,   -0.00162823,    0.00194360,    0.00486534,   -0.00358061,   -0.00978809,
0.00031236,    0.00027704,   -0.00069589,   -0.00070222},
{   -0.00250411,    0.00120978,   -0.00274384,    0.00233910,    0.00139088,   -0.00736257,   -
0.00754632,   -0.00465566,   -0.00148867,   -0.00220448},
{    0.00000985,    0.00354670,    0.00241602,    0.00381914,   -0.00498555,    0.00034259,
0.00007178,   -0.00160886,   -0.00018617,   -0.00073934},
{   -0.00030544,    0.00020933,    0.00356684,   -0.00290166,   -0.00629055,   -0.00501993,   -
0.00710975,   -0.00422976,   -0.00177327,   -0.00156522},
{   -0.00226254,   -0.00391714,   -0.00326461,   -0.00151939,   -0.00365321,   -0.00340561,   -
0.00355831,   -0.00279590,   -0.00107019,   -0.00087203},
{   -0.00319889,    0.00356115,   -0.00255526,   -0.00187794,   -0.00567546,   -0.00040661,   -
0.00596883,   -0.00525175,   -0.00086633,   -0.00158737},
},
{{    0.00007492,    0.00274526,    0.00053401,    0.00097771,    0.00018040,   -0.00303219,   -
0.00170872,   -0.00089653,   -0.00020116,   -0.00062042},
{   -0.00201631,   -0.00125767,   -0.00196945,   -0.00464759,   -0.00288294,   -0.00428708,   -
0.00183602,   -0.00071289,   -0.00093030,   -0.00067826},
{   -0.00223623,   -0.00171246,   -0.00046686,    0.00170002,    0.00244198,    0.00108873,
0.00191275,    0.00055247,    0.00040544,    0.00017678},
{   -0.00149753,   -0.00154993,    0.00079974,    0.00221293,   -0.00553476,   -0.00346923,   -
0.00211231,   -0.00154997,   -0.00037169,   -0.00069879},
{    0.00289225,   -0.00045208,    0.00151539,   -0.00150161,   -0.00144310,   -0.00308428,
0.00211248,    0.00132638,    0.00017002,    0.00056742},
{   -0.00114496,    0.00024257,    0.00315614,   -0.00436637,   -0.00261428,    0.00296444,   -
0.00371535,   -0.00308495,   -0.00033931,   -0.00035859},
{    0.00047727,    0.00066667,   -0.00498548,   -0.00147002,   -0.00211159,    0.00158957,   -
0.00093119,   -0.00238958,   -0.00021992,   -0.00044901},
{   -0.00071416,   -0.00142483,   -0.00099961,   -0.00030932,    0.00108240,   -0.00304381,   -
0.01041545,   -0.00518788,   -0.00149510,   -0.00175121},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
```

```
{   0.00000000,   0.00000000,   0.00000000,   0.00000000,   0.00000000,   0.00000000,
0.00000000,   0.00000000,   0.00000000,   0.00000000},
{   0.00000000,   0.00000000,   0.00000000,   0.00000000,   0.00000000,   0.00000000,
0.00000000,   0.00000000,   0.00000000,   0.00000000},
{   0.00000000,   0.00000000,   0.00000000,   0.00000000,   0.00000000,   0.00000000,
0.00000000,   0.00000000,   0.00000000,   0.00000000},
{   0.00000000,   0.00000000,   0.00000000,   0.00000000,   0.00000000,   0.00000000,
0.00000000,   0.00000000,   0.00000000,   0.00000000},
{   0.00000000,   0.00000000,   0.00000000,   0.00000000,   0.00000000,   0.00000000,
0.00000000,   0.00000000,   0.00000000,   0.00000000},
{   0.00000000,   0.00000000,   0.00000000,   0.00000000,   0.00000000,   0.00000000,
0.00000000,   0.00000000,   0.00000000,   0.00000000},
},
};


/*===========================================================================*/


/*===========================================================================*/
/* Conexant System Inc.                        */
/* 4311 Jamboree Road                          */
/* Newport Beach, CA 92660                      */
/*----------------------------------------------*/
/* Copyright(C) 2000 Conexant System Inc.          */
/*----------------------------------------------*/
/* ALL RIGHTS RESERVED:                      */
/* No part of this software may be reproduced in any form or by any */
/* means or used to make any derivative work (such as transformation */
/* or adaptation) without the authorisation of Conexant System Inc. */
/*===========================================================================*/
/* FILE:  FLOAT64 CBes_40k                      */
/*===========================================================================*/


FLOAT64 CBes_40k[MAXLTT_40k][LMSMAX_40k][MAXLNp] = {
{ {   0.00842379,   0.00868718,   0.01533677,   0.00423439,   -0.00886805,   -0.02132286,   -
0.03152681,   -0.01975061,   -0.01152093,   -0.01341948},
{   0.02528175,   0.04259634,   0.03789221,   0.01659535,   -0.00266498,   -0.01529545,   -
0.01653101,   -0.01528401,   -0.01047642,   -0.01127117},
{   0.00995479,   0.00363859,   0.00806370,   0.00822096,   0.00620995,   -0.00070450,   -
0.01144342,   -0.01579542,   -0.00221153,   -0.00294104},
```

EP 1 214 706 B1

{ 0.01825004, 0.02545979, 0.04466266, 0.02836983, 0.01316085, 0.00027194, -0.00400197, -0.00838218, -0.00375841, -0.00973750},

{ 0.00296122, -0.00108515, -0.01175420, -0.01975204, -0.02622812, -0.03646736, -0.04191239, -0.02314044, -0.01950957, -0.00848902},

{ 0.01074297, 0.00681698, 0.00056120, -0.00407483, -0.01399303, -0.02157338, -0.01318401, -0.01868371, -0.02269936, -0.00789793},

{ 0.00161361, -0.00204469, -0.00577466, -0.00520582, -0.01194833, -0.01701884, -0.02718566, -0.03396933, 0.00356014, 0.00207288},

{ 0.00128185, 0.00071461, -0.00353124, -0.00421683, -0.00402716, -0.01095437, -0.01997320, -0.01228136, -0.01038306, -0.01511933},

{ 0.01263317, 0.00885365, 0.00553783, 0.00332289, 0.00051954, -0.00463222, -0.00479201, -0.00059580, -0.00296811, -0.00742176},

{ 0.02932750, 0.05512251, 0.05469747, 0.03776658, 0.02375761, 0.01262417, 0.00718223, 0.00132870, 0.00011158, -0.00513680},

{ 0.00642743, 0.00434195, 0.02734756, 0.02479522, 0.01571155, 0.01283758, 0.01229307, 0.01044734, 0.00897595, 0.00630824},

{ 0.01460256, 0.03932975, 0.06822591, 0.05302119, 0.04169594, 0.03078633, 0.02255555, 0.01244313, 0.00953978, 0.00142364},

{ -0.00287700, -0.00594367, -0.00427960, -0.00935634, -0.01810575, -0.01295170, -0.00769887, -0.00571883, -0.00874120, -0.01136659},

{ 0.01008734, 0.01526783, 0.00777807, 0.00070427, 0.00135748, -0.00536141, -0.01289474, -0.01106339, -0.01607998, -0.02069269},

{ -0.00328972, -0.00552321, -0.00318850, -0.00178185, -0.00147855, -0.00051298, -0.00279881, 0.00132960, -0.00017352, -0.00197559},

{ 0.00121992, -0.00434412, 0.01514515, 0.01817932, 0.01049800, 0.00520725, 0.00023122, -0.00368011, -0.00530645, -0.00881600},

{ 0.00199953, -0.00256907, -0.01114171, -0.02208218, -0.03765710, -0.02107483, -0.00931923, -0.01498688, 0.00281978, 0.00017816},

{ 0.02318353, 0.02670253, 0.01494551, -0.00435182, -0.01874850, -0.02816325, -0.02151003, -0.01875342, -0.01056712, -0.01030210},

{ 0.00593350, -0.00144199, -0.00319629, 0.00534692, -0.00410015, -0.00689996, -0.00585349, -0.01388552, 0.00983518, 0.00370328},

{ 0.02103832, 0.01958430, 0.01633620, 0.00746899, -0.00235633, -0.00929591, -0.00554876, -0.00612474, -0.00324632, -0.00700581},

{ 0.00234866, -0.00352786, -0.02131325, -0.03497021, -0.05395155, -0.05653978, -0.02600962, -0.01502758, -0.00980138, 0.00243400},

{ 0.01568001, 0.01102804, -0.00170998, -0.02008550, -0.03923722, -0.04625200, -0.02200445, -0.01343909, -0.00778321, -0.00400345},

{ -0.00585802, -0.01166306, -0.02076399, -0.01569569, -0.02319850, -0.02849718, -0.03356291, -0.04020848, -0.00730455, 0.00321833},

892

```
{   0.00185346,    0.00678275,   -0.00153838,   -0.01371849,   -0.01459743,   -0.02278911,   -
0.03180223,   -0.01313531,   -0.01769927,   -0.01864802},
{   0.00821169,    0.00139332,   -0.00460277,   -0.01685032,   -0.02524833,   -0.00457010,
0.00196353,   -0.00415526,    0.00912706,    0.00274897},
{   0.03471515,    0.03244906,    0.01761282,    0.00942270,    0.00084999,   -0.00060117,
0.00424733,    0.00201139,    0.00120962,   -0.00201383},
{   0.00874697,    0.00243208,   -0.00304610,    0.00436503,    0.00711522,    0.00403357,
0.00297985,   -0.00013373,    0.00316739,   -0.00155733},
{   0.03284353,    0.04366651,    0.03130752,    0.02318913,    0.01642637,    0.01414287,
0.01412819,    0.01325717,    0.00966138,    0.00557574},
{  -0.00897348,   -0.01645486,   -0.02303920,   -0.02958479,   -0.04569751,   -0.01492066,   -
0.01361113,   -0.01301319,   -0.00757028,    0.00636876},
{  -0.00187898,    0.00446579,   -0.00080704,   -0.00978002,   -0.02210903,   -0.02856633,   -
0.00962606,   -0.01269407,   -0.00658807,   -0.00520677},
{  -0.00446633,   -0.01073344,   -0.02048699,   -0.03419970,   -0.02140272,   -0.00647786,   -
0.00772629,   -0.00141074,    0.00209371,    0.00587952},
{   0.00902524,    0.00471972,   -0.00531728,   -0.00875254,    0.00077703,   -0.00500107,   -
0.00748311,   -0.00872906,   -0.01258366,   -0.01533540},
{   0.00084134,   -0.00457492,    0.00907268,   -0.00166421,   -0.00738630,   -0.01300070,   -
0.01171425,   -0.00534867,   -0.00189046,   -0.00597370},
{   0.00495534,    0.02747202,    0.02105600,    0.01350886,    0.00672681,    0.00692694,
0.00961278,    0.00731403,    0.00734680,    0.00074704},
{  -0.01085449,    0.00040259,    0.01902320,    0.01121839,    0.01057293,    0.00799889,
0.00903296,    0.00546843,    0.00715537,   -0.00173898},
{   0.00891381,    0.01614815,    0.05052174,    0.03900262,    0.02759091,    0.02061948,
0.01293547,    0.00629289,    0.00473463,   -0.00084806},
{  -0.01427083,   -0.02305916,   -0.02815308,   -0.02282330,   -0.02653827,   -0.01853194,   -
0.01096763,   -0.00407586,   -0.00043150,    0.01353875},
{   0.00451472,   -0.00037789,   -0.00521137,   -0.00857891,   -0.01433970,   -0.02416975,   -
0.02263041,    0.00545231,    0.00509081,   -0.00233034},
{  -0.00732576,   -0.01382500,   -0.02440248,   -0.00600805,   -0.00823324,   -0.01648982,   -
0.00672027,   -0.01575532,    0.00458639,    0.00142685},
{  -0.00584221,    0.00239261,    0.00002187,   -0.00722194,   -0.00486836,   -0.00676743,   -
0.00609408,   -0.00910835,   -0.00233031,   -0.00402547},
{   0.00156682,    0.00529745,    0.01074526,    0.01358844,    0.01228688,    0.01451921,
0.00886985,    0.00921486,    0.00922770,    0.01278627},
{   0.02888988,    0.04401362,    0.04449791,    0.03793522,    0.03615802,    0.03507046,
0.02857499,    0.02323810,    0.01532404,    0.01091717},
{  -0.00673575,    0.00708902,    0.04383843,    0.03175772,    0.02881380,    0.02740709,
0.02920017,    0.02384121,    0.01895719,    0.00803623},
```

{ 0.02514915, 0.05928013, 0.07204149, 0.06324505, 0.05974481, 0.05096021,
0.04377068, 0.03425910, 0.02087256, 0.01162497},

{ -0.00748868, -0.01403437, -0.01834467, -0.02220715, -0.01698717, 0.00975040,
0.01151622, 0.00725551, 0.00642775, 0.00104778},

{ 0.00209732, 0.00931211, 0.00439910, 0.00138879, 0.01378028, 0.00911980,
0.00353992, 0.00010052, 0.00002712, -0.00501547},

{ -0.00165095, -0.00688923, -0.01339332, -0.01799657, 0.00760584, 0.02621803,
0.02225676, 0.01309325, 0.01073847, 0.00333487},

{ 0.01340580, 0.00737926, 0.00937836, 0.00955465, 0.02491769, 0.02088644,
0.01809767, 0.01206103, 0.00688650, -0.00225557},

{ -0.00280285, -0.01027851, -0.02114079, -0.03232847, -0.05019914, -0.01541405,
0.01040407, 0.00488665, 0.00735409, 0.00230072},

{ 0.01769232, 0.01286728, 0.00509533, -0.00385545, -0.01360630, -0.01065628, -
0.00099360, -0.00752588, 0.00392812, 0.00249821},

{ -0.00287736, -0.00927581, -0.01141761, 0.00494131, -0.00006858, 0.00383888,
0.00928349, 0.00680291, 0.01299393, 0.00903792},

{ 0.01338085, 0.00684954, 0.02016501, 0.01396750, 0.00394469, 0.00215369,
0.00532778, 0.00390260, 0.00729791, 0.00281916},

{ -0.00782735, -0.01769183, -0.03956412, -0.04925343, -0.06255674, -0.04770456, -
0.01246839, -0.00352283, -0.00008778, 0.00496558};

{ -0.00043147, -0.00420665, -0.01525085, -0.01865562, -0.02901928, -0.04225189, -
0.01238412, 0.00284584, -0.00262297, -0.00200952},

{ -0.01897721, -0.03002013, -0.04202603, -0.04157439, -0.01953528, -0.00909125, -
0.00557029, 0.00296829, 0.00837520, 0.02272494},

{ -0.00430169, -0.00701750, -0.01399148, -0.01425799, -0.01951155, -0.02099896, -
0.00401286, -0.00855452, 0.00210266, 0.00148451},

{ 0.00089308, -0.00573222, -0.00687366, -0.01404191, -0.02040077, 0.01115878,
0.00754778, 0.00379226, 0.00494852, -0.00162361},

{ 0.02273135, 0.02268721, 0.02202985, 0.01772318, 0.01595899, 0.01831229,
0.02009693, 0.01988832, 0.01756866, 0.01336297},

{ -0.00802140, -0.01147725, 0.01735733, 0.01614599, 0.01890368, 0.02527107,
0.02535296, 0.02521981, 0.01936066, 0.00964759},

{ 0.01101261, 0.02459861, 0.03007775, 0.03132783, 0.02500170, 0.03112715,
0.02820242, 0.02555671, 0.01990715, 0.01604691},

{ -0.01044815, -0.02010963, -0.03231533, -0.05076033, -0.04215723, -0.01116070, -
0.00748550, 0.00002613, 0.00462318, 0.01521166},

{ 0.00336939, -0.00304703, -0.00880680, -0.01591634, -0.02904755, -0.02472976,
0.01099256, 0.00917770, 0.00472864, 0.00252114},

{ -0.01183996, -0.02066113, -0.03460361, -0.04184939, -0.01041113, -0.00188617, -
0.00098410, 0.00161789, 0.00375380, 0.01394438},

```
{   -0.00039830 ,   -0.00466744 ,   -0.01262580 ,   -0.02111370 ,    0.00587910 ,    0.01104953 ,
0.00437385 ,   -0.00111574 ,   -0.00144865 ,   -0.00880168},
{   -0.00912855 ,   -0.00967373 ,    0.00714008 ,    0.00163746 ,   -0.00275357 ,   -0.00691492 ,   -
0.00575918 ,   -0.00602136 ,   -0.00407011 ,   -0.00454880},
{   -0.00255543 ,    0.00614921 ,    0.03687539 ,    0.01820347 ,    0.00124175 ,   -0.00730685 ,   -
0.00935798 ,   -0.01262178 ,   -0.00737867 ,   -0.01012977},
{   -0.01333849 ,   -0.01591748 ,    0.00305090 ,    0.01086912 ,    0.01047755 ,    0.00849883 ,
0.00303463 ,    0.00222270 ,    0.00134141 ,   -0.00025796},
{   -0.00936362 ,   -0.01047446 ,    0.03651876 ,    0.03415287 ,    0.02215632 ,    0.01364159 ,
0.00618621 ,    0.00076102 ,    0.00062994 ,   -0.00592997},
{   -0.00648855 ,   -0.01113029 ,   -0.02130286 ,   -0.02415974 ,   -0.00906372 ,   -0.02048675 ,   -
0.01897523 ,   -0.00729972 ,   -0.01465304 ,   -0.00324484},
{   -0.00073009 ,   -0.00478232 ,   -0.00809012 ,   -0.00674682 ,   -0.00699652 ,   -0.01274285 ,   -
0.01476475 ,   -0.02101635 ,   -0.02841145 ,   -0.00256900},
{   -0.01541940 ,   -0.02257801 ,   -0.01269042 ,   -0.00663735 ,   -0.01383393 ,   -0.01014917 ,   -
0.00815281 ,   -0.00144199 ,   -0.00101933 ,    0.00214340},
{   -0.00430707 ,   -0.01008551 ,   -0.00538098 ,    0.01127611 ,    0.00180862 ,   -0.00383903 ,   -
0.01162061 ,   -0.01239840 ,   -0.02236644 ,   -0.01754571},
{    0.00250399 ,   -0.00145059 ,    0.00744185 ,    0.00239925 ,    0.00187795 ,    0.00368643 ,
0.00341092 ,    0.00234075 ,    0.00295276 ,    0.00274923},
{    0.02220381 ,    0.02667705 ,    0.03016336 ,    0.02484058 ,    0.02302165 ,    0.01687465 ,
0.01248381 ,    0.00801419 ,    0.00575512 ,   -0.00123957},
{   -0.01289551 ,   -0.01948192 ,    0.00749604 ,    0.03972999 ,    0.02799627 ,    0.03095827 ,
0.02682699 ,    0.01926759 ,    0.01536589 ,    0.00359824},
{   -0.00694105 ,   -0.00274076 ,    0.06283919 ,    0.05831478 ,    0.04446961 ,    0.03475004 ,
0.02466616 ,    0.01660218 ,    0.01015739 ,    0.00001262},
{   -0.00663293 ,   -0.01124560 ,   -0.02072134 ,   -0.02087353 ,    0.00350779 ,   -0.00267171 ,   -
0.00781240 ,   -0.00568940 ,   -0.00619713 ,   -0.00664816},
{    0.00052805 ,   -0.00203616 ,   -0.00862252 ,   -0.00794312 ,    0.01109699 ,    0.00296591 ,   -
0.00783946 ,   -0.00642006 ,   -0.01293148 ,   -0.01997245},
{   -0.01385446 ,   -0.02235013 ,   -0.02005617 ,    0.00658714 ,    0.00311085 ,    0.00396594 ,   -
0.00201973 ,    0.00017492 ,    0.00070455 ,    0.00196768},
{    0.00312050 ,   -0.00502734 ,   -0.00391517 ,    0.02334708 ,    0.01492120 ,    0.00609770 ,
0.00166321 ,   -0.00414391 ,    0.00144125 ,   -0.00101720},
{   -0.00548185 ,   -0.00927002 ,   -0.00735945 ,   -0.01104572 ,   -0.01737564 ,   -0.02531887 ,   -
0.02824219 ,   -0.00834746 ,   -0.00524587 ,   -0.00124403},
{    0.00458493 ,    0.01671853 ,    0.00619380 ,   -0.00362342 ,   -0.01016732 ,   -0.01291563 ,   -
0.00905806 ,   -0.00497735 ,    0.00129131 ,   -0.00231415},
{   -0.01024597 ,   -0.01324182 ,   -0.00754560 ,   -0.00682415 ,   -0.00605662 ,   -0.00314351 ,   -
0.00866384 ,   -0.00828965 ,   -0.00057488 ,    0.00290604},
```

{    0.00035898,    0.00655540,    0.00886062,    0.00948731,    0.00050215,    -0.00606058,    -
0.00747207,    -0.00688271,    -0.00352236,    -0.00803250},

{    -0.00793173,    -0.01967196,    -0.04026658,    -0.03192191,    -0.04031043,    -0.04440686,    -
0.03706285,    -0.01990808,    -0.00593113,    -0.00039715},

{    -0.00635586,    -0.01153473,    -0.02387486,    -0.02909210,    -0.04337326,    -0.05288439,    -
0.01514696,    -0.00500377,    -0.00569617,    0.00585471},

{    -0.01430856,    -0.02562646,    -0.04221961,    -0.01853589,    -0.01402970,    -0.02227550,    -
0.02219039,    -0.02338731,    -0.00807786,    0.00288073},

{    -0.00998135,    -0.01806646,    -0.02136027,    -0.00730465,    -0.01160051,    -0.01000576,    -
0.01280801,    -0.01978523,    -0.02645340,    0.00062405},

{    -0.00361873,    -0.00711001,    -0.01113611,    -0.01442181,    0.00048802,    -0.00555145,    -
0.00999573,    -0.01397199,    0.00258458,    -0.00163856},

{    0.01608025,    0.02072329,    0.00865589,    0.00419188,    0.00587315,    0.00650795,
0.00746960,    0.00493725,    0.00530017,    0.00091609},

{    -0.00258830,    -0.00860751,    -0.01643995,    -0.00330272,    0.01669732,    0.00724283,
0.00455523,    -0.00064296,    -0.00070869,    -0.00461911},

{    0.00045132,    0.01927470,    0.02936541,    0.02556292,    0.02449298,    0.01514524,
0.00763378,    -0.00025992,    -0.00107520,    -0.00837104},

{    -0.00807614,    -0.01468184,    -0.03526087,    -0.05143390,    -0.01592930,    -0.01986599,    -
0.02407442,    -0.01347152,    -0.00877064,    -0.00363455},

{    0.00179084,    -0.00207469,    -0.02147562,    -0.03247891,    -0.00458303,    -0.00969956,    -
0.01977553,    -0.00722409,    -0.01118867,    -0.01567662},

{    -0.01156613,    -0.01882328,    -0.02689507,    -0.02577053,    -0.00530313,    -0.00582166,    -
0.00599250,    -0.00717979,    -0.00327482,    0.01205451},

{    -0.00629756,    -0.01144468,    -0.01480162,    -0.01132932,    0.00363022,    0.00554277,    -
0.00203589,    -0.00919722,    -0.01756165,    -0.00323606},

{    -0.00505869,    -0.01212584,    -0.01604989,    0.01406907,    0.00703596,    -0.00003723,    -
0.00630506,    -0.01217800,    0.00493628,    -0.00140540},

{    0.01614992,    0.01499725,    0.01847138,    0.01780286,    0.01376991,    0.00696326,    -
0.00071808,    -0.00218387,    0.00076887,    -0.00600070},

{    -0.00922172,    -0.01839712,    -0.01718859,    0.02629952,    0.03169211,    0.02054630,
0.01191487,    0.00581676,    0.00289883,    -0.00428161},

{    0.00130289,    -0.00293433,    0.01502302,    0.03529064,    0.04162203,    0.02984230,
0.01820698,    0.01010425,    0.00515796,    -0.00325531},

{    -0.00803390,    -0.01768812,    -0.04490980,    -0.03476464,    0.00128782,    -0.00700112,    -
0.00889952,    -0.00925927,    -0.01047435,    -0.01210404},

{    -0.00224388,    -0.00885128,    -0.01431027,    0.00056043,    -0.00175653,    -0.00957837,    -
0.00213878,    -0.00217443,    -0.00787601,    -0.01324443},

{    -0.00942789,    -0.02489036,    -0.04548997,    0.00419906,    -0.00204955,    -0.00847809,    -
0.00757134,    -0.01278104,    0.00092336,    -0.00456560},

{   -0.00862279 ,   -0.01784181 ,   -0.03137311 ,   -0.01016528 ,   0.02029932 ,   0.01087722 ,
0.00126383 ,   -0.00187619 ,   -0.00820948 ,   -0.01128958},

{   -0.00214451 ,   -0.01012148 ,   -0.00815792 ,   0.03032796 ,   0.02118089 ,   0.01465145 ,
0.01434881 ,   0.00924109 ,   0.01234463 ,   0.00621214},

{   0.01901068 ,   0.02546003 ,   0.03184928 ,   0.02975200 ,   0.03929600 ,   0.03399356 ,
0.02994347 ,   0.02317742 ,   0.01472360 ,   0.00403768},

{   -0.00706920 ,   -0.01106330 ,   0.02697666 ,   0.04237599 ,   0.04876120 ,   0.05446952 ,
0.04454959 ,   0.03625874 ,   0.02458257 ,   0.01328984},

{   0.00584135 ,   0.02277180 ,   0.05493147 ,   0.04792701 ,   0.05513066 ,   0.05228310 ,
0.04242706 ,   0.03760509 ,   0.02533449 ,   0.01376458},

{   -0.00832225 ,   -0.01877720 ,   -0.04596338 ,   -0.05353089 ,   0.00746299 ,   0.02192792 ,
0.01409321 ,   0.00663039 ,   0.00261977 ,   -0.00681113},

{   0.00048273 ,   -0.00539747 ,   -0.00945376 ,   0.00004885 ,   0.02869582 ,   0.02042802 ,
0.00703972 ,   0.00314249 ,   -0.00177051 ,   -0.00789829},

{   -0.01064635 ,   -0.02694699 ,   -0.04942587 ,   -0.00398838 ,   0.02460442 ,   0.01967373 ,
0.01925711 ,   0.01424337 ,   0.01004813 ,   0.00270193},

{   -0.00332860 ,   -0.01091961 ,   -0.01848431 ,   -0.00486287 ,   0.04553311 ,   0.03898003 ,
0.02721398 ,   0.02015112 ,   0.01086293 ,   0.00201390},

{   -0.00652335 ,   -0.01144519 ,   -0.01534182 ,   -0.01807526 ,   -0.02371538 ,   -0.00915732 ,   -
0.00588846 ,   -0.00487463 ,   -0.00623341 ,   0.00441392},

{   0.00716741 ,   0.00382678 ,   -0.00052349 ,   -0.00409624 ,   -0.01208226 ,   -0.01751940 ,
0.00470209 ,   0.00223712 ,   -0.00350926 ,   -0.00490031},

{   -0.01538645 ,   -0.02243737 ,   -0.00924649 ,   0.00355542 ,   0.00165311 ,   0.00918893 ,
0.00653865 ,   0.00877182 ,   0.00712893 ,   0.00802341},

{   -0.00267666 ,   -0.00919867 ,   0.00496288 ,   0.01178975 ,   0.00884084 ,   0.01289639 ,
0.01257300 ,   0.00820578 ,   0.00408443 ,   0.00147009},

{   -0.01264225 ,   -0.02720729 ,   -0.05722194 ,   -0.03947146 ,   -0.03242657 ,   -0.03326879 ,   -
0.00982578 ,   -0.00860058 ,   -0.00088398 ,   0.00086213},

{   -0.00386645 ,   -0.01399853 ,   -0.03824488 ,   -0.02228856 ,   -0.02298534 ,   -0.03454881 ,   -
0.00544705 ,   -0.01098026 ,   -0.01050510 ,   -0.00581305},

{   -0.01967032 ,   -0.03639457 ,   -0.04382661 ,   0.00038419 ,   0.00103522 ,   0.00788552 ,
0.00487504 ,   0.00554907 ,   0.00846038 ,   0.00736618},

{   -0.01839912 ,   -0.02937407 ,   -0.03617522 ,   -0.01499036 ,   -0.00692504 ,   0.00184427 ,   -
0.00044529 ,   0.00611089 ,   0.00796965 ,   0.01773673},

{   -0.00683449 ,   -0.01304168 ,   -0.02052076 ,   -0.01609455 ,   -0.00102776 ,   -0.00319254 ,
0.01275266 ,   0.00963052 ,   0.00370009 ,   -0.00121833},

{   0.01103437 ,   0.00541947 ,   0.00506780 ,   -0.00383360 ,   -0.00847884 ,   0.00753648 ,
0.01370641 ,   0.01064539 ,   0.01309200 ,   0.00628886},

{   -0.00977018 ,   -0.01846998 ,   -0.02291703 ,   0.00347842 ,   0.01944544 ,   0.01631708 ,
0.02954462 ,   0.02392258 ,   0.01608993 ,   0.00555268},

```
{    0.00848938,    0.00893435,    0.01777669,    0.01872626,    0.02955171,    0.03076567,
0.03584935,    0.02911589,    0.01758367,    0.00627147},
{   -0.01398691,   -0.02483689,   -0.05063277,   -0.06137782,   -0.01182542,   -0.00872281,   -
0.00491626,   -0.00299305,   -0.00062419,    0.00398992},
{   -0.00631871,   -0.01176534,   -0.02465955,   -0.03502781,    0.00645603,    0.01117879,
0.00357097,    0.00024658,   -0.00036118,   -0.00601290},
{   -0.01238566,   -0.02782555,   -0.06269483,   -0.04600188,    0.00970197,    0.00648747,
0.00596559,    0.00457740,    0.00247241,   -0.00273583},
{   -0.00773967,   -0.01358329,   -0.02234491,   -0.02257646,    0.02203643,    0.02084404,
0.01128873,    0.00604494,    0.00035335,   -0.00668373},
},
{{    0.00589332,    0.00462334,   -0.00937151,   -0.01478366,    0.00674597,    0.00164302,   -
0.00890749,   -0.00091839,    0.00487032,    0.00012026},
{   -0.00346857,   -0.00100200,   -0.00418711,   -0.01512477,   -0.00104209,   -0.00491133,   -
0.00209555,    0.00045850,    0.00023339,    0.00567173},
{   -0.00028271,    0.00224414,    0.00099960,   -0.01264817,    0.00158111,    0.00022627,   -
0.01842169,   -0.01055957,    0.00042331,   -0.00405902},
{   -0.00390851,   -0.00352008,   -0.00207375,    0.00120978,   -0.00464186,   -0.00376280,   -
0.00221930,   -0.01267883,   -0.00542772,    0.00871528},
{   -0.00382147,   -0.00416908,   -0.00485174,   -0.00203840,    0.00230541,    0.01428577,
0.00348975,   -0.00203438,    0.00540564,    0.00212166},
{   -0.00658368,   -0.00562053,   -0.00032279,   -0.00877305,   -0.00793305,    0.00320924,   -
0.00170063,    0.00284923,    0.00552278,    0.00194940},
{   -0.00306744,   -0.00298506,    0.00275083,   -0.00903488,   -0.00722304,    0.00779413,   -
0.00659414,   -0.01601075,    0.00131982,   -0.00042380},
{   -0.00248310,   -0.00449444,    0.00566261,   -0.00065823,   -0.00872763,   -0.00130268,   -
0.01288316,   -0.00693877,   -0.01220849,   -0.01360034},
{   -0.00072128,    0.00231367,    0.00035512,   -0.01551778,    0.00432592,    0.00565027,
0.00593031,    0.00810666,    0.00899915,    0.00625029},
{   -0.00066179,   -0.00173624,   -0.00431518,   -0.00780679,   -0.00602446,   -0.00298258,
0.00230417,    0.01526494,    0.00530183,    0.00378699},
{    0.01420960,    0.01196404,   -0.00294391,   -0.00888598,    0.00196835,    0.00379997,   -
0.00358727,   -0.00099442,    0.00276169,    0.00178194},
{    0.00321848,    0.00710562,    0.00119961,   -0.00705532,   -0.00591387,   -0.00790931,   -
0.00594289,   -0.00112852,   -0.00141542,    0.00020474},
{    0.00158007,    0.00075190,   -0.00438742,   -0.00815969,   -0.01423721,    0.00789778,   -
0.00626154,   -0.00721660,    0.00986720,    0.00544411},
{    0.00053880,    0.00193110,   -0.00320550,   -0.01120683,   -0.01402005,   -0.00860931,   -
0.00088470,    0.00359764,    0.00639980,    0.00638517},
```

{  0.00514671,  0.00724043,  0.00484854,  -0.00241769,  -0.00502971,  0.00567643,  -0.00615547,  -0.01736942,  0.00360319,  0.00082512},

{  -0.00123535,  0.00317582,  0.00109983,  -0.00277902,  -0.00785073,  -0.00623414,  -0.00634773,  -0.00697720,  -0.00355725,  -0.00067376},

{  -0.00232563,  0.00140314,  -0.00001979,  -0.00260601,  0.00649245,  0.00124911,  -0.00845958,  -0.01423763,  0.00877591,  0.00516649},

{  -0.00033112,  -0.00053678,  -0.00671801,  0.00048873,  -0.00504141,  -0.00520921,  -0.01312229,  -0.01582773,  0.01416822,  0.00967165},

{  -0.00111536,  -0.00099037,  0.00077595,  0.00925548,  0.00657777,  -0.00082887,  -0.02043111,  -0.02532625,  -0.00004947,  0.00413641},

{  0.00223668,  0.00440574,  -0.00389912,  -0.00163039,  -0.00531277,  -0.01246551,  -0.00572137,  -0.01703647,  0.00128153,  -0.00021183},

{  -0.00489011,  -0.00537238,  0.00466282,  0.00913929,  0.00263062,  0.00055262,  -0.00633866,  -0.00173384,  0.00295317,  0.00492165},

{  -0.00518055,  -0.00184590,  -0.00615225,  -0.00513941,  -0.00640695,  -0.00674303,  -0.00939142,  -0.00503372,  -0.00261001,  0.00054585},

{  0.00342481,  0.00123740,  0.00395662,  0.01448936,  -0.00232972,  -0.00130577,  -0.00847327,  -0.01335209,  0.00276921,  -0.00077323},

{  -0.00054923,  -0.00210083,  0.01190224,  0.00837311,  -0.00532849,  -0.01568541,  -0.02727868,  -0.01972403,  -0.00978498,  -0.00572220},

{  0.00127495,  -0.00040612,  -0.00190491,  -0.00183223,  0.00169595,  0.00266085,  0.00532158,  0.00218445,  0.00658819,  0.00644266},

{  0.00234860,  0.00330952,  -0.00328322,  -0.00849035,  -0.00205267,  -0.00707072,  -0.00859310,  0.01122104,  0.01656984,  0.01134028},

{  0.00280211,  0.00477070,  0.00686869,  0.00053437,  -0.00232578,  -0.00783250,  -0.02164326,  0.00027012,  0.01494755,  0.00888127},

{  -0.00069263,  -0.00203166,  0.00079744,  -0.00185686,  -0.00644126,  -0.01254378,  -0.02563748,  0.00489706,  0.00806657,  0.00414407},

{  0.00050861,  -0.00178828,  0.00750363,  0.00202558,  -0.00285327,  0.00807892,  -0.01136765,  0.00086126,  0.01255455,  0.00718041},

{  -0.00388121,  0.00019894,  0.01275788,  -0.01009612,  -0.01482093,  -0.00157354,  -0.00274766,  0.00461392,  0.00591598,  0.00479990},

{  0.00389949,  0.00561890,  0.00164381,  0.00179842,  -0.01061784,  -0.00488127,  0.00294474,  -0.00246773,  0.00633013,  0.00082486},

{  -0.00182684,  0.00331154,  0.01501940,  -0.00102040,  -0.01454819,  -0.01631174,  -0.00713666,  -0.00529551,  0.00133896,  -0.00110141},

{  0.00707108,  0.00404909,  -0.00897539,  -0.00171521,  -0.00538120,  0.00675914,  0.00805150,  0.00315939,  0.00552084,  0.00303929},

{  0.00097440,  0.00046715,  -0.01037887,  -0.00704198,  -0.00189990,  -0.01032341,  0.00730091,  0.00133774,  0.00755266,  0.00594051},

{   -0.00429144,   -0.00107703,   -0.00272150,   0.00592237,   0.00373714,   -0.00153810,   -0.00265470,   -0.00380070,   0.00191190,   -0.00334290},

{   -0.00249022,   -0.00255174,   -0.00161664,   0.00646709,   -0.00455495,   -0.01892915,   -0.00189057,   -0.00146743,   0.00201011,   0.00303839},

{   0.00307047,   0.00152128,   0.00274522,   -0.00813843,   -0.00637170,   0.02161188,   0.00769219,   0.00422507,   0.01083575,   0.00554388},

{   -0.00026886,   0.00146906,   0.00690360,   -0.00233633,   -0.00743382,   0.00197966,   0.00461441,   -0.00077399,   0.00622981,   0.00926711},

{   -0.00095175,   -0.00300642,   0.00349728,   0.00973936,   0.00130663,   0.01672464,   0.00214381,   -0.00479473,   0.00021323,   -0.00504992},

{   -0.00796774,   -0.00777454,   0.01472064,   0.00419640,   0.00009850,   -0.00227039,   -0.00413390,   -0.00745379,   -0.00530568,   -0.00508610},

{   -0.00234006,   0.00776935,   0.00056224,   -0.00061124,   -0.00076573,   0.00180958,   0.00268168,   0.00534481,   0.00376392,   0.00642912},

{   0.00198816,   0.00290657,   0.00129810,   -0.00500597,   -0.01289560,   -0.02129240,   0.00221555,   0.01412627,   0.00494994,   0.00218721},

{   0.00723649,   0.00496646,   0.00543579,   -0.00103025,   0.00171306,   0.00331929,   0.00035451,   0.01023642,   0.00581490,   0.00815197},

{   0.00084689,   0.00051713,   0.00802087,   0.00446553,   -0.00621724,   -0.00873814,   -0.00885721,   0.00624454,   -0.00380893,   -0.00302404},

{   -0.00243724,   -0.00216389,   -0.00117648,   -0.00252831,   -0.01632920,   0.00478344,   0.01074398,   0.00398316,   0.00820569,   0.00334913},

{   0.00486904,   0.00644839,   0.01191909,   0.00233043,   -0.01100158,   -0.00947657,   0.00863266,   0.01294053,   0.01078684,   0.00924624},

{   0.00463246,   0.00231681,   0.01278480,   0.00716155,   0.00188431,   0.00390487,   -0.00117313,   -0.00118873,   0.00141110,   -0.00260139},

{   -0.00759524,   -0.00214592,   0.01757851,   0.00191647,   -0.00642818,   -0.00735460,   0.01055379,   0.00696078,   -0.00141687,   -0.00544053},

{   0.00157257,   -0.00417419,   -0.01018863,   0.01614394,   0.00408876,   0.00277369,   0.00445860,   -0.00524322,   0.00999605,   0.00688280},

{   0.00487436,   0.00148844,   -0.00299441,   0.00966635,   -0.00545120,   -0.01094305,   0.00934612,   0.00000377,   0.01068280,   0.01285382},

{   0.00610992,   0.00526033,   -0.00074024,   0.00850982,   0.00886539,   0.00381742,   -0.00354831,   -0.00656414,   0.00863265,   0.00417819},

{   0.00136375,   0.00410255,   0.00605260,   0.00491661,   0.00043020,   -0.01139207,   0.00163925,   -0.00745387,   0.00095721,   0.00119725},

{   0.00166585,   0.00142636,   -0.00379524,   0.00486954,   0.00892121,   0.00957308,   0.00322862,   0.00561332,   0.00188950,   0.00386129},

{   -0.00357255,   -0.00403382,   -0.00152553,   0.00568588,   -0.00278822,   0.00284068,   0.00261788,   0.00745671,   0.00662131,   0.01260820},

{   -0.00156450,   -0.00201631,   0.00324050,   0.02500402,   0.00272701,   0.00027856,
0.00547226,   0.00365120,   0.00179261,   -0.00147760},

{   0.00029645,   -0.00428110,   0.00888215,   0.00687383,   -0.01547752,   0.00437531,   -
0.00116347,   -0.00941400,   0.00762043,   0.00402898},

{   -0.00251414,   -0.00204373,   -0.00289258,   -0.00308742,   0.00311107,   0.01010143,
0.01046861,   0.01386760,   0.01371189,   0.01189869},

{   0.00085058,   0.00284917,   0.00433633,   0.00378226,   -0.00066686,   -0.01165624,
0.00075283,   0.01762876,   0.00938403,   0.00269279},

{   0.00116966,   0.00140161,   0.00644003,   0.00630100,   0.00481016,   0.00067718,
0.00302025,   -0.00006228,   0.01579197,   0.01360116},

{   -0.00129828,   -0.00112730,   0.00413839,   0.01474563,   0.00591950,   -0.00769547,   -
0.01692050,   0.00026673,   0.00314501,   0.00088163},

{   0.00050192,   -0.00019614,   0.00523667,   0.00906082,   -0.00532943,   0.01006419,
0.00564608,   0.01186492,   0.00969477,   0.00395468},

{   -0.00472998,   -0.00313090,   0.00439118,   0.00022579,   -0.00887046,   -0.00911719,
0.00020407,   0.01041237,   0.01523070,   0.01085361},

{   0.00119451,   0.00284162,   0.00615884,   0.01153521,   0.00517547,   0.00277399,
0.00832575,   0.00779691,   0.00324772,   0.00351751},

{   -0.00519556,   -0.00295172,   0.02525489,   0.01798212,   -0.00438738,   -0.01222669,   -
0.00900323,   -0.00185156,   0.00339578,   0.00260920},

{   -0.00270637,   -0.00222864,   -0.00539474,   -0.01321067,   0.00789722,   0.00313879,   -
0.00453286,   0.00561428,   -0.00475956,   -0.00890697},

{   -0.00118036,   -0.00042033,   -0.00719468,   -0.01000462,   -0.00682112,   0.00535234,
0.00235443,   -0.00474756,   -0.00545839,   0.00110324},

{   -0.00225500,   -0.00171062,   -0.00466855,   -0.00747594,   0.01389486,   0.00992659,   -
0.00695008,   -0.02006762,   -0.01364416,   -0.00078982},

{   -0.00085803,   0.00410182,   -0.00196015,   -0.00639579,   0.00078628,   -0.00226078,   -
0.00861787,   -0.01373490,   -0.02391058,   -0.00808851},

{   -0.00063885,   -0.00001952,   -0.00743163,   -0.01553771,   0.01422720,   0.01936474,
0.00728046,   -0.00008372,   -0.00367349,   -0.00708286},

{   -0.00143970,   -0.00178368,   -0.00273734,   -0.00958149,   -0.01110954,   0.01782250,
0.00774218,   -0.00147129,   -0.01449725,   -0.01403554},

{   -0.00070646,   0.00159104,   0.00274791,   -0.00326417,   0.01380166,   0.01596148,
0.00444873,   -0.00546512,   -0.01887057,   -0.01582117},

{   -0.00144073,   -0.00261082,   0.00273428,   -0.00317007,   -0.00558809,   0.01255326,
0.00109155,   -0.01208593,   -0.02965142,   -0.00191764},

{   0.00283848,   0.00393704,   -0.00296926,   -0.00944444,   0.00507323,   0.00666967,
0.00841999,   0.00754188,   -0.00201340,   -0.00680120},

{   0.00480224,   0.00081276,   -0.01865624,   -0.00093591,   0.00293862,   -0.00865280,
0.00171235,   0.00781937,   -0.00444062,   -0.00614202},

{ 0.00445001, 0.00326413, -0.01123814, -0.00595242, 0.01485198, 0.00558687, -0.00356026, -0.00424684, -0.01156887, -0.01361932},

{ -0.00001678, 0.00143093, -0.00345284, -0.00553204, 0.00216156, -0.01013138, -0.01031674, 0.00521731, -0.00806113, -0.01077367},

{ -0.00184428, 0.00471354, 0.00859489, -0.01317721, 0.00266957, 0.00773321, 0.00466730, -0.00016286, -0.00560587, -0.00721775},

{ -0.00150527, 0.00246554, -0.00357066, -0.00724693, -0.00780699, -0.01201075, 0.00866401, 0.00266341, -0.01053797, -0.00947744},

{ 0.00630638, 0.00710376, 0.00061292, 0.00335619, 0.00813022, 0.01010773, 0.00259815, -0.00391783, -0.00935298, -0.01174642},

{ 0.00342893, 0.00256425, -0.00293257, 0.00447207, -0.00452771, -0.01078035, -0.00152854, -0.00582106, -0.02093782, -0.01548175},

{ 0.00174264, 0.00486940, 0.00101490, -0.00369979, 0.00914580, -0.00046007, 0.00393674, -0.00514304, -0.00502874, -0.00318928},

{ 0.00367157, 0.00164282, -0.00259170, -0.00102131, -0.00130364, -0.00405688, -0.00361148, 0.00155262, -0.00264098, 0.00186231},

{ 0.00379067, 0.00092008, -0.01490638, 0.00899597, 0.00682106, -0.00394004, -0.00989744, -0.01493545, -0.00413015, -0.00533970},

{ 0.00324614, -0.00281525, -0.00637901, 0.00571717, -0.00898235, 0.00195685, -0.00582317, -0.01132263, -0.00403691, -0.00861630},

{ -0.00529028, -0.00491416, 0.00404015, -0.00201376, 0.00941126, 0.00059865, -0.01008402, -0.00255501, -0.00695912, -0.00756088},

{ -0.00119706, -0.00423473, -0.00828492, -0.00284703, -0.00058170, -0.00458320, -0.00889183, -0.00170038, -0.01224148, -0.00964573},

{ 0.00188817, 0.00283448, 0.00026518, 0.01441261, 0.01227742, 0.00509984, -0.00687448, -0.01384025, -0.01981324, -0.01406364},

{ -0.00053697, 0.00136264, 0.01095638, 0.00811139, 0.00453491, -0.00084917, -0.01580995, -0.02585460, -0.03501521, -0.01882424},

{ -0.00161777, -0.00076829, -0.00361048, -0.00596857, 0.01843197, 0.00988164, 0.00150586, 0.00012576, 0.00777538, 0.00518969},

{ -0.00210784, -0.00409224, -0.00920995, 0.00092189, 0.00542201, -0.00211517, -0.00765625, 0.00629464, 0.00842455, 0.00411284},

{ 0.00003792, 0.00222472, 0.00228015, 0.00100784, 0.01260415, 0.00201989, -0.01000386, 0.00598743, 0.00253893, -0.00282166},

{ 0.00507067, 0.00480165, -0.00272484, 0.00565289, 0.00121260, -0.00570415, -0.01959834, -0.00317788, -0.00411844, -0.00695937},

{ -0.00376294, 0.00059416, 0.01423623, 0.00080375, 0.00643702, 0.00686370, -0.00313787, -0.00987418, -0.00299491, -0.00249963},

{ -0.00806457, 0.00222565, 0.00504739, -0.00636976, -0.00098179, -0.00726277, -0.00505596, -0.00341247, -0.00422603, -0.00245231},

{ -0.00067223, 0.00090078, 0.00075010, -0.00162500, 0.00183818, 0.00897492, -0.00282313, -0.00134597, -0.00390676, -0.00756619},

{ 0.00171542, 0.00674575, 0.00696047, 0.00121510, -0.00079761, -0.00280685, -0.00419458, -0.00418100, -0.00817770, -0.01188108},

{ -0.00480908, -0.00299589, -0.00693984, -0.00437097, -0.00048672, 0.00064401, 0.00503113, 0.00470563, 0.00008420, 0.00227688},

{ -0.00010864, -0.00080145, -0.00089350, -0.00030148, -0.01136001, -0.01489977, 0.00793012, 0.00084201, -0.00747283, 0.00764944},

{ -0.00175219, -0.00341623, -0.00793373, 0.00795065, 0.01151782, 0.00477091, 0.00103290, -0.00150988, -0.01301039, -0.01109959},

{ -0.00213945, -0.00034159, -0.00073789, 0.00375862, 0.00220275, -0.00676203, -0.00223236, -0.00809945, -0.02018789, 0.00074251},

{ -0.00192672, -0.00173695, -0.00081662, -0.00184874, -0.00358986, 0.01475006, 0.01613872, 0.00823781, -0.00473629, -0.00807271},

{ 0.00345772, 0.00341053, 0.00500926, -0.00330046, -0.01186972, 0.01181906, 0.00440546, 0.00265077, -0.00258333, -0.00760893},

{ -0.00042330, 0.00083297, 0.00375033, 0.00502954, 0.00372912, 0.00148808, 0.01280970, 0.00292874, -0.01416698, -0.01890834},

{ 0.00113566, 0.00249418, 0.00389607, -0.00536590, -0.01420978, -0.00016841, 0.00287547, -0.00624030, -0.01628379, -0.00581503},

{ -0.00135987, 0.00077581, 0.00264995, -0.00236121, 0.00861954, 0.00648555, 0.01697403, 0.01659641, 0.00547484, -0.00009327},

{ -0.00262019, -0.00285140, -0.00443122, -0.00008469, -0.00708718, -0.01345062, 0.02067079, 0.01735198, 0.00351791, -0.00193104},

{ -0.00385576, -0.00350660, -0.00083694, 0.00705176, 0.00994210, 0.00368093, 0.00642495, 0.01024715, 0.00118806, -0.00376492},

{ 0.00622286, 0.00543629, -0.00045749, 0.00418943, -0.00317214, -0.01015493, 0.01309732, 0.00753043, -0.00646111, -0.00717690},

{ 0.00083145, 0.00045971, -0.00461627, -0.01645929, -0.01458668, 0.01870089, 0.02118257, 0.00993928, 0.00277086, -0.00044704},

{ 0.00482793, 0.00551503, 0.00208811, -0.00565857, -0.01268429, -0.00426449, 0.02459712, 0.01985106, 0.00847906, 0.00460058},

{ 0.00293454, 0.00421160, 0.00457712, 0.00374468, 0.00332494, 0.01346970, 0.01175397, 0.00792934, 0.00201689, -0.00183101},

{ 0.00120334, 0.00415760, 0.00695187, 0.00696322, -0.00317111, 0.00161058, 0.00970844, 0.00009515, -0.00806091, -0.00043975},

{ -0.00187667, -0.00216523, -0.00190075, 0.00979870, 0.00245961, -0.00083074, 0.01583148, 0.00805848, 0.00650797, 0.00323620},

{ -0.00197460, -0.00480332, -0.00926156, 0.00782345, -0.00159864, -0.00761256, 0.01016645, 0.00047921, -0.01013106, -0.00271237},

```
{   -0.00114979,   -0.00094748,   0.00052070,   0.00669376,   0.01050549,   0.00668137,
0.00315455,   -0.00712109,   -0.00558144,   0.00578709},
{   0.00320088,   0.00416886,   0.00593271,   0.00483418,   0.00568066,   0.00139672,   -
0.00959812,   -0.01323612,   -0.00508168,   -0.00319184},
{   -0.00440848,   -0.00146257,   0.00310220,   0.00221527,   0.00519237,   0.00742201,
0.00520584,   0.00481628,   -0.00233592,   0.00289503},
{   -0.00286947,   -0.00476632,   0.00102804,   0.00037028,   -0.00499286,   -0.00369873,
0.00335549,   0.00450933,   -0.00478313,   -0.00727082},
{   0.00562573,   0.00177228,   -0.00388755,   0.01529287,   0.00637977,   -0.00311580,
0.00524145,   -0.00226732,   -0.01257961,   0.00160312},
{   0.00824527,   0.00640849,   0.00417142,   0.00499035,   -0.00196902,   -0.00136031,   -
0.00185235,   -0.00845783,   -0.01908885,   -0.00931572},
{   0.00315259,   0.00242346,   -0.00524211,   -0.00194243,   0.01131435,   -0.00315874,
0.01082409,   0.01283626,   0.00487072,   0.00186936},
{   -0.00668040,   -0.00354932,   -0.00117341,   -0.00226992,   -0.00022671,   -0.00666072,
0.00314488,   0.00734916,   0.00425614,   0.00164093},
{   -0.00389583,   0.00205666,   0.01156000,   0.00378337,   0.00388467,   0.00191016,
0.00226343,   0.00715162,   0.00447477,   0.00145831},
{   0.00260564,   0.00776913,   0.00295654,   0.00507983,   0.00280605,   -0.00262448,   -
0.00087415,   0.00308014,   -0.00047010,   -0.00550276},
{   -0.00400435,   -0.00461726,   0.00647083,   -0.00632126,   0.00578397,   0.01191517,
0.00167871,   0.01065949,   0.00598003,   0.00123230},
{   -0.00172116,   0.00293152,   0.00458923,   -0.00446042,   -0.00402144,   -0.00537020,
0.01255438,   0.01025417,   0.00081987,   -0.00211946},
{   0.00098726,   0.00151129,   0.00213603,   0.01091075,   0.01596006,   0.01027042,
0.00492642,   0.00288748,   -0.00109633,   -0.00508732},
{   -0.00137552,   -0.00354111,   0.00880722,   0.01614140,   -0.00039181,   0.00028126,
0.00048723,   -0.00412099,   -0.01187375,   -0.01250538},
},
{{   -0.00071405,   0.00244371,   0.00235739,   -0.00329369,   0.00472867,   -0.00361321,   -
0.00584670,   0.00863128,   0.00145642,   -0.00441746},
{   0.00242589,   -0.00430711,   -0.00122645,   -0.00464764,   -0.00017887,   -0.00471663,
0.00181162,   0.00249980,   -0.00276848,   -0.00485697},
{   -0.00126161,   0.00092104,   0.00405563,   0.00014858,   -0.00389621,   -0.00436458,
0.00588222,   0.00666140,   0.00160434,   -0.00355981},
{   0.00144272,   -0.00099722,   -0.00329538,   0.00173437,   -0.00306283,   0.00373708,
0.00877845,   0.00397062,   -0.00065690,   -0.00004783},
{   -0.00005275,   -0.00144138,   -0.00384176,   -0.00446236,   0.00088025,   0.00069624,   -
0.00766217,   -0.00227704,   0.00487439,   -0.00176593},
```

{   -0.00139297,    0.00141438,   -0.00012646,   -0.01026693,   -0.00010281,   -0.00277474,   -0.00025676,   -0.00333147,   -0.00272379,   -0.00301211},

{   -0.00001482,    0.00462141,    0.00170302,    0.00056160,    0.00010522,   -0.00055656,    0.00580159,   -0.00135691,    0.00699179,   -0.00022409},

{   -0.00209273,    0.00036039,   -0.00388741,   -0.00210837,    0.00414685,   -0.00550009,    0.00800933,   -0.00162490,   -0.00075248,   -0.00143789},

{    0.00221342,   -0.00070693,    0.00305034,   -0.00100824,    0.00209771,    0.00433956,   -0.01006429,    0.00335628,   -0.00422019,   -0.00190244},

{    0.00110913,    0.00340343,   -0.00021330,   -0.00231460,   -0.00372496,   -0.00103889,   -0.00204804,    0.00150248,   -0.00867284,   -0.00012270},

{    0.00129154,    0.00225690,    0.00307610,   -0.00457771,   -0.00260350,    0.00704766,   -0.00038185,    0.00136466,   -0.00074573,   -0.00661474},

{   -0.00197707,    0.00190446,    0.00129311,   -0.00202580,    0.00168859,    0.00202957,    0.00764207,    0.00343175,   -0.00841492,   -0.00689243},

{   -0.00106230,   -0.00290282,    0.00301179,   -0.00342316,    0.00541939,    0.00276419,   -0.00096920,   -0.00704790,    0.00021120,   -0.00488600},

{   -0.00335184,   -0.00011723,   -0.00134520,    0.00234701,    0.00275337,   -0.00243280,   -0.00553081,   -0.00189510,   -0.00558213,   -0.00439766},

{   -0.00138223,   -0.00078722,   -0.00307855,   -0.00120769,   -0.00597490,    0.00077555,    0.00204629,   -0.00278627,   -0.00509984,   -0.00917128},

{   -0.00085738,    0.00296249,   -0.00100328,    0.00620823,   -0.00194594,   -0.00477741,    0.00408894,   -0.00431777,   -0.00362229,   -0.00545227},

{    0.00316502,   -0.00496468,    0.00196254,    0.00170085,   -0.00353618,    0.00161267,   -0.00450792,    0.00475622,    0.00559953,    0.00043379},

{    0.00053033,   -0.00215320,   -0.00123736,    0.00400112,   -0.00279937,   -0.00382983,   -0.00922124,    0.00920321,   -0.00189296,   -0.00641793},

{    0.00052374,    0.00024094,    0.00074222,    0.00121188,   -0.01308354,    0.00365845,   -0.00019892,    0.00285161,    0.00119182,   -0.00210593},

{    0.00304271,    0.00045754,   -0.00242181,    0.00326300,    0.00404964,    0.00162161,    0.00036536,    0.00577343,   -0.00083931,   -0.00692977},

{   -0.00226510,   -0.00217357,   -0.00177951,    0.00056309,   -0.00247590,   -0.00393503,   -0.00087352,   -0.00385851,    0.00499243,    0.00317747},

{   -0.00333292,    0.00237891,    0.00005875,   -0.00045224,   -0.00577007,   -0.00489336,   -0.00492713,   -0.00252844,    0.00232674,   -0.00355871},

{   -0.00180577,    0.00152251,   -0.00168650,   -0.00373161,   -0.00494445,    0.00070000,    0.00429748,    0.00264468,    0.00510881,    0.00414298},

{    0.00057352,    0.00182813,   -0.00478781,   -0.00132287,   -0.00291248,   -0.00582607,    0.00036611,    0.00615309,   -0.00063952,   -0.00043562},

{   -0.00182077,   -0.00052387,    0.00205275,    0.00439155,    0.00206254,    0.00666979,   -0.00737222,   -0.00041091,    0.00380985,   -0.00242852},

{ 0.00014505, -0.00015497, 0.00061676, 0.01102116, 0.00142684, 0.00011530, -0.00312628, -0.00115247, -0.00199428, 0.00034276},

{ -0.00117950, -0.00018668, -0.00688237, 0.00558761, -0.00323614, 0.00541723, -0.00055777, 0.00037185, 0.00298021, -0.00413622},

{ -0.00268489, -0.00092316, 0.00159680, 0.00503780, 0.00394093, 0.00242255, 0.00621897, 0.00128319, 0.00007167, -0.00303362},

{ -0.00135406, 0.00132612, -0.00225185, 0.00350878, 0.00389900, 0.00171999, -0.00146560, -0.01126312, 0.00449526, 0.00062508},

{ 0.00057295, 0.00202047, 0.00151283, 0.00312576, -0.00383849, -0.00182327, -0.01048760, 0.00046503, 0.00309555, 0.00301733},

{ -0.00609476, 0.00199366, 0.00169769, 0.00046054, -0.00149788, 0.00247156, 0.00418583, -0.00524517, 0.00147818, -0.00181362},

{ -0.01003447, 0.01292732, 0.00144356, 0.00014990, -0.00020365, -0.00069182, 0.00181901, 0.00113486, 0.00113268, -0.00250931},

{ 0.00006361, -0.00181203, 0.00862741, 0.00068174, 0.00059483, -0.00396821, -0.00204192, -0.00122617, -0.00279883, -0.00399060},

{ 0.00181692, 0.00040708, 0.00331578, 0.00298869, 0.00229580, -0.00470435, 0.00041688, 0.00701320, -0.00684961, 0.00460646},

{ -0.00266523, -0.00105798, -0.00115075, -0.00481424, 0.00159800, 0.00371013, 0.00172283, 0.00560712, 0.00009891, -0.00254009},

{ -0.00096200, -0.00239708, -0.00072227, 0.00067105, 0.00463245, -0.00181151, 0.00337878, 0.00842315, 0.00288416, 0.00323331},

{ 0.00569136, 0.00077628, 0.00039776, 0.00048030, -0.00188477, -0.00314697, -0.00222859, -0.00447499, -0.00134527, -0.00279319},

{ -0.00153154, 0.00040495, 0.00152195, 0.00070061, 0.00138840, -0.01182738, -0.00063394, -0.00060032, -0.00145040, 0.00350855},

{ 0.00161879, 0.00168494, 0.00016532, -0.00457719, 0.00575290, 0.00392115, 0.00266311, 0.00249840, 0.00499373, 0.00343679},

{ -0.00070075, 0.00073156, 0.00065334, 0.00149705, 0.01170892, -0.00197723, -0.00141944, -0.00046048, 0.00095963, 0.00180512},

{ -0.00156776, 0.00045531, 0.00268804, 0.00243883, -0.00464246, 0.00566962, -0.00172435, -0.00532991, -0.00755432, 0.00530406},

{ 0.00030268, -0.00185108, -0.00129334, 0.00272568, 0.00062491, -0.00097022, 0.00302455, -0.00348647, -0.01446303, 0.00783601},

{ -0.00159285, -0.00020812, 0.00015774, -0.00097503, 0.00055084, 0.01284415, 0.00377701, -0.00068963, 0.00427403, -0.00037142},

{ -0.00056554, -0.00072153, 0.00399038, -0.00497191, -0.00216464, 0.00230184, 0.00514089, 0.00188768, -0.00145550, 0.00582894},

{ 0.00014005, 0.00159032, 0.00329557, -0.00328601, -0.00164245, -0.00200642, 0.00427870, -0.00869724, -0.00082951, 0.00278987},

{ 0.00148181, 0.00041916, -0.00309927, 0.00000661, 0.00384593, -0.00416487, -0.00532559, -0.00516995, -0.00491788, 0.00837744},

{ 0.00181614, 0.00144269, -0.00413538, -0.00380312, -0.00057933, 0.00520384, 0.00350609, -0.00557332, -0.00211640, -0.00159629},

{ 0.00066935, 0.00251700, 0.00184908, 0.00313305, 0.00486335, 0.00320866, 0.00053516, -0.00308264, -0.00540642, -0.00227221},

{ -0.00056760, -0.00509891, 0.00312949, 0.00258167, -0.00347055, 0.00168554, 0.00454403, 0.00083750, -0.00395094, -0.00462307},

{ -0.00172296, -0.00043749, 0.00021821, 0.00597557, -0.00575854, -0.00305225, 0.00185040, 0.00412548, -0.00124724, 0.00677852},

{ -0.00155956, -0.00139261, 0.00127855, -0.00271569, -0.00503071, 0.00013262, -0.00702389, 0.00286641, -0.00334405, 0.00905613},

{ -0.00018965, 0.00035757, -0.00072086, -0.00143142, -0.00076345, 0.00185087, -0.00587735, 0.01505721, 0.00708978, 0.00160281},

{ 0.00153159, -0.00074015, 0.00455896, 0.00502158, -0.00181818, 0.00142143, 0.00367497, -0.00577837, 0.00397397, 0.00346490},

{ 0.00219679, 0.00016825, 0.00112885, -0.00123956, -0.00506878, -0.00586318, 0.00599759, -0.00257719, -0.00168635, 0.00893136},

{ -0.00259072, 0.00143377, 0.00410598, 0.00032354, 0.00259146, 0.00057327, -0.00177219, 0.00040267, 0.00496435, 0.00746802},

{ 0.00120161, 0.00134208, -0.00114094, 0.00600306, 0.00122526, -0.00577037, -0.00099565, 0.00334876, 0.00698501, 0.00215005},

{ -0.00056736, -0.00167842, -0.00069670, 0.00355302, 0.00308114, 0.00556195, 0.00242661, -0.00140627, 0.00151165, 0.01229007},

{ 0.00083364, 0.00285861, -0.00243291, 0.00164170, 0.00263424, -0.00090010, 0.00697612, 0.00302630, -0.00104099, 0.00985203},

{ -0.00017316, 0.00009661, -0.00299242, -0.00102654, 0.00586767, 0.00604661, -0.00028475, 0.00204755, -0.00628829, 0.00215750},

{ -0.00014705, 0.00171547, 0.00258157, 0.00347264, -0.00015150, 0.00627925, 0.00319688, 0.00698722, 0.00121685, 0.00472592},

{ 0.00179634, 0.00126112, -0.00073379, 0.00063915, -0.00368064, 0.00718675, -0.00185159, -0.00631904, 0.00912638, 0.00622665},

{ 0.00036801, 0.00043860, -0.00172184, -0.00545561, -0.00089735, -0.00376398, -0.00148660, 0.00088411, 0.00278433, 0.01309199},

{ -0.00233412, 0.00492067, -0.00200138, -0.00302371, 0.00154279, 0.00258392, -0.00437544, -0.00206242, -0.00059180, 0.00151697},

{ 0.01100540, 0.01627034, 0.00098453, -0.00264300, -0.00342966, -0.00000160, -0.00029849, 0.00180940, 0.00122892, 0.00238391},

{ 0.00000000, 0.00000000, 0.00000000, 0.00000000, 0.00000000, 0.00000000, 0.00000000, 0.00000000, 0.00000000, 0.00000000},

```
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
```

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

{ 0.00000000, 0.00000000, 0.00000000, 0.00000000, 0.00000000, 0.00000000,
0.00000000, 0.00000000, 0.00000000, 0.00000000},

```
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
```

```
{   0.00000000,   0.00000000,   0.00000000,   0.00000000,   0.00000000,   0.00000000,
0.00000000,   0.00000000,   0.00000000,   0.00000000},
{   0.00000000,   0.00000000,   0.00000000,   0.00000000,   0.00000000,   0.00000000,
0.00000000,   0.00000000,   0.00000000,   0.00000000},
{   0.00000000,   0.00000000,   0.00000000,   0.00000000,   0.00000000,   0.00000000,
0.00000000,   0.00000000,   0.00000000,   0.00000000},
},
};


/*===========================================================================*/


/*===========================================================================*/
/* Conexant System Inc.                          */
/* 4311 Jamboree Road                            */
/* Newport Beach, CA 92660                        */
/*-----------------------------------------------*/
/* Copyright(C) 2000 Conexant System Inc.             */
/*-----------------------------------------------*/
/* ALL RIGHTS RESERVED:                          */
/* No part of this software may be reproduced in any form or by any  */
/* means or used to make any derivative work (such as transformation */
/* or adaptation) without the authorisation of Conexant System Inc.  */
/*===========================================================================*/
/* FILE:  FLOAT64 CBes_85k                        */
/*===========================================================================*/



FLOAT64 CBes_85k[MAXLTT_85k][LMSMAX_85k][MAXLNp] = {
{{   0.03011250,   0.05271740,   0.06473784,   0.06435282,   0.06452657,   0.06279520,
0.05773527,   0.04953492,   0.03258218,   0.02518716},
{   0.01602284,   0.01223286,   0.02716675,   0.01515761,  -0.00130077,  -0.00532771,
0.00089903,   0.00036138,   0.00272831,  -0.00395430},
{   0.02401271,   0.03914647,   0.03915858,   0.01749331,  -0.00316505,  -0.01593492,  -
0.02332304,  -0.01928769,  -0.01089091,  -0.01175246},
{  -0.01300759,  -0.00840161,   0.00682484,  -0.00081947,  -0.00651557,  -0.00812344,  -
0.00999762,  -0.00801675,  -0.00511146,  -0.00416989},
{  -0.01818762,  -0.03192724,  -0.06456176,  -0.04615027,  -0.00055719,  -0.00821339,  -
0.00290679,  -0.00506395,  -0.00036802,  -0.00223339},
{   0.04702580,   0.05568841,   0.04484019,   0.02967458,   0.01458701,   0.00945917,
0.00722793,   0.00571889,   0.00149213,  -0.00247952},
```

911

{ -0.01485766, -0.01597556, 0.00778368, 0.01287732, 0.01335396, 0.01226611,
0.01049375, 0.00863086, 0.00659185, 0.00144317},
{ 0.01027236, 0.02730616, 0.04024012, 0.02727445, 0.00988789, 0.00395820,
0.00281685, -0.00016378, 0.00442352, -0.00260261},
{ 0.01018086, 0.02317232, 0.01823444, 0.01381079, 0.01110116, 0.00731025,
0.00224764, 0.00064606, 0.00224514, -0.00374675},
{ 0.03440958, 0.04813170, 0.04772426, 0.03918479, 0.03828848, 0.04482698,
0.04793362, 0.04624364, 0.03528126, 0.02795062},
{ 0.02012151, 0.02798955, 0.01690498, -0.00162132, -0.01795221, -0.02033811, -
0.00304788, 0.00318819, 0.00300105, -0.00068904},
{ -0.00771849, -0.01042661, 0.02415417, 0.02101670, 0.00511120, -0.00259045, -
0.01164459, -0.01753263, -0.01833297, -0.01582638},
{ 0.03093007, 0.02841266, 0.01851041, 0.01255380, -0.00055904, -0.00770237, -
0.00354944, -0.00713726, -0.01158101, -0.01336380},
{ 0.01250769, 0.01073677, 0.04218614, 0.03936715, 0.02331104, 0.01263867, -
0.00130949, -0.00833368, -0.00515605, -0.00890725},
{ 0.02999284, 0.03533733, 0.02511555, 0.01201614, 0.00337246, 0.00922871,
0.01583742, 0.01541255, 0.01296229, 0.00790224},
{ -0.01170270, -0.01799777, -0.03459895, -0.04037440, -0.00093168, -0.00201978, -
0.01253730, -0.00295387, -0.00802624, -0.00664753},
{ -0.00726885, -0.01627472, -0.01522945, 0.03430538, 0.02169323, 0.01089532, -
0.00154582, -0.00739393, 0.00585284, -0.00078346},
{ -0.00436114, -0.01237267, -0.02091931, -0.00244249, 0.01246437, 0.00270874, -
0.00687659, -0.00651871, -0.01814616, -0.02330265},
{ 0.03517674, 0.06355752, 0.06857296, 0.05938929, 0.04741369, 0.03893724,
0.02726384, 0.01966913, 0.01129379, 0.00478196},
{ -0.01860181, -0.02677876, -0.04407154, -0.04095438, -0.01009746, -0.01626406, -
0.01253701, -0.00731142, -0.00220656, 0.01567101},
{ 0.01698267, 0.01310731, 0.00257197, -0.01257890, -0.03301049, -0.03748283, -
0.01335818, -0.01974036, -0.01923884, -0.00554617},
{ -0.01302456, -0.02004788, -0.03292591, -0.02055095, 0.02059680, 0.01219580, -
0.00013659, -0.00557743, -0.00905106, -0.00933003},
{ -0.00101468, 0.01573975, 0.01522490, 0.00440810, -0.00745773, -0.01547614, -
0.01712205, -0.01281291, -0.00291117, -0.00745792},
{ -0.00645665, -0.00803376, 0.03718368, 0.03703527, 0.02560332, 0.02060903,
0.01271667, 0.00626016, 0.00721148, -0.00046866},
{ 0.00969971, 0.00507633, -0.00469157, -0.00353471, 0.01129945, 0.00162597, -
0.00787840, -0.00714222, -0.01077091, -0.01917782},
{ -0.00921545, -0.01537870, -0.01341638, -0.01877411, -0.00679339, 0.01005825, -
0.00052251, -0.00884878, -0.01748464, -0.01358666},

{ -0.02241539, -0.03247605, -0.03701199, -0.01090514, -0.00887298, 0.00529690, -0.00127800, 0.00405804, 0.00659569, 0.01933625},

{ 0.00600397, 0.01074139, 0.02092690, 0.01970426, 0.01176908, 0.01359934, 0.01409811, 0.01382651, 0.01320097, 0.01301970},

{ 0.01141765, 0.00585173, 0.00099689, -0.01003275, 0.00167233, 0.01809863, 0.01718491, 0.01680690, 0.01478071, 0.00556505},

{ 0.00532323, 0.02795015, 0.06817748, 0.06100996, 0.05743580, 0.05354041, 0.04499788, 0.03264736, 0.02017310, 0.00922294},

{ -0.02035650, -0.03006271, -0.04684134, -0.03358747, -0.02235513, -0.01916831, -0.00595318, -0.00071390, -0.00137424, 0.01494029},

{ -0.00390696, -0.00736702, -0.01984008, -0.02822155, 0.00327165, 0.00343909, -0.00602792, -0.00782717, -0.00570698, -0.01439530},

{ -0.00083505, -0.00797647, -0.01183219, -0.00060675, -0.00978943, -0.01842960, -0.00060424, 0.00138312, -0.00990396, -0.01301919},

{ -0.00153786, 0.00594700, 0.01742534, 0.01203318, 0.00432435, 0.00026490, 0.00152903, 0.00261276, 0.00144338, -0.00298043},

{ 0.02514795, 0.02694397, 0.03251137, 0.02791743, 0.02189767, 0.01664660, 0.01392899, 0.01020858, 0.00946374, 0.00251344},

{ 0.01100263, 0.01767290, 0.01081835, -0.00842438, -0.02354175, -0.03362519, -0.03553471, -0.00317026, 0.00153320, -0.00582507},

{ 0.01299545, 0.02093436, 0.03195115, 0.03015983, 0.02262512, 0.02771440, 0.02669818, 0.02707517, 0.02510345, 0.01691998},

{ 0.01109239, 0.00726528, 0.01170571, 0.01399126, 0.02465632, 0.01511573, 0.00541503, 0.00142378, -0.00097093, -0.00882481},

{ -0.01941829, -0.02760284, -0.03358766, -0.01196969, -0.01694781, -0.01634516, -0.01319709, -0.00584112, -0.00097540, 0.01214821},

{ -0.02107221, -0.02948952, -0.04896206, -0.05545068, -0.01814541, -0.01060619, -0.00334635, 0.00268116, 0.00045516, 0.01809656},

{ -0.01400252, -0.02253890, -0.04613798, -0.05388472, 0.00707619, 0.01867959, 0.00765829, 0.00198822, -0.00470518, -0.01022938},

{ -0.00148627, -0.00099175, 0.00560137, -0.00668187, 0.00030117, -0.00039004, -0.00639128, -0.01024137, -0.00170219, -0.00524556},

{ -0.00549896, -0.01470279, -0.01695822, 0.02198312, 0.03669617, 0.02463584, 0.01276040, 0.00736205, 0.00005241, -0.00473827},

{ -0.00132779, -0.00278557, 0.02514555, 0.02374663, 0.02009989, 0.02808080, 0.03082887, 0.03087115, 0.02409034, 0.01348647},

{ -0.01058509, -0.01658262, -0.02338305, -0.00972392, 0.00553297, -0.00333131, 0.00588576, 0.00111411, -0.00029098, -0.00373132},

{ 0.00160918, -0.00536342, -0.01461500, -0.00612135, 0.02269393, 0.01788420, 0.00592269, 0.00065486, -0.00379472, -0.01142680},

{ -0.00735894, -0.01347182, -0.02349130, -0.02205992, 0.02751215, 0.02381083, 0.00992716, 0.00358035, -0.00636554, -0.01445333},

{ -0.00259622, -0.00664229, -0.01866048, -0.03590918, -0.05839927, -0.06065164, -0.01983147, 0.00600777, 0.00351924, 0.00449450},

{ 0.03019245, 0.04180980, 0.04242800, 0.03707932, 0.02969960, 0.02907674, 0.02621267, 0.02268569, 0.01544914, 0.00888835},

{ 0.00410478, -0.00530070, -0.00295468, 0.02816624, 0.01664470, 0.00777464, 0.00692805, -0.00028335, 0.00294711, 0.00261301},

{ -0.01128064, -0.01882569, -0.01409550, 0.01270598, 0.00521923, 0.01708157, 0.01549205, 0.01315745, 0.01284490, 0.00551201},

{ 0.01235582, 0.00495826, 0.00768318, 0.01105327, -0.00329601, -0.00357798, 0.00325452, 0.00012424, 0.00501045, 0.00643709},

{ 0.01030086, 0.00438282, -0.00311851, -0.02076026, -0.04378026, -0.04024490, 0.00518616, 0.01327369, 0.00583413, 0.00260305},

{ 0.01585195, 0.02158346, 0.01265352, -0.00225988, -0.01537653, -0.02523274, -0.02858671, -0.01981777, -0.02753662, -0.02470708},

{ -0.00405472, -0.00972641, 0.00833755, 0.00837587, 0.00118455, 0.00982980, 0.00623398, 0.00759464, 0.00871849, 0.00594262},

{ -0.01145855, -0.01827606, -0.01906050, -0.01321846, -0.01659787, -0.00515321, -0.01575232, -0.02756877, -0.03799206, -0.00151852},

{ 0.00720446, -0.00064353, -0.00701769, -0.02430002, -0.03349658, 0.00705156, 0.00874910, 0.00186248, 0.00901299, 0.00015126},

{ -0.01518806, -0.02321451, -0.02690132, 0.00534415, -0.00308821, -0.00432329, -0.00601155, -0.01009555, -0.01496766, -0.01130705},

{ -0.01550506, -0.02653400, -0.03852672, 0.01008836, 0.01733050, 0.01204091, 0.01458971, 0.00882104, 0.00848728, 0.00131771},

{ -0.01295495, -0.02006295, -0.03745275, -0.03024400, -0.01406475, -0.02456492, -0.00740866, -0.00919721, -0.00415596, 0.00474972},

{ -0.01664452, -0.02405961, -0.03649393, -0.03646140, -0.01100296, -0.00245895, -0.00755079, -0.01214057, -0.01077375, 0.01126263},

{ -0.00108388, -0.00662234, -0.02067877, -0.03852748, -0.05961239, -0.02435135, -0.00623433, -0.00902003, 0.00759261, 0.00276482},

{ -0.01724702, -0.02611390, -0.03652935, -0.03780674, -0.03761547, -0.01849779, -0.01307332, -0.00332941, 0.00083897, 0.01835804},

{ 0.01208979, 0.00809377, 0.01689381, 0.01941724, 0.00720310, -0.00476103, -0.01467246, -0.01450666, -0.00270332, -0.00725360},

{ 0.00980247, 0.01559737, 0.00594148, 0.00019967, -0.00062672, -0.01000914, -0.01451608, -0.01143174, -0.01193905, -0.01828814},

{ -0.00311454, -0.01203376, -0.00927907, 0.02078032, 0.00360031, -0.00034344, -0.00832342, -0.00936971, 0.00192210, -0.00672316},

```
{  -0.01379369,  -0.02012157,  -0.02470930,  -0.02980865,  -0.03913091,  -0.00703542,  -
0.00668963,  -0.00621541,  -0.00767146,   0.00501472},
{  -0.01307473,  -0.02603028,  -0.05475627,  -0.03679790,   0.02162444,   0.01966973,
0.01865785,   0.01710904,   0.01237958,   0.00370059},
{   0.00064712,  -0.00558789,  -0.01323406,  -0.01583633,  -0.03346232,  -0.03305713,
0.01043219,   0.00799608,   0.00367465,  -0.00077605},
{  -0.01743761,  -0.02261109,  -0.03091739,  -0.02751019,  -0.02026401,  -0.01742175,  -
0.02580788,  -0.02763544,  -0.01051019,   0.01002048},
{   0.00216431,  -0.00560940,  -0.01900158,  -0.04152299,  -0.05988942,  -0.02922351,
0.01788276,   0.01381030,   0.01100524,   0.00877503},
{  -0.01828726,  -0.02442716,  -0.01062820,   0.00049875,  -0.00510124,   0.00221065,  -
0.00191559,   0.00275880,   0.00074190,   0.00944648},
{  -0.00879868,  -0.01598313,  -0.03004215,  -0.04948885,  -0.04196567,  -0.01983909,  -
0.01370329,  -0.00427476,   0.00082035,   0.01297109},
{  -0.00230832,  -0.01010282,  -0.01668657,  -0.03198117,  -0.03699492,   0.01269478,
0.01377988,   0.00820876,   0.00580972,  -0.00152692},
{   0.01551234,   0.03419445,   0.06055726,   0.04707260,   0.03313935,   0.02368624,
0.01430269,   0.00668846,   0.00691489,   0.00056254},
{   0.01406692,   0.01449025,   0.02394177,   0.02399262,   0.03079103,   0.02573220,
0.02140991,   0.01309781,   0.00779774,  -0.00239127},
{  -0.00828736,  -0.01743047,   0.00335240,   0.04816538,   0.03638020,   0.03234748,
0.02652692,   0.01796155,   0.01503502,   0.00549014},
{   0.00094473,  -0.00491647,   0.00128189,   0.01052383,   0.03986395,   0.03560681,
0.02404924,   0.01677403,   0.00763441,  -0.00199493},
{  -0.01506920,  -0.02351502,  -0.04035310,  -0.04043075,  -0.00847623,   0.00878313,
0.00972518,   0.00819359,   0.00632904,   0.00339077},
{   0.01785404,   0.02207023,   0.03441687,   0.03255487,   0.04601287,   0.04152598,
0.04282719,   0.03719784,   0.02088540,   0.01024143},
{   0.01931626,   0.01456799,   0.00936344,   0.00110318,  -0.01440516,  -0.01437875,  -
0.01424618,  -0.02355264,   0.00183293,  -0.00067569},
{   0.00521639,  -0.00179269,  -0.00175685,   0.01034082,  -0.00307994,  -0.00944490,  -
0.01447315,  -0.02104899,   0.00289221,  -0.00373207},
{  -0.00685119,   0.00469486,   0.00447692,  -0.00819117,  -0.02000782,  -0.02240418,  -
0.01177251,  -0.01311489,   0.00040491,  -0.00407311},
{   0.02359967,   0.03214284,   0.05067474,   0.05064540,   0.03918985,   0.04448732,
0.03853463,   0.03322630,   0.02812674,   0.02336996},
{  -0.00315399,   0.00029074,  -0.00602774,  -0.01695521,  -0.00750983,  -0.01427804,  -
0.02487497,  -0.01355392,  -0.01422887,  -0.02043397},
{   0.01021442,   0.00593011,  -0.00854369,  -0.03200625,  -0.05616386,  -0.05552187,  -
0.02617807,  -0.02123191,  -0.01014762,   0.00017089},
```

```
{  -0.00357899,   -0.01168453,   -0.02003192,    0.00360176,   -0.00698634,   -0.01205097,
   0.00501530,   -0.00571256,    0.00716748,    0.00642730},
{  -0.00204187,    0.00754425,   -0.00122054,   -0.01452030,   -0.02381772,   -0.02974159,   -
   0.02443919,   -0.02145534,   -0.02556043,   -0.01726765},
{  -0.01225962,   -0.02021357,   -0.03276307,    0.00077601,    0.00339980,   -0.00682563,   -
   0.01438413,   -0.02362521,    0.00510472,   -0.00030699},
{  -0.01243222,   -0.02180635,   -0.03374801,   -0.00552771,    0.03324926,    0.03598020,
   0.02254258,    0.01346735,    0.00006868,   -0.00653802},
{   0.01148091,    0.00692796,    0.00040312,   -0.00436061,   -0.01726674,   -0.02679639,   -
   0.00256074,    0.00092198,   -0.00728032,   -0.00945666},
{  -0.00178888,   -0.00688681,   -0.01213265,   -0.02513887,   -0.03796508,   -0.00819531,   -
   0.01296614,   -0.01487822,   -0.01910969,   -0.01537065},
{  -0.00725535,   -0.01262777,   -0.01183104,   -0.00983393,   -0.01670010,   -0.00293400,   -
   0.00771642,   -0.00212860,    0.00386644,    0.00120922},
{   0.00164142,   -0.00392946,   -0.01381401,   -0.00515787,    0.00254924,   -0.00942431,   -
   0.01478234,   -0.02189020,   -0.03120124,   -0.00938677},
{  -0.00637770,   -0.01406334,   -0.02198870,   -0.00809124,    0.04237495,    0.04494788,
   0.03299125,    0.02381818,    0.01366707,    0.00592031},
{  -0.00854519,   -0.01460363,   -0.02844237,   -0.02588072,   -0.04063413,   -0.03740634,
   0.00128514,    0.00170535,    0.00151977,    0.00167284},
{  -0.01347334,   -0.02291845,   -0.04127466,   -0.06185673,   -0.03481773,   -0.01543559,   -
   0.00855813,    0.00127078,    0.00279083,    0.01982719},
{  -0.00883732,   -0.01775697,   -0.03452937,   -0.03890479,   -0.05133868,   -0.05444499,   -
   0.02467414,   -0.00827826,   -0.00632791,    0.00470165},
{   0.01947562,    0.01480394,    0.00585211,   -0.01157039,   -0.02573721,   -0.00361897,
   0.00770904,    0.00117448,    0.01013551,    0.00533763},
{  -0.00797957,   -0.01335512,   -0.02556722,   -0.02463242,   -0.00471432,   -0.01441015,   -
   0.01478523,   -0.00963687,   -0.01951507,   -0.00599849},
{  -0.01014364,   -0.01336506,   -0.00756888,   -0.02085792,   -0.03437920,   -0.03380901,   -
   0.01522635,   -0.01085877,   -0.00407099,   -0.00059958},
{  -0.01191418,   -0.01893562,   -0.02285608,   -0.02175026,   -0.01437801,    0.00862057,
   0.01242598,    0.01037422,    0.00881772,    0.00301240},
{  -0.00410227,   -0.00810982,   -0.02082509,   -0.02673533,   -0.02102781,   -0.03371932,   -
   0.03125568,   -0.00162297,   -0.00621962,   -0.00958948},
{  -0.00236826,   -0.00528324,   -0.01688967,   -0.02665562,   -0.04625641,   -0.04899277,   -
   0.01293267,   -0.00471950,   -0.00579889,    0.00382789},
{  -0.00829334,   -0.01601839,   -0.02981488,   -0.04926722,   -0.02466496,    0.00312334,
   0.01756506,    0.01017462,    0.00301230,   -0.00031275},
{  -0.00314835,   -0.00971408,   -0.00126585,    0.00084833,   -0.01365008,   -0.01221557,   -
   0.02038756,   -0.01962756,   -0.02820450,   -0.02680765},
```

EP 1 214 706 B1

{   -0.00652397,   -0.01336956,   -0.03077461,   -0.04977855,   -0.06644036,   -0.02418368,   -0.00439690,   0.00168036,   0.00799340,   0.00870391},

{   -0.00459352,   -0.00907604,   -0.02068476,   -0.01752188,   -0.03509759,   -0.02897723,   -0.02242144,   -0.02913997,   0.00318966,   -0.00091595},

{   0.01107762,   0.00546846,   -0.00001276,   -0.00142842,   -0.01076665,   -0.02078226,   -0.02919168,   -0.02466836,   -0.03191429,   -0.02349747},

{   0.00783465,   -0.00042958,   -0.00136463,   -0.00608877,   -0.02410140,   -0.00715177,   -0.00640987,   -0.01457449,   0.00913402,   0.00152079},

{   -0.01546191,   -0.01851968,   -0.00669892,   -0.01056069,   -0.01249849,   -0.01381879,   -0.01374939,   -0.00900376,   -0.00739429,   -0.00470642},

{   0.00078318,   0.00203456,   -0.00457136,   -0.01985878,   -0.03592355,   -0.04690434,   -0.02895935,   0.00293128,   -0.00121505,   -0.00717597},

{   -0.01212653,   -0.01986692,   -0.02324829,   0.00367052,   -0.01032869,   -0.01729308,   -0.03407878,   -0.02295738,   -0.00829270,   -0.00252379},

{   -0.00904510,   -0.01094450,   -0.01829106,   -0.03299925,   -0.04246203,   -0.02987120,   -0.03013587,   -0.02375396,   -0.01112768,   0.00806776},

{   0.00371073,   0.01192758,   0.04487591,   0.04961298,   0.04469640,   0.03739255,   0.02788493,   0.01888919,   0.01006733,   0.00055537},

{   -0.00414876,   -0.00806971,   -0.01853441,   -0.00784140,   -0.01284125,   -0.02142337,   -0.01870911,   -0.02863545,   -0.00013891,   -0.00452064},

{   0.00370482,   -0.00028583,   -0.01043066,   -0.01367416,   -0.02846861,   -0.03863164,   -0.01679499,   -0.01875735,   -0.02837507,   -0.00521203},

{   -0.01149320,   -0.02138073,   -0.01879618,   0.02580091,   0.03158101,   0.03076868,   0.04075558,   0.03485110,   0.02587197,   0.01424616},

{   -0.01344467,   -0.02008154,   -0.02874508,   -0.01984988,   -0.03087705,   -0.03726973,   -0.01732255,   -0.01355235,   -0.01306657,   0.00834000},

{   0.00017944,   -0.00749797,   -0.00950584,   -0.01971890,   -0.03880470,   -0.05068581,   -0.05707708,   -0.00602932,   -0.00093686,   0.00151256},

{   -0.00657895,   -0.01276092,   -0.00663745,   -0.01018639,   -0.02569065,   -0.03611357,   -0.04709358,   -0.01963325,   -0.02213332,   -0.00364810},

{   -0.00891231,   -0.00896874,   0.04729117,   0.04958298,   0.04900047,   0.05114494,   0.04291088,   0.03529066,   0.02325801,   0.01218071},

{   -0.00625101,   -0.01361953,   -0.02559423,   -0.03223054,   0.00838412,   0.03074426,   0.02326855,   0.01143200,   0.00726839,   -0.00254345},

{   0.00962416,   0.00578797,   -0.00469408,   -0.02098031,   -0.03970154,   -0.02410071,   -0.01945893,   -0.02555644,   0.00279541,   -0.00276733},

{   0.00016594,   -0.00399601,   -0.00731727,   -0.00585359,   -0.01695927,   -0.02650291,   -0.04236752,   -0.05179219,   -0.00927053,   0.00223535},

{   -0.01137819,   -0.01841432,   -0.02863844,   -0.02549466,   -0.00272539,   0.03105273,   0.04129874,   0.02703469,   0.01674746,   0.00882358},

917

EP 1 214 706 B1

{ -0.01240696, -0.02050348, -0.03230916, -0.01847850, 0.02493462, 0.01658082, 0.01950329, 0.01626036, 0.01239434, 0.00368862},
{ 0.00400441, 0.00044364, -0.00439758, -0.01272883, -0.02737488, -0.03568903, 0.05039078, -0.01931315, 0.00614772, -0.00059630},
},
{ { 0.00006111, -0.00011239, -0.00091541, -0.00171992, 0.01263544, 0.01320593, 0.01204569, 0.01293225, 0.00666364, 0.00402353},
{ 0.00779445, 0.00696512, -0.00184068, 0.00596820, 0.01118068, 0.00710638, 0.00466814, 0.00030543, -0.00416637, -0.00506631},
{ -0.00775987, -0.00470163, 0.02876918, 0.01544713, 0.00472025, 0.00233966, -0.00091549, -0.00172232, -0.00574072, -0.00729726},
{ -0.00192205, -0.00209183, 0.00072963, -0.00370971, -0.01469616, -0.01831928, 0.01060567, 0.00841196, -0.00113362, -0.00135248},
{ 0.00727874, 0.00550317, 0.00265535, 0.00347190, -0.00348257, -0.00700786, 0.01453249, 0.01124473, 0.00636632, 0.00507658},
{ -0.00370169, -0.00578109, -0.01054631, 0.00237922, 0.00610875, 0.00382378, 0.01112889, 0.01061231, 0.00444948, 0.00172272},
{ -0.01082310, -0.00343578, 0.00088772, -0.00179936, 0.00486192, 0.00272746, 0.00364738, 0.00156064, -0.00077856, -0.00162852},
{ 0.00827082, 0.00679115, -0.00515113, -0.01458570, 0.00622652, 0.00687030, 0.00124702, 0.00308527, 0.00723321, 0.00498593},
{ 0.00033643, 0.00105011, 0.00317059, 0.00722382, 0.00500150, 0.00323058, 0.01981710, 0.01102549, -0.00303191, -0.00663890},
{ 0.00236747, 0.00370410, -0.00666410, -0.01274279, -0.01239504, -0.01568273, -0.01086512, -0.00400080, -0.00089377, 0.00181257},
{ 0.00276404, 0.00157884, 0.00686494, 0.01048618, 0.00795789, 0.01655090, 0.00799517, 0.00421079, 0.00749205, 0.00227781},
{ -0.00212620, -0.00277584, 0.00272206, 0.01528548, 0.01589311, 0.00970912, 0.00469392, 0.00593647, 0.00104566, -0.00224531},
{ 0.00005560, -0.00071041, -0.00280654, -0.00394772, -0.00535340, -0.00398863, 0.02467535, 0.02212432, 0.01059736, 0.00534966},
{ 0.00464703, 0.00474611, 0.00196303, -0.00845117, -0.00736551, 0.01393551, 0.01622437, 0.00953056, 0.00301761, -0.00005419},
{ 0.00047992, -0.00137581, 0.00480373, 0.02034039, 0.00168192, -0.00273659, 0.00600385, 0.00154407, -0.00004413, 0.00158964},
{ -0.00111287, 0.00035244, -0.00680570, -0.01735569, -0.00251611, -0.00534775, 0.00351667, 0.00680632, -0.00068295, -0.00082886},
{ 0.00748514, 0.00560680, -0.00091863, 0.00920877, 0.00118810, -0.00632105, -0.00962053, -0.00702395, 0.00190340, -0.00024475},

918

```
{   -0.00250611,   -0.00404516,   -0.00747983,   0.01095903,   0.00795864,   0.00282929,
0.00388997,   -0.00170172,   -0.01516082,   -0.01499629},
{   -0.00382775,   -0.00496896,   -0.00872420,   -0.00897827,   -0.01372950,   0.00223387,
0.00948376,   0.00437347,   0.00551626,   0.00429765},
{   -0.00068027,   -0.00054087,   -0.00137117,   -0.01218331,   -0.01646237,   -0.00125409,  -
0.00512591,   -0.00259414,   0.00019934,   -0.00152469},
{   0.01072110,   0.01216315,   0.00858058,   0.00496877,   0.00387715,   0.00465455,
0.00295036,   0.00223345,   0.00185529,   0.00004801},
{   0.00296041,   0.00674527,   0.00374328,   -0.00204315,   -0.00721346,   -0.00780599,
0.00719436,   0.00024193,   -0.01220476,   -0.01078088};
{   -0.00216296,   -0.00253576,   -0.01080409,   -0.01403971,   0.01317200,   0.01261837,
0.00193829,   0.00045172,   0.00132059,   -0.00249276},
{   0.00922137,   0.01014334,   0.00260340,   -0.00465584,   -0.00515572,   -0.00850082,  -
0.00859783,   -0.00459811,   -0.00840030,   -0.00796677},
{   -0.00801438,   -0.00425278,   0.01495038,   -0.00190038,   -0.00985608,   -0.01157529,  -
0.00885614,   -0.00304473,   0.00181800,   0.00099605},
{   -0.00490201,   -0.00762224,   0.00040365,   0.00582002,   -0.00073916,   0.01154589,
0.00012161,   -0.00446718,   0.00332097,   0.00016409},
{   0.00137264,   0.00074422,   0.02283779,   0.01073287,   -0.00116295,   -0.01058273,  -
0.00316988,   0.00677347,   0.00575176,   0.00257174},
{   0.00319146,   -0.00045188,   -0.01012620,   -0.00021037,   -0.00441827,   -0.01132391,
0.00311417,   -0.00315884,   -0.01255682,   -0.00397431},
{   0.00171563,   -0.00111647,   -0.00583420,   0.01095067,   0.00858833,   0.00692717,
0.00873388,   0.00136371,   0.01266588,   0.00897107},
{   0.00042425,   -0.00141434,   -0.00204316,   -0.00825233,   -0.00419762,   0.01843774,
0.00776467,   0.00399437,   0.01425773,   0.00899603},
{   0.00198198,   0.00052505,   0.00305308,   0.00190291,   -0.01278992,   -0.00529606,
0.00142837,   -0.00523604,   0.00823206,   0.00641433},
{   0.00407774,   0.00128382,   -0.01316027,   -0.00600687,   0.00007500,   -0.00346172,  -
0.00039881,   0.00485414,   0.00543620,   0.00280821},
{   0.00088827,   0.00372026,   0.00085106,   -0.00512459,   0.00587403,   0.00079244,  -
0.00147824,   0.00452383,   -0.00429125,   -0.00514253},
{   -0.00288860,   -0.00282246,   -0.00094926,   -0.00396700,   -0.00478751,   0.01771119,
0.01499634,   0.00307891,   -0.00983328,   -0.01055430},
{   -0.00321458,   0.00689814,   0.00937494,   -0.00267765,   0.00449666,   0.00131638,
0.00049454,   -0.00173761,   0.00155754,   0.00049179},
{   0.00243335,   0.00346759,   -0.00851574,   -0.01570546,   0.00138322,   0.00309032,  -
0.00448764,   -0.01035466,   -0.01368467,   -0.01006367},
{   -0.00445209,   -0.00451981,   0.00775260,   0.00538409,   0.00259379,   0.01130075,
0.01159070,   0.01239608,   0.01218984,   0.00879261},
```

{  -0.00161021,   0.00070235,  -0.00059480,   0.00445431,   0.00396118,  -0.00732553,
0.00000194,   0.00135627,  -0.00251368,  -0.00203525},

{  -0.00651984,  -0.00550594,  -0.00499920,  -0.00484211,  -0.00506232,  -0.00662786,  -
0.00706928,  -0.00334101,  -0.01055323,  -0.00690449},

{  0.00457578,   0.00388137,   0.00548547,   0.00933548,   0.01001904,   0.00163964,
0.00450871,   0.01572982,   0.01107527,   0.00528513},

{  -0.00466753,  -0.00445362,  -0.00337934,  -0.00944068,   0.00200823,   0.00377579,  -
0.00386050,   0.00763733,   0.01127368,   0.00761098},

{  0.00228387,   0.00262173,  -0.00174080,  -0.00116707,   0.01802132,   0.01001005,  -
0.00421486,  -0.01083893,   0.00535106,   0.00251343},

{  -0.00226686,  -0.00219198,  -0.00696038,  -0.00326018,  -0.00700208,  -0.01000534,
0.00590006,  -0.00019387,   0.01364628,   0.01164173},

{  -0.00525566,  -0.00589099,  -0.01282020,  -0.00218846,  -0.00069747,  -0.00377804,  -
0.00281350,  -0.00928819,  -0.00206454,   0.00166221},

{  -0.00648441,  -0.00834980,   0.00047410,   0.00544467,  -0.00151490,  -0.00721561,
0.00421142,   0.01267029,   0.00553720,   0.00203413},

{  -0.00319906,  -0.00153334,  -0.00319572,   0.00124053,   0.00867730,   0.00469551,  -
0.00579935,  -0.01876245,  -0.02031045,  -0.00047261},

{  0.00153075,   0.00203053,   0.01557594,   0.00248293,  -0.00568021,   0.00992088,
0.00651748,   0.00288808,  -0.00400202,  -0.00632845},

{  0.00486833,   0.00291524,   0.00857085,   0.00288218,  -0.00243590,   0.00758656,  -
0.00270442,   0.00120835,   0.01880961,   0.01357284},

{  -0.00011043,   0.00233758,   0.00924841,  -0.00813434,  -0.01069492,  -0.00390450,
0.00359210,   0.01126875,   0.00746396,   0.00485185},

{  -0.00494091,  -0.00523131,   0.01230702,   0.01752272,   0.00766125,  -0.00318486,  -
0.01345777,  -0.00804930,   0.00290803,   0.00083750},

{  0.00032569,   0.00009018,   0.01225586,   0.00569636,  -0.00705480,  -0.01384848,  -
0.01169237,  -0.01071170,  -0.01027119,  -0.00767364},

{  0.00280051,   0.00710533,   0.00490902,   0.00336591,   0.00371334,  -0.00447382,  -
0.01473072,  -0.01935226,  -0.02067918,  -0.01008544},

{  0.00612606,   0.00452334,   0.00281361,  -0.00371625,  -0.00823255,   0.00377597,  -
0.00722384,  -0.01549285,   0.00240305,  -0.00039173},

{  -0.00188299,  -0.00288016,  -0.00945697,  -0.00819146,   0.00376693,  -0.00310810,  -
0.01815127,  -0.01087037,  -0.00275809,  -0.00523949},

{  0.00302839,   0.00234366,   0.00453269,   0.01641155,   0.01357589,   0.00569236,  -
0.00491735,  -0.00780978,  -0.00900474,  -0.00804208},

{  -0.00080239,  -0.00316640,  -0.00369995,   0.00115340,  -0.00644417,  -0.01160044,  -
0.02211991,   0.00383138,   0.00405909,   0.00056062},

{  0.00174899,   0.00438349,   0.00367090,  -0.00111571,   0.01566313,   0.01579812,
0.00417576,  -0.00456289,  -0.01404146,  -0.01288739},

{ 0.00718619, 0.00681000, 0.01045663, 0.01057205, 0.00363275, 0.00126916, -0.00035579, -0.00555201, -0.01126034, -0.00898206},

{ 0.00405121, 0.00357693, 0.00265770, -0.00375096, -0.00505171, -0.01364679, -0.01345036, 0.01153075, 0.01532976, 0.00847445},

{ -0.00043160, -0.00087914, 0.00860999, 0.00148947, 0.00531393, 0.00352189, -0.01237297, -0.00004966, -0.00106361, -0.00556562},

{ -0.00056662, -0.00212456, -0.00117172, 0.00762109, 0.00219673, -0.00025564, -0.01128915, -0.01699960, 0.01354709, 0.01176087},

{ -0.00408654, -0.00096384, -0.00423818, -0.00744231, -0.00876295, -0.01304774, -0.01141891, -0.01555846, -0.01246216, 0.00585658},

{ -0.00039385, 0.00025901, 0.00353937, 0.00203476, -0.00176971, 0.00209237, -0.00340730, -0.01026764, -0.02600074, -0.02177020},

{ 0.00243314, 0.00343546, 0.00161754, -0.00371032, -0.00350422, -0.00970857, -0.02319258, -0.02738033, 0.00899502, 0.00814799},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

```
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
```

```
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000-,   0.00000000,    0.00000000,    0.00000000,    0.00000000,    0.00000000,
0.00000000,    0.00000000,    0.00000000,    0.00000000},
},
{{   0.00007302,   -0.00074506,    0.00167535,   -0.00200298,   -0.01561921,    0.00467142,
0.00250590,   -0.00179108,    0.00045385,   -0.00218648},
{   0.00093298,   -0.00177509,    0.01404716,    0.00543233,    0.00031596,    0.00291425,   -
0.00009707,    0.00167511,    0.00182873,    0.00219560},
{  -0.00174480,    0.00007287,   -0.00089953,   -0.01199317,   -0.00050311,   -0.00556124,   -
0.00281232,   -0.00270383,   -0.00114969,   -0.00214721},
{  -0.00262070,    0.00748139,   -0.00280502,   -0.00136286,   -0.00078590,    0.00175876,   -
0.00098000,    0.00457380,    0.00355523,    0.01034175},
{   0.00074436,   -0.00115665,    0.00189529,    0.01157575,    0.00224026,   -0.00212844,   -
0.00306117,    0.00230632,   -0.00278911,    0.00703257},
{   0.00390810,    0.00046965,   -0.00695795,    0.00670060,    0.00287957,    0.00210736,
0.00370070,    0.00504010,    0.00404556,    0.00019377},
{   0.00189179,    0.00096211,    0.00210929,    0.00010549,   -0.00104655,    0.01168018,   -
0.00070392,    0.00279664,    0.00885825,    0.00387118},
{  -0.00079471,   -0.00199071,    0.00625236,    0.00278785,   -0.00271890,    0.00075786,
0.00309626,   -0.00618918,    0.00809770,    0.01078922},
```

{ 0.00013985, -0.00141381, -0.00365764, 0.00326014, -0.00874184, 0.00148973, -0.00651280, -0.00398857, 0.00748833, 0.00190015},

{ 0.00696733, 0.01084724, 0.00240300, -0.00150848, -0.00300501, -0.00039626, -0.00258365, -0.00025108, -0.00054973, 0.00145405},

{ -0.00023407, -0.00239894, 0.00102984, 0.00612422, -0.00136156, 0.00867489, 0.00206586, 0.00942366, 0.00106978, -0.00561362},

{ 0.00234993, -0.00051945, -0.00417579, -0.00371189, 0.00167682, -0.00557327, 0.00565083, 0.01242620, -0.00050916, -0.00199941},

{ -0.00188685, -0.00077652, 0.00330529, -0.00125596, -0.00501212, -0.00913486, -0.00240911, 0.00818219, 0.00350082, 0.00295110},

{ -0.00076638, 0.00183468, 0.00532269, -0.00322180, 0.00552090, 0.00256412, 0.00336437, 0.00908956, 0.00331912, -0.00190910},

{ 0.00111320, -0.00037587, -0.00024503, 0.00402914, 0.00237231, -0.00271156, -0.01232017, 0.01351714, 0.01213235, 0.00516090},

{ 0.00210448, 0.00546874, -0.00340875, 0.00102174, 0.00582430, -0.00256006, -0.00435470, -0.00040125, 0.00165970, -0.00364914},

{ 0.00126084, 0.00040107, -0.00141030, -0.00645370, -0.00571476, 0.00271883, 0.00332637, 0.00396915, 0.00628144, 0.00809955},

{ 0.00117079, 0.00059576, -0.00014311, -0.00465681, -0.00591142, -0.00478553, -0.00138077, -0.00704582, -0.01184659, 0.00882896},

{ 0.00138973, 0.00123652, 0.00304817, -0.00507302, 0.00288668, -0.00338459, -0.01331825, 0.00027167, 0.00470983, 0.00387003},

{ 0.00076815, 0.00155115, 0.00291000, 0.00703008, 0.00621193, 0.00485275, 0.00301572, -0.00341427, 0.00549137, 0.00287316},

{ 0.00033265, -0.00047441, -0.00019610, -0.00024157, 0.01414834, 0.00262556, -0.00205734, 0.00161241, 0.00131464, 0.00131441},

{ -0.00378284, -0.00044598, -0.00380424, -0.00331107, 0.00360503, -0.00291761, -0.00829789, 0.00941720, 0.00051424, -0.00585368},

{ 0.00195321, 0.00184592, -0.00126926, 0.00055559, -0.00055360, -0.00721628, 0.00243223, -0.00459577, 0.01175538, 0.01116091},

{ -0.00023710, 0.00162962, -0.00275466, -0.00136286, 0.00636333, 0.00927344, 0.00845523, 0.00355330, -0.00205688, -0.00505345},

{ 0.00427265, 0.00381217, -0.00033214, 0.00105652, -0.00486730, 0.00089909, 0.00048308, -0.00797174, 0.00324721, -0.00023383},

{ 0.00026448, -0.00067842, 0.00107705, 0.00333172, 0.00195835, 0.00189156, 0.00951886, 0.00930392, 0.00693669, 0.00857660},

{ 0.00407814, 0.00285434, 0.00269327, 0.00424816, 0.00462708, 0.00521001, 0.00096518, 0.00184609, -0.00404653, -0.00582069},

{ 0.00051601, 0.00244371, 0.00807730, -0.00659189, 0.00075139, 0.00120002, -0.00067461, -0.00520723, 0.00006501, -0.00106395},

```
{   0.00154864,    0.00175935,    0.00137842,    0.00332717,   -0.00770257,   -0.00281735,
0.00898536,    0.00426355,    0.00356744,   -0.00048447},
{  -0.00110883,   -0.00025148,    0.00118848,   -0.00870558,    0.00650556,    0.00586968,
0.00271981,   -0.00453412,    0.00242571,    0.00849993},
{   0.00070532,   -0.00025072,    0.00366505,   -0.00167716,   -0.00296136,    0.01020369,
0.00688567,    0.00095235,   -0.01077141,    0.00293674},
{   0.00269407,    0.00092414,   -0.00878398,    0.00160851,   -0.00639129,   -0.00094266,
0.00082998,   -0.00270264,   -0.00442263,   -0.00888590},
{  -0.00278214,    0.00287601,   -0.00500381,   -0.00138864,   -0.00284296,   -0.00735792,
0.00637880,   -0.00326541,    0.00157648,   -0.00131956},
{   0.00363546,    0.00214577,    0.00414674,    0.00266734,   -0.00079453,   -0.00406520,
0.00712001,    0.00206326,   -0.00523273,    0.01149989},
{  -0.00000026,   -0.00386427,    0.00640634,    0.00261276,    0.00277903,   -0.00013026,   -
0.01273183,    0.00959437,   -0.00109646,   -0.00530037},
{   0.00349409,    0.00059023,   -0.00230930,    0.00261091,   -0.00124556,   -0.00746849,   -
0.01029008,    0.00287435,   -0.00605374,   -0.00529882},
{   0.00353078,    0.00009537,    0.00405514,   -0.00273642,   -0.00681506,    0.00089121,   -
0.00769497,    0.00918448,    0.00100596,   -0.00354415},
{  -0.00048915,    0.00219592,    0.00196135,    0.00371528,    0.00049757,   -0.00921692,
0.00952075,    0.00796835,   -0.00439759,   -0.00914252},
{   0.00099541,   -0.00179639,   -0.00422007,    0.00144744,   -0.00122703,    0.00894285,
0.00517048,   -0.00422113,    0.00026459,    0.01125521},
{   0.00284500,    0.00255142,   -0.00501236,   -0.00399376,    0.00453097,   -0.00045817,
0.00396111,   -0.00344911,   -0.01026568,    0.00482538},
{  -0.00325499,    0.00057240,   -0.00117489,   -0.00668998,   -0.00387262,    0.00826259,
0.00012935,   -0.00535898,   -0.00161315,   -0.00518571},
{  -0.00204424,   -0.00205964,   -0.00267784,   -0.00085138,    0.00334009,   -0.00839914,   -
0.00136307,   -0.00173559,   -0.00516495,    0.01164448},
{  -0.00410270,    0.00939750,    0.00385454,    0.00290060,    0.00194424,    0.00206843,
0.00582770,   -0.00159821,   -0.00199349,   -0.00404345},
{   0.00129409,   -0.00184888,   -0.00259575,   -0.00257605,    0.00297719,    0.00723570,   -
0.00858313,   -0.00202067,   -0.00340528,   -0.00772488},
{  -0.00235071,   -0.00109572,   -0.00477851,   -0.00437243,    0.00461958,    0.00073576,   -
0.00018923,    0.00108088,    0.00900257,    0.00726468},
{  -0.00078569,    0.00304111,    0.00186742,   -0.00410820,    0.00456433,   -0.00060262,   -
0.00330057,   -0.00122075,   -0.01093924,   -0.00844479},
{   0.00095778,    0.00049767,    0.00293670,    0.00335490,    0.00341477,    0.00244888,   -
0.00308668,   -0.01163045,   -0.01418884,    0.00720374},
{   0.00026347,   -0.00164608,   -0.00094501,    0.00772980,    0.00046633,   -0.00128056,
0.00689654,   -0.00084991,   -0.01277967,   -0.00052741},
```

{ -0.00065633, 0.00272296, 0.00456446, 0.00488337, -0.00292273, -0.00487562, -0.00687198, -0.00517779, -0.00174580, -0.00346636},

{ 0.00260815, -0.00641491, -0.00095775, -0.00226445, -0.00283377, -0.00246661, -0.00611697, -0.00409055, 0.00354730, 0.00338705},

{ -0.00099595, 0.00094685, -0.00331898, -0.00146973, 0.00179052, -0.00139797, -0.00709227, -0.01524743, 0.00441790, 0.00173202},

{ -0.00408121, 0.00089766, 0.00094466, 0.00325065, 0.00672033, -0.00019249, 0.00589924, 0.00322853, -0.00242561, 0.00219359},

{ -0.00257228, -0.00179791, -0.00268333, -0.00031574, -0.00571698, -0.00369395, -0.00741923, -0.00260730, -0.00501607, 0.00224587},

{ -0.00113380, -0.00073103, -0.00428704, 0.00683978, 0.00594497, 0.00372150, -0.00044871, -0.00602975, -0.00321987, -0.00597447},

{ 0.00341457, 0.00178256, -0.00503937, -0.00927698, 0.00228853, 0.00247928, -0.00337487, 0.00382129, 0.00237729, -0.00228635},

{ -0.00621084, 0.00386607, 0.00249559, 0.00131394, 0.00261413, 0.00158248, -0.00461110, -0.00825484, 0.00388321, 0.00049303},

{ -0.00071191, -0.00404093, -0.00406227, -0.00362297, -0.00396032, -0.00054434, 0.00823714, 0.00458085, -0.00313846, -0.00720971},

{ -0.00317347, -0.00411505, 0.00155333, -0.00082595, 0.00270407, 0.00844264, 0.00193732, 0.00016764, 0.00304433, 0.00055788},

{ -0.00530220, 0.00236141, 0.00160612, -0.00435760, -0.00325925, -0.00106870, 0.01171124, 0.00597055, 0.00152771, -0.00160379},

{ -0.00380354, -0.00248355, -0.00205986, 0.00649275, -0.00148701, -0.00123465, 0.00469793, 0.00036483, 0.00663194, 0.00243151},

{ -0.00319243, -0.00320118, 0.00582574, -0.00058566, -0.00096663, -0.00345346, 0.00008310, -0.00664409, -0.00607386, -0.00673633},

{ -0.01462694, 0.01047577, 0.00080652, -0.00036210, 0.00012141, -0.00213070, 0.00368270, 0.00243329, 0.00218546, -0.00253235},

{ 0.00057512, -0.00450090, -0.01124568, -0.00049298, 0.00071818, -0.00244420, -0.00243412, 0.00051171, -0.00145560, -0.00282889},

{ -0.01118169, 0.00200960, 0.01001314, 0.00019961, 0.00375019, 0.00144620, 0.00168001, -0.00091153, -0.00359078, -0.00690694},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{ 0.00000000, 0.00000000, 0.00000000, 0.00000000, 0.00000000, 0.00000000, 0.00000000, 0.00000000, 0.00000000, 0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

{    0.00000000,    0.00000000,    0.00000000,    0.00000000,    0.00000000,    0.00000000,
0.00000000,    0.00000000,    0.00000000,    0.00000000},

```
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
{   0.00000000,    0.00000000,    0.00000000,    0.00000000,    0.00000000,    0.00000000,
0.00000000,    0.00000000,    0.00000000,    0.00000000},
```

```
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
```

},
{ { 0.00086208, -0.00248842, 0.00084186, -0.00446845, 0.00190942, -0.00295110, -0.00414520, 0.00622425, 0.00301297, -0.00225570},
{ -0.00066277, -0.00156242, -0.00188648, -0.00068226, 0.00362849, 0.00524252, 0.00329070, 0.00544285, 0.00084142, -0.00328989},
{ 0.00028247, -0.00016973, 0.00049755, -0.00255812, -0.00450452, 0.00681138, -0.00044480, 0.00599771, 0.00111314, 0.00478895},
{ 0.00041410, 0.00081556, -0.00343059, -0.00451393, -0.00500038, -0.00225441, 0.00018195, 0.00143104, 0.00177757, -0.00128368},
{ -0.00079673, 0.00159853, -0.00034292, 0.00129426, -0.00007302, 0.00546219, 0.00665160, -0.00060734, 0.00546493, 0.00373903},
{ 0.00068656, 0.00111316, -0.00008834, 0.00168500, -0.00013310, -0.01042266, 0.00157247, 0.00014180, 0.00170112, 0.00146082},
{ -0.00166456, -0.00053325, 0.00240356, -0.00180217, 0.00300015, -0.00312061, 0.00658243, -0.00067789, 0.00694877, 0.00108795},
{ 0.00118114, -0.00008417, -0.00656243, 0.00095065, 0.00071917, -0.00153054, -0.00386470, -0.00257462, 0.00007614, 0.00225336},
{ 0.00094708, -0.00160821, 0.00629218, 0.00066733, 0.00448857, -0.00283788, 0.00022201, 0.00142664, 0.00163499, -0.00287178},
{ -0.00443331, 0.00103346, -0.00057657, -0.00053597, -0.00097487, 0.00332860, -0.00072481, -0.00027174, 0.00542735, -0.00107210},
{ -0.00153246, 0.00126305, 0.00037245, 0.00417289, -0.00493101, -0.00290573, 0.00475200, -0.00247545, 0.00169144, -0.00189035},
{ 0.00632485, 0.00086394, -0.00243321, -0.00106806, 0.00089774, 0.00107041, 0.00100679, -0.00003992, -0.00117692, -0.00043792},
{ -0.00623386, 0.01390054, 0.00108531, -0.00192767, -0.00132562, 0.00104818, -0.00054211, -0.00030534, -0.00020025, -0.00258714},
{ -0.00113192, -0.00035026, -0.00059348, 0.00129056, -0.00149712, -0.00082094, -0.00071770, 0.00970785, 0.00744038, 0.00238955},
{ 0.00123799, 0.00207061, -0.00115538, -0.00289553, 0.00056005, -0.00391641, 0.00717160, 0.00382398, -0.00122682, -0.00377559},
{ 0.00077307, 0.00142555, 0.00109648, -0.00464006, 0.00533187, -0.00510332, 0.00023855, -0.00328482, -0.00074710, -0.00460103},
{ 0.00238819, -0.00135793, -0.00201387, 0.00387475, -0.00317698, -0.00222894, 0.00021505, 0.00525476, 0.00104911, -0.00520327},
{ 0.00065771, -0.00098232, 0.00319080, -0.00011477, -0.00132514, -0.00374788, 0.00162312, 0.00722737, -0.00459214, 0.00172425},
{ -0.00080202, 0.00335683, 0.00240561, -0.00084930, -0.00253268, -0.00320793, 0.00148629, 0.00474258, 0.00404238, -0.00205515},

{  -0.00084023,  -0.00062754,  0.00305737,  -0.00277919,  -0.00390684,  0.00155093,
0.00464761,  0.00169321,  -0.00112743,  -0.00660412},

{  -0.00176868,  0.00027891,  -0.00201939,  -0.00235603,  -0.00009332,  -0.00457865,  -
0.00467367,  0.00322558,  0.00020224,  0.00584177},

{  0.00086051,  -0.00472371,  0.00225357,  0.00169834,  -0.00099507,  0.00166508,
0.00349894,  -0.00397513,  0.00081766,  0.00088133},

{  -0.00135226,  -0.00102119,  0.00024682,  0.00058089,  0.00708151,  0.00338386,  -
0.00097824,  -0.00454912,  0.00067067,  0.00050568},

{  -0.00166578,  -0.00031528,  0.00204148,  0.00423986,  0.00002128,  0.00552738,
0.00293300,  0.00102631,  -0.00392290,  0.00005823},

{  0.00247632,  0.00008008,  0.00181157,  0.00039791,  -0.00424684,  -0.00178287,
0.00106831,  -0.00164437,  0.00466169,  0.00536029},

{  0.00125419,  0.00000370,  -0.00230147,  0.00086239,  -0.00376812,  0.00998392,
0.00183310,  -0.00260948,  0.00012972,  -0.00325000},

{  -0.00129835,  -0.00040074,  0.00347131,  -0.00240826,  -0.00210135,  0.00023977,  -
0.00514458,  0.00096217,  0.00482401,  0.00448526},

{  -0.00020902,  0.00260007,  0.00052125,  -0.00445330,  -0.00314753,  0.00350929,
0.00163139,  -0.00557720,  0.00211181,  0.00226549},

{  0.00095971,  0.00192905,  0.00138940,  -0.00149907,  0.00434330,  0.00299268,  -
0.00050098,  0.00685241,  0.00339234,  0.00214265},

{  0.00111410,  0.00147469,  -0.00261147,  0.00385966,  -0.00161462,  0.00069539,
0.00429436,  0.00372510,  -0.00357642,  0.00732019},

{  0.00006076,  0.00042616,  -0.00290309,  -0.00079895,  0.00620516,  -0.00348487,
0.00376823,  0.00253090,  0.00253809,  0.00324418},

{  -0.00012903,  0.00245457,  -0.00379365,  0.00290667,  0.00212028,  0.00266207,  -
0.00094542,  0.00127099,  0.00286725,  -0.00536799},

{  -0.00009478,  -0.00029151,  -0.00049341,  0.00888911,  0.00214375,  0.00061872,
0.00143956,  0.00142848,  0.00333705,  0.00056408},

{  0.00222409,  -0.00002446,  -0.00149917,  0.00325262,  0.00276110,  -0.00310332,
0.00352549,  -0.00657974,  -0.00242479,  0.00296384},

{  -0.00134549,  0.00274138,  -0.00217626,  0.00018026,  0.00211455,  0.00533394,  -
0.00307828,  -0.00164653,  -0.00277337,  0.00667706},

{  0.00064191,  -0.00189750,  -0.00206915,  -0.00192326,  -0.00156328,  -0.00116744,
0.00750298,  0.00038875,  -0.00034884,  0.00670989},

{  -0.00064076,  0.00027328,  -0.00032465,  -0.00764104,  0.00273591,  0.00193690,
0.00167687,  0.00269155,  -0.00268331,  0.00124151},

{  -0.00203748,  0.00145185,  -0.00306498,  0.00044752,  -0.00373806,  0.00209342,  -
0.00038828,  0.00603700,  -0.00437354,  -0.00275224},

{  0.00024120,  -0.00048565,  -0.00123779,  0.00499967,  -0.00281858,  0.00397071,  -
0.00330131,  -0.00607967,  0.00298967,  0.00235291},

{   0.00196641,    0.00056098,    -0.00177490,    -0.00194885,    0.00203612,    -0.00067509,    -0.00565878,    0.00424678,    -0.00609632,    0.00238902},

{   0.00014292,    -0.00202034,    -0.00166715,    -0.00079566,    -0.00315657,    -0.00596721,    -0.00141144,    -0.00552633,    0.00226848,    -0.00208710},

{   0.00093111,    -0.00165178,    -0.00032798,    0.00295016,    0.00195668,    0.00147907,    -0.00431917,    0.00469877,    -0.00039486,    0.00895634},

{   0.00122796,    0.00203197,    0.00268342,    0.00095639,    -0.00378623,    0.00180324,    -0.00269705,    -0.00036101,    -0.00557186,    -0.00079306},

{   0.00180834,    0.00084937,    0.00222321,    0.00285031,    0.00249971,    0.00239334,    0.00671113,    0.00031736,    0.00160739,    -0.00415138},

{   -0.00174145,    0.00091289,    -0.00316276,    -0.00256852,    0.00151101,    0.00104166,    0.00534198,    -0.00497542,    -0.00067080,    -0.00337438},

{   -0.00097879,    0.00144201,    0.00080518,    0.00356054,    0.00239883,    -0.00256869,    -0.00483024,    0.00850655,    -0.00034326,    -0.00500386},

{   -0.00212114,    -0.00127095,    -0.00140703,    0.00327541,    0.00122228,    -0.00489747,    0.00317885,    0.00162179,    -0.00275859,    -0.00532159},

{   0.00025401,    0.00014398,    0.00298840,    0.00243957,    0.00166451,    0.00629781,    -0.00537736,    0.00110198,    0.00363840,    -0.00101688},

{   -0.00202005,    0.00235003,    0.00217112,    0.00022358,    0.00312872,    -0.00218539,    0.00335181,    0.00012472,    -0.00442290,    0.00491788},

{   -0.00202496,    0.00038179,    0.00070388,    -0.00313552,    0.00304247,    0.00196510,    -0.00682258,    0.00062708,    -0.00069537,    -0.00433244},

{   -0.00024116,    -0.00111487,    0.00232351,    0.00340867,    0.00186041,    -0.00438451,    -0.00575372,    -0.00318147,    -0.00328493,    0.00097041},

{   0.00147860,    0.00312901,    0.00014157,    0.00339818,    0.00150767,    -0.00205441,    -0.00322139,    -0.00185155,    0.00341243,    0.00366935},

{   0.00018523,    0.00192453,    -0.00110424,    0.00024090,    -0.00346463,    -0.00066422,    -0.00953683,    0.00067760,    0.00292052,    -0.00150136},

{   0.00056105,    0.00009368,    0.00118450,    -0.00227920,    0.00227109,    -0.00205330,    -0.00230305,    -0.00634465,    0.00179672,    0.01198107},

{   0.00215523,    -0.00042082,    -0.00175150,    -0.00358539,    0.00279677,    0.00336525,    -0.00016516,    -0.00443252,    0.00674258,    0.00099186},

{   -0.00142919,    0.00124386,    0.00293935,    0.00149501,    -0.00001751,    -0.00030417,    -0.00203712,    -0.00892448,    0.00199036,    -0.00334775},

{   0.00185580,    -0.00063800,    0.00416852,    -0.00335500,    0.00154925,    0.00345948,    -0.00107564,    -0.00527175,    -0.00310700,    -0.00329016},

{   -0.00096271,    -0.00176145,    -0.00088351,    -0.00397697,    -0.00203621,    0.00308198,    -0.00394513,    -0.00270040,    -0.00509416,    0.00386696},

{   0.00073146,    -0.00078403,    0.00206517,    -0.00050691,    0.00247155,    0.00521481,    0.00314152,    0.00015458,    -0.00658762,    0.01286261},

{   -0.00177727,   -0.00088440,   0.00112403,   0.00121361,   -0.00446313,   -0.00190805,
0.00097416,   -0.00196491,   -0.00458979,   0.00926580},

{   -0.00063716,   -0.00074135,   -0.00320684,   0.00060174,   0.00146160,   -0.00175724
0.00095403,   -0.00052926,   -0.01098564,   0.00521625},

{   0.00147074,   -0.00242869,   -0.00034958,   0.00151139,   -0.00105102,   0.00117536,
0.00341839,   -0.00116328,   -0.00521109,   -0.00834604},

{   -0.00089161,   0.00169236,   0.00070051,   -0.00300855,   -0.00261332,   -0.00489216
0.00078356,   -0.00301007,   -0.00620281,   -0.00242624},

{   0.00009583,   0.00150178,   -0.00007453,   0.00239520,   0.00522328,   0.00147270,
0.00167806,   -0.00123525,   -0.00775452,   -0.00448655},

{   0.00000000,   0.00000000,   0.00000000,   0.00000000,   0.00000000,   0.00000000,
0.00000000,   0.00000000,   0.00000000,   0.00000000},

{   0.00000000,   0.00000000,   0.00000000,   0.00000000,   0.00000000,   0.00000000,
0.00000000,   0.00000000,   0.00000000,   0.00000000},

{   0.00000000,   0.00000000,   0.00000000,   0.00000000,   0.00000000,   0.00000000,
0.00000000,   0.00000000,   0.00000000,   0.00000000},

{   0.00000000,   0.00000000,   0.00000000,   0.00000000,   0.00000000,   0.00000000,
0.00000000,   0.00000000,   0.00000000,   0.00000000},

{   0.00000000,   0.00000000,   0.00000000,   0.00000000,   0.00000000,   0.00000000,
0.00000000,   0.00000000,   0.00000000,   0.00000000},

{   0.00000000,   0.00000000,   0.00000000,   0.00000000,   0.00000000,   0.00000000,
0.00000000,   0.00000000,   0.00000000,   0.00000000},

{   0.00000000,   0.00000000,   0.00000000,   0.00000000,   0.00000000,   0.00000000,
0.00000000,   0.00000000,   0.00000000,   0.00000000},

{   0.00000000,   0.00000000,   0.00000000,   0.00000000,   0.00000000,   0.00000000,
0.00000000,   0.00000000,   0.00000000,   0.00000000},

{   0.00000000,   0.00000000,   0.00000000,   0.00000000,   0.00000000,   0.00000000,
0.00000000,   0.00000000,   0.00000000,   0.00000000},

{   0.00000000,   0.00000000,   0.00000000,   0.00000000,   0.00000000,   0.00000000,
0.00000000,   0.00000000,   0.00000000,   0.00000000},

{   0.00000000,   0.00000000,   0.00000000,   0.00000000,   0.00000000,   0.00000000,
0.00000000,   0.00000000,   0.00000000,   0.00000000},

{   0.00000000,   0.00000000,   0.00000000,   0.00000000,   0.00000000,   0.00000000,
0.00000000,   0.00000000,   0.00000000,   0.00000000},

{   0.00000000,   0.00000000,   0.00000000,   0.00000000,   0.00000000,   0.00000000,
0.00000000,   0.00000000,   0.00000000,   0.00000000},

```
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
{    0.00000000,    0.00000000,    0.00000000,    0.00000000,    0.00000000,    0.00000000,
0.00000000,    0.00000000,    0.00000000,    0.00000000},
```

```
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
{    0.00000000 ,    0.00000000 ,    0.00000000 ,    0.00000000 ,    0.00000000 ,    0.00000000 ,
0.00000000 ,    0.00000000 ,    0.00000000 ,    0.00000000},
```

```
{   0.00000000 ,   0.00000000 ,   0.00000000 ,   0.00000000 ,   0.00000000 ,   0.00000000 ,
0.00000000 ,   0.00000000 ,   0.00000000 ,   0.00000000},
{   0.00000000 ,   0.00000000 ,   0.00000000 ,   0.00000000 ,   0.00000000 ,   0.00000000 ,
0.00000000 ,   0.00000000 ,   0.00000000 ,   0.00000000},
{   0.00000000 ,   0.00000000 ,   0.00000000 ,   0.00000000 ,   0.00000000 ,   0.00000000 ,
0.00000000 ,   0.00000000 ,   0.00000000 ,   0.00000000},
{   0.00000000 ,   0.00000000 ,   0.00000000 ,   0.00000000 ,   0.00000000 ,   0.00000000 ,
0.00000000 ,   0.00000000 ,   0.00000000 ,   0.00000000},
{   0.00000000 ,   0.00000000 ,   0.00000000 ,   0.00000000 ,   0.00000000 ,   0.00000000 ,
0.00000000 ,   0.00000000 ,   0.00000000 ,   0.00000000},
{   0.00000000 ,   0.00000000 ,   0.00000000 ,   0.00000000 ,   0.00000000 ,   0.00000000 ,
0.00000000 ,   0.00000000 ,   0.00000000 ,   0.00000000},
{   0.00000000 ,   0.00000000 ,   0.00000000 ,   0.00000000 ,   0.00000000 ,   0.00000000 ,
0.00000000 ,   0.00000000 ,   0.00000000 ,   0.00000000},
{   0.00000000 ,   0.00000000 ,   0.00000000 ,   0.00000000 ,   0.00000000 ,   0.00000000 ,
0.00000000 ,   0.00000000 ,   0.00000000 ,   0.00000000},
{   0.00000000 ,   0.00000000 ,   0.00000000 ,   0.00000000 ,   0.00000000 ,   0.00000000 ,
0.00000000 ,   0.00000000 ,   0.00000000 ,   0.00000000},
},
};

/*---------------------------------------------------------------*/


/*===============================================================*/
/*----------------------------- END ----------------------------*/
/*===============================================================*/
```

```
/*==============================================================
=*/


/*============================================================*/
/* Conexant System Inc.                                       */
/* 4311 Jamboree Road                                         */
/* Newport Beach, CA 92660                                    */
/*----------------------------------------------------------*/
/* Copyright(C) 2000 Conexant System Inc.                     */
/*----------------------------------------------------------*/
/* ALL RIGHTS RESERVED:                                       */
/* No part of this software may be reproduced in any form or by any */
/* means or used to make any derivative work (such as transformation */
/* or adaptation) without the authorisation of Conexant System Inc.  */
/*==========================================================*/
/* LIBRARY: tracks.tab                                        */
/*==========================================================*/


/*---------------------------------------------------------------
*/
/*------------------------------ TABLES ------------------------------
*/
/*---------------------------------------------------------------
*/


static INT16 srchpuls[12] = {0, 1, 2, 3, 4, 6, 5, 7, 0, 7, 1, 6};


/*----------------------------------------------------------*/
/*======================== 13 bits FCB ====================*/
/*----------------------------------------------------------*/


/*----------------------------------------------------------*/
/*     2 pulses CB :   2pulses x 5bits/pulse + 2 signs = 12 bits    */
/*----------------------------------------------------------*/


static INT16 track_2_5_0[2][32]={
     {0,1,2,3,4,5,6,7,8,9,10, 12, 14, 16, 18, 20, 22, 24, 26,
     28, 30, 32, 34, 36, 38, 40, 42, 44, 46, 48, 50, 52},


     {1, 3, 5, 7, 9, 11,12,13,14,15,16,17,18,19,20,21,22,23, 25,
```

```
       27, 29, 31, 33, 35, 37, 39, 41, 43, 45, ·47, 49, 51}};


   /*----------------------------------------------------------------*/
   /*      3 pulses CB :  3 pulses x 2 bits/pulse + 3 signs = 9 bits      */
   /*----------------------------------------------------------------*/


   static INT16 track_3_2_0[3][4]={
           {0, 3, 6, 9}, {1, 4, 7, 10}, {2, 5, 8, 11}
   };


   /*----------------------------------------------------------------*/
   /*      1 pulse CB :  1 pulse x 3 bits/pulse + 1 signs = 4 (3) bits   */
   /*----------------------------------------------------------------*/


   static INT16 track_1_3_0[1][8]={
           {0, 5, 11, 17, 23, 29, 35, 41}
   };




   /*----------------------------------------------------------------*/
   /*========================= 15 bits FCB =========================*/
   /*----------------------------------------------------------------*/




   /*----------------------------------------------------------------*/
   /*   2 pulses CB :   2pulses x 6.5bits/pulse + 1 sign = 14 bits       */
   /*----------------------------------------------------------------*/


   static INT16 track_2_7_1[2][80]={
       {0,  1,  2,  3,  4,  5,  6,  7,  8,  9,  10, 11, 12, 13, 14, 15,
        16, 17, 18, 19, 20, 21, 22, 23, 24, 25, 26, 27, 28, 29, 30, 31,
        32, 33, 34, 35, 36, 37, 38, 39, 40, 41, 42, 43, 44, 45, 46, 47,
        48, 49, 50, 51, 52, 53, 54, 55, 56, 57, 58, 59, 60, 61, 62, 63,
        64, 65, 66, 67, 68, 69, 70, 71, 72, 73, 74, 75, 76, 77, 78, 79},

       {0,  1,  2,  3,  4,  5,  6,  7,  8,  9,  10, 11, 12, 13, 14, 15,
        16, 17, 18, 19, 20, 21, 22, 23, 24, 25, 26, 27, 28, 29, 30, 31,
        32, 33, 34, 35, 36, 37, 38, 39, 40, 41, 42, 43, 44, 45, 46, 47,
        48, 49, 50, 51, 52, 53, 54, 55, 56, 57, 58, 59, 60, 61, 62, 63,
        64, 65, 66, 67, 68, 69, 70, 71, 72, 73, 74, 75, 76, 77, 78, 79}
   };
```

```
/*---------------------------------------------------------------*/
/*   1 pulse CB :   1 pulse x 4 bits/pulse + 1 signs = 5 (4) bits      */
/*---------------------------------------------------------------*/


static INT16 track_1_4_0[1][16]={
      {0, 4, 8, 12, 16, 20, 24, 28, 33, 38, 43, 48, 53, 58, 63, 68}
};




/*---------------------------------------------------------------*/
/*========================== 30 bits FCB =======================*/
/*---------------------------------------------------------------*/


/*---------------------------------------------------------------*/
/*      8 pulses CB : 6p x 3b + 2p x 4b + 4b signs = 30 bits         */
/*---------------------------------------------------------------*/


static INT16 track_8_4_0[8][16]={
      {0, 5, 10, 15, 20, 25, 30, 35, 2, 7, 12, 17, 22, 27, 32, 37},
      {1, 6, 11, 16, 21, 26, 31, 36, 0, 0, 0, 0, 0, 0, 0, 0},
      {3, 8, 13, 18, 23, 28, 33, 38, 0, 0, 0, 0, 0, 0, 0, 0},
      {4, 9, 14, 19, 24, 29, 34, 39, 0, 0, 0, 0, 0, 0, 0, 0},

      {0, 5, 10, 15, 20, 25, 30, 35, 2, 7, 12, 17, 22, 27, 32, 37},
      {1, 6, 11, 16, 21, 26, 31, 36, 0, 0, 0, 0, 0, 0, 0, 0},
      {3, 8, 13, 18, 23, 28, 33, 38, 0, 0, 0, 0, 0, 0, 0, 0},
      {4, 9, 14, 19, 24, 29, 34, 39, 0, 0, 0, 0, 0, 0, 0, 0}
};




/*---------------------------------------------------------------*/
/*========================== 22 bits FCB =======================*/
/*---------------------------------------------------------------*/


/*---------------------------------------------------------------*/
/*      5 pulses CB : 3p x 4b + 2p x 3b + 3b signs = 21 bits         */
/*---------------------------------------------------------------*/


static short track_5_4_0[5][16]={
```

```
    {0, 5, 10, 15, 20, 25, 30, 35, 2, 7, 12, 17, 22, 27, 32, 37},
    {1, 6, 11, 16, 21, 26, 31, 36, 3, 8, 13, 18, 23, 28, 33, 38},
    {4, 9, 14, 19, 24, 29, 34, 39, 0, 0, 0, 0, 0, 0, 0, 0},

    {1, 6, 11, 16, 21, 26, 31, 36, 3, 8, 13, 18, 23, 28, 33, 38},
    {4, 9, 14, 19, 24, 29, 34, 39, 0, 0, 0, 0, 0, 0, 0, 0},
};


/*-------------------------------------------------------------*/
/*     5 pulses CB : 5p x 3b + 5b signs = 20 bits              */
/*-------------------------------------------------------------*/


static short track_5_3_2[5][8]={
    {0,  1,  2,  3,  4,  6,  8,  10},
    {5,  9,  13, 16, 19, 22, 25, 27},
    {7,  11, 15, 18, 21, 24, 28, 32},
    {12, 14, 17, 20, 23, 26, 30, 34},
    {29, 31, 33, 35, 36, 37, 38, 39}
};



/*-------------------------------------------------------------*/
/*     5 pulses CB : 5p x 3b + 5b signs = 20 bits              */
/*-------------------------------------------------------------*/


static short track_5_3_1[5][8]={
    {0,  1,  2,  3,  4,  5,  6,  7 },
    {8,  9,  10, 11, 12, 13, 14, 15},
    {16, 17, 18, 19, 20, 21, 22, 23},
    {24, 25, 26, 27, 28, 29, 30, 31},
    {32, 33, 34, 35, 36, 37, 38, 39}
};

/*---------------------------------------------------------------
*/

/*==============================================================
*/
/*----------------------------- END ----------------------------
*/
```

```
/*===========================================================================
*/
```

**Claims**

1. A variable rate speech compression system (10) for processing a speech signal (18), the variable rate speech compression system comprising:

   an encoding system (12) operable to extract and encode parameters of a frame of the speech signal, the encoding system comprising:

   a subframe processing module (70,74,80,84) operable to encode parameters representative of a subframe of the frame as a function of a rate selection comprising one of a first rate and a second rate and a type classification comprising one of a first type (152, 184) and a second type (154, 186) wherein the first type and the second type indicate bit allocations for the first rate and the second rate, the subframe processing module comprising:

   a gain quantization section (366) operable to jointly encode an adaptive codebook gain and a fixed codebook gain when the type classification is the first type; and

   a frame processing module (44,72,76,82,86) operable to encode parameters representative of the frame as a function of the rate selection and the type classification, the frame processing module comprising:

   a 3D/4D open loop VQ module (454) operable to encode the adaptive codebook gain when the type classification is the second type; and
   a 3D/4D gain codebook (492), the frame processing module operable to encode the fixed codebook gain with the 3D/4D VQ gain codebook when the type classification is the second type.

2. The variable rate speech compression system of claim 1, where the subframe processing module further comprises an adaptive codebook section (362) operable to generate a closed loop pitch lag when the type classification is the first type.

3. The variable rate speech compression system as in claim 1 or 2, where the subframe processing module further comprises an open loop pitch estimation module (316) operable to generate an open loop pitch lag when the type classification is the second type.

4. The variable rate speech compression system as in claim 1, 2 or 3, where the frame processing module comprises a pitch preprocessing module (322) operable to modify the speech signal to improve encoding.

5. The variable rate speech compression system of claim 1, where the frame processing module comprises an interpolation module (338) operable to select an interpolation path when the type classification is the first type and the rate selection is the first rate, the frame processing module operable to encode short term predictor parameters as a function of the interpolation path.

6. The variable rate speech compression system of claim 1, where the frame processing module comprises a predictor switch module (336) operable to generate predictor coefficients when the rate selection is the second rate, the frame processing module operable to encode short term predictor parameters as a function of the predictor coefficients.

7. The variable rate speech compression system of claim 1 where the frame processing module comprises a pitch pre-processing module (322) operable to modify the speech signal to improve encoding.

8. The variable rate speech compression system of claim 7, where the pitch pre-processing module is operable to perform continuous time warping of the speech signal.

9. The variable rate speech compression system as in claim 7 or 8, where the pitch pre-processing module is operable to modify the speech signal as a function of a grade characterization of the speech signal.

10. The variable rate speech compression system as in claim 7, 8 or 9, where the pitch pre-processing module is operable to perform waveform interpolation of the speech signal.

11. The variable rate speech compression system of claim 7, where the frame processing module comprises an interpolation module (338) operable to select an interpolation path when the type classification is the first type and the rate selection is the first rate, the frame processing module operable to encode short term predictor parameters as a function of the interpolation path.

12. The variable rate speech compression system of claim 7, where the frame processing module comprises a predictor switch module (336) operable to select predictor coefficients when the rate selection is the second rate, the frame processing module operable to encode short term predictor parameters as a function of the predictor coefficients.

13. The variable rate speech compression system of claim 7, where the frame processing module is operable to encode short-term predictor parameters, an open loop pitch lag, an adaptive codebook gain and a fixed codebook gain when the type classification is the second type.

14. The variable rate speech compression system as in claim 7 or 13, where the frame processing module comprises a 3D/4D open loop VQ module (454) operable to encode an adaptive codebook gain with a pre-gain quantization table when the type classification is the second type.

15. The variable rate speech compression system as in claim 7, 13 or 14, where the frame processing module comprises a 3D/4D VQ gain codebook (492), operable to encode a fixed codebook gain with a delayed gain quantization table when the type classification is the second type.

16. The variable rate speech compression system of claim 7, where the subframe processing module is operable to encode a closed loop pitch lag, a fixed codebook contribution, an adaptive codebook gain and a fixed codebook gain when the type classification is the first type.

17. The variable rate speech compression system of claim 7, where the subframe processing module is operable to search a fixed codebook (390) to determine a fixed codebook contribution for the subframe, the fixed codebook comprising three 5-pulse codebooks (160) when the rate selection is the first rate and the type classification is the first type.

18. The variable rate speech compression system as in claim 7 or 17, where the subframe processing module is operable to search a fixed codebook (390) to determine a fixed codebook contribution for the subframe, the fixed codebook comprising an 8-pulse codebook (162) when the rate selection is the first rate and the type classification is the second type.

19. The variable rate speech compression system of claim 7, where the subframe processing module is operable to search a fixed codebook (390) to determine a fixed codebook contribution for the subframe, the fixed codebook comprising a 2-pulse codebook (192), a 3-pulse codebook (194) and a gaussian codebook (195) when the rate selection is the second rate and the type classification is the first type.

20. The variable rate speech compression system as in claim 7 or 19, where the subframe processing module is operable to search a fixed codebook (390) to determine a fixed codebook contribution for the subframe, the fixed codebook comprising a 2-pulse codebook (196) and a 3-pulse codebook (197) when the rate selection is the second rate and the type classification is the second type.

21. The variable rate speech compression system as in claim 19 or 20, where subframe processing module is operable to perform enhancements to the fixed codebook, the enhancements comprising at least one of injection of high frequency noise, incorporation of additional pulses and filtration.

22. The variable rate speech compression system of claim 7, where the subframe processing module is operable to determine a quantized gain vector for the subframe when the rate selection is one of the first rate and the second rate and the type classification is the first type, the quantized gain vector representative of joint encoding of an adaptive codebook gain and a fixed codebook gain.

23. The variable rate speech compression system of claim 7, where the first rate is 8.5 Kilobits per second and the second rate is 4.0 Kilobits per second.

24. The variable rate speech compression system of claim 1 further comprising:

a line spectrum frequency prediction error quantization table selectable as a function of the rate selection, the line spectrum frequency prediction error quantization table associated with encoding short-term predictor parameters of the speech signal;
a 2D gain quantization table associated with the quantization section;
a pre-gain quantization table selectable as a function of the rate selection, the pre-gain quantization table associated with encoding the adaptive codebook gain when the type classification is a second type (154, 186);
a delayed gain quantization table selectable as a function of the rate selection, the delayed gain quantization table associated with encoding the fixed codebook gain when the type classification is the second type; and
a decoding system (16) in communication with the encoding system, the decoding system (16) operable to decode the speech signal with the line spectrum frequency prediction error quantization table and at least one of the 2D gain quantization table, the pre-gain quantization table and the delayed gain quantization table as a function of the rate selection and the type classification.

25. The variable rate speech compression system of claim 24, where the line spectrum frequency prediction error quantization table comprises four stages (156) when the rate selection is a full rate.

26. The variable rate speech compression system of claim 25, where a first stage comprises 128 quantization vectors.

27. The variable rate speech compression system of claim 24, where the line spectrum frequency prediction error quantization table comprises three stages (188) when the rate selection is a half rate.

28. The variable rate speech compression system of claim 27, where a first stage and a second stage each comprise 128 quantization vectors and a third stage comprises 64 quantization vectors.

29. The variable rate speech compression system of claim 28, where the first stage comprises a first quantization vector represented as {0.00842379, 0.00868718, 0.01533677, 0.00423439, -0.00886805, -0.02132286, -0.03152681, -0.01975061, -0.01152093, -0.01341948} and a second quantization vector represented as {0.02528175, 0.04259634, 0.03789221, 0.01659535, -0.00266498, -0.01529545, -0.01653101, -0.01528401, -0.01047642, -0.01127117).

30. The variable rate speech compression system of claim 28, where the second stage comprises a first quantization vector represented as {0.00589332, 0.00462334, -0.00937151, -0.01478366, 0.00674597, 0.00164302, -0.00890749, -0.00091839, 0.00487032, 0.00012026} and a second quantization vector represented as {-0.00346857, -0.00100200, -0.00418711, -0.01512477, -0.00104209, -0.00491133, -0.00209555, 0.00045850, 0.00023339, 0.00567173}.

31. The variable rate speech compression system of claim 28, where the third stage comprises a first quantization vector represented as {-0.00071405, 0.00244371, 0.00235739, -0.00329369, 0.00472867, -0.00361321, -0.00584670, 0.00863128, 0.00145642, -0.00441746} and a second quantization vector represented as {0.00242589, -0.00430711, -0.00122645, -0.00464764, -0.00017887, -0.00471663, 0.00181162, 0.00249980, -0.00276848, -0.00485697}.

32. The variable rate speech compression system of claim 24, where the encoding system is operable to jointly encode the fixed codebook gain and the adaptive codebook gain with the 2D gain quantization table for each of at least two subframes of a frame of the speech signal.

33. The variable rate speech compression system of claim 24, where the 2D gain quantization table comprises 128 quantization vectors of 2 elements each.

34. The variable rate speech compression system of claim 24, where the 2D gain quantization table comprises a first quantization vector represented as ( 1.13718400, 2.00167200} and a second quantization vector represented as {1.15061100, 0.80219900} when the rate selection is a full rate.

**35.** The variable rate speech compression system of claim 24, where the pre-gain quantization table comprises 64 vectors when the rate selection is a full rate.

**36.** The variable rate speech compression system of claim 24, where the pre-gain quantization table comprises 16 vectors when the rate selection is a half rate.

**37.** The variable rate speech compression system of claim 24, where the pre-gain quantization table comprises a first vector represented as {0.60699869, 0.59090763, 0.64920781, 0.64610492} and a second vector represented as {0.68101613, 0.65403889, 0.64210982, 0.63130892} when the rate selection is a full rate.

**38.** The variable rate speech compression system of claim 24, where the pre-gain quantization table comprises a first vector represented as {1.16184904, 1.16859789, 1.13656320} and a second vector represented as {1.14613289, 1.06371877, 0.91852525} when the rate selection is a half rate.

**39.** The variable rate speech compression system of claim 24, where the delayed gain quantization table comprises 1024 vectors when the rate selection is a full rate.

**40.** The variable rate speech compression system of claim 24, where the delayed gain quantization table comprises 256 vectors when the rate selection is a half rate.

**41.** The variable rate speech compression system of claim 24, where the encoding system is operable to encode with the delayed gain quantization table and a plurality of prediction coefficients when the type classification is the second type and the rate selection is a full rate.

**42.** The variable rate speech compression system of claim 41, where the predictor coefficients comprise a first predictor coefficient represented as {0.7, 0.6, 0.4, 0.2}, a second predictor coefficient represented as {0.4, 0.2, 0.1, 0.05}, a third predictor coefficient represented as (0.3, 0.2, 0.075, 0.025} and a fourth predictor coefficient represented as {0.2, 0.075, 0.025, 0.0}.

**43.** The variable rate speech compression system of claim 24, where the delayed gain quantization table comprises a first vector represented as {0.18423671, 0.06523999, 0.13390472} and a second vector represented as {0.27552690, 0.09702324, 0.05427950} when the rate selection is a half rate.

**44.** The variable rate speech compression system of claim 24, where the encoding system further comprises a line spectrum frequency predictor coefficients table associated with encoding short-term predictor parameters, the line spectrum frequency predictor coefficients table comprising a first set of predictor coefficients and a second set of predictor coefficients, the first and second set of predictor coefficients selectable by the encoding system when the rate selection is a half rate.

**45.** The variable rate speech compression system of claim 44, where the first set of predictor coefficients comprises a first vector represented as {0.45782564, 0.59002827, 0.73704688, 0.73388197, 0.75903791, 0.74076479, 0.65966007, 0.58070788, 0.52280647, 0.42738207} and a second vector represented as {0.19087084, 0.26721569, 0.38110463, 0.39655069, 0.43984539, 0.42178869, 0.34869783, 0.28691864, 0.23847475, 0.17468375}.

**46.** The variable rate speech compression system of claim 44, where the second set of predictor coefficients comprises a first vector represented as {0.14936742, 0.25397094, 0.42536339, 0.40318214, 0.39778242, 0.34731435, 0.22773174, 0.17583478, 0.12497067, 0.11001108} and a second vector represented as {0.09932127, 0.15389237, 0.24021347, 0.24507006, 0.26478926, 0.23018456, 0.15178193, 0.11368182, 0.07674584, 0.06122567}.

**47.** A bitstream generated by a variable rate speech compression system (10) to represent a speech signal (18), the bitstream comprising:

a full rate bitstream representing a first frame of the speech signal, the full rate bitstream comprising a type component (142, 174) indicative of allocation of a plurality of bits representing the first frame;

a half rate bitstream representing a second frame of the speech signal, the half rate bitstream comprising the type component indicative of allocation of a plurality of bits representing the second frame;
a quarter rate bitstream representing a third frame of the speech signal with a predetermined number of bits that are fixedly allocated; and
an eighth rate bitstream representing a fourth frame of the speech signal with a predetermined number of bits that are fixedly allocated.

48. The bitstream of claim 47, where the type component represents a type classification comprising one of a first type (152, 184) and a second type (154, 186).

49. The bitstream of claim 47, where the full rate bitstream comprises 1 bit representing a type classification with the type component and 169 bits selectively allocated as a function of the type classification to represent a line spectrum frequency component (140, 172), an adaptive codebook component (144, 176), a fixed codebook component (146, 178) and a gain component (147, 179).

50. The bitstream of claim 49, where the line spectrum frequency component is representative of short-term predictor parameters for the first frame, the line spectrum frequency component comprising 27 bits when the type classification is a first type (152, 184) and 21 bits when the type classification is a second type (154, 186).

51. The bitstream of claim 49, where the adaptive codebook component is representative of an adaptive codebook contribution, the adaptive codebook component comprising 26 bits representing the adaptive codebook contribution for each of a plurality of subframes of the first frame when the type classification is a first type (152, 184) and 8 bits representing the adaptive codebook contribution of the first frame when the type classification is a second type (154, 186).

52. The bitstream of claim 49, where the fixed codebook component is representative of the fixed codebook contribution for a plurality of subframes of the first frame, the fixed codebook component comprising 88 bits when the type classification is a first type (152, 184) and 120 bits when the type classification is a second type (154, 186).

53. The bitstream of claim 47, where the half rate bitstream comprises 1 bit representing a type classification with the type component, 21 bits representing a line spectrum frequency component (140, 172) and 58 bits selectively allocated as a function of the type classification to represent an adaptive codebook component (144, 176), a fixed codebook component (146, 178) and a gain component (147, 179).

54. The bitstream of claim 53, where the adaptive codebook component is representative of an adaptive codebook contribution, the adaptive codebook component comprising 14 bits representing the adaptive codebook contribution for each of a plurality of subframes of the second frame when the type classification is a first type (152, 184) and 7 bits representing the adaptive codebook contribution of the second frame when the type classification is a second type (154, 186).

55. The bitstream of claim 53, where the fixed codebook component is representative of the fixed codebook contribution for a plurality of subframes of the second frame, the fixed codebook component comprising 30 bits when the type classification is a first type (152, 184) and 39 bits when the type classification is a second type (154, 186).

56. The bitstream of claim 47, where the eighth rate bitstream comprises a line spectrum frequency component (240) and an energy component (242).

57. The bitstream of claim 56, where the eighth rate bitstream comprises 11 bits representing the line spectrum frequency component and 5 bits representing the energy component.

58. A method of processing a speech signal (18) with a variable rate speech compression system (10), the method comprising:

a) extracting parameters from a frame of the speech signal;
b) selecting a rate as a function of the extracted parameters;
c) selecting one of a first type (152, 184) and a second type (154, 186) as a function of the extracted parameters wherein the first type and the second type indicate bit allocations for the rate;
d) jointly encoding an adaptive codebook gain and a fixed codebook gain for each of the subframes when the type classification is the first type; and

e) individually encoding the adaptive codebook gain and the fixed codebook gain for the frame when the type classification is the second type.

**59.** The method of claim 58, further comprising:

f) encoding a closed loop pitch lag for each of a plurality of subframes of the frame when the type classification is the first type; and

g) encoding an open loop pitch lag representative of the frame when the type classification is the second type.

**60.** The method as in claim 58 or 59, where a) comprises performing pitch preprocessing to modify the speech signal.

**61.** The method of claim 58, where b) comprises selecting the rate as a function of a mode signal.

**62.** The method of claim 58, where b) comprises:

performing an open loop rate selection; and

performing a final rate selection as a function of the open loop rate selection, characterization of the frame and a half-rate signaling flag.

**63.** The method of claim 58, further comprising:

f) choosing an interpolation path to encode short-term predictor parameters when the type classification is the first type and the rate selected is a full rate.

**64.** The method of claim 58, further comprising:

f) selecting a set of predictor coefficients when the rate selected is a half rate; and

g) encoding short-term predictor parameters as a function of the selected set of predictor coefficients.

**65.** The method of claim 58, where e) comprises encoding the adaptive codebook gain with a pre-gain quantization table.

**66.** The method as in claim 58 or 65, where e) comprises encoding the fixed codebook gain with a delayed gain quantization table.

**67.** The method of claim 58, further comprising:

f) selecting the rate as a half rate

g) injecting high frequency noise into a fixed codebook;

h) incorporating additional pulses into the fixed codebook; and

i) encoding a fixed codebook contribution.

**68.** The method of claim 58, where b) comprises selecting one of 8.5 kilobits per second and 4 kilobits per second.

**Patentansprüche**

**1.** Ein Sprachkomprimierungssystem mit variabler Rate bzw. Geschwindigkeit (10) zum Verarbeiten eines Sprachsignals (18), wobei das Sprachkomprimierungssystem mit variabler Rate Folgendes aufweist:

ein Codiersystem (12), das benutzt wird bzw. betreibbar ist zum Extrahieren und Codieren von Parametern eines Rahmens des Sprachsignals, wobei das Codiersystem Folgendes aufweist:

ein Teilrahmen- bzw. Unterrahmenverarbeitungsmodul (70, 74, 80, 84), das benutzt wird zum Codieren von Parametern, die für einen Unterrahmen des Rahmens repräsentativ sind, und zwar als eine Funktion einer Geschwindigkeits- bzw. Ratenauswahl, die eine Rate aus einer ersten Rate und einer zweiten Rate aufweist und einer Typklassifikation, die einen Typ aus einem ersten Typ (152, 184) und einem zweite Typ (154, 186) aufweist und wobei der erste Typ und der zweite Typ Bit-Zuordnungen für die erste Rate und die zweite Rate anzeigen, wobei das Unterrahmenverarbeitungsmodul Folgendes aufweist:

einen Verstärkungsquantisierungsabschnitt (366), der benutzt wird zum gemeinsamen Codieren einer adaptiven Codebuchverstärkung und einer fixierten bzw. festen Codebuchverstärkung, wenn die Typklassifikation vom ersten Typ ist; und
ein Rahmenverarbeitungsmodul (44, 72, 76, 82, 86), das benutzt wird zum Codieren von Parametern, die für den Rahmen repräsentativ sind, und zwar als eine Funktion der Ratenauswahl und der Typklassifikation, wobei das Rahmenverarbeitungsmodul Folgendes aufweist:

ein 3D-/4D-VQ-Modul mit offener Schleife (3D-/4D-VQ-Modulsteuerung) (454), das benutzt wird zum Codieren der adaptiven Codebuchverstärkung, wenn die Typklassifikation vom zweiten Typ ist; und
ein 3D-/4D-Verstärkungscodebuch (492), wobei das Rahmenverarbeitungsmodul benutzt wird zum Codieren der fixierten Codebuchverstärkung mit dem 3D-/4D-VQ-Verstärkungscodebuch, wenn die Typklassifikation vom zweiten Typ ist.

2. Sprachkomprimierungssystem mit variabler Rate nach Anspruch 1, wobei das Unterrahmenverarbeitungsmodul ferner einen adaptiven Codebuchabschnitt (362) aufweist, der benutzt wird zum Erzeugen eines Tonhöhenabstands (pitch lag) mit geschlossener Schleife (Tonhöhenabstandsregelung), wenn die Typklassifikation vom ersten Typ ist.

3. Sprachkomprimierungssystem mit variabler Rate nach Anspruch 1 oder 2, wobei das Unterrahmenverarbeitungsmodul ferner ein Tonhöhenschätzungsmodul mit offener Schleife (Tonhöhenschätzungsmodulsteuerung) (316) aufweist, das benutzt wird zum Erzeugen eines Tonhöhenabstands mit offener Schleife, wenn die Typklassifikation vom zweiten Typ ist.

4. Sprachkomprimierungssystem mit variabler Rate nach Anspruch 1, 2 oder 3, wobei das Rahmenverarbeitungsmodul ein Tonhöhenvorverarbeitungsmodul (322) aufweist, das benutzt wird zum Modifizieren des Sprachsignals um das Codieren zu verbessern.

5. Sprachkomprimierungssystem mit variabler Rate nach Anspruch 1, wobei das Rahmenverarbeitungsmodul ein Interpolationsmodul (338) aufweist, das benutzt wird zum Auswählen eines Interpolationspfades, wenn die Typklassifikation vom ersten Typ ist und die Ratenauswahl die erste Rate ist, wobei das Rahmenverarbeitungsmodul benutzt wird zum Codieren von Kurzzeitvorhersageparametern als eine Funktion des Interpolationspfades.

6. Sprachkomprimierungssystem mit variabler Rate nach Anspruch 1, wobei das Rahmenverarbeitungsmodul ein Vorhersageschaltermodul (336) aufweist, das benutzt wird zum Erzeugen von Vorhersagekoeffizienten, wenn die Ratenauswahl die zweite Rate ist, wobei das Rahmenverarbeitungsmodul benutzt wird zum Codieren von Kurzzeitvorhersageparametern als eine Funktion der Vorhersagekoeffizienten.

7. Sprachkomprimierungssystem mit variabler Rate nach Anspruch 1, wobei das Rahmenverarbeitungsmodul ein Tonhöhenvorverarbeitungsmodul (pitch pre-processing module) (322) aufweist, das benutzt wird zum Modifizieren des Sprachsignals um das Codieren zu verbessern.

8. Sprachkomprimierungssystem mit variabler Rate nach Anspruch 7, wobei das Tonhöhenvorverarbeitungsmodul benutzt wird zum Durchführen kontinuierlicher zeitlicher Verformung (time warping) des Sprachsignals.

9. Sprachkomprimierungssystem mit variabler Rate nach Anspruch 7 oder 8, wobei das Tonhöhenvorverarbeitungsmodul benutzt wird zum Modifizieren des Sprachsignals als eine Funktion einer Grad- bzw. Qualitäts-Charakterisierung (grade characterization) des Sprachsignals.

10. Sprachkomprimierungssystem mit variabler Rate nach Anspruch 7, 8 oder 9, wobei das Tonhöhenvorverarbeitungsmodul benutzt wird zum Durchführen von Wellenforminterpolation des Sprachsignals.

11. Sprachkomprimierungssystem mit variabler Rate nach Anspruch 7, wobei das Rahmenverarbeitungsmodul ein Interpolationsmodul (338) aufweist, das benutzt wird zum Auswählen eines Interpolationspfades, wenn die Typklassifikation vom ersten Typ ist und die Ratenauswahl die erste Rate ist, wobei das Rahmenverarbeitungsmodul benutzt wird zum Codieren von Kurzzeitvorhersageparametern als eine Funktion des Interpolationspfades.

12. Sprachkomprimierungssystem mit variabler Rate nach Anspruch 7, wobei das Rahmenverarbeitungsmodul ein Vorhersageschaltermodul (336) aufweist, das benutzt wird zum Auswählen von Vorhersagekoeffizienten, wenn die Ratenauswahl die zweite Rate ist, wobei das Rahmenverarbeitungsmodul benutzt wird zum Codieren von Kurzzeitvorhersageparametern als eine Funktion der Vorhersagekoeffizienten.

13. Sprachkomprimierungssystem mit variabler Rate nach Anspruch 7, wobei das Rahmenverarbeitungsmodul benutzt wird zum Codieren von Kurzzeitvorhersageparametern, eines Tonhöhenabstands mit offener Schleife, einer adaptiven Codebuchverstärkung und einer fixierten Codebuchverstärkung, wenn die Typklassifikation vom zweiten Typ ist.

14. Sprachkomprimierungssystem mit variabler Rate nach Anspruch 7 oder 13, wobei das Rahmenverarbeitungsmodul ein 3D-/4D-VQ-Modul mit offener Schleife (454) aufweist, das benutzt wird zum Codieren einer adaptiven Codebuchverstärkung mit einer Vorverstärkungsquantisierungstabelle, wenn die Typklassifikation vom zweiten Typ ist.

15. Sprachkomprimierungssystem mit variabler Rate nach Anspruch 7, 13 oder 14, wobei das Rahmenverarbeitungsmodul ein 3D-/4D-VQ-Verstärkungscodebuch (492) aufweist, das benutzt wird zum Codieren einer fixierten Codebuchverstärkung mit einer verzögerten Verstärkungsquantisierungstabelle, wenn die Typklassifikation vom zweiten Typ ist.

16. Sprachkomprimierungssystem mit variabler Rate nach Anspruch 7, wobei das Unterrahmenverarbeitungsmodul benutzt wird zum Codieren eines Tonhöhenabstands mit offener Schleife, eines fixierten Codebuchbeitrags, einer adaptiven Codebuchverstärkung und einer festen Codebuchverstärkung, wenn die Typklassifikation vom ersten Typ ist.

17. Sprachkomprimierungssystem mit variabler Rate nach Anspruch 7, wobei das Unterrahmenverarbeitungsmodul benutzt wird zum Suchen eines fixierten Codebuchs (390) und zwar zum Bestimmen eines fixierten Codebuchbeitrags für den Unterrahmen, wobei das fixierte Codebuch drei 5-Puls-Codebücher (160) aufweist, wenn die Ratenauswahl die erste Rate ist und die Typ Klassifikation vom ersten Typ ist.

18. Sprachkomprimierungssystem mit variabler Rate nach Anspruch 7 oder 17, wobei das Unterrahmenverarbeitungsmodul benutzt wird zum Suchen eines fixierten Codebuchs (390) und zwar zum Bestimmen eines fixierten Codebuchbeitrags für den Unterrahmen, wobei das fixierten Codebuch ein 8-Puls-Codebuch (162) aufweist, wenn die Ratenauswahl die erste Rate ist und die Typklassifikation vom zweiten Typ ist.

19. Sprachkomprimierungssystem mit variabler Rate nach Anspruch 7, wobei das Unterrahmenverarbeitungsmodul benutzt wird zum Suchen eines fixierten Codebuchs (390) und zwar zum Bestimmen eines fixierten Codebuchbeitrags für den Unterrahmen, wobei das fixierte Codebuch ein 2-Puls-Codebuch (192), ein 3-Puls-Codebuch (194) und ein Gauss-förmiges Codebuch (195) aufweist, wenn die Ratenauswahl die zweite Rate ist und die Typklassifikation vom ersten Typ ist.

20. Sprachkomprimierungssystem mit variabler Rate nach Anspruch 7 oder 19, wobei das Unterrahmenverarbeitungsmodul benutzt wird zum Suchen eines fixierten Codebuchs (390) und zwar zum Bestimmen eines fixierten Codebuchbeitrags für den Unterrahmen, wobei das fixierte Codebuch ein 2-Puls-Codebuch (196) und ein 3-Puls-Codebuch (197) aufweist, wenn die Ratenauswahl die zweite Rate ist und die Typklassifikation vom zweiten Typ ist.

21. Sprachkomprimierungssystem mit variabler Rate nach Anspruch 19 oder 20, wobei das Unterrahmenverarbeitungsmodul benutzt wird zum Durchführen von Verbesserungen für das fixierte Codebuch, wobei die Verbesserungen wenigstens Injektion von Hochfrequenzrauschen oder Einbeziehung von zusätzlichen Pulsen und Filterung aufweisen.

22. Sprachkomprimierungssystem mit variabler Rate nach Anspruch 7, wobei das Unterrahmenverarbeitungsmodul benutzt wird zum Bestimmen eines quantisierten Verstärkungsvektors für den Unterrahmen, wenn die Ratenauswahl die erste Rate oder die zweite Rate ist und die Typklassifikation vom ersten Typ ist, wobei der quantisierte Verstärkungsvektor repräsentativ für gemeinsames Codieren einer adaptiven Codebuchverstärkung und einer fixierten Codebuchverstärkung ist.

**23.** Sprachkomprimierungssystem mit variabler Rate nach Anspruch 7, wobei die erste Rate 8,5 kBit pro Sekunde und die zweite Rate 4,0 kBit pro Sekunde ist.

**24.** Sprachkomprimierungssystem mit variabler Rate nach Anspruch 1, das ferner Folgendes aufweist:

eine Linienspektrum-Frequenzvorhersagefehler-Quantisierungstabelle als eine Funktion der Ratenauswahl auswählbar, wobei die Linienspektrum-Frequenzvorhersage-Quantisierungstabelle mit der Codierung von Kurzzeitvorhersageparametern des Sprachsignals assoziiert ist;

eine 2D-Verstärkungsquantisierungstabelle, die mit dem Quantisierungsabschnitt bzw.-Sektion assoziiert ist;
eine Vorverstärkungsquantisierungstabelle, die als eine Funktion der Ratenauswahl auswählbar ist, wobei die Vorverstärkungsquantisierungstabelle mit der Codierung der adaptiven Codebuchverstärkung assoziiert ist, wenn die Typklassifikation vom zweiten Typ (154, 186) ist;

eine verzögerte Verstärkungsquantisierungstabelle, die als eine Funktion der Ratenauswahl auswählbar ist, wobei die verzögerte Verstärkungsquantisieründstabelle mit der Codierung der fixierten Codebuchverstärkung assoziiert ist; und

ein Decodiersystem (16), das mit dem Codiersystem in Kommunikation ist, wobei das Codiersystem (16) benutzt wird zum Decodieren des Sprachsignals mit der Linienspektrum-Frequenzvorhersagefehler-Quantisierungstabelle und wenigstens einem der folgenden: der 2D-Verstärkungsquantisierungstabelle, der Vorverstärkungsquantisierungstabelle und der verzögerten Verstärkungsquantisierungstabelle als eine Funktion der Ratenauswahl und der Typklassifikation.

**25.** Sprachkomprimierungssystem mit variabler Rate nach Anspruch 24, wobei die Linienspektrum-Frequenzvorhersagefehler-Quantisierungstabelle vier Stufen (156) aufweist, wenn die Ratenauswahl eine Vollrate ist.

**26.** Sprachkomprimierungssystem mit variabler Rate nach Anspruch 25, wobei die erste Stufe 128 Quantisierungsvektoren aufweist.

**27.** Sprachkomprimierungssystem mit variabler Rate nach Anspruch 24, wobei die Linienspektrum-Frequenzvorhersagefehler-Quantisierungstabelle drei Stufen (188) aufweist, wenn die Ratenauswahl eine Halbrate ist.

**28.** Sprachkomprimierungssystem mit variabler Rate nach Anspruch 27, wobei eine erste Stufe und eine zweite Stufe jeweils 128 Quantisierungsvektoren aufweisen und eine dritte Stufe 64 Quantisierungsvektoren aufweist.

**29.** Sprachkomprimierungssystem mit variabler Rate nach Anspruch 28, wobei die erste Stufe einen ersten Quantisierungsvektor dargestellt durch {0,00842379, 0,00868718, 0,01533677, 0,00423439, 0,00886805, -0,02132286, -0,03152681, -0,01975061, 0,01152093, -0,01341948} und einen zweiten Quantisierungsvektor dargestellt durch {0,02528175, 0,04259634, 0,03789221, 0,01659535, -0,00266498, -0,01529545, -0,01653101, -0,01528401, -0,01047642, -0,01127117} aufweist.

**30.** Sprachkomprimierungssystem mit variabler Rate nach Anspruch 28, wobei die zweite Stufe einen ersten Quantisierungsvektor dargestellt durch {0,00589332, 0,00462334, -0,00937151, -0,01478366, 0,00674597, 0,00164302, -0,00890749, -0,00091839, 0,00487032, 0,00012026} und einen zweiten Quantisierungsvektor dargestellt durch {-0,00346857, -0,00100200, -0,00418711, -0,01512477, -0,00104209, -0,00491133, -0,00209555, 0,00045850, 0,00023339, 0,00567173} aufweist.

**31.** Sprachkomprimierungssystem mit variabler Rate nach Anspruch 28, wobei die dritte Stufe einen ersten Quantisierungsvektor dargestellt durch {-0,00071405, 0,00244371, 0,00235739, -0,00329369, 0,00472867, -0,00361321, -0,00584670, 0,00863128, 0,00145642, -0,00441746} und einen zweiten Quantisierungsvektor dargestellt durch {0,00242589, -0,00430711, -0,00122645, -0,00464764, -0,00017887, -0,00471663, 0,00181162, 0,00249980, -0,00276848, -0,00485697} aufweist.

**32.** Sprachkomprimierungssystem mit variabler Rate nach Anspruch 24, wobei das Codiersystem benutzt wird zum gemeinsamen Codieren der fixierten Codebuchverstärkung und der adaptiven Codebuchverstärkung mit der 2D-Verstärkungsquantisierungstabelle für jeden der wenigstens zwei Unterrahmen eines Rahmens des Sprachsignals.

**33.** Sprachkomprimierungssystem mit variabler Rate nach Anspruch 24, wobei die 2D-Verstärkungsquantisierungstabelle 128 Quantisierungsvektoren mit jeweils zwei Elementen aufweist.

**34.** Sprachkomprimierungssystem mit variabler Rate nach Anspruch 24, wobei die 2D-Verstärkungsquantisierungstabelle einen ersten Quantisierungsvektor dargestellt durch {1,13718400, 2,00167200} und einen zweiten Quantisierungsvektor dargestellt durch {1,15061100, 0,80219900} aufweist, wenn die Ratenauswahl eine Vollrate ist.

**35.** Sprachkomprimierungssystem mit variabler Rate nach Anspruch 24, wobei die Vorverstärkungsquantisierungstabelle 64 Vektoren aufweist, wenn die Ratenauswahl eine Vollrate ist.

**36.** Sprachkomprimierungssystem mit variabler Rate nach Anspruch 24, wobei die Vorverstärkungsquantisierungstabelle 16 Vektoren aufweist, wenn die Ratenauswahl eine Halbrate ist.

**37.** Sprachkomprimierungssystem mit variabler Rate nach Anspruch 24, wobei die Vorverstärkungsquantisierungstabelle einen ersten Vektor dargestellt durch {0,60699869, 0,59090763, 0,64920781, 0,64610492} und einen zweiten Vektor dargestellt durch {0,68101613, 0,65403889, 0,64210982, 0,63130892} aufweist, wenn die Ratenauswahl eine Vollrate ist.

**38.** Sprachkomprimierungssystem mit variabler Rate nach Anspruch 24, wobei die Vorverstärkungsquantisierungstabelle einen ersten Vektor dargestellt durch {1,16184904, 1,16859789, 1,13656320} und einen zweiten Vektor dargestellt durch {1,14613289, 1,06371877, 0,91852525} aufweist, wenn die Ratenauswahl eine Halbrate ist.

**39.** Sprachkomprimierungssystem mit variabler Rate nach Anspruch 24, wobei die verzögerte Verstärkungsquantisierungstabelle 1024 Vektoren aufweist, wenn die Ratenauswahl eine Vollrate ist.

**40.** Sprachkomprimierungssystem mit variabler Rate nach Anspruch 24, wobei die verzögerte Verstärkungsquantisierungstabelle 256 Vektoren aufweist, wenn die Ratenauswahl eine Halbrate ist.

**41.** Sprachkomprimierungssystem mit variabler Rate nach Anspruch 24, wobei das Codiersystem benutzt wird zum Codieren mit der verzögerten Verstärkungsquantisierungstabelle und einer Vielzahl von Vorhersagekoeffizienten, wenn die Typklassifikation vom zweiten Typ ist und die Ratenauswahl eine Vollrate ist.

**42.** Sprachkomprimierungssystem mit variabler Rate nach Anspruch 41, wobei die Vorhersagekoeffizienten einen ersten Vorhersagekoeffizienten dargestellt durch {0,7, 0,6, 0,4, 0,2}, einen zweiten Vorhersagekoeffizienten dargestellt durch {0,4, 0,2, 0,1, 0,05}, einen dritten Vorhersagekoeffizienten dargestellt durch {0,3, 0,2, 0,075, 0,025} und einen vierten Vorhersagekoeffizienten dargestellt durch {0,2, 0,075, 0,025, 0,0} aufweisen.

**43.** Sprachkomprimierungssystem mit variabler Rate nach Anspruch 24, wobei die verzögerte Verstärkungsquantisierungstabelle einen ersten Vektor dargestellt durch {0,18423671, 0,06523999, 0,13390472} und einen zweiten Vektor dargestellt durch {0,27552690, 0,09702324, 0,05427950} aufweisen, wenn die Ratenauswahl eine Halbrate ist.

**44.** Sprachkomprimierungssystem mit variabler Rate nach Anspruch 24, wobei das Codiersystem ferner eine Linienspektrum-Frequenzvorhersage-Koeffiziententabelle aufweist, die mit der Codierung von Kurzzeitvorhersageparametern assoziiert ist, wobei die Linienspektrum-Frequenzvorhersage-Koeffiziententabelle einen ersten Satz von Vorhersagekoeffizienten und einen zweiten Satz von Vorhersagekoeffizienten aufweist, wobei der erste und zweite Satz von Vorhersagekoeffizienten durch das Codierungssystem wählbar sind, wenn die Ratenauswahl eine Halbrate ist.

**45.** Sprachkomprimierungssystem mit variabler Rate nach Anspruch 44, wobei der erste Satz von Vorhersagekoeffizienten einen ersten Vektor dargestellt durch {0,45782564, 0,59002827, 0,73704688, 0,73388197, 0,75903791, 0,74076479, 0,65966007, 0,58070788, 0,52280647, 0,42738207} und einen zweiten Vektor dargestellt durch {0,19087084, 0,26721569, 0,38110463, 0,39655069, 0,43984539, 0,42178869, 0,34869783, 0,28691864, 0,23847475, 0,17468375} aufweist.

**46.** Sprachkomprimierungssystem mit variabler Rate nach Anspruch 44, wobei der zweite Satz von Vorhersagekoeffizienten einen ersten Vektor dargestellt durch {0,14936742, 0,25397094, 0,42536339, 0,40318214, 0,39778242, 0,34731435, 0,22773174, 0,17583478, 0,12497067, 0,11001108 wie} und einen zweiten Vektor dargestellt durch {0,09932127, 0,15389237, 0,24021347, 0,24507006, 0,26478926, 0,23018456, 0,15178193, 0,11368182, 0,07674584, 0,06122567} aufweist.

**47.** Ein Bitstrom, der durch ein Sprachkomprimierungssystem mit variabler Rate (10) erzeugt wird zum Repräsentieren bzw. Darstellen eines Sprachsignals (18), wobei der Bitstrom Folgendes aufweist:

einen Vollraten-Bitstrom, der einen ersten Rahmen des Sprachsignals (Sprachsignalrahmen) repräsentiert, wobei der Vollraten-Bitstrom eine Typ-Komponente (142, 174) zum Anzeigen der Zuweisung einer Vielzahl von Bits, die den ersten Rahmen repräsentieren aufweist;
einen Halbraten-Bitstrom, der einen zweiten Rahmen des Sprachsignals repräsentiert, wobei der Halbraten-Bitstrom die Typ-Komponente zum Anzeigen der Zuweisung einer Vielzahl von Bits, die den zweiten Rahmen repräsentieren aufweist;
einen Viertelraten-Bitstrom, der einen dritten Rahmen des Sprachsignals repräsentiert mit einer vorher bestimmten Anzahl von Bits die fest bzw. fixiert zugewiesen sind; und
einen Achtelraten-Bitstrom, der einen vierten Rahmen des Sprachsignals repräsentiert mit einer vorher bestimmten Anzahl von Bits die fest zugewiesen sind.

48. Bitstrom nach Anspruch 47, wobei die Typ-Komponente eine Typklassifikation repräsentiert, die einen ersten Typ (152, 184) oder einen zweiten Typ (154, 186) aufweist.

49. Bitstrom nach Anspruch 47, wobei der Vollraten-Bitstrom folgendes aufweist: 1 Bit, das eine Typklassifikation mit der Typ-Komponente repräsentiert und 169 Bits, die selektiv zugewiesen sind als eine Funktion in der Typklassifikation zum Darstellen einer Linienspektrumfrequenz-Komponente (140, 172), einer adaptiven Codebuch-Komponente (144, 176), einer fixierten Codebuch-Komponente (146, 178) und einer Verstärkungs-Komponente (147, 179).

50. Bitstrom nach Anspruch 49, wobei die Linienspektrumfrequenzkomponente repräsentativ ist für Kurzzeitvorhersageparameter für den ersten Rahmen, wobei die Linienspektrumfrequenzkomponente 27 Bits aufweist, wenn die Typklassifikation von einem ersten Typ (152, 184) ist und 21 Bits aufweist, wenn die Typklassifikation von einem zweiten Typ (154, 186) ist.

51. Bitstrom nach Anspruch 49, wobei die adaptive Codebuchkomponente repräsentativ ist für einen adaptiven Codebuchbeitrag, wobei die adaptive Codebuchkomponente 26 Bits aufweist, die den adaptiven Codebuchbeitrag repräsentieren und zwar für jeden einer Vielzahl von Unter- bzw. Teilrahmen, wenn die Typklassifikation von einem ersten Typ (152, 184) ist und 8 Bits aufweist, die den adaptiven Codebuchbeitrag des ersten Rahmens repräsentieren, wenn die Typklassifikation von einem zweiten Typ (154, 186) ist.

52. Bitstrom nach Anspruch 49, wobei die fixierte bzw. feste Codebuchkomponente repräsentativ ist für den festen bzw. fixierten Codebuchbeitrag für eine Vielzahl von Teilrahmen des ersten Rahmens, wobei die feste Codebuchkomponente 88 Bits aufweist, wenn die Typklassifikation von einem ersten Typ (152, 184) ist und 120 Bits aufweist, wenn die Typklassifikation von einem zweiten Typ (154, 186) ist.

53. Bitstrom nach Anspruch 47, wobei der Halbraten-Bitstrom folgendes aufweist: 1 Bit, das eine Typklassifikation mit der Typ-Komponente repräsentiert, 21 Bits, die eine Linienspektrumfrequenzkomponente (140, 172) repräsentieren und 58 Bits, die als eine Funktion der Typklassifikation selektiv zugewiesen sind zum Repräsentieren einer adaptiven Codebuchkomponente (144, 176), einer festen Codebuchkomponente (146, 178) und einer Verstärkungskomponente (147, 179).

54. Bitstrom nach Anspruch 53, wobei die adaptive Codebuchkomponente repräsentativ ist für einen adaptiven Codebuchbeitrag, wobei die adaptive Codebuchkomponente 14 Bits aufweist, die den adaptiven Codebuchbeitrag für jeden einer Vielzahl von Teilrahmen des zweiten Rahmens repräsentieren, wenn die Typklassifikation von einem ersten Typ (152, 184) ist und 7 Bits aufweist, die den adaptiven Codebuchbeitrag des zweiten Rahmens repräsentieren, wenn die Typklassifikation von einem zweiten Typ (154, 186) ist.

55. Bitstrom nach Anspruch 53, wobei die feste Codebuchkomponente repräsentativ ist für den festen Codebuchbeitrag für eine Vielzahl von Teilrahmen des zweiten Rahmens, wobei die feste Codebuchkomponente 30 Bits aufweist, wenn die Typklassifikation von einem ersten Typ (152, 184) ist und 39 Bits aufweist, wenn die Typklassifikation von einem zweiten Typ (154, 186) ist.

56. Bitstrom nach Anspruch 47, wobei der Achtelraten-Bitstrom eine Linienspektrumfrequenzkomponente (240) und eine Energiekomponente (242) aufweist.

**57.** Bitstrom nach Anspruch 56, wobei der Achtelraten-Bitstrom 11 Bits aufweist, die die Linienspektrumfrequenzkomponente repräsentieren und 5 Bits aufweist, die die Energiekomponente repräsentieren.

**58.** Ein Verfahren zum Verarbeiten eines Sprachsignals (18) mit einem Sprachkomprimierungssystem mit variabler Rate (10), wobei das Verfahren Folgendes aufweist:

a) Extrahieren von Parametern aus einem Rahmen des Sprachsignals;

b) Auswählen einer Rate als eine Funktion der extrahierten Parameter;

c) Auswählen eines ersten Typs (152, 184) oder eines zweiten Typs (154, 186) als eine Funktion der extrahierten Parameter, wobei der erste Typ und der zweite Typ Bit-Zuweisungen für die Rate anzeigen;

d) gemeinsames Codieren einer adaptiven Codebuchverstärkung und einer festen Codebuchverstärkung für jeden der Teilrahmen, wenn die Typklassifikation vom ersten Typ ist; und

e) individuelles Codieren der adaptiven Codebuchverstärkung und der festen Codebuchverstärkung für den Rahmen, wenn die Typklassifikation vom zweiten Typ ist.

**59.** Verfahren nach Anspruch 58, das ferner Folgendes aufweist:

f) Codieren eines Tonhöhenabstands mit geschlossener Schleife (Tonhöhenabstandsregelung) für jede einer Vielzahl von Teilrahmen des Rahmens, wenn die Typklassifikation vom ersten Typ ist; und

g) Codieren eines Tonhöhenabstands mit offener Schleife (Tonhöhenabstandssteuerung), der für den Rahmen repräsentativ ist, wenn die Typklassifikation vom zweiten Typ ist.

**60.** Verfahren nach Anspruch 58 oder 59, wobei a) das Durchführen von Tonhöhenvorverarbeitung zum Modifizieren des Sprachsignals aufweist.

**61.** Verfahren nach Anspruch 58, wobei b) das Auswählen der Rate als eine Funktion eines Modussignals (Betriebsartensignals) aufweist.

**62.** Verfahren nach Anspruch 58, wobei b) Folgendes aufweist:

Durchführen einer Ratenauswahl mit offener Schleife (Ratenauswahlsteuerung); und

Durchführen einer finalen bzw. endgültigen Ratenauswahl als eine Funktion der Ratenauswahl mit offener Schleife, der Charakterisierung des Rahmens und einem Halbraten-Signalisierungsmarker (flag).

**63.** Verfahren nach Anspruch 58, das ferner Folgendes aufweist:

f) Auswählen eines Interpolationspfades zum Codieren von Kurzzeitvorhersageparametern, wenn die Typklassifikation vom ersten Typ ist und die ausgewählte Rate eine Vollrate ist.

**64.** Verfahren nach Anspruch 58, das ferner Folgendes aufweist:

f) Auswählen eines Satzes von Vorhersagekoeffizienten, wenn die ausgewählte Rate eine Halbrate ist; und

g) Codieren von Kurzzeitvorhersageparametern als eine Funktion des ausgewählten Satzes von Vorhersagekoeffizienten.

**65.** Verfahren nach Anspruch 58, wobei e) das Codieren der adaptiven Codebuchverstärkung mit einer Vorverstärkungsquantisierungstabelle aufweist.

**66.** Verfahren nach Anspruch 58 oder 65, wobei e) das Codieren der festen Codebuchverstärkung mit einer verzögerten Verstärkungsquantisierungstabelle aufweist.

**67.** Verfahren nach Anspruch 58, das ferner Folgendes aufweist:

f) Auswählen der Rate als eine Halbrate;

g) Injizieren von hochfrequentem Rauschen in ein festes Codebuch;

h) Einbeziehen von zusätzlichen Pulsen in das feste Codebuch; und

i) Codieren eines festen Codebuchbeitrags.

**68.** Verfahren nach Anspruch 58, wobei b) das Auswählen einer Rate aus 8,5 Kilobit pro Sekunde und 4 Kilobit pro Sekunde aufweist.

**Revendications**

**1.** Système (10) de compression de la parole à débit variable pour traiter un signal de parole (18), le système de compression de la parole à débit variable comprenant :

un système de codage (12) actionnable pour extraire et coder des paramètres d'une trame du signal de parole, le système de codage comprenant :

un module de traitement de sous trame (70, 74, 80, 84) actionnable pour coder des paramètres représentatifs d'une sous trame de la trame en fonction d'une sélection de débit comprenant l'un d'un premier débit et d'un deuxième débit et un classement de type comprenant l'un d'un premier type (152, 184) et d'un deuxième type (154, 186), le premier type et le deuxième type indiquant des allocations de bits pour le premier débit et le deuxième débit, le module de traitement de sous trame comprenant :

une partie de quantification de gain (366) actionnable pour coder de manière jointe un gain de livre de code adaptatif et un gain de livre de code fixe lorsque le classement de type est le premier type ; et un module de traitement de trame (44, 72, 76, 82, 86) actionnable pour coder des paramètres représentatifs de la trame en fonction de la sélection de débit et du classement de type, le module de traitement de trame comprenant :

un module VQ 3D/4D en boucle ouverte (454) actionnable pour coder le gain de livre de code adaptatif lorsque le classement de type est le deuxième type ; et un livre de code de gain 3D/4D (492), le module de traitement de trame étant actionnable pour coder le gain de livre de code fixe avec le livre de code de gain VQ 3D/4D lorsque le classement de type est le deuxième type.

**2.** Système de compression de la parole à débit variable selon la revendication 1, dans lequel le module de traitement de sous trame comprend en outre une partie de livre de code adaptatif (362) actionnable pour produire un décalage de hauteur en boucle fermée lorsque le classement de type est le premier type.

**3.** Système de compression de la parole à débit variable selon la revendication 1 ou 2, dans lequel le module de traitement de sous trame comprend en outre un module d'estimation de hauteur en boucle ouverte (316) actionnable pour produire un décalage de hauteur en boucle ouverte lorsque le classement de type est le deuxième type.

**4.** Système de compression de la parole à débit variable selon la revendication 1, 2 ou 3, dans lequel le module de traitement de trame comprend un module de pré-traitement de hauteur (322) actionnable pour modifier le signal de parole pour améliorer le codage.

**5.** Système de compression de la parole à débit variable selon la revendication 1, dans lequel le module de traitement de trame comprend un module d'interpolation (338) actionnable pour sélectionner un chemin d'interpolation lorsque le classement de type est le premier type et la sélection de débit est le premier débit, le module de traitement de trame étant actionnable pour coder des paramètres de prédicteur à court terme en fonction du chemin d'interpolation.

**6.** Système de compression de la parole à débit variable selon la revendication 1, dans lequel le module de traitement de trame comprend un module de commutateur de prédicteur (336) actionnable pour produire des coefficients de prédicteur lorsque la sélection de débit est le deuxième débit, le module de traitement de trame étant actionnable pour coder des paramètres de prédicteur à court terme en fonction des coefficients de prédicteur.

**7.** Système de compression de la parole à débit variable selon la revendication 1, dans lequel le module de traitement de trame comprend un module de prétraitement de hauteur (322) actionnable pour modifier le signal de parole afin d'améliorer le codage.

**8.** Système de compression de la parole à débit variable selon la revendication 7, dans lequel le module de prétraitement de hauteur est actionnable pour effectuer une distorsion temporelle continue du signal de parole.

9.  Système de compression de la parole à débit variable selon la revendication 7 ou 8, dans lequel le module de prétraitement de hauteur est actionnable pour modifier le signal de parole en fonction d'une caractérisation de classe du signal de parole.

10. Système de compression de la parole à débit variable selon la revendication 7, 8 ou 9, dans lequel le module de prétraitement de hauteur est actionnable pour effectuer une interpolation de formes d'onde du signal de parole.

11. Système de compression de la parole à débit variable selon la revendication 7, dans lequel le module de traitement de trame comprend un module d'interpolation (338) actionnable pour sélectionner un chemin d'interpolation lorsque le classement de type est le premier type et la sélection de débit est le premier débit, le module de traitement de trame étant actionnable pour coder des paramètres de prédicteur à court terme en fonction du chemin d'interpolation.

12. Système de compression de la parole à débit variable selon la revendication 7, dans lequel le module de traitement de trame comprend un module de commutateur de prédicteur (336) actionnable pour sélectionner des coefficients de prédicteur lorsque la sélection de débit est le deuxième débit, le module de traitement de trame étant actionnable pour coder des paramètres de prédicteur à court terme en fonction des coefficients de prédicteur.

13. Système de compression de la parole à débit variable selon la revendication 7, dans lequel le module de traitement de trame est actionnable pour coder des paramètres de prédicteur à court terme, un décalage de hauteur en boucle ouverte, un gain de livre de code adaptatif et un gain de livre de code fixe lorsque le classement de type est le deuxième type.

14. Système de compression de la parole à débit variable selon la revendication 7 ou 13, dans lequel le module de traitement de trame comprend un module VQ 3D/4D en boucle ouverte (454) actionnable pour coder un gain adaptatif de livre de code avec une table de quantification de pré-gain lorsque le classement de type est le deuxième type.

15. Système de compression de la parole à débit variable selon la revendication 7, 13 ou 14, dans lequel le module de traitement de trame comprend un livre de code de gain VQ 3D/4D (492), actionnable pour coder un gain de livre de code fixe avec une table de quantification de gain retardé lorsque le classement de type est le deuxième type.

16. Système de compression de la parole à débit variable selon la revendication 7, dans lequel le module de traitement de sous trame est actionnable pour coder un décalage de hauteur en boucle fermée, une contribution de livre de code fixe, un gain de livre de code adaptatif et un gain de livre de code fixe lorsque le classement de type est le premier type.

17. Système de compression de la parole à débit variable selon la revendication 7, dans lequel le module de traitement de sous trame est actionnable pour effectuer une recherche dans un livre de code fixe (390) pour déterminer une contribution de livre de code fixe pour la sous trame, le livre de code fixe comprenant trois livres de code à 5 impulsions (160) lorsque la sélection de débit est le premier débit et le classement de type est le premier type.

18. Système de compression de la parole à débit variable selon la revendication 7 ou 17, dans lequel le module de traitement de sous trame est actionnable pour effectuer une recherche dans un livre de code fixe (390) pour déterminer une contribution de livre de code fixe pour la sous trame, le livre de code fixe comprenant un livre de code à 8 impulsions (162) lorsque la sélection de débit est le premier débit et le classement de type est le deuxième type.

19. Système de compression de la parole à débit variable selon la revendication 7, dans lequel le module de traitement de sous trame est actionnable pour effectuer une recherche dans un livre de code fixe (390) pour déterminer une contribution de livre de code fixe pour la sous trame, le livre de code fixe comprenant un livre de code à 2 impulsions (192), un livre de code à 3 impulsions (194) et un livre de code gaussien (195) lorsque la sélection de débit est le deuxième débit et le classement de type est le premier type.

20. Système de compression de la parole à débit variable selon la revendication 7 ou 19, dans lequel le module de traitement de sous trame est actionnable pour effectuer une recherche dans un livre de code fixe (390) pour déterminer une contribution de livre de code fixe pour la sous trame, le livre de code fixe comprenant un livre de code à 2 impulsions (196) et un livre de code à 3 impulsions (197) lorsque la sélection de débit est le deuxième débit et le classement de type est le deuxième type.

21. Système de compression de la parole à débit variable selon la revendication 19 ou 20, dans lequel le module de traitement de sous trame est actionnable pour effectuer des améliorations du livre de code fixe, les améliorations comprenant au moins une injection d'un bruit haute fréquence, une incorporation d'impulsions supplémentaires et un filtrage.

22. Système de compression de la parole à débit variable selon la revendication 7, dans lequel le module de traitement de sous trame est actionnable pour déterminer un vecteur de gain quantifié pour la sous trame lorsque la sélection de débit est l'une du premier débit et du deuxième débit et lorsque le classement de type est le premier type, le vecteur de gain quantifié étant représentatif d'un codage joint d'un gain de livre de code adaptatif et d'un gain de livre de code fixe.

23. Système de compression de la parole à débit variable selon la revendication 7, dans lequel le premier débit est de 8,5 kilobits par seconde et le deuxième débit est de 4,0 kilobits par seconde.

24. Système de compression de la parole à débit variable selon la revendication 1, comprenant en outre :

   une table de quantification d'erreur de prédiction de fréquence de spectre de ligne sélectionnable en fonction de la sélection de débit, la table de quantification d'erreur de prédiction de fréquence de spectre de ligne étant associée aux paramètres de prédicteur à court terme de codage du signal de parole ;
   une table de quantification 2D associée à la partie de quantification ;
   une table de quantification de pré gain sélectionnable en fonction de la sélection de débit, la table de quantification de pré gain étant associée au codage du gain de livre de code adaptatif lorsque le classement de type est un deuxième type (154, 186) ;
   une table de quantification de gain retardé sélectionnable en fonction de la sélection de débit, la table de quantification de gain retardé étant associée au codage du gain de livre de code fixe lorsque le classement de type est le deuxième type ; et
   un système de décodage (16) en communication avec le système de codage, le système de décodage (16) étant actionnable pour décoder le signal de parole avec la table de quantification d'erreur de prédiction de fréquence de spectre de ligne et au moins l'une de la table de quantification de gain 2D, de la table de quantification de pré gain et de la table de quantification de gain retardé en fonction de la sélection de débit et du classement de type.

25. Système de compression de la parole à débit variable selon la revendication 24, dans lequel la table de quantification d'erreur de prédiction de fréquence de spectre de ligne comprend quatre niveaux (156) lorsque la sélection de débit est un plein débit.

26. Système de compression de la parole à débit variable selon la revendication 25, dans lequel un premier niveau comprend 128 vecteurs de quantification.

27. Système de compression de la parole à débit variable selon la revendication 24, dans lequel la table de quantification d'erreur de prédiction de fréquence de spectre de ligne comprend trois niveaux (188) lorsque la sélection de débit est un demi débit.

28. Système de compression de la parole à débit variable selon la revendication 27, dans lequel un premier niveau et un deuxième niveau comprennent chacun 128 vecteurs de quantification et un troisième niveau comprend 64 vecteurs de quantification.

29. Système de compression de la parole à débit variable selon la revendication 28, dans lequel le premier niveau comprend un premier vecteur de quantification représenté par {0,00842379, 0,00868718, 0,01533677, 0,00423439, -0,00886805, - 0,02132286, -0,03152681, -0,01975061, -0,01152093, -0,01341948} et un deuxième vecteur de quantification représenté par {0,02528175, 0,04259634, 0,03789221, 0,01659535, -0,00266498, - 0,01529545, -0,01653101, -0,01528401, -0,01047642, -0,01127117}.

**30.** Système de compression de la parole à débit variable selon la revendication 28, dans lequel le deuxième niveau comprend un premier vecteur de quantification représenté par {0,00589332, 0,00462334, -0,00937151, -0,01478366, 0,00674597, 0,00164302, -0,00890749, -0,00091839, 0,00487032, 0,00012026} et un deuxième vecteur de quantification représenté par (-0,00346857, -0,00100200, -0,00418711, -0,01512477, - 0,00104209, -0,00491133, -0,00209555, 0,00045850, 0,00023339, 0,00567173}.

**31.** Système de compression de la parole à débit variable selon la revendication 28, dans lequel le troisième niveau comprend un premier vecteur de quantification représenté par {-0,00071405, 0,00244371, 0,00235739, -0,00329369, 0,00472867, -0,00361321, -0,00584670, 0,00863128, 0,00145642, -0,00441746} et un deuxième vecteur de quantification représenté par {0,00242589, -0,00430711, -0,00122645, -0,00464764, -0,00017887, -0,00471663, 0,00181162, 0,00249980, -0,00276848, -0,00485697}.

**32.** Système de compression de la parole à débit variable selon la revendication 24, dans lequel le système de codage est actionnable pour coder de manière jointe le gain de livre de code fixe et le gain de livre de code adaptatif avec la table de quantification de gain 2D pour chacune d'au moins deux sous-trames d'une trame du signal de parole.

**33.** Système de compression de la parole à débit variable selon la revendication 24, dans lequel la table de quantification de gain 2D comprend 128 vecteurs de quantification de 2 éléments chacun.

**34.** Système de compression de la parole à débit variable selon la revendication 24, dans lequel la table de quantification de gain 2D comprend un premier vecteur de quantification représenté par {1,13718400, 2,00167200} et un deuxième vecteur de quantification représenté par {1,15061100, 0,80219900} lorsque la sélection de débit est un plein débit.

**35.** Système de compression de la parole à débit variable selon la revendication 24, dans lequel la table de quantification de pré gain comprend 64 vecteurs lorsque la sélection de débit est un plein débit.

**36.** Système de compression de la parole à débit variable selon la revendication 24, dans lequel la table de quantification de pré gain comprend 16 vecteurs lorsque la sélection de débit est un demi débit

**37.** Système de compression de la parole à débit variable selon la revendication 24, dans lequel la table de quantification de pré gain comprend un premier vecteur représenté par {0,60699869, 0,59090763, 0,64920781, 0,64610492} et un deuxième vecteur représenté par {0,68101613, 0,65403889, 0,64210982, 0,63130892} lorsque la sélection de débit est un plein débit.

**38.** Système de compression de la parole à débit variable selon la revendication 24, dans lequel la table de quantification de pré gain comprend un premier vecteur représenté par {1,16184904, 1,16859789, 1,13656320} et un deuxième vecteur représenté par {1,14613289, 1,06371877, 0,91852525} lorsque la sélection de débit est un demi débit

**39.** Système de compression de la parole à débit variable selon la revendication 24, dans lequel la table de quantification de gain retardé comprend 1024 vecteurs lorsque la sélection de débit est un plein débit.

**40.** Système de compression de la parole à débit variable selon la revendication 24, dans lequel la table de quantification de gain retardé comprend 256 vecteurs lorsque la sélection de débit est un demi débit.

**41.** Système de compression de la parole à débit variable selon la revendication 24, dans lequel le système de codage est actionnable pour effectuer un codage en utilisant la table de quantification de gain retardé et une pluralité de coefficients de prédiction lorsque le classement de type est le deuxième type et la sélection de débit est un plein débit.

**42.** Système de compression de la parole à débit variable selon la revendication 41, dans lequel les coefficients de prédicteur comprennent un premier coefficient de prédicteur représenté par {0,7, 0,6, 0,4, 0,2}, un deuxième coefficient de prédicteur représenté par {0,4, 0,2, 0,1, 0,05}, un troisième coefficient de prédicteur représenté par {0,3, 0,2, 0,075, 0,025} et un quatrième coefficient de prédicteur représenté par {0,2, 0,075, 0,025, 0,0}.

**43.** Système de compression de la parole à débit variable selon la revendication 24, dans lequel la table, de quantification de gain retardé comprend un premier vecteur représenté par {0,18423671, 0,06523999, 0,13390472} et un deuxième vecteur représenté par {0,27552690, 0,09702324, 0,05427950} lorsque la sélection de débit est un demi débit.

**44.** Système de compression de la parole à débit variable selon la revendication 24, dans lequel le système de codage comprend en outre une table de coefficients de prédicteur de fréquence de spectre de ligne associée aux paramètres de prédicteur à court terme de codage, la table de coefficients de prédicteur de fréquence de spectre de ligne comprenant un premier jeu de coefficients de prédicteur et un deuxième jeu de coefficients de prédicteur, les premier et deuxième jeux de coefficients de prédicteur étant sélectionnables par le système de codage lorsque la sélection de débit est un demi débit.

**45.** Système de compression de la parole à débit variable selon la revendication 44, dans lequel le premier jeu de coefficients de prédicteur comprend un premier vecteur représenté par {0,45782564, 0,59002827, 0,73704688, 0,73388197, 0,75903791, 0,74076479, 0,65966007, 0,58070788, 0,52280647, 0,42738207} et un deuxième vecteur représenté par {0,19087084, 0,26721569, 0,38110463, 0,39655069, 0,43984539, 0,42178869, 0,34869783, 0,28691864, 0,23847475, 0,17468375}.

**46.** Système de compression de la parole à débit variable selon la revendication 44, dans lequel le deuxième jeu de coefficients de prédicteur comprend un premier vecteur représenté par {0,14936742, 0,25397094, 0,42536339, 0,40318214, 0,39778242, 0,34731435, 0,22773174, 0,17583478, 0,12497067, 0,11001108} et un deuxième vecteur représenté par {0,09932127, 0,15389237, 0,24021347, 0,24507006, 0,26478926, 0,23018456, 0,15178193, 0,11368182, 0,07674584, 0,06122567}.

**47.** Flux de bits produit par un système de compression de la parole à débit variable (10) pour représenter un signal de parole (18), le flux de bits comprenant :

un flux de bits à plein débit représentant une première trame du signal de parole, le flux de bits à plein débit comprenant une composante de type (142, 174) indiquant une allocation d'une pluralité de bits représentant la première trame ;
un flux de bits à demi débit représentant une deuxième trame du signal de parole, le flux de bits à demi débit comprenant une composante de type indiquant une allocation d'une pluralité de bits représentant la deuxième trame ;
un flux de bits à quart de débit représentant une troisième trame du signal de parole avec un nombre de bits prédéterminé alloué de manière fixe ; et
un flux de bits à huitième de débit représentant une quatrième trame du signal de parole avec un nombre de bits prédéterminé alloué de manière fixe.

**48.** Flux de bits selon la revendication 47, dans lequel la composante de type représente un classement de type comprenant l'un d'un premier type (152, 184) et d'un deuxième type (154, 186).

**49.** Flux de bits selon la revendication 47, dans lequel le flux de bits à plein débit comprend un bit représentant un classement de type et la composante de type, et 169 bits alloués de manière sélective en fonction du classement de type pour représenter une composante de fréquence de spectre de ligne (140, 172), une composante de livre de code adaptatif (144, 176), une composante de livre de code fixe (146, 178) et une composante de gain (147, 179).

**50.** Flux de bits selon la revendication 49, dans lequel la composante de fréquence de spectre de ligne est représentative de paramètres de prédicteur à court terme pour la première trame, la composante de fréquence de spectre de ligne comprenant 27 bits lorsque le classement de type est un premier type (152, 184) et 21 bits lorsque le classement de type est un deuxième type (154, 186).

**51.** Flux de bits selon la revendication 49, dans lequel la composante de livre de code adaptatif est représentative d'une contribution de livre de code adaptatif, la composante de livre de code adaptatif comprenant 26 bits représentant la contribution de livre de code adaptatif pour chacune d'une pluralité de sous-trames de la première trame lorsque le classement de type est un premier type (152, 184) et 8 bits représentant la contribution de livre de code adaptatif de la première trame lorsque le classement de type est un deuxième type (154, 186).

**52.** Flux de bits selon la revendication 49, dans lequel la composante de livre de code fixe est représentative de la contribution de livre de code fixe pour une pluralité de sous trames de la première trame, la composante de livre de code fixe comprenant 88 bits lorsque le classement de type est un premier type (152, 184) et 120 bits lorsque le classement de type est un deuxième type (154, 186).

53. Flux de bits selon la revendication 47, dans lequel le flux de bits à demi débit comprend un bit représentant un classement de type et la composante de type, 21 bits représentant une composante de fréquence de spectre de ligne (140, 172) et 58 bits alloués sélectivement en fonction du classement de type pour représenter une composante de livre de code adaptatif (144, 176), une composante de livre de code fixe (146, 178) et une composante de gain (147, 179).

54. Flux de bits selon la revendication 53, dans lequel la composante de livre de code adaptatif est représentative d'une contribution de livre de code adaptatif, la composante de livre de code adaptatif comprenant 14 bits représentant la contribution du livre de code adaptatif pour chacune d'une pluralité de sous trames de la deuxième trame lorsque le classement de type est un premier type (152, 184) et 7 bits représentant la contribution de livre de code adaptatif de la deuxième trame lorsque le classement de type est un deuxième type (154, 186).

55. Flux de bits selon la revendication 53, dans lequel la composante de livre de code fixe est représentative de la contribution de livre de code fixe pour une pluralité de sous-trames de la deuxième trame, la composante de livre de code fixe comprenant 30 bits lorsque le classement de type est un premier type (152, 184) et 39 bits lorsque le classement de type est un deuxième type (154, 186).

56. Flux de bits selon la revendication 47, dans lequel le flux de bits à huitième de débit comprend une composante de fréquence de spectre de ligne (240) et une composante d'énergie (242).

57. Flux de bits selon la revendication 56, dans lequel le flux de bits à huitième de débit comprend 11 bits représentant la composante de fréquence de spectre de ligne et cinq bits représentant la composante d'énergie.

58. Procédé de traitement d'un signal de parole (18) au moyen d'un système de compression de la parole à débit variable (10), comprenant les étapes suivantes :

   a) extraire des paramètres d'une trame du signal de parole ;
   b) sélectionner un débit en fonction des paramètres extraits ;
   c) sélectionner l'un d'un premier type (152, 184) et d'un deuxième type (154, 186) en fonction des paramètres extraits, les premier et deuxième types indiquant des allocations de bits pour le débit ;
   d) coder de manière jointe un gain de livre de code adaptatif et un gain de livre de code fixe pour chacune des sous-trames lorsque le classement de type est le premier type ; et
   e) coder de manière individuelle le gain de livre de code adaptatif et le gain de livre de code fixe pour la trame lorsque le classement de type est le deuxième type.

59. Procédé selon la revendication 58, comprenant en outre les étapes suivantes :

   f) coder un décalage de hauteur en boucle fermée pour chacune d'une pluralité de sous-trames de la trame lorsque le classement de type est le premier type ; et
   g) coder un décalage de hauteur en boucle ouverte représentatif de la trame lorsque le classement de type est le deuxième type.

60. Procédé selon la revendication 58 ou 59, dans lequel l'étape a) comprend la mise en oeuvre d'un pré-calcul de hauteur pour modifier le signal de parole.

61. Procédé selon la revendication 58, dans lequel l'étape b) comprend la sélection du débit en fonction d'un signal de mode.

62. Procédé selon la revendication 58, dans lequel l'étape b) comprend les étapes suivantes :

   effectuer une sélection de débit en boucle ouverte ; et
   effectuer une sélection de débit finale en fonction de la sélection de débit en boucle ouverte, de la caractérisation de la trame et d'un drapeau signalant un demi débit.

63. Procédé selon la revendication 58, comprenant en outre les étapes :

f) choisir un chemin d'interpolation pour coder des paramètres de prédicteur à court terme lorsque le classement de type est le premier type et la sélection de débit est un plein débit.

64. Procédé selon la revendication 58, comprenant en outre les étapes suivantes :

f) sélectionner un jeu de coefficients de prédicteur lorsque le débit sélectionné est un demi débit ; et
g) coder des paramètres de prédicteur à court terme en fonction du jeu sélectionné de coefficients de prédicteur.

65. Procédé selon la revendication 58, dans lequel l'étape e) comprend le codage du gain de livre de code adaptatif avec une table de quantification de pré gain

66. Procédé selon la revendication 58 ou 65, dans lequel l'étape e) comprend le codage du gain de livre de code fixe avec une table de quantification de gain retardé.

67. Procédé selon la revendication 58, comprenant en outre les étapes suivantes :

f) sélectionner un demi débit pour le débit ;
g) injecter du bruit haute fréquence dans un livre de code fixe ;
h) incorporer des impulsions supplémentaires dans le livre de code fixe ; et
i) coder une contribution de livre de code fixe.

68. Procédé selon la revendication 58, dans lequel l'étape b) comprend une sélection entre 8,5 kilobits par seconde et 4 kilobits par seconde.

FIG. 1

FIG. 2

FIG. 3

| | BITS PER 20 ms | | | |
|---|---|---|---|---|
| | TYPE 0 (4 SUBFRAMES) | | TYPE 1 (4 SUBFRAMES) | |
| LSFs | INTERPOLATION | 2 BITS | | |
| | 1ST STAGE | 7 BITS | 1ST STAGE | 7 BITS |
| | 2ND STAGE | 6 BITS | 2ND STAGE | 6 BITS |
| | 3RD STAGE | 6 BITS | 3RD STAGE | 6 BITS |
| | 4TH STAGE | 6 BITS | 4TH STAGE | 6 BITS |
| | | 27 BITS | | 25 BITS |
| TYPE | 1 BIT | | | |
| ADAPTIVE CODEBOOK | 8,5,8,5 BITS/SUBFRAME | 26 BITS | 8 BITS/FRAME | 8 BITS |
| FIXED CODEBOOK | 5 - PULSE CODEBOOK | | 8 - PULSE CODEBOOK | |
| | 5 - PULSE CODEBOOK | 22 BITS/SUBFRAME | | 30 BITS/SUBFRAME |
| | 5 - PULSE CODEBOOK | | | |
| | | 88 BITS | | 120 BITS |
| ADAPTIVE CODEBOOK GAIN | 2D VQ/SUBFRAME | 7 BITS/SUBFRAME | 4D PRE VQ/FRAME | 6 BITS |
| FIXED CODEBOOK GAIN | | 28 BITS | 4D DELAYED VQ/FRAME | 10 BITS |
| TOTAL | 170 BITS | | 170 BITS | |

FIG. 4

FIG. 5

| | BITS PER 20 ms | |
|---|---|---|
| | TYPE 0 (2 SUBFRAMES) | TYPE 1 (3 SUBFRAMES) |
| LSFs (172) | 190 — PREDICTOR SWITCH | 1 BIT |
| | 188 { 1ST STAGE | 7 BITS |
| | 2ND STAGE | 7 BITS |
| | 3 RD STAGE | 6 BITS |
| | | 21 BITS |
| TYPE (174) | 1 BIT | |
| ADAPTIVE CODEBOOK (176) | 7 BITS/SUBFRAME    14 BITS | 7 BITS/FRAME    7 BITS |
| FIXED CODEBOOK (178) | 192 — 2 - PULSE CODEBOOK | 2 - PULSE CODEBOOK |
| | 194 — 3 - PULSE CODEBOOK | 3 - PULSE CODEBOOK (197) |
| | 195 — GAUSSIAN CODEBOOK   15 BITS/SUBFRAME | 13 BITS/SUBFRAME |
| | 30 BITS | 39 BITS |
| ADAPTIVE CODEBOOK GAIN (180) | 2D VQ/SUBFRAME    7 BITS/SUBFRAME | 3D PRE VQ/FRAME    4 BITS |
| FIXED CODEBOOK GAIN | 14 BITS | 3D DELAYED VQ/FRAME    8 BITS |
| TOTAL | 80 BITS | 80 BITS |

FIG. 5

EP 1 214 706 B1

|  | BITS PER 20 ms | |
|---|---|---|
| 202 — LSFs | 206 — INTERPOLATION | 2 BITS |
|  | 1ST STAGE | 7 BITS |
|  | 2ND STAGE | 6 BITS |
|  | 208 { 3RD STAGE | 6 BITS |
|  | 4TH STAGE | 6 BITS |
|  |  | 27 BITS |
| 204 — ENERGY | 6 BITS/SUBFRAME | 12 BITS |
| TOTAL | 39 BITS | |

## FIG. 6

|  | BITS PER 20 ms | |
|---|---|---|
| 240 — LSFs | 1ST STAGE | 4 BITS |
|  | 244 { 2ND STAGE | 4 BITS |
|  | 3RD STAGE | 3 BITS |
|  |  | 11 BITS |
| 242 — ENERGY | 5 BITS/FRAME | 5 BITS |
| TOTAL | 16 BITS | |

## FIG. 7

EP 1 214 706 B1

SPEECH
SIGNAL
18

302
SILENCE
ENHANCEMENT

304
HIGH-PASS
FILTER

306
NOISE
SUPPRESSION

308
PRE-PROCESSED
SPEECH

34

FIG. 8

FIG.9

EP 1 214 706 B1

FIG. 10

FIG. 11

FIG. 12